# EUROPEAN PATENT APPLICATION

(11) **EP 4 790 059 A1**
(43) Date of publication of application: **12.08.2026**
(21) Application number: 26157439.6
(22) Date of filing: 10.02.2026
(51) Int. Cl.: C07F 15/00, C09K 11/06, H10K 50/11

(54) **ORGANIC ELECTROLUMINESCENT MATERIALS AND DEVICES**

(30) Priority: 11.02.2025 US 202563756839 P; 09.02.2026 US 202619533394
(71) Applicant: Universal Display Corporation, Ewing, NJ 08618 (US)
(72) Inventor: PALMER, Wystan Neil, Ewing, 08618 (US); KOVEL, Carli Brooke, Ewing, 08618 (US); MACOR, Joseph A., Ewing, 08618 (US); FLEETHAM, Tyler, Ewing, 08618 (US); CHEN, Hsiao-Fan, Ewing, 08618 (US); DYER, Robert, Ewing, 08618 (US); GILMARTIN, Philip Henry, Ewing, 08618 (US); HAMZE, Rasha, Ewing, 08618 (US); SZIGETHY, Geza, Ewing, 08618 (US); GUAN, Weiye, Ewing, 08618 (US); WARRING, Levi Stanton, Ewing, 08618 (US)
(74) Representative: Maiwald GmbH

(57) **Abstract**

Provided are organometallic compounds which comprise a central metal atom which is coordinated by am at least two-dentate ligand comprising at least two 5-membered to 10-membered carbocyclic or heterocyclic rings which are connected by a direct bond. Also provided are compositions comprising these organometallic compounds. Further provided are organic light emitting devices (OLEDs) as well as related consumer products that utilize these organometallic compounds.

## Description

### CROSS-REFERENCE TO RELATED APPLICATIONS

This application claims priority under 35 U.S.C. § 119(e) to United States Provisional Application No. 63/756,839, filed on February 11, 2025, the entire contents of which are incorporated herein by reference.

### FIELD

The present disclosure generally relates to organic or metal coordination compounds and compositions and their various uses including as emitters, sensitizers, charge transporters, or exciton transporters in devices such as organic light emitting diodes and related electronic devices and consumer products.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

In one aspect, the present disclosure provides a compound having a first ligand L_{A} comprising a structure of Formula I: 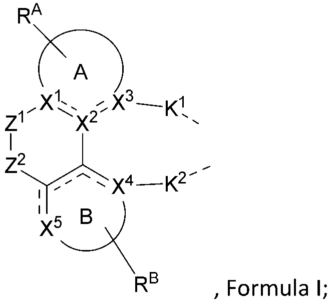
wherein moieties A and B are each independently a monocyclic ring or a polycyclic fused ring system, wherein the monocyclic ring or each ring of the polycyclic fused ring system is independently a 5-membered to 10-membered carbocyclic or heterocyclic ring;
wherein K¹ and K² are each independently selected from the group consisting of a direct bond, O, S, N(R^{α}), P(R^{α}), B(R^{α}), C(R^{α})(R^{β}), and Si(R^{α})(R^{β});
wherein Z¹ is selected from the group consisting of BR^{C}, C=O, C=S, C=Se, GaR^{C}, SiR^{C}R^{C'}, and GeR^{C}R^{C'};
wherein Z² is selected from the group consisting of NR^{D}, O, and S;
wherein X¹ to X⁵ are each independently C or N;
wherein R^{A} and R^{B} each independently represent mono to the maximum allowable substitution or no substitution;
wherein R^{α}, R^{β}, R^{A}, R^{B}, R^{C}, R^{C'} and R^{D} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof;
wherein any two of R^{α}, R^{β}, R^{A}, R^{B}, R^{C}, R^{C'} and R^{D} may be joined or fused to form a ring;
wherein -̅-̅-̅-̅-̅ is a single or double bond;
wherein L_{A} is coordinated to a metal M;
wherein the metal M may be coordinated to other ligands;
wherein L_{A} may join with other ligands to comprise a tridentate, tetradentate, pentadentate, or hexadentate ligand;
with the proviso that when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring;
   and
wherein at least one of the following eleven conditions is true:
   1) moiety A is a 6-membered to 10-membered ring, and R^{B} on X⁵ and an R^{D} from Z² are joined to form a polycyclic fused ring system, and X⁴ is not N;
   2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
   3) M is Pt or Pd, and moiety A is a 6-membered ring;
   4) moiety A is a 6-membered ring, X³ is N, and Z¹ is selected from the group consisting of BR^{C}, GaR^{C}, SiR^{C}R^{C'} and GeR^{C}R^{C'};
   5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
   6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
   7) at least one of R^{A}, R^{B}, R^{C} (if present), and R^{D} (if present) comprises a group selected from germyl, boryl, and partially or fully deuterated silyl;
   8) at least one of R^{A}, R^{B}, R^{C} (if present), and R^{D} (if present) comprises three 6-membered aromatic rings that are not fused to each other, or an aromatic ring fused by a non-aromatic ring;
   9) moiety A is a 5-membered ring and Z¹ is selected from the group consisting of C=O, C=S, and C=Se; and
   10) M is Pt or Pd, X¹ and X³ are both N, X₂ is C, and moiety A is an imidazole ring, and two R^{A} are joined to form a benzene ring which is further substituted;
   11) the compound comprises a structure of 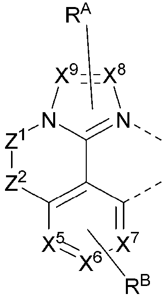 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 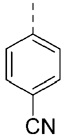 or 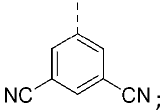 and wherein the compound is not one of the following compounds 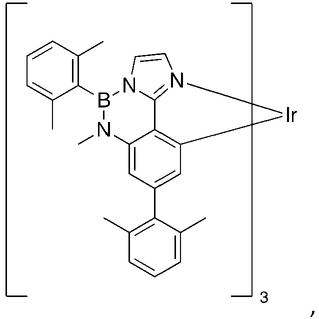 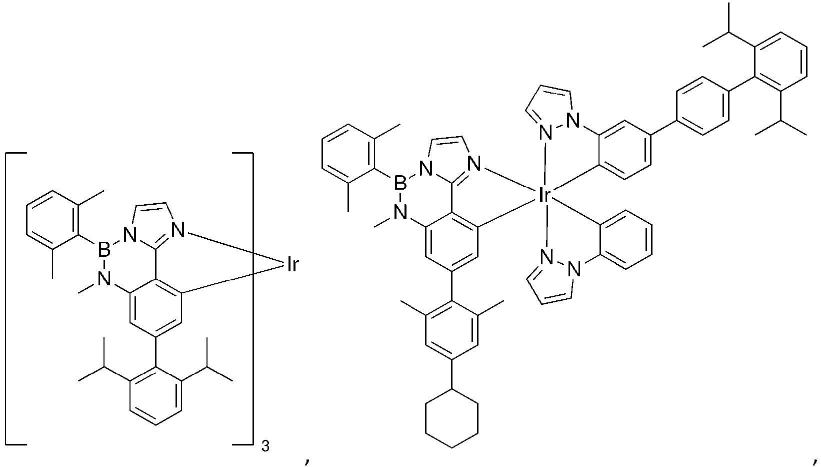 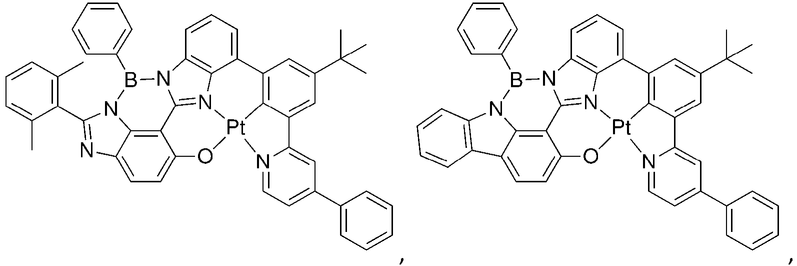 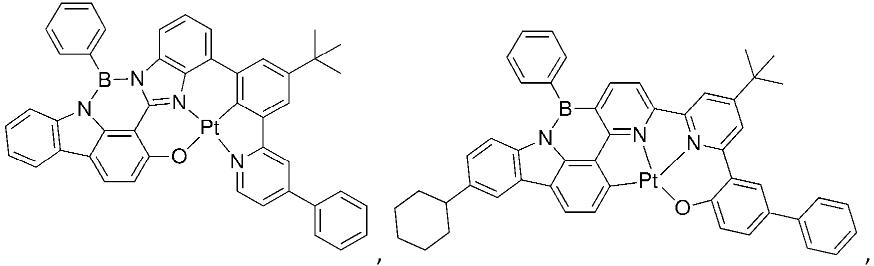 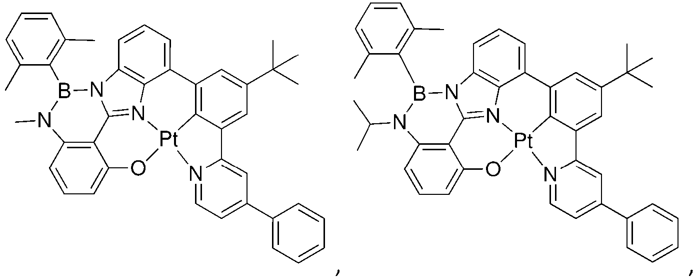 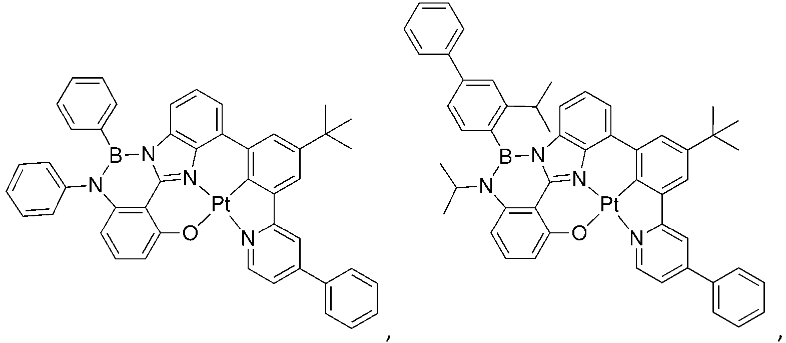 or

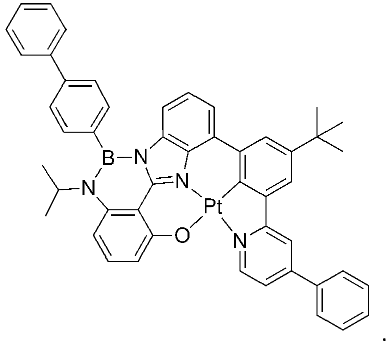

In another aspect, the present disclosure provides a composition of the compound as described herein.

In yet another aspect, the present disclosure provides an OLED having an organic layer comprising the compound as described herein.

In yet another aspect, the present disclosure provides a consumer product comprising an OLED with an organic layer comprising the compound as described herein.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:
As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "NIR", "red", "green", "blue", "yellow" layer, material, region, or device refers to a layer, a material, a region, or a device that emits light in the wavelength range of about 700-1500 nm, 580-700 nm, 500-600 nm, 400-500 nm, 540-600 nm, respectively, or a layer, a material, a region, or a device that has a highest peak in its emission spectrum in the respective wavelength region. In some arrangements, separate regions, layers, materials, or devices may provide separate "deep blue" and "light blue" emissions. As used herein, the "deep blue" emission component refers to an emission having a peak emission wavelength that is at least about 4 nm less than the peak emission wavelength of the "light blue" emission component. Typically, a "light blue" emission component has a peak emission wavelength in the range of about 465-500 nm, and a "deep blue" emission component has a peak emission wavelength in the range of about 400-470 nm, though these ranges may vary for some configurations.

In some arrangements, a color altering layer that converts, modifies, or shifts the color of the light emitted by another layer to an emission having a different wavelength is provided. Such a color altering layer can be formulated to shift wavelength of the light emitted by the other layer by a defined amount, as measured by the difference in the wavelength of the emitted light and the wavelength of the resulting light. In general, there are two classes of color altering layers: color filters that modify a spectrum by removing light of unwanted wavelengths, and color changing layers that convert photons of higher energy to lower energy. For example, a "red" color filter can be present in order to filter an input light to remove light having a wavelength outside the range of about 580-700 nm. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material, region, or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | Interior: [0.5086,0.26571 |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior: [0.2268,0.33211 |
| Central Yellow | Locus: [0.373I,0.6245];[0.6270,0.3725]; |
| | Interior: [0.3700,0.4087];[0.2886,0.4572] |

The terms "halo," "halogen," and "halide" are used interchangeably and refer to fluorine, chlorine, bromine, and iodine.

The term "acyl" refers to a substituted carbonyl group (-C(O)-Rₛ).

The term "ester" refers to a substituted oxycarbonyl (-O-C(O)-Rₛ or -C(O)-O-Rₛ) group.

The term "ether" refers to an -ORₛ group.

The terms "sulfanyl" or "thio-ether" are used interchangeably and refer to a -SRₛ group.

The term "selenyl" refers to a -SeRₛ group.

The term "sulfinyl" refers to a -S(O)-Rₛ group.

The term "sulfonyl" refers to a -SO₂-Rₛ group.

The term "phosphino" refers to a group containing at least one phosphorus atom bonded to the relevant structure. Common examples of phosphino groups include, but are not limited to, groups such as a -P(Rₛ)₂ group or a -PO(Rₛ)₂ group, wherein each Rₛ can be same or different.

The term "silyl" refers to a group containing at least one silicon atom bonded to the relevant structure. Common examples of silyl groups include, but are not limited to, groups such as a -Si(Rₛ)₃ group, wherein each Rₛ can be same or different.

The term "germyl" refers to a group containing at least one germanium atom bonded to the relevant structure. Common examples of germyl groups include, but are not limited to, groups such as a -Ge(Rₛ)₃ group, wherein each Rₛ can be same or different.

The term "boryl" refers to a group containing at least one boron atom bonded to the relevant structure. Common examples of boryl groups include, but are not limited to, groups such as a -B(Rₛ)₂ group or its Lewis adduct -B(Rₛ)₃ group, wherein Rₛ can be same or different.

In each of the above, Rₛ can be hydrogen, or a substituent selected from the group consisting of the General Substituents as defined in this application. Preferred Rₛ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably Rₛ is selected from the group consisting of alkyl, cycloalkyl, aryl, heteroaryl, and combination thereof.

The term "alkyl" refers to and includes both straight and branched chain alkyl groups having an alkyl carbon atom bonded to the relevant structure. Preferred alkyl groups are those containing from one to fifteen carbon atoms, preferably one to nine carbon atoms, and the preferred alkyl groups include methyl, ethyl, n-propyl, iso-propyl, n-butyl, sec-butyl, iso-butyl, tert-butyl, n-pentyl, 2-methylbutyl, 3-methylbutyl, 2,2-dimethylpropyl, 1,3-dimethylpropyl, 1,1-dimethylpropyl, 2-ethylpropyl, 1,2-dimethylpropyl, n-hexyl, 2-methylpentyl, 3-methylpentyl, 2,2-dimethylbutyl, 2,3-dimethylbutyl, n-heptyl, 2-methylhexyl, 3-methylhexyl, 2,2-dimethylpentyl, 2,3-dimethylpentyl, 2,4-dimethylpentyl, 3,3-dimethylpentyl, 3-ethylpentyl, 2,2,3-trimethylbutyl, and the like. Additionally, the alkyl group can be further substituted.

The term "cycloalkyl" refers to and includes monocyclic, polycyclic, and spiro alkyl groups having a ring alkyl carbon atom bonded to the relevant structure. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain with one carbon atom from the carbon-carbon double bond that is bonded to the relevant structure. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain with one carbon atom from the carbon-carbon triple bond that is bonded to the relevant structure. Preferred alkynyl groups are those containing two to fifteen carbon atoms. Additionally, the alkynyl group can be further substituted.

The terms "aralkyl" or "arylalkyl" are used interchangeably and refer to an aryl-substituted alkyl group having an alkyl carbon atom bonded to the relevant structure. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused, such as, without limitation, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, selenophenodipyridine, azaborine, borazine, 5λ²,9λ²-diaza-13b-boranaphtho[2,3,4-de]anthracene, 5λ²-benzo[*d*]benzo[4,5]imidazo[3,2-α]imidazole, and 5,9-dioxa-13b-boranaphtho[3,2,1-*de*]anthracene; preferably dibenzothiophene, dibenzofuran, dibenzoselenophene, carbazole, indolocarbazole, imidazole, pyridine, triazine, benzimidazole, 5λ²,9λ²-diaza-13b-boranaphtho[2,3,4-*de*]anthracene, 5λ²-benzo[d]benzo[4,5]imidazo[3,2-a]imidazole, and 5,9-dioxa-13b-boranaphtho[3,2,1-*de*]anthracene. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, benzimidazole, 5λ²,9λ²-diaza-13b-boranaphtho[2,3,4-de]anthracene, 5λ²-benzo[*d*]benzo[4,5]imidazo[3,2-α]imidazole, 5,9-dioxa-13b-boranaphtho[3,2,1-de]anthracene, and the respective aza-analogs of each thereof are of particular interest.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, germyl, boryl, aryl, heteroaryl, nitrile, sulfanyl, and combinations thereof.

In some instances, the Even More Preferred General Substituents are selected from the group consisting of deuterium, fluorine, alkyl, cycloalkyl, silyl, aryl, heteroaryl, nitrile, and combinations thereof.

In yet other instances, the Most Preferred General Substituents are selected from the group consisting of deuterium, alkyl, cycloalkyl, aryl, heteroaryl, and combinations thereof.

In the event one or more substituents (e.g., R, R', R", R^{A}, R_{A}, R¹, R₁, etc.) is not specifically defined, each of the one or more substituents shall be understood to independently represent hydrogen or a substituent selected from the group consisting of the General Substituents defined herein. Similarly, each of the one or more substituents can optionally be joined or fused with another substituent to form a ring. It shall also be understood that any substituent that can be selected from the General Substituents defined herein can also be selected from the Preferred General Substituents defined herein, the More Preferred General Substituents defined herein, the Even More Preferred General Substituents defined herein, or the Most Preferred General Substituents defined herein.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for all available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

The present disclosure includes all acceptable isotopically-labelled compounds of the present disclosure wherein one or more atoms are replaced by atoms having the same atomic number, but an atomic mass or mass number different from the atomic mass or mass number usually found in nature.

Examples of isotopes suitable for inclusion in the compounds of the present disclosure include isotopes of hydrogen, such as ²H and ³H, carbon, such as ¹¹C, ¹³C and ¹⁴C, chlorine, such as ³⁶Cl, fluorine, such as ¹⁸F, iodine, such as ¹²¹I, ¹²⁴I and ¹²⁵I, nitrogen, such as ¹³N and ¹⁵N, oxygen, such as ¹⁵O, ¹⁷O and ¹⁸O, phosphorus, such as ³²P, and sulphur, such as ³⁵S.

Certain isotopically-labelled compounds of the present disclosure, for example, those incorporating a radioactive isotope, are useful in diagnostic and other studies. The radioactive isotopes tritium, i.e.³H, and carbon-14, i.e. ¹⁴C, are particularly useful for this purpose in view of their ease of incorporation and ready means of detection.

Substitution with heavier isotopes such as deuterium, i.e. ²H, may afford certain advantages resulting from greater stability, and hence may be preferred in some circumstances.

Isotopically-labelled compounds of the invention can generally be prepared by conventional techniques known to those skilled in the art or by processes analogous to those described in the accompanying Examples and Preparations using an appropriate isotopically-labelled reagent in place of the non-labelled reagent previously employed.

For example, deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent, such as, without limitation, methyl, phenyl, pyridyl, etc. includes undeuterated, partially deuterated, and fully deuterated versions thereof. Similarly, classes of substituents such as, without limitation, alkyl, aryl, cycloalkyl, heteroaryl, etc. also include undeuterated, partially deuterated, and fully deuterated versions thereof. Unless otherwise specified, atoms in chemical structures without valences fully filled by H or D should be considered to include undeuterated, partially deuterated, and fully deuterated versions thereof. For example, the chemical structure of 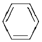 implies to include C₆H₆, C₆D₆, C₆H₃D₃, and any other partially deuterated variants thereof. Some common basic partially or fully deuterated groups include, without limitation, CD₃, CD₂C(CH₃)₃, C(CD₃)₃, and C₆D₅. Similarly, where partially or fully defined atomic structures show a particular position may be or is deuterium, the same atomic structures with one, two, or up to all deuterium atoms replaced by hydrogen are also envisioned.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instances, a pair of substituents in the molecule can be joined or fused into a ring. The preferred ring is a five to nine-membered carbocyclic or heterocyclic ring, including both instances where the portion of the ring formed by the pair of substituents is saturated and where the portion of the ring formed by the pair of substituents is unsaturated. In yet other instances, a pair of adjacent substituents can be joined or fused into a ring. As used herein, "adjacent" means that the two substituents involved can be on the same ring next to each other, or on two neighboring rings having the two closest available substitutable positions, such as 2, 2' positions in a biphenyl, or 1, 8 positions in a naphthalene.

### B. The Compounds of the Present Disclosure

In one aspect, the present disclosure provides a compound having a first ligand L_{A} comprising a structure of Formula I: 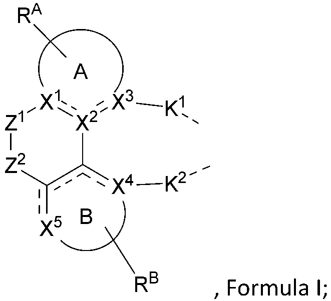
wherein moieties A and B are each independently a monocyclic ring or a polycyclic fused ring system, wherein the monocyclic ring or each ring of the polycyclic fused ring system is independently a 5-membered to 10-membered carbocyclic or heterocyclic ring;
wherein K¹ and K² are each independently selected from the group consisting of a direct bond, O, S, N(R^{α}), P(R^{α}), B(R^{α}), C(R^{α})(R^{β}), and Si(R^{α})(R^{β});
wherein Z¹ is selected from the group consisting of BR^{C}, C=O, C=S, C=Se, GaR^{C}, SiR^{C}R^{C'}, and GeR^{C}R^{C'};
wherein Z² is selected from the group consisting of NR^{D}, O, and S;
wherein X¹ to X⁵ are each independently C or N;
wherein R^{A} and R^{B} each independently represent mono to the maximum allowable substitution or no substitution;
wherein R^{α}, R^{β}, R^{A}, R^{B}, R^{C}, R^{C'} and R^{D} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof;
wherein any two of R^{α}, R^{β}, R^{A}, R^{B}, R^{C}, R^{C'} and R^{D} may be joined or fused to form a ring;
wherein -̅-̅-̅-̅-̅ is a single or double bond;
wherein L_{A} is coordinated to a metal M;
wherein the metal M may be coordinated to other ligands;
wherein L_{A} may join with other ligands to comprise a tridentate, tetradentate, pentadentate, or hexadentate ligand.

In some embodiments, when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring.

In some embodiments, at least one of the following eleven conditions is true:
1) moiety A is a 6-membered to 10-membered ring, and R^{B} on X⁵ and an R^{D} from Z² are joined to form a polycyclic fused ring system, and X⁴ is not N;
2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
3) M is Pt or Pd, and moiety A is a 6-membered ring;
4) moiety A is a 6-membered ring, X³ is N, and Z¹ is selected from the group consisting of BR^{C}, GaR^{C}, SiR^{C}R^{C}' and GeR^{C}R^{C'};
5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
7) at least one of R^{A}, R^{B}, R^{C} (if present), and R^{D} (if present) comprises a group selected from germyl, boryl, and partially or fully deuterated silyl;
8) at least one of R^{A}, R^{B}, R^{C} (if present), and R^{D} (if present) comprises three 6-membered aromatic rings that are not fused to each other, or an aromatic ring fused by a non-aromatic ring;
9) moiety A is a 5-membered ring and Z¹ is selected from the group consisting of C=O, C=S, and C=Se;
10) M is Pt or Pd, X¹ and X³ are both N, X² is C, moiety A is an imidazole ring, and two R^{A} are joined to form a benzene ring which is further substituted; and
11) the compound comprises a structure of 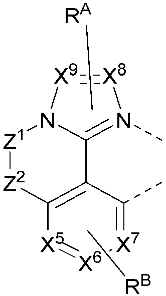 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 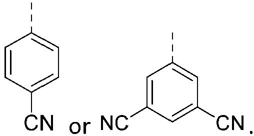 In some embodiments, at least one of conditions 10) and 11) is true. In some embodiments, one of conditions 10) and 11) is true.

In some embodiments, the compound is not one of the following compounds:

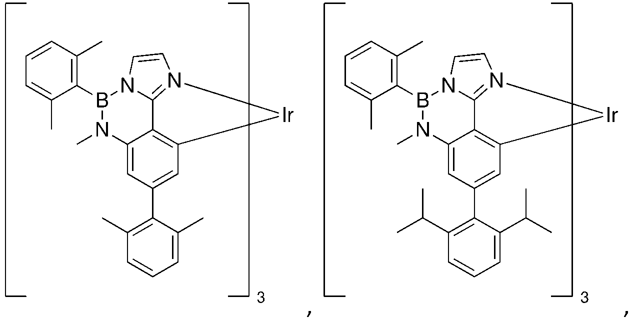

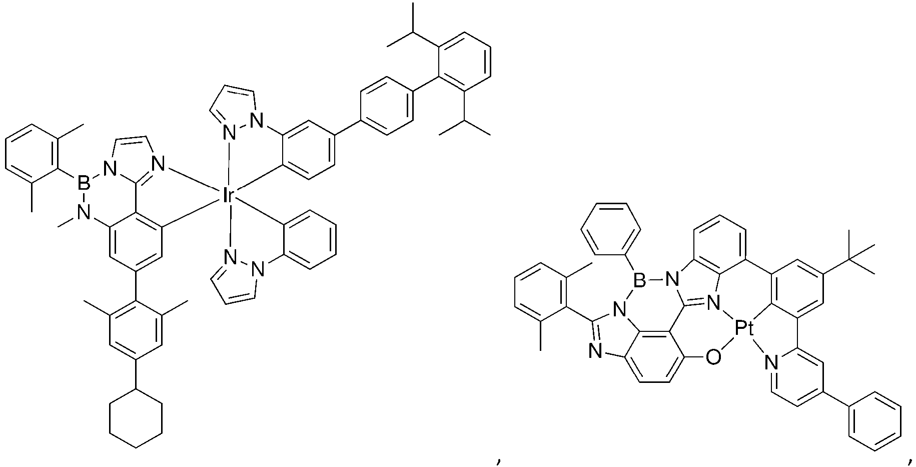

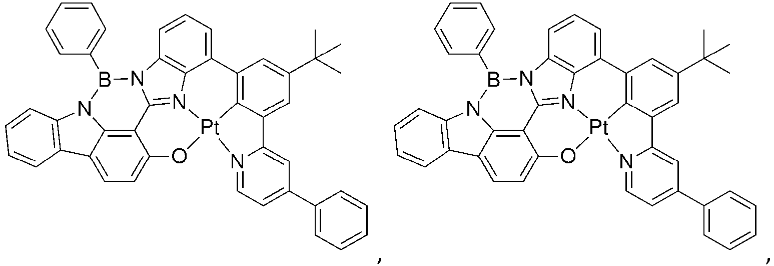

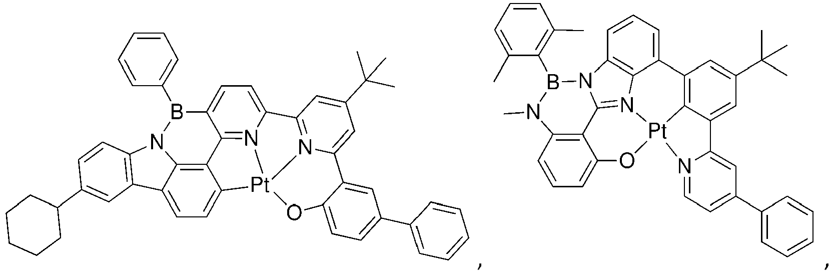

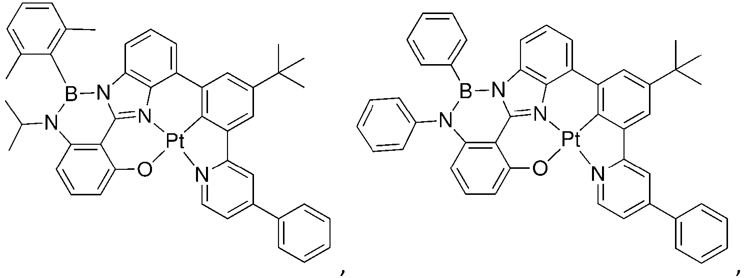

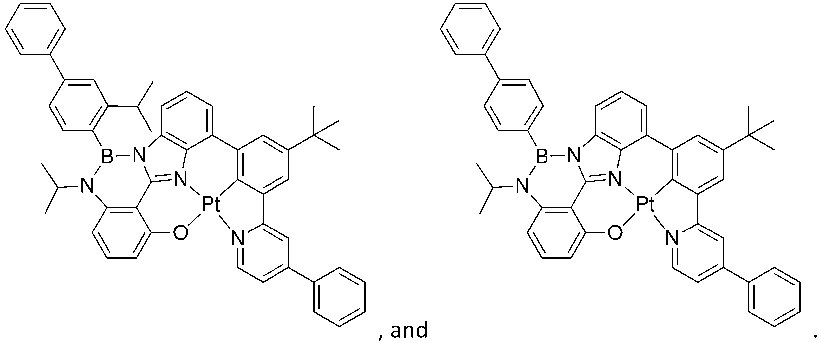

In some embodiments, the first ligand L_{A} consists essentially of Formula I.

In some embodiments, the first ligand L_{A} has a structure of Formula I.

In some embodiments, any two substituents may be joined or fused to form a ring. In some embodiments, at least two of R^{α}, R^{β}, R^{A}, R^{B}, R^{C} and R^{D} are alkyl and joined to form into a ring, which can be further substituted. In some embodiments, at least two R^{A} are joined to form into a ring. In some embodiments, at least two R^{B} are joined to form into a ring. In some embodiments, at least one R^{A} with one R^{C} are joined to form into a ring. In some embodiments, at least one R^{D} with one R^{B} are joined to form into a ring. In some embodiments, at least one R^{α} with one R^{A} are joined to form into a ring. In some embodiments, at least one R^{β} with one R^{A} are joined to form into a ring. In some embodiments, at least one R^{α} with one R^{B} are joined to form into a ring. In some embodiments, at least one R^{β} with one R^{B} are joined to form into a ring. In some of the above embodiments, the ring formed by the two substituents can be an aromatic ring or a non-aromatic ring. In some of such embodiments, the non-aromatic ring can be formed by two alkyl substituents.

In some embodiments, the first ligand L_{A} has the structure of Formula I, at least one R^{α}, R^{β}, R^{A}, R^{B}, R^{C}, R^{C'} and R^{D} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{C'} is partially or fully deuterated. In some embodiments, at least one R^{D} is partially or fully deuterated. In some embodiments, at least one R^{α} or R^{β} is partially or fully deuterated.

In some embodiments, the first ligand L_{A} has the structure of Formula I, at least one R^{A}, R^{B}, R^{C}, R^{C'} or R^{D} is selected from the group consisting of the General Substituents defined herein. In some embodiments, at least one R^{A} is selected from the group consisting of the General Substituents defined herein. In some embodiments, at least one R^{B} is selected from the group consisting of the General Substituents defined herein. In some embodiments, at least one R^{C} is selected from the group consisting of the General Substituents defined herein. In some embodiments, at least one R^{C'} is selected from the group consisting of the General Substituents defined herein. In some embodiments, at least one R^{D} is selected from the group consisting of the General Substituents defined herein.

In some embodiments, the first ligand L_{A} has the structure of Formula I, at least one R^{A}, R^{B}, R^{C}, R^{C'} or R^{D} is selected from the group consisting of the Preferred General Substituents defined herein. In some embodiments, at least one R^{A} is selected from the group consisting of the Preferred General Substituents defined herein. In some embodiments, at least one R^{B} is selected from the group consisting of the Preferred General Substituents defined herein. In some embodiments, at least one R^{C} is selected from the group consisting of the Preferred General Substituents defined herein. In some embodiments, at least one R^{C'} is selected from the group consisting of the Preferred General Substituents defined herein. In some embodiments, at least one R^{D} is selected from the group consisting of the Preferred General Substituents defined herein.

In some embodiments, the first ligand L_{A} comprises an electron-withdrawn group selected from the group consisting of the structures of the following EWG1 LIST: F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2} )₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 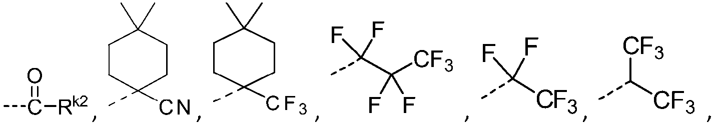 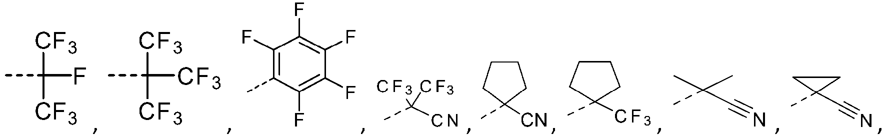 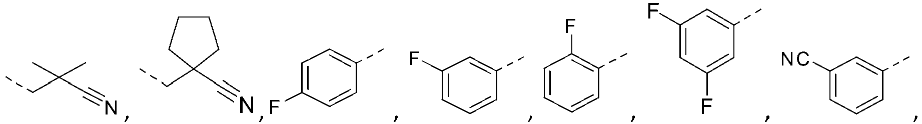 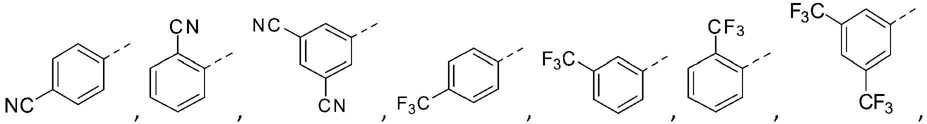 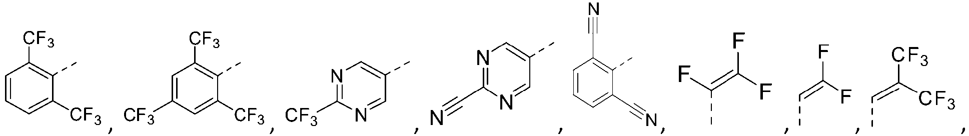 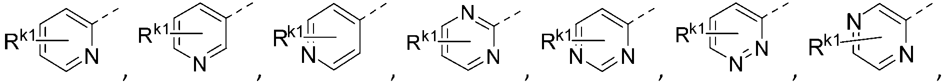 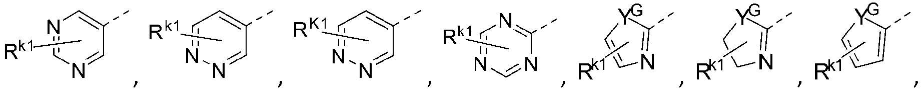 and 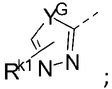
wherein each R^{k1} represents mono to the maximum allowable substitution, or no substitutions;
wherein Y^{G} is selected from the group consisting of BRₑ, NRₑ, PRₑ, O, S, Se, C=O, S=O, SO₂, CRₑR_{f}, SiRₑR_{f}, and GeRₑR_{f'}; and
wherein each of R^{k1} R^{k2}, R^{k3}, Rₑ, and R_{f} is independently a hydrogen, or a substituent selected from the group consisting of the General Substituents defined herein.

In some embodiments, the first ligand L_{A} comprises an electron-withdrawing group selected from the group consisting of the structures of the following EWG2 List:

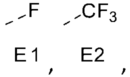

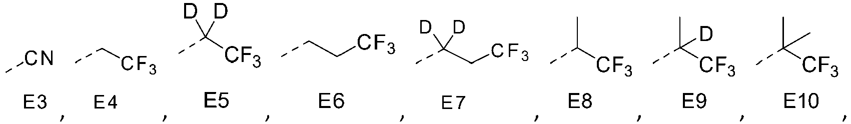

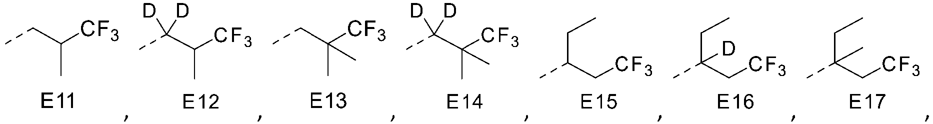

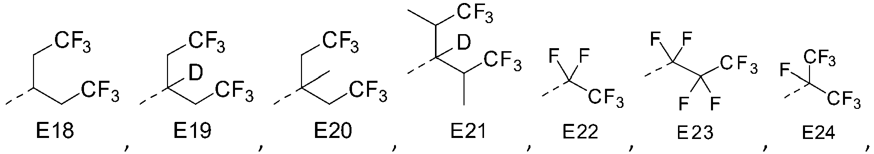

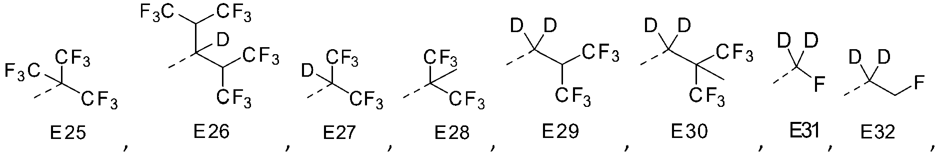

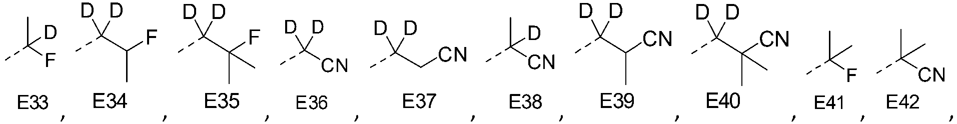

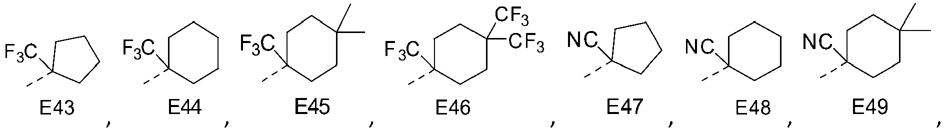

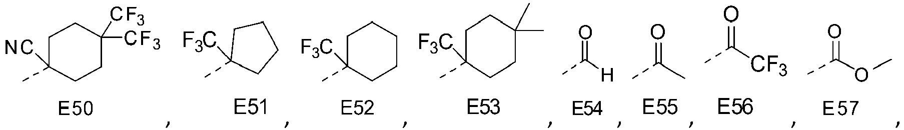

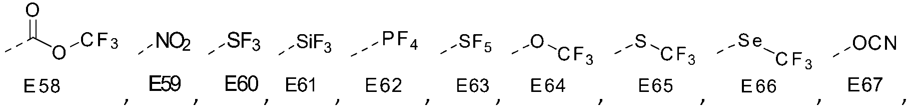

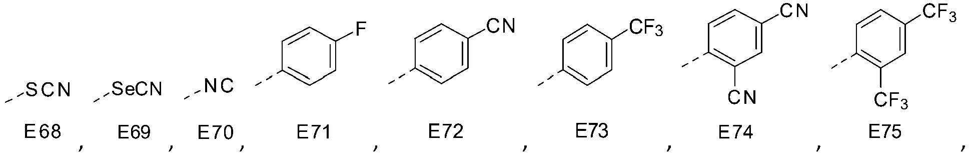

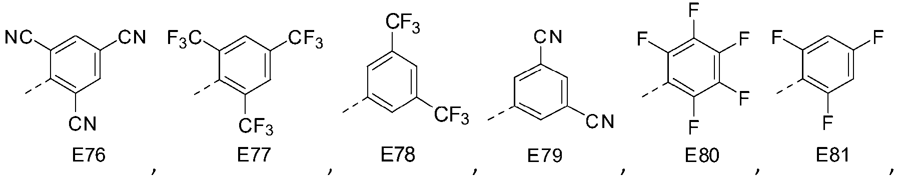

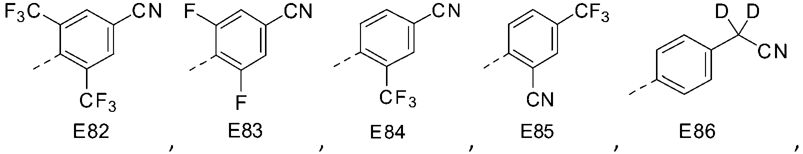

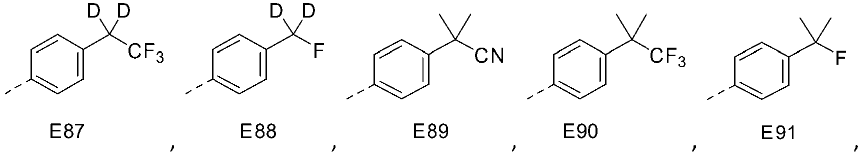

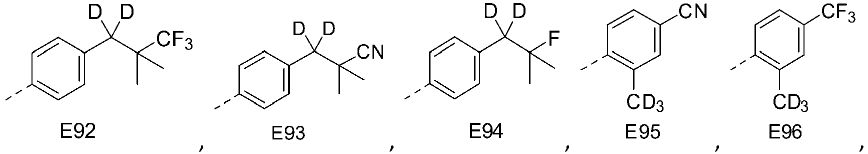

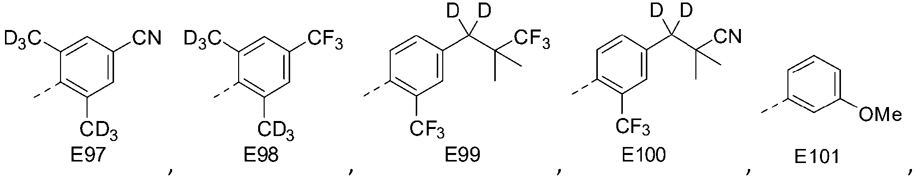

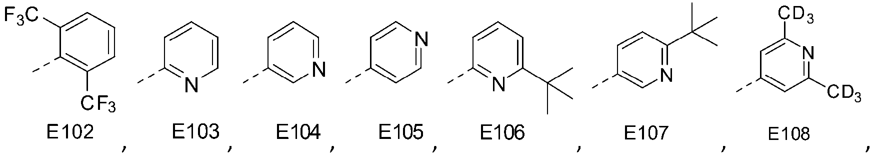

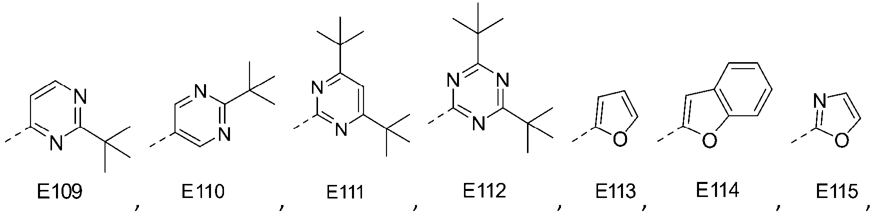

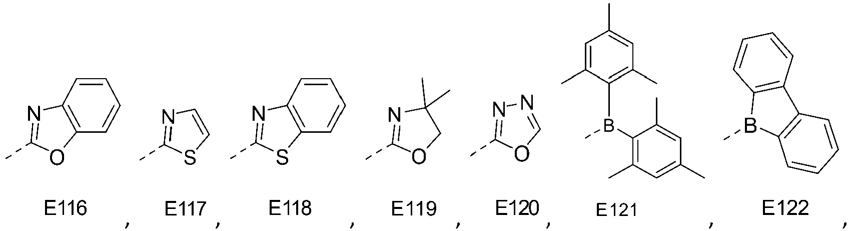

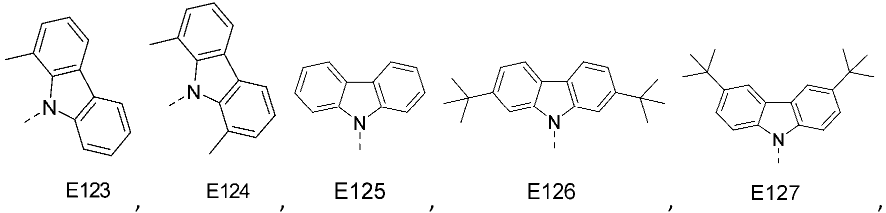

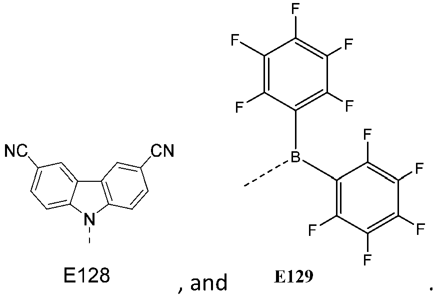

In some embodiments, the first ligand L_{A} comprises an electron-withdrawing group selected from the group consisting of the structures of the following EWG3 LIST:

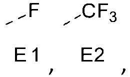

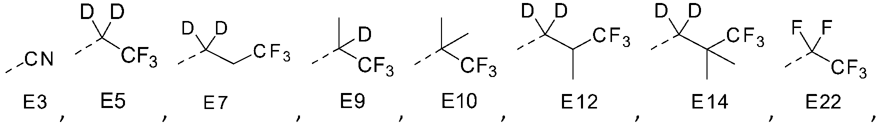

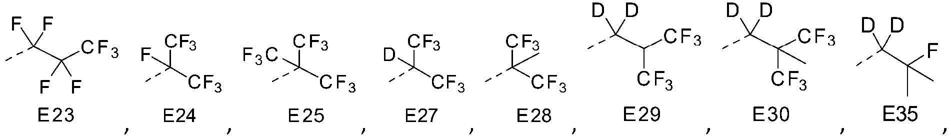

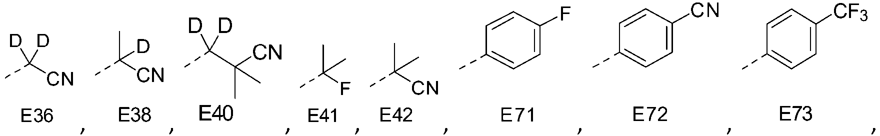

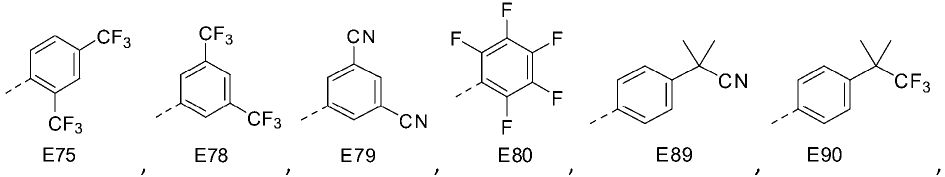

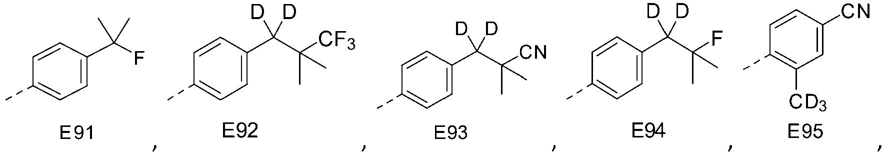

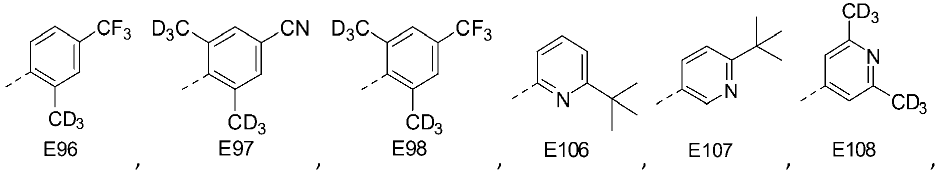

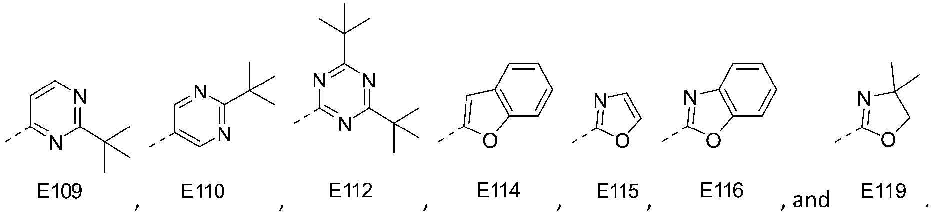

In some embodiments, the first ligand L_{A} comprises an electron-withdrawing group selected from the group consisting of the structures of the following EWG4 LIST:

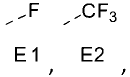

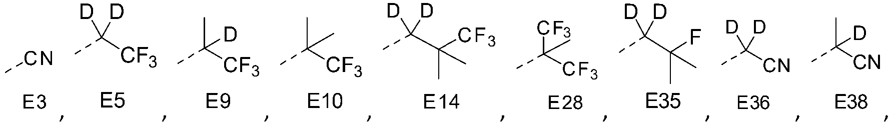

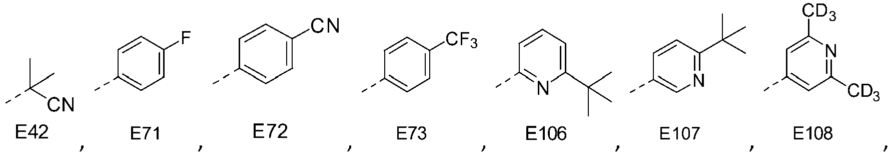

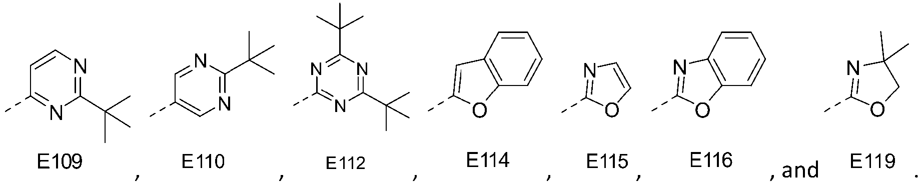

In some embodiments, the first ligand L_{A} comprises a π-electron deficient electron-withdrawing group selected from the group consisting of the structures of the following Pi-EWG LIST: CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, BR^{k2}R^{k3}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate, 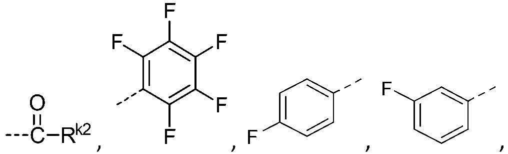 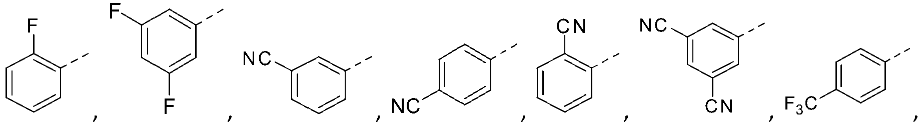 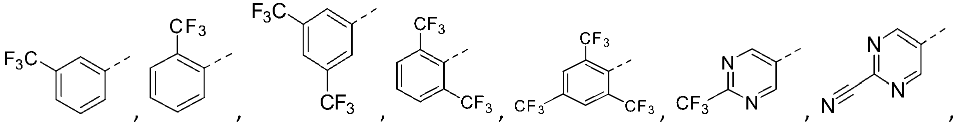 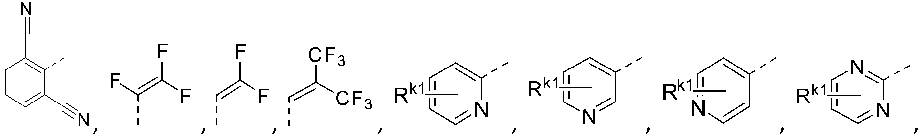 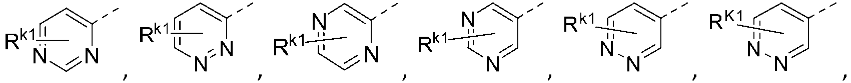 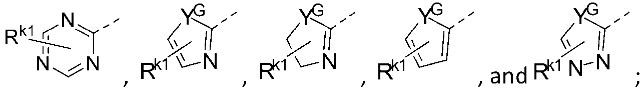 wherein the variables are the same as previously defined.

In some embodiments, the first ligand L_{A} has the structure of Formula I, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments, the first ligand L_{A} has the structure of Formula I, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments, the first ligand L_{A} has the structure of Formula I, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments, the first ligand L_{A} has the structure of Formula I, at least one R^{C'} is or comprises an electron-withdrawing group from the EWG1 LIST as defined herein. In some embodiments, at least one R^{C'} is or comprises an electron-withdrawing group from the EWG2 LIST as defined herein. In some embodiments, at least one R^{C'} is or comprises an electron-withdrawing group from the EWG3 LIST as defined herein. In some embodiments, at least one R^{C'} is or comprises an electron-withdrawing group from the EWG4 LIST as defined herein. In some embodiments, at least one R^{C'} is or comprises an electron-withdrawing group from the Pi-EWG LIST as defined herein.

In some embodiments, the first ligand L_{A} has the structure of Formula I, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} is or comprises an electron-withdrawing group from the Pi-EWG LIST as defined herein.

In some embodiments, when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring.

In some embodiments, moiety A is a 6-membered to 10-membered ring, and R^{B} on X⁵ and an R^{D} on Z² are joined to form a polycyclic fused ring system, and X⁴ is not N. In some embodiments, Moiety A is a 6-membered ring. In some embodiments, Moiety A is a pyridine or pyrimidine ring. In some embodiments, Moiety A is a pyridine ring. In some embodiments, R^{B} on X⁵ and an R^{D} from Z² are joined to form a polycyclic fused ring system containing 2 fused rings. In some embodiments, R^{B} on X⁵ and an R^{D} from Z² are joined along with ring B to form a substituted or unsubstituted carbazole. In some embodiments, R^{B} on X⁵ and an R^{D} from Z² are joined along with ring B to form a substituted carbazole. In some embodiments, R^{B} on X⁵ and an R^{D} from Z² are joined along with ring B to form a substituted polycyclic fused ring system with an EWG. In some embodiments, R^{B} on X⁵ and an R^{D} from Z² are joined along with ring B to form a substituted polycyclic fused ring system ubstituted with CN. In some embodiments, R^{B} on X⁵ and an R^{D} from Z² are oined along with ring B to form a carbazole that is fused with one or more additional rings.

In some embodiments, moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole. In some embodiments, Moiety A is an imidazole, pyrole, pyrazole, triazole. In some embodiments, Moiety A is preferably an imidazole. In some embodiments, two R^{A} are joined to form a monocyclic or polycyclic ring system fused onto moiety A. In some embodiments, Moiety A is a benzimidazole. In some embodiments, R^{B} on X⁵ and an R^{D} from Z² are joined along with ring B to form a substituted carbazole. In some embodiments, R^{B} on X⁵ and an R^{D} from Z² are joined along with ring B to form a polycyclic fused ring system substituted with an EWG. In some embodiments, R^{B} on X⁵ and an R^{D} from Z² are joined along with ring B to form a polycyclic fused ring system substituted with CN. In some embodiments, R^{B} on X⁵ and a R^{D} from Z² are joined along with ring B to form a carbazole that is fused with one or more additional rings.In some embodiments, M is Pt or Pd, and moiety A is a 6-membered ring. In some embodiments, M is Pt. In some embodiments, Moiety A is a pyridine or pyrimidine. In some embodiments, Moiety A is a pyridine.

In some embodiments, moiety A is a 6-membered ring, X³ is N, and Z¹ is selected from the group consisting of BR^{C}, GaR^{C}, SiR^{C}R^{C'} and GeR^{C}R^{C'}. In some embodiments, Moiety A is a pyridine or pyrimidine. In some embodiments, Moiety A is a pyridine. In some embodiments, Z¹ is BR^{C} or SiR^{C}R^{C'}. In some embodiments, Z¹ is BR^{C}.

In some embodiments, moiety A and moiety B are both 6-membered rings, Z¹ is selected from the group consisting of C=O, C=S, and C=Se, and Z² is NR^{D}, with the proviso that if M is Ir, then R^{D} is a cyclic group.

In some embodiments, moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle. In some embodiments, moiety B is pyridine or pyrimidine. In some embodiments, moiety B is pyridine. In some embodiments, Z¹ is BR^{C} or SiR^{C}R^{C'}. In some embodiments, Z¹ is BR^{C}. In some embodiments, Z² is NR^{D}. In some embodiments, R^{C} is joined with R^{A} to form a monocyclic or polycyclic fused ring system. In some embodiments, R^{C} is not joined with R^{A} to form ring.

In some embodiments, moiety A and moiety B are both 6-membered rings, Z¹ is selected from the group consisting of C=O, C=S, and C=Se, and Z² is NR^{D}, with the proviso that if M is Ir, then R^{D} is a cyclic group. In some embodiments, Z¹ is C=O. In some embodiments, R^{D} is a substituted or unsubstituted aryl or heteroaryl group. In some embodiments, R^{D} is a substituted or unsubstituted phenyl ring. In some embodiments, R^{D} is an alkyl substituted aryl.

In some embodiments, at least one of R^{A}, R^{B}, R^{C} (if present), and R^{D} (if present) comprises a group selected from germyl, boryl, and partially or fully deuterated silyl. In some embodiments, one of R^{A}, R^{B}, R^{C}, and R^{D} comprises a boryl group. In some embodiments, R^{B} comprises is a boryl group. In some embodiments, Z² is NR^{D} and R^{D} is joined to at least one R^{B} to form a ring comprising a boryl group. In some embodiments, one of R^{A}, R^{B}, R^{C}, and R^{D} comprises a silyl or germyl group. In some embodiments, one of R^{A}, R^{B}, R^{C}, and R^{D} comprises a trialkyl germyl group. In some embodiments, one of R^{A}, R^{B}, R^{C}, and R^{D} comprises a fully or partially deuterated trialkyl silyl group. In some embodiments, one of R^{A}, R^{B}, R^{C}, and R^{D} comprises a silyl group comprising a fully or partially deuterated aromatic ring.

In some embodiments, at least one of R^{A}, R^{B}, R^{C} (if present), and R^{D} (if present) comprises three 6-membered aromatic rings that are not fused to each other, or an aromatic ring fused by a non-aromatic ring. In some embodiments, at least one of R^{A}, R^{B}, R^{C} (if present), and R^{D} (if present) comprises a substituted or unsubstituted terphenyl. In some embodiments, at least one of R^{A}, R^{B}, R^{C} (if present), and R^{D} (if present) comprises an alkyl substituted terphenyl. In some embodiments, at least one of R^{A}, R^{B}, R^{C} (if present), and R^{D} (if present) comprises an aromatic ring fused with a saturated 5 or 6 membered carbocyclic ring. In some embodiments, at least one of R^{A}, R^{B}, R^{C} (if present), and R^{D} (if present) comprises a phenyl ring fused with a saturated 6 membered carbocyclic ring.

In some embodiments, moiety A is a 5-membered ring and Z¹ is selected from the group consisting of C=O, C=S, and C=Se. In some embodiments, moiety A is selected from imidazole, pyrrole, triazole, oxazole, and furan. In some embodiments, moiety A is imidazole. In some embodiments, Z¹ is C=O.

In some embodiments, M is Pt or Pd, X¹ and X³ are both N, X² is C, moiety A is an imidazole ring, and two R^{A} are joined to form a benzene ring which is further substituted. In some embodiments, the benzene ring is substituted with deuterium, aryl, heteroaryl, alkyl, silyl and combinations thereof. In some embodiments, the benzene ring is substituted with alkyl.

In some embodiments, the compound comprises a structure of 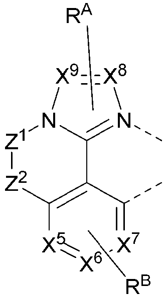 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 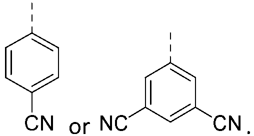 In some embodiments, Z¹ is BR and Z² is NR. In some embodiments, Z¹ is C=O and Z² is NR.

In some embodiments, moiety A is a 5-membered ring and Z¹ is selected from the group consisting of C=O, C=S, and C=Se.

In some embodiments, Z² is NR^{D}, R^{D} comprises a polycyclic fused ring system, and R^{D} and R^{B} on X⁵ are joined together to form a 5 to 10-membered ring.

In some embodiments, R^{D} is a polycyclic fused ring system comprising exactly 2 rings.

In some embodiments, R^{D} is a polycyclic fused ring system comprising at least 2 rings.

In some embodiments, R^{D} is a polycyclic fused ring system comprising exactly 3 rings.

In some embodiments, R^{D} is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, nathpho-imidazole (benzobenzimidazole), dibenzofuran, aza-dibenzofuran, dibenzothiophene, aza-dibenzothiophene, phthalazine, phenanthrene, aza-phenanthrene, anthracene, aza-anthracene, phenanthridine, fluorene, and aza-fluorene.

In some embodiments, R^{D} and R^{B} on X⁵ are joined together to form a 5-membered ring.

In some embodiments, R^{D} and R^{B} on X⁵ are joined together to form a 6-membered ring.

In some embodiments, R^{B} is selected from the group consisting of alkyl, heteroalkyl, alkenyl, and heteroalkenyl.

In some embodiments, R^{B} is methyl.

In some embodiments, moiety B is selected from the group consisting of benzene, pyridine, pyrimidine, pyridazine, pyrazine, triazine, imidazole, pyrazole, pyrrole, oxazole, furan, thiophene, thiazole, and triazole.

In some embodiments, moiety B is benzene.

In some embodiments, X⁴ is C.

In some embodiments, X⁵ is C.

In some embodiments, each of R^{α}, R^{β}, R^{A}, R^{B}, R^{C}, R^{C'} and R^{D} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some embodiments, the metal M is selected from the group consisting of Ir, Rh, Re, Ru, Os, Pt, Pd, Ag, Au, and Cu.

In some embodiments, M is selected from the group consisting of Ir, Pd, and Pt.

In some embodiments, M is Ir.

In some embodiments, M is Pt.

In some embodiments, M is Pd.

In some embodiments, Z¹ is BR^{C}. In some embodiments, Z¹ is GaR^{C}. In some embodiments, Z¹ is SiR^{C}R^{C'}. In some embodiments, Z¹ is GeR^{C}R^{C'}.

In some embodiments, Z¹ is BR^{C} and R^{C} comprises at least one aromatic ring.

In some embodiments, Z¹ is BR^{C} and R^{C} comprises at least one 6-membered aromatic ring.

In some embodiments, Z¹ is BR^{C} and R^{C} comprises at least one 6-membered carbocyclic aromatic ring.

In some embodiments, Z¹ is BR^{C} and R^{C} comprises at least two aromatic rings.

In some embodiments, Z¹ is BR^{C} and R^{C} comprises at least two 6-membered aromatic rings.

In some embodiments, Z¹ is BR^{C} and R^{C} comprises at least two 6-membered carbocyclic aromatic rings. In some embodiments, Z¹ is BR^{C} and R^{C} comprises an alkyl substituted aromatic ring. In some embodiments, Z¹ is BR^{C} and R^{C} comprises an 2, 6 di alkyl aromatic ring.

In some embodiments, Z¹ is C=O.

In some embodiments, Z¹ is C=S.

In some embodiments, Z¹ is C=Se.

In some embodiments, at least one of X¹-X⁵ is N.

In some embodiments, exactly one of X¹-X⁵ is N.

In some embodiments, at least two of X¹-X⁵ are N.

In some embodiments, X¹ is N.

In some embodiments, X¹ and X³ are N.

In some embodiments, X² is N.

In some embodiments, X² is C.

In some embodiments, X³ is N and X⁴ is C.

In some embodiments, X³ is C and X⁴ is N.

In some embodiments, X³ is C.

In some embodiments, one of K¹ and K² is selected from the group consisting of O, S, N(R^{α}), P(R^{α}), B(R^{α}), C(R^{α})(R^{β}), and Si(R^{α})(R^{β}).

In some embodiments, both of K¹ and K² are a direct bond.

In some embodiments, Z² is NR^{D}.

In some embodiments, Z² is NR^{D} and R^{D} and R^{B} on X⁵ form a ring.

In some embodiments, Z² is NR^{D} and R^{D} and R^{B} on X⁵ form a 6-membered ring.

In some embodiments, Z² is O.

In some embodiments, Z² is S.

In some embodiments, Z¹ is BR^{C} and Z² is NR^{D}.

In some embodiments, Z¹ is BR^{C} and Z² is O.

In some embodiments, Z¹ is C=O and Z² is NR^{D}.

In some embodiments, Z¹ is C=O and Z² is O.

In some embodiments, all R^{A} are hydrogen.

In some embodiments, all R^{B} are hydrogen.

In some embodiments, moiety A is a selected from the group consisting of the following Cyclic Moiety List: benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, phenanthro[3,2-b]benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, nathpho-imidazole (benzobenzimidazole), dibenzofuran, aza-dibenzofuran, dibenzothiophene, aza-dibenzothiophene, quinoxaline, phthalazine, phenanthrene, aza-phenanthrene, anthracene, aza-anthracene, phenanthridine, fluorene, and aza-fluorene.

In some embodiments, the aza variant includes one N on a benzo ring. In some embodiments, the aza variant includes one N on a benzo ring and the N is coordinated to the metal M.

In some embodiments, moiety A is a monocyclic ring.

In some embodiments, moiety A is selected from the group consisting of benzene, pyridine, pyrimidine, pyridazine, pyrazine, triazine, imidazole, pyrazole, pyrrole, oxazole, furan, thiophene, thiazole, and triazole.

In some embodiments, moiety A is a benzene, pyrimidine, or pyridine.

In some embodiments, moiety A is pyridine.

In some embodiments, moiety A is pyrimidine.

In some embodiments, moiety A is a polycyclic fused ring system.

In some embodiments, moiety A is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, nathpho-imidazole (benzobenzimidazole), dibenzofuran, aza-dibenzofuran, dibenzothiophene, aza-dibenzothiophene, phthalazine, phenanthrene, aza-phenanthrene, anthracene, aza-anthracene, phenanthridine, fluorene, and aza-fluorene.

In some embodiments, moiety A is naphthalene, quinoline, benzofuran, aza-benzofuran, benzothiophene, aza-benzothiophene, benzimidazole, aza-benzimidazole, carbazole, aza-carbazole, nathpho-imidazole (benzobenzimidazole), dibenzofuran, aza-dibenzofuran, dibenzothiophene, or aza-dienzothiophene.

In some embodiments, moiety B is a selected from the group consisting of the following Cyclic Moiety List: benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, phenanthro[3,2-b]benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, nathpho-imidazole (benzobenzimidazole), dibenzofuran, aza-dibenzofuran, dibenzothiophene, aza-dibenzothiophene, quinoxaline, phthalazine, phenanthrene, aza-phenanthrene, anthracene, aza-anthracene, phenanthridine, fluorene, and aza-fluorene.

In some embodiments, the aza variant includes one N on a benzo ring. In some embodiments, the aza variant includes one N on a benzo ring and the N is coordinated to the metal M.

In some embodiments, moiety B is a monocyclic ring.

In some embodiments, moiety B is selected from the group consisting of benzene, pyridine, pyrimidine, pyridazine, pyrazine, triazine, imidazole, pyrazole, pyrrole, oxazole, furan, thiophene, thiazole, and triazole.

In some embodiments, moiety B is a benzene, pyrimidine, or pyridine.

In some embodiments, moiety B is pyrimidine.

In some embodiments, moiety B is pyridine,

In some embodiments, moiety B is a polycyclic fused ring system.

In some embodiments, moiety B is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, nathpho-imidazole (benzobenzimidazole), dibenzofuran, aza-dibenzofuran, dibenzothiophene, aza-dibenzothiophene, phthalazine, phenanthrene, aza-phenanthrene, anthracene, aza-anthracene, phenanthridine, fluorene, and aza-fluorene.

In some embodiments, moiety B is naphthalene, quinoline, benzofuran, aza-benzofuran, benzothiophene, aza-benzothiophene, benzimidazole, aza-benzimidazole, carbazole, aza-carbazole, nathpho-imidazole (benzobenzimidazole), dibenzofuran, aza-dibenzofuran, dibenzothiophene, or aza-dienzothiophene.

In some embodiments, the ligand L_{A} is selected from the group consisting of the following structures (LIST 1): 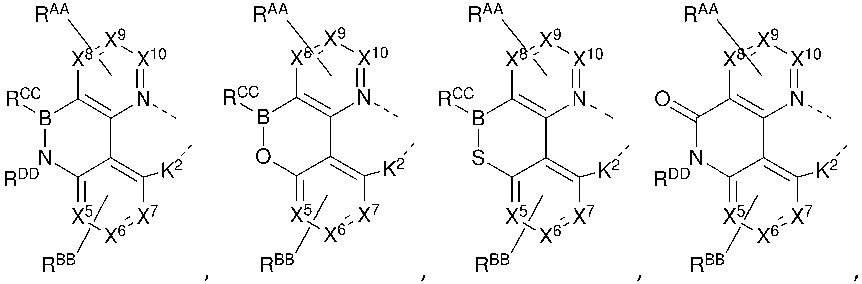 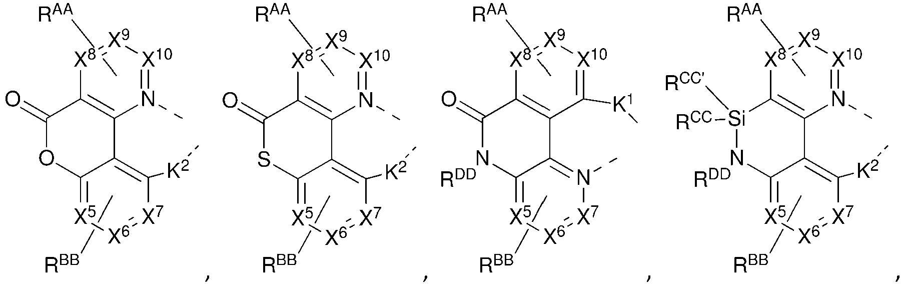 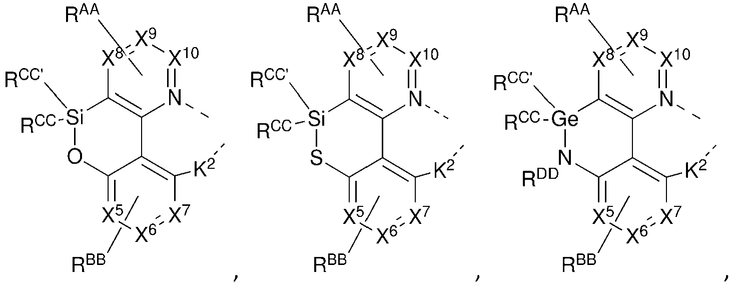 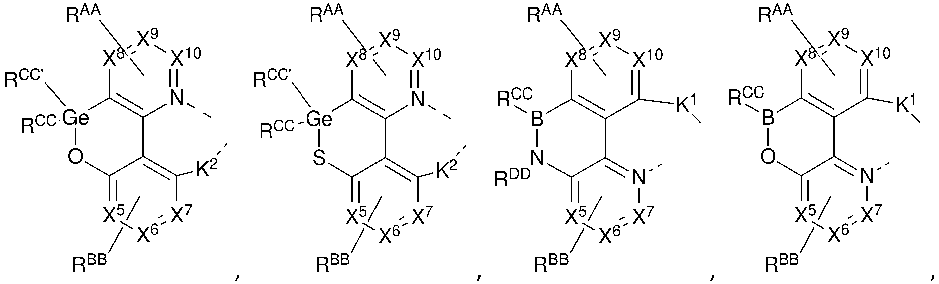 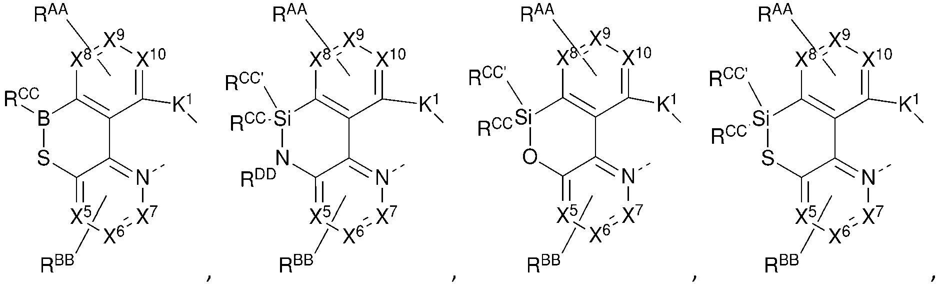 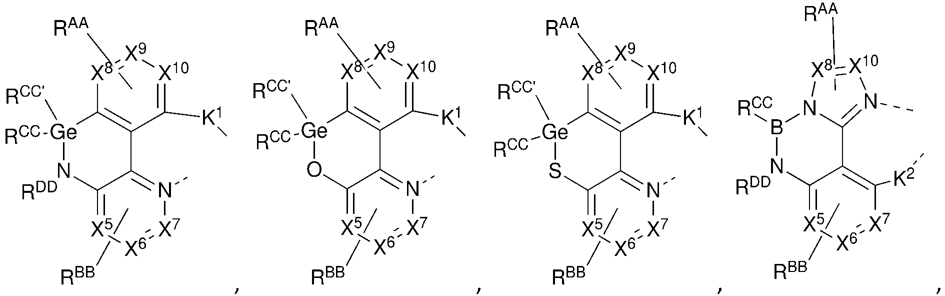 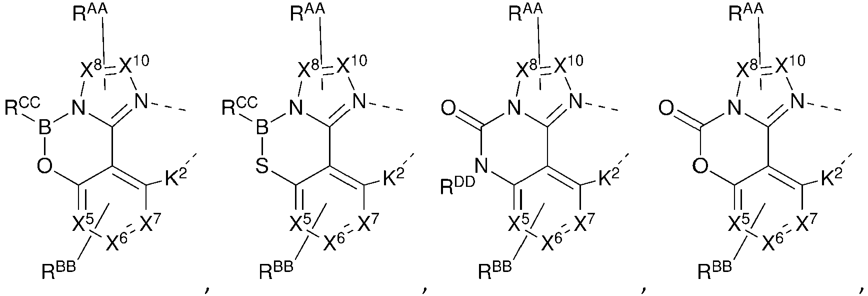 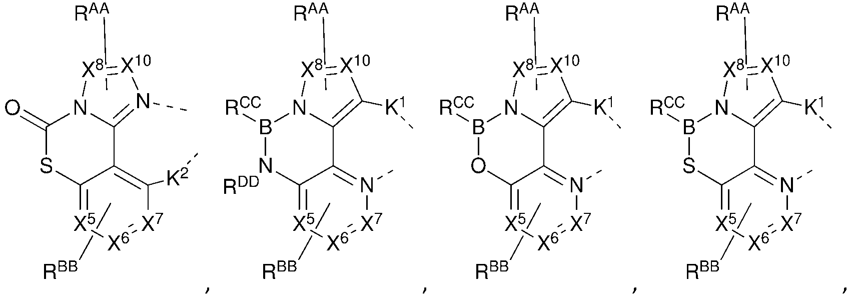 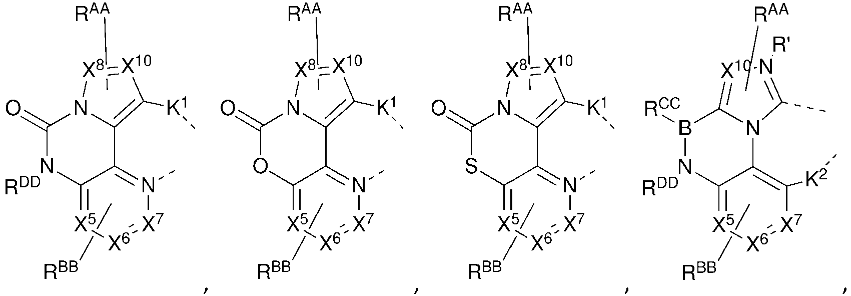 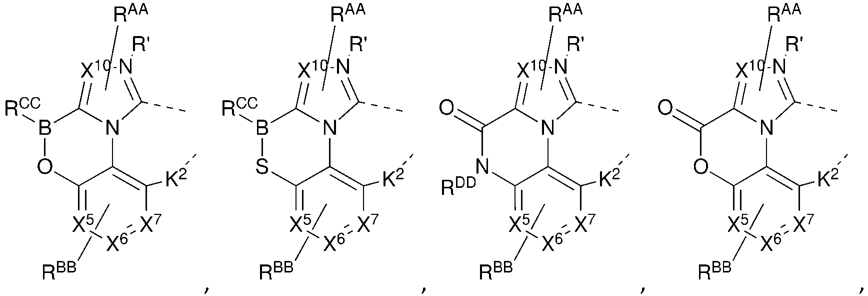 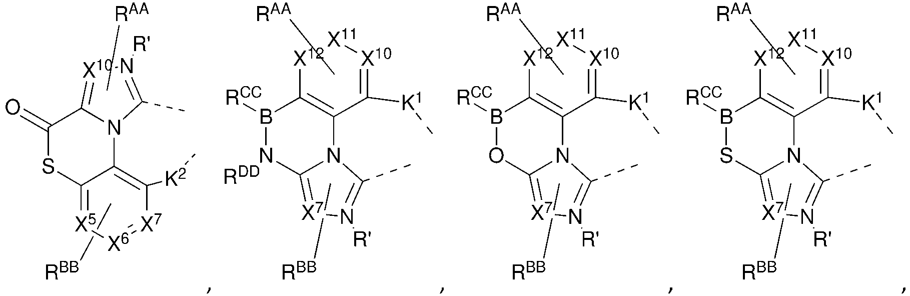 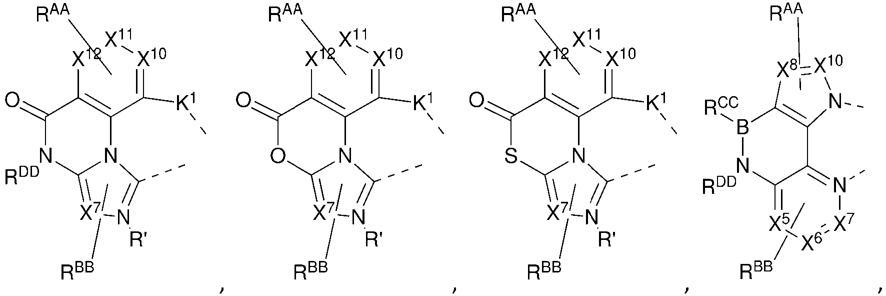 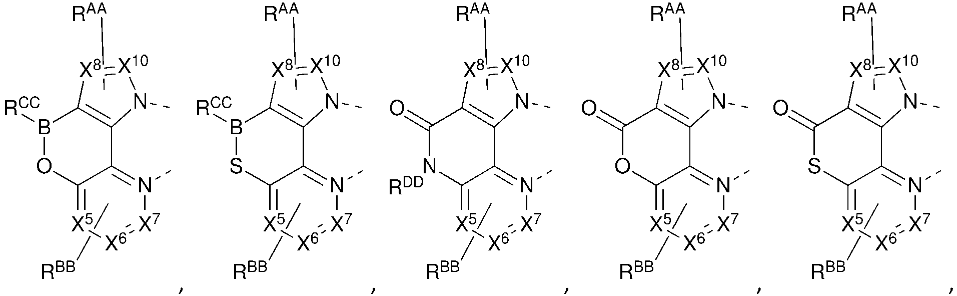 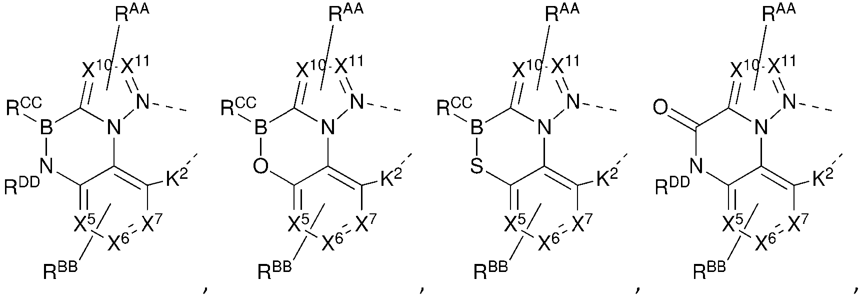 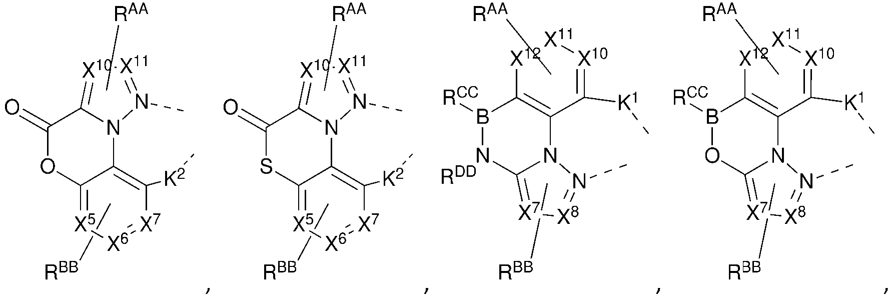 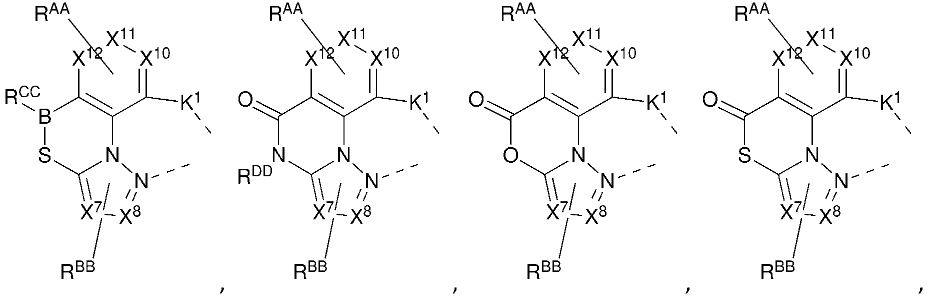 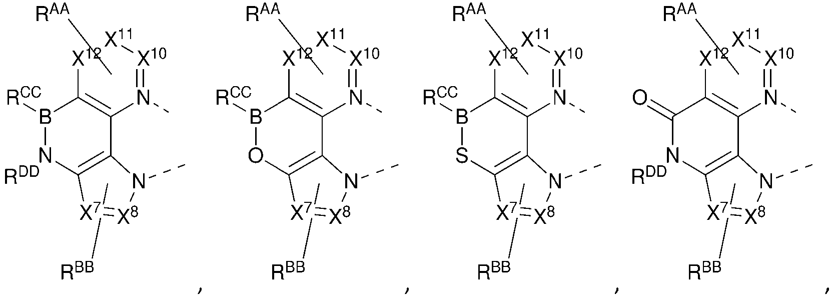 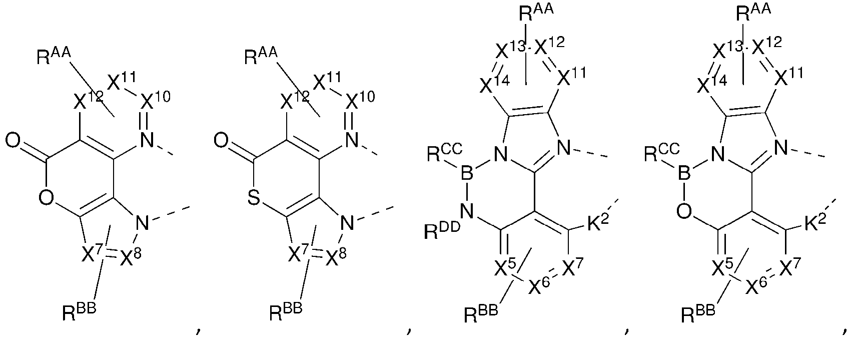 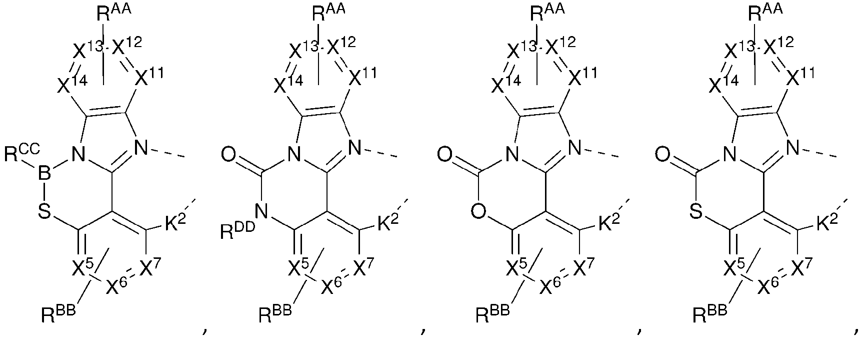 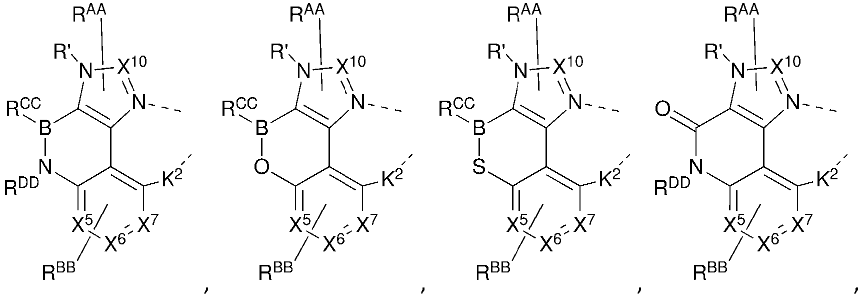 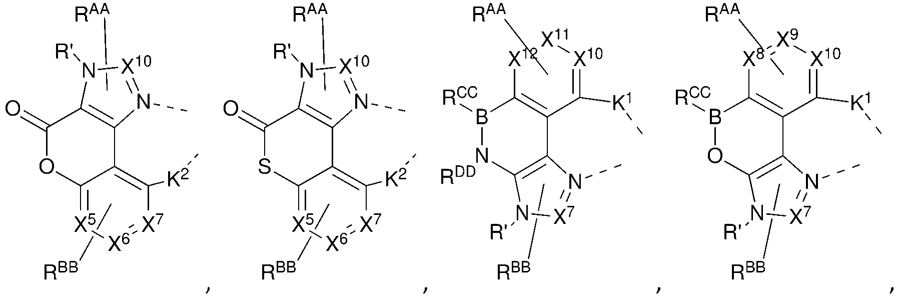 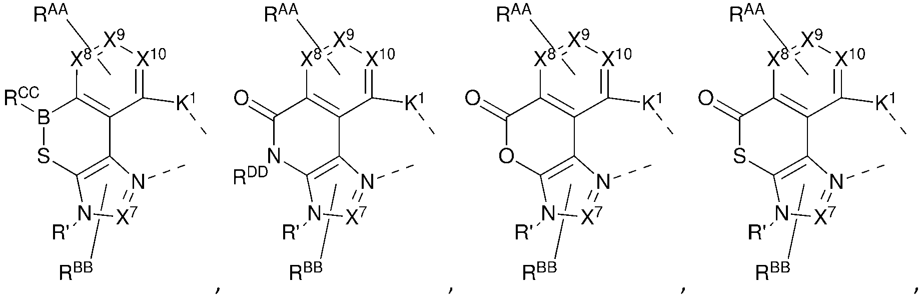 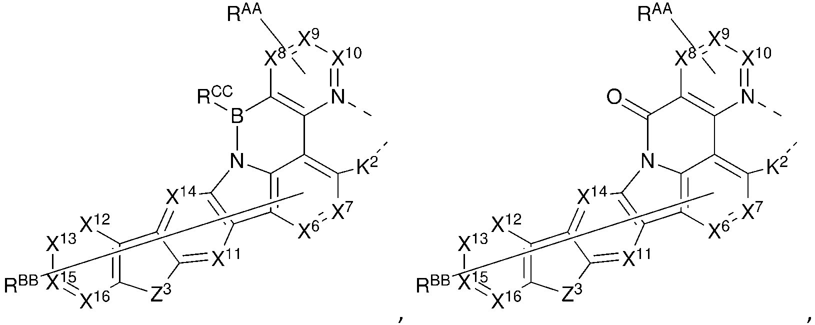 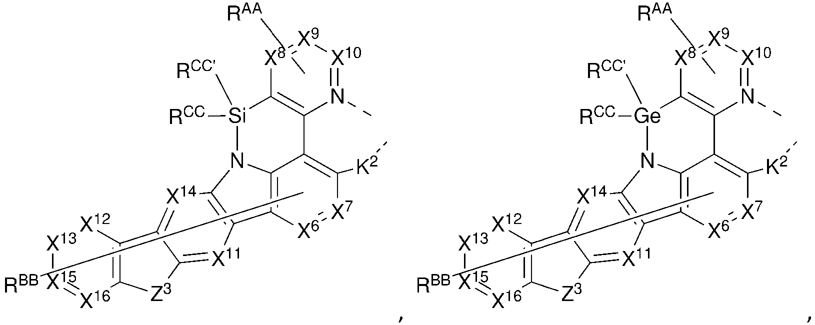 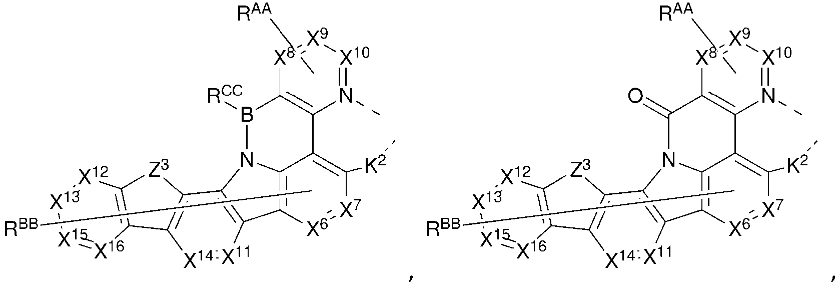 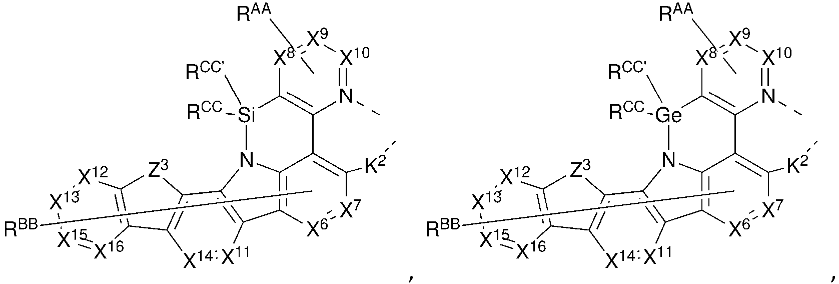 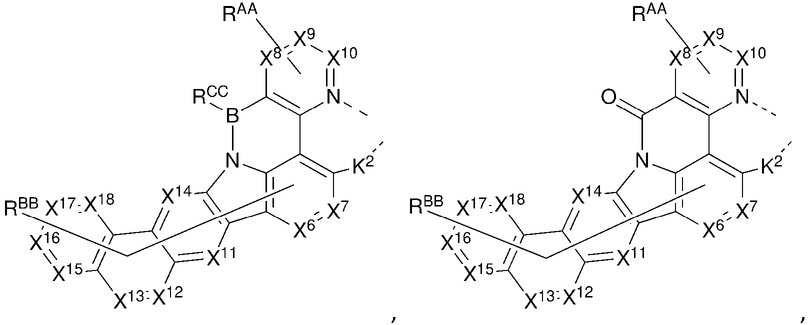 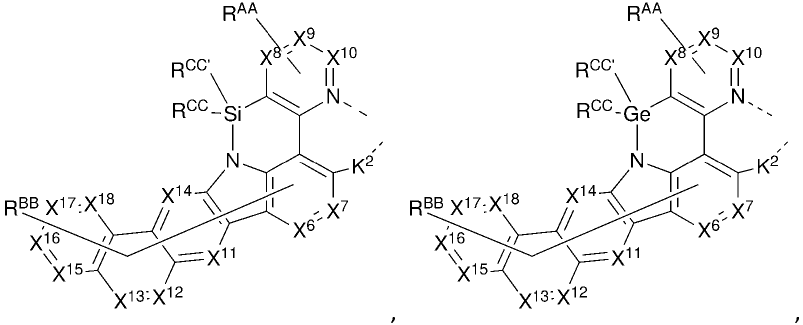 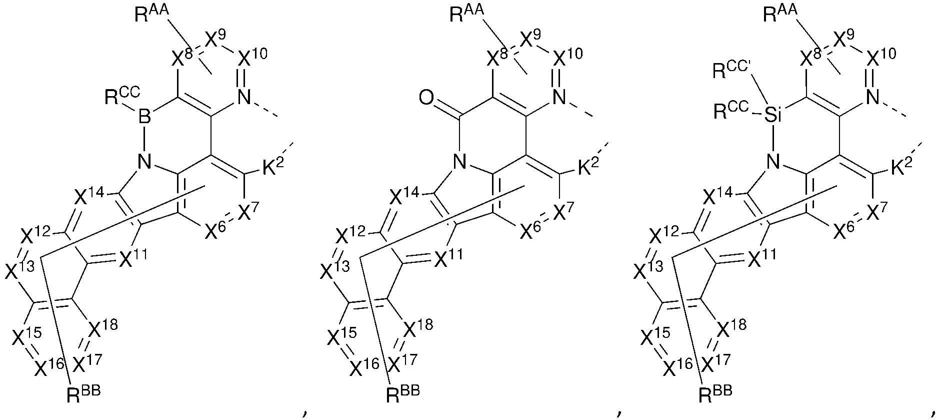 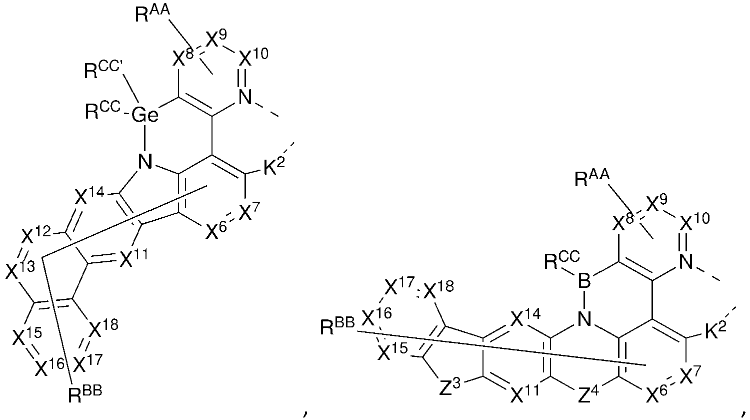 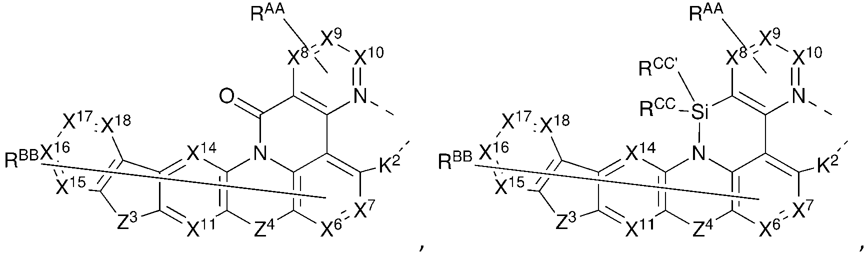 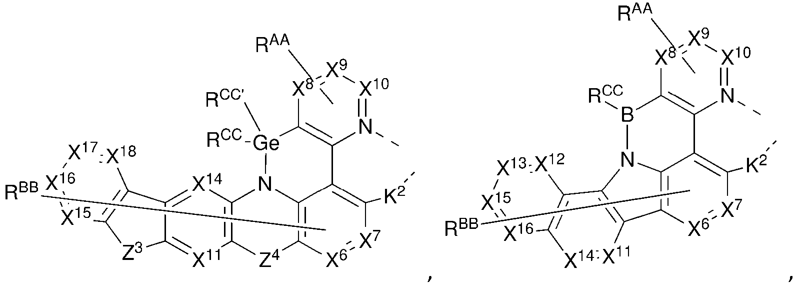 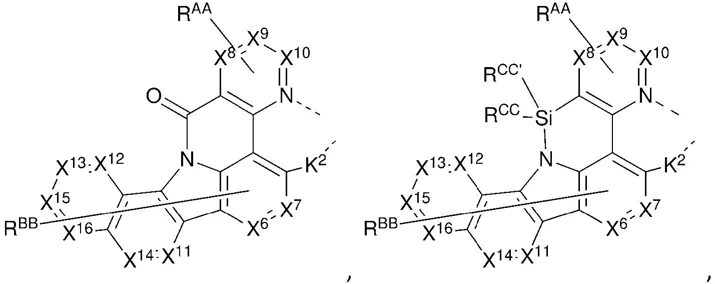 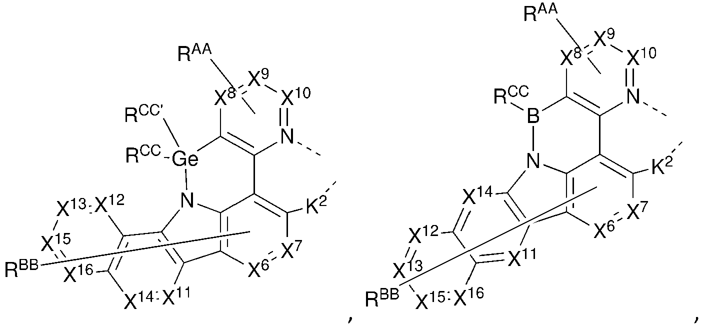 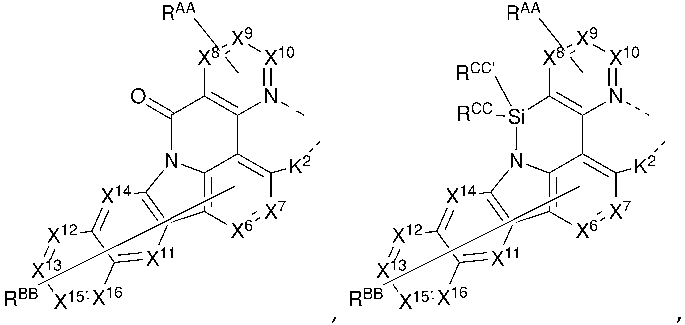 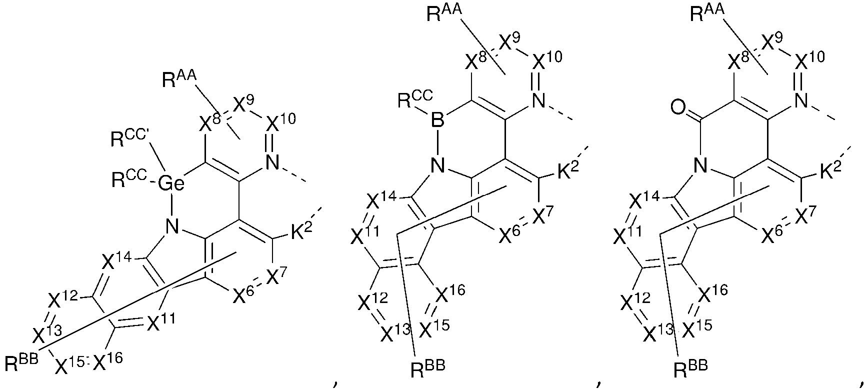 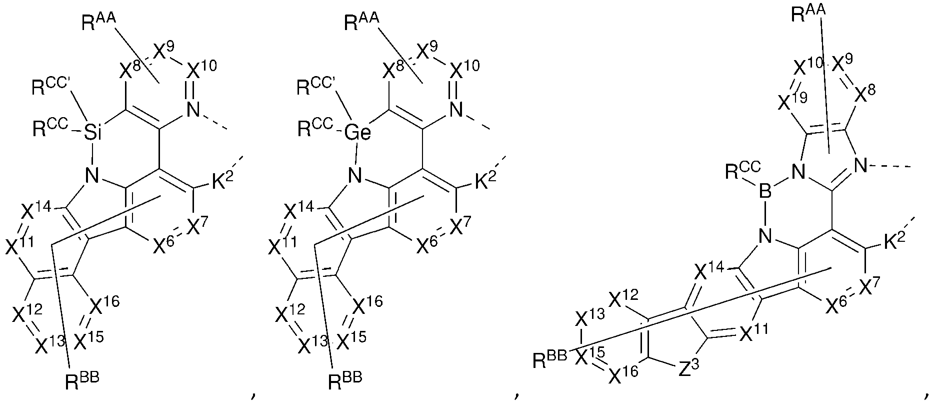 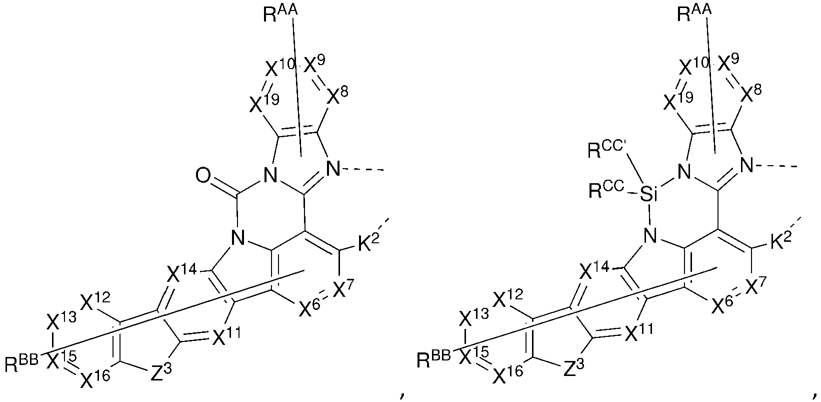 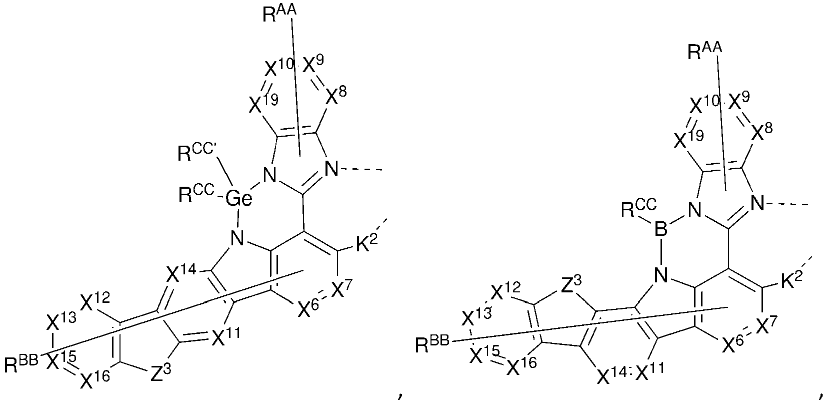 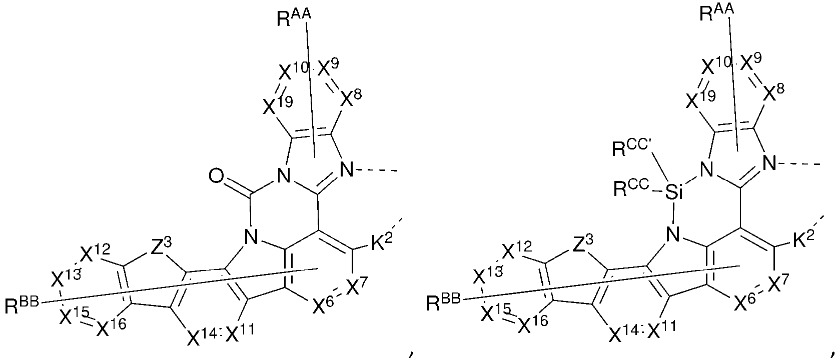 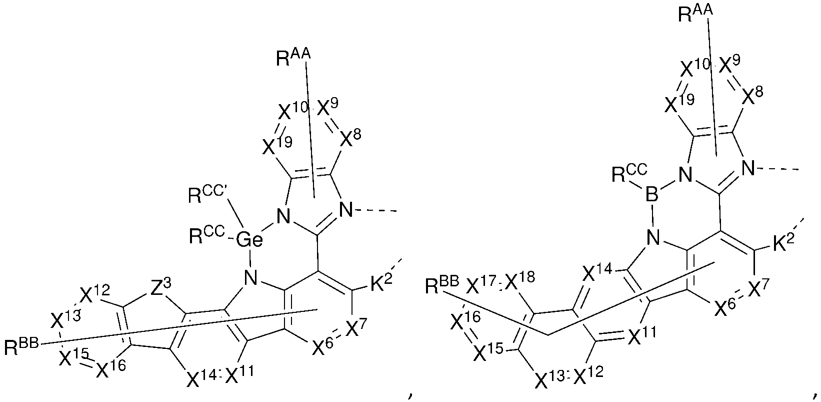 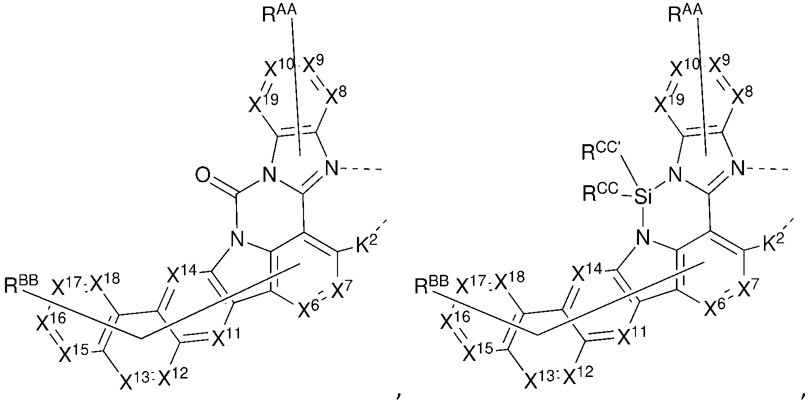 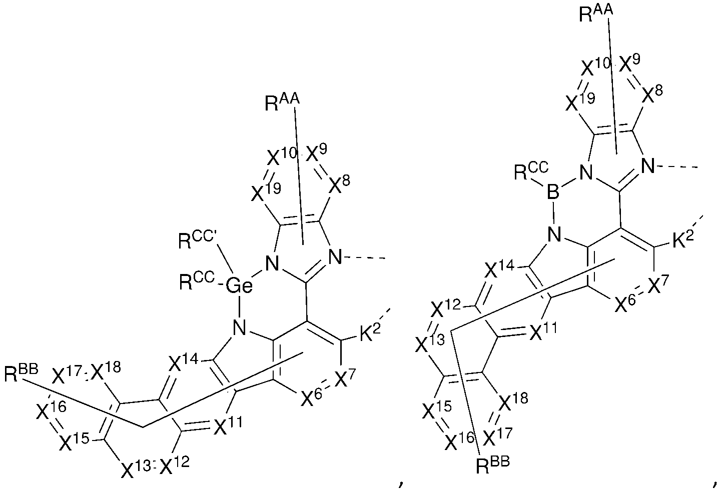 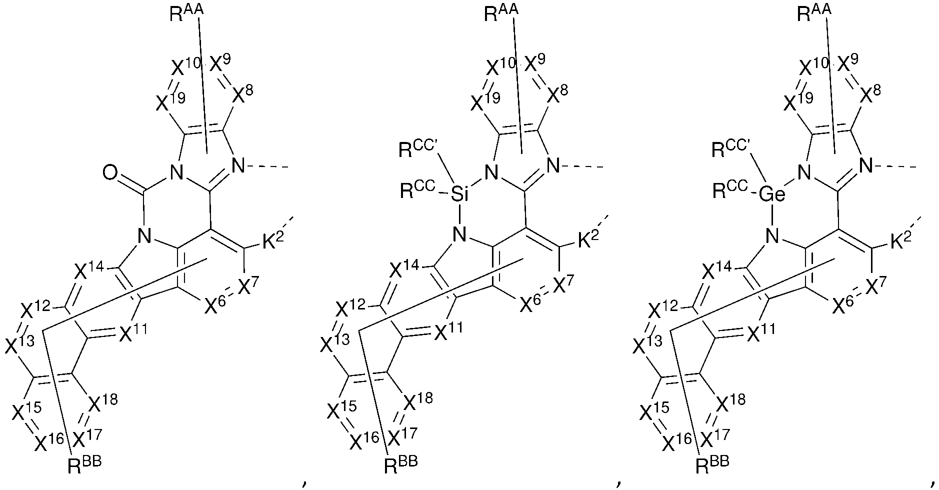 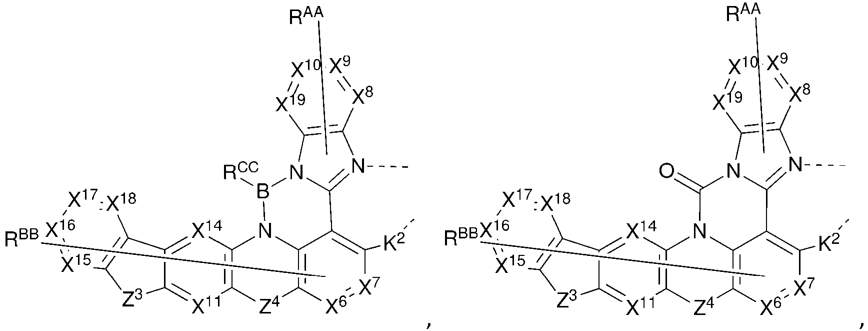 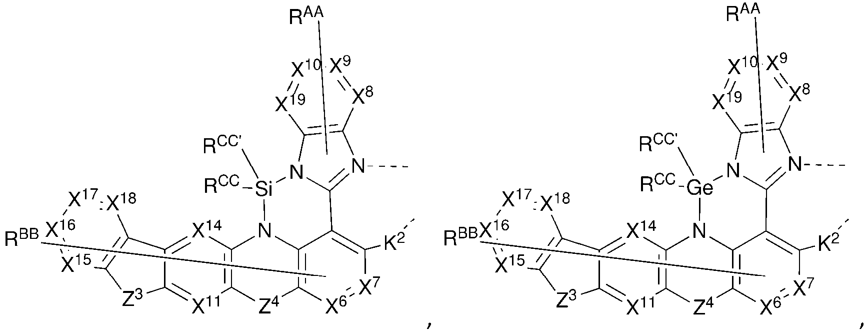 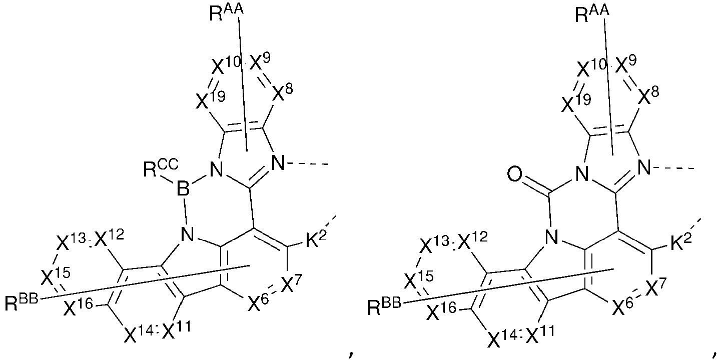 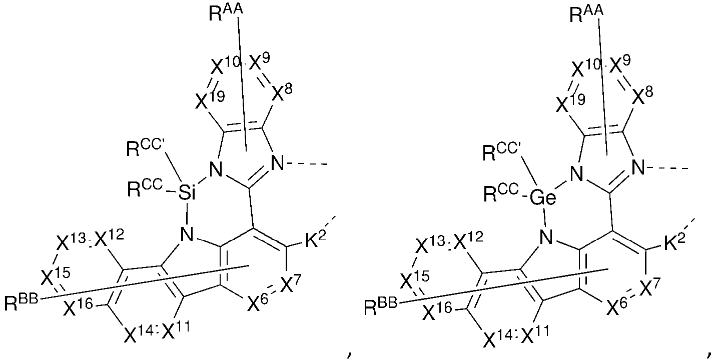 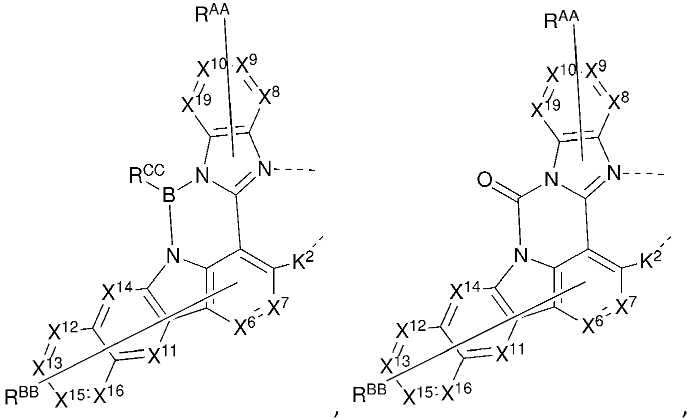 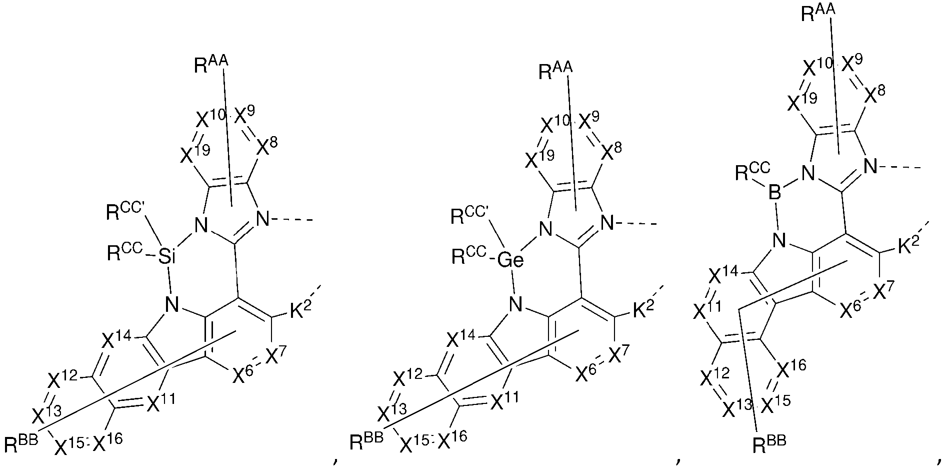 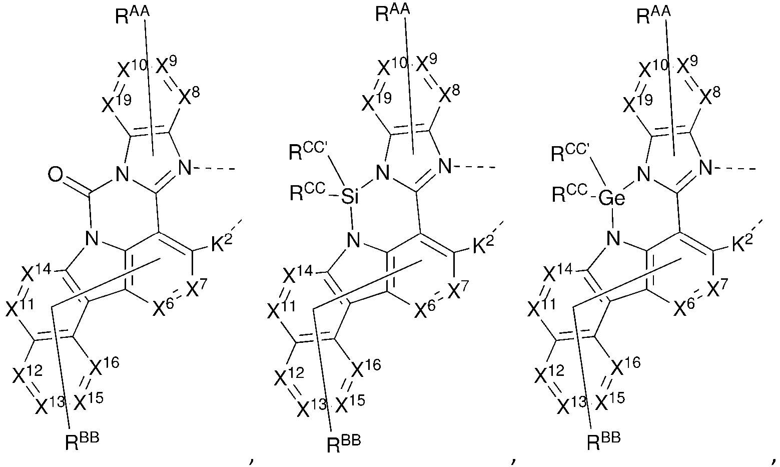 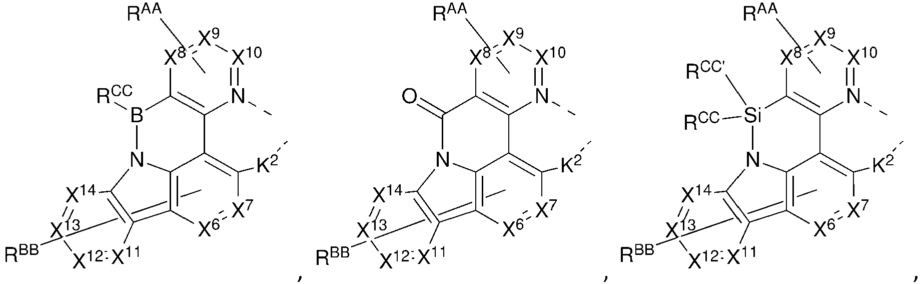 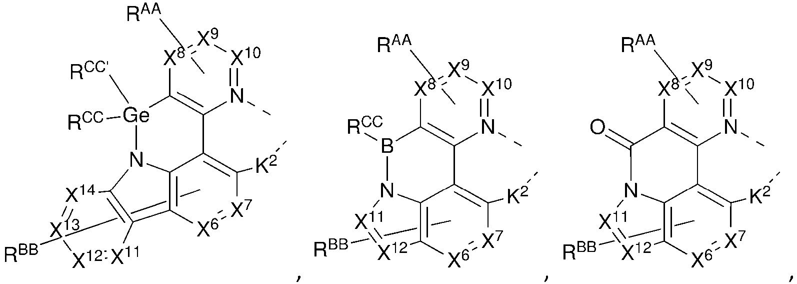 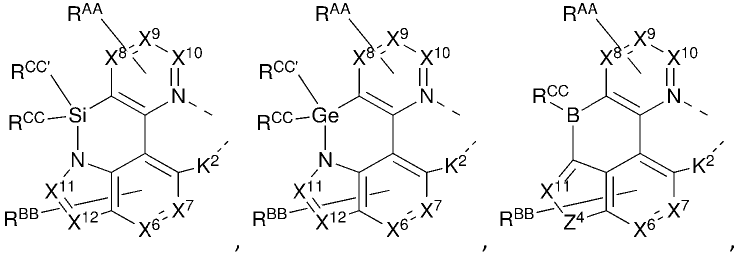 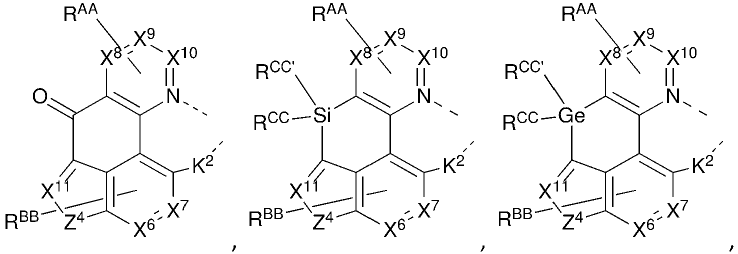 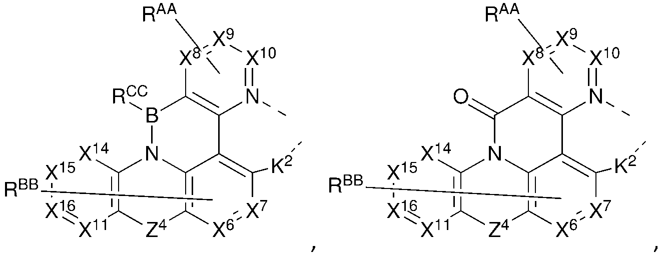 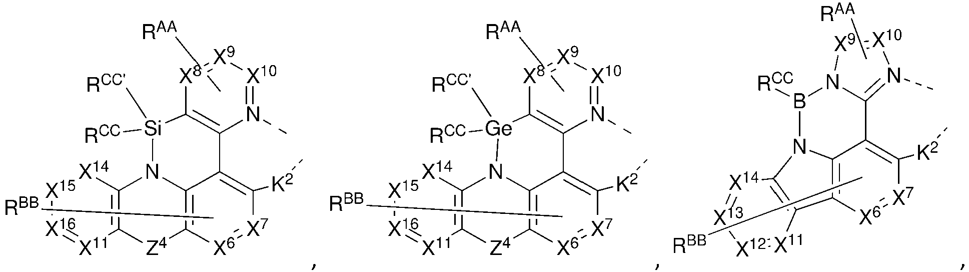 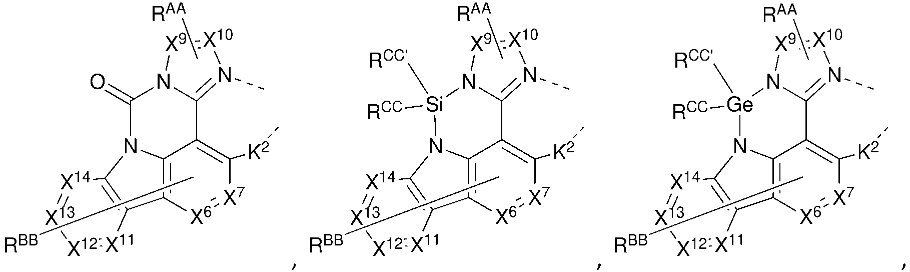 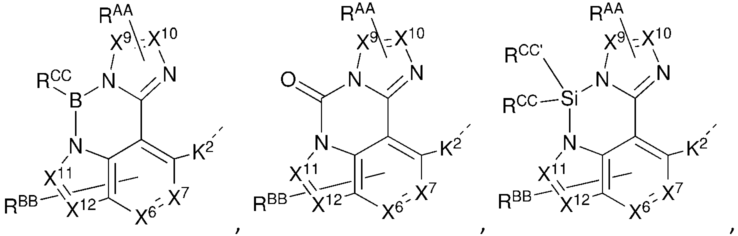 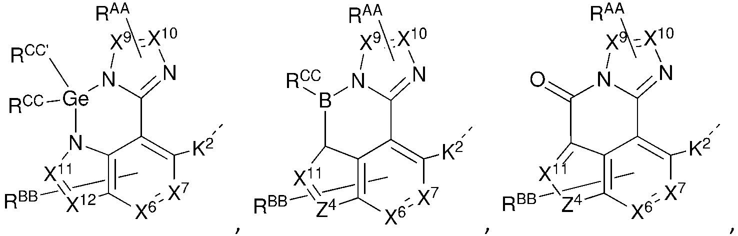 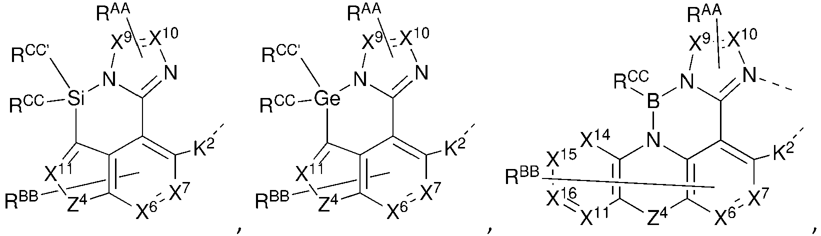 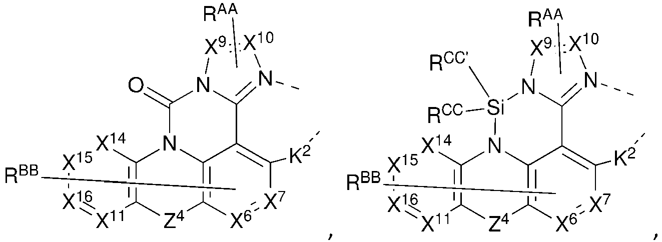 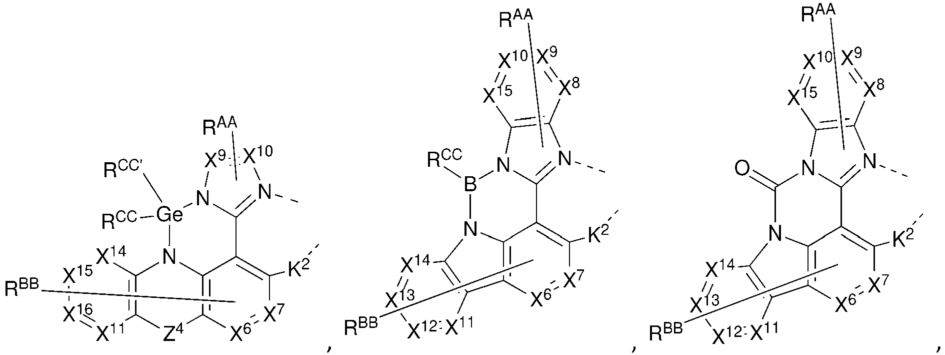 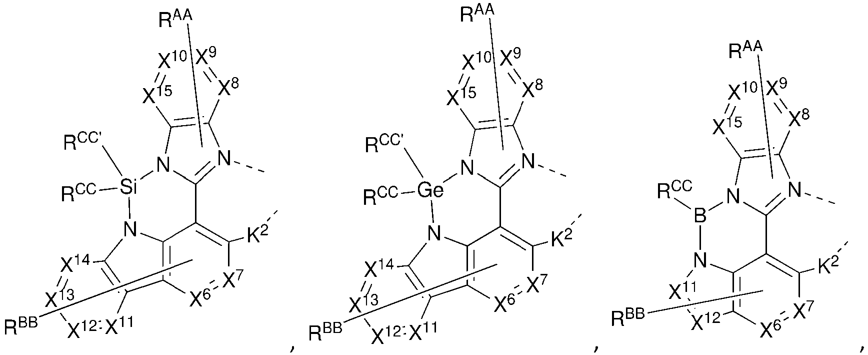 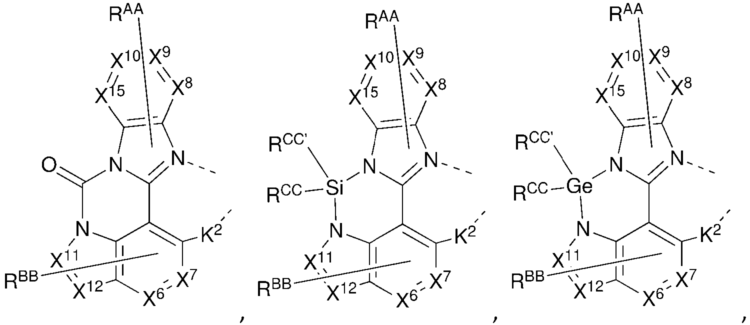 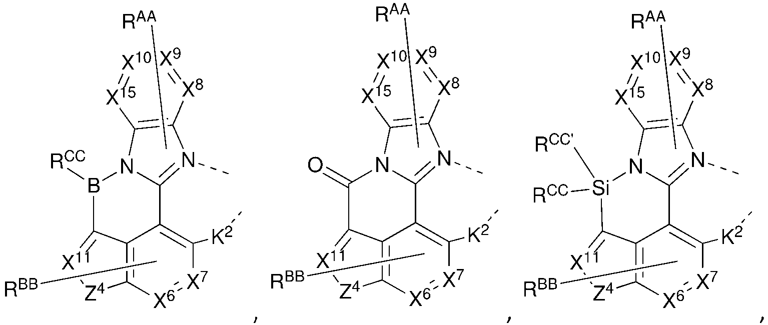 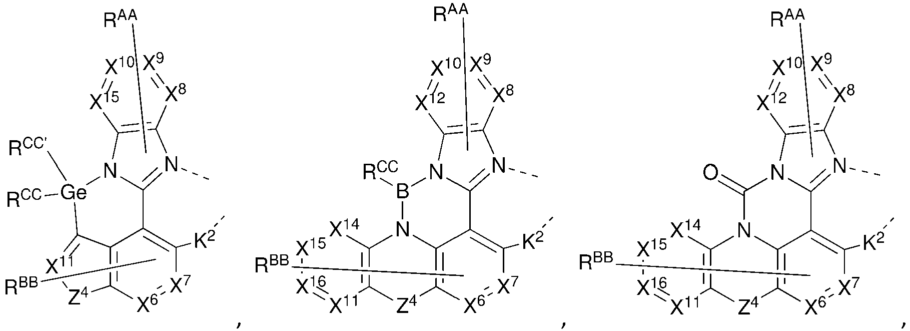 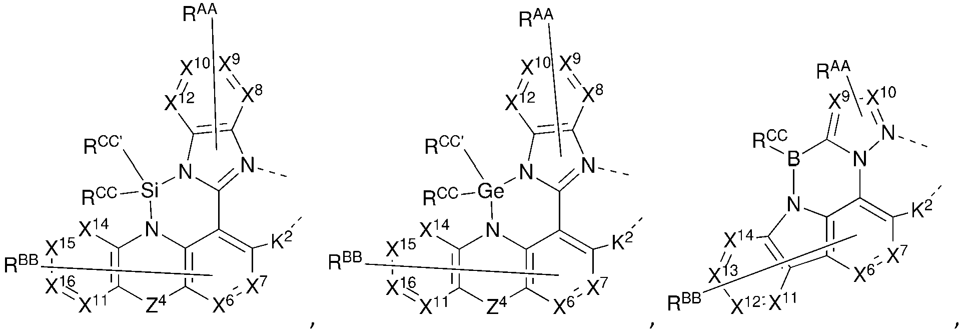 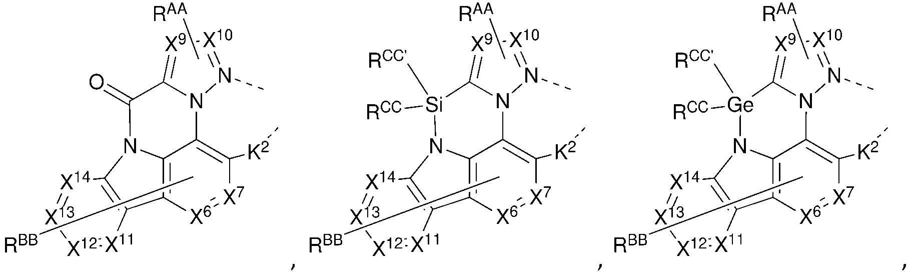 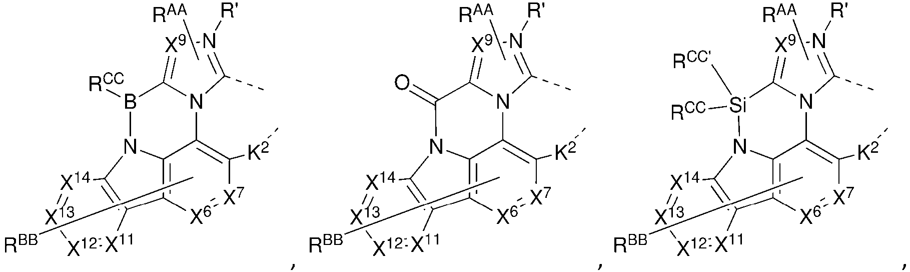 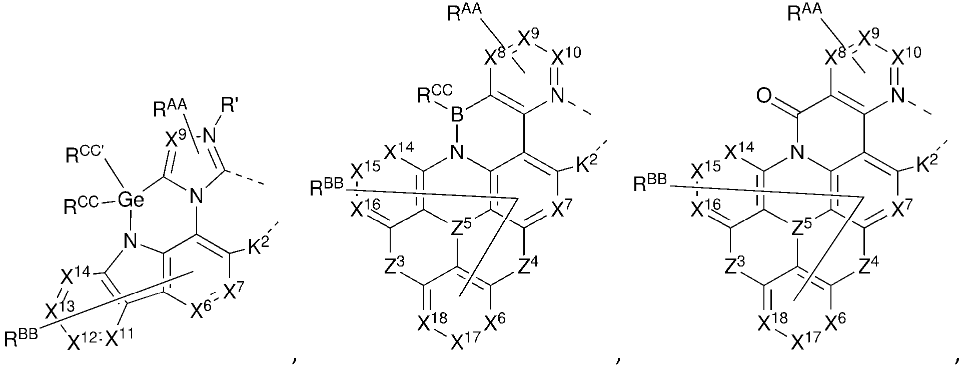 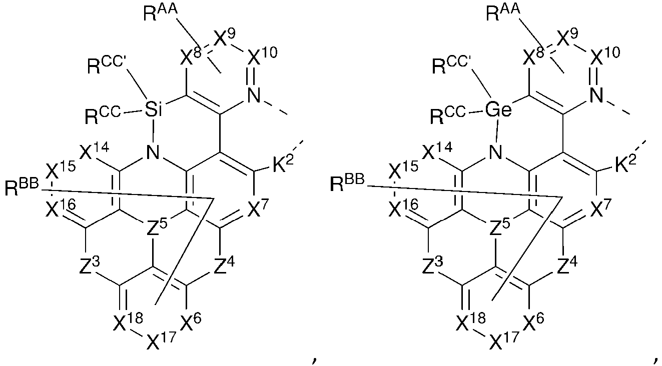 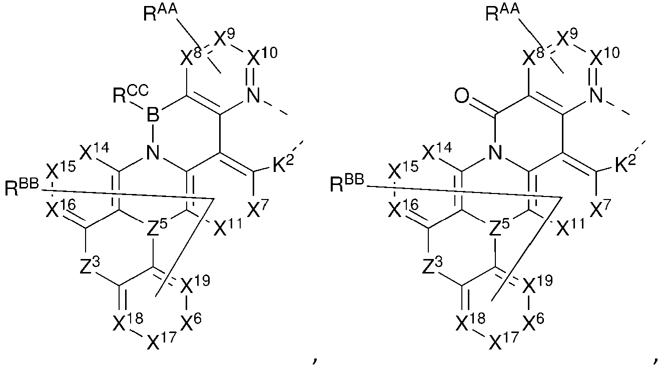 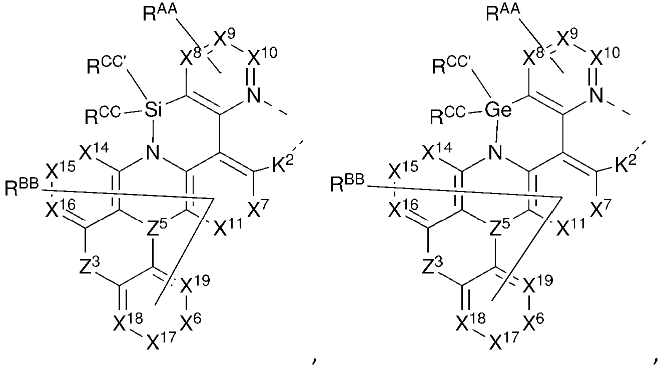 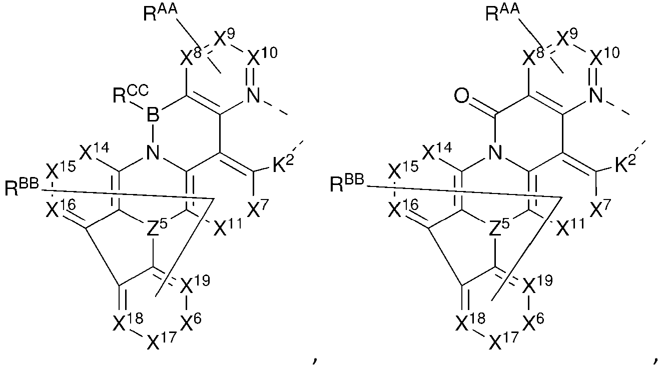 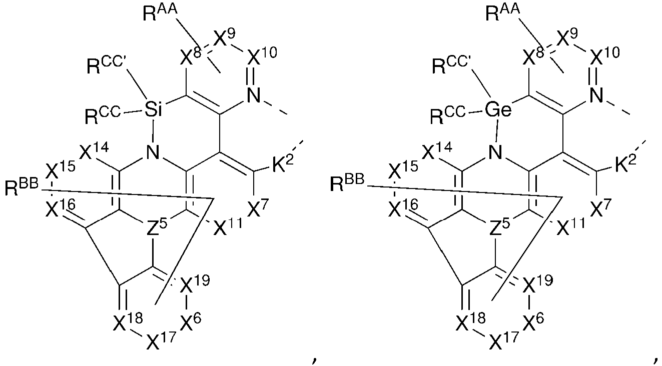 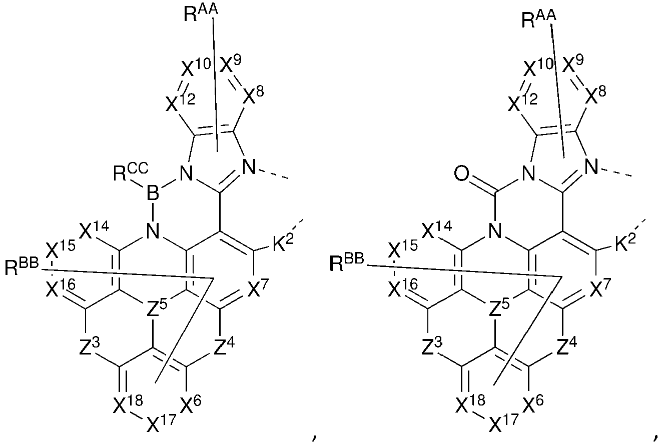 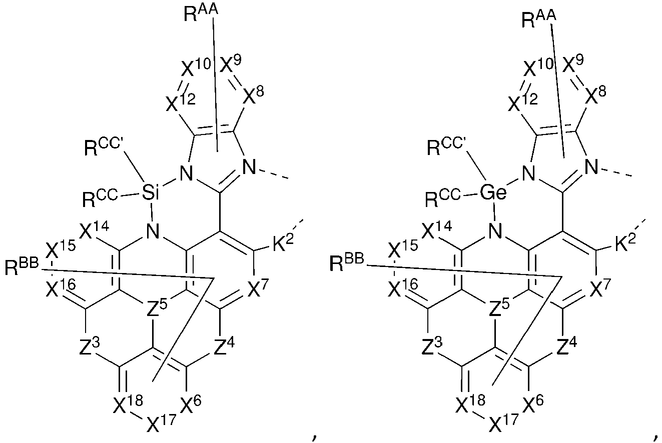 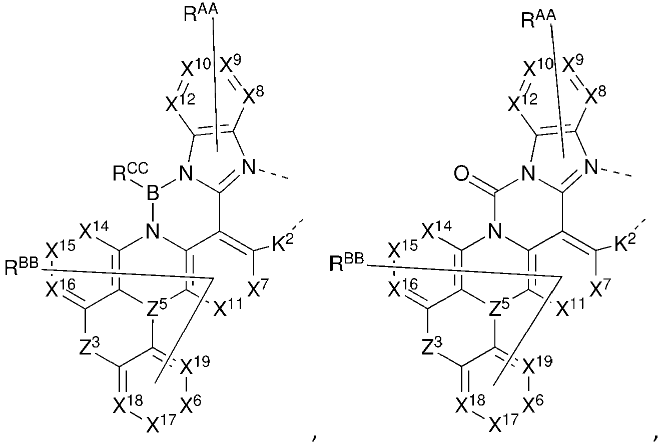 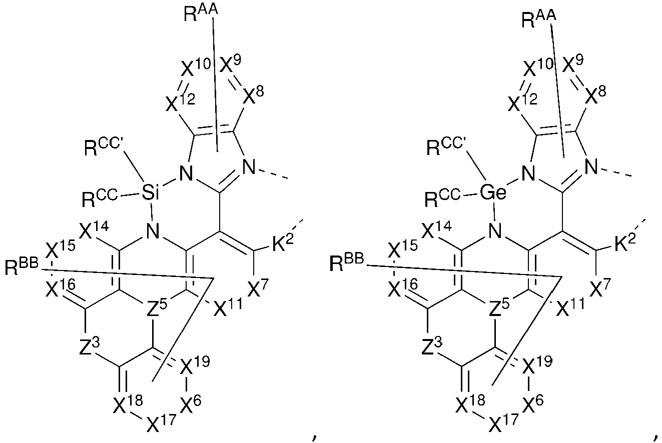 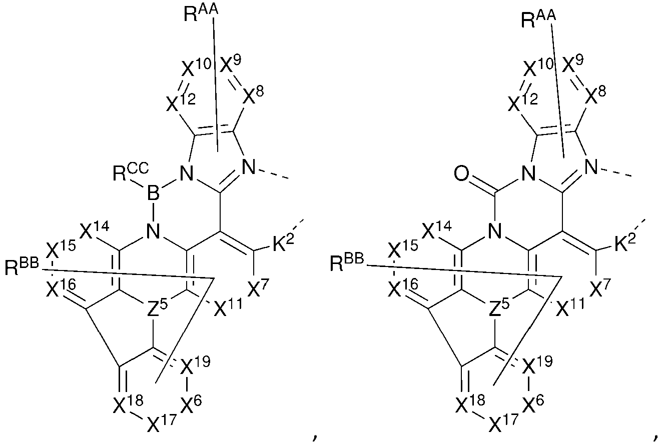 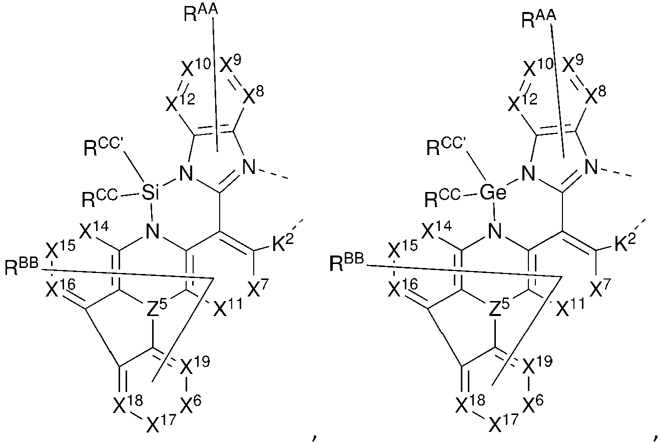 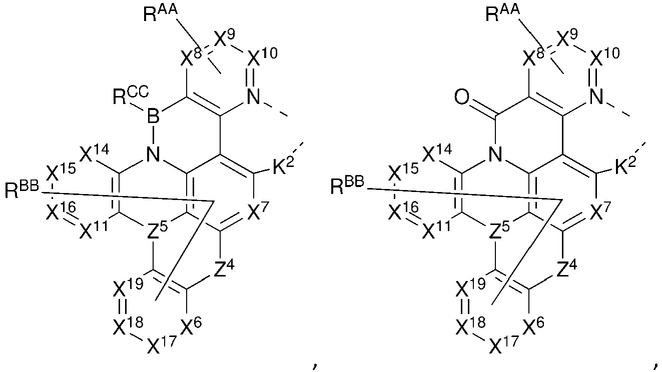 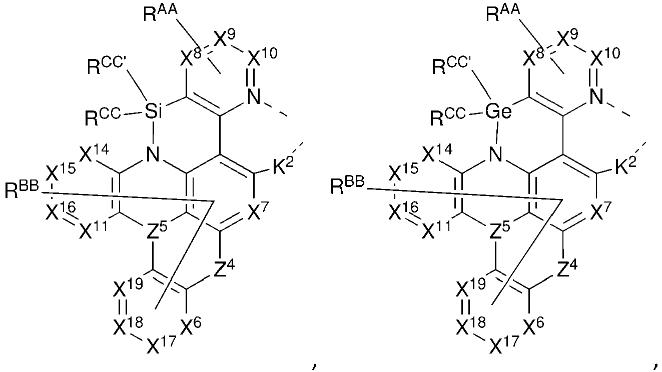 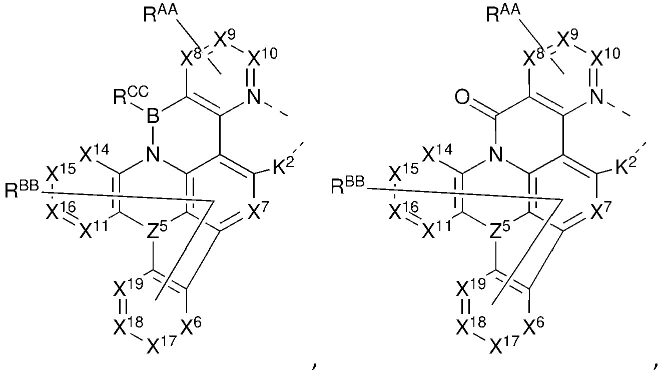 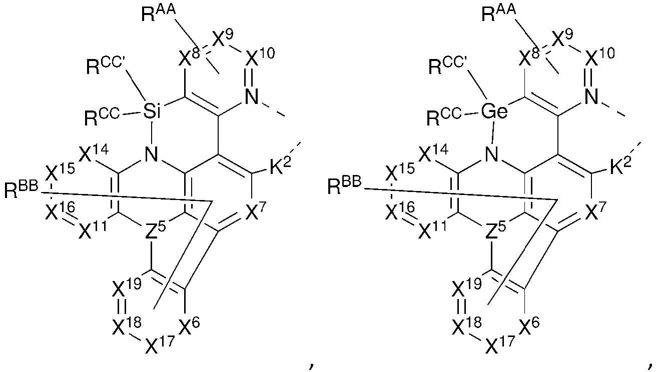 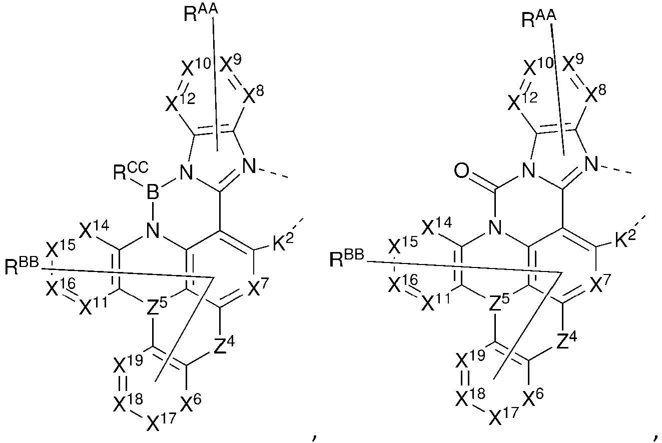 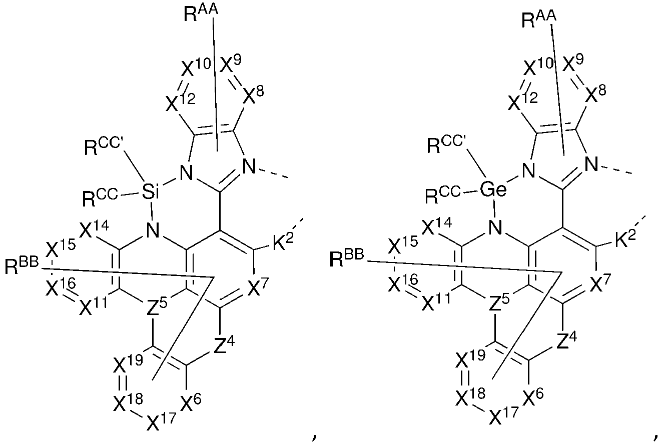 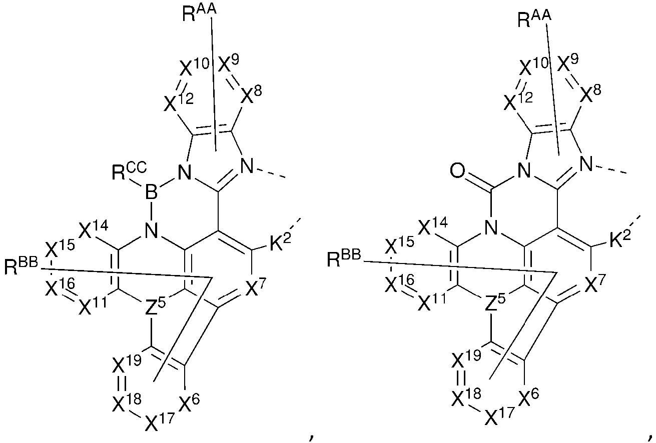 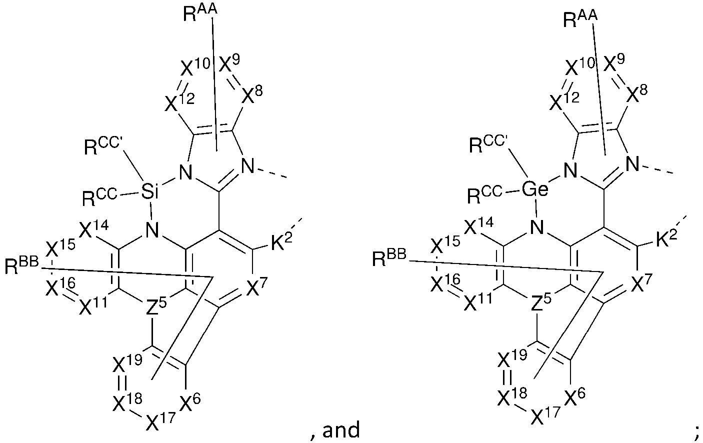
wherein X⁶ to X¹⁹ are each independently C or N;
wherein Z³ and Z⁴ are each independently selected from the group consisting of O, S, NR^{a}, BR^{a} C(R^{a})(R^{b}), and Si(R^{a})(R^{b});
wherein Z⁵ is B or N; and
wherein each R', R^{a}, R^{b}, R^{AA}, R^{BB}, R^{CC}, R^{CC'} and R^{DD} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof.

In some embodiments where ligand L_{A} is a structure selected from LIST 1, at least one R^{a}, R^{b}, R^{AA}, R^{BB}, R^{CC}, R^{CC'}, R^{DD} or R' is selected from the group consisting of the General Substituents defined herein. In some embodiments, at least one R^{AA} is selected from the group consisting of the General Substituents defined herein. In some embodiments, at least one R^{BB} is selected from the group consisting of the General Substituents defined herein. In some embodiments, at least one R^{CC} is selected from the group consisting of the General Substituents defined herein. In some embodiments, at least one R^{CC'} is selected from the group consisting of the General Substituents defined herein. In some embodiments, at least one R^{DD} is selected from the group consisting of the General Substituents defined herein. In some embodiments, at least one R' is selected from the group consisting of the General Substituents defined herein. In some embodiments, at least one R^{a} or R^{b} is selected from the group consisting of the General Substituents defined herein.

In some embodiments where ligand L_{A} is selected from LIST 1, at least one R^{a}, R^{b}, R^{AA}, R^{BB}, R^{CC}, R^{CC'}, R^{DD}, or R^{'} is selected from the group consisting of the Preferred General Substituents defined herein. In some embodiments, at least one R^{AA} is selected from the group consisting of the Preferred General Substituents defined herein. In some embodiments, at least one R^{BB} is selected from the group consisting of the Preferred General Substituents defined herein. In some embodiments, at least one R^{CC} is selected from the group consisting of the Preferred General Substituents defined herein. In some embodiments, at least one R^{CC'} is selected from the group consisting of the Preferred General Substituents defined herein. In some embodiments, at least one R^{DD} is selected from the group consisting of the Preferred General Substituents defined herein. In some embodiments, at least one R' is selected from the group consisting of the Preferred General Substituents defined herein. In some embodiments, at least one R^{a} or R^{b} is selected from the group consisting of the Preferred General Substituents defined herein.

In some embodiments where ligand L_{A} is selected from LIST 1, at least one R^{a}, R^{b}, R^{AA}, R^{BB}, R^{CC}, R^{CC'}, R^{DD}, or R' is partially or fully deuterated. In some embodiments, at least one R^{AA} is partially or fully deuterated. In some embodiments, at least one R^{BB} is partially or fully deuterated. In some embodiments, at least one R^{CC} is partially or fully deuterated. In some embodiments, at least one R^{CC'} is partially or fully deuterated. In some embodiments, at least one R^{DD} is partially or fully deuterated. In some embodiments, at least one R' is partially or fully deuterated. In some embodiments, at least one R^{a} or R ^{b} is partially or fully deuterated.

In some embodiments where ligand L_{A} is selected from LIST 1, at least one R^{AA} is or comprises an electron-withdrawing group from the EWG1 LIST as defined herein. In some embodiments, at least one R^{AA} is or comprises an electron-withdrawing group from the EWG2 LIST as defined herein. In some embodiments, at least one R^{AA} is or comprises an electron-withdrawing group from the EWG3 LIST as defined herein. In some embodiments, at least one R^{AA} is or comprises an electron-withdrawing group from the EWG4 LIST as defined herein. In some embodiments, at least one R^{AA} is or comprises an electron-withdrawing group from the Pi-EWG LIST as defined herein.

In some embodiments where ligand L_{A} is selected from LIST 1, at least one R^{BB} is or comprises an electron-withdrawing group from the EWG1 LIST as defined herein. In some embodiments, at least one R^{BB} is or comprises an electron-withdrawing group from the EWG2 LIST as defined herein. In some embodiments, at least one R^{BB} is or comprises an electron-withdrawing group from the EWG3 LIST as defined herein. In some embodiments, at least one R^{BB} is or comprises an electron-withdrawing group from the EWG4 LIST as defined herein. In some embodiments, at least one R^{BB} is or comprises an electron-withdrawing group from the Pi-EWG LIST as defined herein.

In some embodiments where ligand L_{A} is selected from LIST 1, at least one R^{CC} is or comprises an electron-withdrawing group from the EWG1 LIST as defined herein. In some embodiments, at least one R^{CC} is or comprises an electron-withdrawing group from the EWG2 LIST as defined herein. In some embodiments, at least one R^{CC} is or comprises an electron-withdrawing group from the EWG3 LIST as defined herein. In some embodiments, at least one R^{CC} is or comprises an electron-withdrawing group from the EWG4 LIST as defined herein. In some embodiments, at least one R^{CC} is or comprises an electron-withdrawing group from the Pi-EWG LIST as defined herein.

In some embodiments where ligand L_{A} is selected from LIST 1, at least one R^{CC'} is or comprises an electron-withdrawing group from the EWG1 LIST as defined herein. In some embodiments, at least one R^{CC'} is or comprises an electron-withdrawing group from the EWG2 LIST as defined herein. In some embodiments, at least one R^{CC'} is or comprises an electron-withdrawing group from the EWG3 LIST as defined herein. In some embodiments, at least one R^{CC'} is or comprises an electron-withdrawing group from the EWG4 LIST as defined herein. In some embodiments, at least one R^{CC'} is or comprises an electron-withdrawing group from the Pi-EWG LIST as defined herein.

In some embodiments where ligand L_{A} is selected from LIST 1, at least one R^{DD} is or comprises an electron-withdrawing group from the EWG1 LIST as defined herein. In some embodiments, at least one R^{DD} is or comprises an electron-withdrawing group from the EWG2 LIST as defined herein. In some embodiments, at least one R^{DD} is or comprises an electron-withdrawing group from the EWG3 LIST as defined herein. In some embodiments, at least one R^{DD} is or comprises an electron-withdrawing group from the EWG4 LIST as defined herein. In some embodiments, at least one R^{DD} is or comprises an electron-withdrawing group from the Pi-EWG LIST as defined herein.

In some embodiments where ligand L_{A} is selected from LIST 1, at least one R' is or comprises an electron-withdrawing group from the EWG1 LIST as defined herein. In some embodiments, at least one R' is or comprises an electron-withdrawing group from the EWG2 LIST as defined herein. In some embodiments, at least one R' is or comprises an electron-withdrawing group from the EWG3 LIST as defined herein. In some embodiments, at least one R' is or comprises an electron-withdrawing group from the EWG4 LIST as defined herein. In some embodiments, at least one R' is or comprises an electron-withdrawing group from the Pi-EWG LIST as defined herein.

In some embodiments where ligand L_{A} is selected from LIST 1, at least one R^{a} or R^{b} is or comprises an electron-withdrawing group from the EWG1 LIST as defined herein. In some embodiments, at least one R^{a} or R^{b} is or comprises an electron-withdrawing group from the EWG2 LIST as defined herein. In some embodiments, at least one R^{a} or R^{b} is or comprises an electron-withdrawing group from the EWG3 LIST as defined herein. In some embodiments, at least one R^{a} or R^{b} is or comprises an electron-withdrawing group from the EWG4 LIST as defined herein. In some embodiments, at least one R^{a} or R^{b} is or comprises an electron-withdrawing group from the Pi-EWG LIST as defined herein.

In some embodiments, the ligand L_{A} is selected from the group consisting of the following structures (LIST 2): 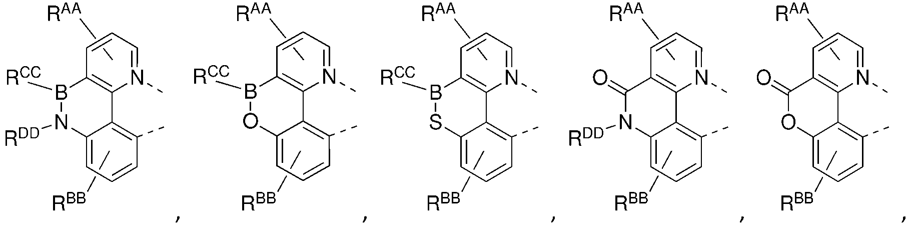 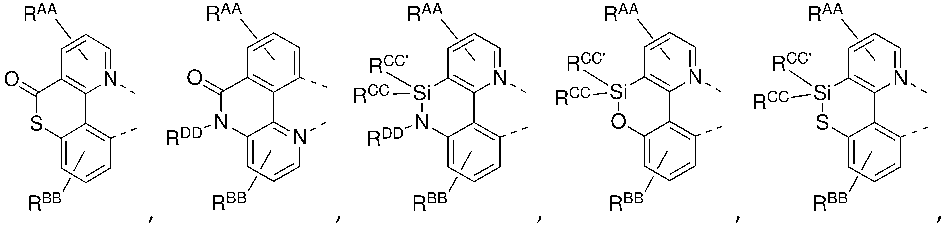 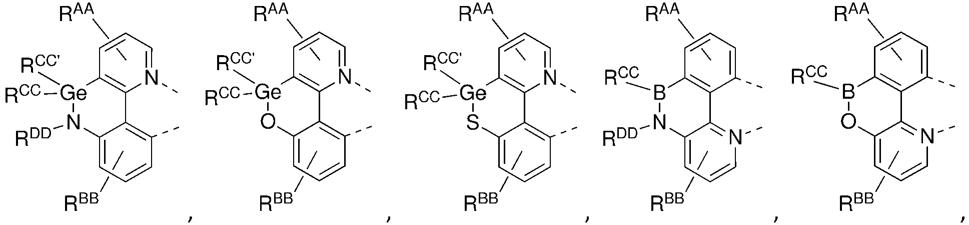 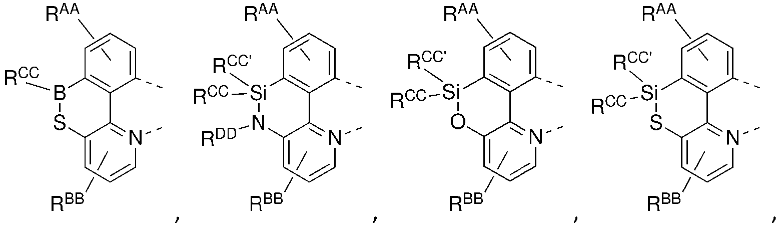 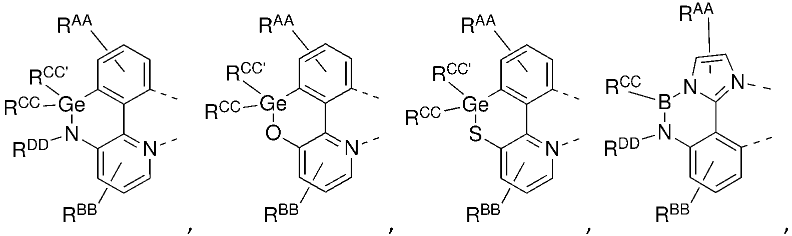 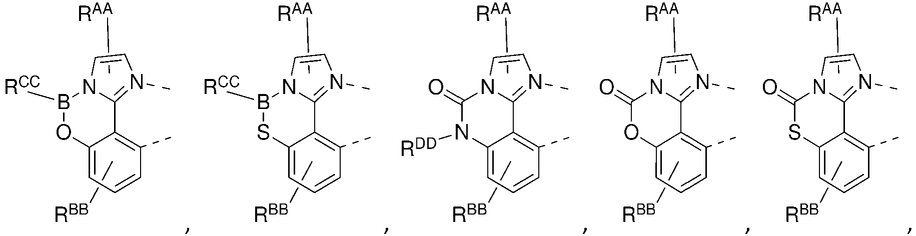 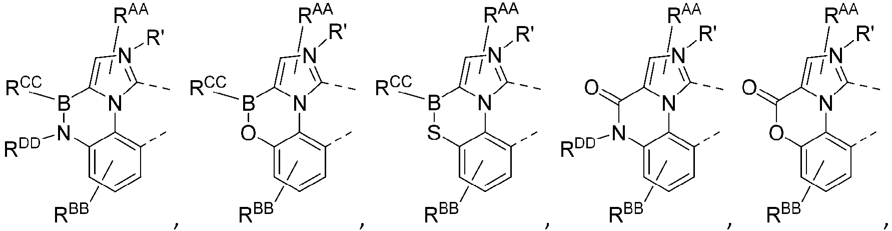 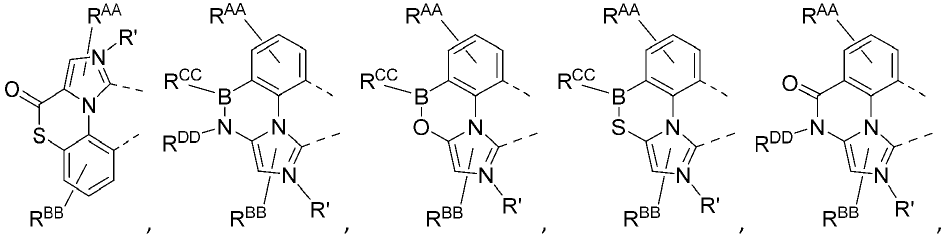 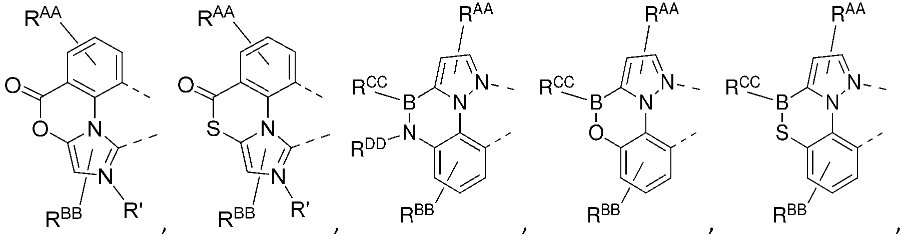 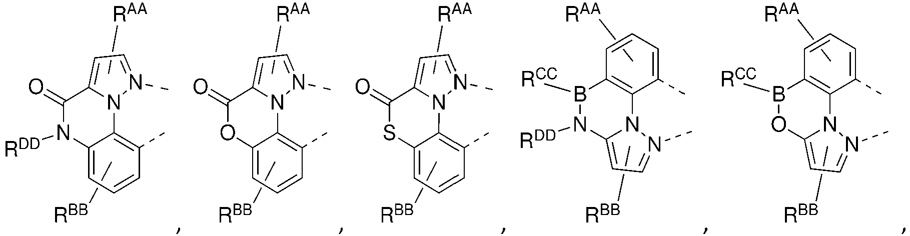 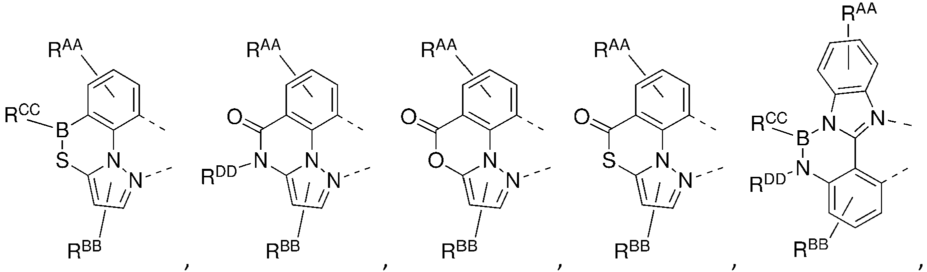 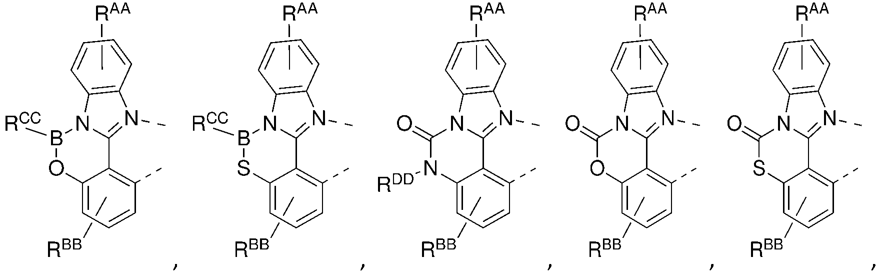 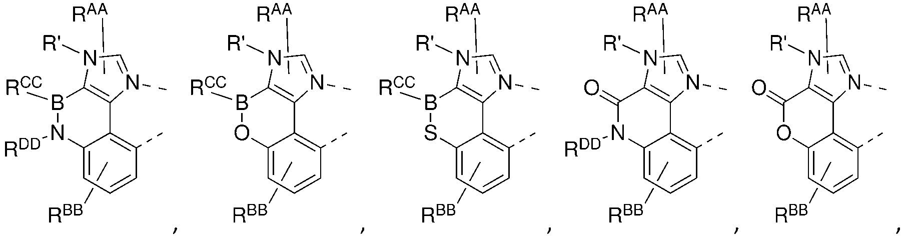 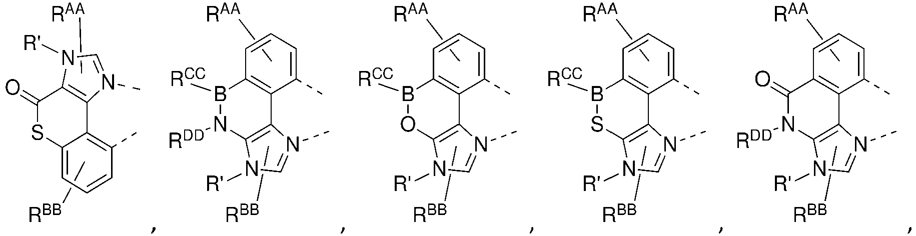 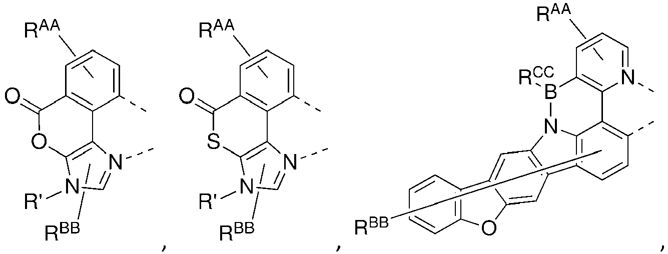 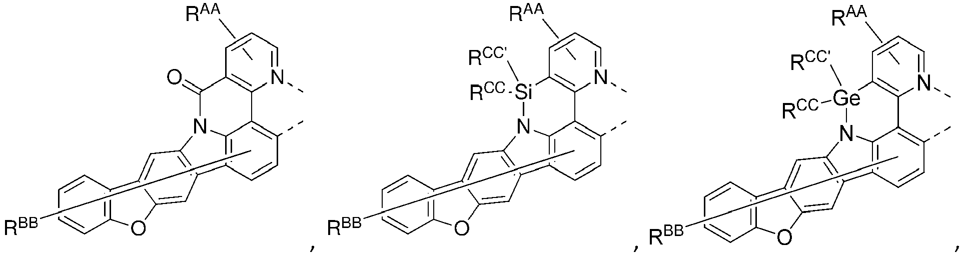 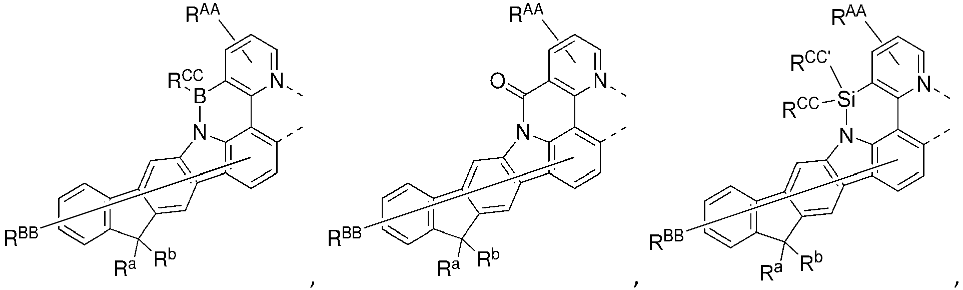 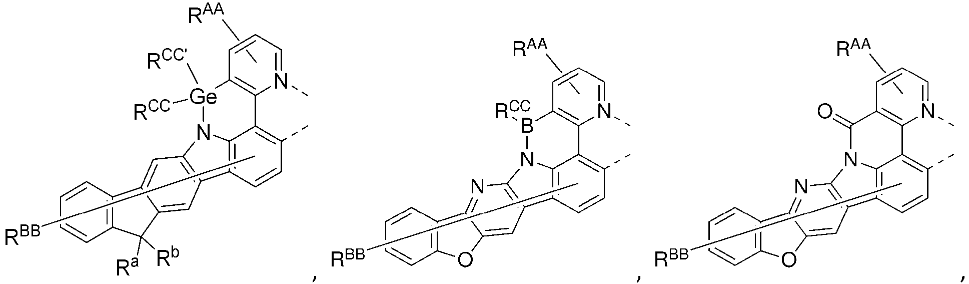 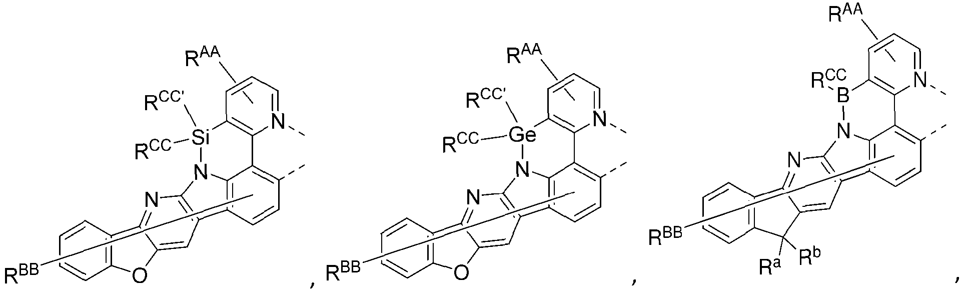 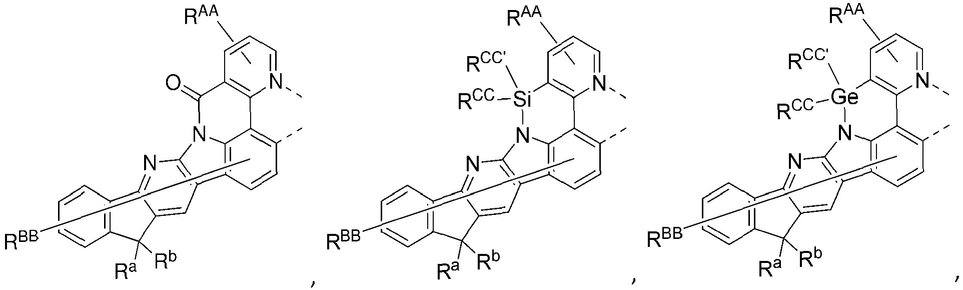 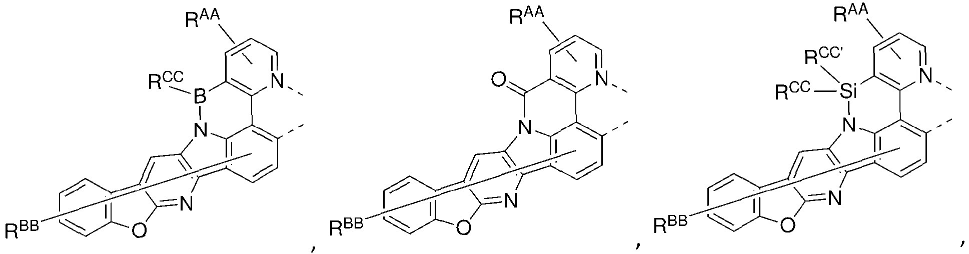 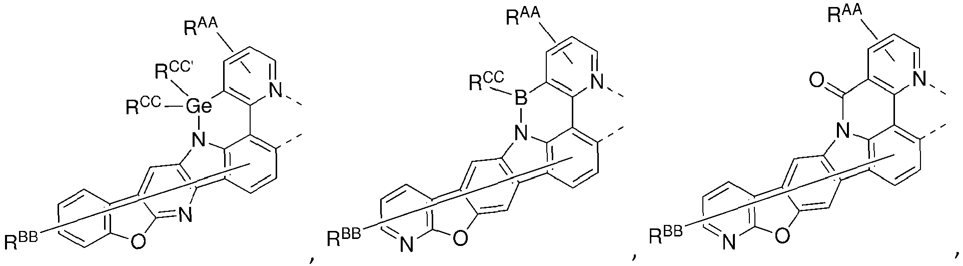 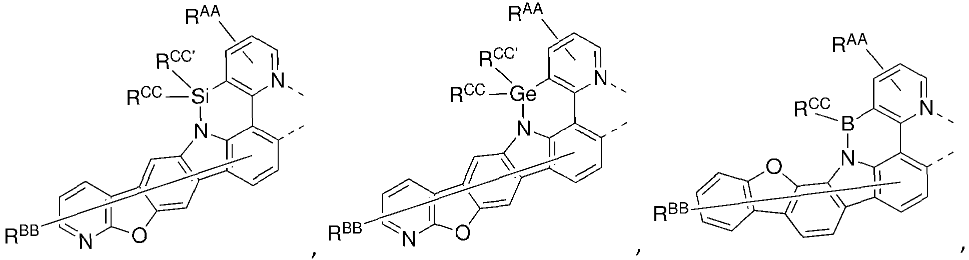 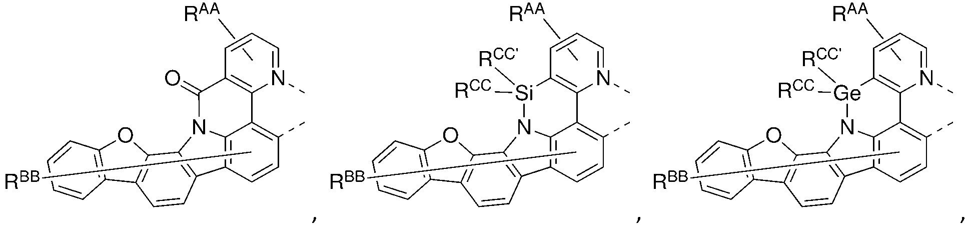 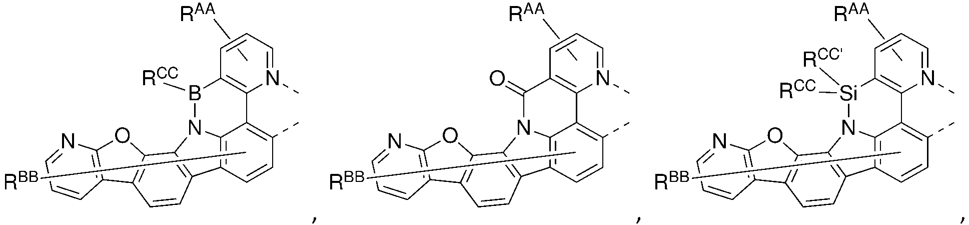 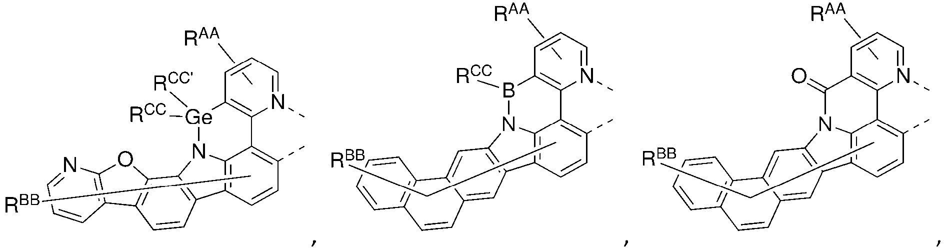 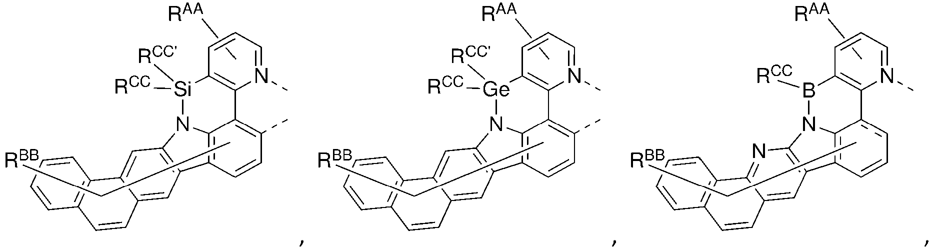 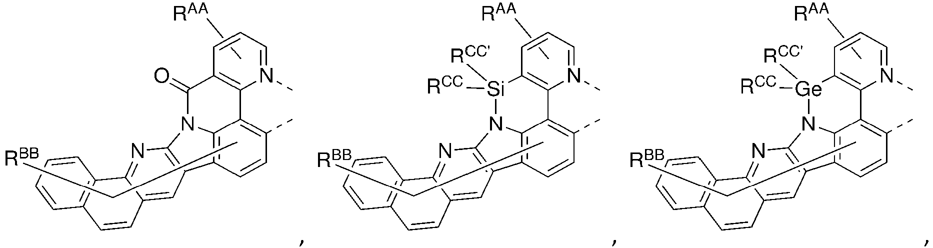 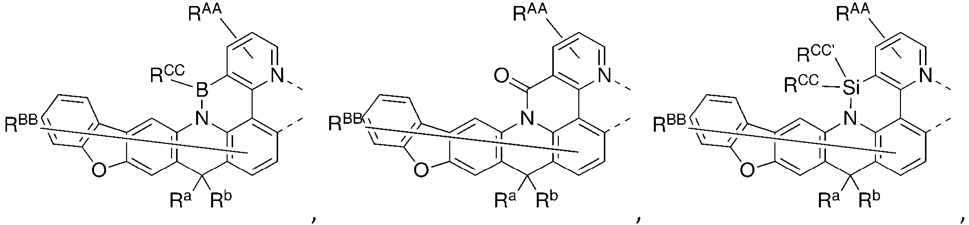 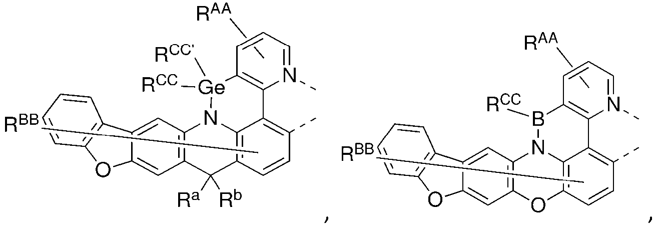 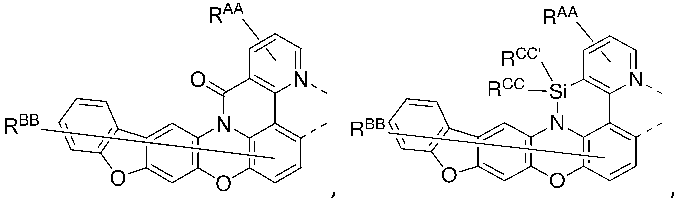 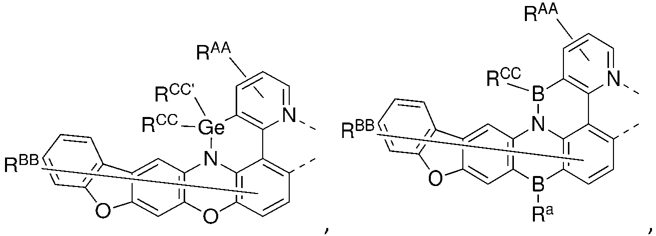 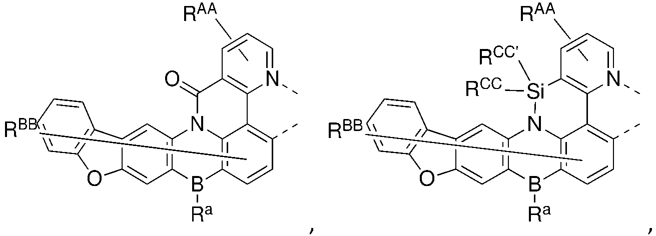 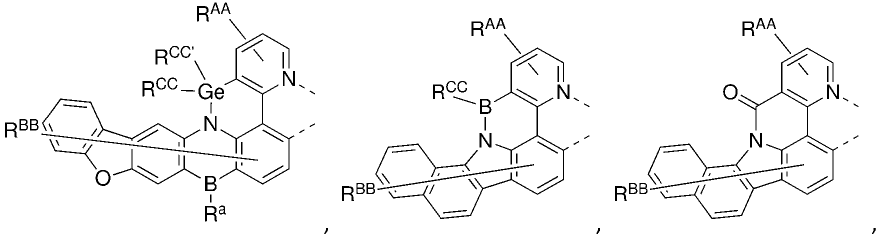 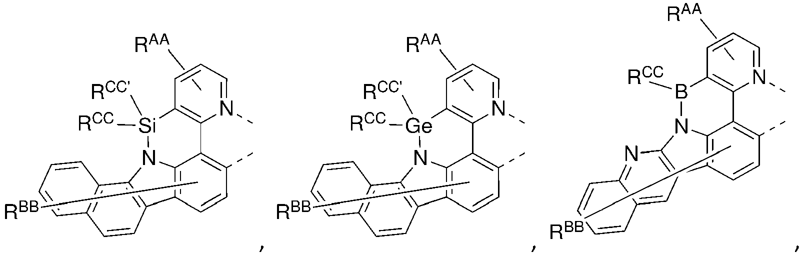 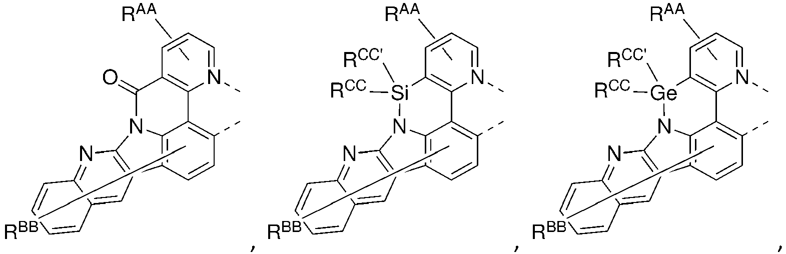 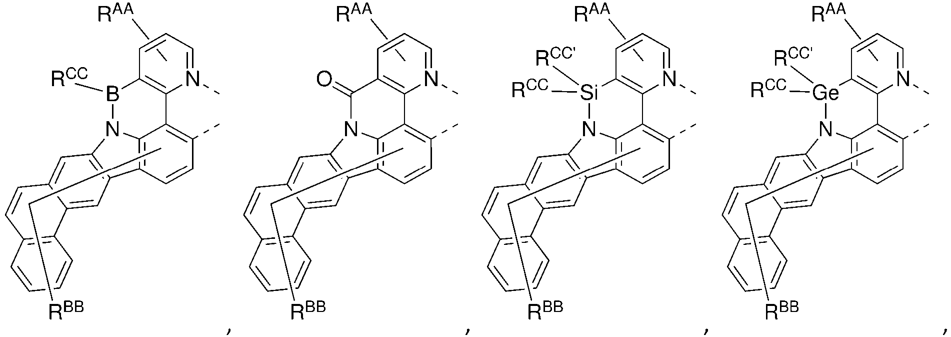 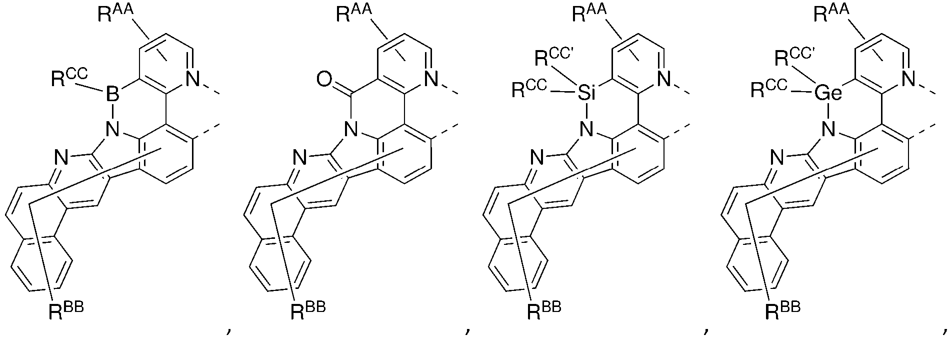 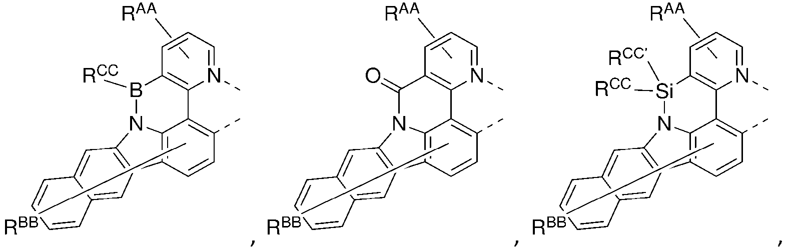 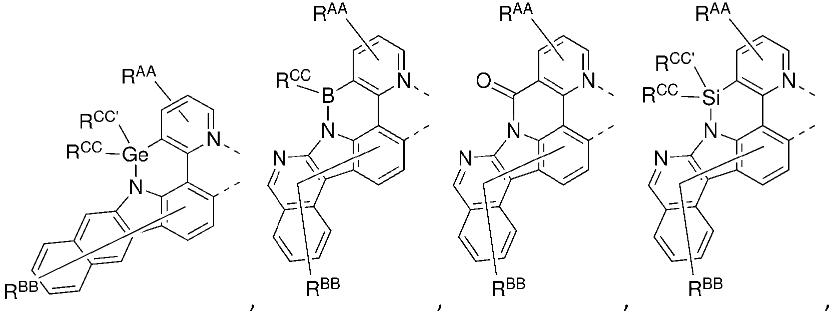 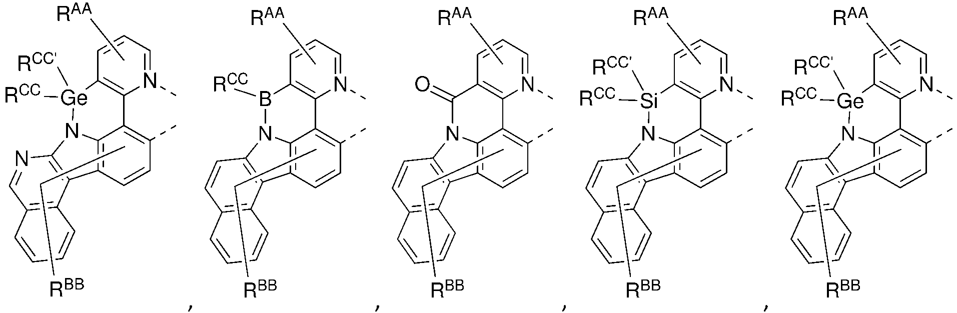 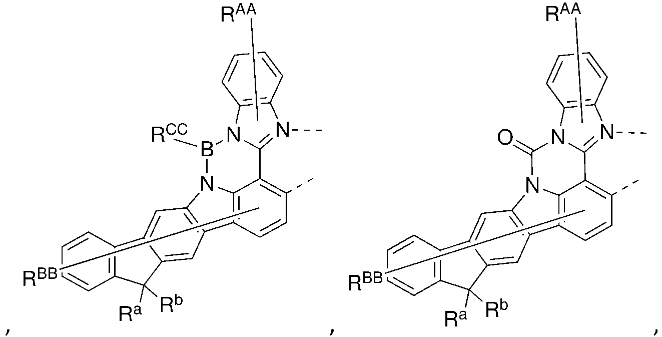 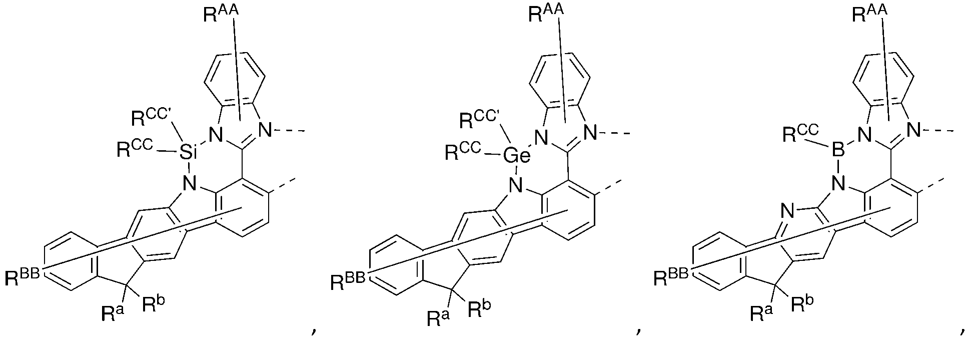 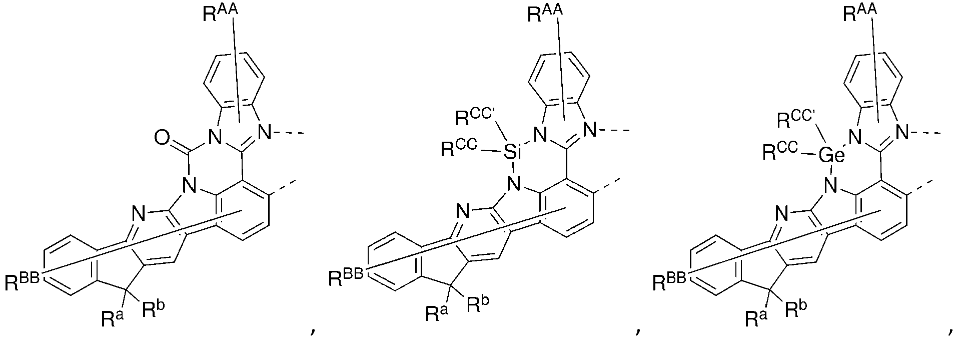 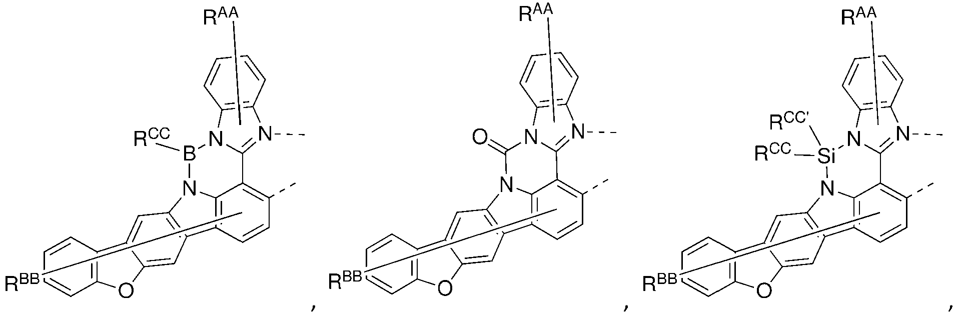 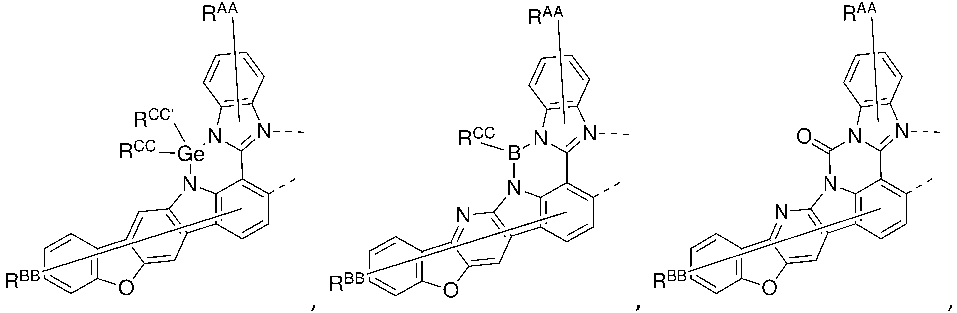 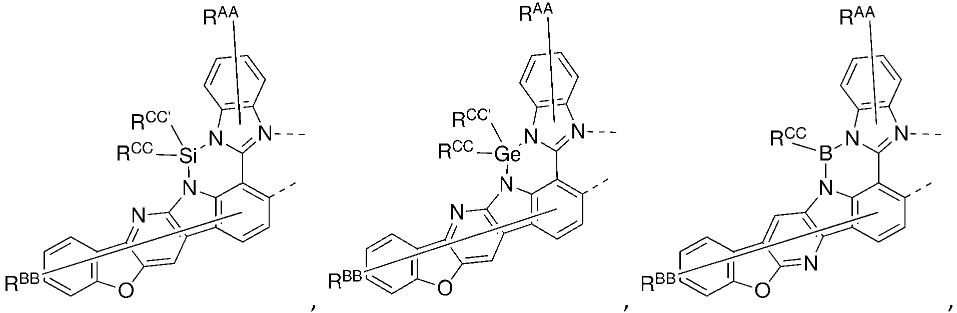 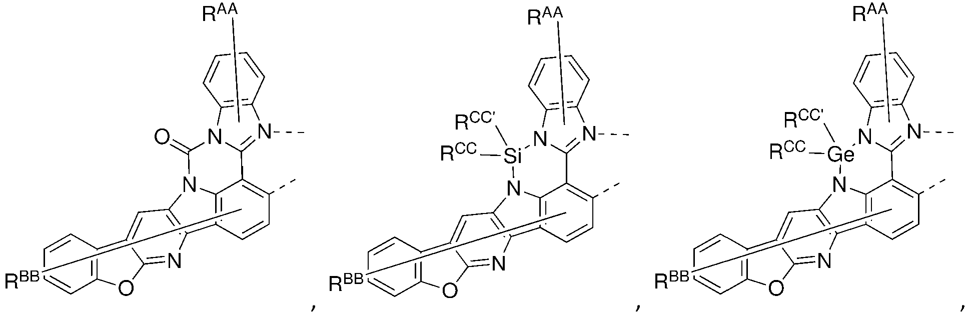 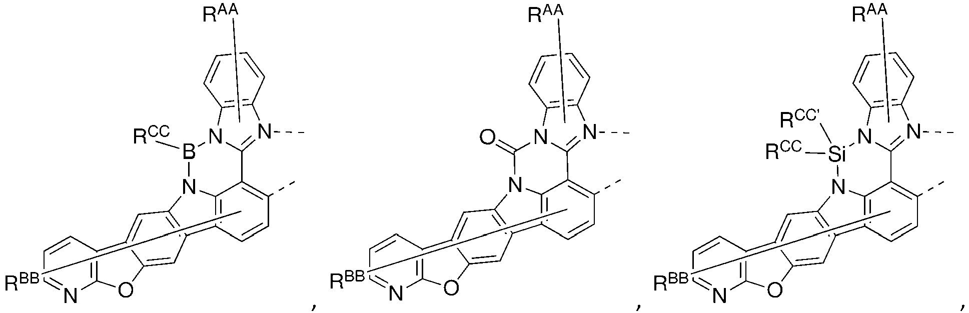 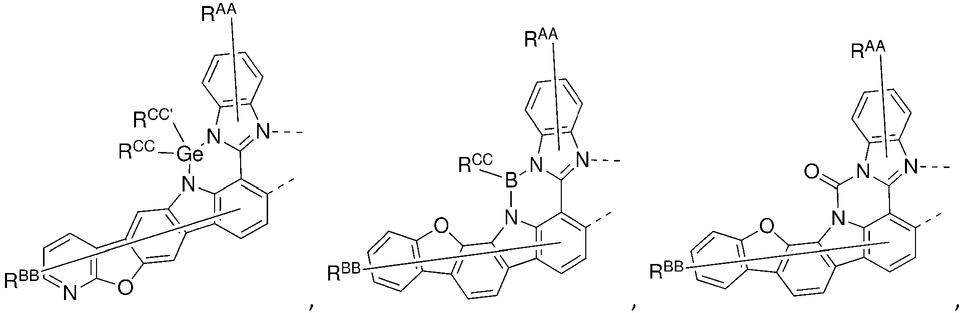 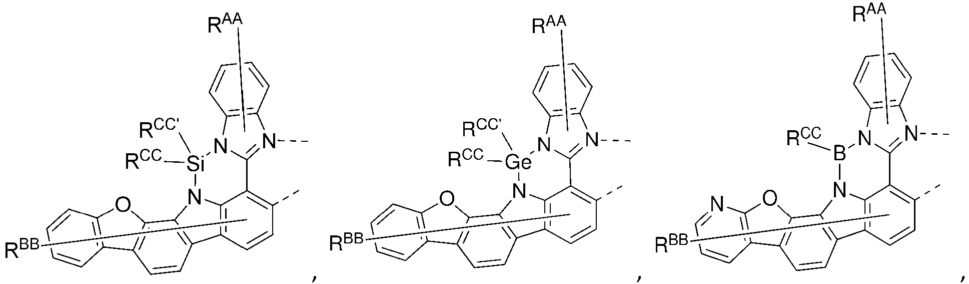 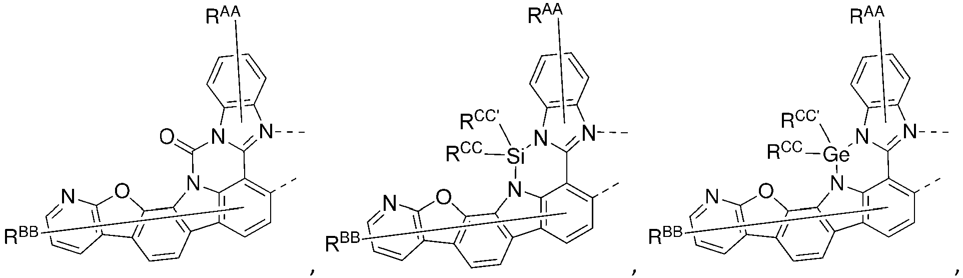 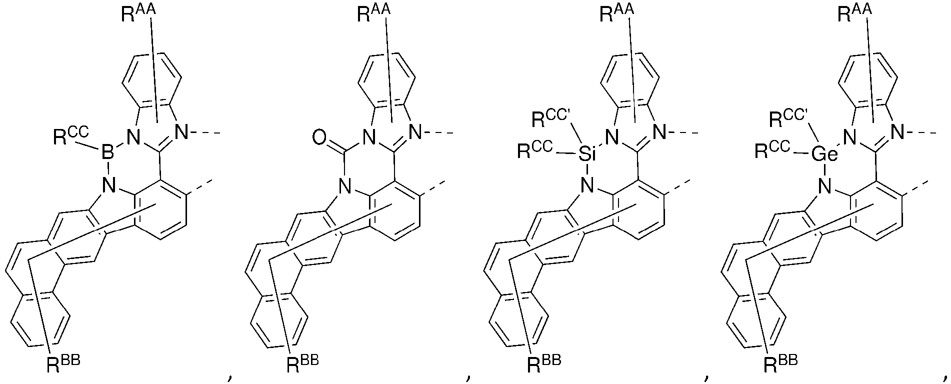 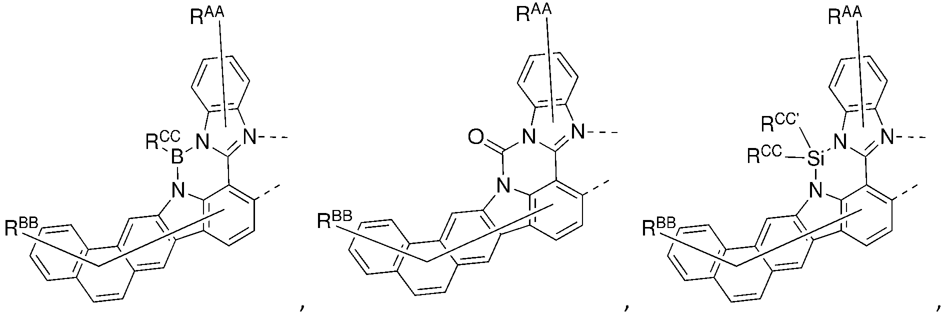 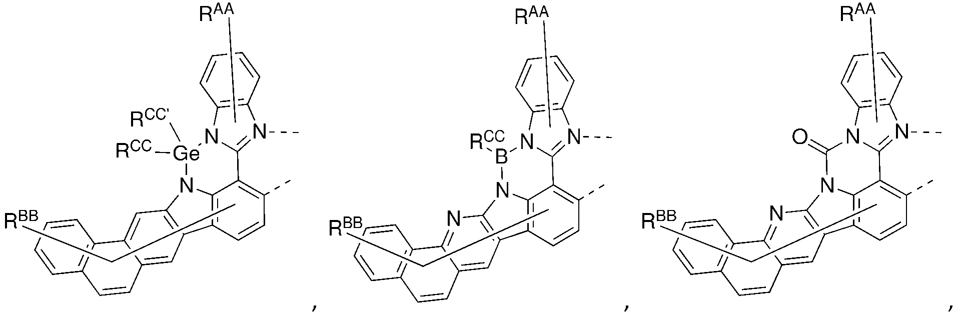 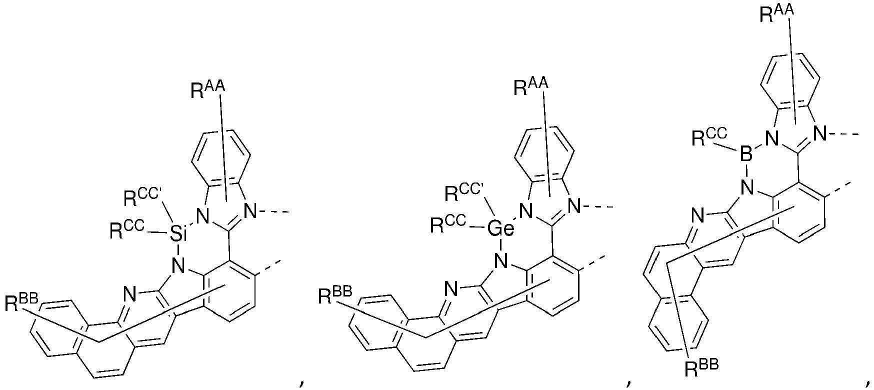 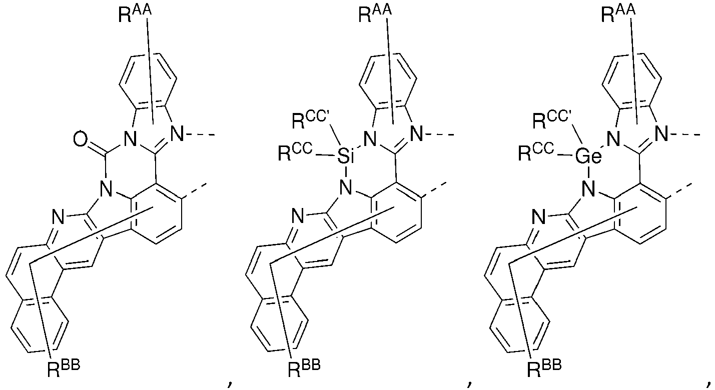 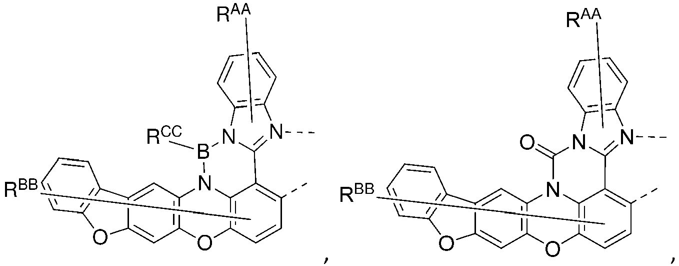 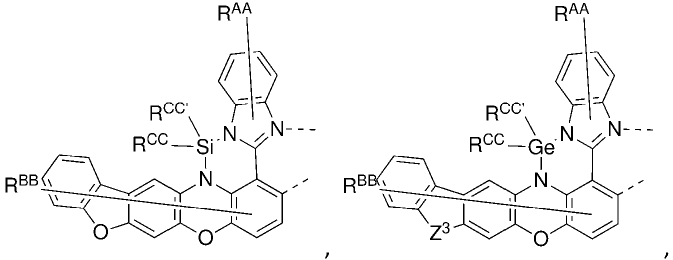 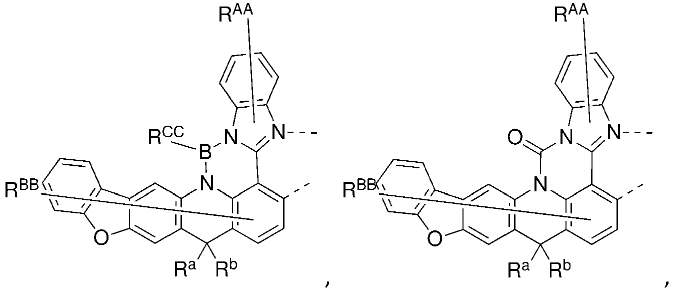 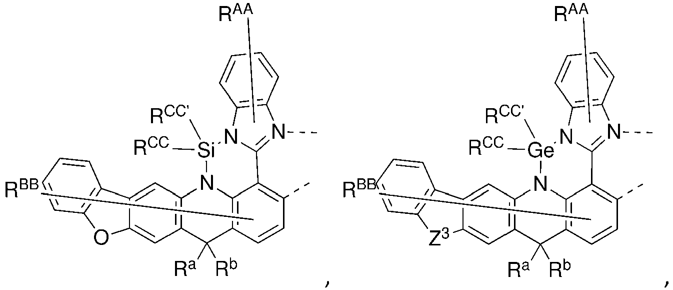 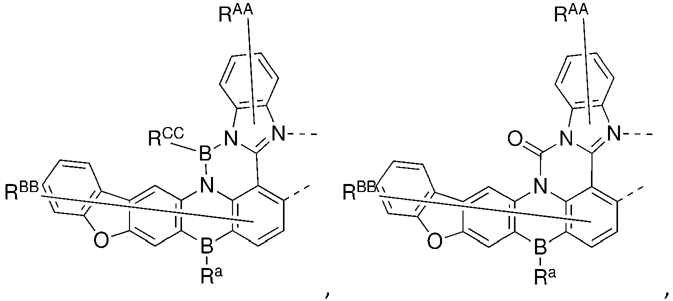 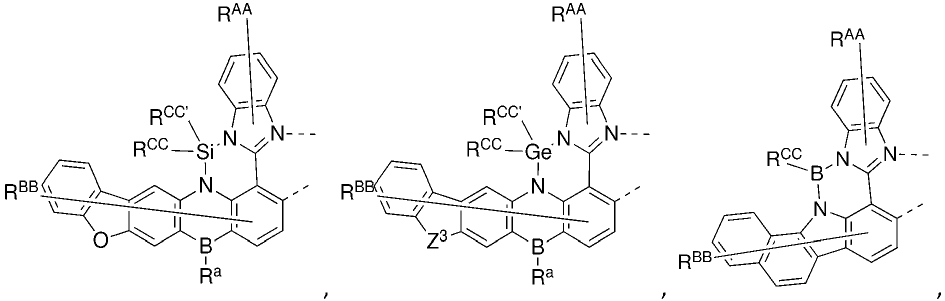 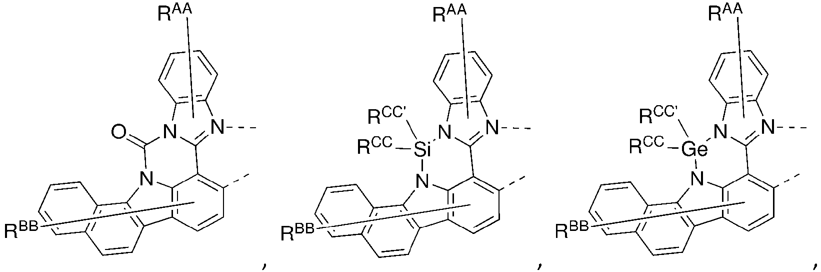 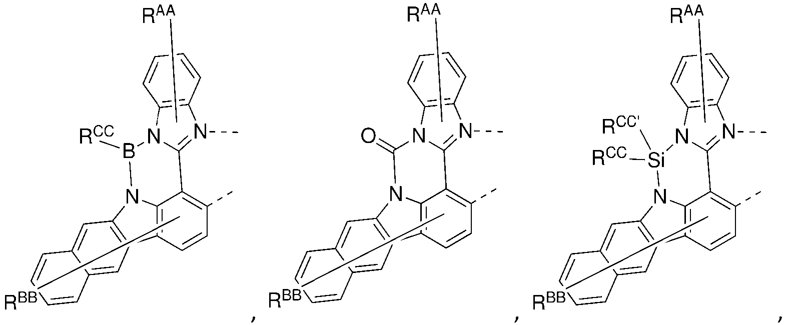 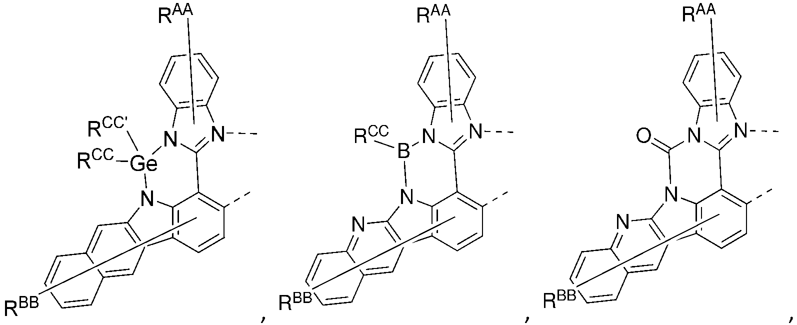 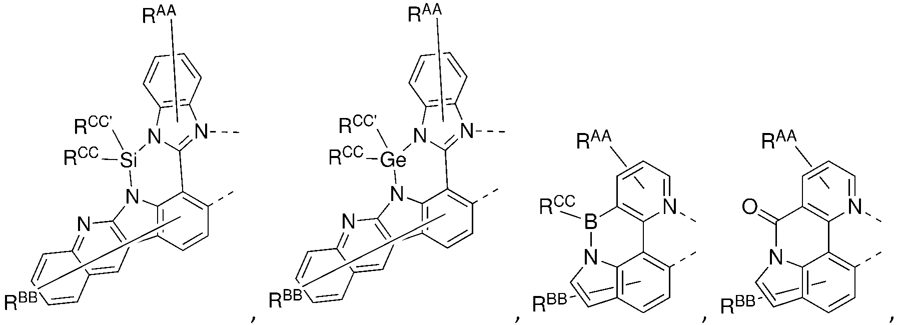 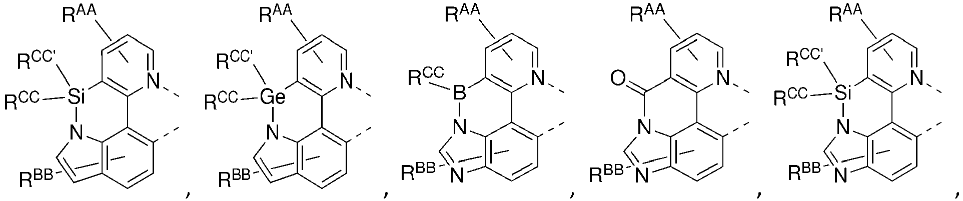 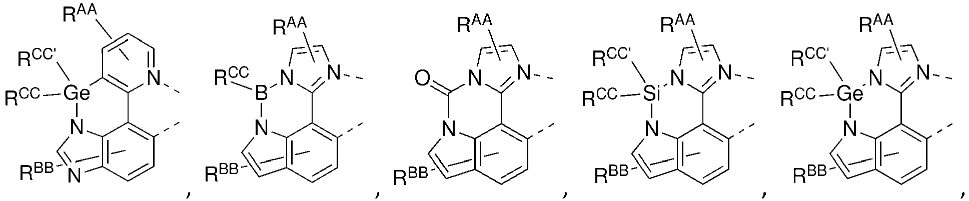 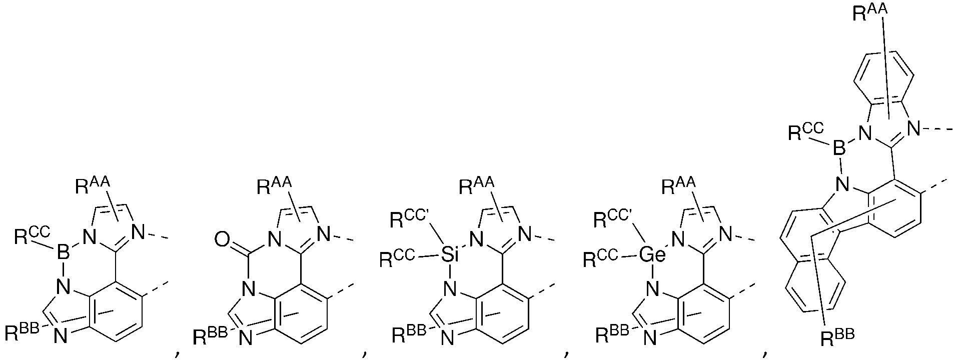 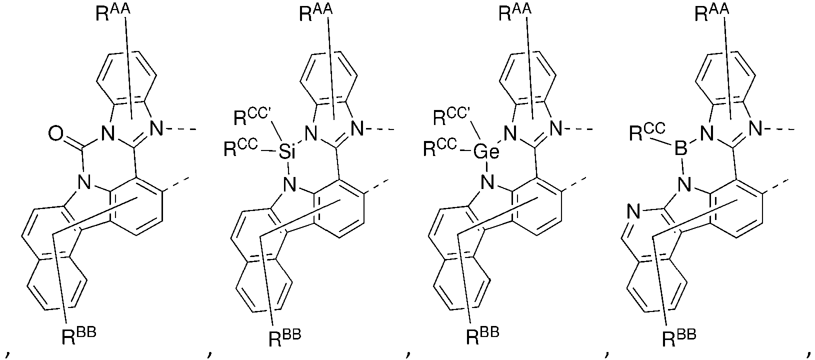 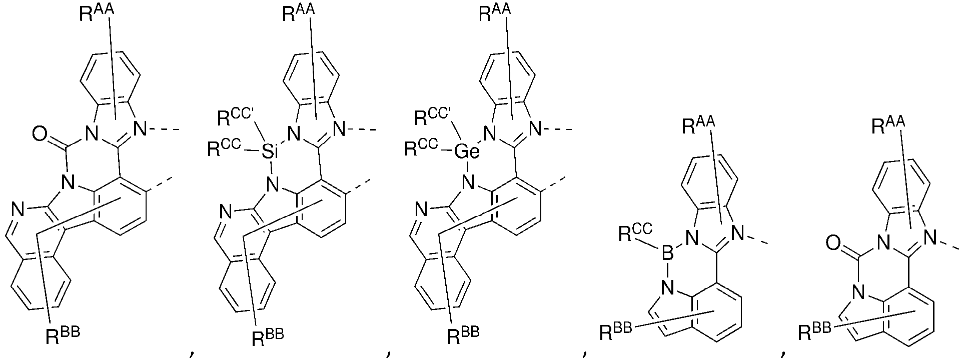 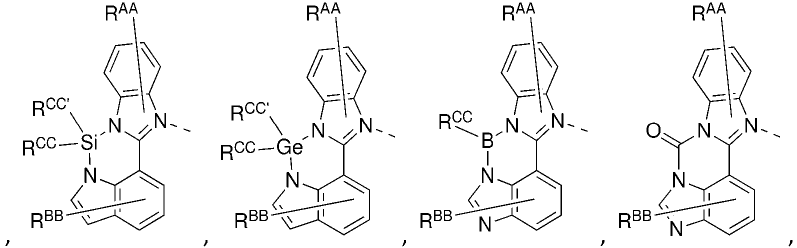 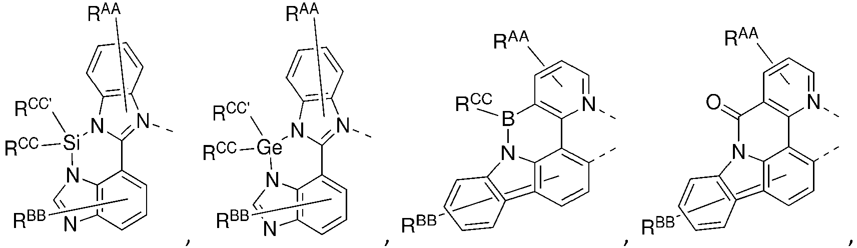 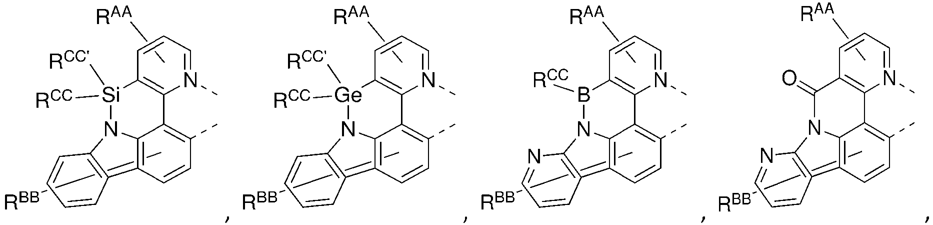 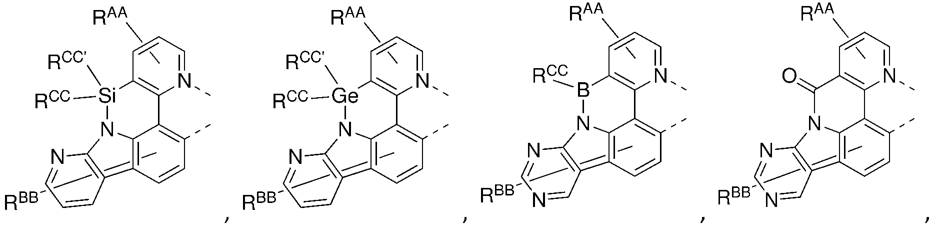 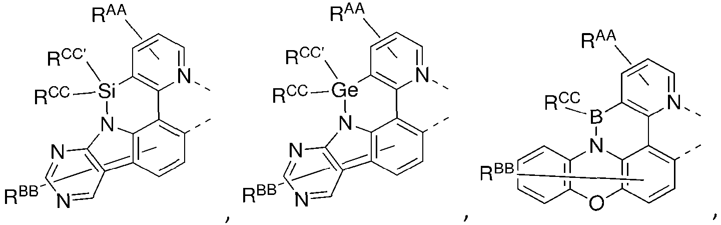 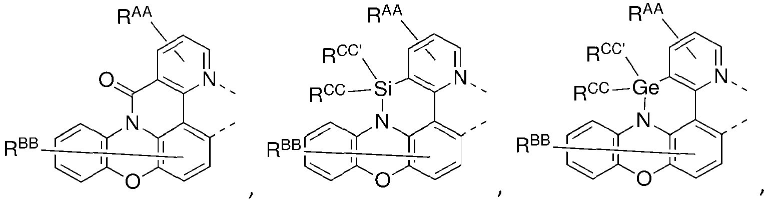 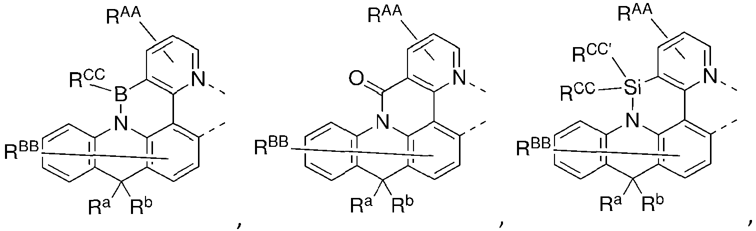 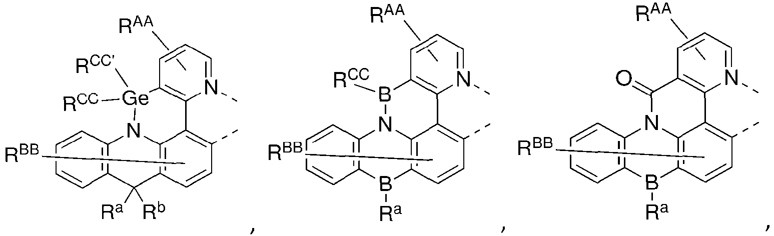 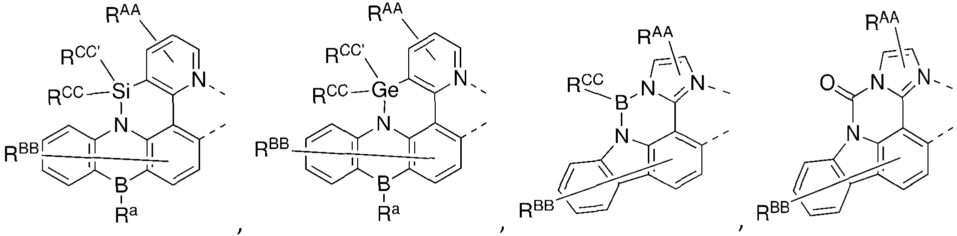 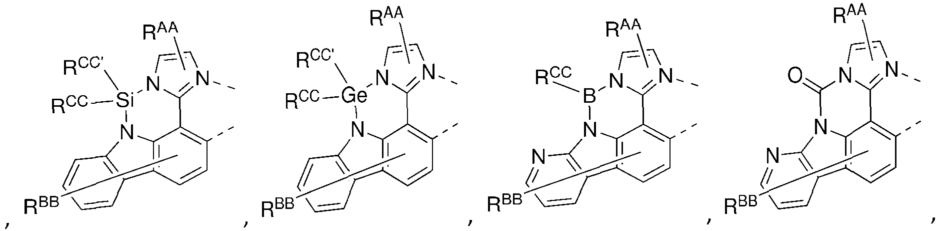 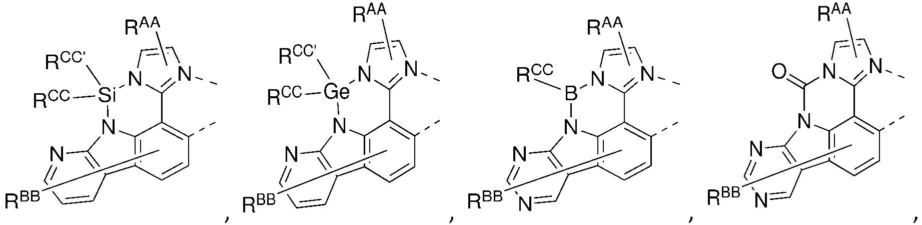 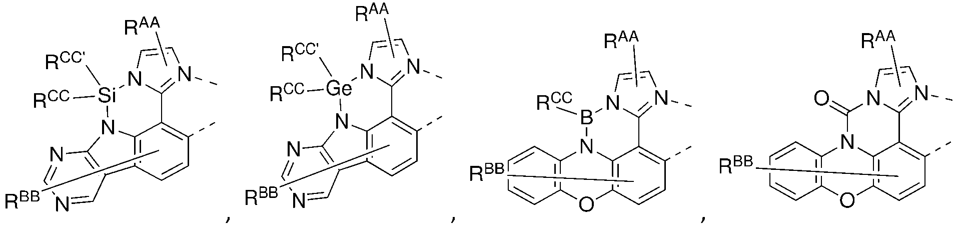 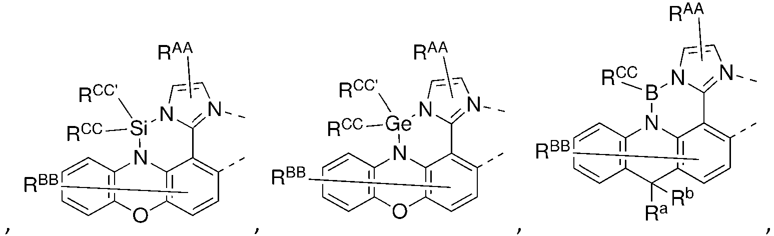 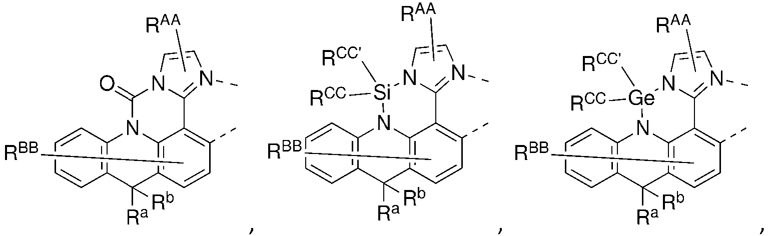 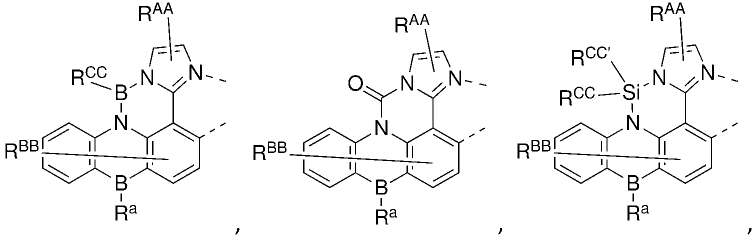 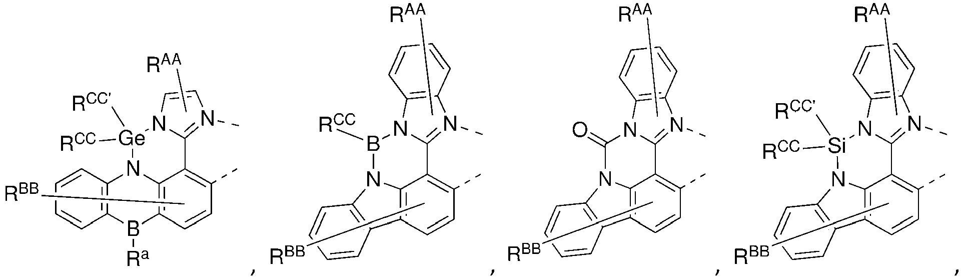 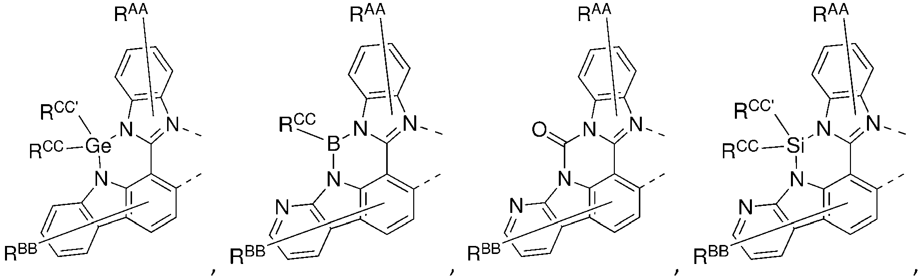 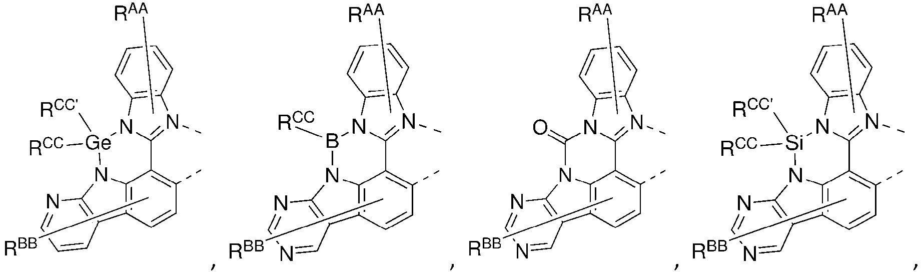 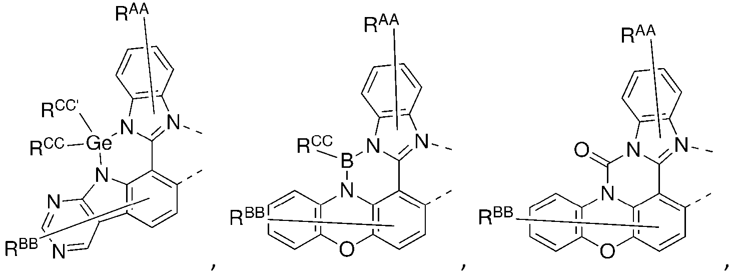 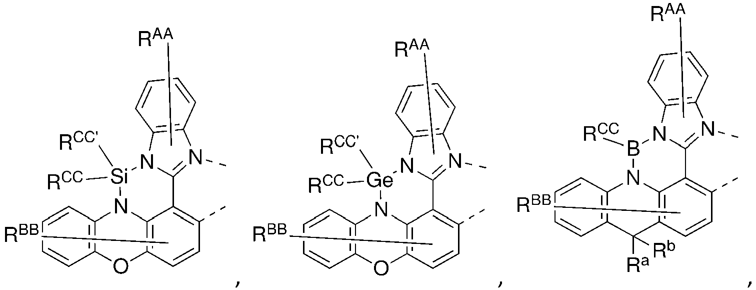 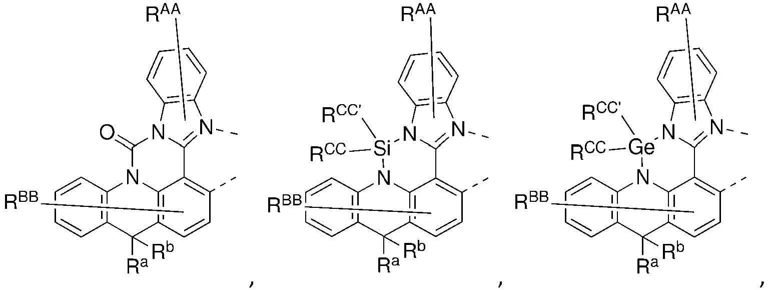 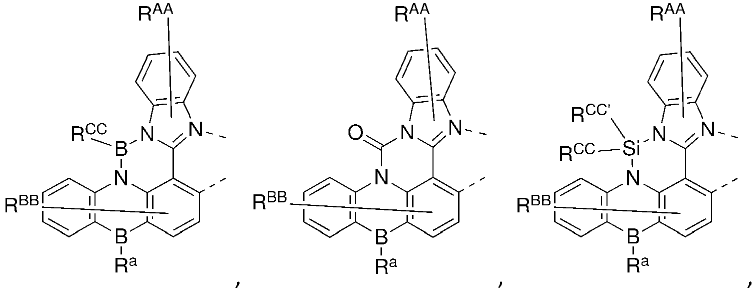 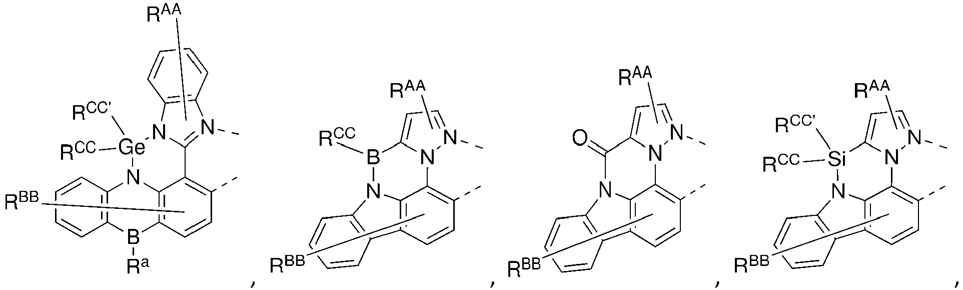 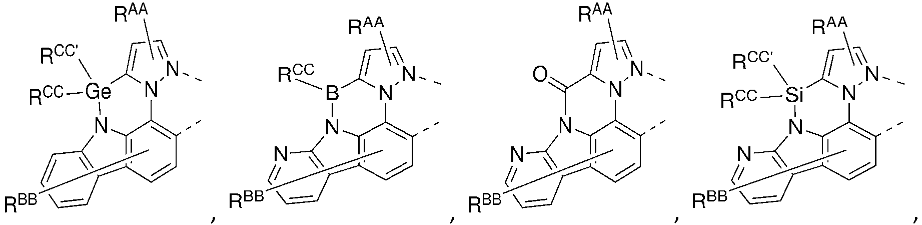 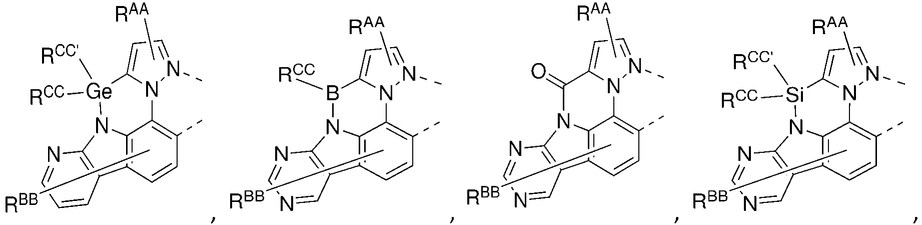 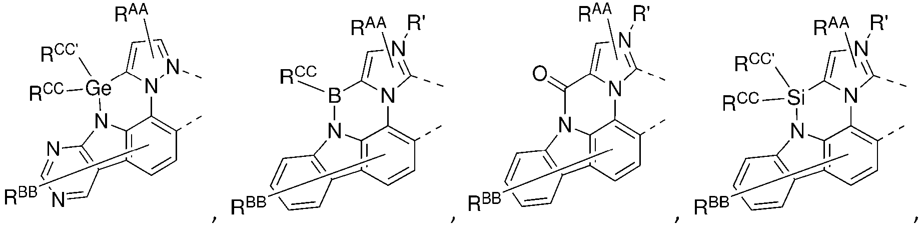 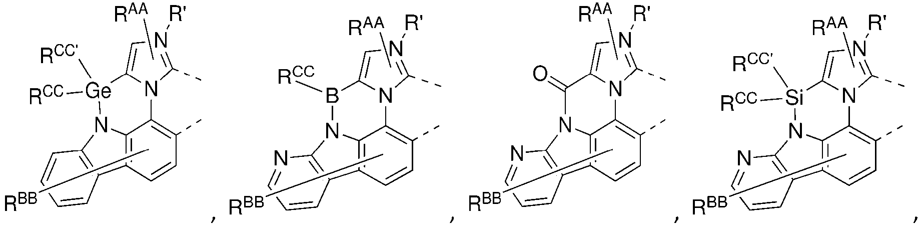 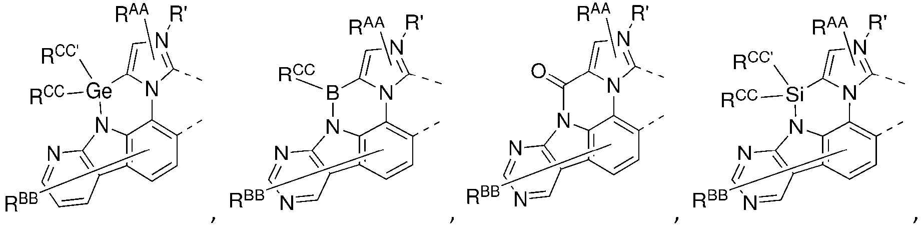 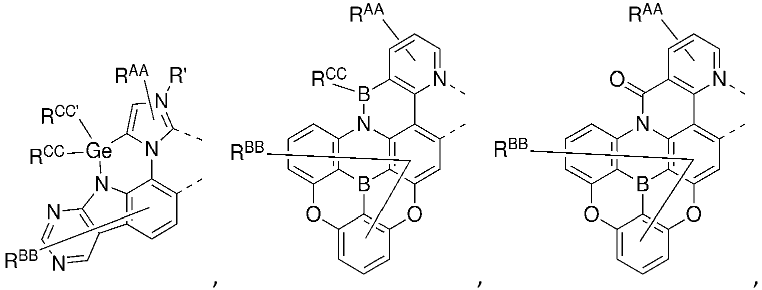 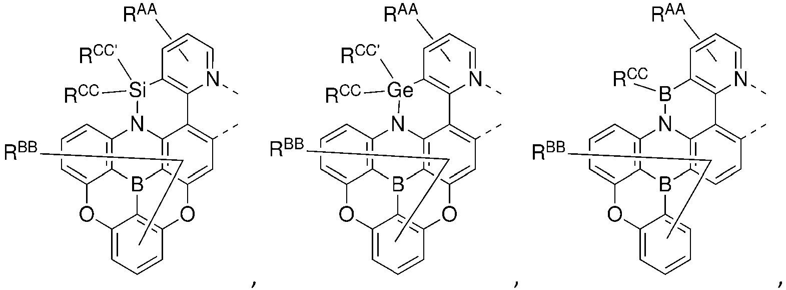 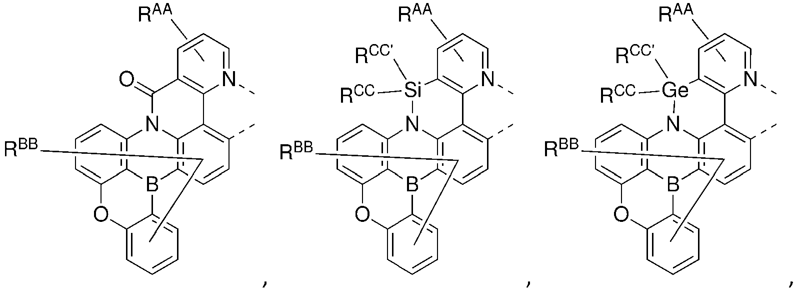 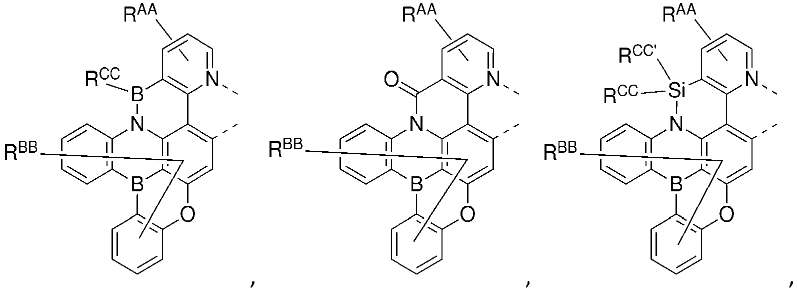 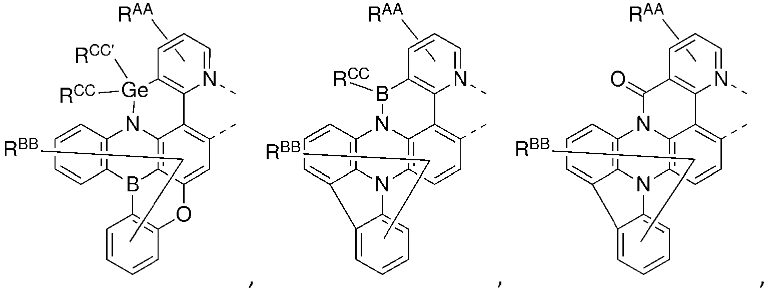 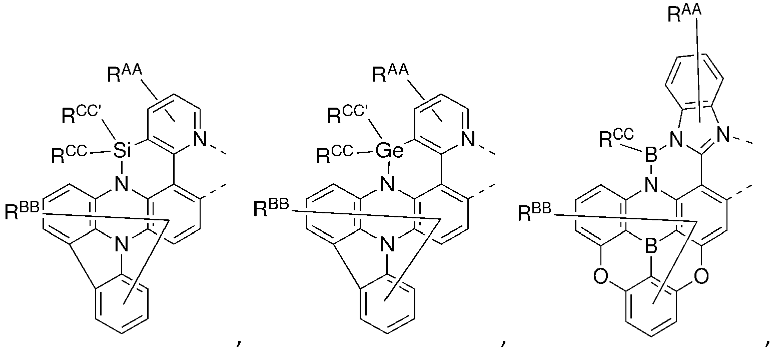 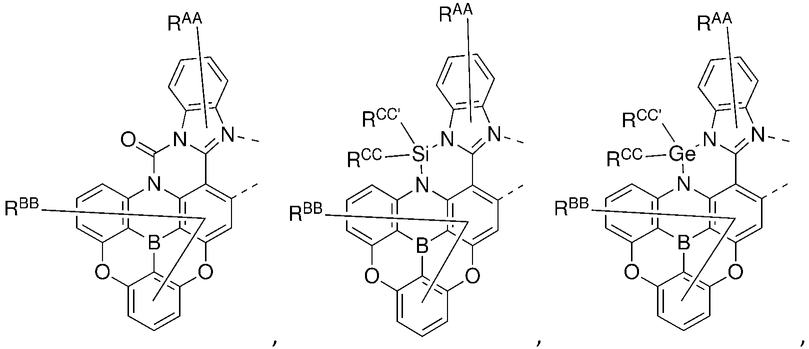 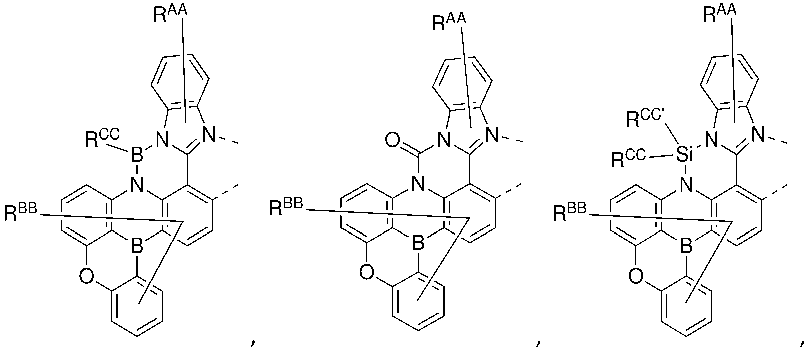 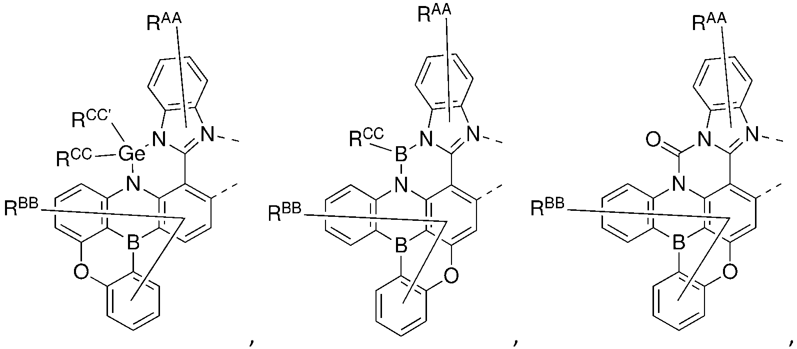 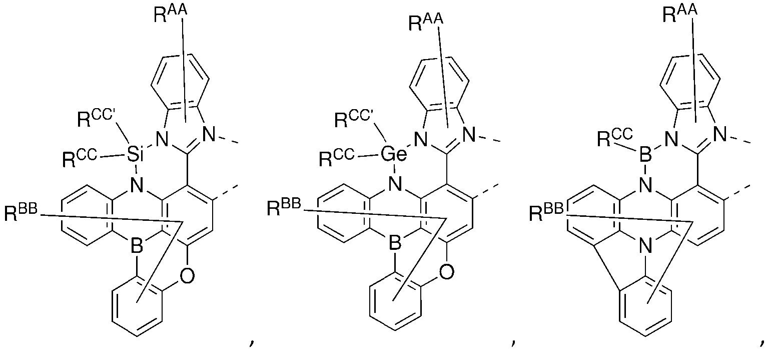 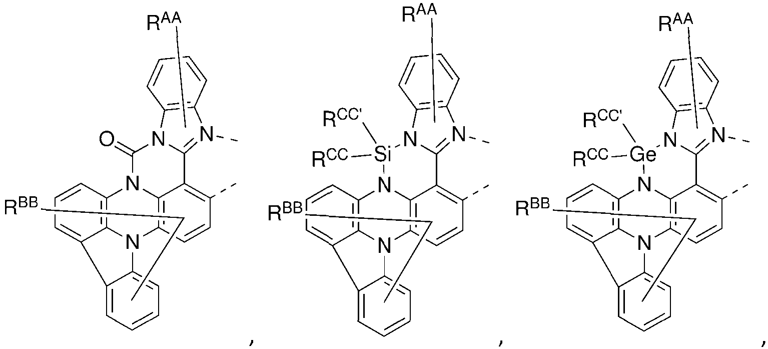 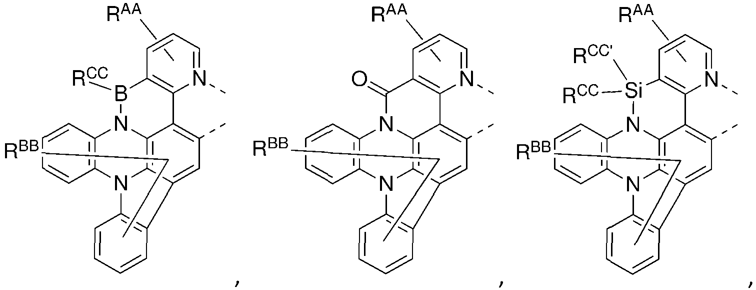 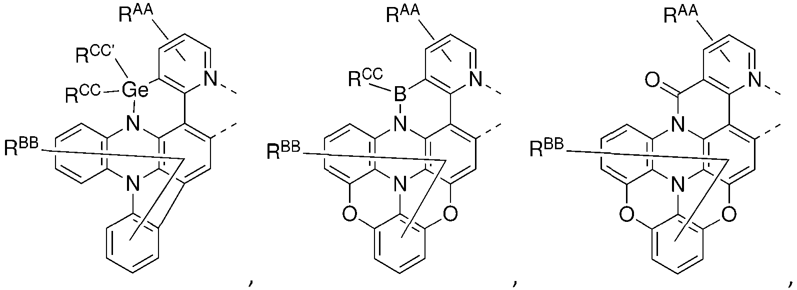 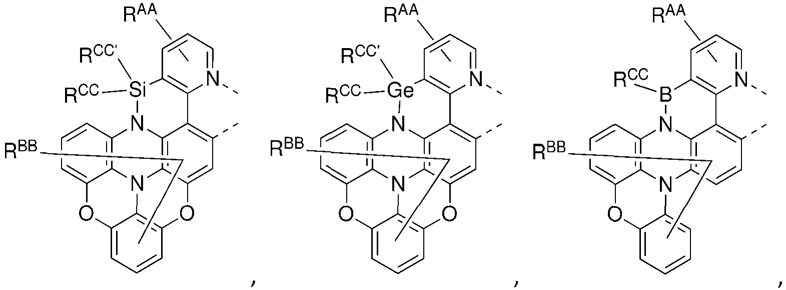 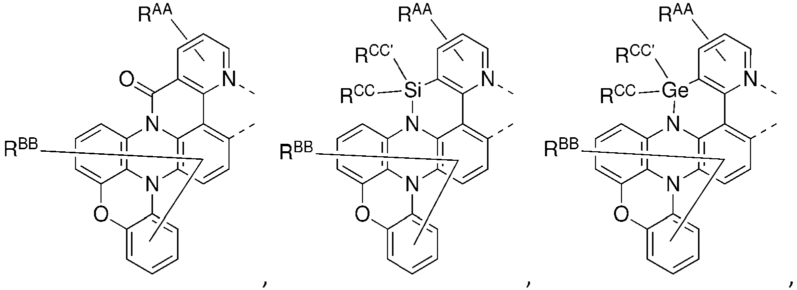 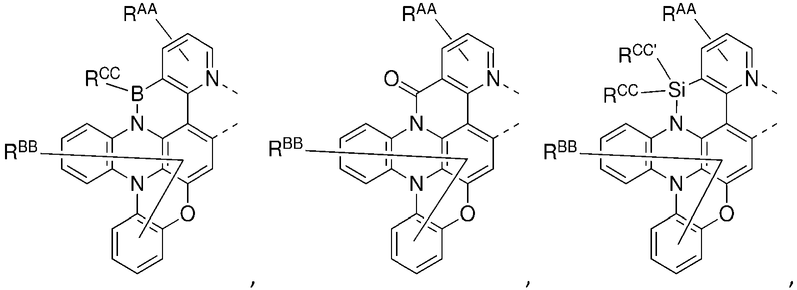 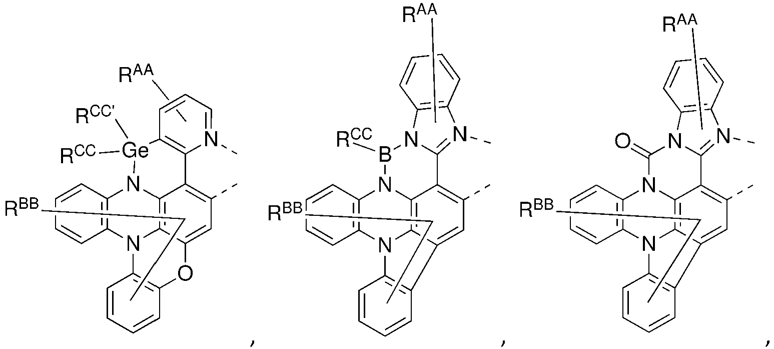 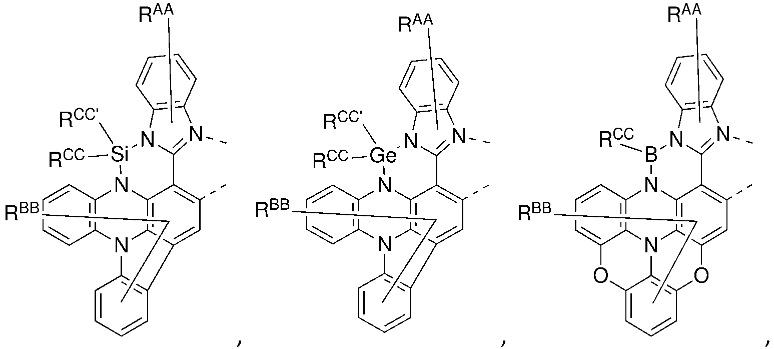 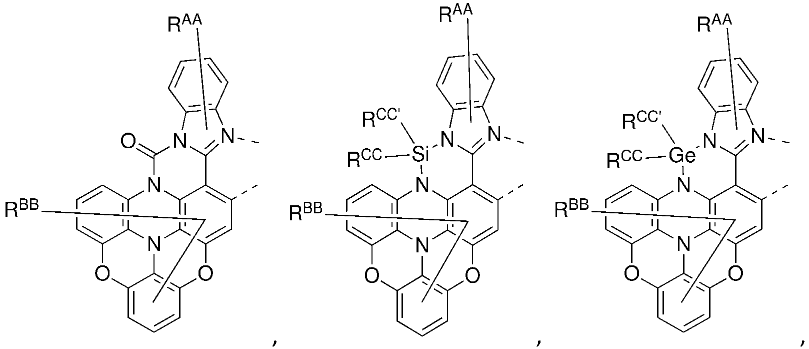 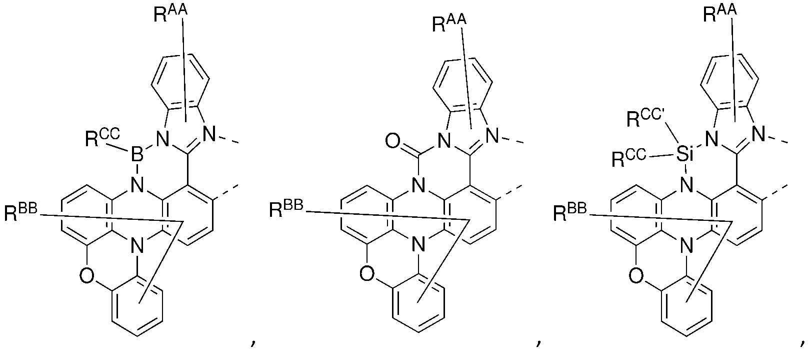 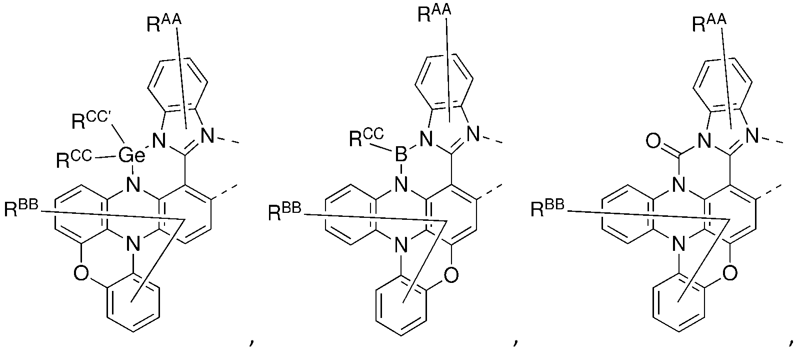 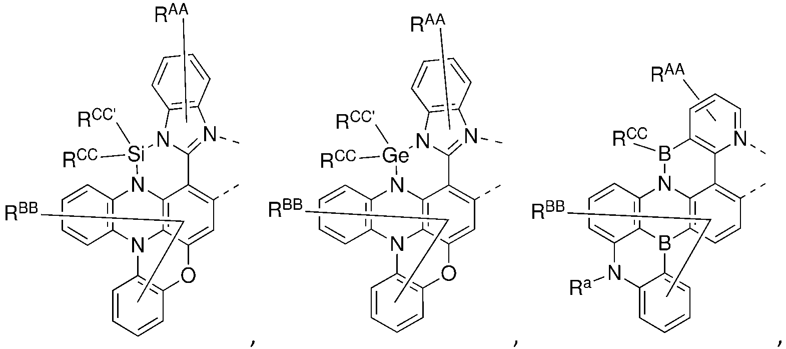 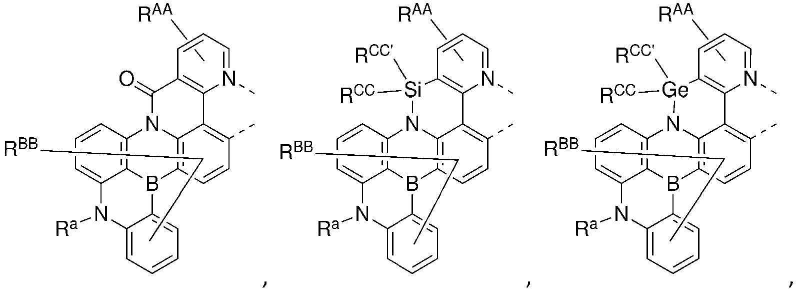 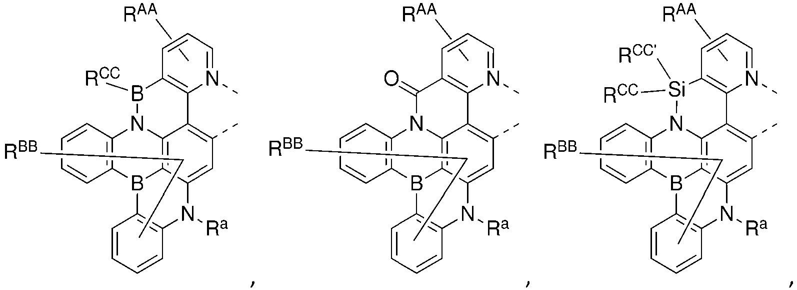 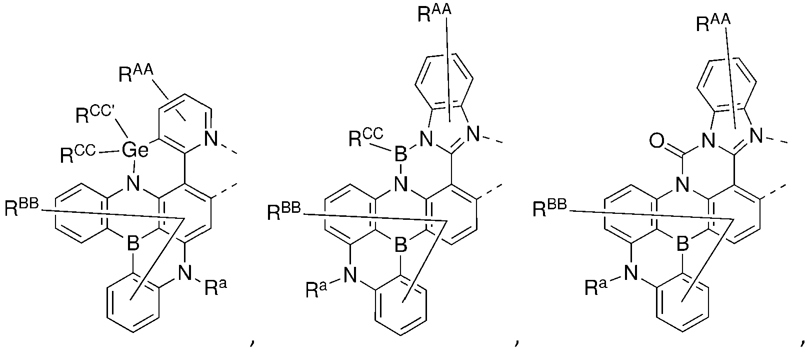 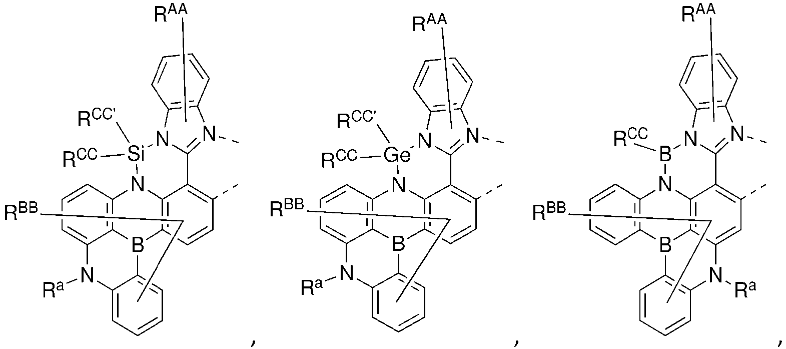 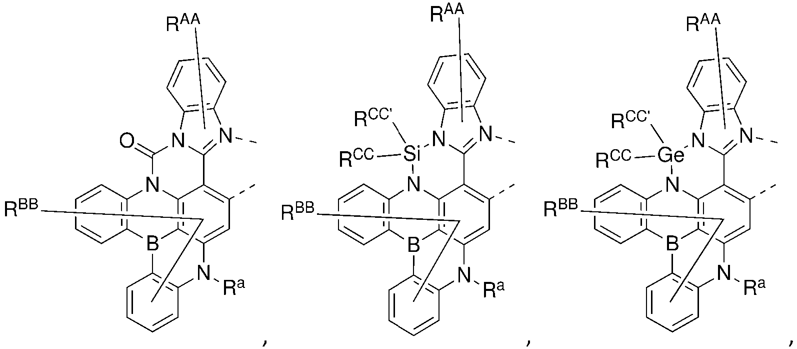 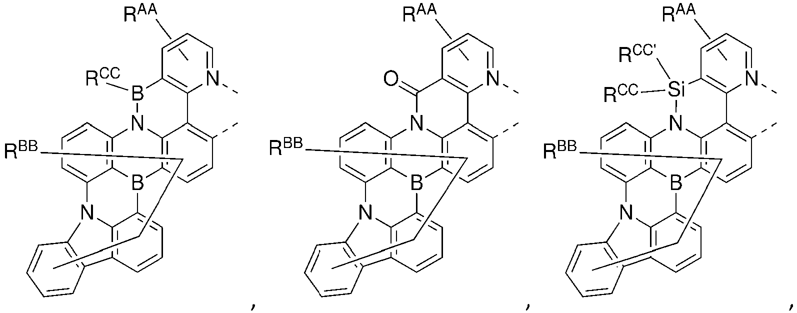 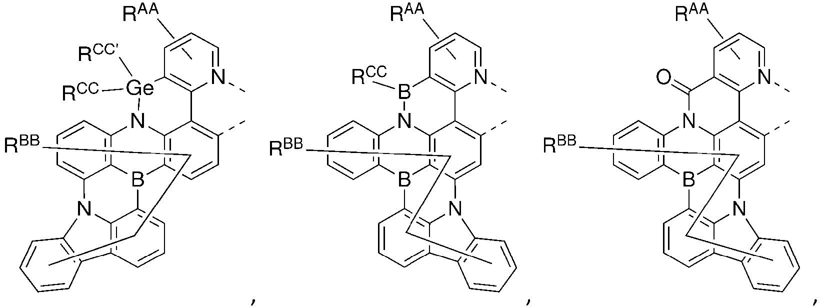 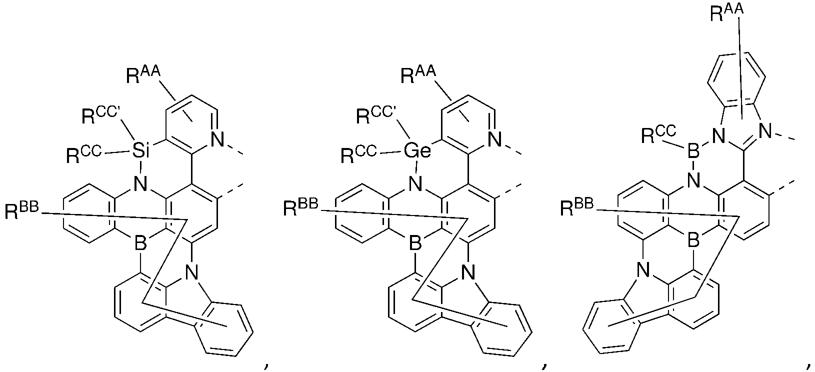 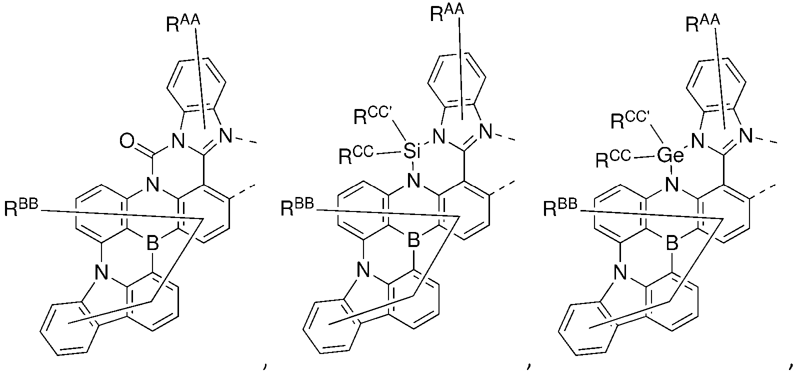 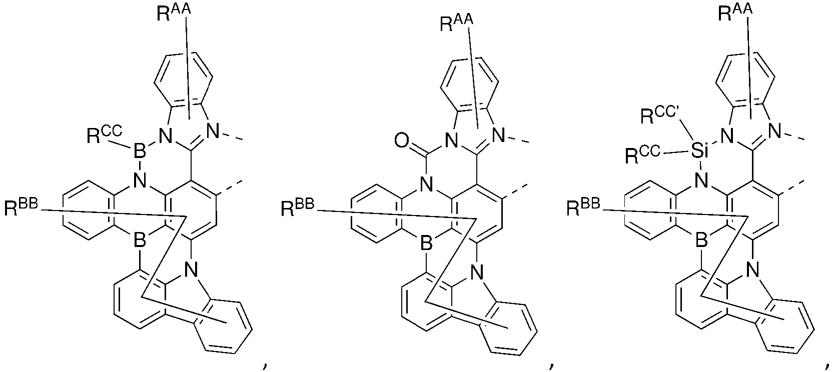 and

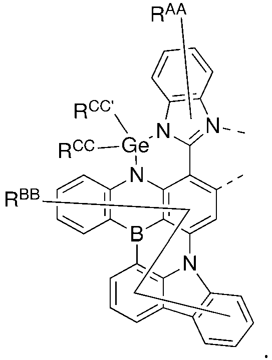

In some embodiments where ligand L_{A} is a structure selected from LIST 2, at least one R^{a}, R^{b}, R^{AA}, R^{BB}, R^{CC}, R^{CC'}, R^{DD} or R' is selected from the group consisting of the General Substituents defined herein. In some embodiments, at least one R^{AA} is selected from the group consisting of the General Substituents defined herein. In some embodiments, at least one R^{BB} is selected from the group consisting of the General Substituents defined herein. In some embodiments, at least one R^{CC} is selected from the group consisting of the General Substituents defined herein. In some embodiments, at least one R^{CC'} is selected from the group consisting of the General Substituents defined herein. In some embodiments, at least one R^{DD} is selected from the group consisting of the General Substituents defined herein. In some embodiments, at least one R' is selected from the group consisting of the General Substituents defined herein. In some embodiments, at least one R^{a} or R^{b} is selected from the group consisting of the General Substituents defined herein.

In some embodiments where ligand L_{A} is selected from LIST 2, at least one R^{a}, R^{b}, R^{AA}, R^{BB}, R^{CC}, R^{CC'}, R^{DD} or R^{'} is selected from the group consisting of the Preferred General Substituents defined herein. In some embodiments, at least one R^{AA} is selected from the group consisting of the Preferred General Substituents defined herein. In some embodiments, at least one R^{BB} is selected from the group consisting of the Preferred General Substituents defined herein. In some embodiments, at least one R^{CC} is selected from the group consisting of the Preferred General Substituents defined herein. In some embodiments, at least one R^{CC'} is selected from the group consisting of the Preferred General Substituents defined herein. In some embodiments, at least one R^{DD} is selected from the group consisting of the Preferred General Substituents defined herein. In some embodiments, at least one R' is selected from the group consisting of the Preferred General Substituents defined herein. In some embodiments, at least one R^{a} or R^{b} is selected from the group consisting of the Preferred General Substituents defined herein.

In some embodiments where ligand L_{A} is selected from LIST 2, at least one R^{a}, R^{b}, R^{AA}, R^{BB}, R^{CC}, R^{CC'}, R^{DD} or R' is partially or fully deuterated. In some embodiments, at least one R^{AA} is partially or fully deuterated. In some embodiments, at least one R^{BB} is partially or fully deuterated. In some embodiments, at least one R^{CC} is partially or fully deuterated. In some embodiments, at least one R^{CC'} is partially or fully deuterated. In some embodiments, at least one R^{DD} is partially or fully deuterated. In some embodiments, at least one R' is partially or fully deuterated. In some embodiments, at least one R^{a} or R^{b} is partially or fully deuterated.

In some embodiments where ligand L_{A} is selected from LIST 2, at least one R^{AA} is or comprises an electron-withdrawing group from the EWG1 LIST as defined herein. In some embodiments, at least one R^{AA} is or comprises an electron-withdrawing group from the EWG2 LIST as defined herein. In some embodiments, at least one R^{AA} is or comprises an electron-withdrawing group from the EWG3 LIST as defined herein. In some embodiments, at least one R^{AA} is or comprises an electron-withdrawing group from the EWG4 LIST as defined herein. In some embodiments, at least one R^{AA} is or comprises an electron-withdrawing group from the Pi-EWG LIST as defined herein.

In some embodiments where ligand L_{A} is selected from LIST 2, at least one R^{BB} is or comprises an electron-withdrawing group from the EWG1 LIST as defined herein. In some embodiments, at least one R^{BB} is or comprises an electron-withdrawing group from the EWG2 LIST as defined herein. In some embodiments, at least one R^{BB} is or comprises an electron-withdrawing group from the EWG3 LIST as defined herein. In some embodiments, at least one R^{BB} is or comprises an electron-withdrawing group from the EWG4 LIST as defined herein. In some embodiments, at least one R^{BB} is or comprises an electron-withdrawing group from the Pi-EWG LIST as defined herein.

In some embodiments where ligand L_{A} is selected from LIST 2, at least one R^{CC} is or comprises an electron-withdrawing group from the EWG1 LIST as defined herein. In some embodiments, at least one R^{CC} is or comprises an electron-withdrawing group from the EWG2 LIST as defined herein. In some embodiments, at least one R^{CC} is or comprises an electron-withdrawing group from the EWG3 LIST as defined herein. In some embodiments, at least one R^{CC} is or comprises an electron-withdrawing group from the EWG4 LIST as defined herein. In some embodiments, at least one R^{CC} is or comprises an electron-withdrawing group from the Pi-EWG LIST as defined herein.

In some embodiments where ligand L_{A} is selected from LIST 2, at least one R^{CC'} is or comprises an electron-withdrawing group from the EWG1 LIST as defined herein. In some embodiments, at least one R^{CC'} is or comprises an electron-withdrawing group from the EWG2 LIST as defined herein. In some embodiments, at least one R^{CC'} is or comprises an electron-withdrawing group from the EWG3 LIST as defined herein. In some embodiments, at least one R^{CC'} is or comprises an electron-withdrawing group from the EWG4 LIST as defined herein. In some embodiments, at least one R^{CC'} is or comprises an electron-withdrawing group from the Pi-EWG LIST as defined herein.

In some embodiments where ligand L_{A} is selected from LIST 2, at least one R^{DD} is or comprises an electron-withdrawing group from the EWG1 LIST as defined herein. In some embodiments, at least one R^{DD} is or comprises an electron-withdrawing group from the EWG2 LIST as defined herein. In some embodiments, at least one R^{DD} is or comprises an electron-withdrawing group from the EWG3 LIST as defined herein. In some embodiments, at least one R^{DD} is or comprises an electron-withdrawing group from the EWG4 LIST as defined herein. In some embodiments, at least one R^{DD} is or comprises an electron-withdrawing group from the Pi-EWG LIST as defined herein.

In some embodiments where ligand L_{A} is selected from LIST 2, at least one R' is or comprises an electron-withdrawing group from the EWG1 LIST as defined herein. In some embodiments, at least one R' is or comprises an electron-withdrawing group from the EWG2 LIST as defined herein. In some embodiments, at least one R' is or comprises an electron-withdrawing group from the EWG3 LIST as defined herein. In some embodiments, at least one R' is or comprises an electron-withdrawing group from the EWG4 LIST as defined herein. In some embodiments, at least one R' is or comprises an electron-withdrawing group from the Pi-EWG LIST as defined herein.

In some embodiments where ligand L_{A} is selected from LIST 2, at least one R^{a} or R^{b} is or comprises an electron-withdrawing group from the EWG1 LIST as defined herein. In some embodiments, at least one R^{a} or R^{b} is or comprises an electron-withdrawing group from the EWG2 LIST as defined herein. In some embodiments, at least one R^{a} or R^{b} is or comprises an electron-withdrawing group from the EWG3 LIST as defined herein. In some embodiments, at least one R^{a} or R^{b} is or comprises an electron-withdrawing group from the EWG4 LIST as defined herein. In some embodiments, at least one R^{a} or R^{b} is or comprises an electron-withdrawing group from the Pi-EWG LIST as defined herein.

In some embodiments, wherein the ligand L_{A} is selected from L_{A}W1-(R*i*)(R*j*)(R*k*)(R*l*), and L_{A}W2-(R*j*)(R*k*)(R*l*), wherein W1 is an integer from 1-263, 265, 267-280, 282, 284-489, W2 is 264, 266, 281, and 283, each i, j, k, and l is independently an integer from 1 to 263, each of Ri, Rj, Rk and R*l* is independently selected from V1 to V263, and each of L_{A}W1-(R*i*)(R*j*)(R*k*)(R*l*), and L_{A}W2-(R*j*)(R*k*)(R*l*) is defined in the following table (LIST 3):

| **L_{A}** | **Structure of L_{A}** | **L_{A}** | **Structure of L_{A}** |
|---|---|---|---|
| L_{A}1-(R*i*)(R*j*)(R*k*)(R*l*), wherein L_{A}1-(V1)(V1)(V1)(V1) to L_{A}1-(V263)(V263)(V263)(V 263), have the structure | 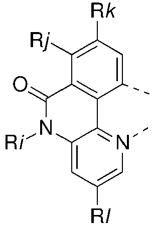 | L_{A}2-(R*i*)(R*j*)(R*k*)(R*l*), wherein L_{A}2-(V1)(V1)(V1)(V1) to L_{A}2-(V263)(V263)(V263)(V 263), have the structure | 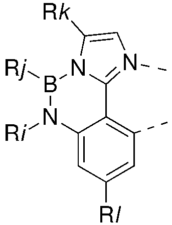 |
| L_{A}3-(R*i*)(R*j*)(R*k*)(R*l*), wherein L_{A}3-(V1)(V1)(V1)(V1) to L_{A}3-(V263)(V263)(V263)(V 263), have the structure | 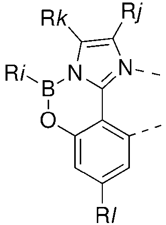 | L_{A}4-(R*i*)(R*j*)(R*k*)(R*l*), wherein L_{A}4-(V1)(V1)(V1)(V1) to L_{A}4-(V263)(V263)(V263)(V 263), have the structure | 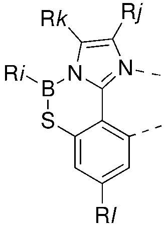 |
| L_{A}5-(R*i*)(R*j*)(R*k*)(R*l*), wherein L_{A}5-(V1)(V1)(V1)(V1) to L_{A}5-(V263)(V263)(V263)(V 263), have the structure | 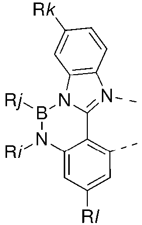 | L_{A}6-(R*i*)(R*j*)(R*k*)(R*l*), wherein L_{A}6-(V1)(V1)(V1)(V1) to L_{A}6-(V263)(V263)(V263)(V 263), have the structure | 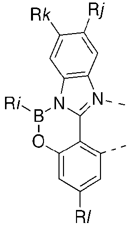 |
| L_{A}7-(R*i*)(R*j*)(R*k*)(R*l*), wherein L_{A}7-(V1)(V1)(V1)(V1) to L_{A}7-(V263)(V263)(V263)(V 263), have the structure | 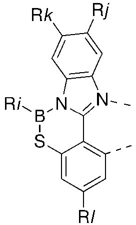 | L_{A}8-(R*i*)(R*j*)(R*k*)(R*l*), wherein L_{A}8-(V1)(V1)(V1)(V1) to L_{A}8-(V263)(V263)(V263)(V 263), have the structure | 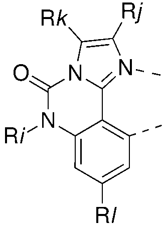 |
| L_{A}9-(R*i*)(R*j*)(R*k*)(R*l*), wherein L_{A}9-(V1)(V1)(V1)(V1) to L_{A}9-(V263)(V263)(V263)(V 263), have the structure | 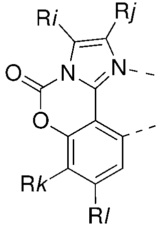 | L_{A}10-(R*i*)(R*j*)(R*k*)(R*l*), wherein L_{A}10-(V1)(V1)(V1)(V1) to L_{A}10-(V263)(V263)(V263)(V 263), have the structure | 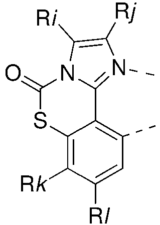 |
| L_{A}11-(R*i*)(R*j*)(R*k*)(R*l*), wherein L_{A}11-(V1)(V1)(V1)(V1) to L_{A}11-(V263)(V263)(V263)(V 263), have the structure | 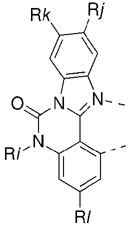 | L_{A}12-(R*i*)(R*j*)(R*k*)(R*l*), wherein L_{A}12-(V1)(V1)(V1)(V1) to L_{A}12-(V263)(V263)(V263)(V 263), have the structure | 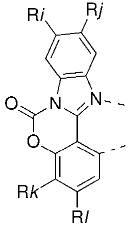 |
| L_{A}13-(R*i*)(R*j*)(R*k*)(R*l*), wherein L_{A}13-(V1)(V1)(V1)(V1) to L_{A}13-(V263)(V263)(V263)(V 263), have the structure | 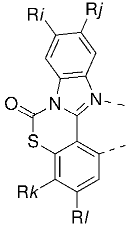 | L_{A}14-(R*i*)(R*j*)(R*k*)(R*l*), wherein L_{A}14-(V1)(V1)(V1)(V1) to L_{A}14-(V263)(V263)(V263)(V 263), have the structure | 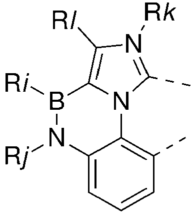 |
| L_{A}15-(R*i*)(R*j*)(R*k*)(R*l*), wherein L_{A}15-(V1)(V1)(V1)(V1) to L_{A}15-(V263)(V263)(V263)(V 263), have the structure | 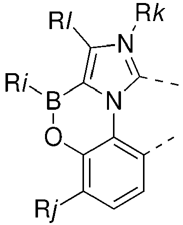 | L_{A}16-(R*i*)(R*j*)(R*k*)(R*l*), wherein L_{A}16-(V1)(V1)(V1)(V1) to L_{A}16-(V263)(V263)(V263)(V 263), have the structure | 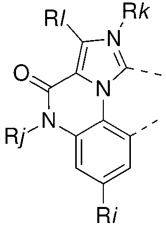 |
| L_{A}17-(R*i*)(R*j*)(R*k*)(R*l*), wherein L_{A}17-(V1)(V1)(V1)(V1) to L_{A}17-(V263)(V263)(V263)(V 263), have the structure | 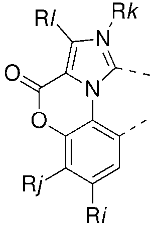 | L_{A}18-(R*i*)(R*j*)(R*k*)(R*l*), wherein L_{A}18-(V1)(V1)(V1)(V1) to L_{A}18-(V263)(V263)(V263)(V 263), have the structure | 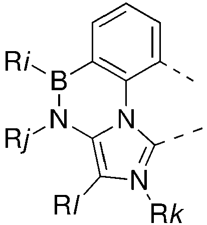 |
| L_{A}19-(R*i*)(R*j*)(R*k*)(R*l*), wherein L_{A}19-(V1)(V1)(V1)(V1) to L_{A}19-(V263)(V263)(V263)(V 263), have the structure | 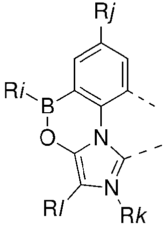 | L_{A}20-(R*i*)(R*j*)(R*k*)(R*l*), wherein L_{A}20-(V1)(V1)(V1)(V1) to L_{A}20-(V263)(V263)(V263)(V 263), have the structure | 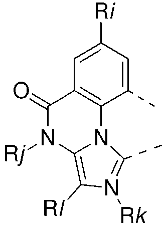 |
| L_{A}21-(R*i*)(R*j*)(R*k*)(R*l*), wherein L_{A}21-(V1)(V1)(V1)(V1) to L_{A}21-(V263)(V263)(V263)(V 263), have the structure | 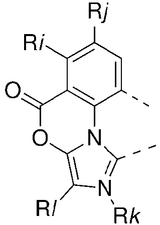 | L_{A}22-(R*i*)(R*j*)(R*k*)(R*l*), wherein L_{A}22-(V1)(V1)(V1)(V1) to L_{A}22-(V263)(V263)(V263)(V 263), have the structure | 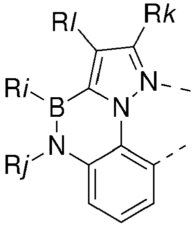 |
| L_{A}23-(R*i*)(R*j*)(R*k*)(R*l*), wherein L_{A}23-(V1)(V1)(V1)(V1) to L_{A}23-(V263)(V263)(V263)(V 263), have the structure | 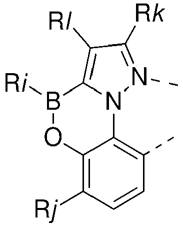 | L_{A}24-(R*i*)(R*j*)(R*k*)(R*l*), wherein L_{A}24-(V1)(V1)(V1)(V1) to L_{A}24-(V263)(V263)(V263)(V 263), have the structure | 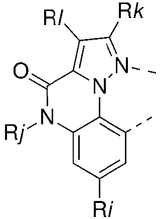 |
| L_{A}25-(R*i*)(R*j*)(R*k*)(R*l*), wherein L_{A}25-(V1)(V1)(V1)(V1) to L_{A}25-(V263)(V263)(V263)(V 263), have the structure | 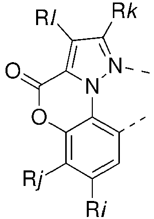 | L_{A}26-(R*i*)(R*j*)(R*k*)(R*l*), wherein L_{A}26-(V1)(V1)(V1)(V1) to L_{A}26-(V263)(V263)(V263)(V 263), have the structure | 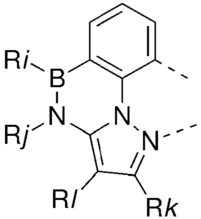 |
| L_{A}27-(R*i*)(R*j*)(R*k*)(R*l*), wherein L_{A}27-(V1)(V1)(V1)(V1) to L_{A}27-(V263)(V263)(V263)(V 263), have the structure | 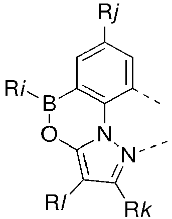 | L_{A}28-(R*i*)(R*j*)(R*k*)(R*l*), wherein L_{A}28-(V1)(V1)(V1)(V1) to L_{A}28-(V263)(V263)(V263)(V 263), have the structure | 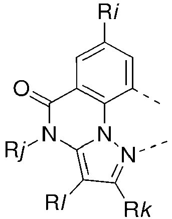 |
| L_{A}29-(R*i*)(R*j*)(R*k*)(R*l*), wherein L_{A}29-(V1)(V1)(V1)(V1) to L_{A}29-(V263)(V263)(V263)(V 263), have the structure | 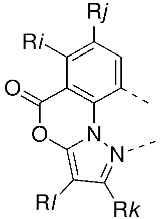 | L_{A}30-(R*i*)(R*j*)(R*k*)(R*l*), wherein L_{A}30-(V1)(V1)(V1)(V1) to L_{A}30-(V263)(V263)(V263)(V 263), have the structure | 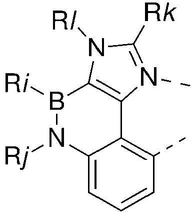 |
| L_{A}31-(R*i*)(R*j*)(R*k*)(R*l*), wherein L_{A}31-(V1)(V1)(V1)(V1) to L_{A}31-(V263)(V263)(V263)(V 263), have the structure | 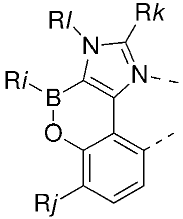 | L_{A}32-(R*i*)(R*j*)(R*k*)(R*l*), wherein L_{A}32-(V1)(V1)(V1)(V1) to L_{A}32-(V263)(V263)(V263)(V 263), have the structure | 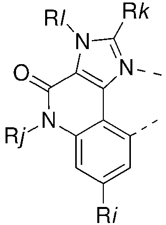 |
| L_{A}33-(R*i*)(R*j*)(R*k*)(R*l*), wherein L_{A}33-(V1)(V1)(V1)(V1) to L_{A}33-(V263)(V263)(V263)(V 263), have the structure | 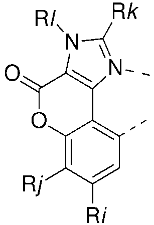 | L_{A}33-(R*i*)(R*j*)(R*k*)(R*l*), wherein L_{A}34-(V1)(V1)(V1)(V1) to L_{A}34-(V263)(V263)(V263)(V 263), have the structure | 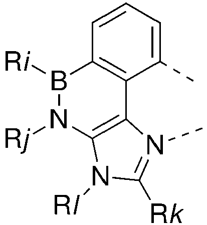 |
| L_{A}35-(R*i*)(R*j*)(R*k*)(R*l*), wherein L_{A}35-(V1)(V1)(V1)(V1) to L_{A}35-(V263)(V263)(V263)(V 263), have the structure | 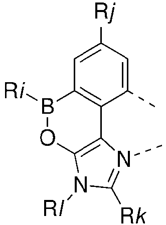 | L_{A}36-(R*i*)(R*j*)(R*k*)(R*l*), wherein L_{A}36-(V1)(V1)(V1)(V1) to L_{A}36-(V263)(V263)(V263)(V 263), have the structure | 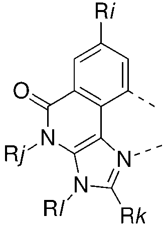 |
| L_{A}37-(R*i*)(R*j*)(R*k*)(R*l*), wherein L_{A}37-(V1)(V1)(V1)(V1) to L_{A}37-(V263)(V263)(V263)(V 263), have the structure | 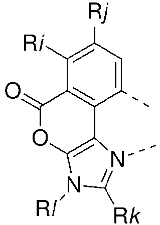 | L_{A}38-(R*i*)(R*j*)(R*k*)(R*l*), wherein L_{A}38-(V1)(V1)(V1)(V1) to L_{A}38-(V263)(V263)(V263)(V 263), have the structure | 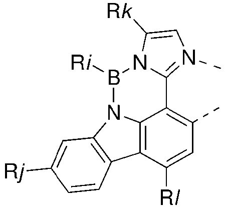 |
| L_{A}39-(R*i*)(R*j*)(R*k*)(R*l*), wherein L_{A}39-(V1)(V1)(V1)(V1) to L_{A}39-(V263)(V263)(V263)(V 263), have the structure | 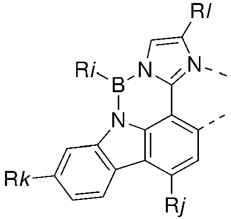 | L_{A}40-(R*i*)(R*j*)(R*k*)(R*l*), wherein L_{A}40-(V1)(V1)(V1)(V1) to L_{A}40-(V263)(V263)(V263)(V 263), have the structure | 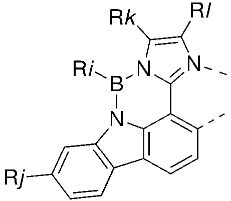 |
| L_{A}41-(R*i*)(R*j*)(R*k*)(R*l*), wherein L_{A}41-(V1)(V1)(V1)(V1) to L_{A}41-(V263)(V263)(V263)(V 263), have the structure | 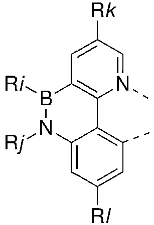 | L_{A}42-(R*i*)(R*j*)(R*k*)(R*l*), wherein L_{A}42-(V1)(V1)(V1)(V1) to L_{A}42-(V263)(V263)(V263)(V 263), have the structure | 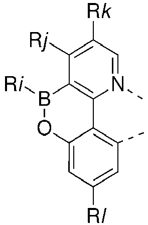 |
| L_{A}43-(R*i*)(R*j*)(R*k*)(R*l*), wherein L_{A}43-(V1)(V1)(V1)(V1) to L_{A}43-(V263)(V263)(V263)(V 263), have the structure | 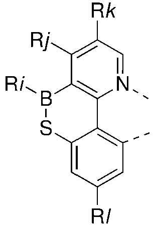 | L_{A}44-(R*i*)(R*j*)(R*k*)(R*l*), wherein L_{A}44-(V1)(V1)(V1)(V1) to L_{A}44-(V263)(V263)(V263)(V 263), have the structure | 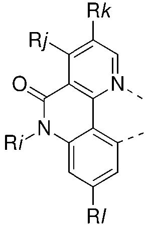 |
| L_{A}45-(R*i*)(R*j*)(R*k*)(R*l*), wherein L_{A}45-(V1)(V1)(V1)(V1) to L_{A}45-(V263)(V263)(V263)(V 263), have the structure | 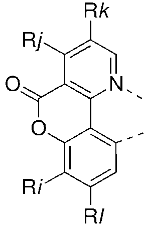 | L_{A}46-(R*i*)(R*j*)(R*k*)(R*l*), wherein L_{A}46-(V1)(V1)(V1)(V1) to L_{A}46-(V263)(V263)(V263)(V 263), have the structure | 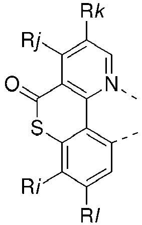 |
| L_{A}47-(R*i*)(R*j*)(R*k*)(R*l*), wherein L_{A}47-(V1)(V1)(V1)(V1) to L_{A}47-(V263)(V263)(V263)(V 263), have the structure | 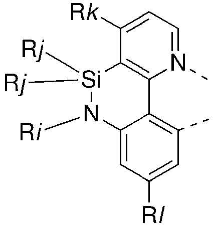 | L_{A}48-(R*i*)(R*j*)(R*k*)(R*l*), wherein L_{A}48-(V1)(V1)(V1)(V1) to L_{A}48-(V263)(V263)(V263)(V 263), have the structure | 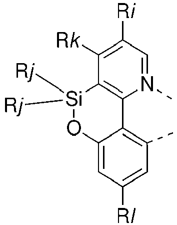 |
| L_{A}49-(R*i*)(R*j*)(R*k*)(R*l*), wherein L_{A}49-(V1)(V1)(V1)(V1) to L_{A}49-(V263)(V263)(V263)(V 263), have the structure | 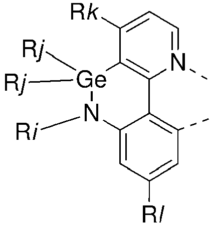 | L_{A}50-(R*i*)(R*j*)(R*k*)(R*l*), wherein L_{A}50-(V1)(V1)(V1)(V1) to L_{A}50-(V263)(V263)(V263)(V 263), have the structure | 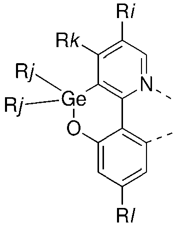 |
| L_{A}51-(R*i*)(R*j*)(R*k*)(R*l*), wherein L_{A}51-(V1)(V1)(V1)(V1) to L_{A}51-(V263)(V263)(V263)(V 263), have the structure | 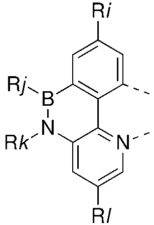 | L_{A}52-(R*i*)(R*j*)(R*k*)(R*l*), wherein L_{A}52-(V1)(V1)(V1)(V1) to L_{A}52-(V263)(V263)(V263)(V 263), have the structure | 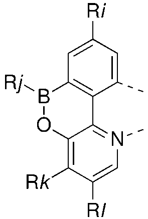 |
| L_{A}53-(R*i*)(R*j*)(R*k*)(R*l*), wherein L_{A}53-(V1)(V1)(V1)(V1) to L_{A}53-(V263)(V263)(V263)(V 263), have the structure | 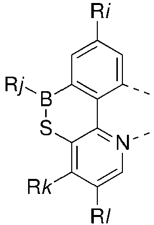 | L_{A}54-(R*i*)(R*j*)(R*k*)(R*l*), wherein L_{A}54-(V1)(V1)(V1)(V1) to L_{A}54-(V263)(V263)(V263)(V 263), have the structure | 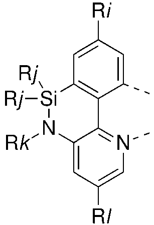 |
| L_{A}55-(R*i*)(R*j*)(R*k*)(R*l*), wherein L_{A}55-(V1)(V1)(V1)(V1) to L_{A}55-(V263)(V263)(V263)(V 263), have the structure | 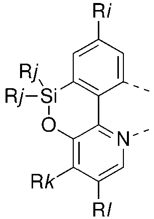 | L_{A}56-(R*i*)(R*j*)(R*k*)(R*l*), wherein L_{A}56-(V1)(V1)(V1)(V1) to L_{A}56-(V263)(V263)(V263)(V 263), have the structure | 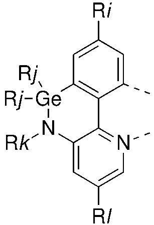 |
| L_{A}57-(R*i*)(R*j*)(R*k*)(R*l*), wherein L_{A}57-(V1)(V1)(V1)(V1) to L_{A}57-(V263)(V263)(V263)(V 263), have the structure | 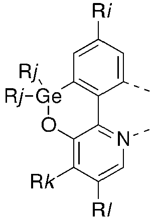 | L_{A}58-(R*i*)(R*j*)(R*k*)(R*l*), wherein L_{A}58-(V1)(V1)(V1)(V1) to L_{A}58-(V263)(V263)(V263)(V 263), have the structure | 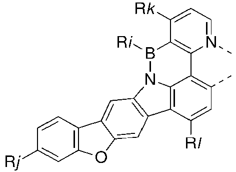 |
| L_{A}59-(R*i*)(R*j*)(R*k*)(R*l*), wherein L_{A}59-(V1)(V1)(V1)(V1) to L_{A}59-(V263)(V263)(V263)(V 263), have the structure | 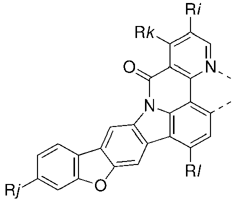 | L_{A}60-(R*i*)(R*j*)(R*k*)(R*l*), wherein L_{A}60-(V1)(V1)(V1)(V1) to L_{A}60-(V263)(V263)(V263)(V 263), have the structure | 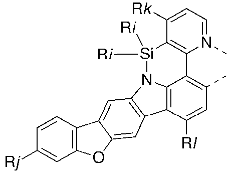 |
| L_{A}61-(R*i*)(R*j*)(R*k*)(R*l*), wherein L_{A}61-(V1)(V1)(V1)(V1) to L_{A}61-(V263)(V263)(V263)(V 263), have the structure | 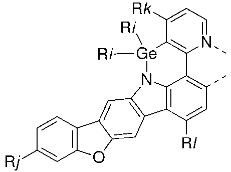 | L_{A}62-(R*i*)(R*j*)(R*k*)(R*l*), wherein L_{A}62-(V1)(V1)(V1)(V1) to L_{A}62-(V263)(V263)(V263)(V 263), have the structure | 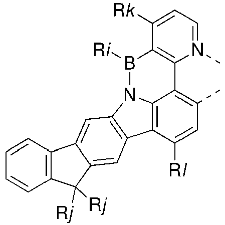 |
| L_{A}63-(R*i*)(R*j*)(R*k*)(R*l*), wherein L_{A}63-(V1)(V1)(V1)(V1) to L_{A}63-(V263)(V263)(V263)(V 263), have the structure | 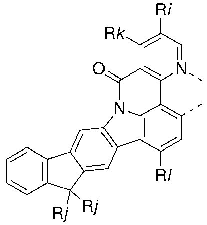 | L_{A}64-(R*i*)(R*j*)(R*k*)(R*l*), wherein L_{A}64-(V1)(V1)(V1)(V1) to L_{A}64-(V263)(V263)(V263)(V 263), have the structure | 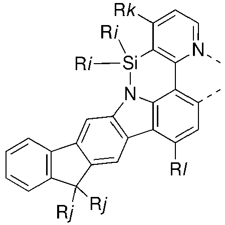 |
| L_{A}65-(R*i*)(R*j*)(R*k*)(R*l*), wherein L_{A}65-(V1)(V1)(V1)(V1) to L_{A}65-(V263)(V263)(V263)(V 263), have the structure | 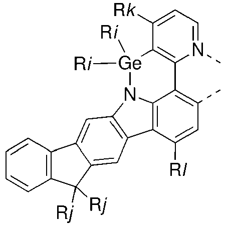 | L_{A}66-(R*i*)(R*j*)(R*k*)(R*l*), wherein L_{A}66-(V1)(V1)(V1)(V1) to L_{A}66-(V263)(V263)(V263)(V 263), have the structure | 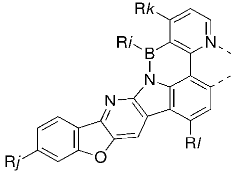 |
| L_{A}67-(R*i*)(R*j*)(R*k*)(R*l*), wherein L_{A}67-(V1)(V1)(V1)(V1) to L_{A}67-(V263)(V263)(V263)(V 263), have the structure | 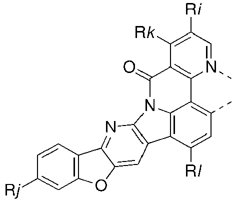 | L_{A}68-(R*i*)(R*j*)(R*k*)(R*l*), wherein L_{A}68-(V1)(V1)(V1)(V1) to L_{A}68-(V263)(V263)(V263)(V 263), have the structure | 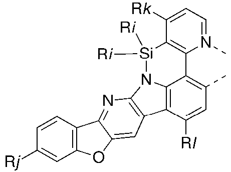 |
| L_{A}69-(R*i*)(R*j*)(R*k*)(R*l*), wherein L_{A}69-(V1)(V1)(V1)(V1) to L_{A}69-(V263)(V263)(V263)(V 263), have the structure | 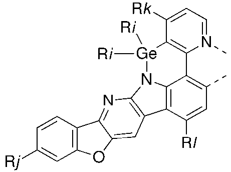 | L_{A}70-(R*i*)(R*j*)(R*k*)(R*l*), wherein L_{A}70-(V1)(V1)(V1)(V1) to L_{A}70-(V263)(V263)(V263)(V 263), have the structure | 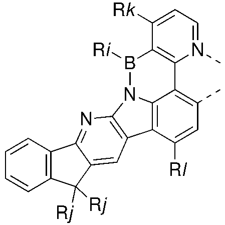 |
| L_{A}71-(R*i*)(R*j*)(R*k*)(R*l*), wherein L_{A}71-(V1)(V1)(V1)(V1) to L_{A}71-(V263)(V263)(V263)(V 263), have the structure | 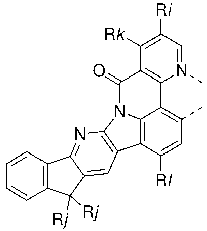 | L_{A}72-(R*i*)(R*j*)(R*k*)(R*l*), wherein L_{A}72-(V1)(V1)(V1)(V1) to L_{A}72-(V263)(V263)(V263)(V 263), have the structure | 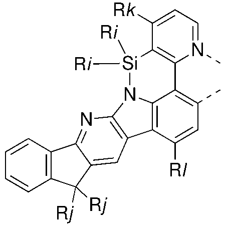 |
| L_{A}73-(R*i*)(R*j*)(R*k*)(R*l*), wherein L_{A}73-(V1)(V1)(V1)(V1) to L_{A}73-(V263)(V263)(V263)(V 263), have the structure | 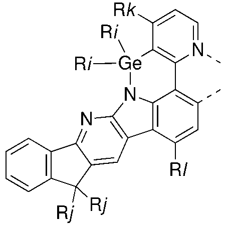 | L_{A}74-(R*i*)(R*j*)(R*k*)(R*l*), wherein L_{A}74-(V1)(V1)(V1)(V1) to L_{A}74-(V263)(V263)(V263)(V 263), have the structure | 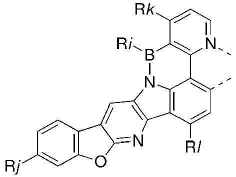 |
| L_{A}75-(R*i*)(R*j*)(R*k*)(R*l*), wherein L_{A}75-(V1)(V1)(V1)(V1) to L_{A}75-(V263)(V263)(V263)(V 263), have the structure | 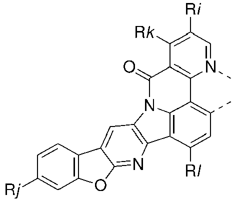 | L_{A}76-(R*i*)(R*j*)(R*k*)(R*l*), wherein L_{A}76-(V1)(V1)(V1)(V1) to L_{A}76-(V263)(V263)(V263)(V 263), have the structure | 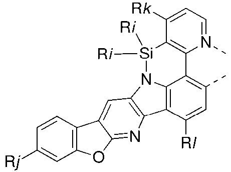 |
| L_{A}77-(R*i*)(R*j*)(R*k*)(R*l*), wherein L_{A}77-(V1)(V1)(V1)(V1) to L_{A}77-(V263)(V263)(V263)(V 263), have the structure | 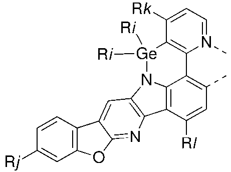 | L_{A}78-(R*i*)(R*j*)(R*k*)(R*l*), wherein L_{A}78-(V1)(V1)(V1)(V1) to L_{A}78-(V263)(V263)(V263)(V 263), have the structure | 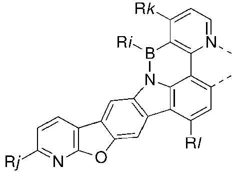 |
| L_{A}79-(R*i*)(R*j*)(R*k*)(R*l*), wherein L_{A}79-(V1)(V1)(V1)(V1) to L_{A}79-(V263)(V263)(V263)(V 263), have the structure | 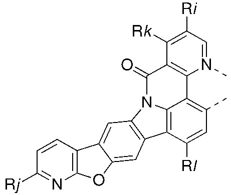 | L_{A}80-(R*i*)(R*j*)(R*k*)(R*l*), wherein L_{A}80-(V1)(V1)(V1)(V1) to L_{A}80-(V263)(V263)(V263)(V 263), have the structure | 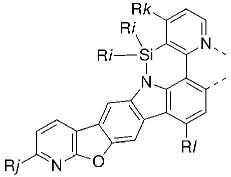 |
| L_{A}81-(R*i*)(R*j*)(R*k*)(R*l*), wherein L_{A}81-(V1)(V1)(V1)(V1) to L_{A}81-(V263)(V263)(V263)(V 263), have the structure | 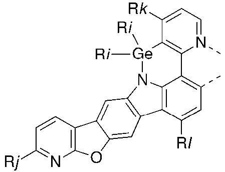 | L_{A}82-(R*i*)(R*j*)(R*k*)(R*l*), wherein L_{A}82-(V1)(V1)(V1)(V1) to L_{A}82-(V263)(V263)(V263)(V 263), have the structure | 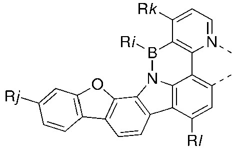 |
| L_{A}83-(R*i*)(R*j*)(R*k*)(R*l*), wherein L_{A}83-(V1)(V1)(V1)(V1) to L_{A}83-(V263)(V263)(V263)(V 263), have the structure | 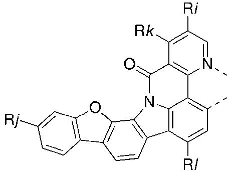 | L_{A}84-(R*i*)(R*j*)(R*k*)(R*l*), wherein L_{A}84-(V1)(V1)(V1)(V1) to L_{A}84-(V263)(V263)(V263)(V 263), have the structure | 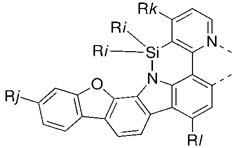 |
| L_{A}85-(R*i*)(R*j*)(R*k*)(R*l*), wherein L_{A}85-(V1)(V1)(V1)(V1) to L_{A}85-(V263)(V263)(V263)(V 263), have the structure | 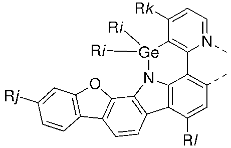 | L_{A}86-(R*i*)(R*j*)(R*k*)(R*l*), wherein L_{A}86-(V1)(V1)(V1)(V1) to L_{A}86-(V263)(V263)(V263)(V 263), have the structure | 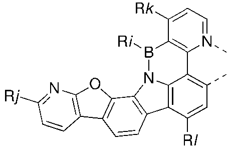 |
| L_{A}87-(R*i*)(R*j*)(R*k*)(R*l*), wherein L_{A}87-(V1)(V1)(V1)(V1) to L_{A}87-(V263)(V263)(V263)(V 263), have the structure | 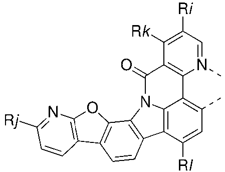 | L_{A}88-(R*i*)(R*j*)(R*k*)(R*l*), wherein L_{A}88-(V1)(V1)(V1)(V1) to L_{A}88-(V263)(V263)(V263)(V 263), have the structure | 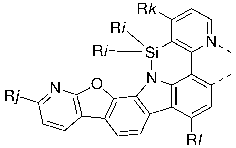 |
| L_{A}89-(R*i*)(R*j*)(R*k*)(R*l*), wherein L_{A}89-(V1)(V1)(V1)(V1) to L_{A}89-(V263)(V263)(V263)(V 263), have the structure | 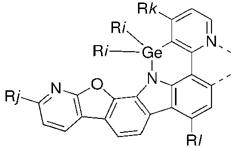 | L_{A}90-(R*i*)(R*j*)(R*k*)(R*l*), wherein L_{A}90-(V1)(V1)(V1)(V1) to L_{A}90-(V263)(V263)(V263)(V 263), have the structure | 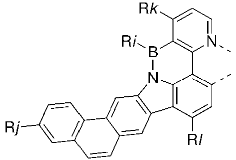 |
| L_{A}91-(R*i*)(R*j*)(R*k*)(R*l*), wherein L_{A}91-(V1)(V1)(V1)(V1) to L_{A}91-(V263)(V263)(V263)(V 263), have the structure | 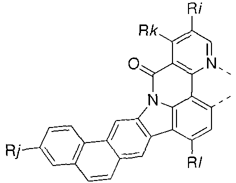 | L_{A}92-(R*i*)(R*j*)(R*k*)(R*l*), wherein L_{A}92-(V1)(V1)(V1)(V1) to L_{A}92-(V263)(V263)(V263)(V 263), have the structure | 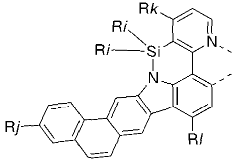 |
| L_{A}93-(R*i*)(R*j*)(R*k*)(R*l*), wherein L_{A}93-(V1)(V1)(V1)(V1) to L_{A}93-(V263)(V263)(V263)(V 263), have the structure | 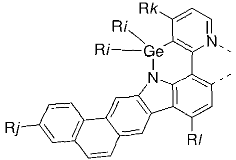 | L_{A}94-(R*i*)(R*j*)(R*k*)(R*l*), wherein L_{A}94-(V1)(V1)(V1)(V1) to L_{A}94-(V263)(V263)(V263)(V 263), have the structure | 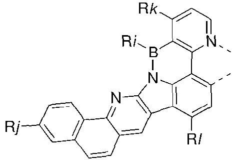 |
| L_{A}95-(R*i*)(R*j*)(R*k*)(R*l*), wherein L_{A}95-(V1)(V1)(V1)(V1) to L_{A}95-(V263)(V263)(V263)(V 263), have the structure | 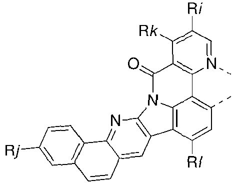 | L_{A}96-(R*i*)(R*j*)(R*k*)(R*l*), wherein L_{A}96-(V1)(V1)(V1)(V1) to L_{A}96-(V263)(V263)(V263)(V 263), have the structure | 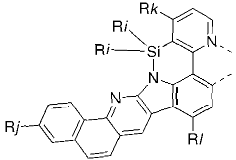 |
| L_{A}97-(R*i*)(R*j*)(R*k*)(R*l*), wherein L_{A}97-(V1)(V1)(V1)(V1) to L_{A}97-(V263)(V263)(V263)(V 263), have the structure | 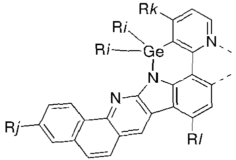 | L_{A}98-(R*i*)(R*j*)(R*k*)(R*l*), wherein L_{A}98-(V1)(V1)(V1)(V1) to L_{A}98-(V263)(V263)(V263)(V 263), have the structure | 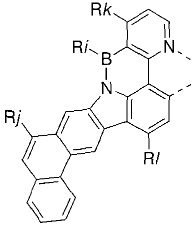 |
| L_{A}99-(R*i*)(R*j*)(R*k*)(R*l*), wherein L_{A}99-(V1)(V1)(V1)(V1) to L_{A}99-(V263)(V263)(V263)(V 263), have the structure | 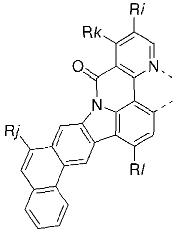 | L_{A}100-(R*i*)(R*j*)(R*k*)(R*l*), wherein L_{A}100-(V1)(V1)(V1)(V1) to L_{A}100-(V263)(V263)(V263)(V 263), have the structure | 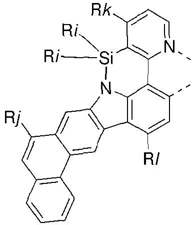 |
| L_{A}101-(R*i*)(R*j*)(R*k*)(R*l*), wherein L_{A}101-(V1)(V1)(V1)(V1) to L_{A}101-(V263)(V263)(V263)(V 263), have the structure | 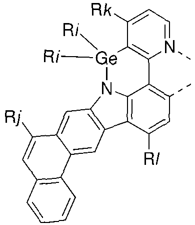 | L_{A}102-(R*i*)(R*j*)(R*k*)(R*l*), wherein L_{A}102-(V1)(V1)(V1)(V1) to L_{A}102-(V263)(V263)(V263)(V 263), have the structure | 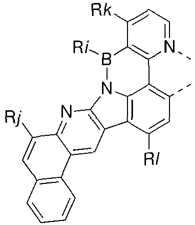 |
| L_{A}103-(R*i*)(R*j*)(R*k*)(R*l*), wherein L_{A}103-(V1)(V1)(V1)(V1) to L_{A}103-(V263)(V263)(V263)(V 263), have the structure | 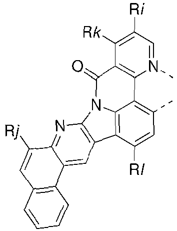 | L_{A}104-(R*i*)(R*j*)(R*k*)(R*l*), wherein L_{A}104-(V1)(V1)(V1)(V1) to L_{A}104-(V263)(V263)(V263)(V 263), have the structure | 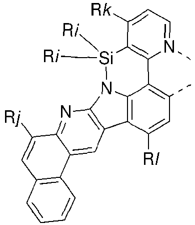 |
| L_{A}105-(R*i*)(R*j*)(R*k*)(R*l*), wherein L_{A}105-(V1)(V1)(V1)(V1) to L_{A}105-(V263)(V263)(V263)(V 263), have the structure | 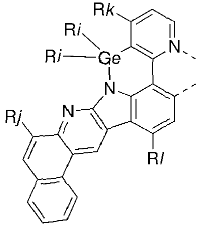 | L_{A}106-(R*i*)(R*j*)(R*k*)(R*l*), wherein L_{A}106-(V1)(V1)(V1)(V1) to L_{A}106-(V263)(V263)(V263)(V 263), have the structure | 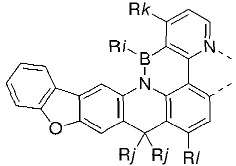 |
| L_{A}107-(R*i*)(R*j*)(R*k*)(R*l*), wherein L_{A}107-(V1)(V1)(V1)(V1) to L_{A}107-(V263)(V263)(V263)(V 263), have the structure | 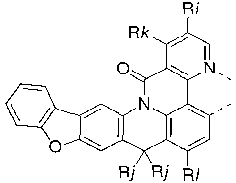 | L_{A}108-(R*i*)(R*j*)(R*k*)(R*l*), wherein L_{A}108-(V1)(V1)(V1)(V1) to L_{A}108-(V263)(V263)(V263)(V 263), have the structure | 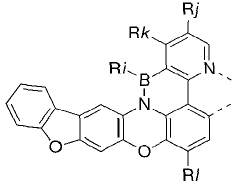 |
| L_{A} 109-(R*i*)(R*j*)(R*k*)(R*l*), wherein L_{A}109-(V1)(V1)(V1)(V1) to L_{A}109-(V263)(V263)(V263)(V 263), have the structure | 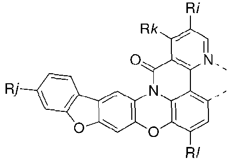 | L_{A}110-(R*i*)(R*j*)(R*k*)(R*l*), wherein L_{A}110-(V1)(V1)(V1)(V1) to L_{A}110-(V263)(V263)(V263)(V 263), have the structure | 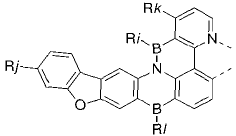 |
| L_{A}111-(R*i*)(R*j*)(R*k*)(R*l*), wherein L_{A}111-(V1)(V1)(V1)(V1) to L_{A}111-(V263)(V263)(V263)(V 263), have the structure | 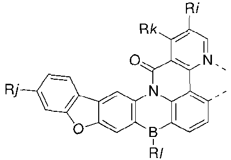 | L_{A}112-(R*i*)(R*j*)(R*k*)(R*l*), wherein L_{A}112-(V1)(V1)(V1)(V1) to L_{A}112-(V263)(V263)(V263)(V 263), have the structure | 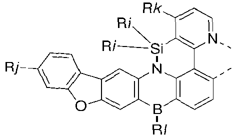 |
| L_{A}113-(R*i*)(R*j*)(R*k*)(R*l*), wherein L_{A}113-(V1)(V1)(V1)(V1) to L_{A}113-(V263)(V263)(V263)(V 263), have the structure | 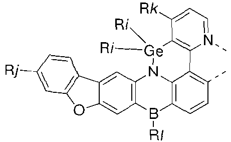 | L_{A}114-(R*i*)(R*j*)(R*k*)(R*l*), wherein L_{A}114-(V1)(V1)(V1)(V1) to L_{A}114-(V263)(V263)(V263)(V 263), have the structure | 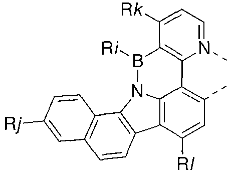 |
| L_{A}115-(R*i*)(R*j*)(R*k*)(R*l*), wherein L_{A}115-(V1)(V1)(V1)(V1) to L_{A}115-(V263)(V263)(V263)(V 263), have the structure | 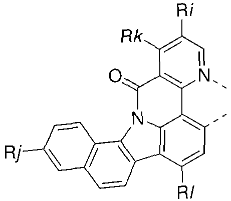 | L_{A}116-(R*i*)(R*j*)(R*k*)(R*l*), wherein L_{A}116-(V1)(V1)(V1)(V1) to L_{A}116-(V263)(V263)(V263)(V 263), have the structure | 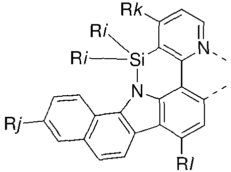 |
| L_{A}117-(R*i*)(R*j*)(R*k*)(R*l*), wherein L_{A}117-(V1)(V1)(V1)(V1) to L_{A}117-(V263)(V263)(V263)(V 263), have the structure | 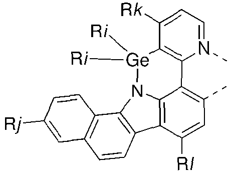 | L_{A}118-(R*i*)(R*j*)(R*k*)(R*l*), wherein L_{A}118-(V1)(V1)(V1)(V1) to L_{A}118-(V263)(V263)(V263)(V 263), have the structure | 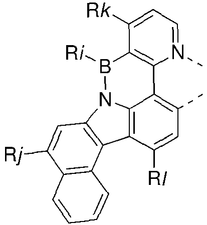 |
| L_{A}119-(R*i*)(R*j*)(R*k*)(R*l*), wherein L_{A}119-(V1)(V1)(V1)(V1) to L_{A}119-(V263)(V263)(V263)(V 263), have the structure | 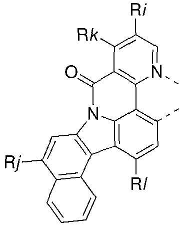 | L_{A}120-(R*i*)(R*j*)(R*k*)(R*l*), wherein L_{A}120-(V1)(V1)(V1)(V1) to L_{A}120-(V263)(V263)(V263)(V 263), have the structure | 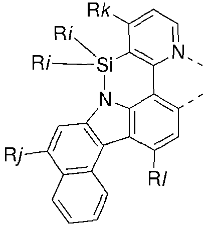 |
| L_{A}121-(R*i*)(R*j*)(R*k*)(R*l*), wherein L_{A}121-(V1)(V1)(V1)(V1) to L_{A}121-(V263)(V263)(V263)(V 263), have the structure | 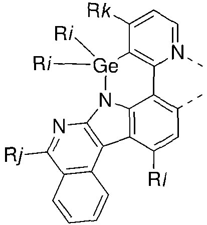 | L_{A1}22-(R*i*)(R*j*)(R*k*)(R*l*), wherein L_{A}122-(V1)(V1)(V1)(V1) to L_{A}122-(V263)(V263)(V263)(V 263), have the structure | 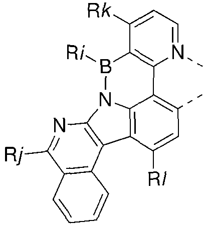 |
| L_{A}123-(R*i*)(R*j*)(R*k*)(R*l*), wherein L_{A}123-(V1)(V1)(V1)(V1) to L_{A}123-(V263)(V263)(V263)(V 263), have the structure | 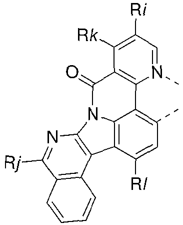 | L_{A}124-(R*i*)(R*j*)(R*k*)(R*l*), wherein L_{A}124-(V1)(V1)(V1)(V1) to L_{A}124-(V263)(V263)(V263)(V 263), have the structure | 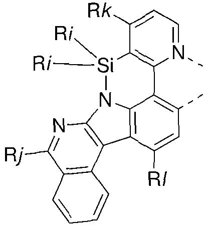 |
| L_{A}125-(R*i*)(R*j*)(R*k*)(R*l*), wherein L_{A}125-(V1)(V1)(V1)(V1) to L_{A}125-(V263)(V263)(V263)(V 263), have the structure | 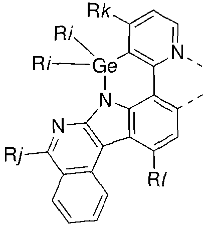 | L_{A}126-(R*i*)(R*j*)(R*k*)(R*l*), wherein L_{A}126-(V1)(V1)(V1)(V1) to L_{A}126-(V263)(V263)(V263)(V 263), have the structure | 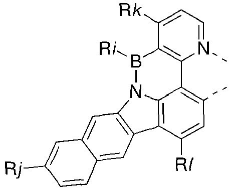 |
| L_{A}127-(R*i*)(R*j*)(R*k*)(R*l*), wherein L_{A}127-(V1)(V1)(V1)(V1) to L_{A}127-(V263)(V263)(V263)(V 263), have the structure | 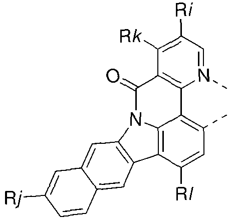 | L_{A}128-(R*i*)(R*j*)(R*k*)(R*l*), wherein L_{A}128-(V1)(V1)(V1)(V1) to L_{A}128-(V263)(V263)(V263)(V 263), have the structure | 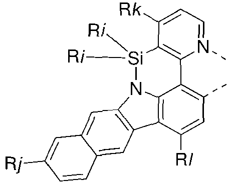 |
| L_{A}129-(R*i*)(R*j*)(R*k*)(R*l*), wherein L_{A}129-(V1)(V1)(V1)(V1) to L_{A}129-(V263)(V263)(V263)(V 263), have the structure | 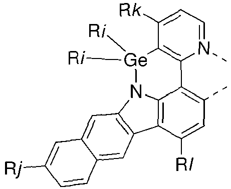 | L_{A}130-(R*i*)(R*j*)(R*k*)(R*l*), wherein L_{A}130-(V1)(V1)(V1)(V1) to L_{A}130-(V263)(V263)(V263)(V 263), have the structure | 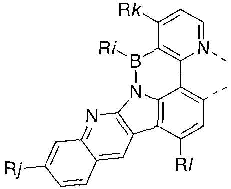 |
| L_{A}131-(R*i*)(R*j*)(R*k*)(R*l*), wherein L_{A}131-(V1)(V1)(V1)(V1) to L_{A}131-(V263)(V263)(V263)(V 263), have the structure | 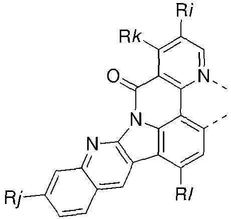 | L_{A}132-(R*i*)(R*j*)(R*k*)(R*l*), wherein L_{A}132-(V1)(V1)(V1)(V1) to L_{A}132-(V263)(V263)(V263)(V 263), have the structure | 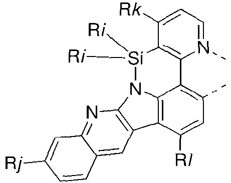 |
| L_{A}133-(R*i*)(R*j*)(R*k*)(R*l*), wherein L_{A}133-(V1)(V1)(V1)(V1) to L_{A}133-(V263)(V263)(V263)(V 263), have the structure | 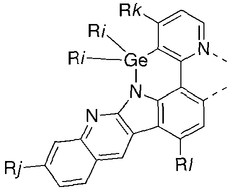 | L_{A}134-(R*i*)(R*j*)(R*k*)(R*l*), wherein L_{A}134-(V1)(V1)(V1)(V1) to L_{A}134-(V263)(V263)(V263)(V 263), have the structure | 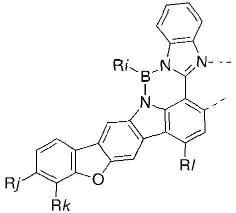 |
| L_{A}135-(R*i*)(R*j*)(R*k*)(R*l*), wherein L_{A}135-(V1)(V1)(V1)(V1) to L_{A}135-(V263)(V263)(V263)(V 263), have the structure | 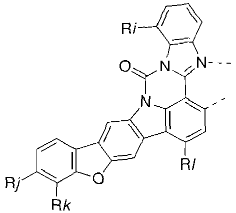 | L_{A}136-(R*i*)(R*j*)(R*k*)(R*l*), wherein L_{A}136-(V1)(V1)(V1)(V1) to L_{A}136-(V263)(V263)(V263)(V 263), have the structure | 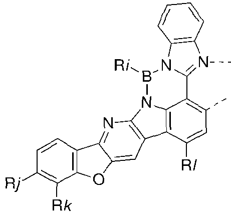 |
| L_{A}137-(R*i*)(R*j*)(R*k*)(R*l*)*,* wherein L_{A}137-(V1)(V1)(V1)(V1) to L_{A}137-(V263)(V263)(V263)(V 263), have the structure | 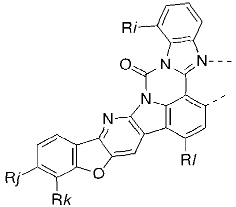 | L_{A}138-(R*i*)(R*j*)(R*k*)(R*l*), wherein L_{A}138-(V1)(V1)(V1)(V1) to L_{A}138-(V263)(V263)(V263)(V 263), have the structure | 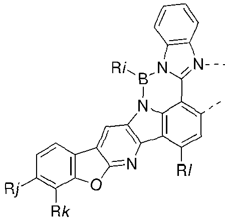 |
| L_{A}139-(R*i*)(R*j*)(R*k*)(R*l*), wherein L_{A}139-(V1)(V1)(V1)(V1) to L_{A}139-(V263)(V263)(V263)(V 263), have the structure | 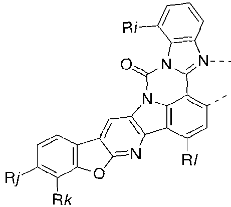 | L_{A}140-(R*i*)(R*j*)(R*k*)(R*l*), wherein L_{A}140-(V1)(V1)(V1)(V1) to L_{A}140-(V263)(V263)(V263)(V 263), have the structure | 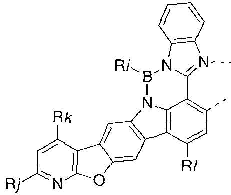 |
| L_{A}141-(R*i*)(R*j*)(R*k*)(R*l*), wherein L_{A}141-(V1)(V1)(V1)(V1) to L_{A}141-(V263)(V263)(V263)(V 263), have the structure | 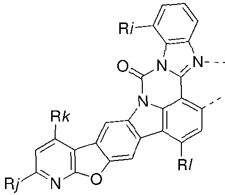 | L_{A}142-(R*i*)(R*j*)(R*k*)(R*l*), wherein L_{A}142-(V1)(V1)(V1)(V1) to L_{A}142-(V263)(V263)(V263)(V 263), have the structure | 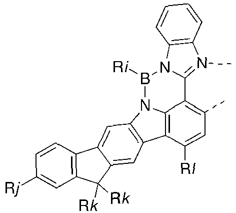 |
| L_{A}143-(R*i*)(R*j*)(R*k*)(R*l*), wherein L_{A}143-(V1)(V1)(V1)(V1) to L_{A}143-(V263)(V263)(V263)(V 263), have the structure | 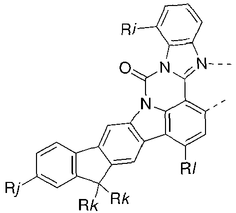 | L_{A}144-(R*i*)(R*j*)(R*k*)(R*l*), wherein L_{A}144-(V1)(V1)(V1)(V1) to L_{A}144-(V263)(V263)(V263)(V 263), have the structure | 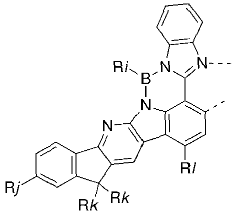 |
| L_{A}145-(R*i*)(R*j*)(R*k*)(R*l*), wherein L_{A}145-(V1)(V1)(V1)(V1) to L_{A}145-(V263)(V263)(V263)(V 263), have the structure | 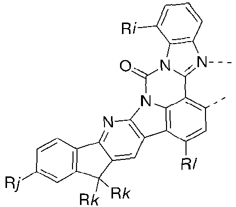 | L_{A}146-(R*i*)(R*j*)(R*k*)(R*l*), wherein L_{A}146-(V1)(V1)(V1)(V1) to L_{A}146-(V263)(V263)(V263)(V 263), have the structure | 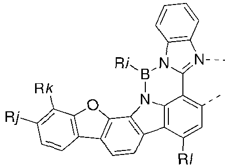 |
| L_{A}147-(R*i*)(R*j*)(R*k*)(R*l*), wherein L_{A}147-(V1)(V1)(V1)(V1) to L_{A}147-(V263)(V263)(V263)(V 263), have the structure | 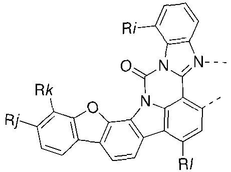 | L_{A}148-(R*i*)(R*j*)(R*k*)(R*l*), wherein L_{A}148-(V1)(V1)(V1)(V1) to L_{A}148-(V263)(V263)(V263)(V 263), have the structure | 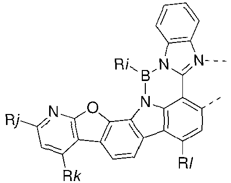 |
| L_{A}149-(R*i*)(R*j*)(R*k*)(R*l*), wherein L_{A}149-(V1)(V1)(V1)(V1) to L_{A}149-(V263)(V263)(V263)(V 263), have the structure | 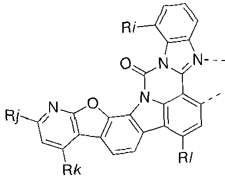 | L_{A}150-(R*i*)(R*j*)(R*k*)(R*l*), wherein L_{A}150-(V1)(V1)(V1)(V1) to L_{A}150-(V263)(V263)(V263)(V 263), have the structure | 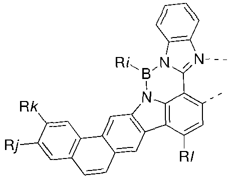 |
| L_{A}151-(R*i*)(R*j*)(R*k*)(R*l*), wherein L_{A}151-(V1)(V1)(V1)(V1) to L_{A}151-(V263)(V263)(V263)(V 263), have the structure | 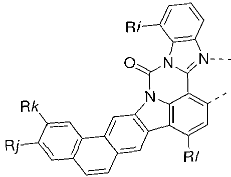 | L_{A}152-(R*i*)(R*j*)(R*k*)(R*l*), wherein L_{A}152-(V1)(V1)(V1)(V1) to L_{A}152-(V263)(V263)(V263)(V 263), have the structure | 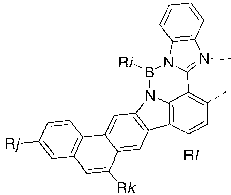 |
| L_{A}153-(R*i*)(R*j*)(R*k*)(R*l*), wherein L_{A}153-(V1)(V1)(V1)(V1) to L_{A}153-(V263)(V263)(V263)(V 263), have the structure | 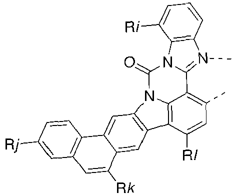 | L_{A}154-(R*i*)(R*j*)(R*k*)(R*l*), wherein L_{A}154-(V1)(V1)(V1)(V1) to L_{A}154-(V263)(V263)(V263)(V 263), have the structure | 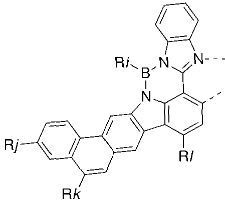 |
| L_{A}155-(R*i*)(R*j*)(R*k*)(R*l*), wherein L_{A}155-(V1)(V1)(V1)(V1) to L_{A}155-(V263)(V263)(V263)(V 263), have the structure | 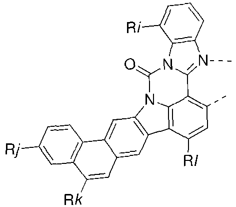 | L_{A}156-(R*i*)(R*j*)(R*k*)(R*l*), wherein L_{A}156-(V1)(V1)(V1)(V1) to L_{A}156-(V263)(V263)(V263)(V 263), have the structure | 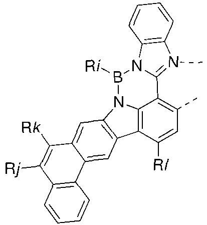 |
| L_{A}157-(R*i*)(R*j*)(R*k*)(R*l*), wherein L_{A}157-(V1)(V1)(V1)(V1) to L_{A}157-(V263)(V263)(V263)(V 263), have the structure | 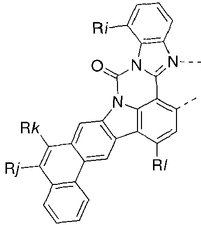 | L_{A}158-(R*i*)(R*j*)(R*k*)(R*l*), wherein L_{A}158-(V1)(V1)(V1)(V1) to L_{A}158-(V263)(V263)(V263)(V 263), have the structure | 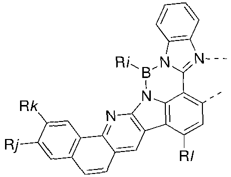 |
| L_{A}159-(R*i*)(R*j*)(R*k*)(R*l*), wherein L_{A}159-(V1)(V1)(V1)(V1) to L_{A}159-(V263)(V263)(V263)(V 263), have the structure | 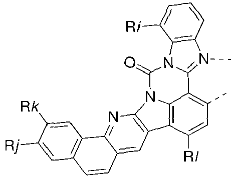 | L_{A}160-(R*i*)(R*j*)(R*k*)(R*l*), wherein L_{A}160-(V1)(V1)(V1)(V1) to L_{A}160-(V263)(V263)(V263)(V 263), have the structure | 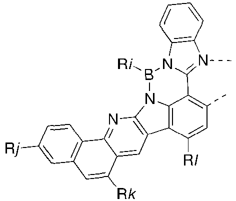 |
| L_{A}161-(R*i*)(R*j*)(R*k*)(R*l*), wherein L_{A}161-(V1)(V1)(V1)(V1) to L_{A}161-(V263)(V263)(V263)(V 263), have the structure | 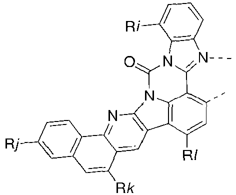 | L_{A}162-(R*i*)(R*j*)(R*k*)(R*l*), wherein L_{A}162-(V1)(V1)(V1)(V1) to L_{A}162-(V263)(V263)(V263)(V 263), have the structure | 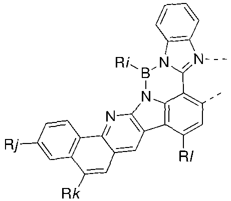 |
| L_{A}163-(R*i*)(R*j*)(R*k*)(R*l*), wherein L_{A}163-(V1)(V1)(V1)(V1) to L_{A}163-(V263)(V263)(V263)(V 263), have the structure | 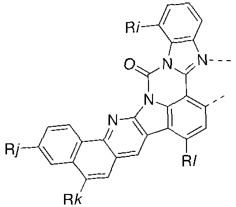 | L_{A}164-(R*i*)(R*j*)(R*k*)(R*l*), wherein L_{A}164-(V1)(V1)(V1)(V1) to L_{A}164-(V263)(V263)(V263)(V 263), have the structure | 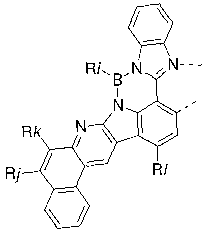 |
| L_{A}165-(R*i*)(R*j*)(R*k*)(R*l*), wherein L_{A}165-(V1)(V1)(V1)(V1) to L_{A}165-(V263)(V263)(V263)(V 263), have the structure | 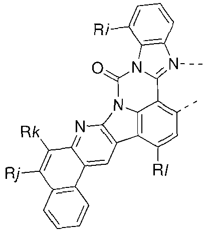 | L_{A}166-(R*i*)(R*j*)(R*k*)(R*l*), wherein L_{A}166-(V1)(V1)(V1)(V1) to L_{A}166-(V263)(V263)(V263)(V 263), have the structure | 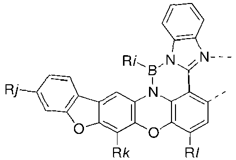 |
| L_{A}167-(R*i*)(R*j*)(R*k*)(R*l*), wherein L_{A}167-(V1)(V1)(V1)(V1) to L_{A}167-(V263)(V263)(V263)(V 263), have the structure | 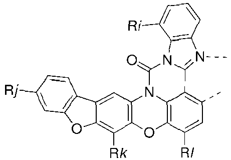 | L_{A}168-(R*i*)(R*j*)(R*k*)(R*l*), wherein L_{A}168-(V1)(V1)(V1)(V1) to L_{A}168-(V263)(V263)(V263)(V 263), have the structure | 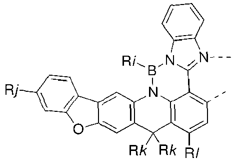 |
| L_{A}169-(R*i*)(R*j*)(R*k*)(R*l*), wherein L_{A}169-(V1)(V1)(V1)(V1) to L_{A}169-(V263)(V263)(V263)(V 263), have the structure | 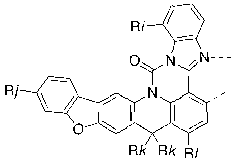 | L_{A}170-(R*i*)(R*j*)(R*k*)(R*l*), wherein L_{A}170-(V1)(V1)(V1)(V1) to L_{A}170-(V263)(V263)(V263)(V 263), have the structure | 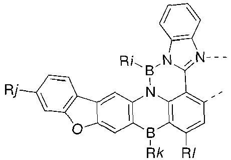 |
| L_{A}171-(R*i*)(R*j*)(R*k*)(R*l*), wherein L_{A}171-(V1)(V1)(V1)(V1) to L_{A}171-(V263)(V263)(V263)(V 263), have the structure | 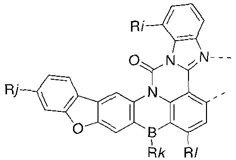 | L_{A}172-(R*i*)(R*j*)(R*k*)(R*l*), wherein L_{A}172-(V1)(V1)(V1)(V1) to L_{A}172-(V263)(V263)(V263)(V 263), have the structure | 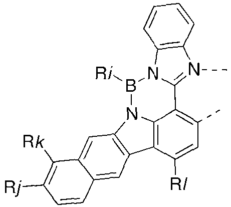 |
| L_{A}173-(R*i*)(R*j*)(R*k*)(R*l*), wherein L_{A}173-(V1)(V1)(V1)(V1) to L_{A}173-(V263)(V263)(V263)(V 263), have the structure | 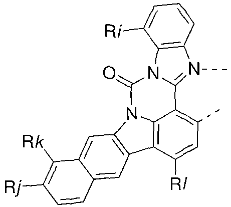 | L_{A}174-(R*i*)(R*j*)(R*k*)(R*l*), wherein L_{A}174-(V1)(V1)(V1)(V1) to L_{A}174-(V263)(V263)(V263)(V 263), have the structure | 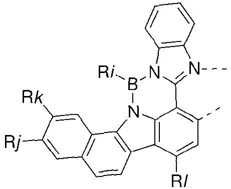 |
| L_{A}175-(R*i*)(R*j*)(R*k*)(R*l*), wherein L_{A}175-(V1)(V1)(V1)(V1) to L_{A}175-(V263)(V263)(V263)(V 263), have the structure | 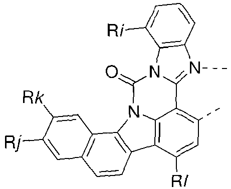 | L_{A}176-(R*i*)(R*j*)(R*k*)(R*l*), wherein L_{A}176-(V1)(V1)(V1)(V1) to L_{A}176-(V263)(V263)(V263)(V 263), have the structure | 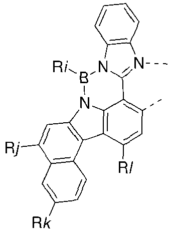 |
| L_{A}177-(R*i*)(R*j*)(R*k*)(R*l*), wherein L_{A}177-(V1)(V1)(V1)(V1) to L_{A}177-(V263)(V263)(V263)(V 263), have the structure | 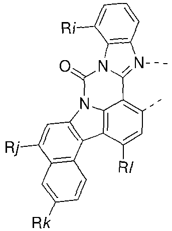 | L_{A}178-(R*i*)(R*j*)(R*k*)(R*l*), wherein L_{A}178-(V1)(V1)(V1)(V1) to L_{A}178-(V263)(V263)(V263)(V 263), have the structure | 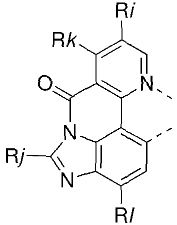 |
| L_{A}179-(R*i*)(R*j*)(R*k*)(R*l*), wherein L_{A}179-(V1)(V1)(V1)(V1) to L_{A}179-(V263)(V263)(V263)(V 263), have the structure | 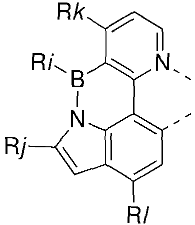 | L_{A}180-(R*i*)(R*j*)(R*k*)(R*l*), wherein L_{A}180-(V1)(V1)(V1)(V1) to L_{A}180-(V263)(V263)(V263)(V 263), have the structure | 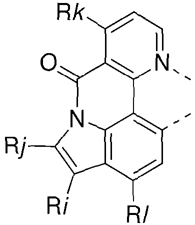 |
| L_{A}181-(R*i*)(R*j*)(R*k*)(R*l*), wherein L_{A}181-(V1)(V1)(V1)(V1) to L_{A}181-(V263)(V263)(V263)(V 263), have the structure | 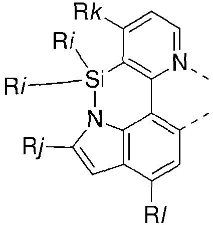 | L_{A}182-(R*i*)(R*j*)(R*k*)(R*l*), wherein L_{A}182-(V1)(V1)(V1)(V1) to L_{A}182-(V263)(V263)(V263)(V 263), have the structure | 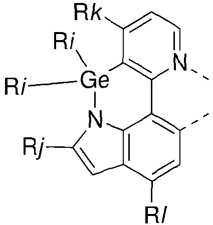 |
| L_{A}183-(R*i*)(R*j*)(R*k*)(R*l*), wherein L_{A}183-(V1)(V1)(V1)(V1) to L_{A}183-(V263)(V263)(V263)(V 263), have the structure | 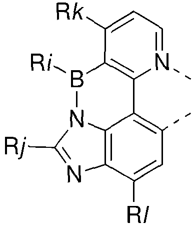 | L_{A}184-(R*i*)(R*j*)(R*k*)(R*l*), wherein L_{A}184-(V1)(V1)(V1)(V1) to L_{A}184-(V263)(V263)(V263)(V 263), have the structure | 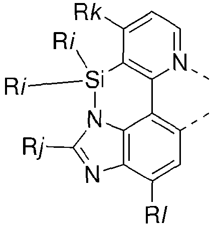 |
| L_{A}185-(R*i*)(R*j*)(R*k*)(R*l*), wherein L_{A}185-(V1)(V1)(V1)(V1) to L_{A}185-(V263)(V263)(V263)(V 263), have the structure | 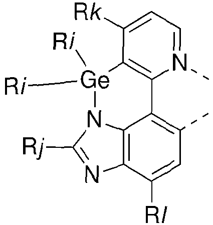 | L_{A}186-(R*i*)(R*j*)(R*k*)(R*l*), wherein Lₐ186-(V1)(V1)(V1)(V1) to L_{A}186-(V263)(V263)(V263)(V 263), have the structure | 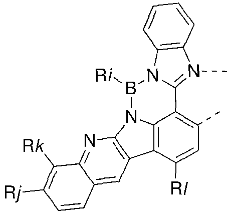 |
| L_{A}187-(R*i*)(R*j*)(R*k*)(R*l*), wherein L_{A}187-(V1)(V1)(V1)(V1) to L_{A}187-(V263)(V263)(V263)(V 263), have the structure | 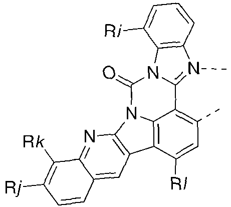 | L_{A}188-(R*i*)(R*j*)(R*k*)(R*l*), wherein L_{A}188-(V1)(V1)(V1)(V1) to L_{A}188-(V263)(V263)(V263)(V 263), have the structure | 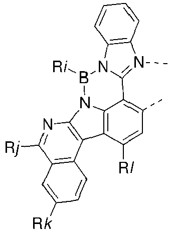 |
| L_{A}189-(R*i*)(R*j*)(R*k*)(R*l*), wherein L_{A}189-(V1)(V1)(V1)(V1) to L_{A}189-(V263)(V263)(V263)(V 263), have the structure | 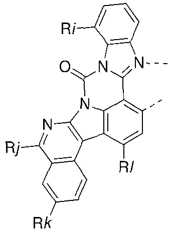 | L_{A}190-(R*i*)(R*j*)(R*k*)(R*l*), wherein L_{A}190-(V1)(V1)(V1)(V1) to L_{A}190-(V263)(V263)(V263)(V 263), have the structure | 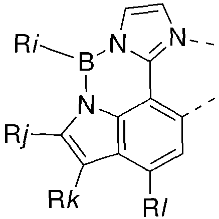 |
| L_{A}191-(R*i*)(R*j*)(R*k*)(R*l*), wherein L_{A}191-(V1)(V1)(V1)(V1) to L_{A}191-(V263)(V263)(V263)(V 263), have the structure | 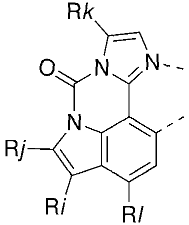 | L_{A}192-(R*i*)(R*j*)(R*k*)(R*l*), wherein L_{A}192-(V1)(V1)(V1)(V1) to L_{A}192-(V263)(V263)(V263)(V 263), have the structure | 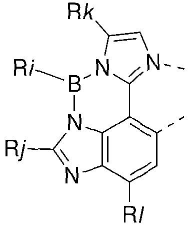 |
| L_{A}193-(R*i*)(R*j*)(R*k*)(R*l*), wherein L_{A}193-(V1)(V1)(V1)(V1) to L_{A}193-(V263)(V263)(V263)(V 263), have the structure | 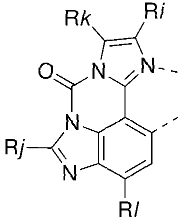 | L_{A}194-(R*i*)(R*j*)(R*k*)(R*l*), wherein L_{A}194-(V1)(V1)(V1)(V1) to L_{A}194-(V263)(V263)(V263)(V 263), have the structure | 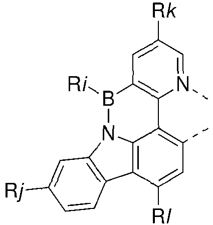 |
| L_{A}195-(R*i*)(R*j*)(R*k*)(R*l*), wherein L_{A}195-(V1)(V1)(V1)(V1) to L_{A}195-(V263)(V263)(V263)(V 263), have the structure | 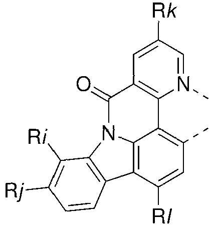 | L_{A}196-(R*i*)(R*j*)(R*k*)(R*l*), wherein L_{A}196-(V1)(V1)(V1)(V1) to L_{A}196-(V263)(V263)(V263)(V 263), have the structure | 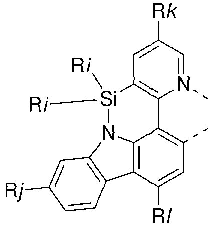 |
| L_{A}197-(R*i*)(R*j*)(R*k*)(R*l*), wherein L_{A}197-(V1)(V1)(V1)(V1) to L_{A}197-(V263)(V263)(V263)(V 263), have the structure | 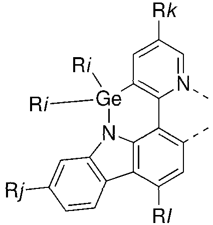 | L_{A}198-(R*i*)(R*j*)(R*k*)(R*l*), wherein L_{A}198-(V1)(V1)(V1)(V1) to L_{A}198-(V263)(V263)(V263)(V 263), have the structure | 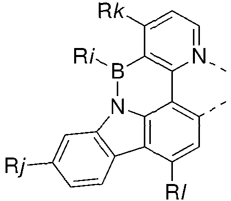 |
| L_{A}199-(R*i*)(R*j*)(R*k*)(R*l*), wherein L_{A}199-(V1)(V1)(V1)(V1) to L_{A}199-(V263)(V263)(V263)(V 263), have the structure | 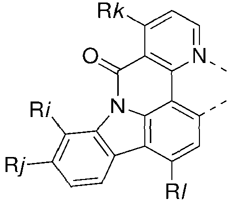 | L_{A}200-(R*i*)(R*j*)(R*k*)(R*l*), wherein L_{A}200-(V1)(V1)(V1)(V1) to L_{A}200-(V263)(V263)(V263)(V 263), have the structure | 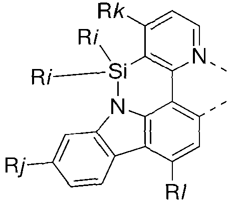 |
| L_{A}201-(R*i*)(R*j*)(R*k*)(Ril), wherein L_{A}201-(V1)(V1)(V1)(V1) to L_{A}201-(V263)(V263)(V263)(V 263), have the structure | 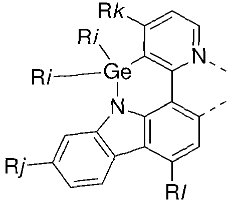 | L_{A}202-(R*i*)(R*j*)(R*k*)(R*l*), wherein L_{A}202-(V1)(V1)(V1)(V1) to L_{A}202-(V263)(V263)(V263)(V 263), have the structure | 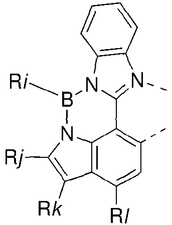 |
| L_{A}203-(R*i*)(R*j*)(R*k*)(R*l*), wherein L_{A}203-(V1)(V1)(V1)(V1) to L_{A}203-(V263)(V263)(V263)(V 263), have the structure | 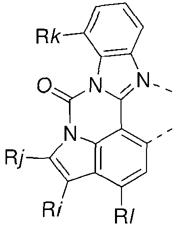 | L_{A}204-(R*i*)(R*j*)(R*k*)(R*l*), wherein L_{A}204-(V1)(V1)(V1)(V1) to L_{A}204-(V263)(V263)(V263)(V 263), have the structure | 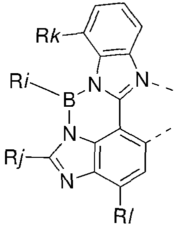 |
| L_{A}205-(R*i*)(R*j*)(R*k*)(R*l*), wherein L_{A}205-(V1)(V1)(V1)(V1) to L_{A}205-(V263)(V263)(V263)(V 263), have the structure | 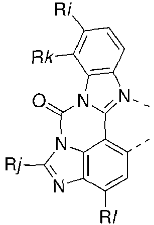 | L_{A}206-(R*i*)(R*j*)(R*k*)(R*l*), wherein L_{A}206-(V1)(V1)(V1)(V1) to L_{A}206-(V263)(V263)(V263)(V 263), have the structure | 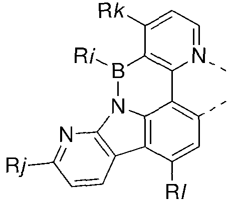 |
| L_{A}207-(R*i*)(R*j*)(R*k*)(R*l*), wherein L_{A}207-(V1)(V1)(V1)(V1) to L_{A}207-(V263)(V263)(V263)(V 263), have the structure | 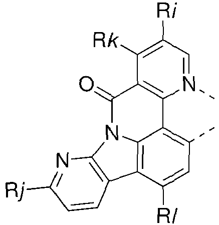 | L_{A}208-(R*i*)(R*j*)(R*k*)(R*l*), wherein L_{A}208-(V1)(V1)(V1)(V1) to L_{A}208-(V263)(V263)(V263)(V 263), have the structure | 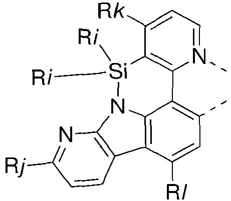 |
| L_{A}209-(R*i*)(R*j*)(R*k*)(R*l*), wherein L_{A}209-(V1)(V1)(V1)(V1) to L_{A}209-(V263)(V263)(V263)(V 263), have the structure | 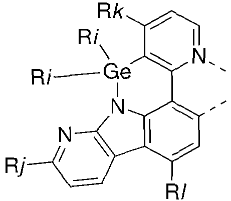 | L_{A}210-(R*i*)(R*j*)(R*k*)(R*l*), wherein L_{A}210-(V1)(V1)(V1)(V1) to L_{A}210-(V263)(V263)(V263)(V 263), have the structure | 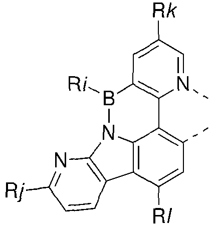 |
| L_{A}211-(R*i*)(R*j*)(R*k*)(R*l*), wherein L_{A}211-(V1)(V1)(V1)(V1) to L_{A}211-(V263)(V263)(V263)(V 263), have the structure | 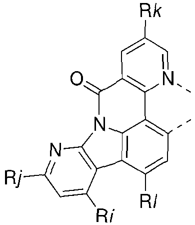 | L_{A}212-(R*i*)(R*j*)(R*k*)(R*l*), wherein L_{A}212-(V1)(V1)(V1)(V1) to L_{A}212-(V263)(V263)(V263)(V 263), have the structure | 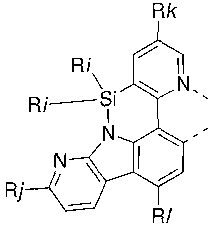 |
| L_{A}213-(R*i*)(R*j*)(R*k*)(R*l*), wherein L_{A}213-(V1)(V1)(V1)(V1) to L_{A}213-(V263)(V263)(V263)(V 263), have the structure | 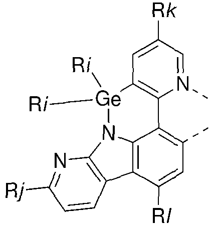 | L_{A}214-(R*i*)(R*j*)(R*k*)(R*l*), wherein L_{A}214-(V1)(V1)(V1)(V1) to L_{A}214-(V263)(V263)(V263)(V 263), have the structure | 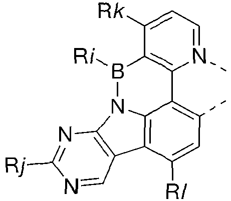 |
| L_{A}215-(R*i*)(R*j*)(R*k*)(R*l*), wherein L_{A}215-(V1)(V1)(V1)(V1) to L_{A}215-(V263)(V263)(V263)(V 263), have the structure | 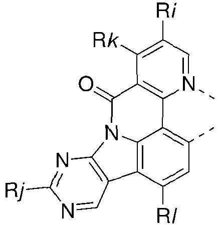 | L_{A}216-(R*i*)(R*j*)(R*k*)(R*l*), wherein L_{A}216-(V1)(V1)(V1)(V1) to L_{A}216-(V263)(V263)(V263)(V 263), have the structure | 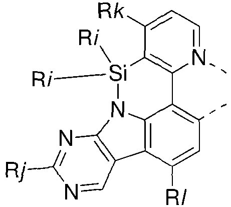 |
| L_{A}217-(R*i*)(R*j*)(R*k*)(R*l*), wherein L_{A}217-(V1)(V1)(V1)(V1) to L_{A}217-(V263)(V263)(V263)(V 263), have the structure | 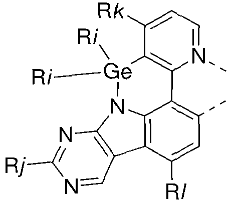 | L_{A}218-(R*i*)(R*j*)(R*k*)(R*l*), wherein L_{A}218-(V1)(V1)(V1)(V1) to L_{A}218-(V263)(V263)(V263)(V 263), have the structure | 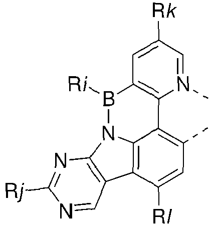 |
| L_{A}219-(R*i*)(R*j*)(R*k*)(R*l*), wherein L_{A}219-(V1)(V1)(V1)(V1) to L_{A}219-(V263)(V263)(V263)(V 263), have the structure | 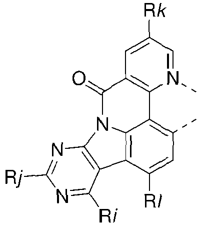 | L_{A}220-(R*i*)(R*j*)(R*k*)(R*l*), wherein L_{A}220-(V1)(V1)(V1)(V1) to L_{A}220-(V263)(V263)(V263)(V 263), have the structure | 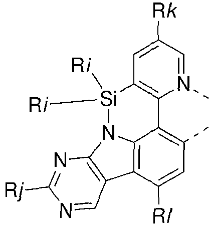 |
| L_{A}221-(R*i*)(R*j*)(R*k*)(R*l*), wherein L_{A}221-(V1)(V1)(V1)(V1) to L_{A}221-(V263)(V263)(V263)(V 263), have the structure | 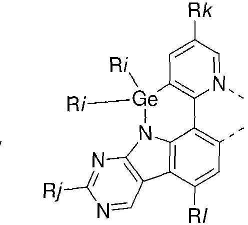 | L_{A}222-(R*i*)(R*j*)(R*k*)(R*l*), wherein L_{A}222-(V1)(V1)(V1)(V1) to L_{A}222-(V263)(V263)(V263)(V 263), have the structure | 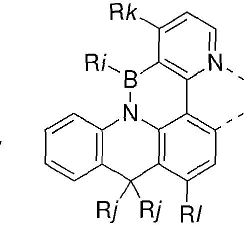 |
| L_{A}223-(R*i*)(R*j*)(R*k*)(R*l*), wherein L_{A}223-(V1)(V1)(V1)(V1) to L_{A}223-(V263)(V263)(V263)(V 263), have the structure | 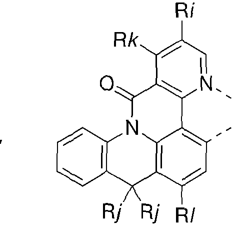 | L_{A}224-(R*i*)(R*j*)(R*k*)(R*l*), wherein L_{A}224-(V1)(V1)(V1)(V1) to L_{A}224-(V263)(V263)(V263)(V 263), have the structure | 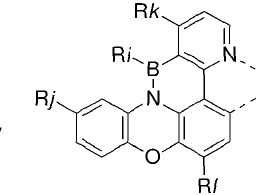 |
| L_{A}263-(R*i*)(R*j*)(R*k*)(R*l*), wherein L_{A}263-(V1)(V1)(V1)(V1) to L_{A}263-(V263)(V263)(V263)(V 263), have the structure | 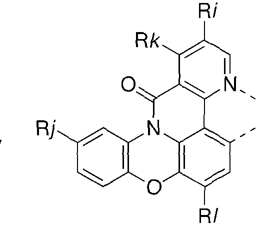 | L_{A}226-(R*i*)(R*j*)(R*k*)(R*l*), wherein L_{A}226-(V1)(V1)(V1)(V1) to L_{A}226-(V263)(V263)(V263)(V 263), have the structure | 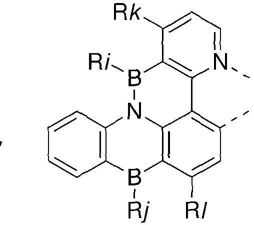 |
| L_{A}227-(R*i*)(R*j*)(R*k*)(R*l*), wherein L_{A}227-(V1)(V1)(V1)(V1) to L_{A}227-(V263)(V263)(V263)(V 263), have the structure | 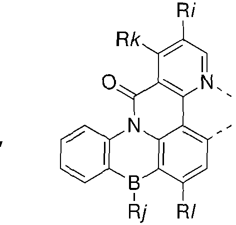 | L_{A}228-(R*i*)(R*j*)(R*k*)(R*l*), wherein L_{A}228-(V1)(V1)(V1)(V1) to L_{A}228-(V263)(V263)(V263)(V 263), have the structure | 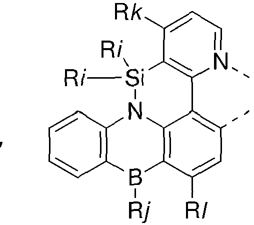 |
| L_{A}229-(R*i*)(R*j*)(R*k*)(R*l*), wherein L_{A}229-(V1)(V1)(V1)(V1) to L_{A}229-(V263)(V263)(V263)(V 263), have the structure | 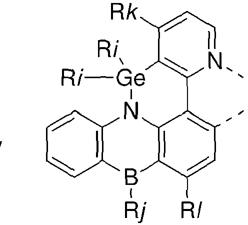 | L_{A}230-(R*i*)(R*j*)(R*k*)(R*l*), wherein L_{A}230-(V1)(V1)(V1)(V1) to L_{A}230-(V263)(V263)(V263)(V 263), have the structure | 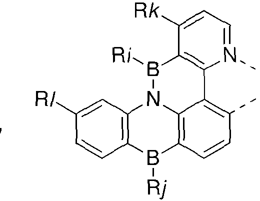 |
| L_{A}231-(R*i*)(R*j*)(R*k*)(R*l*), wherein L_{A}231-(V1)(V1)(V1)(V1) to L_{A}231-(V263)(V263)(V263)(V 263), have the structure | 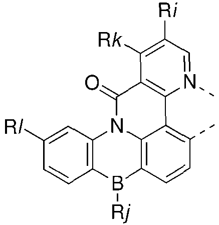 | L_{A}232-(R*i*)(R*j*)(R*k*)(R*l*), wherein L_{A}232-(V1)(V1)(V1)(V1) to L_{A}232-(V263)(V263)(V263)(V 263), have the structure | 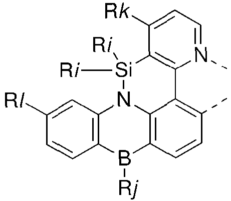 |
| L_{A}233-(R*i*)(R*j*)(R*k*)(R*l*), wherein L_{A}233-(V1)(V1)(V1)(V1) to L_{A}233-(V263)(V263)(V263)(V 263), have the structure | 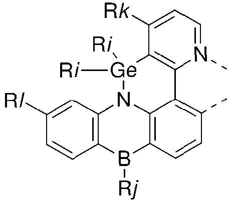 | L_{A}234-(R*i*)(R*j*)(R*k*)(R*l*), wherein L_{A}234-(V1)(V1)(V1)(V1) to L_{A}234-(V263)(V263)(V263)(V 263), have the structure | 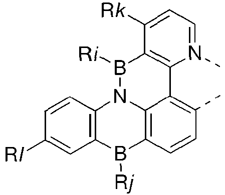 |
| L_{A}235-(R*i*)(R*j*)(R*k*)(R*l*), wherein L_{A}235-(V1)(V1)(V1)(V1) to L_{A}235-(V263)(V263)(V263)(V 263), have the structure | 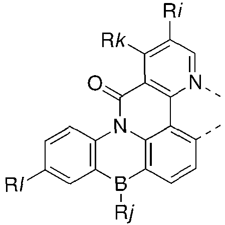 | L_{A}236-(R*i*)(R*j*)(R*k*)(R*l*), wherein L_{A}236-(V1)(V1)(V1)(V1) to L_{A}236-(V263)(V263)(V263)(V 263), have the structure | 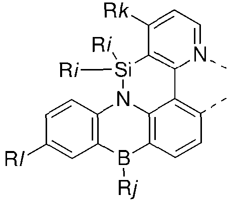 |
| L_{A}237-(R*i*)(R*j*)(R*k*)(R*l*), wherein L_{A}237-(V1)(V1)(V1)(V1) to L_{A}237-(V263)(V263)(V263)(V 263), have the structure | 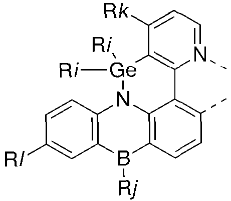 | L_{A}238-(R*i*)(R*j*)(R*k*)(R*l*), wherein L_{A}238-(V1)(V1)(V1)(V1) to L_{A}238-(V263)(V263)(V263)(V 263), have the structure | 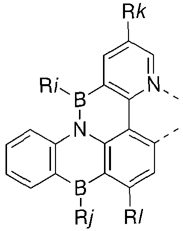 |
| L_{A}239-(R*i*)(R*j*)(R*k*)(R*l*), wherein L_{A}239-(V1)(V1)(V1)(V1) to L_{A}239-(V263)(V263)(V263)(V 263), have the structure | 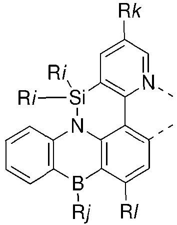 | L_{A}240-(R*i*)(R*j*)(R*k*)(R*l*), wherein L_{A}240-(V1)(V1)(V1)(V1) to L_{A}240-(V263)(V263)(V263)(V 263), have the structure | 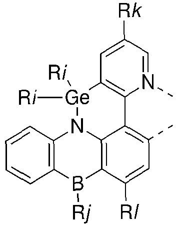 |
| L_{A}241-(R*i*)(R*j*)(R*k*)(R*l*), wherein L_{A}241-(V1)(V1)(V1)(V1) to L_{A}241-(V263)(V263)(V263)(V 263), have the structure | 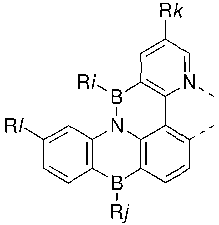 | L_{A}242-(Ri)(R*j*)(R*k*)(R*l*), wherein L_{A}242-(V1)(V1)(V1)(V1) to L_{A}242-(V263)(V263)(V263)(V 263), have the structure | 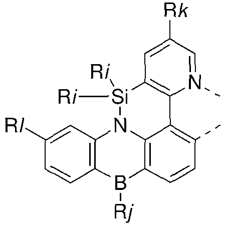 |
| L_{A}243-(R*i*)(R*j*)(R*k*)(R*l*), wherein L_{A}243-(V1)(V1)(V1)(V1) to L_{A}243-(V263)(V263)(V263)(V 263), have the structure | 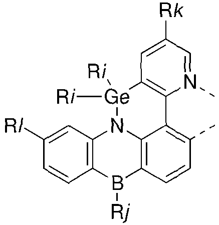 | L_{A}244-(R*i*)(R*j*)(R*k*)(R*l*), wherein L_{A}244-(V1)(V1)(V1)(V1) to L_{A}244-(V263)(V263)(V263)(V 263), have the structure | 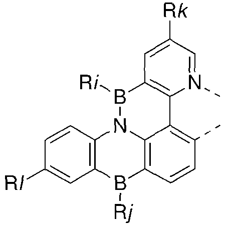 |
| L_{A}245-(R*i*)(R*j*)(R*k*)(R*l*), wherein L_{A}245-(V1)(V1)(V1)(V1) to L_{A}245-(V263)(V263)(V263)(V 263), have the structure | 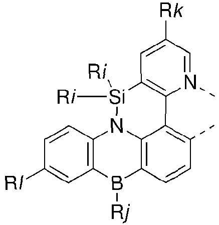 | L_{A}246-(R*i*)(R*j*)(R*k*)(R*l*), wherein L_{A}246-(V1)(V1)(V1)(V1) to L_{A}246-(V263)(V263)(V263)(V 263), have the structure | 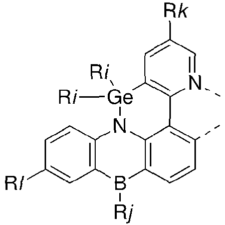 |
| L_{A}247-(R*i*)(R*j*)(R*k*)(R*l*), wherein L_{A}247-(V1)(V1)(V1)(V1) to L_{A}247-(V263)(V263)(V263)(V 263), have the structure | 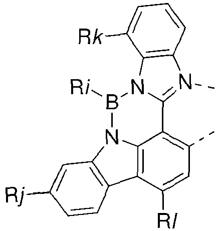 | L_{A}248-(R*i*)(R*j*)(R*k*)(R*l*), wherein L_{A}248-(V1)(V1)(V1)(V1) to L_{A}248-(V263)(V263)(V263)(V 263), have the structure | 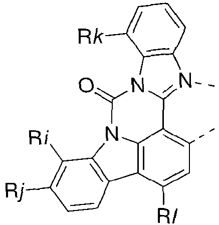 |
| L_{A}249-(R*i*)(R*j*)(R*k*)(R*l*), wherein L_{A}249-(V1)(V1)(V1)(V1) to L_{A}249-(V263)(V263)(V263)(V 263), have the structure | 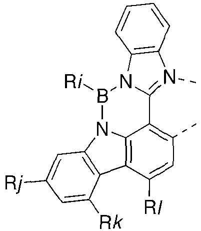 | L_{A}250-(R*i*)(R*j*)(R*k*)(R*l*), wherein L_{A}250-(V1)(V1)(V1)(V1) to L_{A}250-(V263)(V263)(V263)(V 263), have the structure | 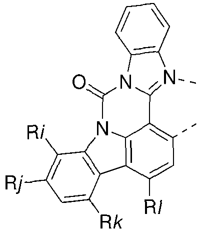 |
| L_{A}251-(R*i*)(R*j*)(R*k*)(R*l*), wherein L_{A}251-(V1)(V1)(V1)(V1) to L_{A}251-(V263)(V263)(V263)(V 263), have the structure | 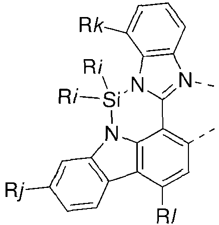 | L_{A}252-(R*i*)(R*j*)(R*k*)(R*l*), wherein L_{A}252-(V1)(V1)(V1)(V1) to L_{A}252-(V263)(V263)(V263)(V 263), have the structure | 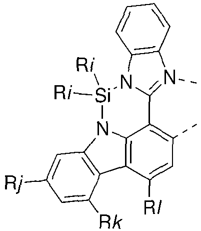 |
| L_{A}253-(R*i*)(R*j*)(R*k*)(R*l*), wherein L_{A}253-(V1)(V1)(V1)(V1) to L_{A}253-(V263)(V263)(V263)(V 263), have the structure | 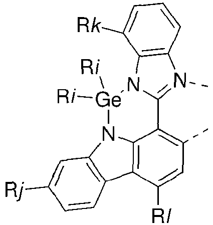 | L_{A}254-(R*i*)(R*j*)(R*k*)(R*l*), wherein L_{A}254-(V1)(V1)(V1)(V1) to L_{A}254-(V263)(V263)(V263)(V 263), have the structure | 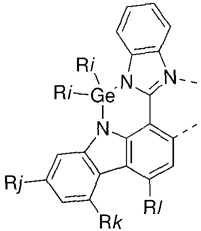 |
| L_{A}255-(R*i*)(R*j*)(R*k*)(R*l*), wherein L_{A}255-(V1)(V1)(V1)(V1) to L_{A}255-(V263)(V263)(V263)(V 263), have the structure | 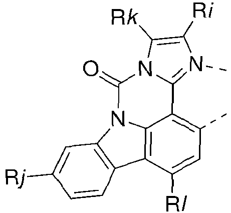 | L_{A}256-(R*i*)(R*j*)(R*k*)(R*l*), wherein L_{A}256-(V1)(V1)(V1)(V1) to L_{A}256-(V263)(V263)(V263)(V 263), have the structure | 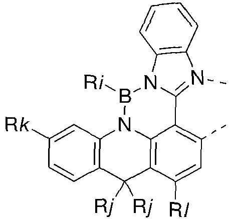 |
| L_{A}257-(R*i*)(R*j*)(R*k*)(R*l*), wherein L_{A}257-(V1)(V1)(V1)(V1) to L_{A}257-(V263)(V263)(V263)(V 263), have the structure | 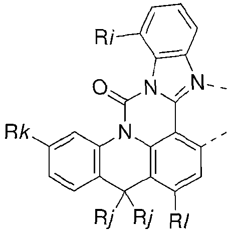 | L_{A}258-(R*i*)(R*j*)(R*k*)(R*l*), wherein L_{A}258-(V1)(V1)(V1)(V1) to L_{A}258-(V263)(V263)(V263)(V 263), have the structure | 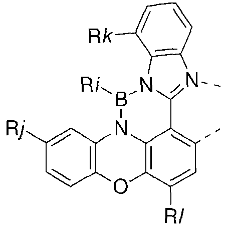 |
| L_{A}259-(R*i*)(R*j*)(R*k*)(R*l*), wherein L_{A}259-(V1)(V1)(V1)(V1) to L_{A}259-(V263)(V263)(V263)(V 263), have the structure | 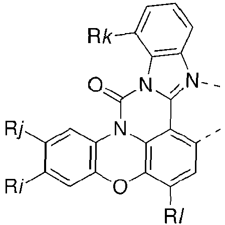 | L_{A}260-(R*i*)(R*j*)(R*k*)(R*l*), wherein L_{A}260-(V1)(V1)(V1)(V1) to L_{A}260-(V263)(V263)(V263)(V 263), have the structure | 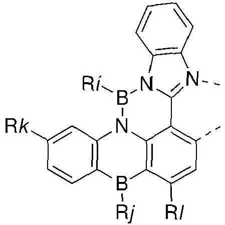 |
| L_{A}261-(R*i*)(R*j*)(R*k*)(R*l*), wherein L_{A}261-(V1)(V1)(V1)(V1) to L_{A}261-(V263)(V263)(V263)(V 263), have the structure | 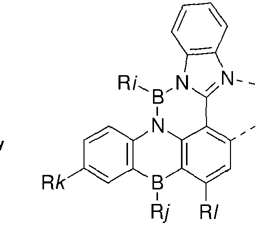 | L_{A}262-(R*i*)(R*j*)(R*k*)(R*l*), wherein L_{A}262-(V1)(V1)(V1)(V1) to L_{A}262-(V263)(V263)(V263)(V 263), have the structure | 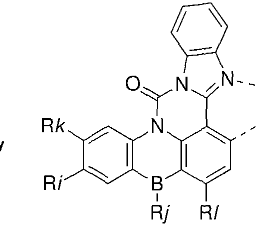 |
| L_{A}263-(R*i*)(R*j*)(R*k*)(R*l*), wherein L_{A}263-(V1)(V1)(V1)(V1) to L_{A}263-(V263)(V263)(V263)(V 263), have the structure | 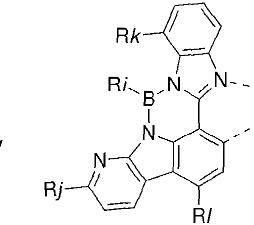 | L_{A}264-(R*j*)(R*k*)(R*l*), wherein L_{A}264-(V1)(V1)(V1) to L_{A}264-(V263)(V263)(V263), have the structure | 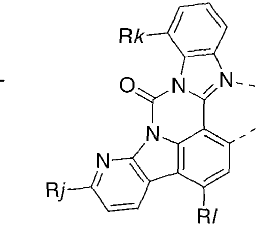 |
| L_{A}265-(R*i*)(R*j*)(R*k*)(R*l*), wherein L_{A}265-(V1)(V1)(V1)(V1) to L_{A}265-(V263)(V263)(V263)(V 263), have the structure | 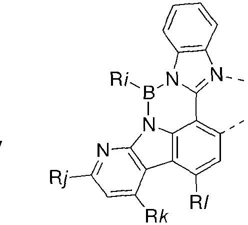 | L_{A}266-(R*j*)(R*k*)(R*l*), wherein L_{A}266-(V1)(V1)(V1) to L_{A}266-(V263)(V263)(V263), have the structure | 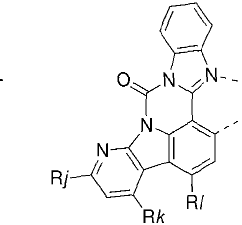 |
| L_{A}267-(R*i*)(R*j*)(R*k*)(R*l*), wherein L_{A}267-(V1)(V1)(V1)(V1) to L_{A}267-(V263)(V263)(V263)(V 263), have the structure | 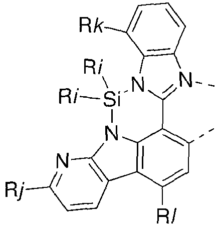 | L_{A}268-(R*i*)(R*j*)(R*k*)(R*l*), wherein L_{A}268-(V1)(V1)(V1)(V1) to L_{A}268-(V263)(V263)(V263)(V 263), have the structure | 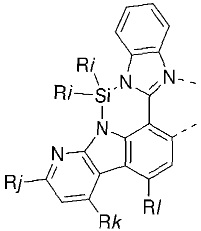 |
| L_{A}269-(R*i*)(R*j*)(R*k*)(R*l*), wherein L_{A}269-(V1)(V1)(V1)(V1) to L_{A}269-(V263)(V263)(V263)(V 263), have the structure | 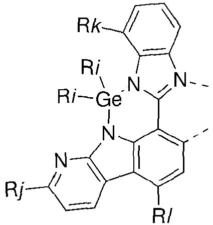 | L_{A}270-(R*i*)(R*j*)(R*k*)(R*l*), wherein L_{A}270-(V1)(V1)(V1)(V1) to L_{A}270-(V263)(V263)(V263)(V 263), have the structure | 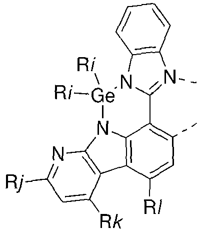 |
| L_{A}271-(R*i*)(R*j*)(R*k*)(R*l*), wherein L_{A}271-(V1)(V1)(V1)(V1) to L_{A}271-(V263)(V263)(V263)(V 263), have the structure | 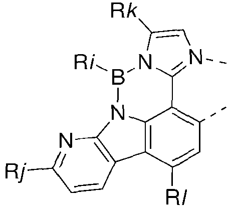 | L_{A}272-(R*i*)(R*j*)(R*k*)(R*l*), wherein L_{A}272-(V1)(V1)(V1)(V1) to L_{A}272-(V263)(V263)(V263)(V 263), have the structure | 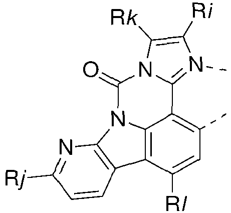 |
| L_{A}273-(R*i*)(R*j*)(R*k*)(R*l*), wherein L_{A}273-(V1)(V1)(V1)(V1) to L_{A}273-(V263)(V263)(V263)(V 263), have the structure | 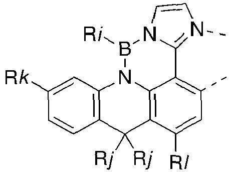 | L_{A}274-(R*i*)(R*j*)(R*k*)(R*l*), wherein L_{A}274-(V1)(V1)(V1)(V1) to L_{A}274-(V263)(V263)(V263)(V 263), have the structure | 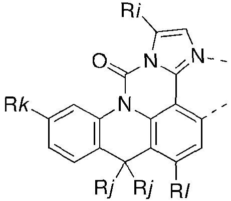 |
| L_{A}275-(R*i*)(R*j*)(R*k*)(R*l*), wherein L_{A}275-(V1)(V1)(V1)(V1) to L_{A}275-(V263)(V263)(V263)(V 263), have the structure | 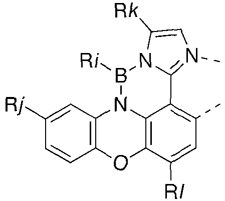 | L_{A}276-(R*i*)(R*j*)(R*k*)(R*l*), wherein L_{A}276-(V1)(V1)(V1)(V1) to L_{A}276-(V263)(V263)(V263)(V 263), have the structure | 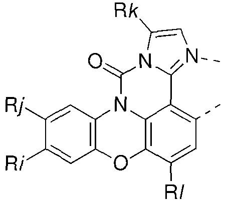 |
| L_{A}277-(R*i*)(R*j*)(R*k*)(R*l*), wherein Lₐ277-(V1)(V1)(V1)(V1) to L_{A}277-(V263)(V263)(V263)(V 263), have the structure | 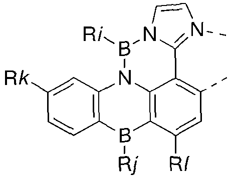 | L_{A}278-(R*i*)(R*j*)(R*k*)(R*l*), wherein L_{A}278-(V1)(V1)(V1)(V1) to L_{A}278-(V263)(V263)(V263)(V 263), have the structure | 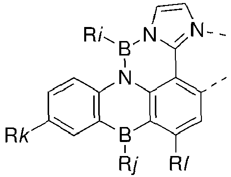 |
| L_{A}279-(R*i*)(R*j*)(R*k*)(R*l*), wherein L_{A}279-(V1)(V1)(V1)(V1) to L_{A}279-(V263)(V263)(V263)(V 263), have the structure | 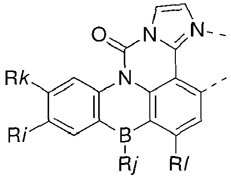 | L_{A}280-(R*i*)(R*j*)(R*k*)(R*l*), wherein L_{A}280-(V1)(V1)(V1)(V1) to L_{A}280-(V263)(V263)(V263)(V 263), have the structure | 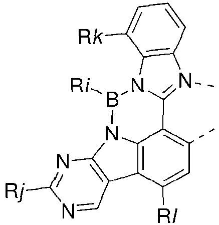 |
| L_{A}281-(R*j*)(R*k*)(R*l*), wherein L_{A}281-(V1)(V1)(V1) to L_{A}281-(V263)(V263)(V263), have the structure | 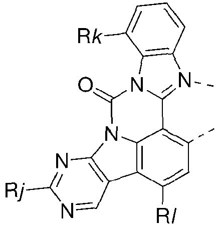 | L_{A}282-(R*i*)(R*j*)(R*k*)(R*l*), wherein L_{A}282-(V1)(V1)(V1)(V1) to L_{A}282-(V263)(V263)(V263)(V 263), have the structure | 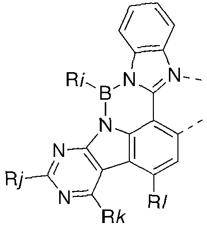 |
| L_{A}283-(R*j*)(R*k*)(R*l*), wherein L_{A}283-(V1)(V1)(V1) to L_{A}283-(V263)(V263)(V263), have the structure | 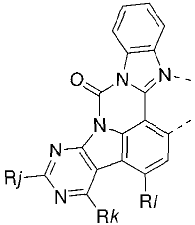 | L_{A}284-(R*i*)(R*j*)(R*k*)(R*l*), wherein L_{A}284-(V1)(V1)(V1)(V1) to L_{A}284-(V263)(V263)(V263)(V 263), have the structure | 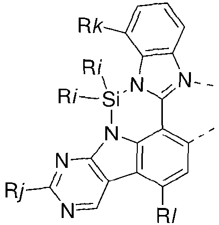 |
| L_{A}285-(R*i*)(R*j*)(R*k*)(R*l*), wherein L_{A}285-(V1)(V1)(V1)(V1) to L_{A}285-(V263)(V263)(V263)(V 263), have the structure | 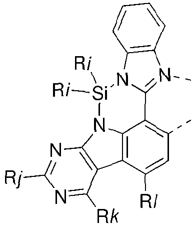 | L_{A}286-(R*i*)(R*j*)(R*k*)(R*l*), wherein L_{A}286-(V1)(V1)(V1)(V1) to L_{A}286-(V263)(V263)(V263)(V 263), have the structure | 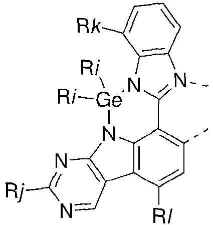 |
| L_{A}287-(R*i*)(R*j*)(R*k*)(R*l*), wherein L_{A}287-(V1)(V1)(V1)(V1) to L_{A}287-(V263)(V263)(V263)(V 263), have the structure | 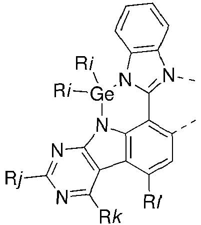 | L_{A}288-(R*i*)(R*j*)(R*k*)(R*l*), wherein L_{A}288-(V1)(V1)(V1)(V1) to L_{A}288-(V263)(V263)(V263)(V 263), have the structure | 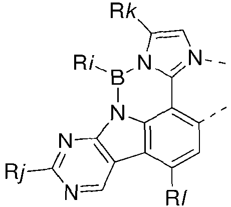 |
| L_{A}289-(R*i*)(R*j*)(R*k*)(R*l*), wherein L_{A}289-(V1)(V1)(V1)(V1) to L_{A}289-(V263)(V263)(V263)(V 263), have the structure | 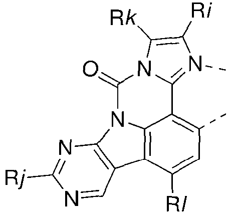 | L_{A}290-(R*i*)(R*j*)(R*k*)(R*l*), wherein L_{A}290-(V1)(V1)(V1)(V1) to L_{A}290-(V263)(V263)(V263)(V 263), have the structure | 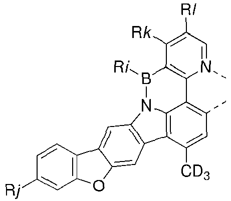 |
| L_{A}291-(R*i*)(R*j*)(R*k*)(R*l*), wherein L_{A}291-(V1)(V1)(V1)(V1) to L_{A}291-(V263)(V263)(V263)(V 263), have the structure | 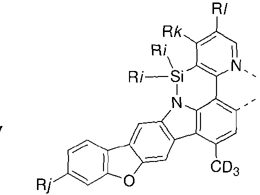 | L_{A}292-(R*i*)(R*j*)(R*k*)(R*l*), wherein L_{A}292-(V1)(V1)(V1)(V1) to L_{A}292-(V263)(V263)(V263)(V 263), have the structure | 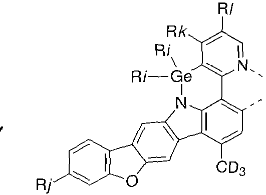 |
| L_{A}293-(R*i*)(R*j*)(R*k*)(R*l*), wherein L_{A}293-(V1)(V1)(V1)(V1) to L_{A}293-(V263)(V263)(V263)(V 263), have the structure | 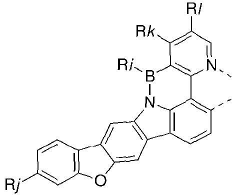 | L_{A}294-(R*i*)(R*j*)(R*k*)(R*l*), wherein L_{A}294-(V1)(V1)(V1)(V1) to L_{A}294-(V263)(V263)(V263)(V 263), have the structure | 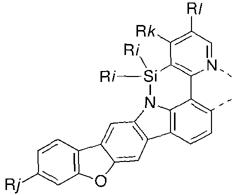 |
| L_{A}295-(R*i*)(R*j*)(R*k*)(R*l*), wherein L_{A}295-(V1)(V1)(V1)(V1) to L_{A}295-(V263)(V263)(V263)(V 263), have the structure | 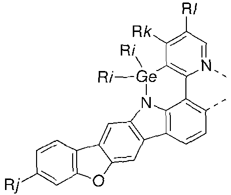 | L_{A}296-(R*i*)(R*j*)(R*k*)(R*l*), wherein L_{A}296-(V1)(V1)(V1)(V1) to L_{A}296-(V263)(V263)(V263)(V 263), have the structure | 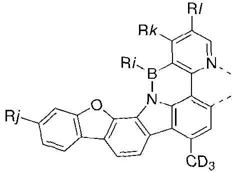 |
| L_{A}297-(R*i*)(R*j*)(R*k*)(R*l*), wherein L_{A}297-(V1)(V1)(V1)(V1) to L_{A}297-(V263)(V263)(V263)(V 263), have the structure | 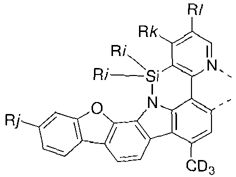 | L_{A}298-(R*i*)(R*j*)(R*k*)(R*l*), wherein L_{A}298-(V1)(V1)(V1)(V1) to L_{A}298-(V263)(V263)(V263)(V 263), have the structure | 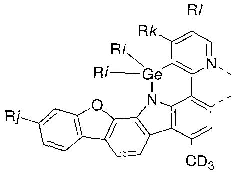 |
| L_{A}299-(R*i*)(R*j*)(R*k*)(R*l*), wherein L_{A}299-(V1)(V1)(V1)(V1) to L_{A}299-(V263)(V263)(V263)(V 263), have the structure | 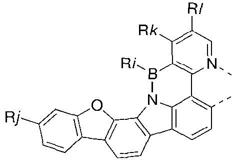 | L_{A}300-(R*i*)(R*j*)(R*k*)(R*l*), wherein L_{A}300-(V1)(V1)(V1)(V1) to L_{A}300-(V263)(V263)(V263)(V 263), have the structure | 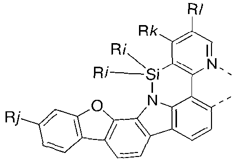 |
| L_{A}301-(R*i*)(R*j*)(R*k*)(R*l*), wherein L_{A}301-(V1)(V1)(V1)(V1) to L_{A}301-(V263)(V263)(V263)(V 263), have the structure | 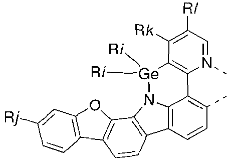 | L_{A}302-(R*i*)(R*j*)(R*k*)(R*l*), wherein L_{A}302-(V1)(V1)(V1)(V1) to L_{A}302-(V263)(V263)(V263)(V 263), have the structure | 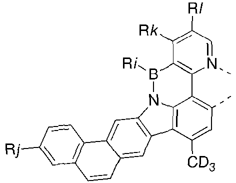 |
| L_{A}303-(R*i*)(R*j*)(R*k*)(R*l*), wherein L_{A}303-(V1)(V1)(V1)(V1) to L_{A}303-(V263)(V263)(V263)(V 263), have the structure | 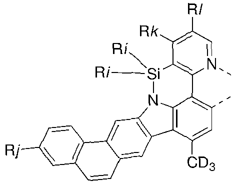 | L_{A}304-(R*i*)(R*j*)(R*k*)(R*l*), wherein L_{A}304-(V1)(V1)(V1)(V1) to L_{A}304-(V263)(V263)(V263)(V 263), have the structure | 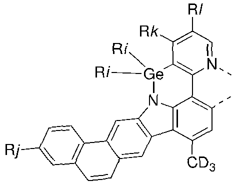 |
| L_{A}305-(R*i*)(R*j*)(R*k*)(R*l*), wherein L_{A}305-(V1)(V1)(V1)(V1) to L_{A}305-(V263)(V263)(V263)(V 263), have the structure | 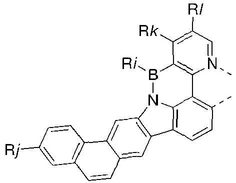 | L_{A}306-(R*i*)(R*j*)(R*k*)(R*l*), wherein L_{A}306-(V1)(V1)(V1)(V1) to L_{A}306-(V263)(V263)(V263)(V 263), have the structure | 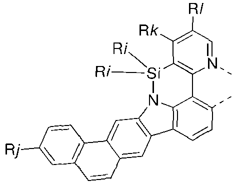 |
| L_{A}307-(R*i*)(R*j*)(R*k*)(R*l*), wherein L_{A}307-(V1)(V1)(V1)(V1) to L_{A}307-(V263)(V263)(V263)(V 263), have the structure | 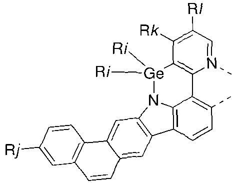 | L_{A}308-(R*i*)(R*j*)(R*k*)(R*l*), wherein L_{A}308-(V1)(V1)(V1)(V1) to L_{A}308-(V263)(V263)(V263)(V 263), have the structure | 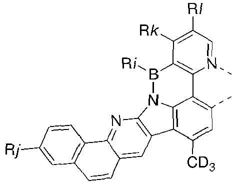 |
| L_{A}309-(R*i*)(R*j*)(R*k*)(R*l*), wherein L_{A}309-(V1)(V1)(V1)(V1) to L_{A}309-(V263)(V263)(V263)(V 263), have the structure | 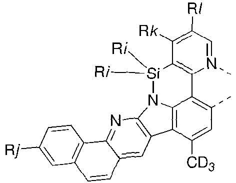 | L_{A}310-(R*i*)(R*j*)(R*k*)(R*l*), wherein L_{A}310-(V1)(V1)(V1)(V1) to L_{A}310-(V263)(V263)(V263)(V 263), have the structure | 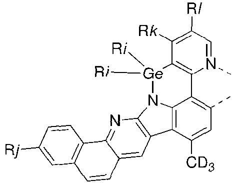 |
| L_{A}311-(R*i*)(R*j*)(R*k*)(R*l*), wherein L_{A}311-(V1)(V1)(V1)(V1) to L_{A}311-(V263)(V263)(V263)(V 263), have the structure | 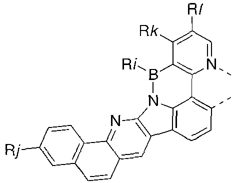 | L_{A}312-(R*i*)(R*j*)(R*k*)(R*l*), wherein L_{A}312-(V1)(V1)(V1)(V1) to L_{A}312-(V263)(V263)(V263)(V 263), have the structure | 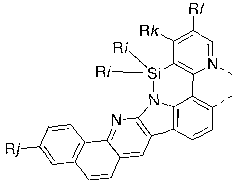 |
| L_{A}313-(R*i*)(R*j*)(R*k*)(R*l*), wherein L_{A}313-(V1)(V1)(V1)(V1) to L_{A}313-(V263)(V263)(V263)(V 263), have the structure | 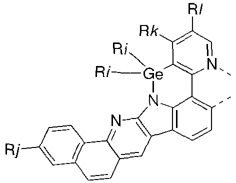 | L_{A}314-(R*i*)(R*j*)(R*k*)(R*l*), wherein L_{A}314-(V1)(V1)(V1)(V1) to L_{A}314-(V263)(V263)(V263)(V 263), have the structure | 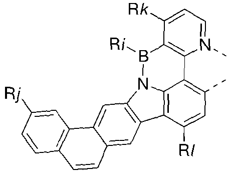 |
| L_{A}315-(R*i*)(R*j*)(R*k*)(R*l*), wherein L_{A}315-(V1)(V1)(V1)(V1) to L_{A}315-(V263)(V263)(V263)(V 263), have the structure | 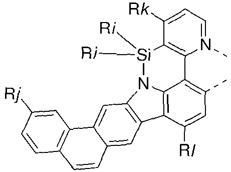 | L_{A}316-(R*i*)(R*j*)(R*k*)(R*l*), wherein L_{A}316-(V1)(V1)(V1)(V1) to L_{A}316-(V263)(V263)(V263)(V 263), have the structure | 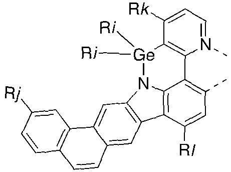 |
| L_{A}317-(R*i*)(R*j*)(R*k*)(R*l*), wherein L_{A}317-(V1)(V1)(V1)(V1) to L_{A}317-(V263)(V263)(V263)(V 263), have the structure | 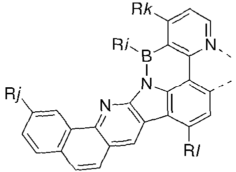 | L_{A}318-(R*i*)(R*j*)(R*k*)(R*l*), wherein L_{A}318-(V1)(V1)(V1)(V1) to L_{A}318-(V263)(V263)(V263)(V 263), have the structure | 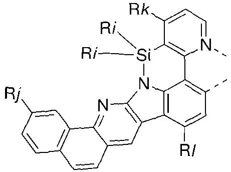 |
| L_{A}319-(R*i*)(R*j*)(R*k*)(R*l*), wherein L_{A}319-(V1)(V1)(V1)(V1) to L_{A}319-(V263)(V263)(V263)(V 263), have the structure | 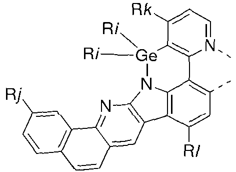 | L_{A}320-(R*i*)(R*j*)(R*k*)(R*l*), wherein L_{A}320-(V1)(V1)(V1)(V1) to L_{A}320-(V263)(V263)(V263)(V 263), have the structure | 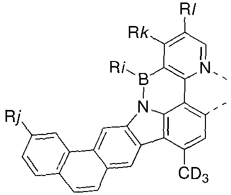 |
| L_{A}321-(R*i*)(R*j*)(R*k*)(R*l*), wherein L_{A}321-(V1)(V1)(V1)(V1) to L_{A}321-(V263)(V263)(V263)(V 263), have the structure | 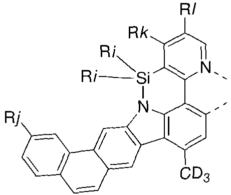 | L_{A}322-(R*i*)(R*j*)(R*k*)(R*l*), wherein L_{A}322-(V1)(V1)(V1)(V1) to L_{A}322-(V263)(V263)(V263)(V 263), have the structure | 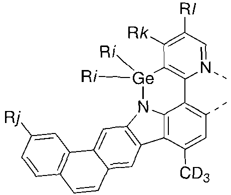 |
| L_{A}323-(R*i*)(R*j*)(R*k*)(R*l*), wherein L_{A}323-(V1)(V1)(V1)(V1) to L_{A}323-(V263)(V263)(V263)(V 263), have the structure | 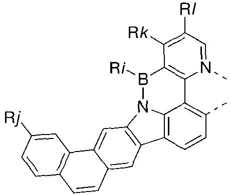 | L_{A}324-(R*i*)(R*j*)(R*k*)(R*l*), wherein L_{A}324-(V1)(V1)(V1)(V1) to L_{A}324-(V263)(V263)(V263)(V 263), have the structure | 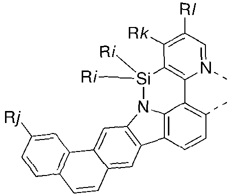 |
| L_{A}325-(R*i*)(R*j*)(R*k*)(R*l*), wherein L_{A}325-(V1)(V1)(V1)(V1) to L_{A}325-(V263)(V263)(V263)(V 263), have the structure | 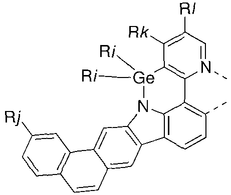 | L_{A}326-(R*i*)(R*j*)(R*k*)(R*l*), wherein L_{A}326-(V1)(V1)(V1)(V1) to L_{A}326-(V263)(V263)(V263)(V 263), have the structure | 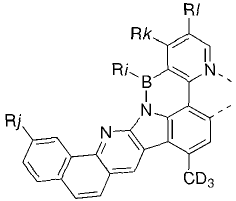 |
| L_{A}327-(R*i*)(R*j*)(R*k*)(R*l*), wherein L_{A}327-(V1)(V1)(V1)(V1) to L_{A}327-(V263)(V263)(V263)(V 263), have the structure | 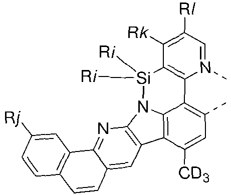 | L_{A}328-(R*i*)(R*j*)(R*k*)(R*l*), wherein L_{A}328-(V1)(V1)(V1)(V1) to L_{A}328-(V263)(V263)(V263)(V 263), have the structure | 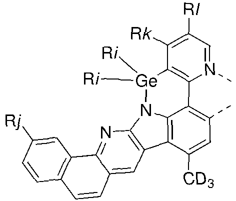 |
| L_{A}329-(R*i*)(R*j*)(R*k*)(R*l*), wherein L_{A}329-(V1)(V1)(V1)(V1) to L_{A}329-(V263)(V263)(V263)(V 263), have the structure | 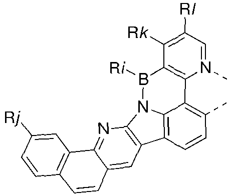 | L_{A}330-(R*i*)(R*j*)(R*k*)(R*l*), wherein L_{A}330-(V1)(V1)(V1)(V1) to L_{A}330-(V263)(V263)(V263)(V 263), have the structure | 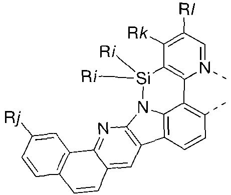 |
| L_{A}331-(R*i*)(R*j*)(R*k*)(R*l*), wherein L_{A}331-(V1)(V1)(V1)(V1) to L_{A}331-(V263)(V263)(V263)(V 263), have the structure | 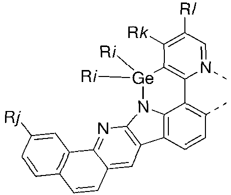 | L_{A}332-(R*i*)(R*j*)(R*k*)(R*l*), wherein L_{A}332-(V1)(V1)(V1)(V1) to L_{A}332-(V263)(V263)(V263)(V 263), have the structure | 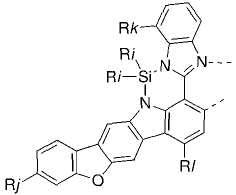 |
| L_{A}333-(R*i*)(R*j*)(R*k*)(R*l*), wherein L_{A}333-(V1)(V1)(V1)(V1) to L_{A}333-(V263)(V263)(V263)(V 263), have the structure | 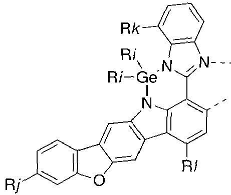 | L_{A}334-(R*i*)(R*j*)(R*k*)(R*l*), wherein L_{A}334-(V1)(V1)(V1)(V1) to L_{A}334-(V263)(V263)(V263)(V 263), have the structure | 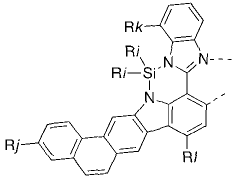 |
| L_{A}335-(R*i*)(R*j*)(R*k*)(R*l*), wherein L_{A}335-(V1)(V1)(V1)(V1) to L_{A}335-(V263)(V263)(V263)(V 263), have the structure | 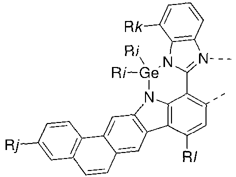 | L_{A}336-(R*i*)(R*j*)(R*k*)(R*l*), wherein L_{A}336-(V1)(V1)(V1)(V1) to L_{A}336-(V263)(V263)(V263)(V 263), have the structure | 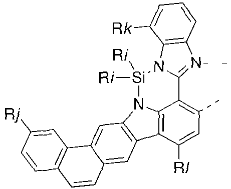 |
| L_{A}337-(R*i*)(R*j*)(R*k*)(R*l*), wherein L_{A}337-(V1)(V1)(V1)(V1) to L_{A}337-(V263)(V263)(V263)(V 263), have the structure | 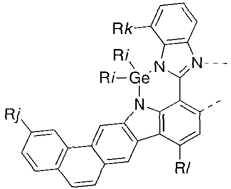 | L_{A}338-(R*i*)(R*j*)(R*k*)(R*l*), wherein L_{A}338-(V1)(V1)(V1)(V1) to L_{A}338-(V263)(V263)(V263)(V 263), have the structure | 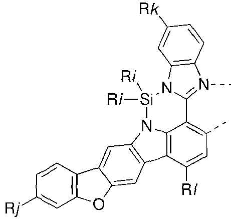 |
| L_{A}339-(R*i*)(R*j*)(R*k*)(R*l*), wherein L_{A}339-(V1)(V1)(V1)(V1) to L_{A}339-(V263)(V263)(V263)(V 263), have the structure | 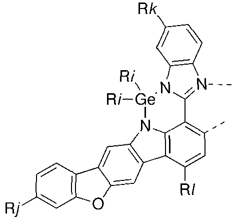 | L_{A}340-(R*i*)(R*j*)(R*k*)(R*l*), wherein L_{A}340-(V1)(V1)(V1)(V1) to L_{A}340-(V263)(V263)(V263)(V 263), have the structure | 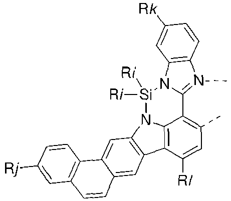 |
| L_{A}341-(R*i*)(R*j*)(R*k*)(R*l*), wherein L_{A}341-(V1)(V1)(V1)(V1) to L_{A}341-(V263)(V263)(V263)(V 263), have the structure | 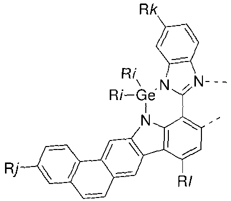 | L_{A}342-(R*i*)(R*j*)(R*k*)(R*l*), wherein L_{A}342-(V1)(V1)(V1)(V1) to L_{A}342-(V263)(V263)(V263)(V 263), have the structure | 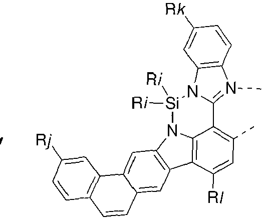 |
| L_{A}343-(R*i*)(R*j*)(R*k*)(R*l*), wherein L_{A}343-(V1)(V1)(V1)(V1) to L_{A}343-(V263)(V263)(V263)(V 263), have the structure | 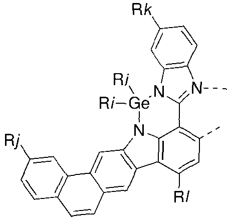 | L_{A}344-(R*i*)(R*j*)(R*k*)(R*l*), wherein L_{A}344-(V1)(V1)(V1)(V1) to L_{A}344-(V263)(V263)(V263)(V 263), have the structure | 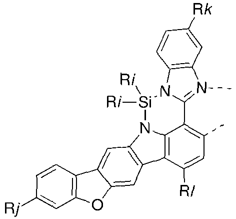 |
| L_{A}345-(R*i*)(R*j*)(R*k*)(R*l*), wherein L_{A}345-(V1)(V1)(V1)(V1) to L_{A}345-(V263)(V263)(V263)(V 263), have the structure | 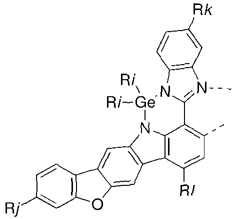 | L_{A}346-(R*i*)(R*j*)(R*k*)(R*l*), wherein L_{A}346-(V1)(V1)(V1)(V1) to L_{A}346-(V263)(V263)(V263)(V 263), have the structure | 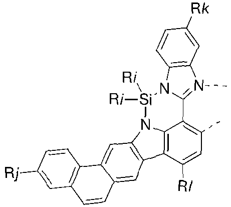 |
| L_{A}347-(R*i*)(R*j*)(R*k*)(R*l*), wherein L_{A}347-(V1)(V1)(V1)(V1) to L_{A}347-(V263)(V263)(V263)(V 263), have the structure | 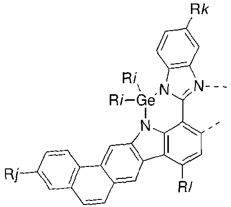 | L_{A}348-(R*i*)(R*j*)(R*k*)(R*l*), wherein L_{A}348-(V1)(V1)(V1)(V1) to L_{A}348-(V263)(V263)(V263)(V 263), have the structure | 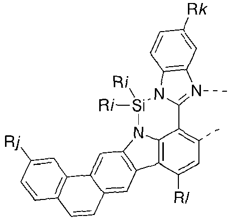 |
| L_{A}349-(R*i*)(R*j*)(R*k*)(R*l*), wherein L_{A}349-(V1)(V1)(V1)(V1) to L_{A}349-(V263)(V263)(V263)(V 263), have the structure | 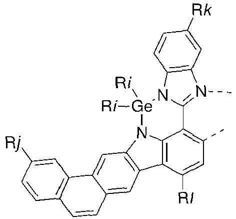 | L_{A}350-(R*i*)(R*j*)(R*k*)(R*l*), wherein L_{A}350-(V1)(V1)(V1)(V1) to L_{A}350-(V263)(V263)(V263)(V 263), have the structure | 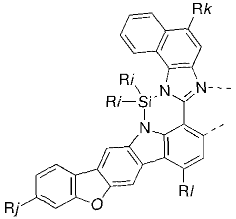 |
| L_{A}351-(R*i*)(R*j*)(R*k*)(R*l*), wherein L_{A}351-(V1)(V1)(V1)(V1) to L_{A}351-(V263)(V263)(V263)(V 263), have the structure | 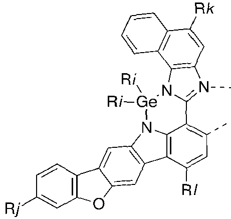 | L_{A}352-(R*i*)(R*j*)(R*k*)(R*l*), wherein L_{A}352-(V1)(V1)(V1)(V1) to L_{A}352-(V263)(V263)(V263)(V 263), have the structure | 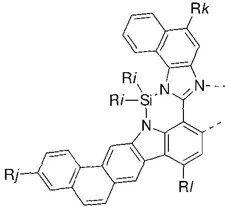 |
| L_{A}353-(R*i*)(R*j*)(R*k*)(R*l*), wherein L_{A}353-(V1)(V1)(V1)(V1) to L_{A}353-(V263)(V263)(V263)(V 263), have the structure | 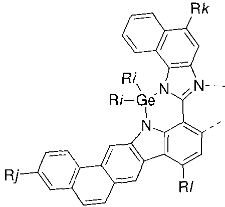 | L_{A}354-(R*i*)(R*j*)(R*k*)(R*l*), wherein L_{A}354-(V1)(V1)(V1)(V1) to L_{A}354-(V263)(V263)(V263)(V 263), have the structure | 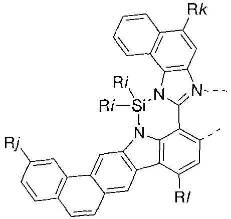 |
| L_{A}355-(R*i*)(R*j*)(R*k*)(R*l*), wherein L_{A}355-(V1)(V1)(V1)(V1) to L_{A}355-(V263)(V263)(V263)(V 263), have the structure | 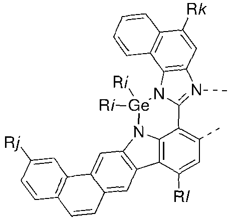 | L_{A}356-(R*i*)(R*j*)(R*k*)(R*l*), wherein L_{A}356-(V1)(V1)(V1)(V1) to L_{A}356-(V263)(V263)(V263)(V 263), have the structure | 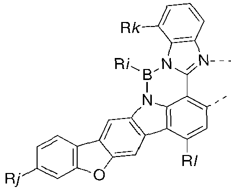 |
| L_{A}357-(R*i*)(R*j*)(R*k*)(R*l*), wherein L_{A}357-(V1)(V1)(V1)(V1) to L_{A}357-(V263)(V263)(V263)(V 263), have the structure | 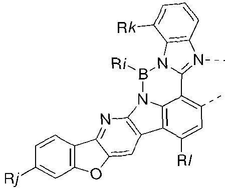 | L_{A}358-(R*i*)(R*j*)(R*k*)(R*l*), wherein L_{A}358-(V1)(V1)(V1)(V1) to L_{A}358-(V263)(V263)(V263)(V 263), have the structure | 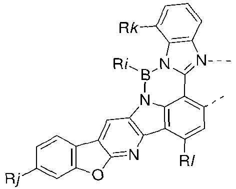 |
| L_{A}359-(R*i*)(R*j*)(R*k*)(R*l*), wherein L_{A}359-(V1)(V1)(V1)(V1) to L_{A}359-(V263)(V263)(V263)(V 263), have the structure | 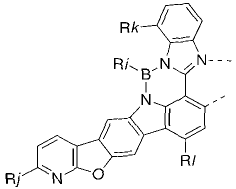 | L_{A}360-(R*i*)(R*j*)(R*k*)(R*l*), wherein L_{A}360-(V1)(V1)(V1)(V1) to L_{A}360-(V263)(V263)(V263)(V 263), have the structure | 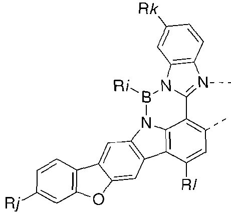 |
| L_{A}361-(R*i*)(R*j*)(R*k*)(R*l*), wherein L_{A}361-(V1)(V1)(V1)(V1) to L_{A}361-(V263)(V263)(V263)(V 263), have the structure | 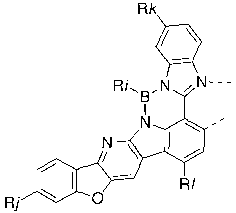 | L_{A}362-(R*i*)(R*j*)(R*k*)(R*l*), wherein L_{A}362-(V1)(V1)(V1)(V1) to L_{A}362-(V263)(V263)(V263)(V 263), have the structure | 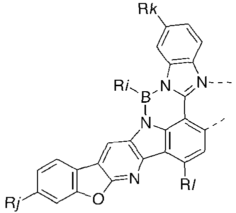 |
| L_{A}363-(R*i*)(R*j*)(R*k*)(R*l*), wherein L_{A}363-(V1)(V1)(V1)(V1) to L_{A}363-(V263)(V263)(V263)(V 263), have the structure | 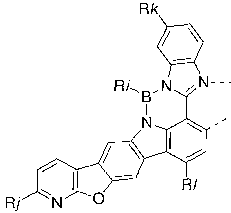 | L_{A}364-(R*i*)(R*j*)(R*k*)(R*l*), wherein L_{A}364-(V1)(V1)(V1)(V1) to L_{A}364-(V263)(V263)(V263)(V 263), have the structure | 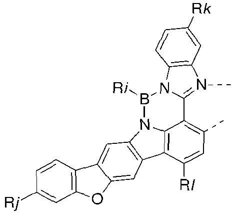 |
| L_{A}365-(R*i*)(R*j*)(R*k*)(R*l*), wherein L_{A}365-(V1)(V1)(V1)(V1) to L_{A}365-(V263)(V263)(V263)(V 263), have the structure | 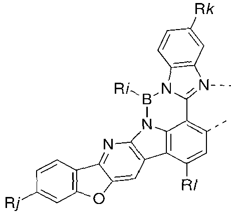 | L_{A}366-(R*i*)(R*j*)(R*k*)(R*l*), wherein L_{A}366-(V1)(V1)(V1)(V1) to L_{A}366-(V263)(V263)(V263)(V 263), have the structure | 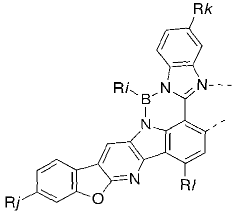 |
| L_{A}367-(R*i*)(R*j*)(R*k*)(R*l*), wherein L_{A}367-(V1)(V1)(V1)(V1) to L_{A}367-(V263)(V263)(V263)(V 263), have the structure | 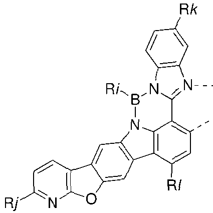 | L_{A}368-(R*i*)(R*j*)(R*k*)(R*l*), wherein L_{A}368-(V1)(V1)(V1)(V1) to L_{A}368-(V263)(V263)(V263)(V 263), have the structure | 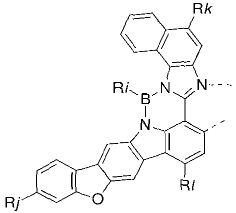 |
| L_{A}369-(R*i*)(R*j*)(R*k*)(R*l*), wherein L_{A}369-(V1)(V1)(V1)(V1) to L_{A}369-(V263)(V263)(V263)(V 263), have the structure | 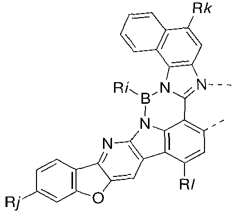 | L_{A}370-(R*i*)(R*j*)(R*k*)(R*l*), wherein L_{A}370-(V1)(V1)(V1)(V1) to L_{A}370-(V263)(V263)(V263)(V 263), have the structure | 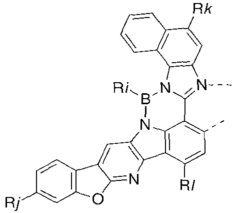 |
| L_{A}371-(R*i*)(R*j*)(R*k*)(R*l*), wherein L_{A}371-(V1)(V1)(V1)(V1) to L_{A}371-(V263)(V263)(V263)(V 263), have the structure | 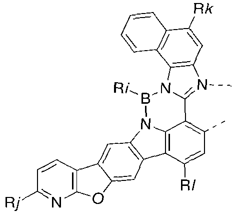 | L_{A}372*-*(R*i*)(R*j*)(R*k*)(R*l*), wherein L_{A}372-(V1)(V1)(V1)(V1) to L_{A}372-(V263)(V263)(V263)(V 263), have the structure | 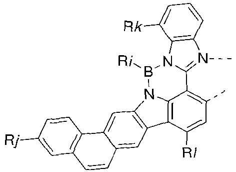 |
| L_{A}373-(R*i*)(R*j*)(R*k*)(R*l*), wherein L_{A}373-(V1)(V1)(V1)(V1) to L_{A}373-(V263)(V263)(V263)(V 263), have the structure | 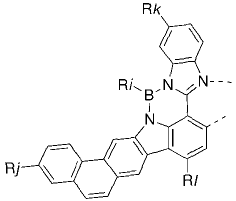 | L_{A}374-(R*i*)(R*j*)(R*k*)(R*l*), wherein L_{A}374-(V1)(V1)(V1)(V1) to L_{A}374-(V263)(V263)(V263)(V 263), have the structure | 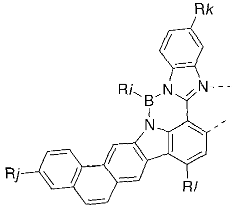 |
| L_{A}375-(R*i*)(R*j*)(R*k*)(R*l*), wherein L_{A}375-(V1)(V1)(V1)(V1) to L_{A}375-(V263)(V263)(V263)(V 263), have the structure | 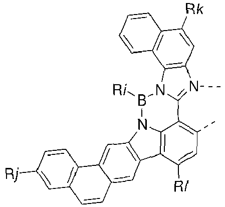 | L_{A}376-(R*i*)(R*j*)(R*k*)(R*l*), wherein L_{A}376-(V1)(V1)(V1)(V1) to L_{A}376-(V263)(V263)(V263)(V 263), have the structure | 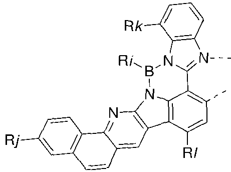 |
| L_{A}377-(R*i*)(R*j*)(R*k*)(R*l*), wherein L_{A}377-(V1)(V1)(V1)(V1) to L_{A}377-(V263)(V263)(V263)(V 263), have the structure | 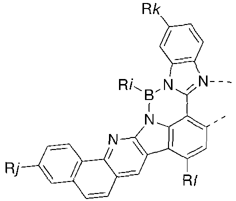 | L_{A}378*-*(R*i*)(R*j*)(R*k*)(R*l*), wherein L_{A}378-(V1)(V1)(V1)(V1) to L_{A}378-(V263)(V263)(V263)(V 263), have the structure | 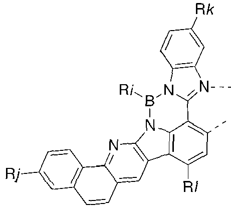 |
| L_{A}379-(R*i*)(R*j*)(R*k*)(R*l*), wherein L_{A}379-(V1)(V1)(V1)(V1) to L_{A}379-(V263)(V263)(V263)(V 263), have the structure | 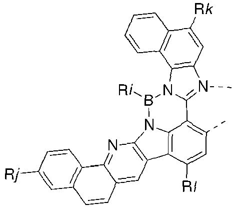 | L_{A}380-(R*i*)(R*j*)(R*k*)(R*l*), wherein L_{A}380-(V1)(V1)(V1)(V1) to L_{A}380-(V263)(V263)(V263)(V 263), have the structure | 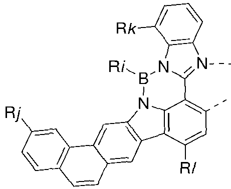 |
| L_{A}381-(R*i*)(R*j*)(R*k*)(R*l*), wherein L_{A}381-(V1)(V1)(V1)(V1) to L_{A}381-(V263)(V263)(V263)(V 263), have the structure | 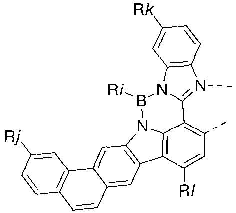 | L_{A}382-(R*i*)(R*j*)(R*k*)(R*l*), wherein L_{A}382-(V1)(V1)(V1)(V1) to L_{A}382-(V263)(V263)(V263)(V 263), have the structure | 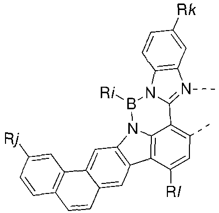 |
| L_{A}383-(R*i*)(R*j*)(R*k*)(R*l*), wherein L_{A}383-(V1)(V1)(V1)(V1) to L_{A}383-(V263)(V263)(V263)(V 263), have the structure | 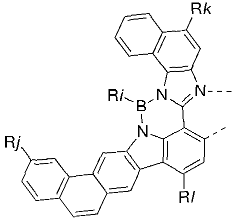 | L_{A}384-(R*i*)(R*j*)(R*k*)(R*l*), wherein L_{A}384-(V1)(V1)(V1)(V1) to L_{A}384-(V263)(V263)(V263)(V 263), have the structure | 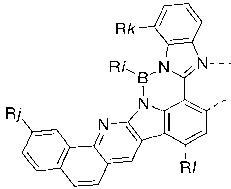 |
| L_{A}385-(R*i*)(R*j*)(R*k*)(R*l*), wherein L_{A}385-(V1)(V1)(V1)(V1) to L_{A}385-(V263)(V263)(V263)(V 263), have the structure | 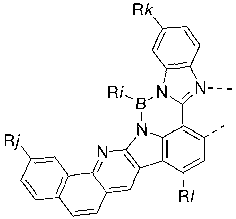 | L_{A}386-(R*i*)(R*j*)(R*k*)(R*l*), wherein L_{A}386-(V1)(V1)(V1)(V1) to L_{A}386-(V263)(V263)(V263)(V 263), have the structure | 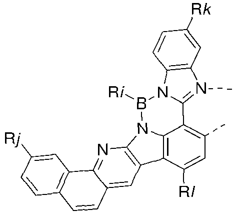 |
| L_{A}387-(R*i*)(R*j*)(R*k*)(R*l*), wherein L_{A}387-(V1)(V1)(V1)(V1) to L_{A}387-(V263)(V263)(V263)(V 263), have the structure | 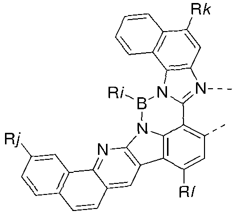 | L_{A}388-(R*i*)(R*j*)(R*k*)(R*l*), wherein L_{A}388-(V1)(V1)(V1)(V1) to L_{A}388-(V263)(V263)(V263)(V 263), have the structure | 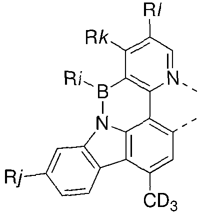 |
| L_{A}389-(R*i*)(R*j*)(R*k*)(R*l*), wherein L_{A}389-(V1)(V1)(V1)(V1) to L_{A}389-(V263)(V263)(V263)(V 263), have the structure | 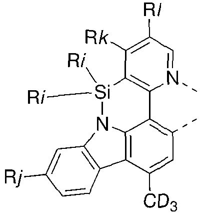 | L_{A}390-(R*i*)(R*j*)(R*k*)(R*l*), wherein L_{A}390-(V1)(V1)(V1)(V1) to L_{A}390-(V263)(V263)(V263)(V 263), have the structure | 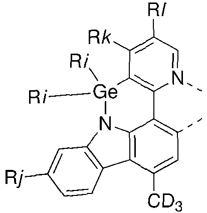 |
| L_{A}391-(R*i*)(R*j*)(R*k*)(R*l*), wherein L_{A}391-(V1)(V1)(V1)(V1) to L_{A}391-(V263)(V263)(V263)(V 263), have the structure | 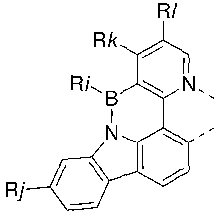 | L_{A}392-(R*i*)(R*j*)(R*k*)(R*l*), wherein L_{A}392-(V1)(V1)(V1)(V1) to L_{A}392-(V263)(V263)(V263)(V 263), have the structure | 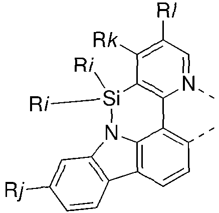 |
| L_{A}393-(R*i*)(R*j*)(R*k*)(R*l*), wherein L_{A}393-(V1)(V1)(V1)(V1) to L_{A}393-(V263)(V263)(V263)(V 263), have the structure | 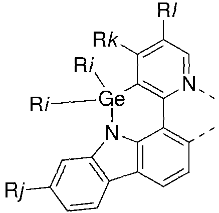 | L_{A}394-(R*i*)(R*j*)(R*k*)(R*l*), wherein L_{A}394-(V1)(V1)(V1)(V1) to L_{A}394-(V263)(V263)(V263)(V 263), have the structure | 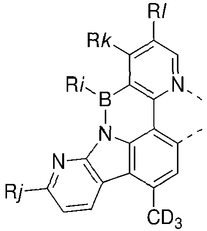 |
| L_{A}395-(R*i*)(R*j*)(R*k*)(R*l*), wherein L_{A}395-(V1)(V1)(V1)(V1) to L_{A}395-(V263)(V263)(V263)(V 263), have the structure | 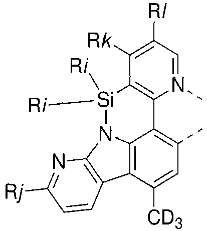 | L_{A}396-(R*i*)(R*j*)(R*k*)(R*l*), wherein L_{A}396-(V1)(V1)(V1)(V1) to L_{A}396-(V263)(V263)(V263)(V 263), have the structure | 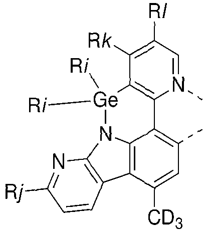 |
| L_{A}397-(R*i*)(R*j*)(R*k*)(R*l*), wherein L_{A}397-(V1)(V1)(V1)(V1) to L_{A}397-(V263)(V263)(V263)(V 263), have the structure | 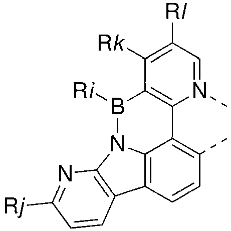 | L_{A}398-(R*i*)(R*j*)(R*k*)(R*l*), wherein L_{A}398-(V1)(V1)(V1)(V1) to L_{A}398-(V263)(V263)(V263)(V 263), have the structure | 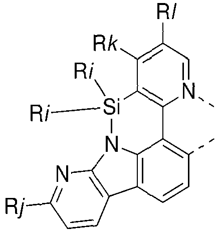 |
| L_{A}399-(R*i*)(R*j*)(R*k*)(R*l*), wherein L_{A}399-(V1)(V1)(V1)(V1) to L_{A}399-(V263)(V263)(V263)(V 263), have the structure | 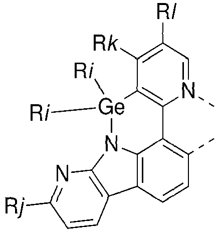 | L_{A}400-(R*i*)(R*j*)(R*k*)(R*l*), wherein L_{A}400-(V1)(V1)(V1)(V1) to L_{A}400-(V263)(V263)(V263)(V 263), have the structure | 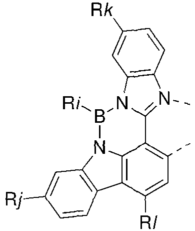 |
| L_{A}401-(R*i*)(R*j*)(R*k*)(R*l*), wherein L_{A}401-(V1)(V1)(V1)(V1) to L_{A}401-(V263)(V263)(V263)(V 263), have the structure | 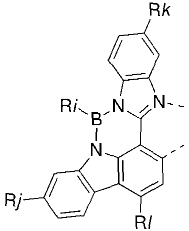 | L_{A}402-(R*i*)(R*j*)(R*k*)(R*l*), wherein L_{A}402-(V1)(V1)(V1)(V1) to L_{A}402-(V263)(V263)(V263)(V 263), have the structure | 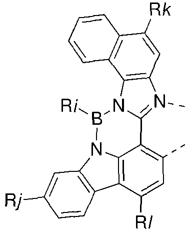 |
| L_{A}403-(R*i*)(R*j*)(R*k*)(R*l*), wherein L_{A}403-(V1)(V1)(V1)(V1) to L_{A}403-(V263)(V263)(V263)(V 263), have the structure | 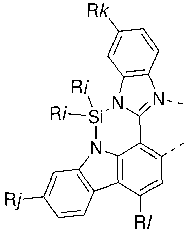 | L_{A}404-(R*i*)(R*j*)(R*k*)(R*l*), wherein L_{A}404-(V1)(V1)(V1)(V1) to L_{A}404-(V263)(V263)(V263)(V 263), have the structure | 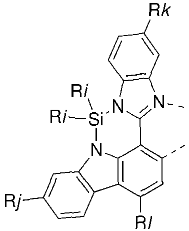 |
| L_{A}405-(R*i*)(R*j*)(R*k*)(R*l*), wherein L_{A}405-(V1)(V1)(V1)(V1) to L_{A}405-(V263)(V263)(V263)(V 263), have the structure | 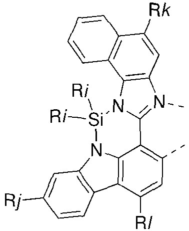 | L_{A}406-(R*i*)(R*j*)(R*k*)(R*l*), wherein L_{A}406-(V1)(V1)(V1)(V1) to L_{A}406-(V263)(V263)(V263)(V 263), have the structure | 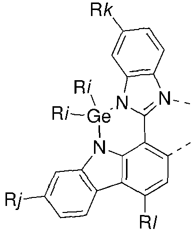 |
| L_{A}407-(R*i*)(R*j*)(R*k*)(R*l*), wherein L_{A}407-(V1)(V1)(V1)(V1) to L_{A}407-(V263)(V263)(V263)(V 263), have the structure | 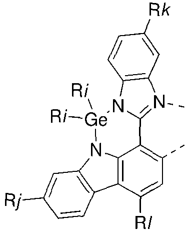 | L_{A}408-(R*i*)(R*j*)(R*k*)(R*l*), wherein L_{A}408-(V1)(V1)(V1)(V1) to L_{A}408-(V263)(V263)(V263)(V 263), have the structure | 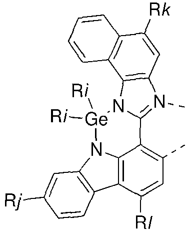 |
| L_{A}409-(R*i*)(R*j*)(R*k*)(R*l*), wherein L_{A}409-(V1)(V1)(V1)(V1) to L_{A}409-(V263)(V263)(V263)(V 263), have the structure | 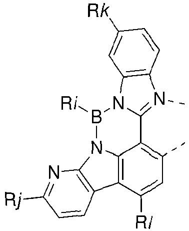 | L_{A}410*-*(R*i*)(R*j*)(R*k*)(R*l*), wherein L_{A}410-(V1)(V1)(V1)(V1) to L_{A}410-(V263)(V263)(V263)(V 263), have the structure | 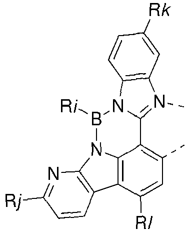 |
| L_{A}411-(R*i*)(R*j*)(R*k*)(R*l*), wherein L_{A}411-(V1)(V1)(V1)(V1) to L_{A}411-(V263)(V263)(V263)(V 263), have the structure | 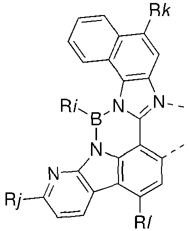 | L_{A}412-(R*i*)(R*j*)(R*k*)(R*l*), wherein L_{A}412-(V1)(V1)(V1)(V1) to L_{A}412-(V263)(V263)(V263)(V 263), have the structure | 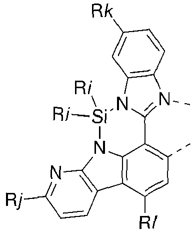 |
| L_{A}413-(R*i*)(R*j*)(R*k*)(R*l*), wherein L_{A}413-(V1)(V1)(V1)(V1) to L_{A}413-(V263)(V263)(V263)(V 263), have the structure | 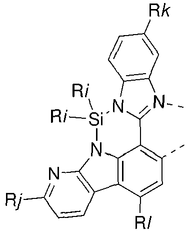 | L_{A}414-(R*i*)(R*j*)(R*k*)(R*l*), wherein L_{A}414-(V1)(V1)(V1)(V1) to L_{A}414-(V263)(V263)(V263)(V 263), have the structure | 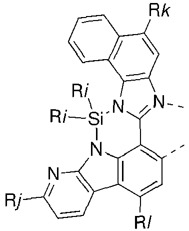 |
| L_{A}415-(R*i*)(R*j*)(R*k*)(R*l*), wherein L_{A}415-(V1)(V1)(V1)(V1) to L_{A}415-(V263)(V263)(V263)(V 263), have the structure | 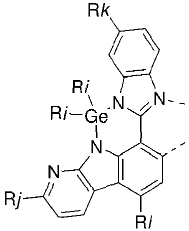 | L_{A}416-(R*i*)(R*j*)(R*k*)(R*l*), wherein L_{A}416-(V1)(V1)(V1)(V1) to L_{A4}16-(V263)(V263)(V263)(V 263), have the structure | 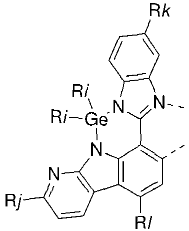 |
| L_{A}417-(R*i*)(R*j*)(R*k*)(R*l*), wherein L_{A}417-(V1)(V1)(V1)(V1) to L_{A}417-(V263)(V263)(V263)(V 263), have the structure | 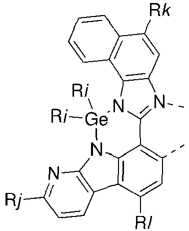 | L_{A}418-(R*i*)(R*j*)(R*k*)(R*l*), wherein L_{A}418-(V1)(V1)(V1)(V1) to L_{A}418-(V263)(V263)(V263)(V 263), have the structure | 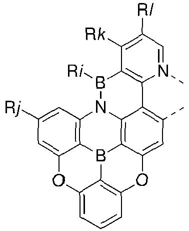 |
| L_{A}419-(R*i*)(R*j*)(R*k*)(R*l*), wherein L_{A}419-(V1)(V1)(V1)(V1) to L_{A}419-(V263)(V263)(V263)(V 263), have the structure | 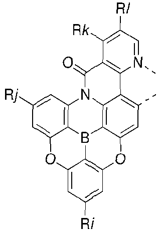 | L_{A}420-(R*i*)(R*j*)(R*k*)(R*l*), wherein L_{A}420-(V1)(V1)(V1)(V1) to L_{A}420-(V263)(V263)(V263)(V 263), have the structure | 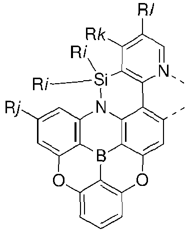 |
| L_{A}421-(R*i*)(R*j*)(R*k*)(R*l*), wherein L_{A}421-(V1)(V1)(V1)(V1) to L_{A}421-(V263)(V263)(V263)(V 263), have the structure | 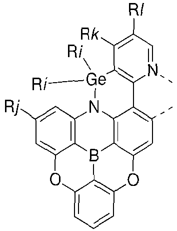 | L_{A}422-(R*i*)(R*j*)(R*k*)(R*l*), wherein L_{A}422-(V1)(V1)(V1)(V1) to L_{A}422-(V263)(V263)(V263)(V 263), have the structure | 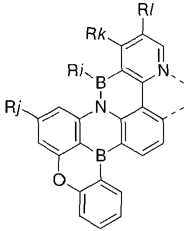 |
| L_{A}423-(R*i*)(R*j*)(R*k*)(R*l*), wherein L_{A}423-(V1)(V1)(V1)(V1) to L_{A}423-(V263)(V263)(V263)(V 263), have the structure | 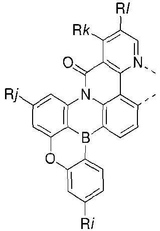 | L_{A}424-(R*i*)(R*j*)(R*k*)(R*l*), wherein L_{A}424-(V1)(V1)(V1)(V1) to L_{A}424-(V263)(V263)(V263)(V 263), have the structure | 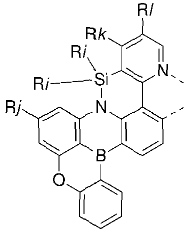 |
| L_{A}425-(R*i*)(R*j*)(R*k*)(R*l*), wherein L_{A}425-(V1)(V1)(V1)(V1) to L_{A}425-(V263)(V263)(V263)(V 263), have the structure | 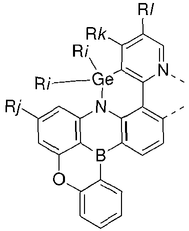 | L_{A}426-(R*i*)(R*j*)(R*k*)(R*l*), wherein L_{A}426-(V1)(V1)(V1)(V1) to L_{A}426-(V263)(V263)(V263)(V 263), have the structure | 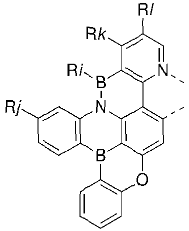 |
| L_{A}427-(R*i*)(R*j*)(R*k*)(R*l*), wherein L_{A}427-(V1)(V1)(V1)(V1) to L_{A}427-(V263)(V263)(V263)(V 263), have the structure | 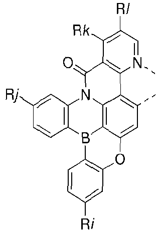 | L_{A}428-(R*i*)(R*j*)(R*k*)(R*l*), wherein L_{A}428-(V1)(V1)(V1)(V1) to L_{A}428-(V263)(V263)(V263)(V 263), have the structure | 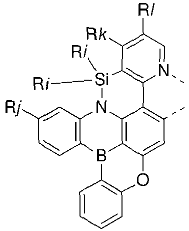 |
| L_{A}429-(R*i*)(R*j*)(R*k*)(R*l*), wherein L_{A}429-(V1)(V1)(V1)(V1) to L_{A}429-(V263)(V263)(V263)(V 263), have the structure | 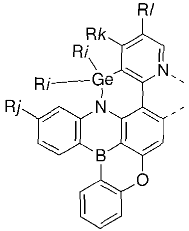 | L_{A}430-(R*i*)(R*j*)(R*k*)(R*l*), wherein L_{A}430-(V1)(V1)(V1)(V1) to L_{A}430-(V263)(V263)(V263)(V 263), have the structure | 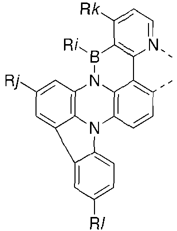 |
| L_{A}431-(R*i*)(R*j*)(R*k*)(R*l*), wherein L_{A}431-(V1)(V1)(V1)(V1) to L_{A}431-(V263)(V263)(V263)(V 263), have the structure | 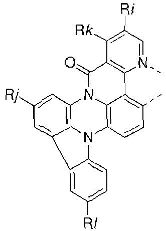 | L_{A}432-(R*i*)(R*j*)(R*k*)(R*l*), wherein L_{A}432-(V1)(V1)(V1)(V1) to L_{A}432-(V263)(V263)(V263)(V 263), have the structure | 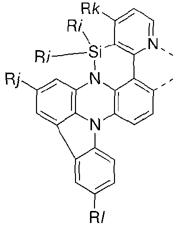 |
| L_{A}433-(R*i*)(R*j*)(R*k*)(R*l*), wherein L_{A}433-(V1)(V1)(V1)(V1) to L_{A}433-(V263)(V263)(V263)(V 263), have the structure | 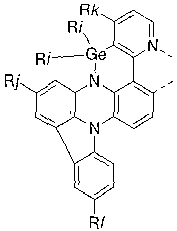 | L_{A}434-(R*i*)(R*j*)(R*k*)(R*l*), wherein L_{A}434-(V1)(V1)(V1)(V1) to L_{A}434-(V263)(V263)(V263)(V 263), have the structure | 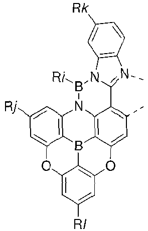 |
| L_{A}435-(R*i*)(R*j*)(R*k*)(R*l*), wherein L_{A}435-(V1)(V1)(V1)(V1) to L_{A}435-(V263)(V263)(V263)(V 263), have the structure | 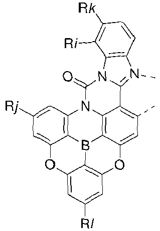 | L_{A}436-(R*i*)(R*j*)(R*k*)(R*l*), wherein L_{A}436-(V1)(V1)(V1)(V1) to L_{A}436-(V263)(V263)(V263)(V 263), have the structure | 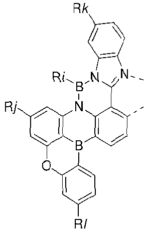 |
| L_{A}437-(R*i*)(R*j*)(R*k*)(R*l*), wherein L_{A}437-(V1)(V1)(V1)(V1) to L_{A}437-(V263)(V263)(V263)(V 263), have the structure | 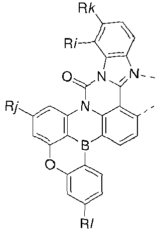 | L_{A}438-(R*i*)(R*j*)(R*k*)(R*l*), wherein L_{A}438-(V1)(V1)(V1)(V1) to L_{A}438-(V263)(V263)(V263)(V 263), have the structure | 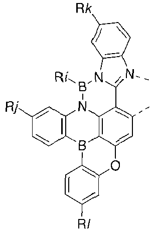 |
| L_{A}439-(R*i*)(R*j*)(R*k*)(R*l*), wherein L_{A}439-(V1)(V1)(V1)(V1) to L_{A}439-(V263)(V263)(V263)(V 263), have the structure | 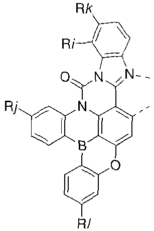 | L_{A}440-(R*i*)(R*j*)(R*k*)(R*l*), wherein L_{A}440-(V1)(V1)(V1)(V1) to L_{A}440-(V263)(V263)(V263)(V 263), have the structure | 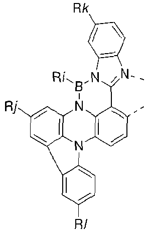 |
| L_{A}441-(R*i*)(R*j*)(R*k*)(R*l*), wherein L_{A}441-(V1)(V1)(V1)(V1) to L_{A}441-(V263)(V263)(V263)(V 263), have the structure | 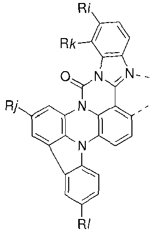 | L_{A}442-(R*i*)(R*j*)(R*k*)(R*l*), wherein L_{A}442-(V1)(V1)(V1)(V1) to L_{A}442-(V263)(V263)(V263)(V 263), have the structure | 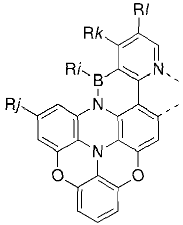 |
| L_{A}443-(R*i*)(R*j*)(R*k*)(R*l*), wherein L_{A}443-(V1)(V1)(V1)(V1) to L_{A}443-(V263)(V263)(V263)(V 263), have the structure | 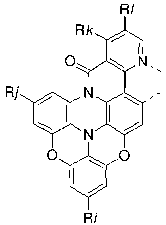 | L_{A}444-(R*i*)(R*j*)(R*k*)(R*l*), wherein L_{A}444-(V1)(V1)(V1)(V1) to L_{A}444-(V263)(V263)(V263)(V 263), have the structure | 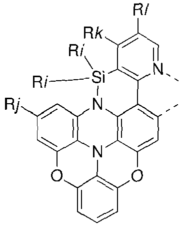 |
| L_{A}445-(R*i*)(R*j*)(R*k*)(R*l*), wherein L_{A}445-(V1)(V1)(V1)(V1) to L_{A}445-(V263)(V263)(V263)(V 263), have the structure | 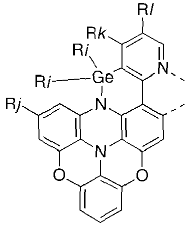 | L_{A}446-(R*i*)(R*j*)(R*k*)(R*l*), wherein L_{A}446-(V1)(V1)(V1)(V1) to L_{A}446-(V263)(V263)(V263)(V 263), have the structure | 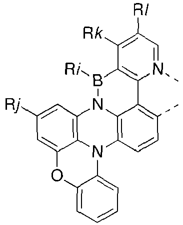 |
| L_{A}447*-*(R*i*)(R*j*)(R*k*)(R*l*), wherein L_{A}447-(V1)(V1)(V1)(V1) to L_{A}447-(V263)(V263)(V263)(V 263), have the structure | 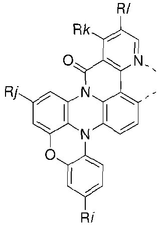 | L_{A}448-(R*i*)(R*j*)(R*k*)(R*l*), wherein L_{A}448-(V1)(V1)(V1)(V1) to L_{A}448-(V263)(V263)(V263)(V 263), have the structure | 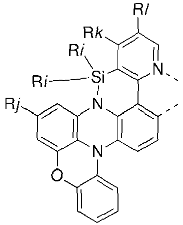 |
| L_{A}449-(R*i*)(R*j*)(R*k*)(R*l*), wherein L_{A}449-(V1)(V1)(V1)(V1) to L_{A}449-(V263)(V263)(V263)(V 263), have the structure | 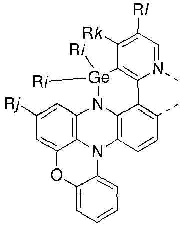 | L_{A}450-(R*i*)(R*j*)(R*k*)(R*l*), wherein L_{A}450-(V1)(V1)(V1)(V1) to L_{A}450-(V263)(V263)(V263)(V 263), have the structure | 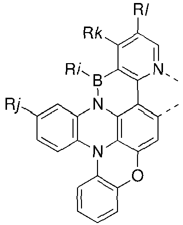 |
| L_{A}451-(R*i*)(R*j*)(R*k*)(R*l*), wherein L_{A}451-(V1)(V1)(V1)(V1) to L_{A}451-(V263)(V263)(V263)(V 263), have the structure | 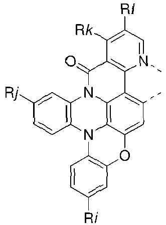 | L_{A}452-(R*i*)(R*j*)(R*k*)(R*l*), wherein L_{A}452-(V1)(V1)(V1)(V1) to L_{A}452-(V263)(V263)(V263)(V 263), have the structure | 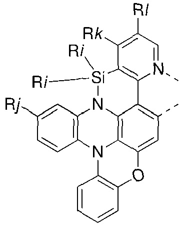 |
| L_{A}453-(R*i*)(R*j*)(R*k*)(R*l*), wherein L_{A}453-(V1)(V1)(V1)(V1) to L_{A}453-(V263)(V263)(V263)(V 263), have the structure | 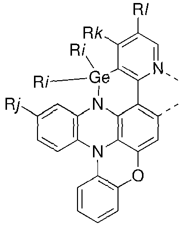 | L_{A}454-(R*i*)(R*j*)(R*k*)(R*l*), wherein L_{A}454-(V1)(V1)(V1)(V1) to L_{A}454-(V263)(V263)(V263)(V 263), have the structure | 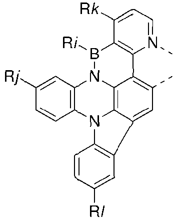 |
| L_{A}455-(R*i*)(R*j*)(R*k*)(R*l*), wherein L_{A}455-(V1)(V1)(V1)(V1) to L_{A}455-(V263)(V263)(V263)(V 263), have the structure | 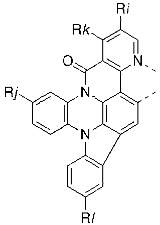 | L_{A}456-(R*i*)(R*j*)(R*k*)(R*l*), wherein L_{A}456-(V1)(V1)(V1)(V1) to L_{A}456-(V263)(V263)(V263)(V 263), have the structure | 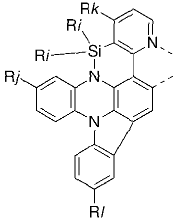 |
| L_{A}457-(R*i*)(R*j*)(R*k*)(R*l*), wherein L_{A}457-(V1)(V1)(V1)(V1) to L_{A}457-(V263)(V263)(V263)(V 263), have the structure | 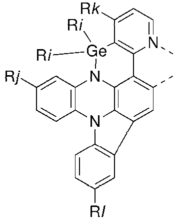 | L_{A}458-(R*i*)(R*j*)(R*k*)(R*l*), wherein L_{A}458-(V1)(V1)(V1)(V1) to L_{A}458-(V263)(V263)(V263)(V 263), have the structure | 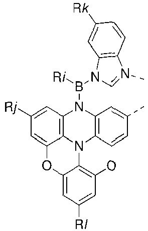 |
| L_{A}459-(R*i*)(R*j*)(R*k*)(R*l*), wherein L_{A}459-(V1)(V1)(V1)(V1) to L_{A}459-(V263)(V263)(V263)(V 263), have the structure | 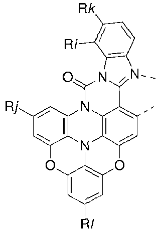 | L_{A}460-(R*i*)(R*j*)(R*k*)(R*l*), wherein L_{A}460-(V1)(V1)(V1)(V1) to L_{A}460-(V263)(V263)(V263)(V 263), have the structure | 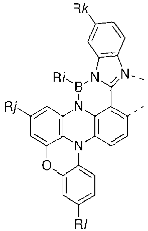 |
| L_{A}461-(R*i*)(R*j*)(R*k*)(R*l*), wherein L_{A}461-(V1)(V1)(V1)(V1) to L_{A}461-(V263)(V263)(V263)(V 263), have the structure | 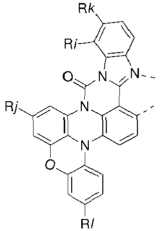 | L_{A}462-(R*i*)(R*j*)(R*k*)(R*l*), wherein L_{A}462-(V1)(V1)(V1)(V1) to L_{A}462-(V263)(V263)(V263)(V 263), have the structure | 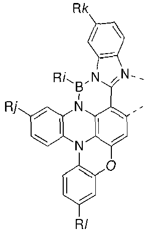 |
| L_{A}463-(R*i*)(R*j*)(R*k*)(R*l*), wherein L_{A}463-(V1)(V1)(V1)(V1) to L_{A}463-(V263)(V263)(V263)(V 263), have the structure | 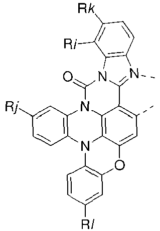 | L_{A}464-(R*i*)(R*j*)(R*k*)(R*l*), wherein L_{A}464-(V1)(V1)(V1)(V1) to L_{A}464-(V263)(V263)(V263)(V 263), have the structure | 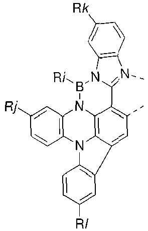 |
| L_{A}465-(R*i*)(R*j*)(R*k*)(R*l*), wherein L_{A}465-(V1)(V1)(V1)(V1) to L_{A}465-(V263)(V263)(V263)(V 263), have the structure | 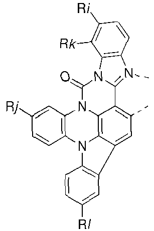 | L_{A}(R*i*)(R*j*)(R*k*)(R*l*), wherein L_{A}466-(V1)(V1)(V1)(V1) to L_{A}466-(V263)(V263)(V263)(V 263), have the structure | 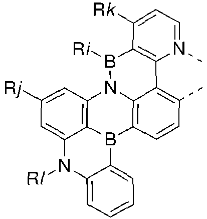 |
| L_{A}467-(R*i*)(R*j*)(R*k*)(R*l*), wherein L_{A}467-(V1)(V1)(V1)(V1) to L_{A}467-(V263)(V263)(V263)(V 263), have the structure | 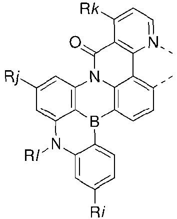 | L_{A}468-(R*i*)(R*j*)(R*k*)(R*l*), wherein L_{A}468-(V1)(V1)(V1)(V1) to L_{A}468-(V263)(V263)(V263)(V 263), have the structure | 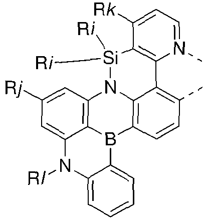 |
| L_{A}469-(R*i*)(R*j*)(R*k*)(R*l*), wherein L_{A}469-(V1)(V1)(V1)(V1) to L_{A}469-(V263)(V263)(V263)(V 263), have the structure | 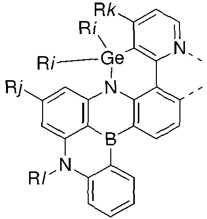 | L_{A}470-(R*i*)(R*j*)(R*k*)(R*l*), wherein L_{A}470-(V1)(V1)(V1)(V1) to L_{A}470-(V263)(V263)(V263)(V 263), have the structure | 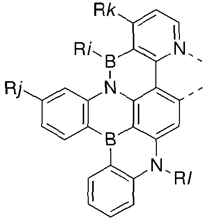 |
| L_{A}471-(R*i*)(R*j*)(R*k*)(R*l*), wherein L_{A}471-(V1)(V1)(V1)(V1) to L_{A}471-(V263)(V263)(V263)(V 263), have the structure | 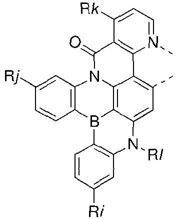 | L_{A}472-(R*i*)(R*j*)(R*k*)(R*l*), wherein L_{A}472-(V1)(V1)(V1)(V1) to L_{A}472-(V263)(V263)(V263)(V 263), have the structure | 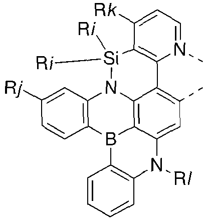 |
| L_{A}473-(R*i*)(R*j*)(R*k*)(R*l*), wherein L_{A}473-(V1)(V1)(V1)(V1) to L_{A}473-(V263)(V263)(V263)(V 263), have the structure | 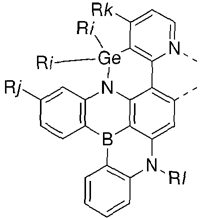 | L_{A}474-(R*i*)(R*j*)(R*k*)(R*l*), wherein L_{A}474-(V1)(V1)(V1)(V1) to L_{A}474-(V263)(V263)(V263)(V 263), have the structure | 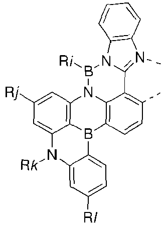 |
| L_{A}475-(R*i*)(R*j*)(R*k*)(R*l*), wherein L_{A}475-(V1)(V1)(V1)(V1) to L_{A}475-(V263)(V263)(V263)(V 263), have the structure | 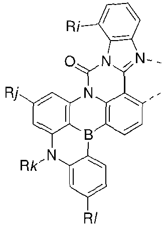 | L_{A}476-(R*i*)(R*j*)(R*k*)(R*l*), wherein L_{A}476-(V1)(V1)(V1)(V1) to L_{A}476-(V263)(V263)(V263)(V 263), have the structure | 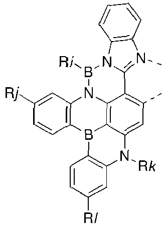 |
| L_{A}477-(R*i*)(R*j*)(R*k*)(R*l*), wherein L_{A}477-(V1)(V1)(V1)(V1) to L_{A}477-(V263)(V263)(V263)(V 263), have the structure | 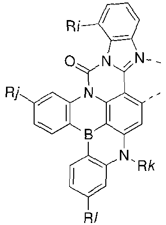 | L_{A}478-(R*i*)(R*j*)(R*k*)(R*l*), wherein L_{A}478-(V1)(V1)(V1)(V1) to L_{A}478-(V263)(V263)(V263)(V 263), have the structure | 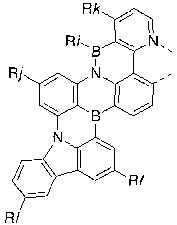 |
| L_{A}479-(R*i*)(R*j*)(R*k*)(R*l*), wherein L_{A}479-(V1)(V1)(V1)(V1) to L_{A}479-(V263)(V263)(V263)(V 263), have the structure | 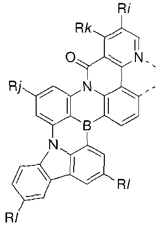 | L_{A}480-(R*i*)(R*j*)(R*k*)(R*l*), wherein L_{A}480-(V1)(V1)(V1)(V1) to L_{A}480-(V263)(V263)(V263)(V 263), have the structure | 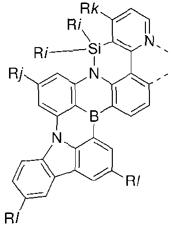 |
| L_{A}481-(R*i*)(R*j*)(R*k*)(R*l*), wherein L_{A}481-(V1)(V1)(V1)(V1) to L_{A}481-(V263)(V263)(V263)(V 263), have the structure | 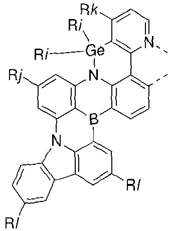 | L_{A}482-(R*i*)(R*j*)(R*k*)(R*l*), wherein L_{A}482-(V1)(V1)(V1)(V1) to L_{A}482-(V263)(V263)(V263)(V 263), have the structure | 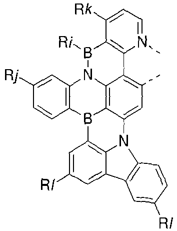 |
| L_{A}483-(R*i*)(R*j*)(R*k*)(R*l*), wherein L_{A}483-(V1)(V1)(V1)(V1) to L_{A}483-(V263)(V263)(V263)(V 263), have the structure | 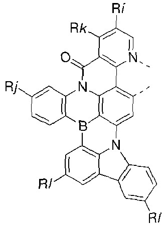 | L_{A}484-(R*i*)(R*j*)(R*k*)(R*l*), wherein L_{A}484-(V1)(V1)(V1)(V1) to L_{A}484-(V263)(V263)(V263)(V 263), have the structure | 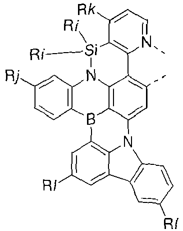 |
| L_{A}485-(R*i*)(R*j*)(R*k*)(R*l*), wherein L_{A}485-(V1)(V1)(V1)(V1) to L_{A}485-(V263)(V263)(V263)(V 263), have the structure | 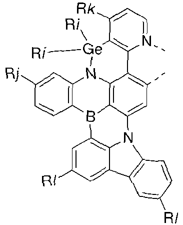 | L_{A}486-(R*i*)(R*j*)(R*k*)(R*l*), wherein L_{A}486-(V1)(V1)(V1)(V1) to L_{A}486-(V263)(V263)(V263)(V 263), have the structure | 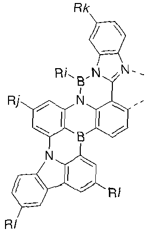 |
| L_{A}487-(R*i*)(R*j*)(R*k*)(R*l*), wherein L_{A}487-(V1)(V1)(V1)(V1) to L_{A}487-(V263)(V263)(V263)(V 263), have the structure | 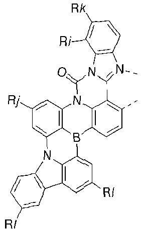 | L_{A}488-(R*i*)(R*j*)(R*k*)(R*l*), wherein L_{A}488-(V1)(V1)(V1)(V1) to L_{A}488-(V263)(V263)(V263)(V 263), have the structure | 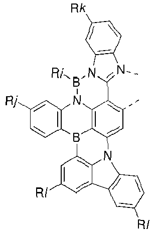 |
| L_{A}489-(R*i*)(R*j*)(R*k*)(R*l*), wherein L_{A}489-(V1)(V1)(V1)(V1) to L_{A}489-(V263)(V263)(V263)(V 263), have the structure | 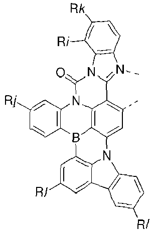 | | |

wherein V1 to V263 have the structures of the following LIST A:

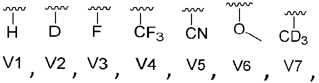

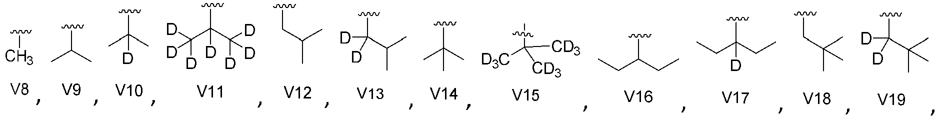

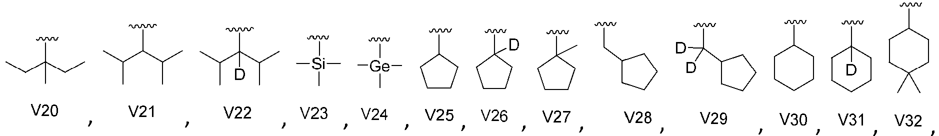

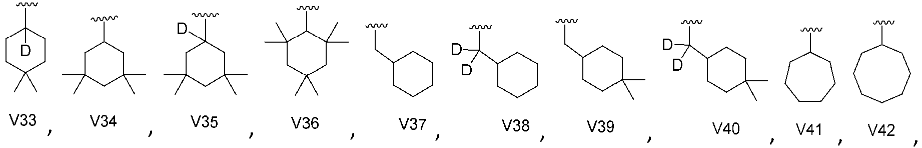

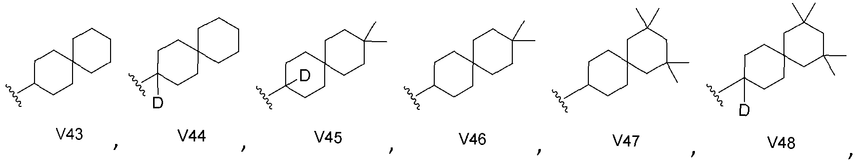

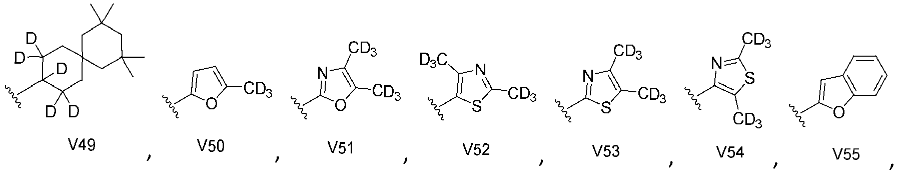

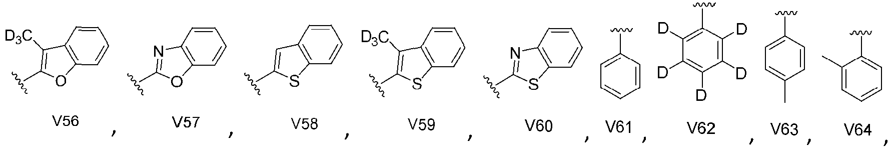

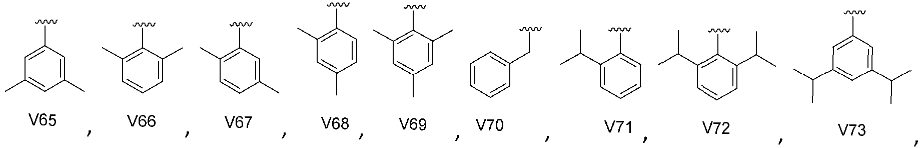

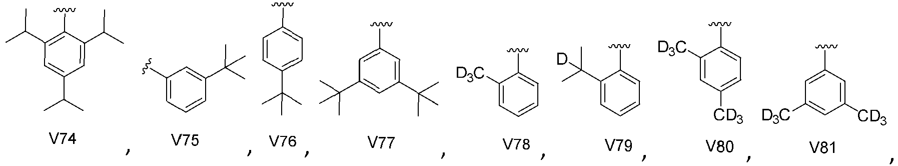

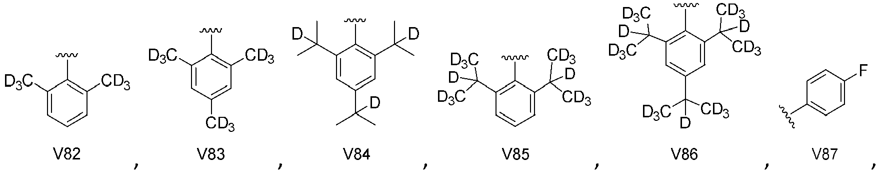

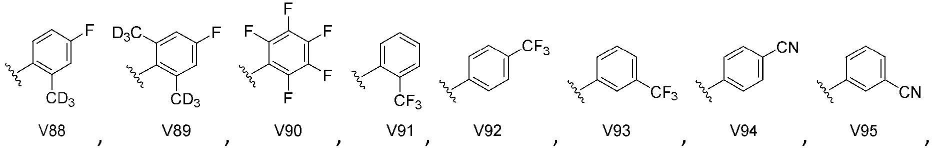

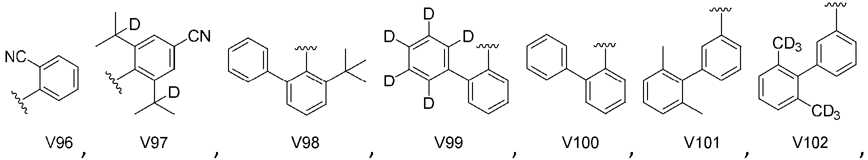

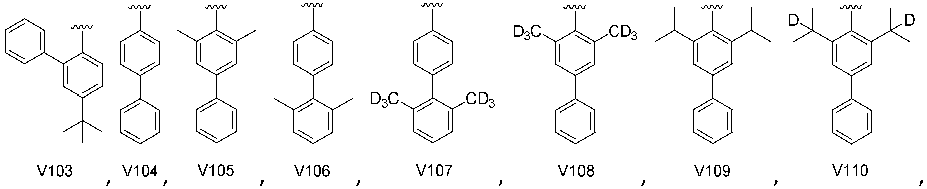

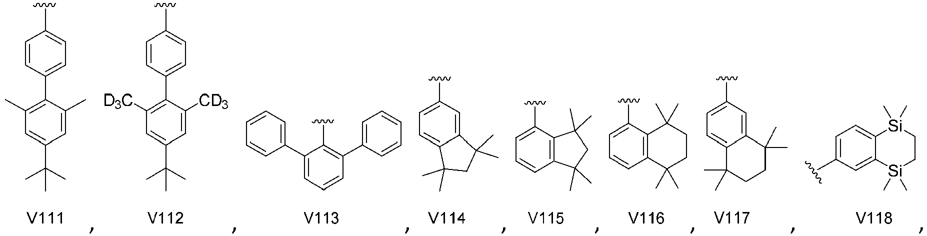

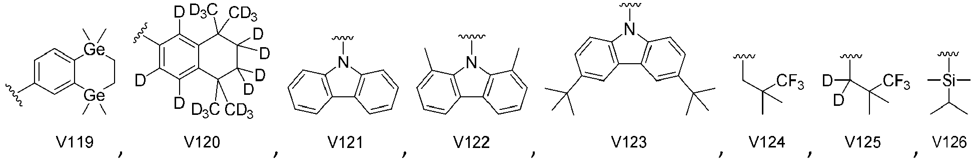

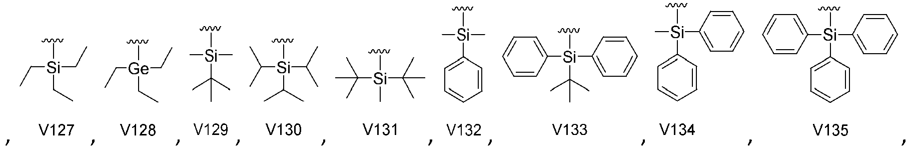

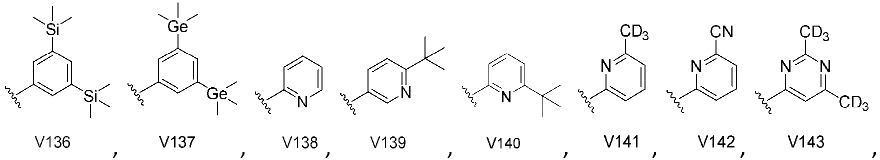

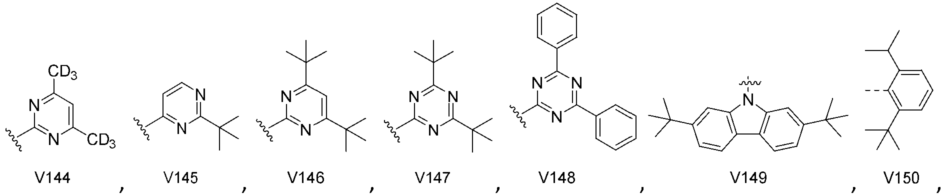

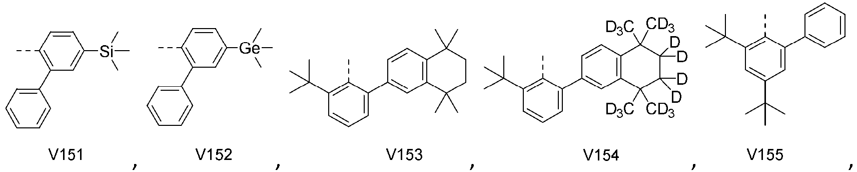

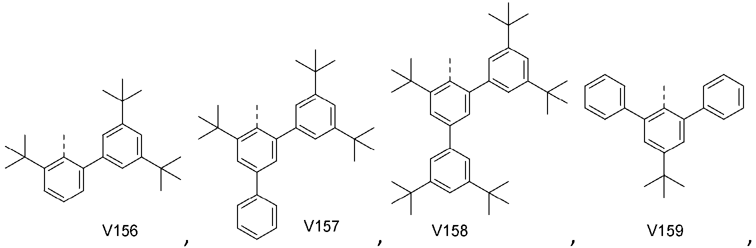

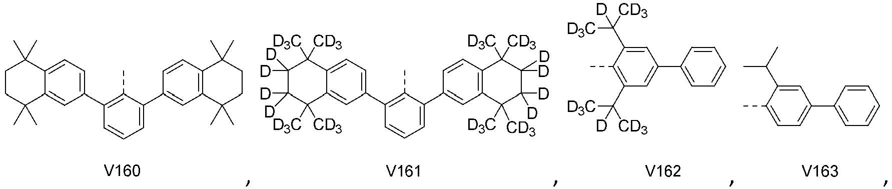

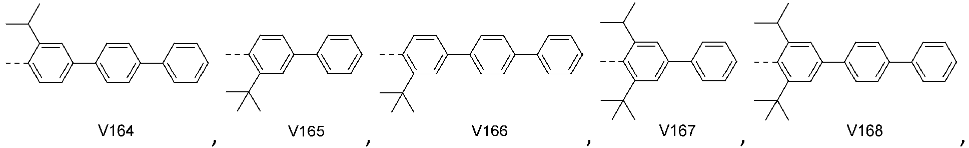

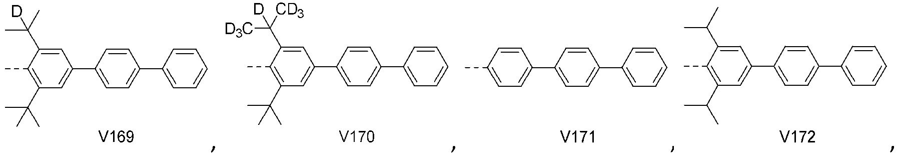

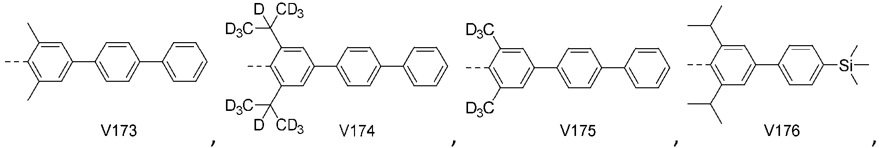

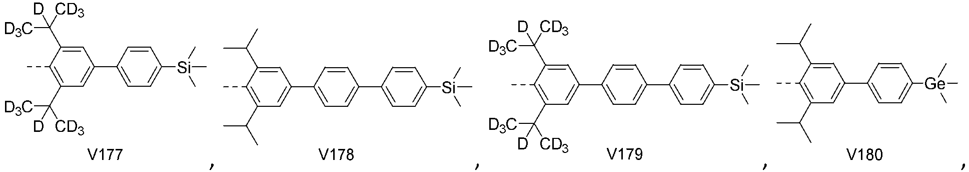

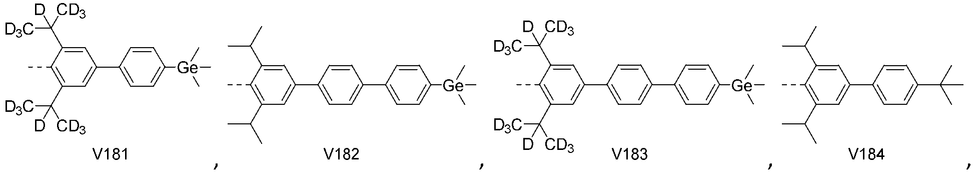

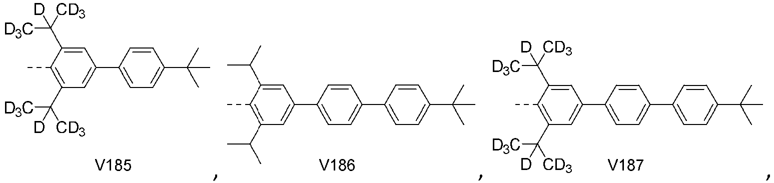

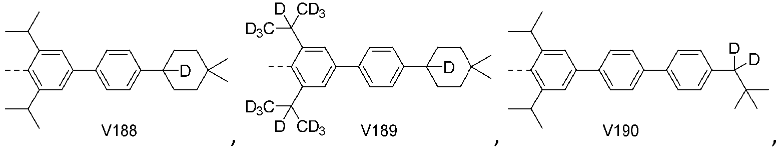

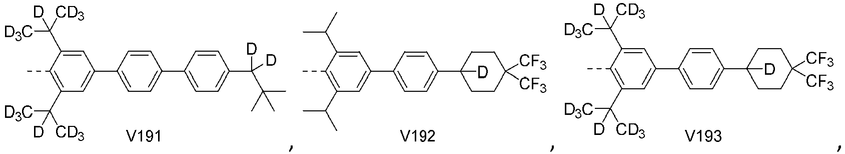

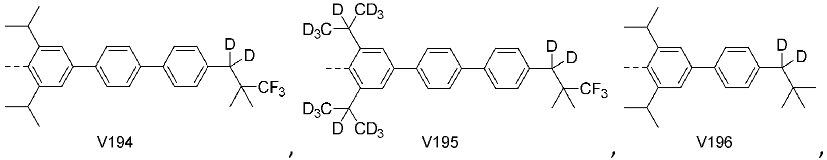

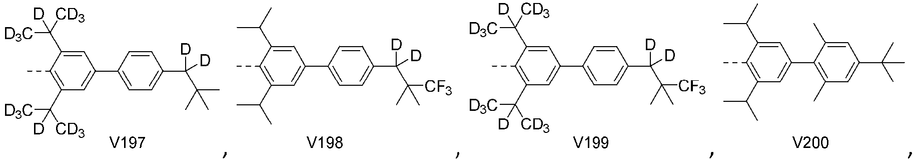

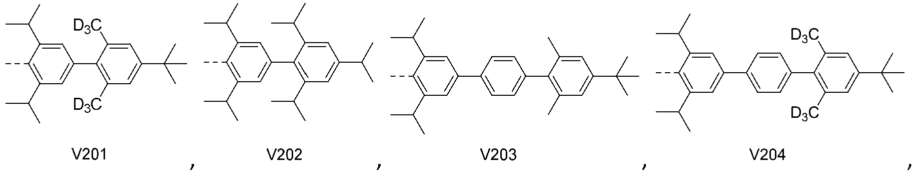

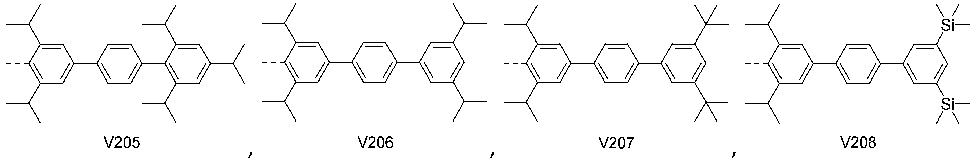

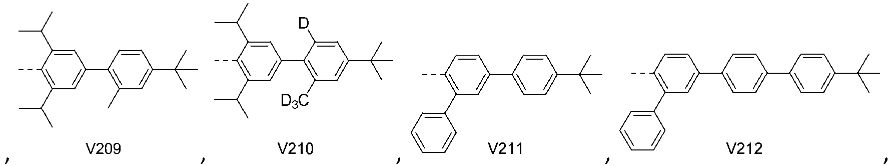

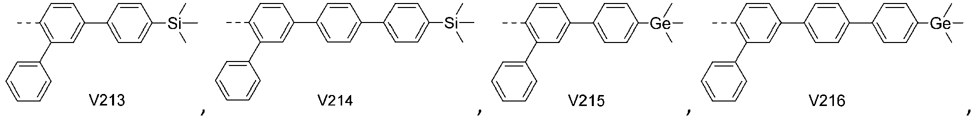

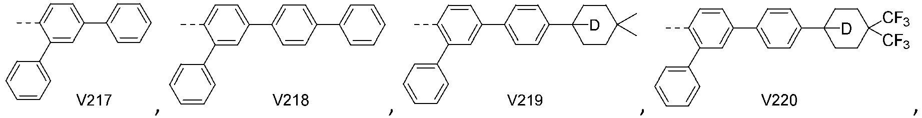

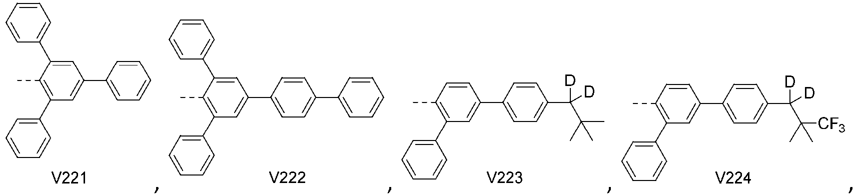

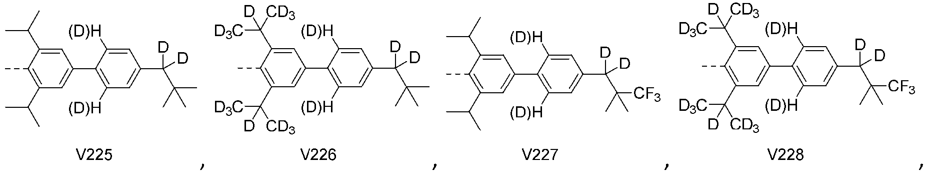

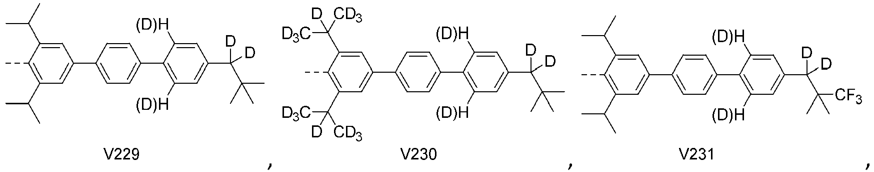

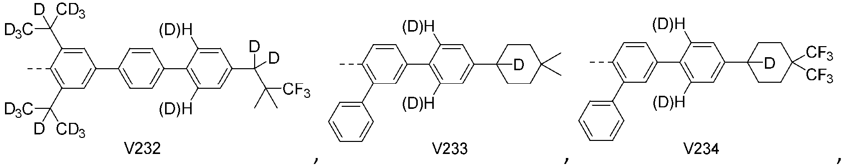

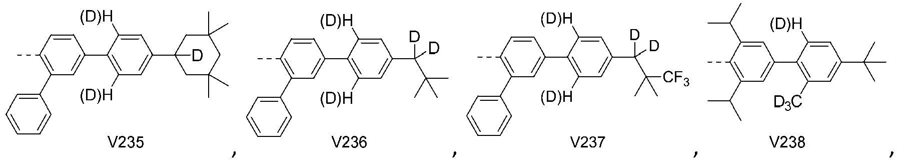

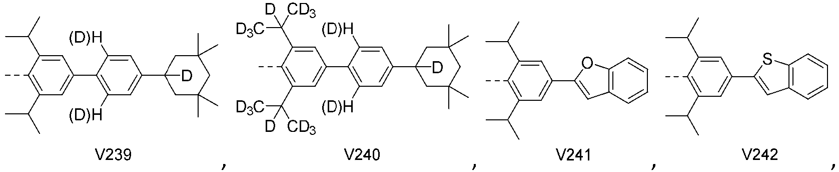

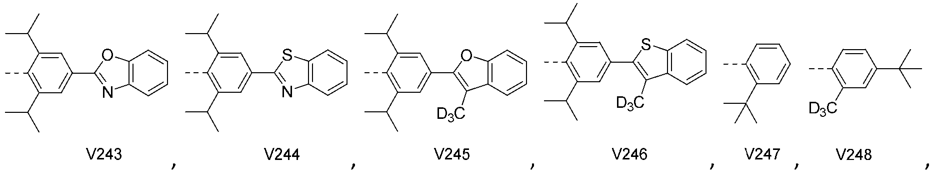

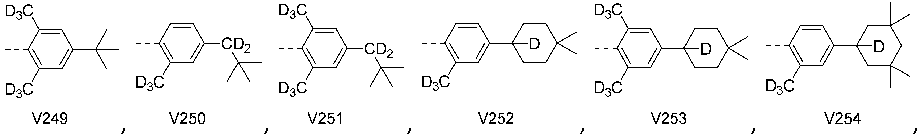

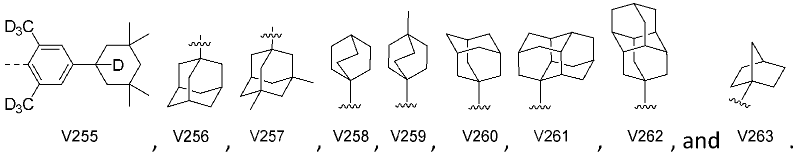

In some embodiments, the compound has a formula of M(L_{A})ₚ(L_{B})_{q}(L_{C})_{c} wherein L_{B} and L_{C} are each a bidentate ligand; and wherein p is 1, 2, or 3; q is 0, 1, or 2; r is 0, 1, or 2; and p+q+r is the oxidation state of the metal M.

In some embodiments, the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other.

In some embodiments, L_{B} is a substituted or unsubstituted phenylpyridine, and L_{C} is a substituted or unsubstituted acetylacetonate.

In some embodiments, the compound has a formula of Pt(L_{A})(L_{B}); and wherein L_{A} and L_{B} can be same or different.

In some embodiments, L_{A} and L_{B} are connected to form a tetradentate ligand.

In some embodiments, L_{B} and L_{C} are each independently selected from the group consisting of the following structures (LIST 4): 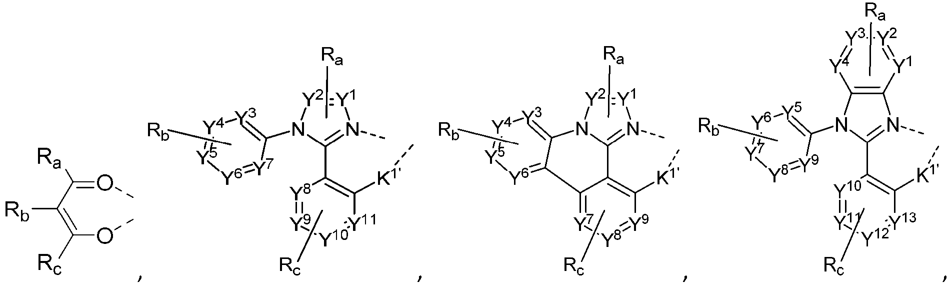 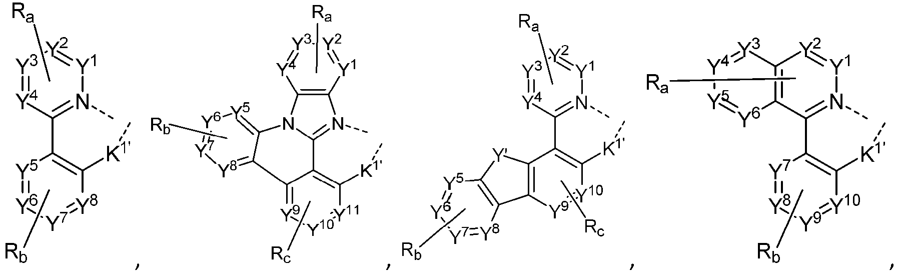 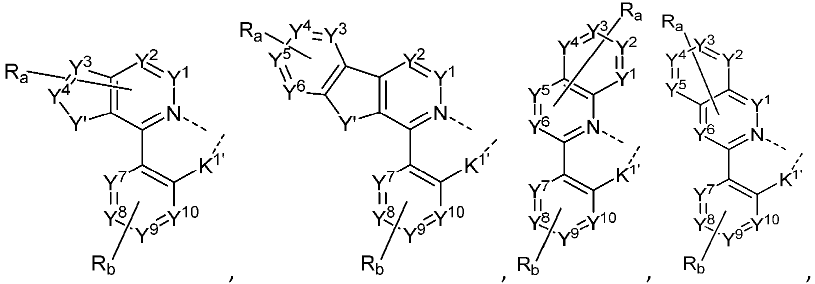 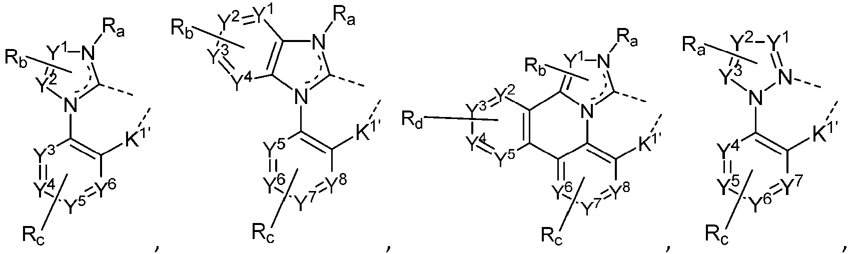 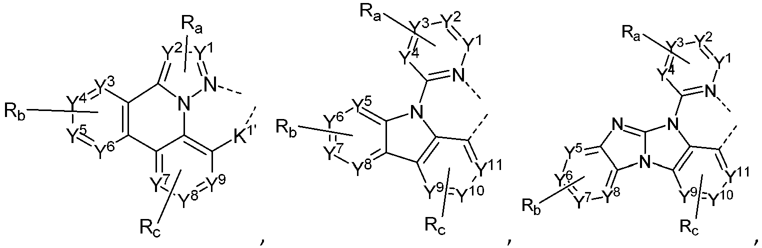 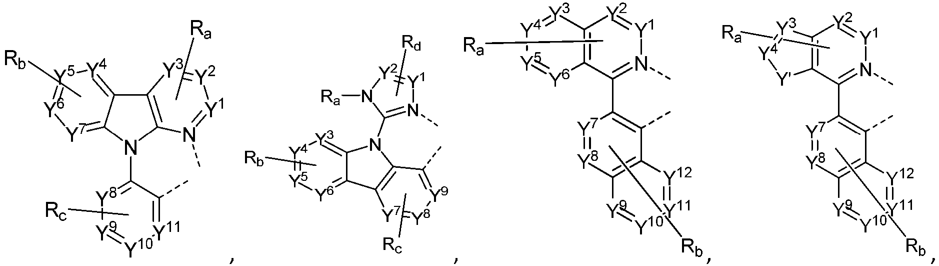 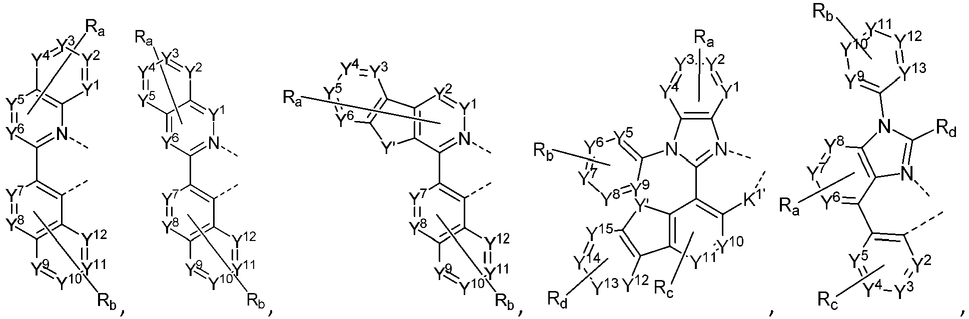 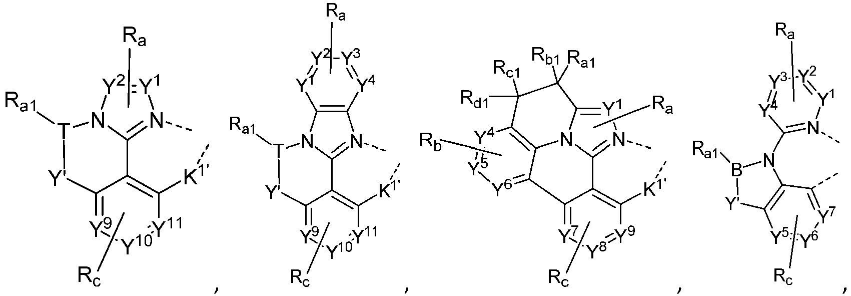 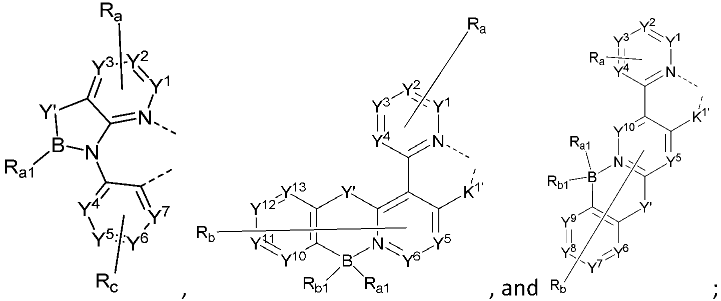 wherein:
T is selected from the group consisting of B, Al, Ga, and In;
wherein K^{1'} is a direct bond or is selected from the group consisting of NRₑ, PRₑ, O, S, and Se;
each of Y¹ to Y¹³ is independently selected from the group consisting of carbon and nitrogen;
Y' is selected from the group consisting of BRₑ, NRₑ, PRₑ, O, S, Se, C=O, C=S, C=Se, S=O, SO₂, P(O)Rₑ, C=NRₑ, C=CRₑR_{f}, CRₑR_{f}, SiRₑR_{f}, and GeRₑR_{f};
Rₑ and R_{f} can be fused or joined to form a ring;
each Rₐ, R_{b}, R_{c}, and R_{d} independently represent zero, mono, or up to a maximum allowed number of substitutions to its associated ring;
each of Rₐ₁, R_{b1}, R_{c1}, R_{d1}, Rₐ, R_{b}, R_{c}, R_{d}, Rₑ and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, selenyl, and combinations thereof; the general substituents defined herein; and any two adjacent Rₐ, R_{b}, R_{c}, R_{d}, Rₑ and R_{f} can be fused or joined to form a ring or form a multidentate ligand.

In some embodiments, L_{B} and L_{C} are each independently selected from the group consisting of the following structures (LIST 5): 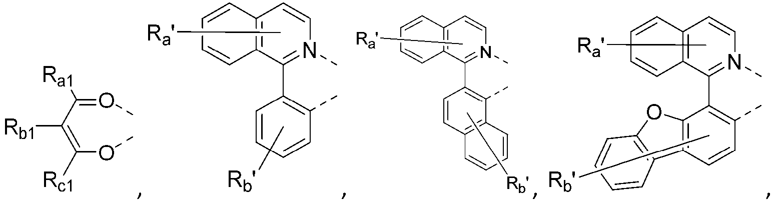 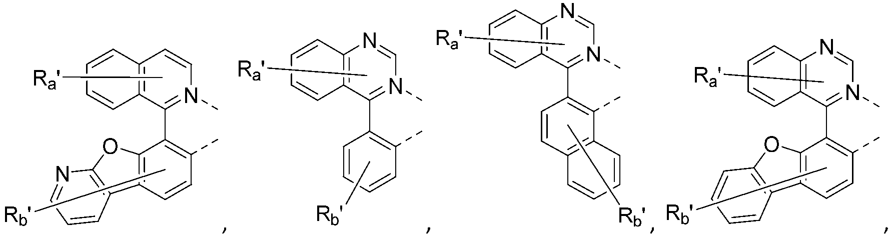 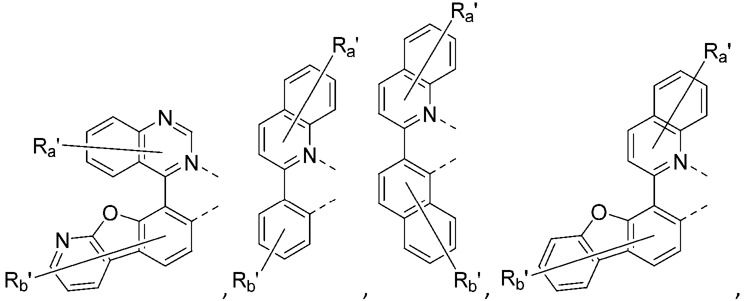 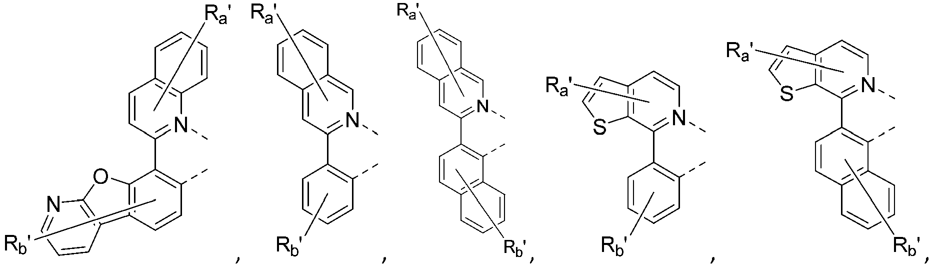 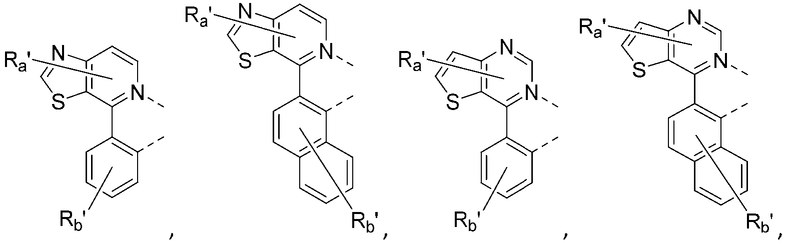 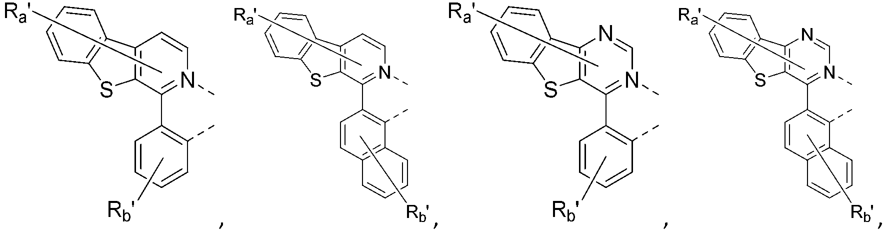 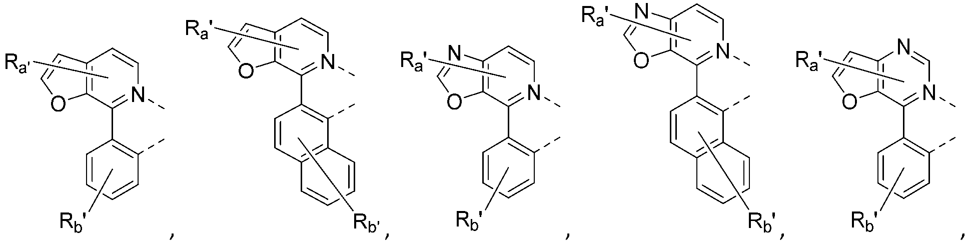 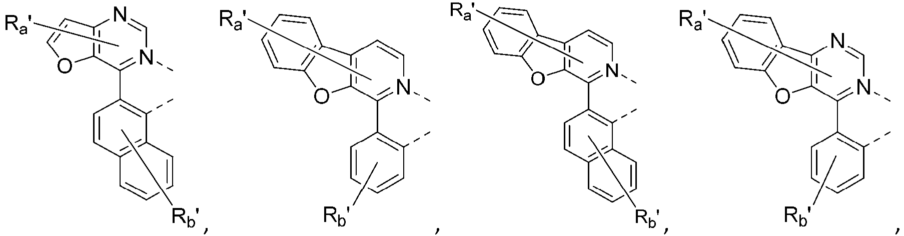 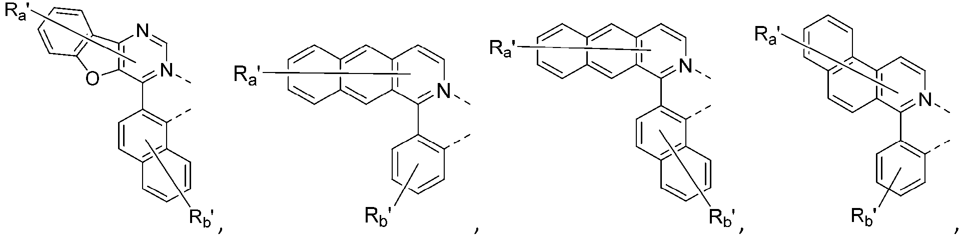 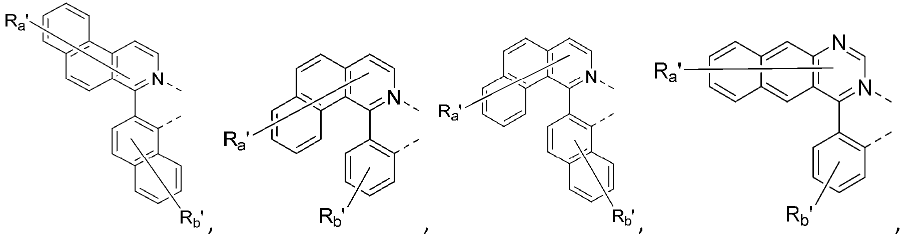 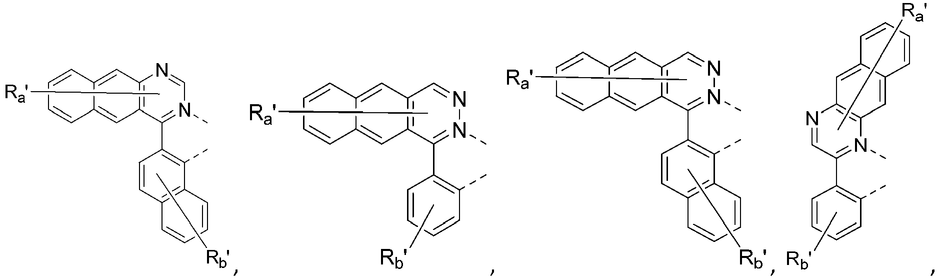 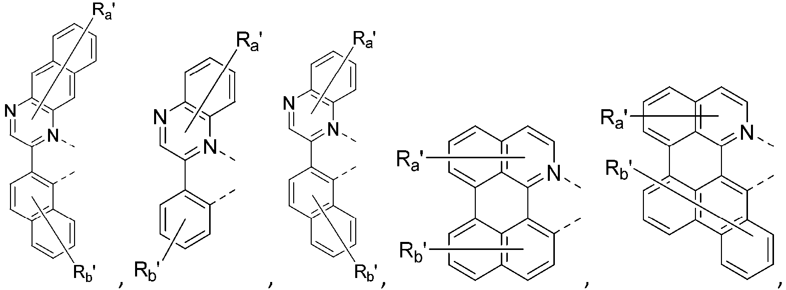 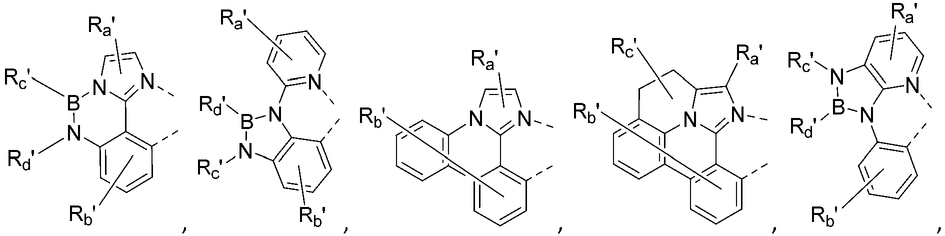 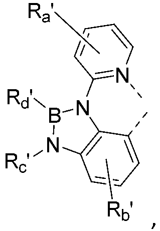 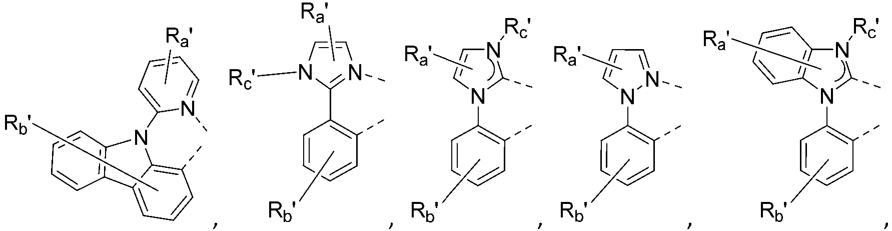 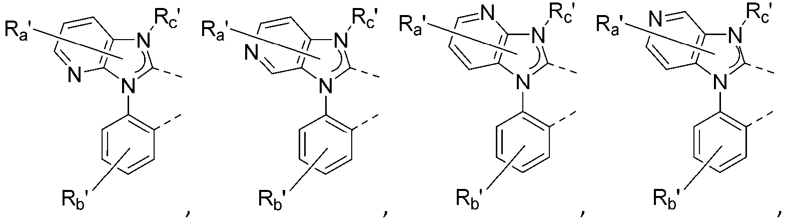 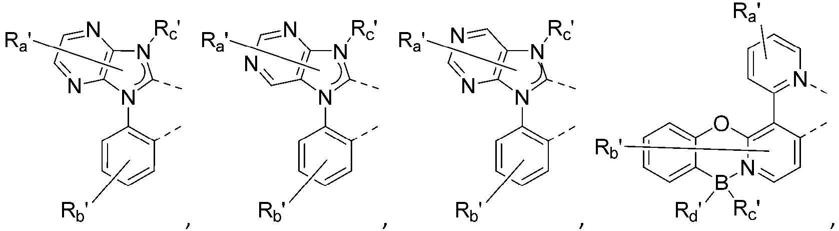 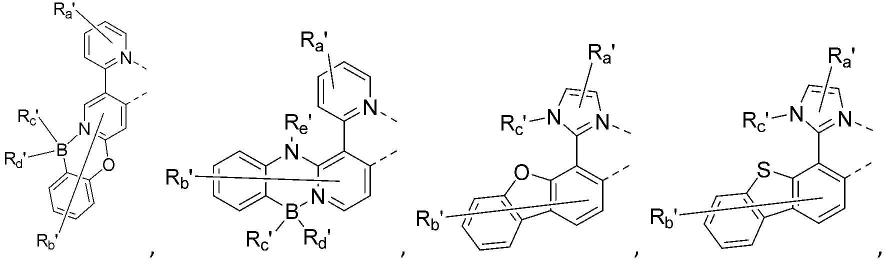 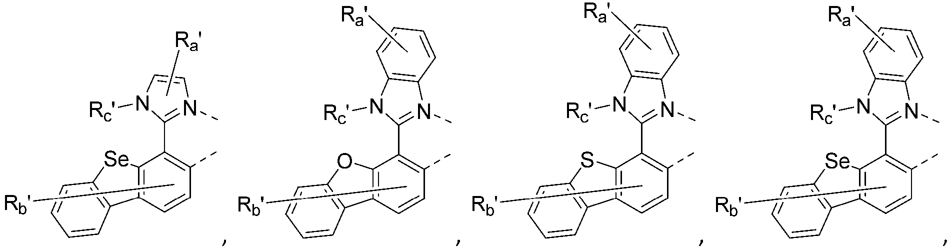 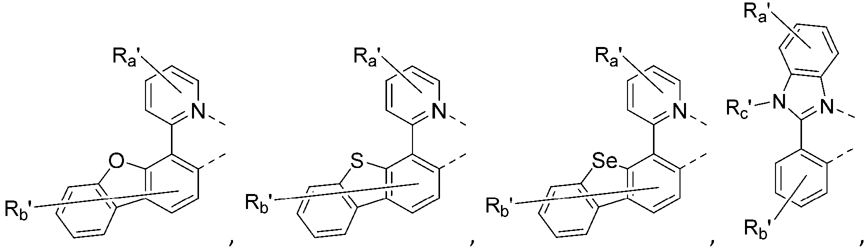 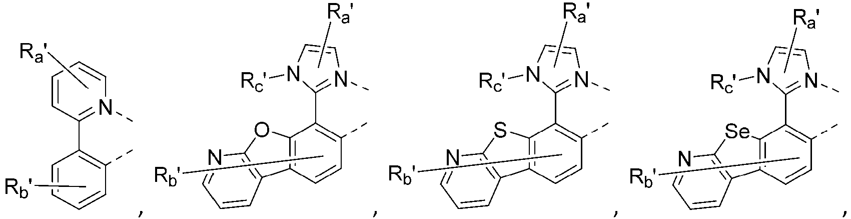 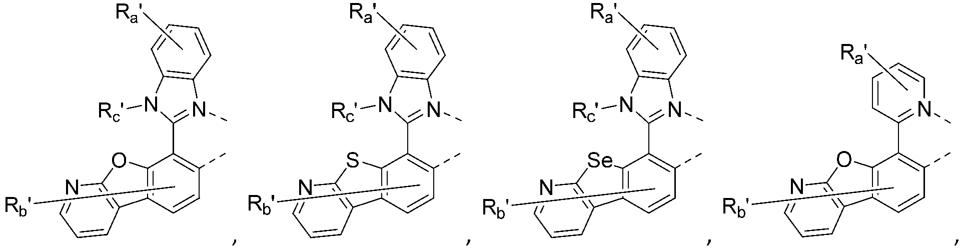 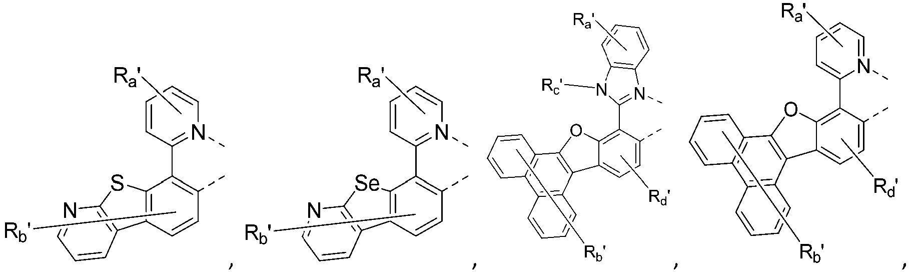 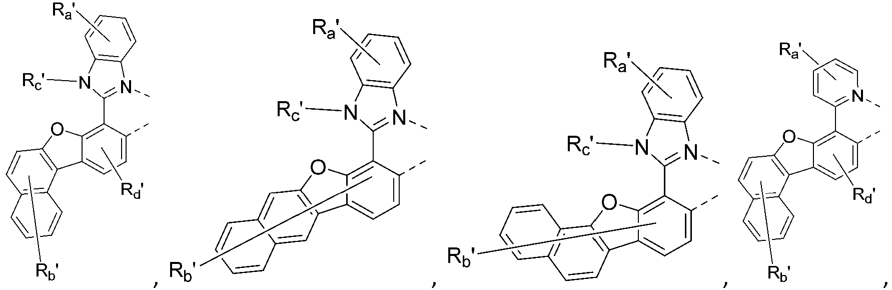 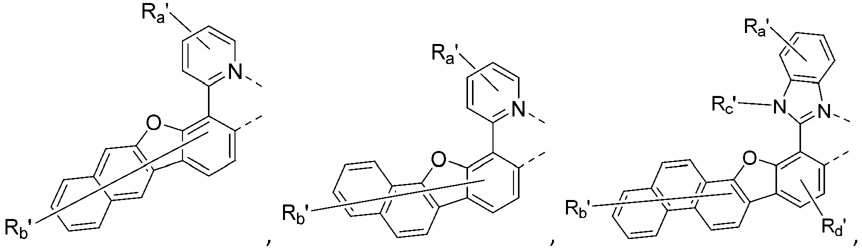 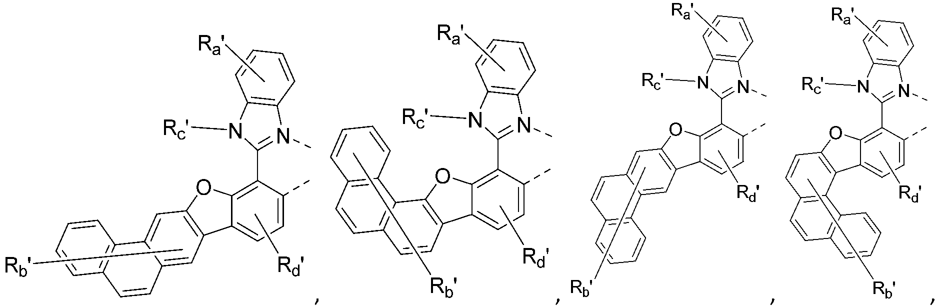 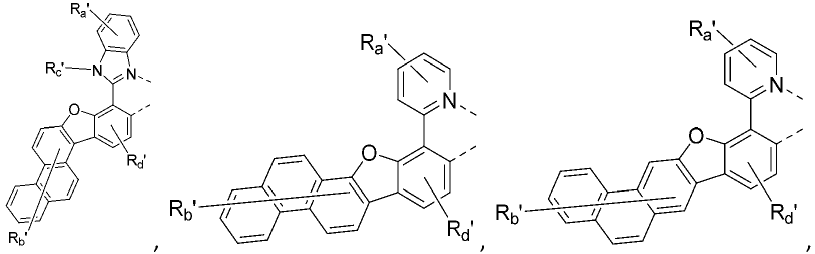 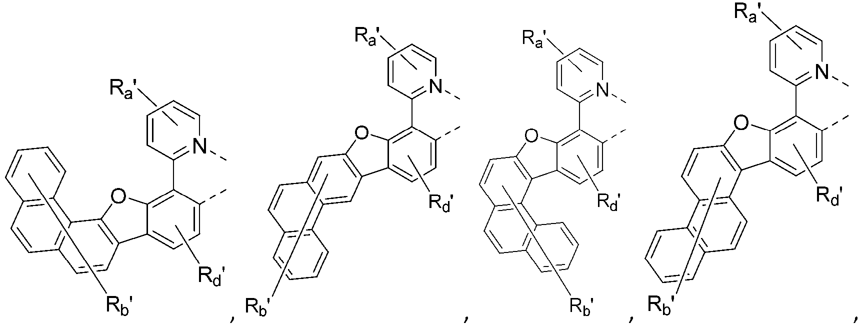 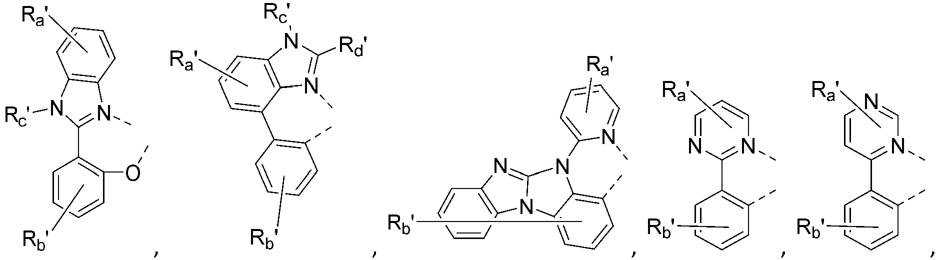 and 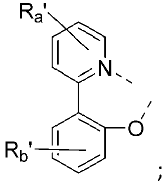
wherein Rₐ', R_{b}', R_{c}', R_{d}', and Rₑ' each independently represent zero, mono, or up to a maximum allowed substitution to its associated ring;
wherein Rₐ', R_{b}', R_{c}', R_{d}', and Rₑ' is each independently hydrogen or a substituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, selenyl, and combinations thereof; and
wherein two adjacent substituents of Rₐ', R_{b}', R_{c}', R_{d}', and Rₑ' can be fused or joined to form a ring or form a multidentate ligand.

In some embodiments, L_{B} comprises a structure of 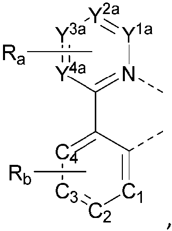 wherein the variables are the same as previously defined. In some embodiments, each of Y^{1a} to Y^{4a} is independently carbon. In some embodiments, at least one of Y^{1a} to Y^{4a} is N. In some embodiments, exactly one of Y^{1a} to Y^{4a} is N. In some embodiments, Y^{1a} is N. In some embodiments, Y^{2a} is N. In some embodiments, Y^{3a} is N. In some embodiments, Y^{4a} is N.

In some embodiments, at least one of R^{a} is a tertiary alkyl, silyl or germyl. In some embodiments, at least one of R^{a} is a tertiary alkyl .

In some embodiments, Y^{1a} is carbon and attached to Rₐ₁. In some such embodiments, Rₐ₁ may be selected from the group consisting of the General Substituents defined herein. In some such embodiments, Rₐ₁ may be selected from the group consisting of the Preferred General Substituents defined herein. In some such embodiments, Rₐ₁ is a tertiary alkyl, silyl or germyl. In some such embodiments, Rₐ₁ is a tertiary alkyl. In some embodiments, Y^{2a} is carbon and attached to Rₐ₂. In some such embodiments, Rₐ₂ may be selected from the group consisting of the General Substituents defined herein. In some such embodiments, Rₐ₂ may be selected from the group consisting of the Preferred General Substituents defined herein. In some such embodiments, Rₐ₂ is a tertiary alkyl, silyl or germyl. In some such embodiments, Rₐ₂ is a tertiary alkyl. In some embodiments, Y^{3a} is carbon and attached to Rₐ₃. In some such embodiments, Rₐ₃ may be selected from the group consisting of the General Substituents defined herein. In some such embodiments, Rₐ₃ may be selected from the group consisting of the Preferred General Substituents defined herein. In some such embodiments, Rₐ₃ is a tertiary alkyl, silyl or germyl. In some such embodiments, Rₐ₃ is a tertiary alkyl. In some embodiments, Y^{4a} is carbon and attached to Rₐ₄. In some such embodiments, Rₐ₄ may be selected from the group consisting of the General Substituents defined herein. In some such embodiments, Rₐ₄ may be selected from the group consisting of the Preferred General Substituents defined herein. In some such embodiments, Rₐ₄ is a tertiary alkyl, silyl or germyl. In some such embodiments, Rₐ₄ is a tertiary alkyl.

In some embodiments, X^{3a} is C and the R^{C} attached thereto is a tertiary alkyl, silyl or germyl. In some embodiments, X^{2a} is C and the R^{C} attached thereto is a tertiary alkyl, silyl or germyl.

In some embodiments, Y^{1a} to Y^{3a} is C, Y^{4a} is N, and the Rₐ₃ attached to Y^{3a} is a tertiary alkyl, silyl or germyl. In some embodiments, Y^{1a} to Y^{3a} is C, Y^{4a} is N, and the Rₐ₂ attached to Y^{2a} is a tertiary alkyl, silyl or germyl.

In some embodiments, at least one of R_{b} is a tertiary alkyl, silyl, or germyl. In some embodiments, at least one of R_{b} is *tert*-butyl. In some embodiments, at least one pair of Rₐ, one pair of R_{b}, or one Rₐ and one R_{b} are joined or fused into a ring.

In some embodiments, R_{b1} is attached to C1 (carbon atom). In some such embodiments, R_{b1} may be selected from the group consisting of the General Substituents defined herein. In some such embodiments, R_{b1} may be selected from the group consisting of the Preferred General Substituents defined herein. In some such embodiments, R_{b1} is a tertiary alkyl, silyl or germyl. In some such embodiments, R_{b1} is a tertiary alkyl. In some embodiments, the tertiary alkyl is tert-butyl. In some embodiments, R_{b2} is attached to C2 (carbon atom). In some such embodiments, R_{b2} may be selected from the group consisting of the General Substituents defined herein. In some such embodiments, R_{b2} may be selected from the group consisting of the Preferred General Substituents defined herein. In some such embodiments, R_{b2} is a tertiary alkyl, silyl or germyl. In some such embodiments, R_{b2} is a tertiary alkyl. In some embodiments, the tertiary alkyl is tert-butyl. In some embodiments, R_{b3} is attached to C3 (carbon atom). In some such embodiments, R_{b3} may be selected from the group consisting of the General Substituents defined herein. In some such embodiments, R_{b3} may be selected from the group consisting of the Preferred General Substituents defined herein. In some such embodiments, R_{b3} is a tertiary alkyl, silyl or germyl. In some such embodiments, R_{b3} is a tertiary alkyl. In some embodiments, the tertiary alkyl is tert-butyl. In some embodiments, R_{b4} is attached to C4 (carbon atom). In some such embodiments, R_{b4} may be selected from the group consisting of the General Substituents defined herein. In some such embodiments, R_{b4} may be selected from the group consisting of the Preferred General Substituents defined herein. In some such embodiments, R_{b4} is a tertiary alkyl, silyl or germyl. In some such embodiments, R_{b4} is a tertiary alkyl. In some embodiments, the tertiary alkyl is tert-butyl.

In some embodiments, the compound has formula Ir(L_{A})₃, formula Ir(L_{A})(L_{B*k*})₂, formula Ir(L_{A})₂(L_{B*k*}), formula Ir(L_{A})₂(L_{C*j*-I}), or formula Ir(L_{A})₂(L_{*Cj*-II}),
wherein L_{A} is according to any one of claims 1-86;
wherein k is an integer from 1 to 544, and each L_{B*k*} has the structure defined as follows (LIST 6): 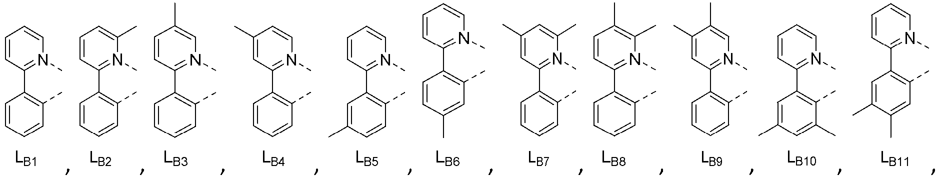 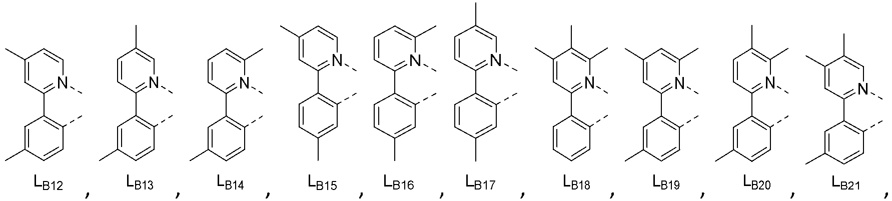 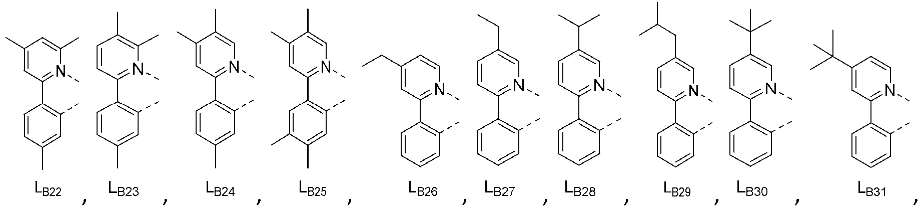 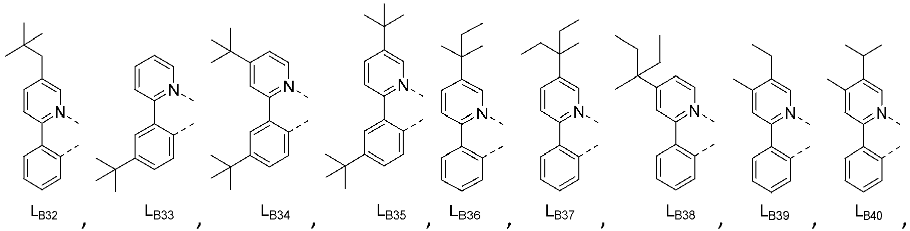 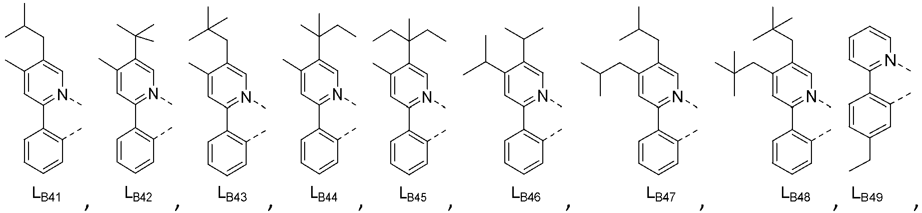 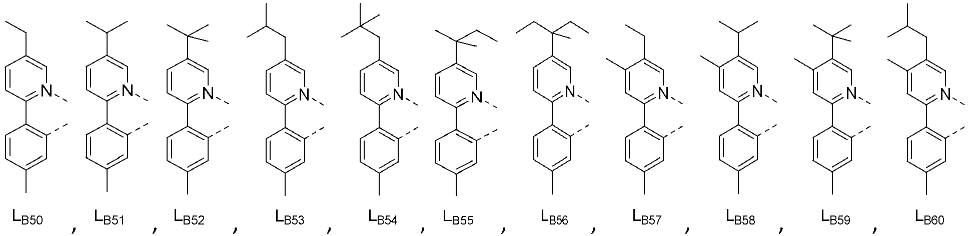 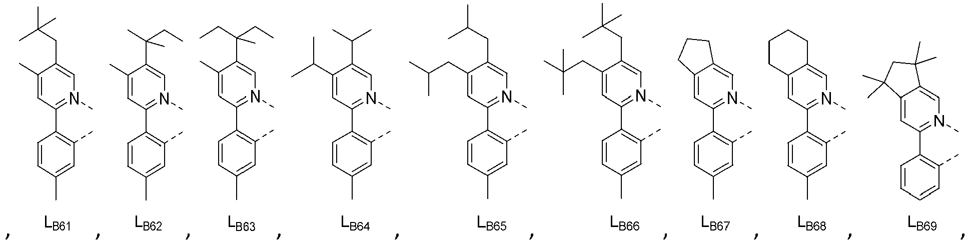 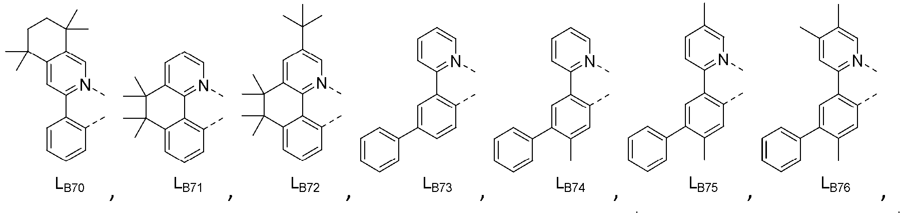 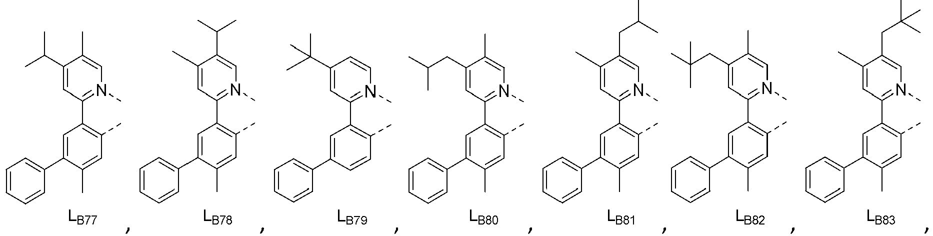 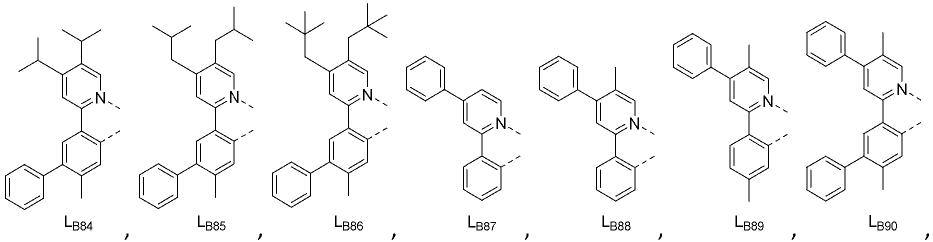 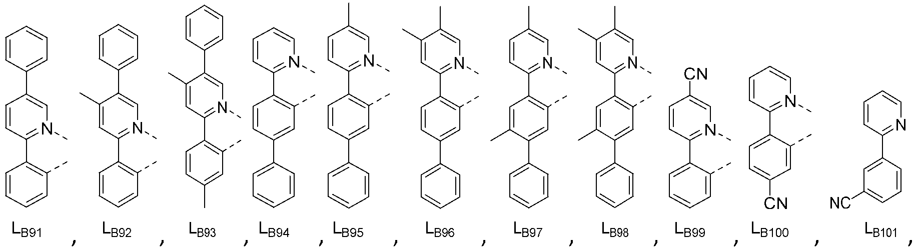 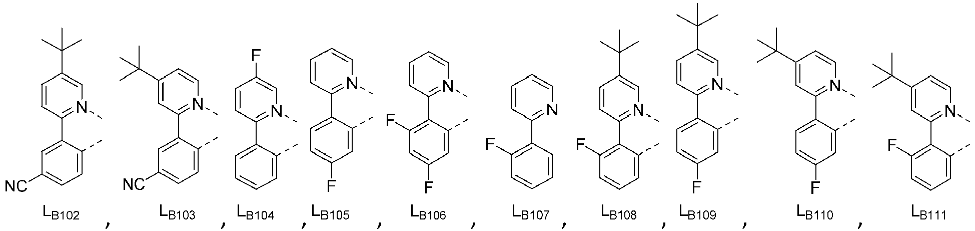 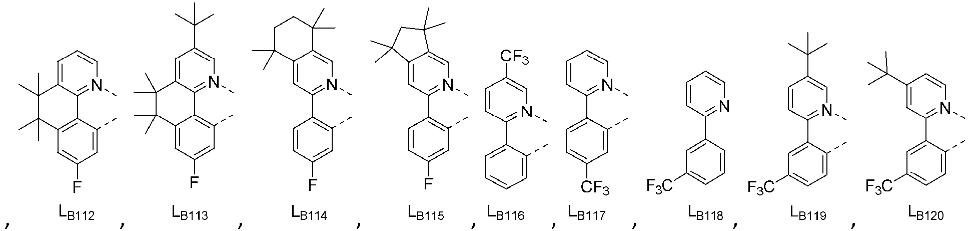 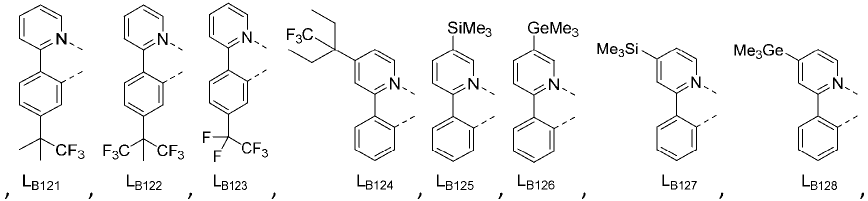 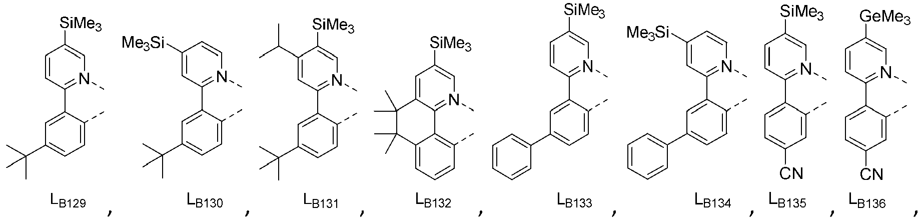 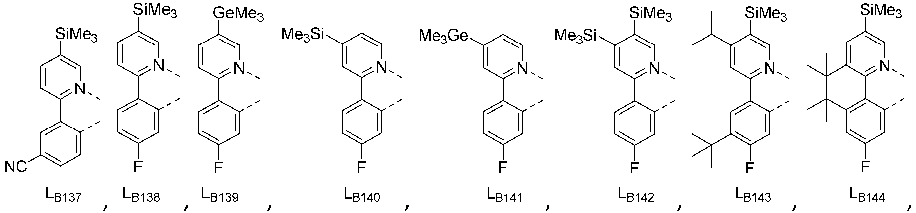 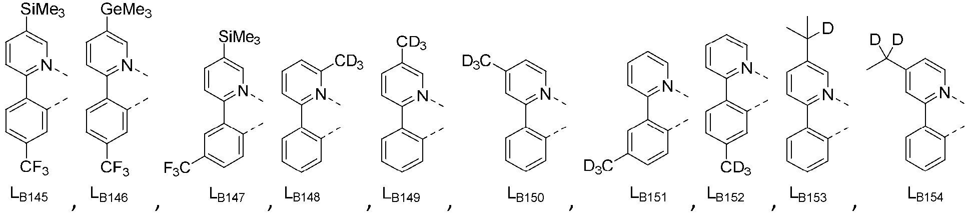 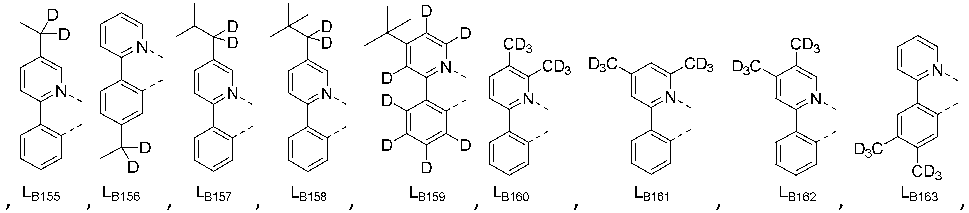 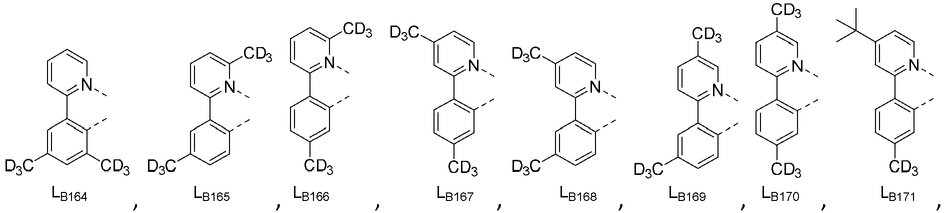 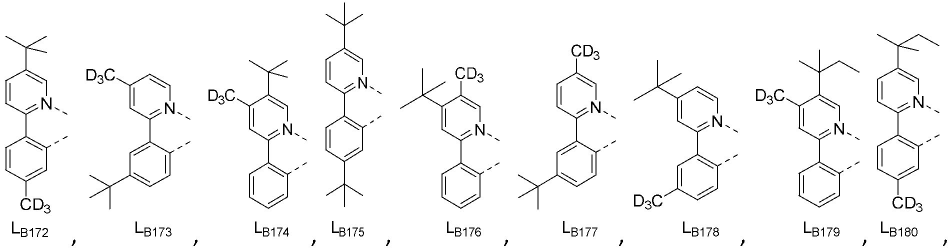 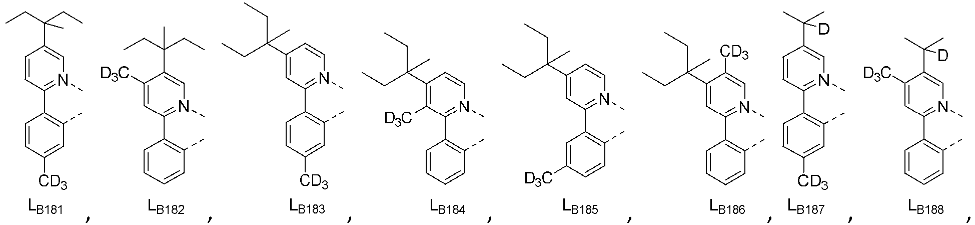 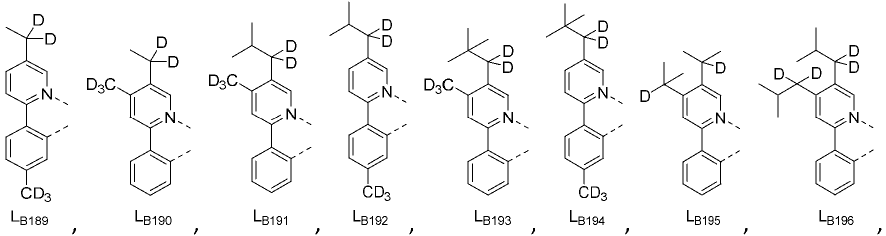 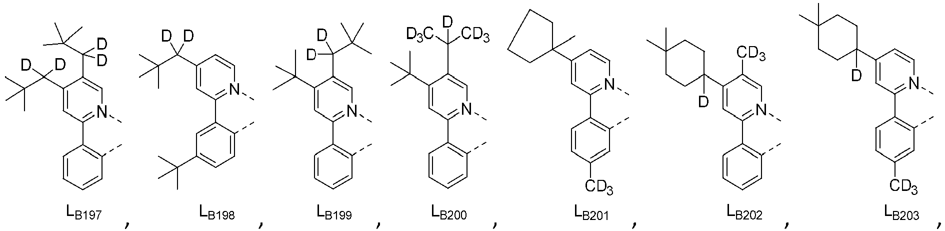 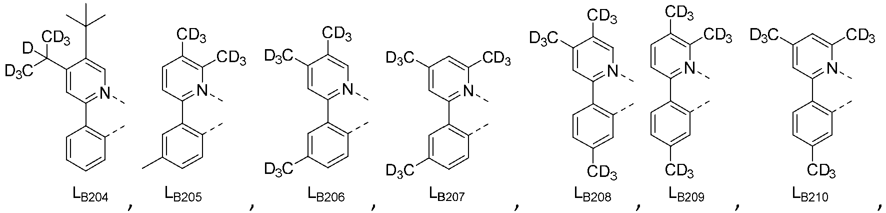 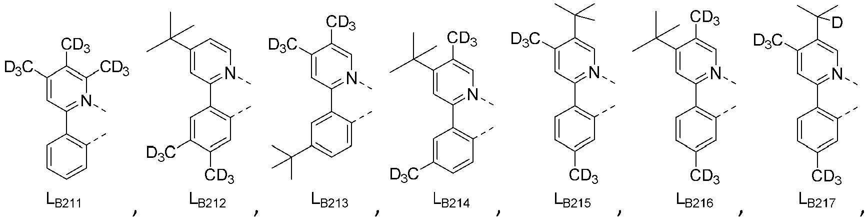 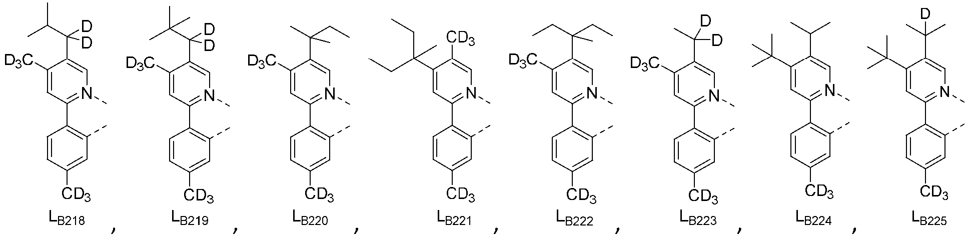 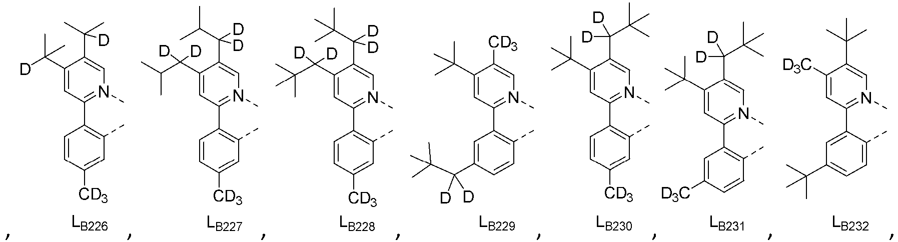 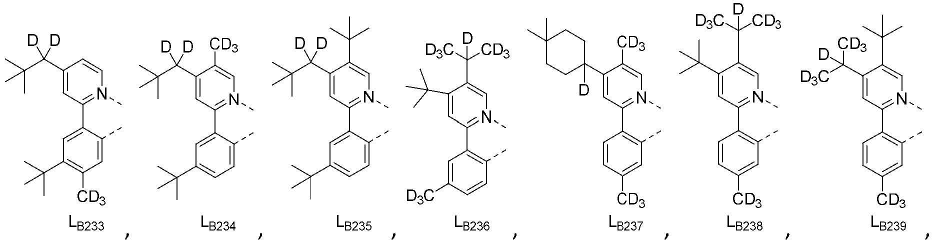 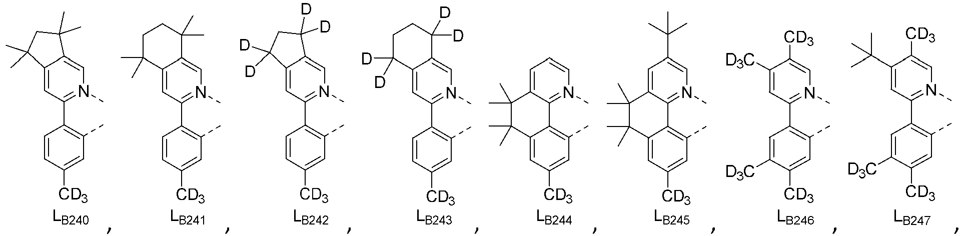 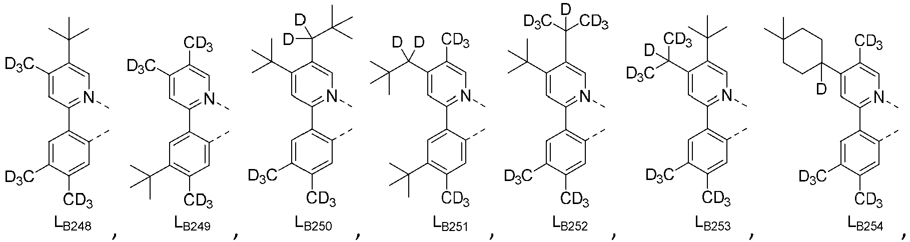 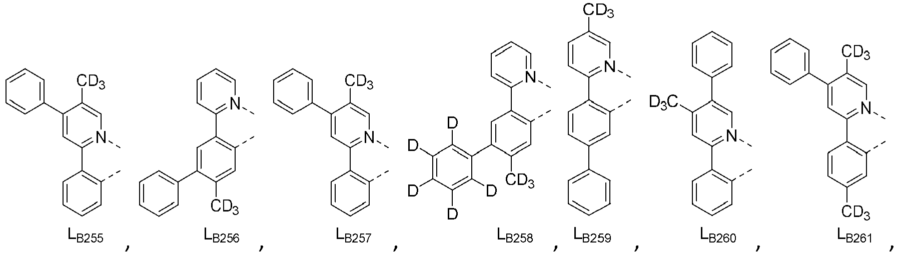 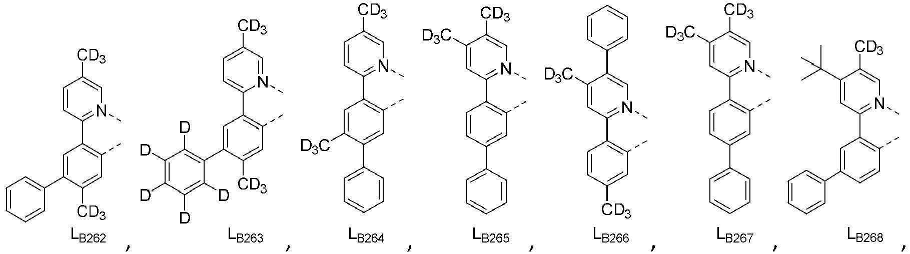 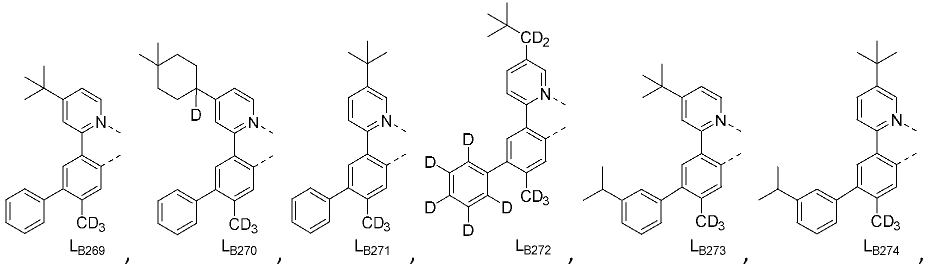 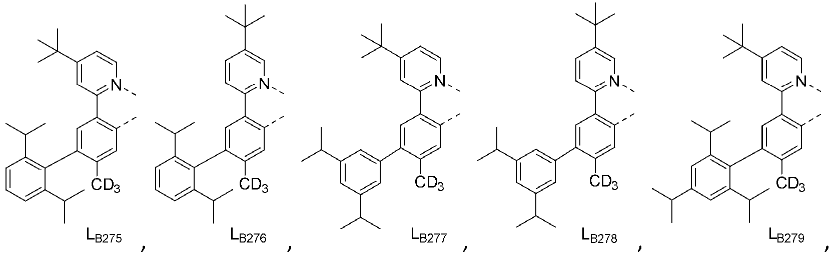 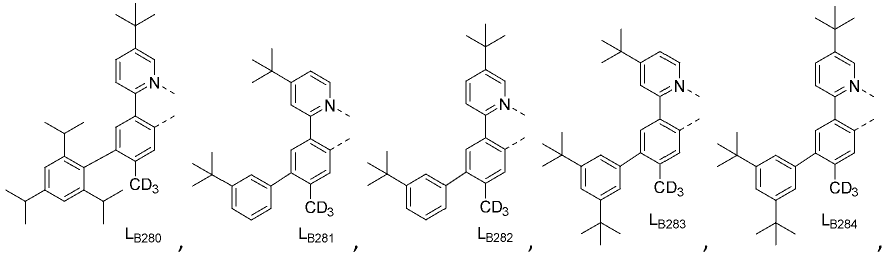 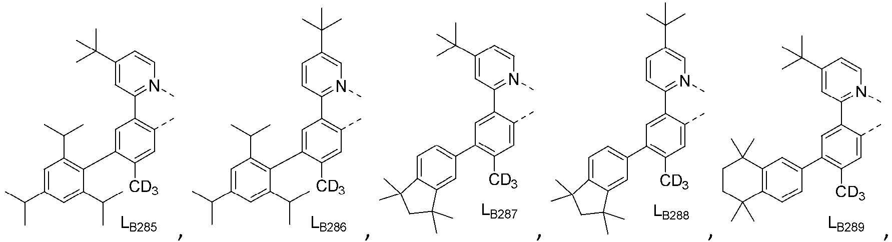 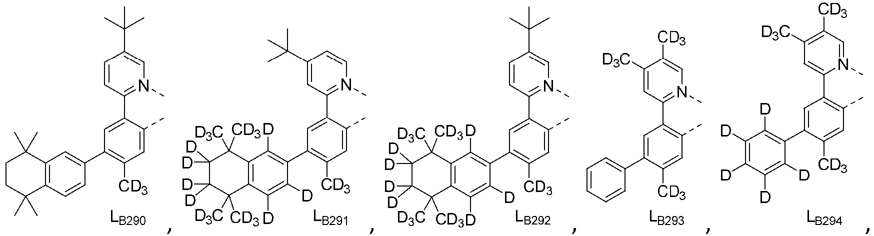 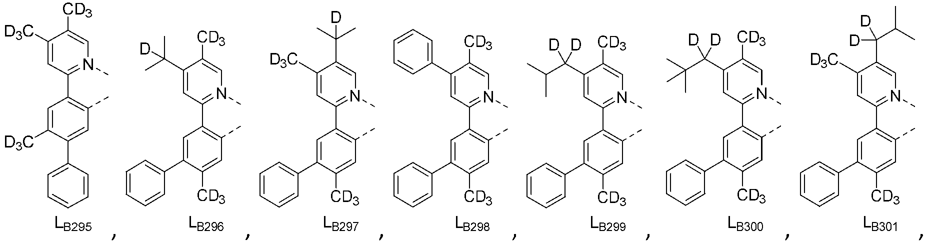 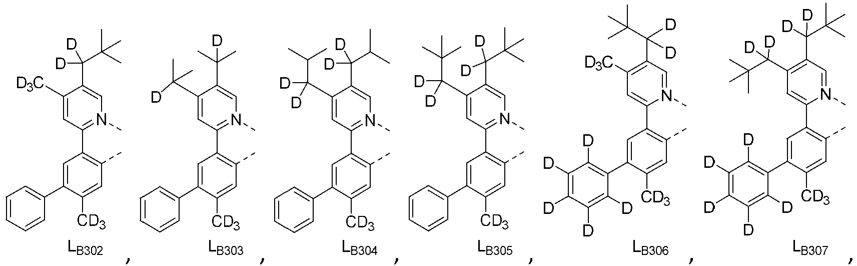 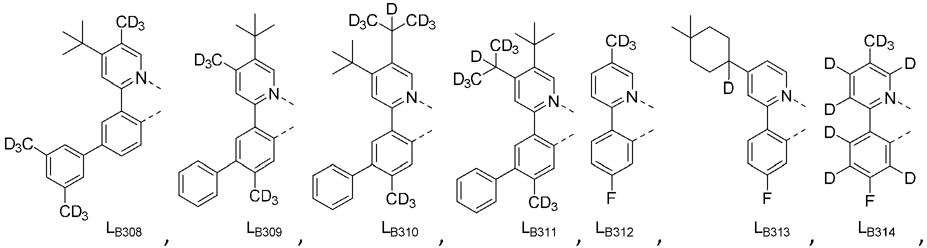 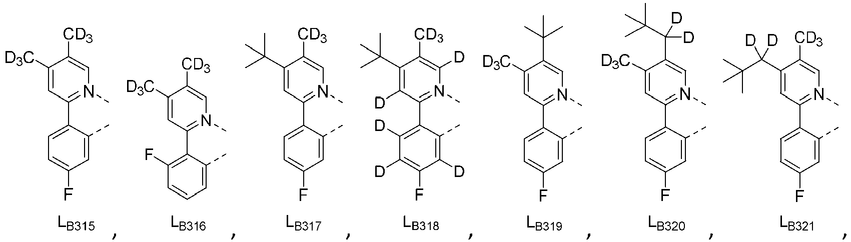 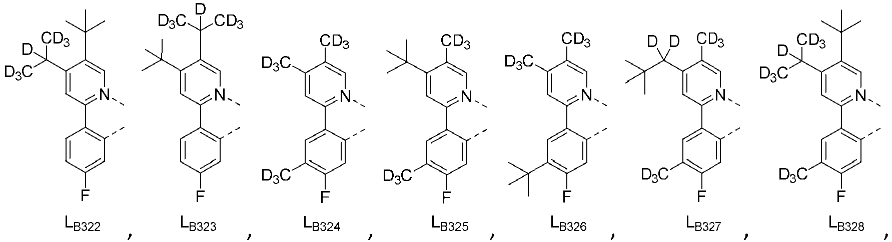 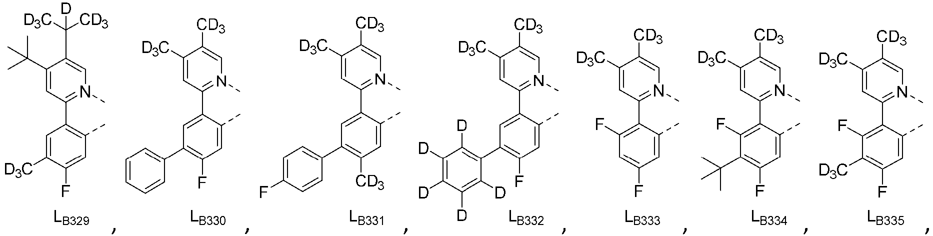 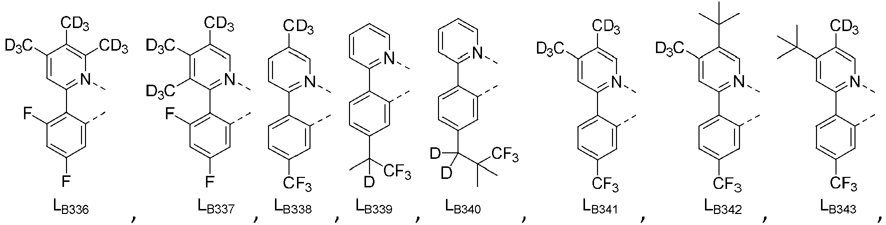 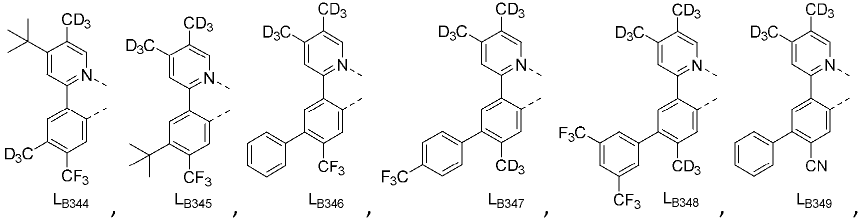 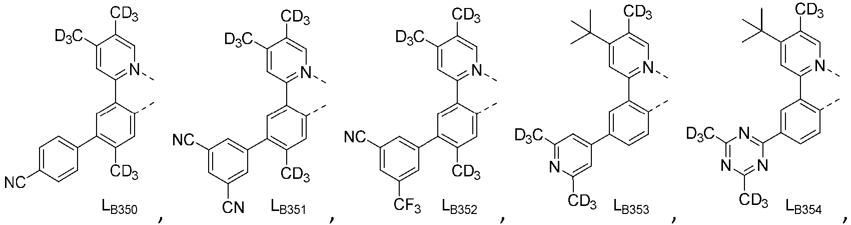 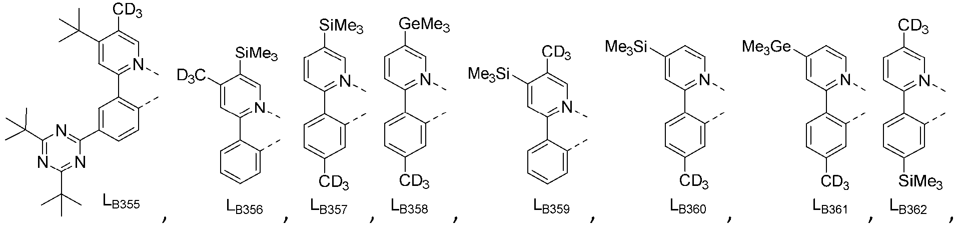 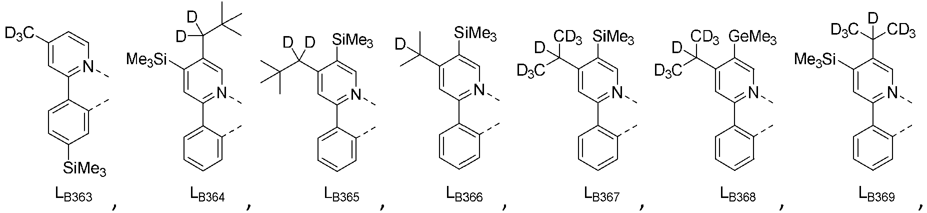 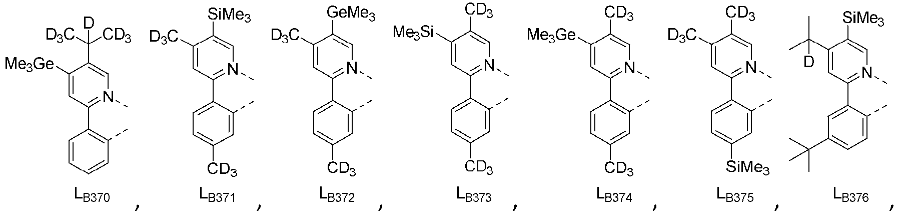 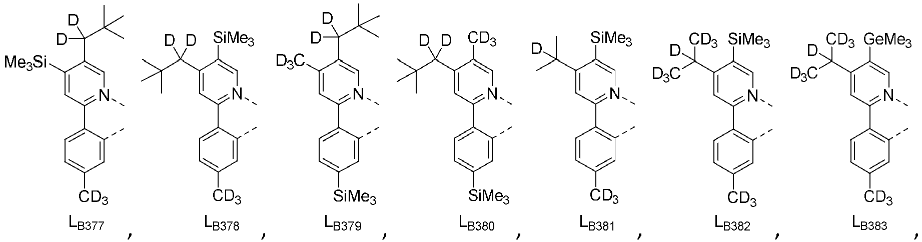 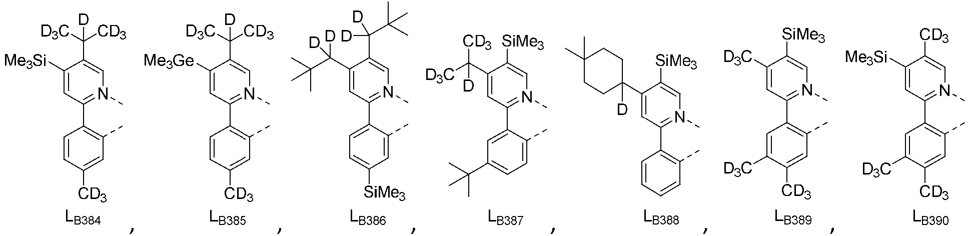 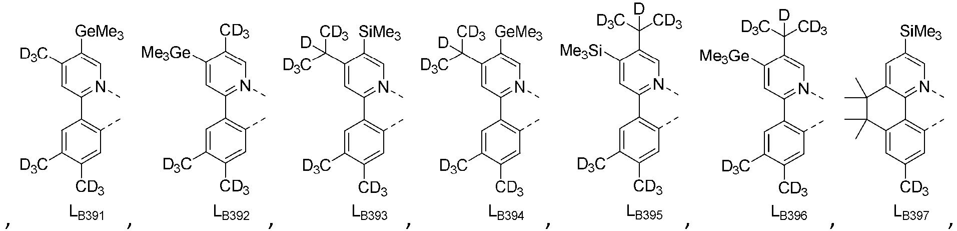 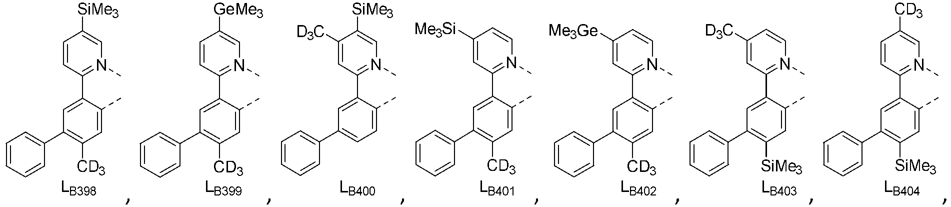 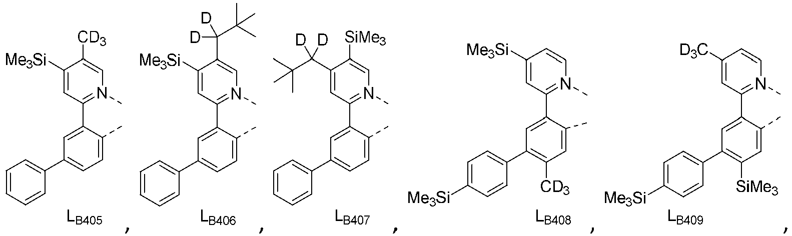 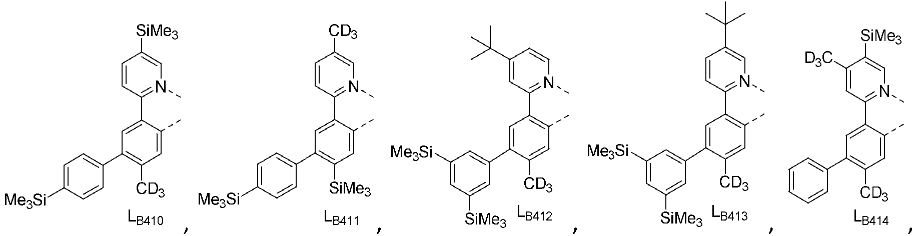 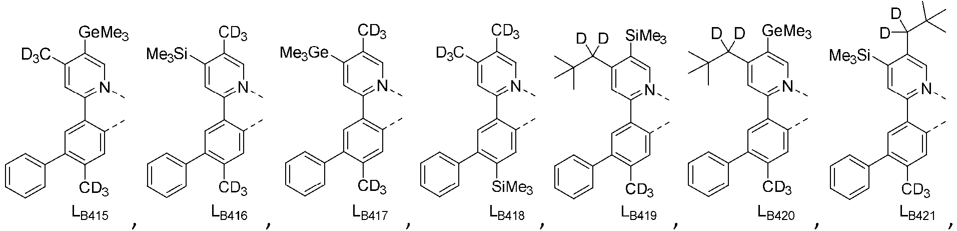 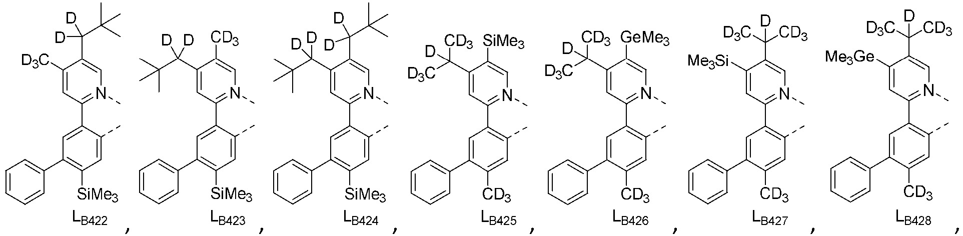 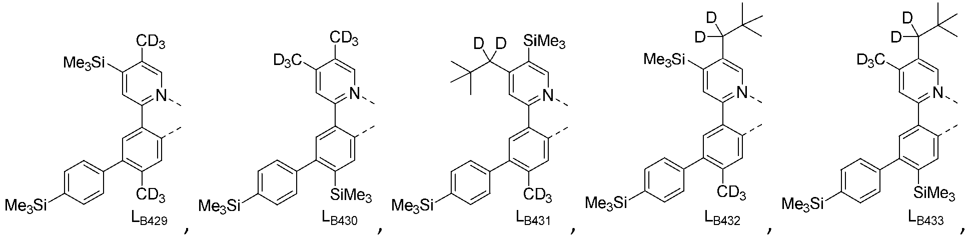 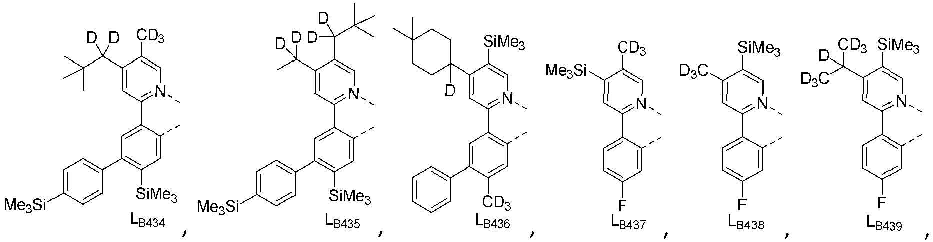 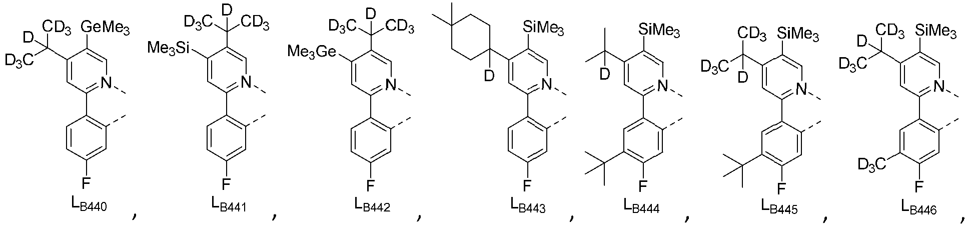 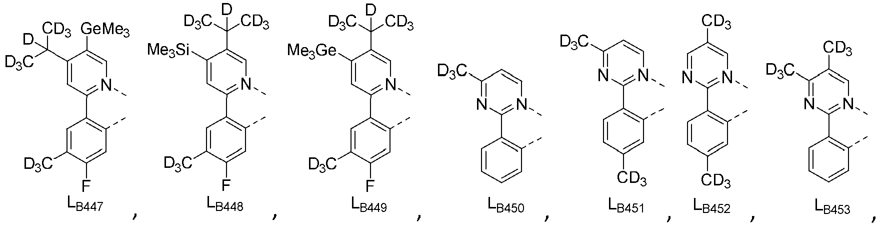 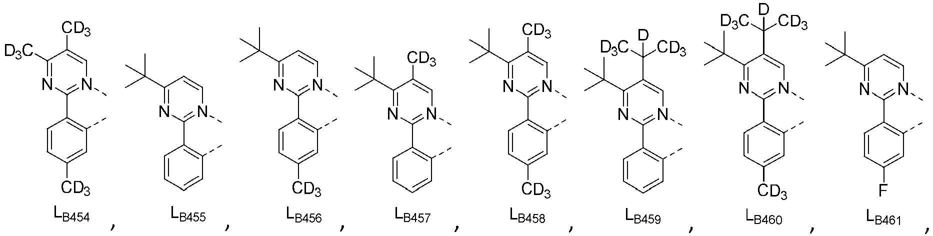 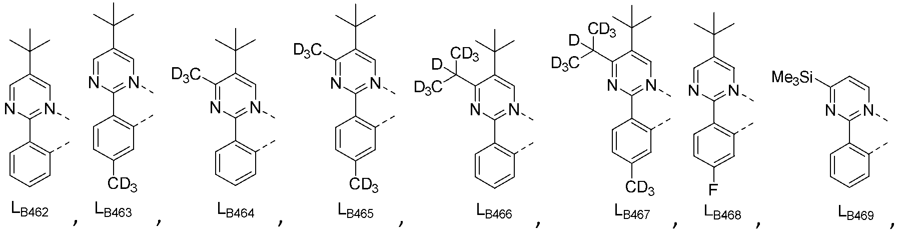 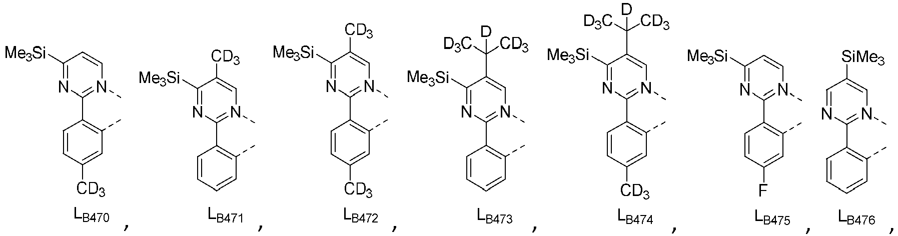 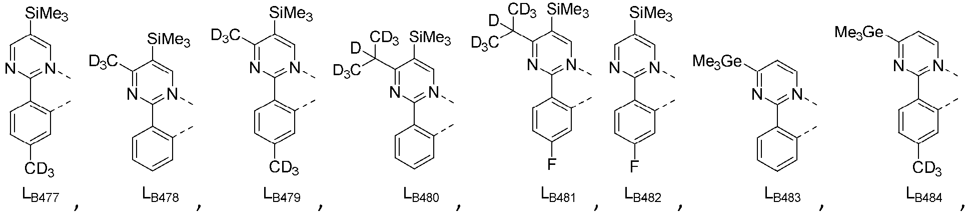 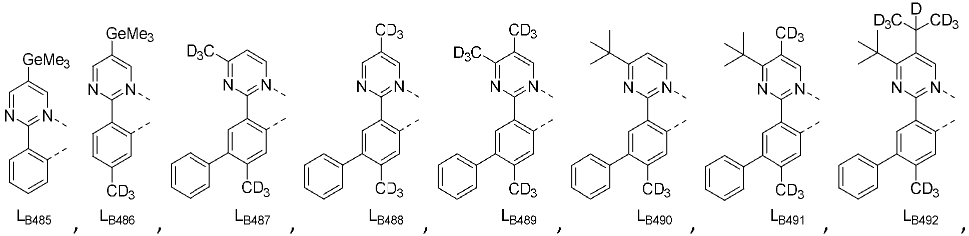 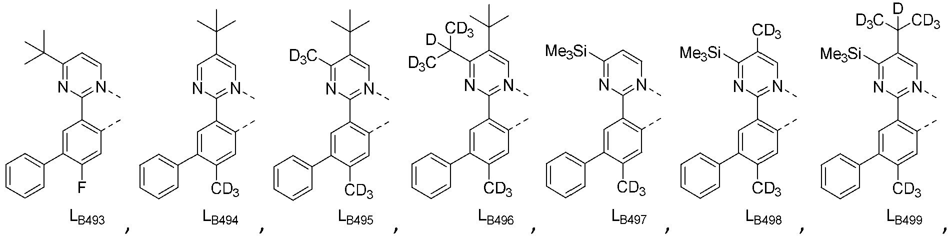 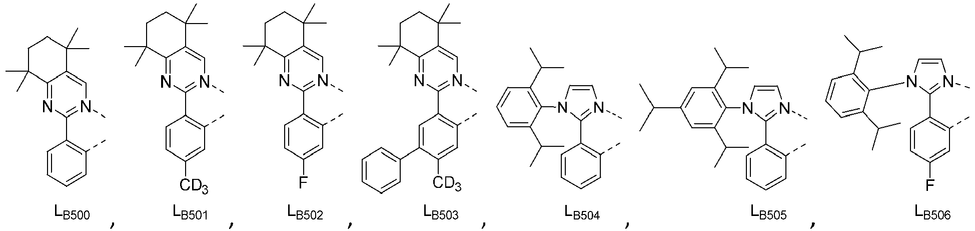 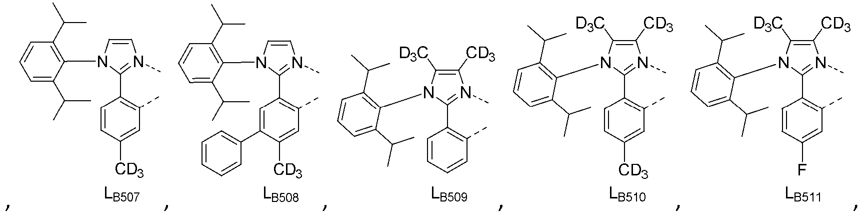 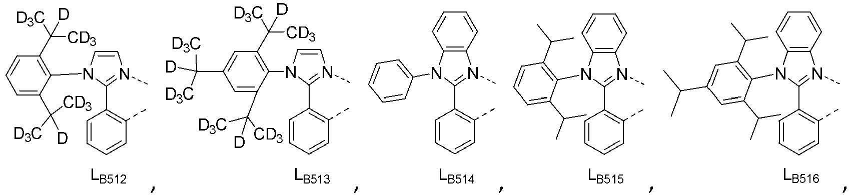 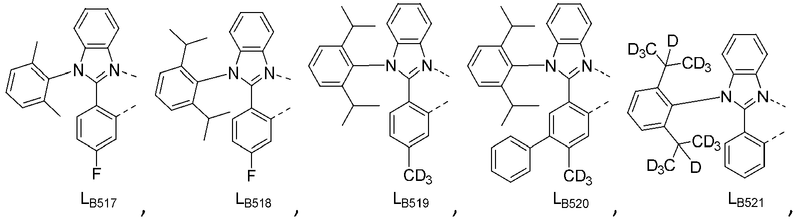 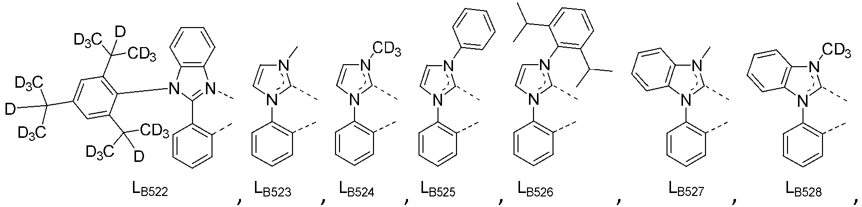 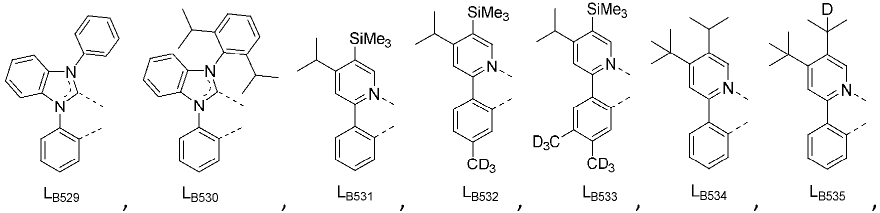 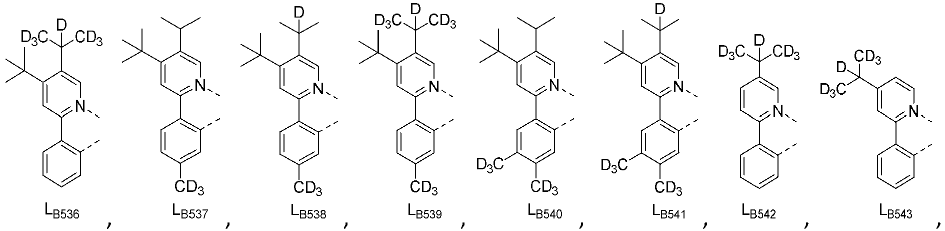 and 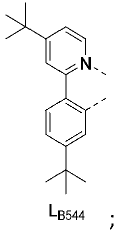 wherein each L_{C*j-*I} has a structure based on formula 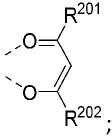 and
each L_{C*j*-II} has a structure based on formula 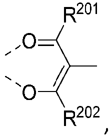 wherein for each L_{C*j*} in L_{C*j*-I} and L_{C*j*-II}, R²⁰¹ and R²⁰² are each independently defined as follows in the following TABLE A:

| **L_{C*j*}** | **R²⁰¹** | **R²⁰²** | **L_{C*j*}** | **R²⁰¹** | **R²⁰²** | **L_{C*j*}** | **R²⁰¹** | **R²⁰²** | **L_{C*j*}** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{D59} | L_{C587} | R^{D143} | R^{D151} |
| L_{C12} | R^{D12} | R^{D12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{D143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{D17} | R^{D87} | L_{C591} | R^{D143} | R^{D175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R^{D17} | R^{D89} | L_{C593} | R^{D144} | R^{D5} |
| L_{C18} | R^{D18} | R^{D18} | L_{C210} | R^{D1} | R^{D54} | L_{C402} | R^{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{D17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{D134} | L_{C601} | R^{D144} | R^{D42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{D143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{D145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{D149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{D145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{D52} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{D59} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{D56} | R^{D56} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{D59} | R^{D59} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{D18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{D145} | R^{D37} |
| L_{C64} | R^{D64} | R^{D64} | L_{C256} | R^{D4} | R^{D50} | L_{C448} | R^{D50} | R^{D118} | L_{C640} | R^{D145} | R^{D40} |
| L_{C65} | R^{D65} | R^{D65} | L_{C257} | R^{D4} | R^{D54} | L_{C449} | R^{D50} | R^{D119} | L_{C641} | R^{D145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{D136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C85} | R^{D85} | R^{D85} | L_{C277} | R^{D4} | R^{D143} | L_{C469} | R^{D55} | R^{D20} | L_{C661} | R^{D145} | R^{D133} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{D43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{D97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{D20} | L_{C485} | R^{D55} | R^{D88} | L_{C677} | R^{D146} | R^{D20} |
| L_{C102} | R^{D102} | R^{D102} | L_{C294} | R^{D9} | R^{D22} | L_{C486} | R^{D55} | R^{D89} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{D104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{D106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D110} | R^{D110} | L_{C302} | R^{D9} | R^{D50} | L_{C494} | R^{D55} | R^{D134} | L_{C686} | R^{D146} | R^{D54} |
| L_{C111} | R^{D111} | R^{D111} | L_{C303} | R^{D9} | R^{D54} | L_{C495} | R^{D55} | R^{D135} | L_{C687} | R^{D146} | R^{D58} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{D59} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{D87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D89} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D93} | L_{C505} | R^{D55} | R^{D155} | L_{C697} | R^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | R^{D146} | R^{D134} |
| L_{C126} | R^{D126} | R^{D126} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D89} | L_{C721} | R^{D133} | R^{D42} |
| L_{C146} | R^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{D59} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C153} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D89} |
| L_{C153} | R^{D158} | R^{D158} | L_{C350} | R^{D10} | R^{D58} | L_{C542} | R^{D116} | R^{D146} | L_{C734} | R^{D133} | R^{D93} |
| L_{C153} | R^{D159} | R^{D159} | L_{C351} | R^{D10} | R^{D59} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | L_{C555} | R^{D143} | R^{D22} | L_{C747} | R^{D133} | R^{D154} |
| L_{C172} | R^{D172} | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | R^{D175} |
| L_{C175} | R^{D175} | R^{D175} | L_{C367} | R^{D10} | R^{D136} | L_{C559} | R^{D143} | R^{D42} | L_{C751} | R^{D175} | R^{D3} |
| L_{C176} | R^{D176} | R^{D176} | L_{C368} | R^{D10} | R^{D143} | L_{C560} | R^{D143} | R^{D43} | L_{C752} | R^{D175} | R^{D5} |
| L_{C177} | R^{D177} | R^{D177} | L_{C369} | R^{D10} | R^{D144} | L_{C561} | R^{D143} | R^{D48} | L_{C753} | R^{D175} | R^{D18} |
| L_{C178} | R^{D178} | R^{D178} | L_{C370} | R^{D10} | R^{D145} | L_{C562} | R^{D143} | R^{D49} | L_{C754} | R^{D175} | R^{D20} |
| L_{C179} | R^{D179} | R^{D179} | L_{C371} | R^{D10} | R^{D146} | L_{C563} | R^{D143} | R^{D54} | L_{C755} | R^{D175} | R^{D22} |
| L_{C180} | R^{D180} | R^{D180} | L_{C372} | R^{D10} | R^{D147} | L_{C564} | R^{D143} | R^{D58} | L_{C756} | R^{D175} | R^{D37} |
| L_{C181} | R^{D181} | R^{D181} | L_{C373} | R^{D10} | R^{D149} | L_{C565} | R^{D143} | R^{D59} | L_{C757} | R^{D175} | R^{D40} |
| L_{C182} | R^{D182} | R^{D182} | L_{C374} | R^{D10} | R^{D151} | L_{C566} | R^{D143} | R^{D78} | L_{C758} | R^{D175} | R^{D41} |
| L_{C183} | R^{D183} | R^{D183} | L_{C375} | R^{D10} | R^{D154} | L_{C567} | R^{D143} | R^{D79} | L_{C759} | R^{D175} | R^{D42} |
| L_{C184} | R^{D184} | R^{D184} | L_{C376} | R^{D10} | R^{D155} | L_{C568} | R^{D143} | R^{D81} | L_{C760} | R^{D175} | R^{D43} |
| L_{C185} | R^{D185} | R^{D185} | L_{C377} | R^{D10} | R^{D161} | L_{C569} | R^{D143} | R^{D87} | L_{C761} | R^{D175} | R^{D48} |
| L_{C186} | R^{D186} | R^{D186} | L_{C378} | R^{D10} | R^{D175} | L_{C570} | R^{D143} | R^{D88} | L_{C762} | R^{D175} | R^{D49} |
| L_{C187} | R^{D187} | R^{D187} | L_{C379} | R^{D17} | R^{D3} | L_{C571} | R^{D143} | R^{D89} | L_{C763} | R^{D175} | R^{D54} |
| L_{C188} | R^{D188} | R^{D188} | L_{C380} | R^{D17} | R^{D5} | L_{C572} | R^{D143} | R^{D93} | L_{C764} | R^{D175} | R^{D58} |
| L_{C189} | R^{D189} | R^{D189} | L_{C381} | R^{D17} | R^{D18} | L_{C573} | R^{D143} | R^{D116} | L_{C765} | R^{D175} | R^{D59} |
| L_{C190} | R^{D190} | R^{D190} | L_{C382} | R^{D17} | R^{D20} | L_{C574} | R^{D143} | R^{D117} | L_{C766} | R^{D175} | R^{D78} |
| L_{C191} | R^{D191} | R^{D191} | L_{C383} | R^{D17} | R^{D22} | L_{C575} | R^{D143} | R^{D118} | L_{C767} | R^{D175} | R^{D79} |
| L_{C192} | R^{D192} | R^{D192} | L_{C384} | R^{D17} | R^{D37} | L_{C576} | R^{D143} | R^{D119} | L_{C768} | R^{D175} | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{D200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C1111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | L_{C1006} | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{D221} | L_{C905} | R^{D1} | R^{D221} | L_{C1013} | R^{D4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{D233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C821} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1038} | R^{D4} | R^{D246} | L_{C1146} | R^{D9} | R^{D246} |
| L_{C823} | R^{D17} | R^{D193} | L_{C931} | R^{D50} | R^{D193} | L_{C1039} | R^{D145} | R^{D193} | L_{C1147} | R^{D168} | R^{D193} |
| L_{C824} | R^{D17} | R^{D194} | L_{C932} | R^{D50} | R^{D194} | L_{C1040} | R^{D145} | R^{D194} | L_{C1148} | R^{D168} | R^{D194} |
| L_{C825} | R^{D17} | R^{D195} | L_{C933} | R^{D50} | R^{D195} | L_{C1041} | R^{D145} | R^{D195} | L_{C1149} | R^{D168} | R^{D195} |
| L_{C826} | R^{D17} | R^{D196} | L_{C934} | R^{D50} | R^{D196} | L_{C1042} | R^{D145} | R^{D196} | L_{C1150} | R^{D168} | R^{D196} |
| L_{C827} | R^{D17} | R^{D197} | L_{C935} | R^{D50} | R^{D197} | L_{C1043} | R^{D145} | R^{D197} | L_{C1151} | R^{D168} | R^{D197} |
| L_{C828} | R^{D17} | R^{D198} | L_{C936} | R^{D50} | R^{D198} | L_{C1044} | R^{D145} | R^{D198} | L_{C1152} | R^{D168} | R^{D198} |
| L_{C829} | R^{D17} | R^{D199} | L_{C937} | R^{D50} | R^{D199} | L_{C1045} | R^{D145} | R^{D199} | L_{C1153} | R^{D168} | R^{D199} |
| L_{C830} | R^{D17} | R^{D200} | L_{C938} | R^{D50} | R^{D200} | L_{C1046} | R^{D145} | R^{D200} | L_{C1154} | R^{D168} | R^{D200} |
| L_{C831} | R^{D17} | R^{D201} | L_{C939} | R^{D50} | R^{D201} | L_{C1047} | R^{D145} | R^{D201} | L_{C1155} | R^{D168} | R^{D201} |
| L_{C832} | R^{D17} | R^{D202} | L_{C940} | R^{D50} | R^{D202} | L_{C1048} | R^{D145} | R^{D202} | L_{C1156} | R^{D168} | R^{D202} |
| L_{C833} | R^{D17} | R^{D203} | L_{C941} | R^{D50} | R^{D203} | L_{C1049} | R^{D145} | R^{D203} | L_{C1157} | R^{D168} | R^{D203} |
| L_{C834} | R^{D17} | R^{D204} | L_{C942} | R^{D50} | R^{D204} | L_{C1050} | R^{D145} | R^{D204} | L_{C1158} | R^{D168} | R^{D204} |
| L_{C835} | R^{D17} | R^{D205} | L_{C943} | R^{D50} | R^{D205} | L_{C1051} | R^{D145} | R^{D205} | L_{C1159} | R^{D168} | R^{D205} |
| L_{C836} | R^{D17} | R^{D206} | L_{C944} | R^{D50} | R^{D206} | L_{C1052} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{D17} | R^{D213} | L_{C951} | R^{D50} | R^{D213} | L_{C1059} | R^{D145} | R^{D213} | L_{C1167} | R^{D168} | R^{D213} |
| L_{C844} | R^{D17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C1171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1068} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{C1076} | R^{D145} | R^{D230} | L_{C1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{C1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1085} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1088} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C1370} | R^{D143} | R^{D200} |
| L_{C1209} | R^{D10} | R^{D201} | L_{C1225} | R^{D55} | R^{D201} | L_{C1317} | R^{D37} | R^{D201} | L_{C1371} | R^{D143} | R^{D201} |
| L_{C1210} | R^{D10} | R^{D202} | L_{C1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | L_{C1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |

wherein R^{D1} to R^{D246} have the following structures as defined in the following LIST 8:

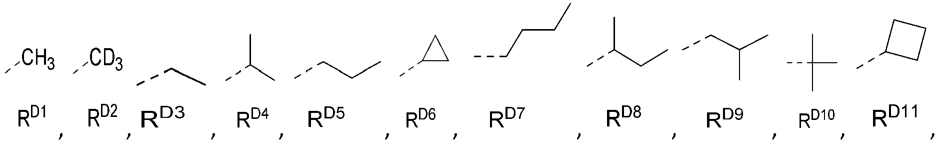

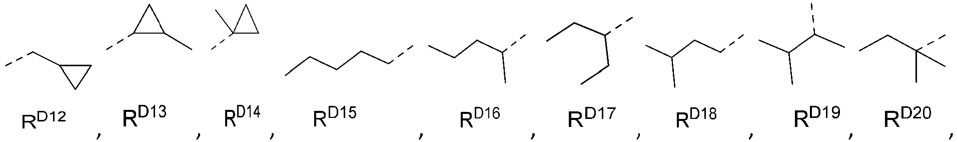

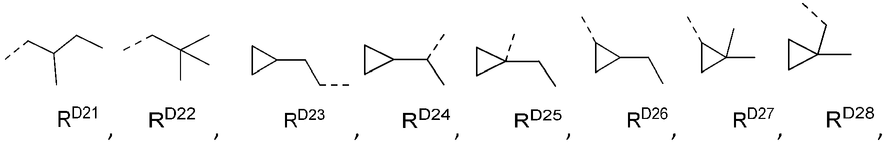

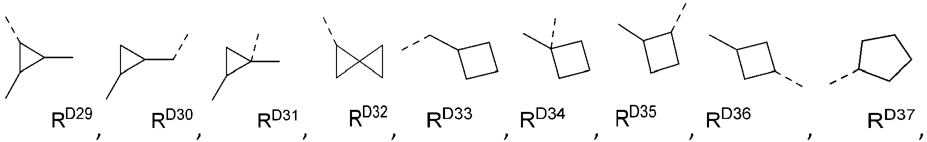

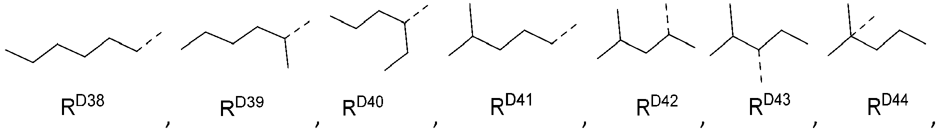

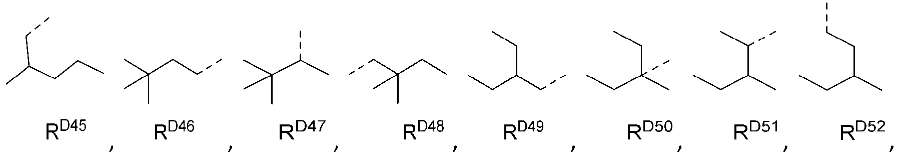

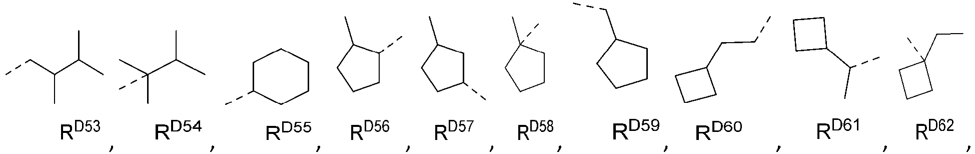

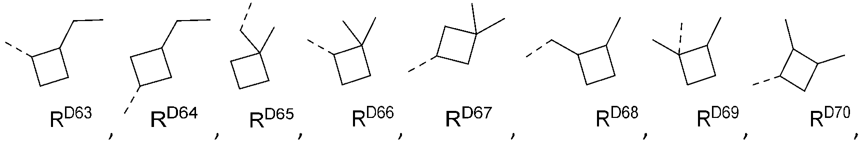

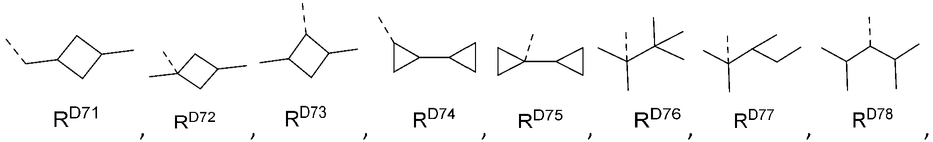

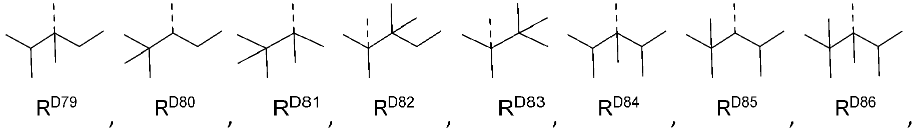

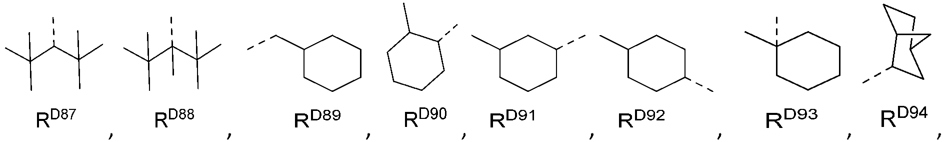

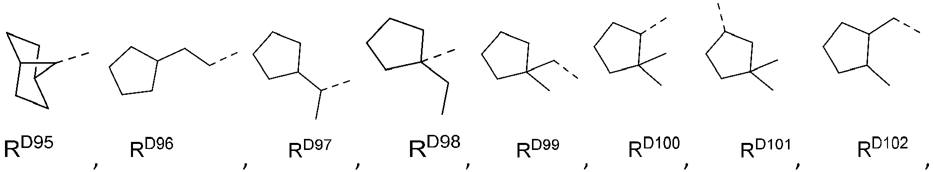

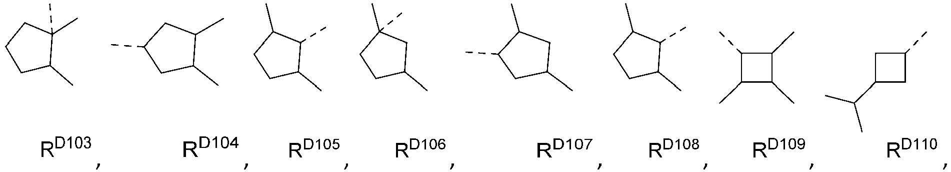

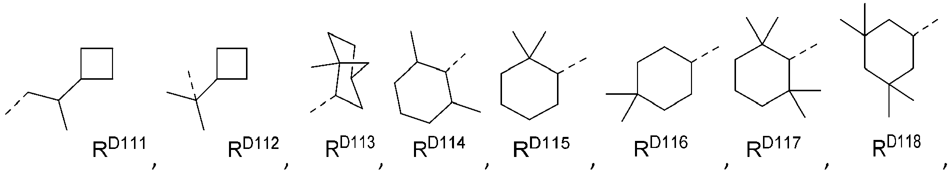

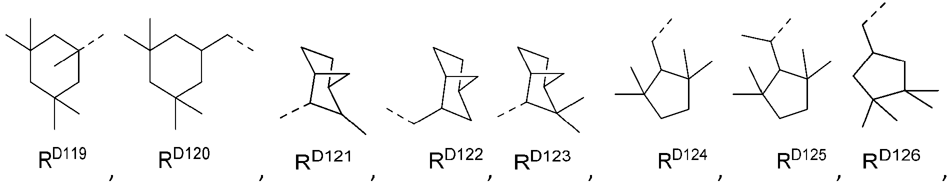

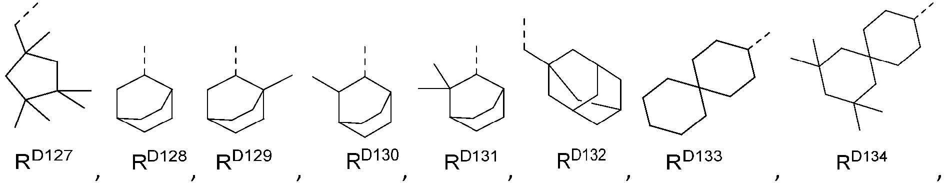

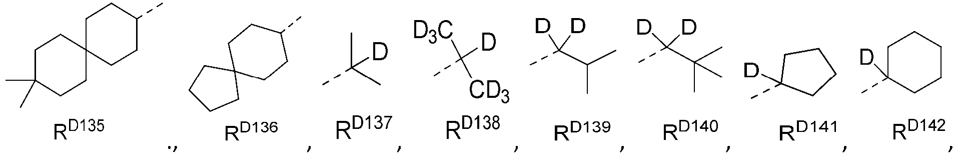

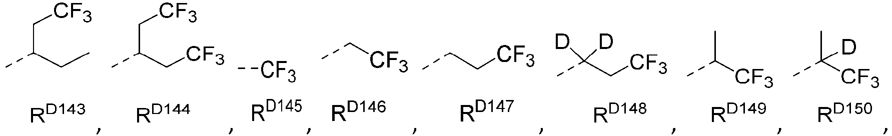

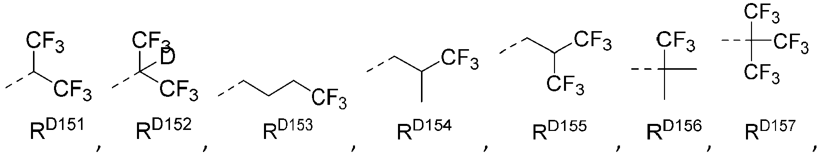

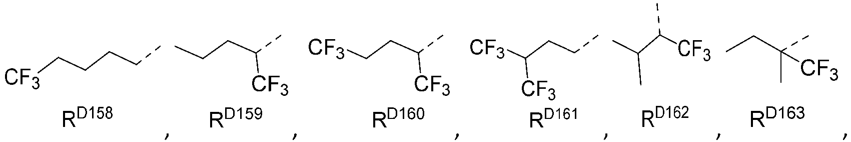

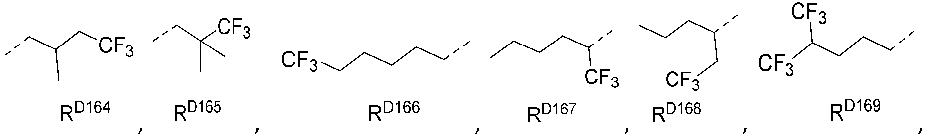

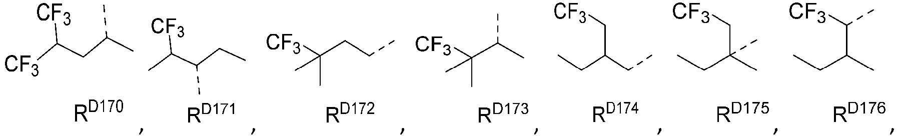

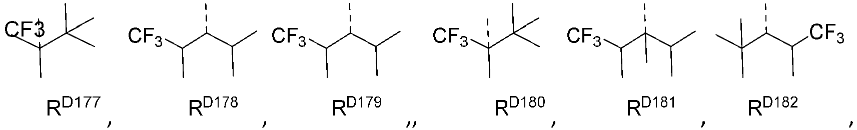

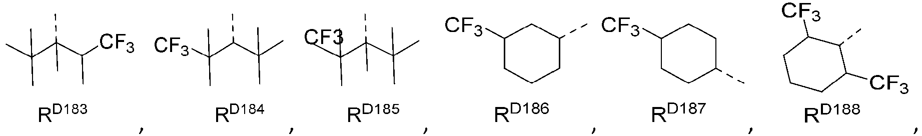

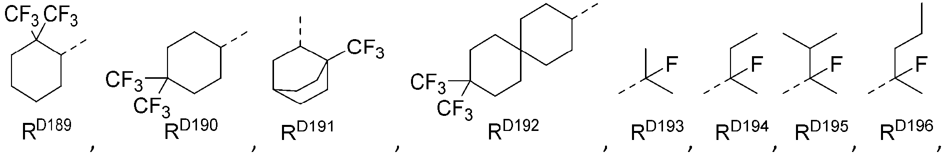

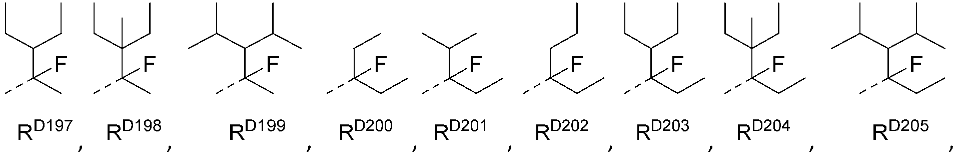

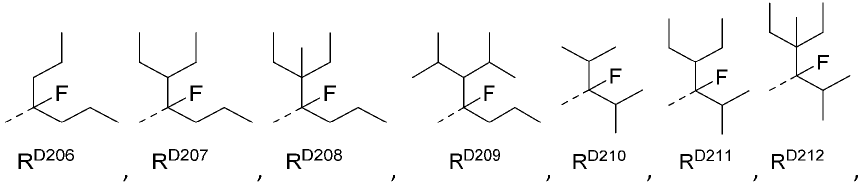

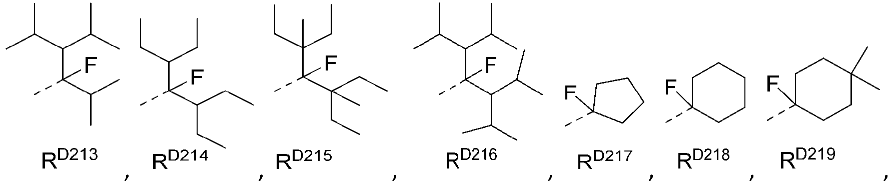

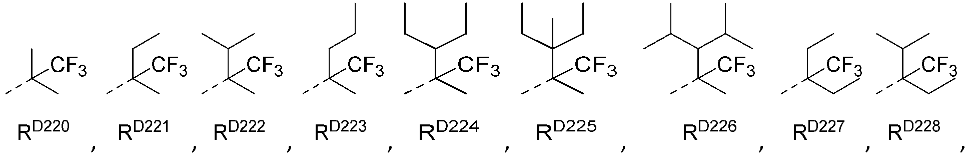

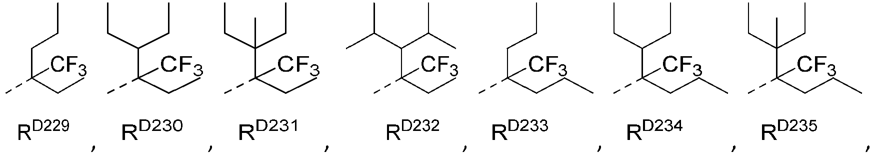

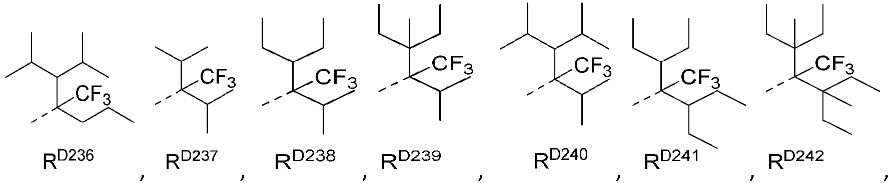

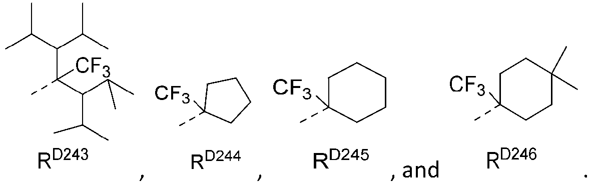

In some embodiments, the compound is selected from the group consisting of only those compounds whose L_{B*k*} corresponds to one of the following: L_{B1}, L_{B30}, L_{B31}, L_{B109}, L_{B110}, L_{B112}, L_{B113}, L_{B114}, L_{B125}, L_{B127}, L_{B138}, L_{B140}, L_{B149}, L_{B150}, L_{B170}, L_{B171}, L_{B172}, L_{B174}, L_{B208}, L_{B241}, L_{B312}, L_{B315}, L_{B356}, L_{B367}, L_{B371}, L_{B382}, L_{B439}, L_{B440}, L_{B455}, L_{B456}, L_{B457}, L_{B458}, L_{B461}, L_{B462}, L_{B463}, L_{B469}, and L_{B476}.

In some embodiments, the compound is selected from the group consisting of only those compounds whose L_{B*k*} corresponds to one of the following: L_{B1}, L_{B30}, L_{B31}, L_{B125}, L_{B138}, L_{B171}, L_{B172}, L_{B356}, L_{B357}, L_{B367}, L_{B371}, L_{B382}, L_{B455}, and L_{B456}.

In some embodiments, the compound is selected from the group consisting of only those compounds having L_{C*j*-I} or L_{C*j*-II} ligand whose corresponding R²⁰¹ and R²⁰² are defined to be one **of** the following structures: R^{D1}, R^{D3}, R^{D4}, R^{D5}, R^{D9}, R^{D10}, R^{D17}, R^{D18}, R^{D20}, R^{D22}, R^{D37}, R^{D40}, R^{D41}, R^{D42}, R^{D43}, R^{D48}, R^{D49}, R^{D50}, R^{D54}, R^{D55}, R^{D58}, R^{D59}, R^{D78}, R^{D79}, R^{D81}, R^{D87}, R^{D88}, R^{D89}, R^{D93}, R^{D116}, R^{D117}, R^{D118}, R^{D119}, R^{D120}, R^{D133}, R^{D134}, R^{D135}, R^{D136}, R^{D143}, R^{D144}, R^{D145}, R^{D146}, R^{D147}, R^{D149}, R^{D151}, R^{D154}, R^{D155}, R^{D161}, R^{D175}, R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having L_{C*j*-I} or L_{C*j*-II} ligand whose corresponding R²⁰¹ and R²⁰² are defined to be one of selected from the following structures R^{D1}, R^{D3}, R^{D4}, R^{D5}, R^{D9}, R^{D10}, R^{D17}, R^{D22}, R^{D43}, R^{D50}, R^{D78}, R^{D116}, R^{D118}, R^{D133}, R^{D134}, R^{D135}, R^{D136}, R^{D143}, R^{D144}, R^{D145}, R^{D146}, R^{D149}, R^{D151}, R^{D154}, R^{D155}, R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having one of the following structures for the L_{C*j*-I} ligand ads defined in the following LIST 7:

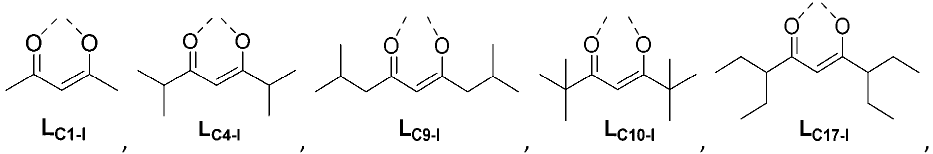

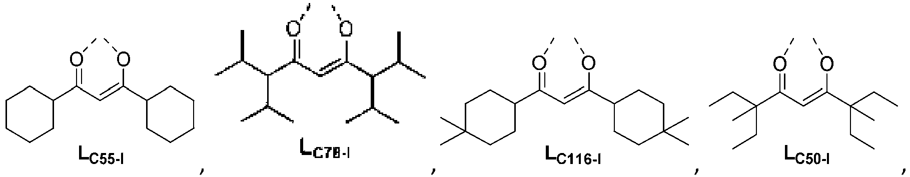

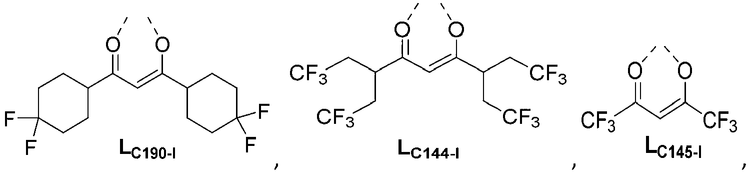

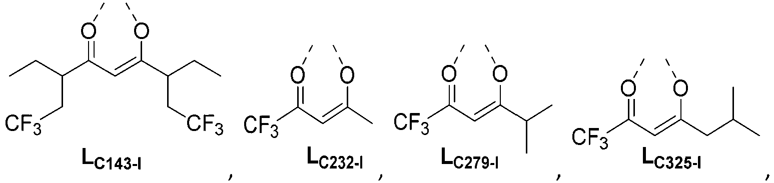

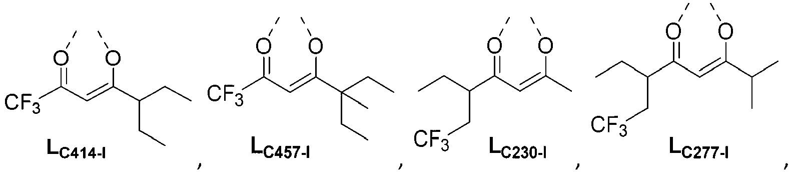

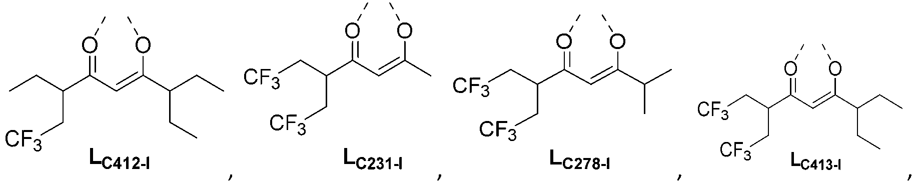

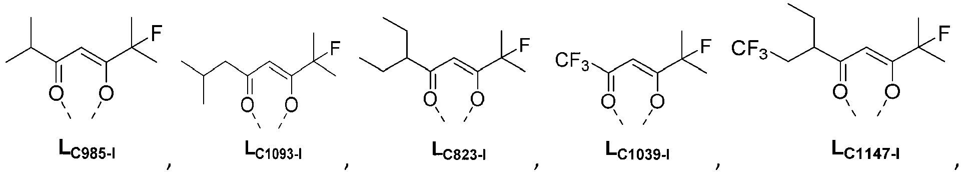

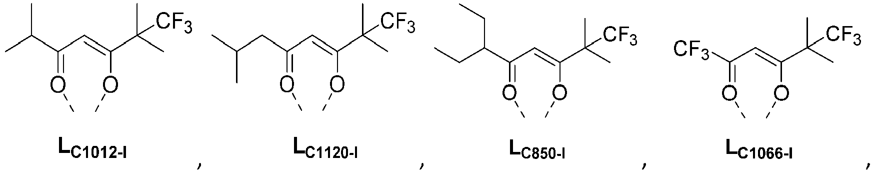

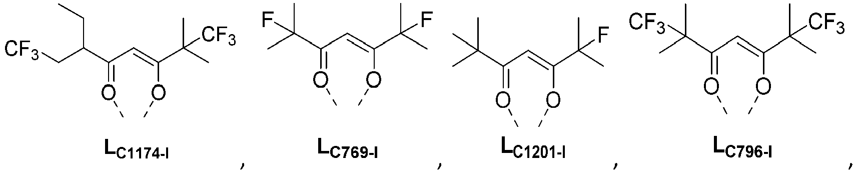

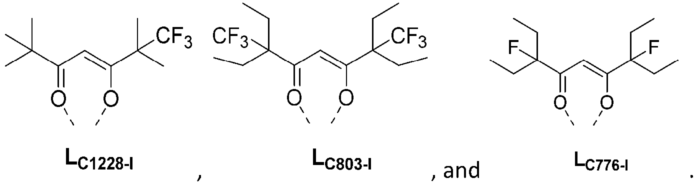

In some embodiments, the compound has a formula selected from the group consisting of Ir(L_{A})₃, Ir(L_{A})₂(L_{B}), Ir(L_{A})(L_{B})₂, Ir(L_{A})₂(L_{C}), and Ir(L_{A})(L_{B})(L_{C}). In some embodiments, L_{A} is selected from the group consisting of the structures of LIST 1, LIST 2, and LIST 3, L_{B} is selected from the group consisting of the structures of LIST 4, LIST 5, and LIST 6 (L_{Bk}), and L_{C} is selected from the group consisting of the structures of L_{C*j*-I} and L_{C*j*-II} as defined in LIST 7.

In some embodiments, L_{A} is selected from the group consisting of the structures of LIST 1 and L_{B} is selected from the group consisting of the structures of L_{Bk}. In some embodiments, L_{A} is selected from the group consisting of the structures of LIST 2 and L_{B} is selected from the group consisting of the structures of L_{Bk}. In some embodiments, L_{A} is selected from LIST 3 defined herein, and L_{B} is selected from the group consisting of the structures of L_{Bk} wherein k is an integer from 1 to 544. In some embodiments, L_{A} is selected from LIST 1 defined herein, and L_{C} is selected from the group consisting of the structures of L_{C*j*-I} and L_{C*j*-II} wherein j is an integer from 1 to 1416.

In some embodiments, the compound can have the formula Ir(L_{A}W1-(R*i*)(R*j*)(R*k*)(R*l*))₃ consisting of the compounds of Ir(L_{A}1-(V1)(V1)(V1)(V1))₃ to Ir(L_{A}263-(V263)(V263)(V263)(V263))₃, Ir(L_{A}265-(V1)(V1)(V1)(V1))₃ to Ir(L_{A}265-(V263)(V263)(V263)(V263))₃, Ir(L_{A}267-(V1)(V1)(V1)(V1))₃ to Ir(L_{A}280-(V263)(V263)(V263)(V263))₃, Ir(L_{A}282-(V1)(V1)(V1)(V1))₃ to Ir(L_{A}282-(V263)(V263)(V263)(V263))₃, and Ir(L_{A}284-(V1)(V1)(V1)(V1))₃ to Ir(L_{A}489-(V263)(V263)(V263)(V263))₃, the formula Ir(L_{A}W1-(R*i*)(R*j*)(R*k*)(R*l*))(L_{B*k*})₂ consisting of the compounds of Ir(L_{A}1-(V1)(V1)(V1)(V1))(L_{B1})₂ to Ir(L_{A}263-(V263)(V263)(V263)(V263))(L_{B544})₂, Ir(L_{A}265-(V1)(V1)(V1)(V1))(L_{B1})₂ to Ir(L_{A}265-(V263)(V263)(V263)(V263))(L_{B544})₂, Ir(L_{A}267-(V1)(V1)(V1)(V1))(L_{B1})₂ to Ir(L_{A}280-(V263)(V263)(V263)(V263))(L_{B544})₂, Ir(L_{A}282-(V1)(V1)(V1)(V1))(L_{B1})₂ to Ir(L_{A}282-(V263)(V263)(V263)(V263))(L_{B544})₂, and Ir(L_{A}284-(V1)(V1)(V1)(V1))(L_{B1})₂ to Ir(L_{A}489-(V263)(V263)(V263)(V263))(L_{B544})₂, the formula Ir(L_{A}W1-(R*i*)(R*j*)(R*k*)(R*l*))₂(L_{Bk}) consisting of the compounds of Ir(L_{A}1-(V1)(V1)(V1)(V1))₂(L_{B1}) to Ir(L_{A}263-(V263)(V263)(V263)(V263))₂(L_{B544}), Ir(L_{A}265-(V1)(V1)(V1)(V1))₂(L_{B1}) to Ir(L_{A}265-(V263)(V263)(V263)(V263))₂(L_{B544}), Ir(L_{A}267-(V1)(V1)(V1)(V1))₂(L_{B1}) to Ir(L_{A}280-(V263)(V263)(V263)(V263))₂(L_{B544}), Ir(L_{A}282-(V1)(V1)(V1)(V1))₂(L_{B1}) to Ir(L_{A}282-(V263)(V263)(V263)(V263))₂(L_{B544}), and Ir(L_{A}284-(V1)(V1)}(V1)(V1))₂(L_{B1}) to Ir(L_{A}489-(V263)(V263)(V263)(V263))₂(L_{B544}), the formula Ir(L_{A}W1-(R*i*)(R*j*)(R*k*)(R*l*))₂(L_{C*j-I*}) consisting of the compounds of Ir(L_{A}1-(V1)(V1)(V1)(V1))₂(L_{C*1-I*}) to Ir(L_{A}263-(V263)(V263)(V263)(V263))₂(L_{C*1416-I*}), Ir(L_{A}265-(V1)(V1)(V1)(V1))₂(L_{C*1-I*}) to Ir(L_{A}265-(V263)(V263)(V263)(V263))₂(L_{C*1416-I*}), Ir(L_{A}267-(V1)(V1)(V1)(V1))₂(L_{C*1-I*}) to Ir(L_{A}280-(V263)(V263)(V263)(V263))₂(L_{C*1416-I*}), Ir(L_{A}282-(V1)(V1)(V1)(V1))₂(L_{C*1-I*}) to Ir(L_{A}282-(V263)(V263)(V263)(V263))₂(L_{C*1416-I*}), and Ir(L_{A}284-(V1)(V1)(V1)(V1))₂(L_{C*1-I*}) to Ir(L_{A}489-(V263)(V263)(V263)(V263))₂(L_{C*1416-I*}), the formula Ir(L_{A}W1-(R*i*)(R*j*)(R*k*)(R*l*))₂(L_{C*j-II*}) consisting of the compounds of Ir(L_{A}1-(V1)(V1)(V1)(V1))₂(L_{C*1-II*}) to Ir(L_{A}263-(V263)(V263)(V263)(V263))₂(L_{C*1416-II*}), Ir(L_{A}265-(R1)(R1)(R1)(R1))₂(L_{C*1-II*}) to Ir(L_{A}265-(V263)(V263)(V263)(V263))₂(L_{C*1416-II*}), Ir(L_{A}267-(R1)(R1)(R1)(R1))₂(L_{C*1-II*}) to Ir(L_{A}280-(V263)(V263)(V263)(V263))₂(L_{C*1416-II*}), Ir(L_{A}282-(R1)(R1)(R1)(R1))₂(L_{C*1-II*}) to Ir(L_{A}282-(V263)(V263)(V263)(V263))₂(L_{C*1416-II*}), and Ir(L_{A}284-(R1)(R1)(R1)(R1))₂(L_{C*1-II*}) to Ir(L_{A}489-(V263)(V263)(V263)(V263))₂(L_{C*1416-II*}), the formula Ir(L_{A}W1-(R*i*)(R*j*)(R*k*)(R*l*))(L_{B*k*})(L_{C*j-I*}) consisting of the compounds of Ir(L_{A}1-(V1)(V1)(V1)(V1))(L_{B1})(L_{C*1-I*}) to Ir(L_{A}263-(V263)(V263)(V263)(V263))(L_{B544})(L_{C*1416*-*I*}), Ir(L_{A}265-(V1)(V1)(V1)(V1))(L_{B1})(L_{C*1-I*}) to Ir(L_{A}265-(V263)(V263)(V263)(V263))(L_{B544})(L_{C*1416-I*}), Ir(L_{A}267-(V1)(V1)(V1)(V1))(L_{B1})(L_{C*1-I*}) to Ir(L_{A}280-(V263)(V263)(V263)(V263))(L_{B544})(L_{C*1416-I*}), Ir(L_{A}282-(V1)(V1)(V1)(V1))(L_{B1})(L_{C*1-I*}) to Ir(L_{A}282-(V263)(V263)(V263)(V263))(L_{B544})(L_{C*1416-I*}), and Ir(L_{A}284-(V1)(V1)(V1)(V1))(L_{B1})(L_{C*1-I*}) to Ir(L_{A}489-(V263)(V263)(V263)(V263))(L_{B544})(L_{C*1416-I*}), or the formula lr(L_{A}W1-(R*i*)(R*j*)(R*k*)(R*l*))(L_{B*k*})(L_{C*j-II*}) consisting of the compounds of Ir(L_{A}1-(V1)(V1)(V1)(V1))(L_{B1})(L_{C*1-II*}) to Ir(L_{A}263-(V263)(V263)(V263)(V263))(L_{B544})(L_{C*1416-II*}), Ir(L_{A}265-(V1)(V1)(V1)(V1))(L_{B1})(L_{C*1-II*}) to Ir(L_{A}265-(V263)(V263)(V263)(V263))(L_{B544})(L_{C*1416-II*}), Ir(L_{A}267-(V1)(V1)(V1)(V1))(L_{B1})(L_{C*1-II*}) to Ir(L_{A}280-(V263)(V263)(V263)(V263))(L_{B544})(L_{C*1416-II*}), Ir(L_{A}282-(V1)(V1)(V1)(V1))(L_{B1})(L_{C*1-II*}) to Ir(L_{A}282-(V263)(V263)(V263)(V263))(L_{B544})(L_{C*1416*-*II*}), and Ir(L_{A}284-(V1)(V1)(V1)(V1))(L_{B1})(L_{C*1-II*}) to Ir(L_{A}489-(V263)(V263)(V263)(V263))(L_{B544})(L_{C*1416-II*}), wherein L_{A}W1-(R*i*)(R*j*)(R*k*)(R*l*), L_{Bk}, and L_{C*j-I*} and *L*_{C*j-II*} are all defined herein.

In some embodiments, the compound can have the formula Ir(L_{A}W2-R*j*)(R*k*)(R*l*))₃ consisting of the compounds of Ir(L_{A}264-(V1)(V1)(V1))₃ to Ir(L_{A}264-(V263)(V263)(V263))₃, Ir(L_{A}266-(V1)(V1)(V1))₃ to Ir(L_{A}266-(V263)(V263)(V263))₃, Ir(L_{A}281-(V1)(V1)(V1))₃ to Ir(L_{A}281-(V263)(V263)(V263))₃, Ir(L_{A}283-(V1)(V1)(V1))₃ to Ir(L_{A}283-(V263)(V263)(V263))₃, the formula Ir(L_{A}W2-(R*j*)(R*k*)(R*l*))(L_{B*k*})₂ consisting of the compounds of Ir(L_{A}264-(V1)(V1)(V1))(L_{B1})₂ to Ir(L_{A}264-(V263)(V263)(V263))(L_{B544})₂, Ir(L_{A}266-(V1)(V1)(V1))(L_{B1})₂ to Ir(L_{A}266-(V263)(V263)(V263))(L_{B544})₂, Ir(L_{A}281-(V1)(V1)(V1))(L_{B1})₂ to Ir(L_{A}281-(V263)(V263)(V263))(L_{B544})₂, and Ir(L_{A}283-(V1)(V1)(V1))(L_{B1})₂ to Ir(L_{A}283-(V263)(V263)(V263))(L_{B544})₂, the formula Ir(L_{A}W2-(R*j*)(R*k*)(R*l*))₂(L_{Bk}) consisting of the compounds of Ir(L_{A}264-(V1)(V1)(V1))₂(L_{B1}) to Ir(L_{A}264-(V263)(V263)(V263))₂(L_{B544}), Ir(L_{A}266-(V1)(V1)(V1))₂(L_{B1}) to Ir(L_{A}266-(V263)(V263)(V263))₂(L_{B544}), Ir(L_{A}281-(V1)(V1)(V1))₂(L_{B1}) to Ir(L_{A}281-(V263)(V263)(V263))₂(L_{B544}), and Ir(L_{A}283-(V1)(V1)(V1))₂(L_{B1}) to Ir(L_{A}283-(V263)(V263)(V263))₂(L_{B544}), the formula Ir(L_{A}W2-(R*j*)(R*k*)(R*l*))₂(L_{C*j-I*}) consisting of the compounds of Ir(L_{A}264-(V1)(V1)(V1))₂(L_{C*1-I*}) to Ir(L_{A}264-(V263)(V263)(V263))₂(L_{C*1416-I*}), Ir(L_{A}266-(V1)(V1)(V1))₂(L_{C*1-I*}) to Ir(L_{A}266-(V263)(V263)(V263))₂(L_{C*1416-I*}), Ir(L_{A}281-(V1)(V1)(V1))₂(L_{C*1-I*}) to Ir(L_{A}281-(V263)(V263)(V263))₂(L_{C*1416-I*}), and Ir(L_{A}283-(V1)(V1)(V1))₂(L_{C*1-I*}) to Ir(L_{A}283-(V263)(V263)(V263))₂(L_{C*1416-I*)}, the formula Ir(L_{A}W2-(R*j*)(R*k*)(R*l*))₂(L_{C*j-II*}) consisting of the compounds of Ir(L_{A}264-(V1)(V1)(V1))₂(L_{C*1-II*}) to Ir(L_{A}264-(V263)(V263)(V263))₂(L_{C*1416-II*}), Ir(L_{A}266-(V1)(V1)(V1))₂(L_{C*1-II*}) to Ir(L_{A}266-(V263)(V263)(V263))₂(L_{C*1416*-*II*}), Ir(L_{A}281-(V1)(V1)(V1))₂(L_{C*1-II*}) to Ir(L_{A}281-(V263)(V263)(V263))₂(L_{C*1416*-*II*}), and Ir(L_{A}283-(V1)(V1)(V1))₂(L_{C*1-II*}) to Ir(L_{A}283-(V263)(V263)(V263))₂(L_{C*1416-II*}), the formula Ir(L_{A}W2-(R*j*)(R*k*)(R*l*))(L_{B*k*})(L_{C*j-I*}) consisting of the compounds of Ir(L_{A}264-(V1)(V1)(V1))(L_{B1})(L_{C*1-I*}) to Ir(L_{A}264-(V263)(V263)(V263))(L_{B544})(L_{C*1416-I*}), Ir(L_{A}266-(V1)(V1)(V1))(L_{B1})(L_{C*1-I*}) to Ir(L_{A}266-(V263)(V263)(V263))(L_{B544})(L_{C*1416-I*}), Ir(L_{A}281-(V1)(V1)(V1))(L_{B1})(L_{C*1-I*}) to Ir(L_{A}281-(V263)(V263)(V263))(L_{B544})(L_{C*1416-I*}), and Ir(L_{A}283-(V1)(V1)(V1))(L_{B1})(L_{C*1*-*I*}) to Ir(L_{A}283-(V263)(V263)(V263))(L_{B544})(L_{C*1416-I*}), or the formula Ir(L_{A}W2-(R*j*)(R*k*)(R*l*))(L_{B*k*})(L_{C*j-II*}) consisting of the compounds of Ir(L_{A}264-(V1)(V1)(V1))(L_{B1})(L_{C*1-II*}) to Ir(L_{A}264-(V263)(V263)(V263))(L_{B544})(L_{C*1416-II*}), Ir(L_{A}266-(V1)(V1)(V1))(L_{B1})(L_{C*1-II*}) to Ir(L_{A}266-(V263)(V263)(V263))(L_{B544})(L_{C*1416-II*}), Ir(L_{A}281-(V1)(V1)(V1))(L_{B1})(L_{C*1-II*}) to Ir(L_{A}281-(V263)(V263)(V263))(L_{B544})(L_{C*1416-II*}), and Ir(L_{A}283-(V1)(V1)(V1))(L_{B1})(L_{C*1-II*}) to Ir(L_{A}283-(V263)(V263)(V263))(L_{B544})(L_{C*1416-II*}), wherein L_{A}W2-(R*j*)(R*k*)(R*l*), L_{B*k*}, and L_{C*j-I*} and L_{C*j-II*} are all defined herein.

In some embodiments, the compound is selected from the group consisting of the structures from the following LIST 9: 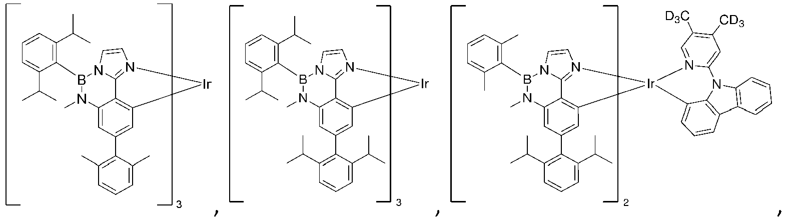 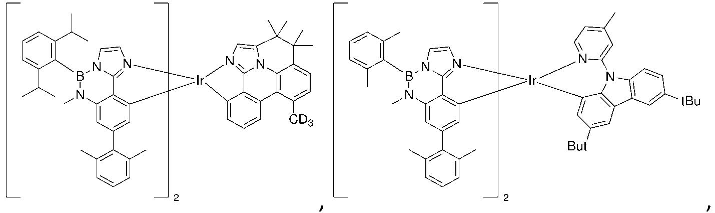 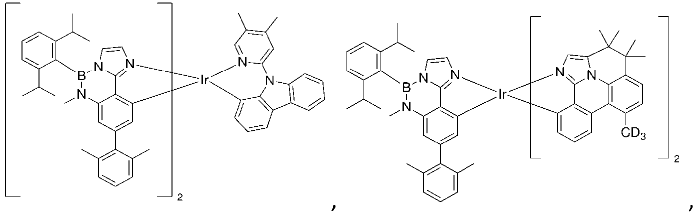 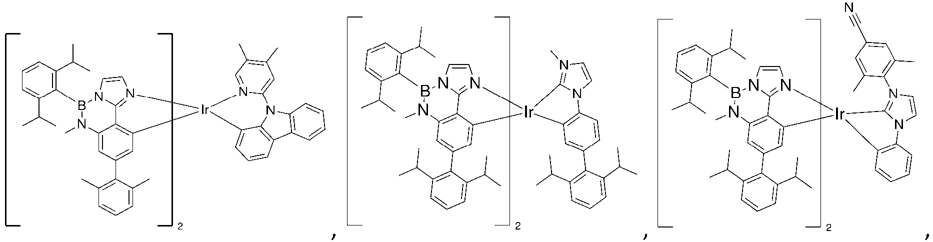 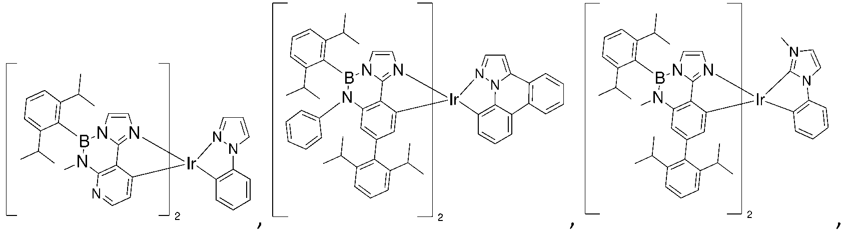 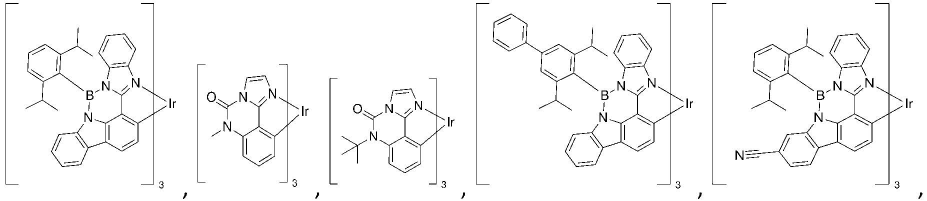 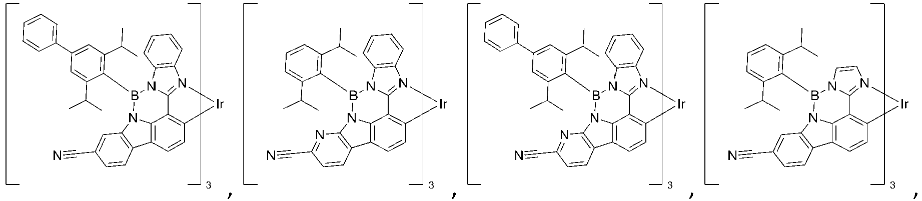 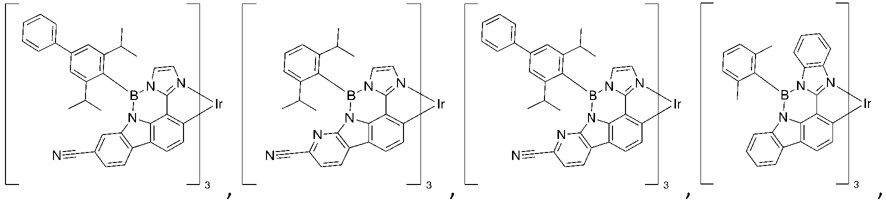 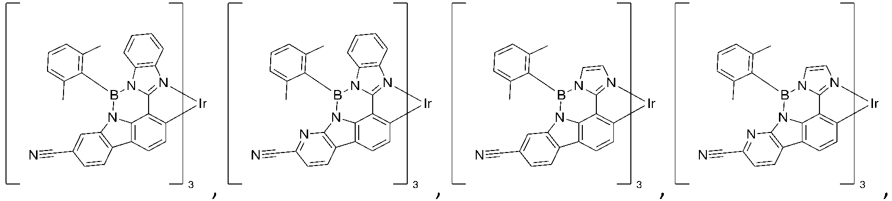 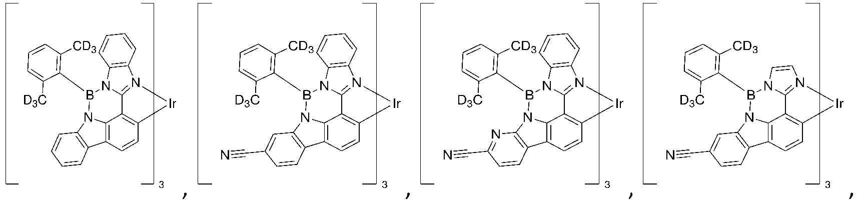 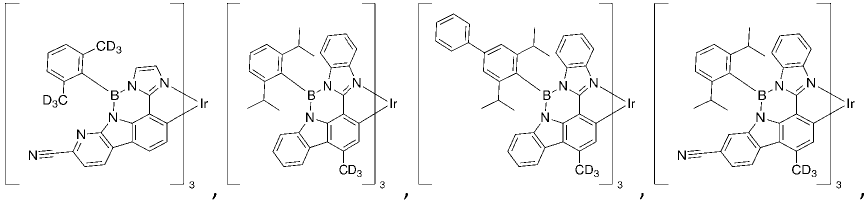 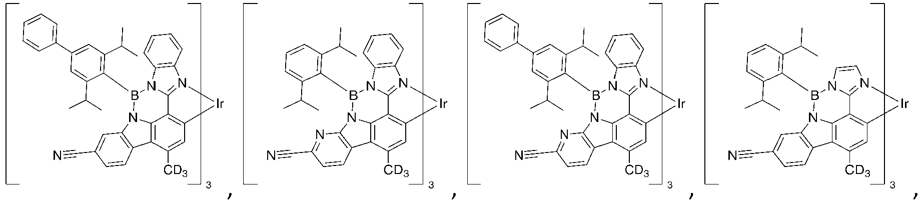 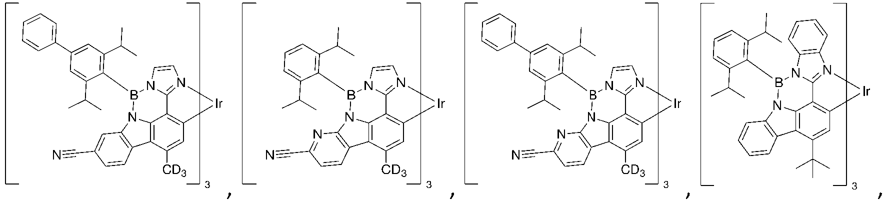 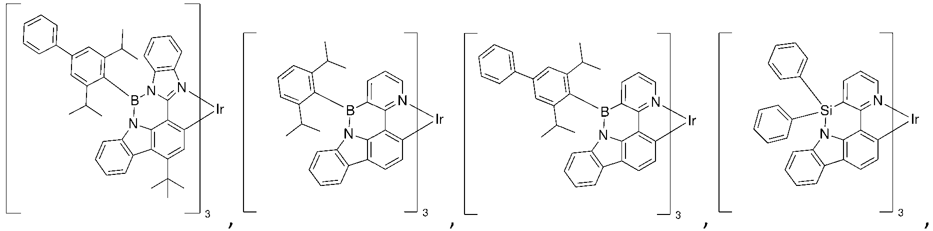 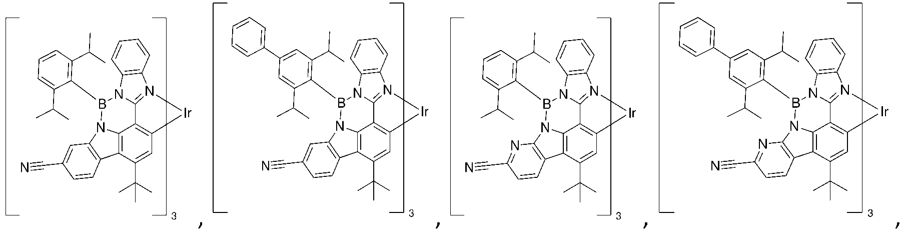 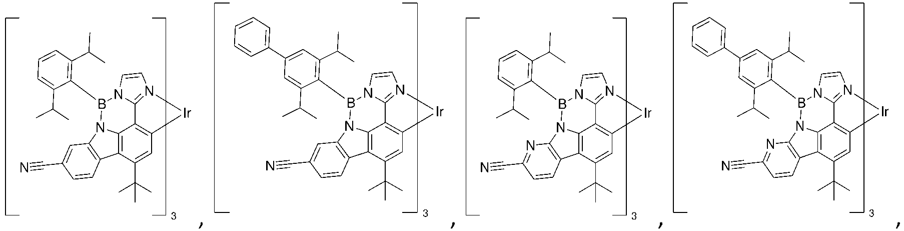 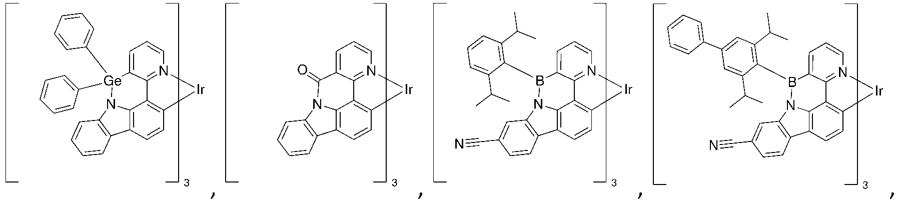 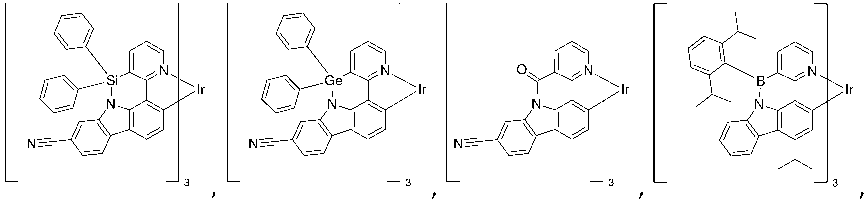 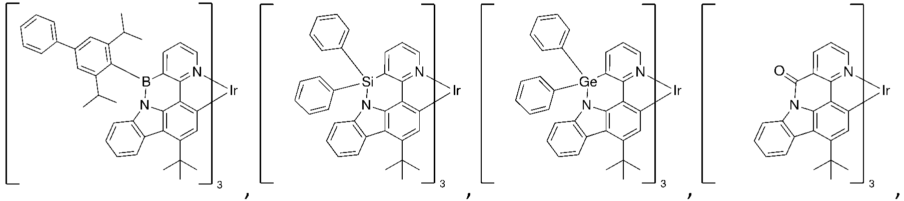 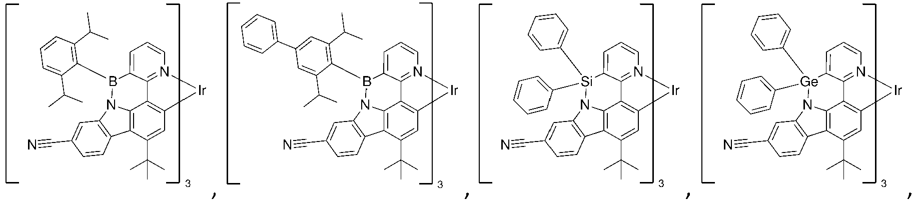 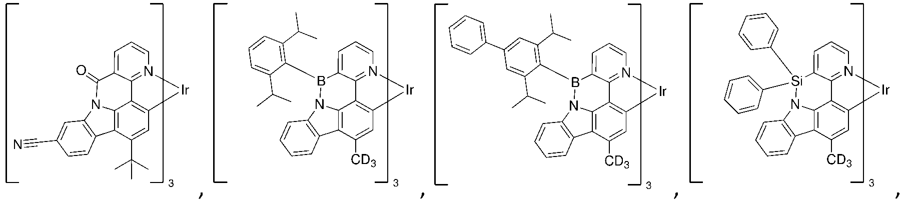 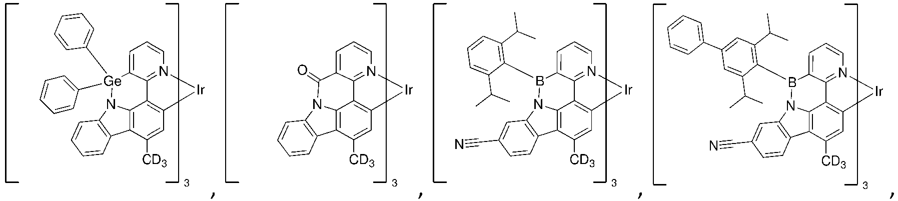 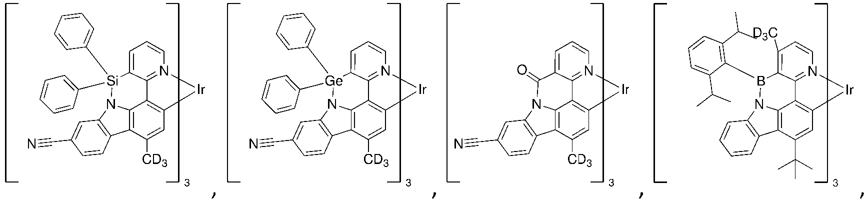 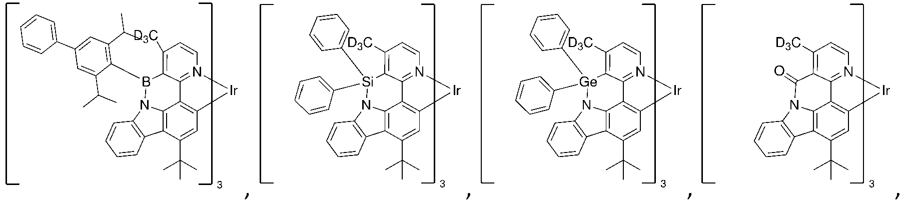 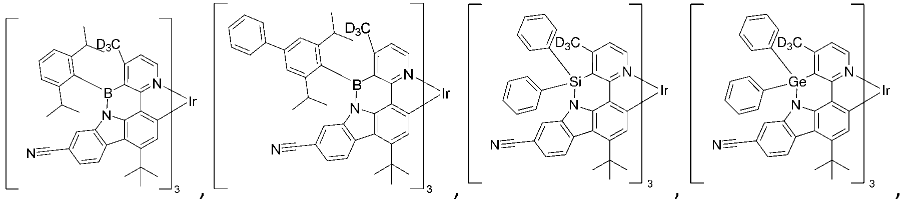 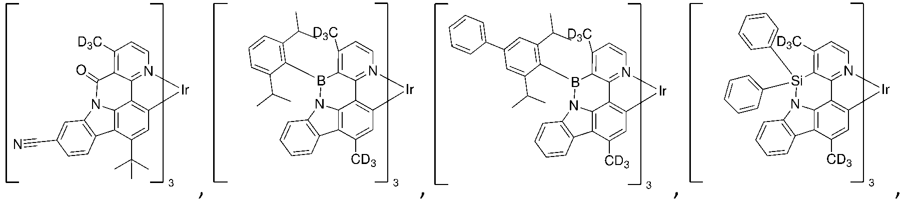 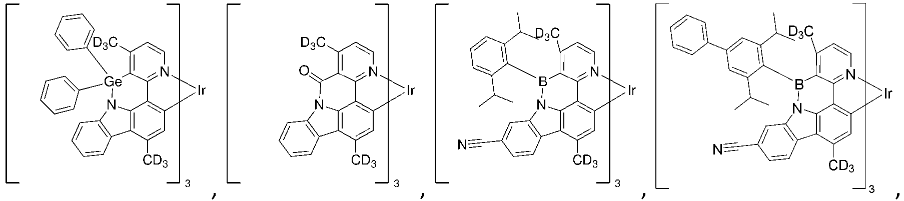 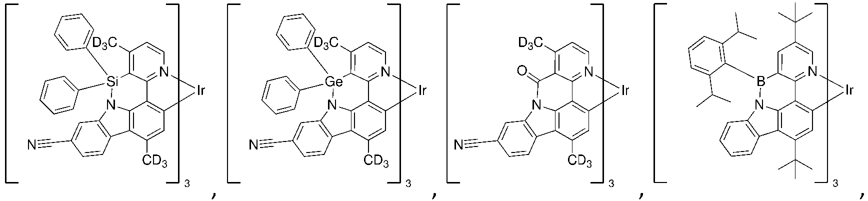 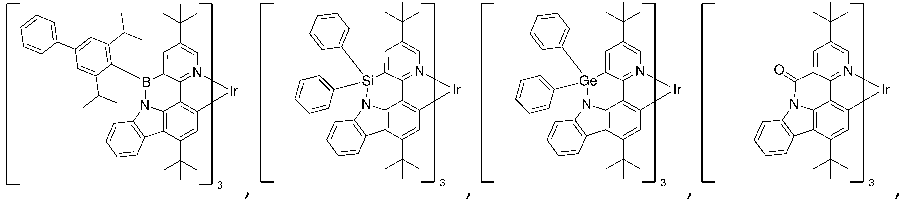 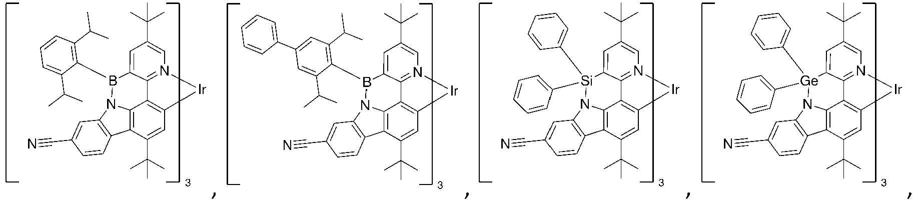 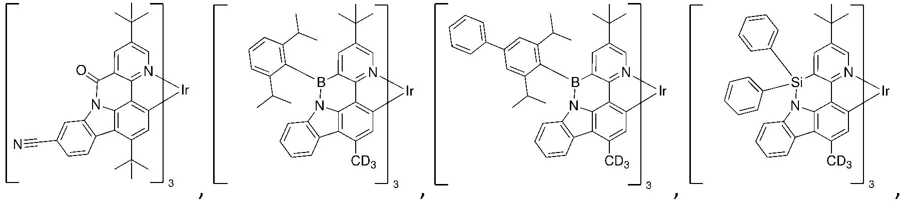 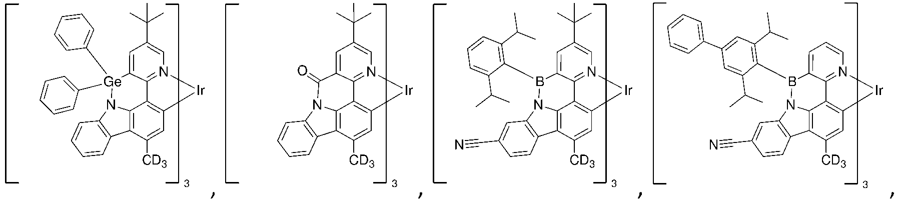 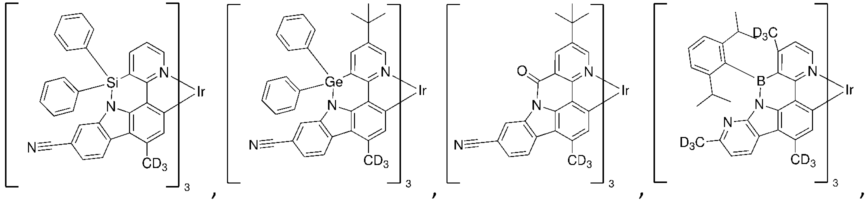 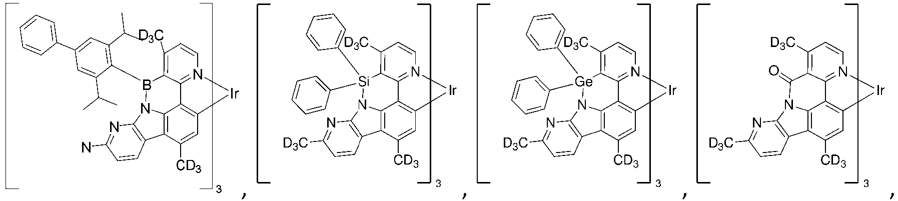 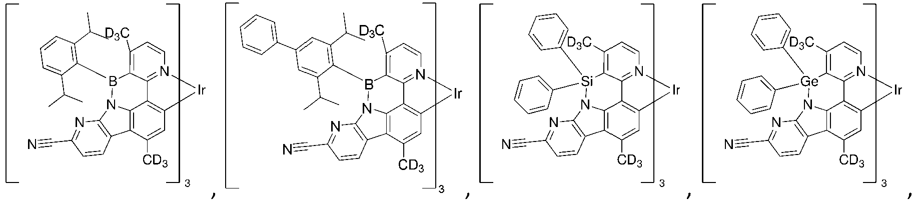 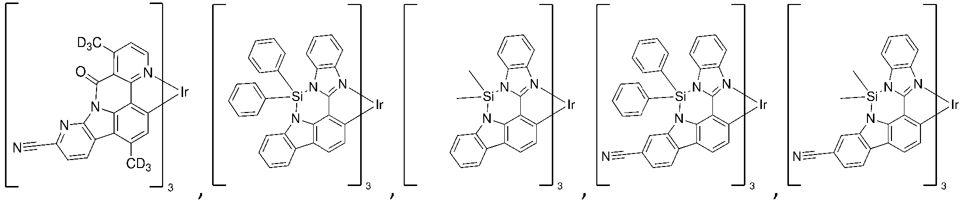 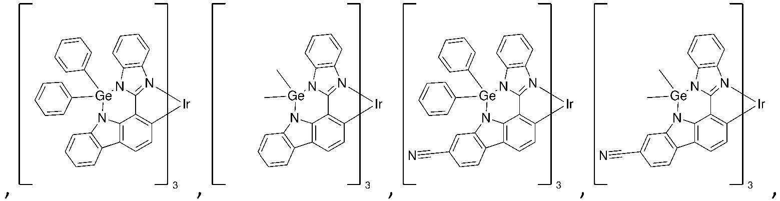 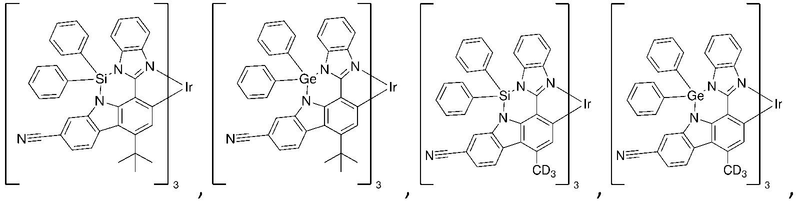 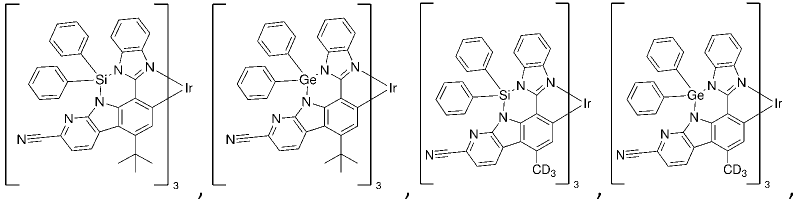 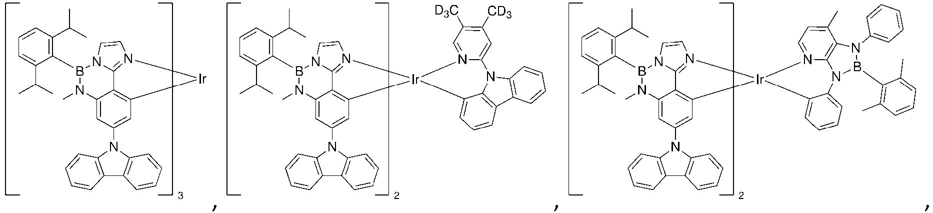 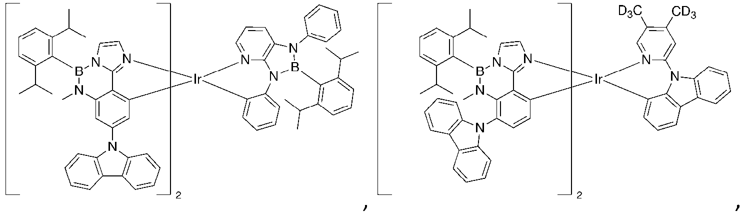 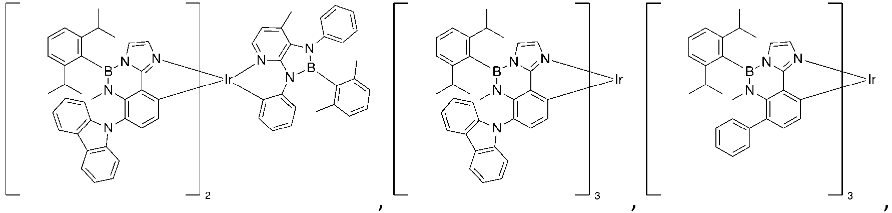 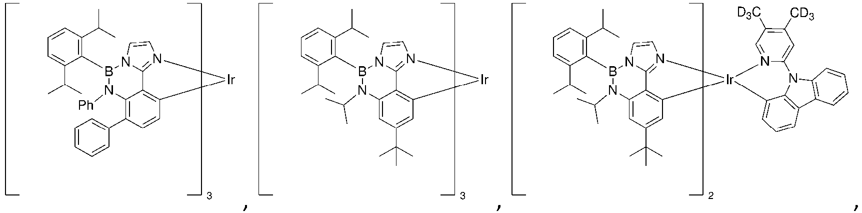 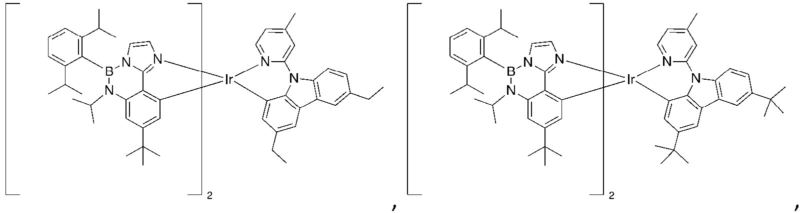 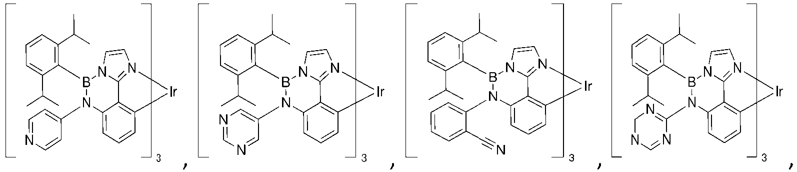 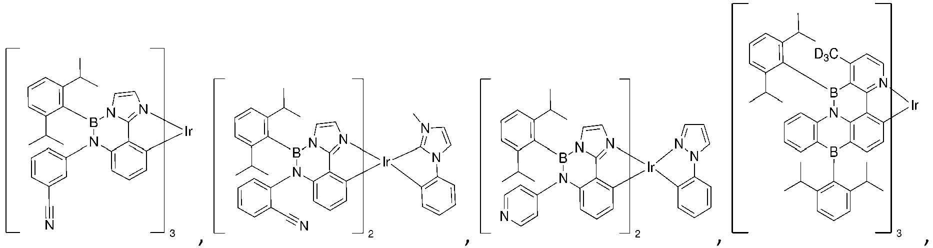 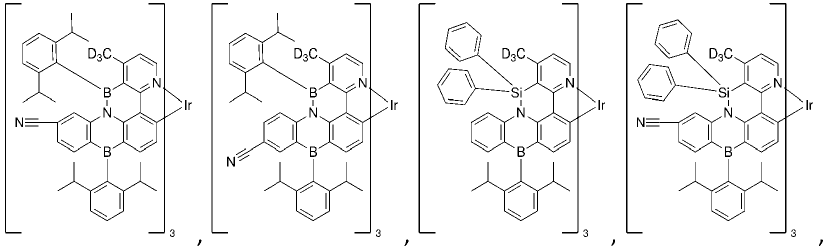 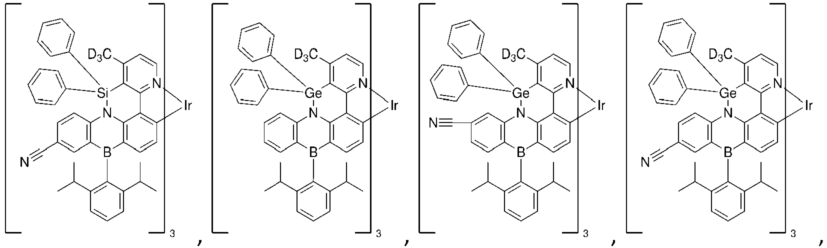 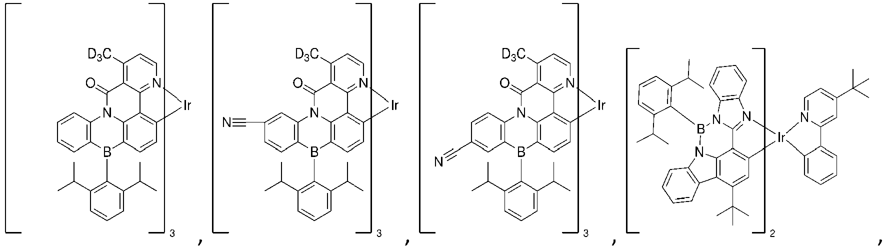 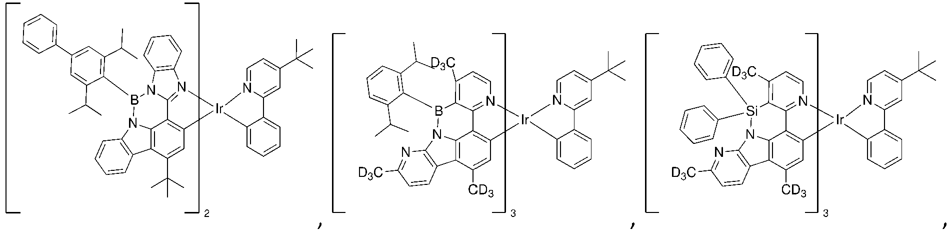 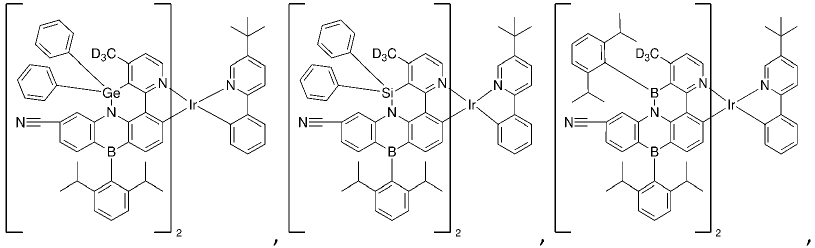 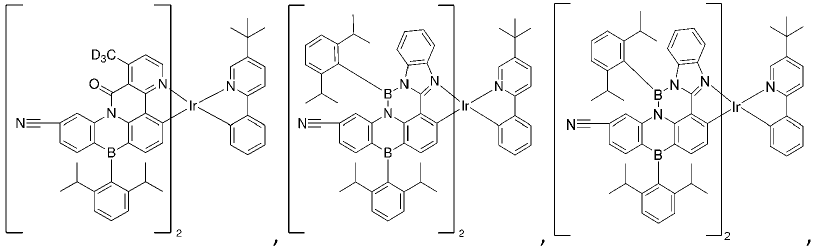 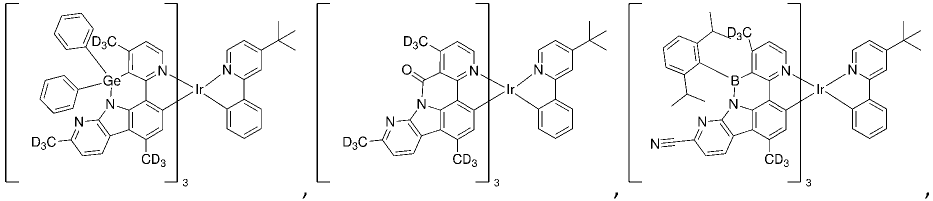 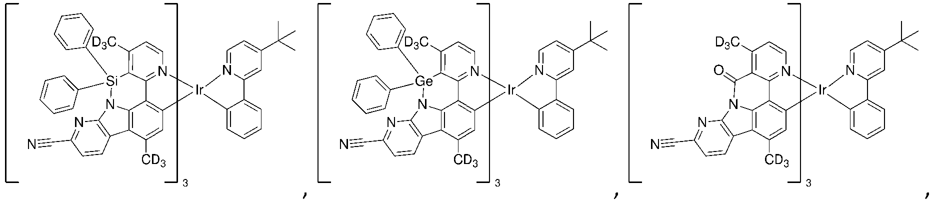 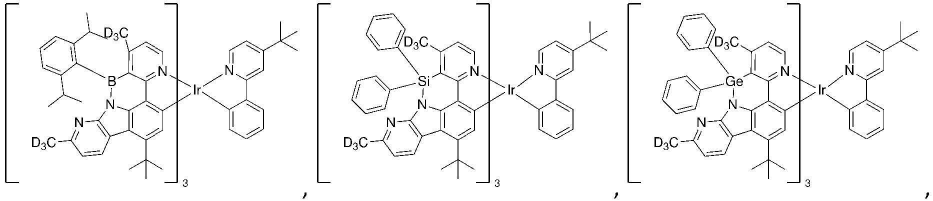 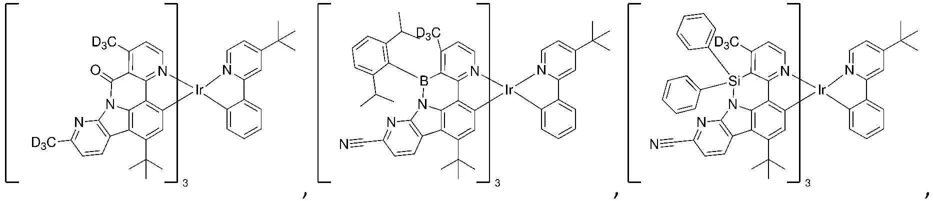 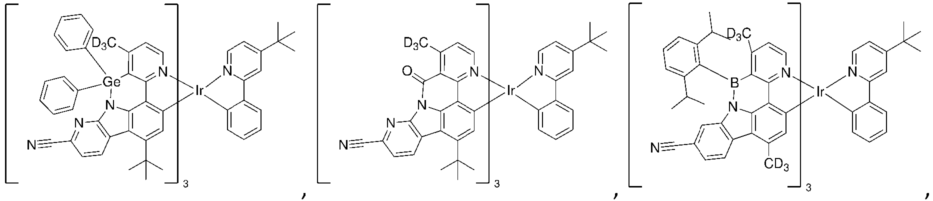 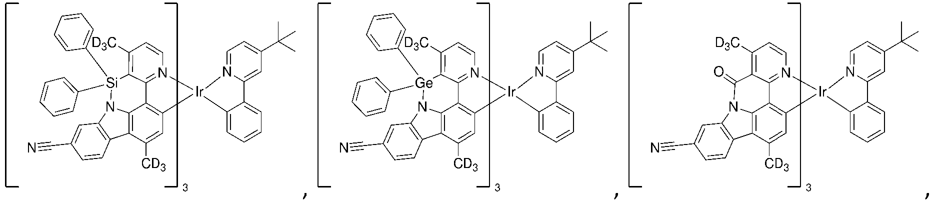 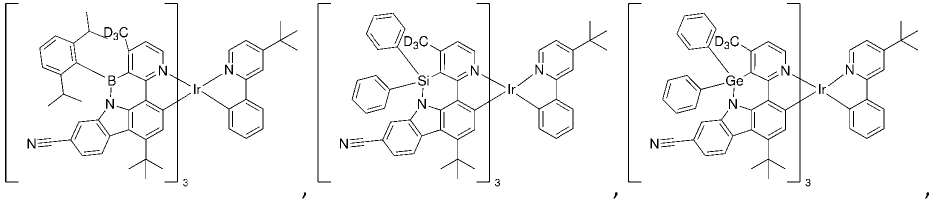 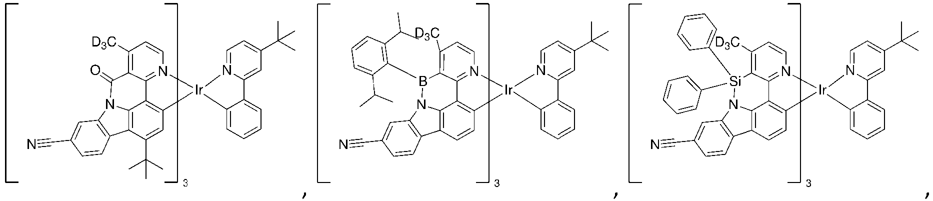 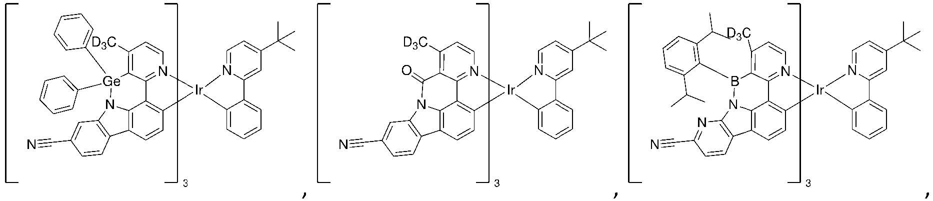 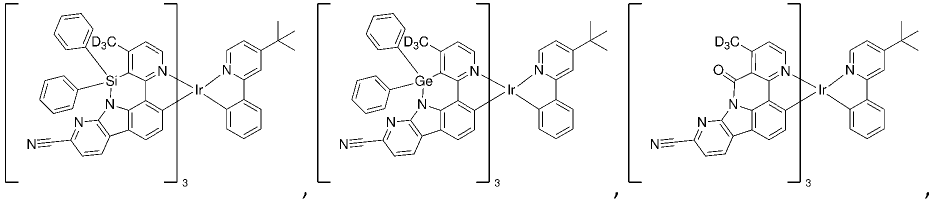 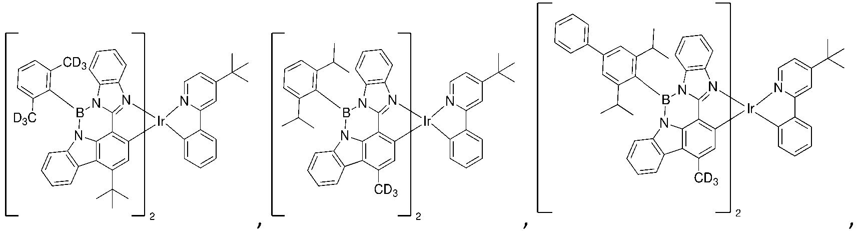 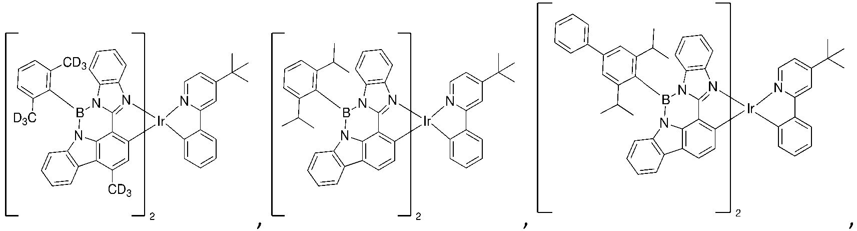 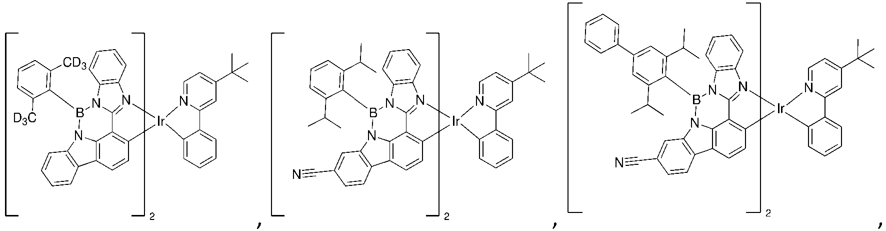 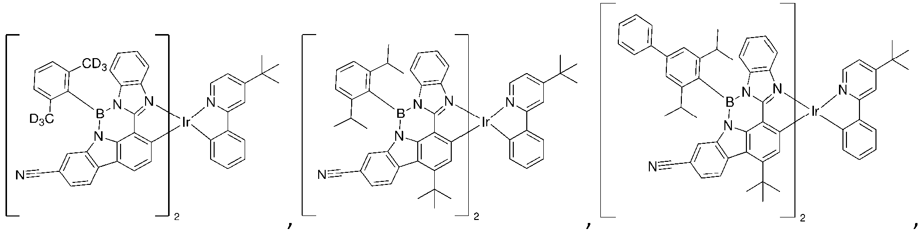 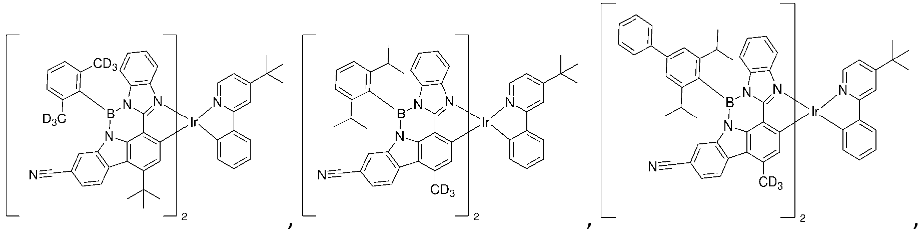 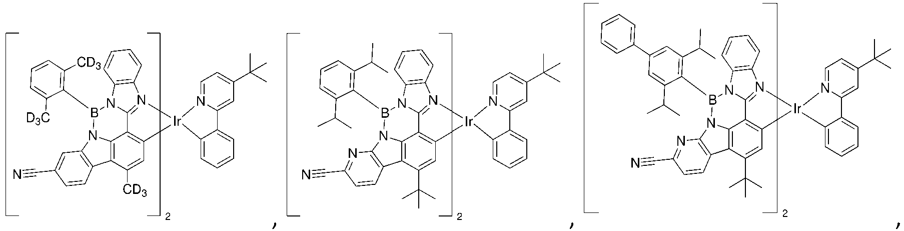 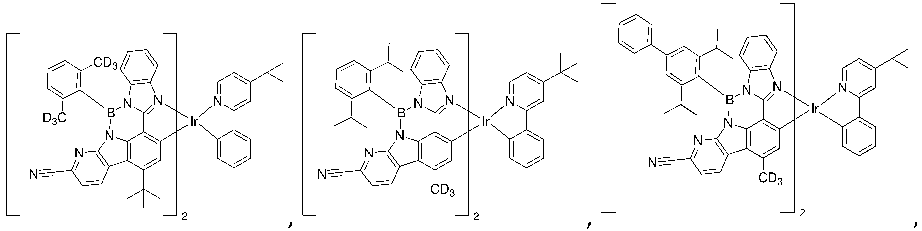 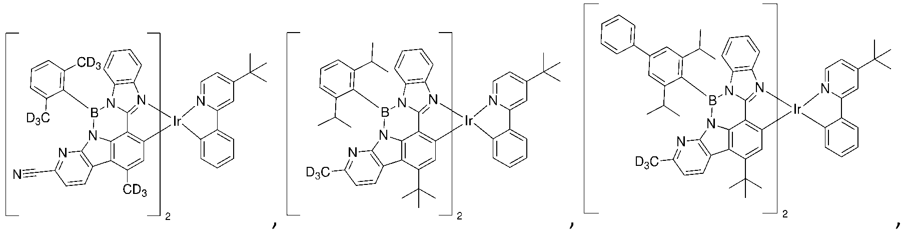 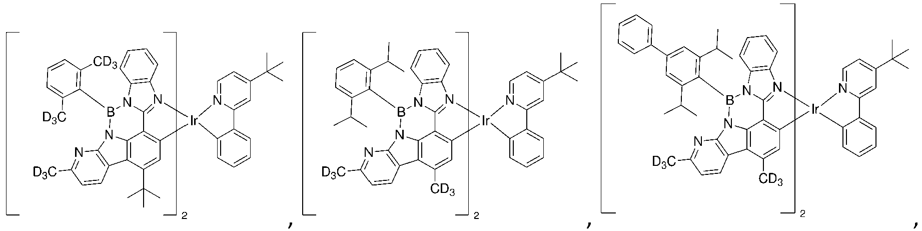 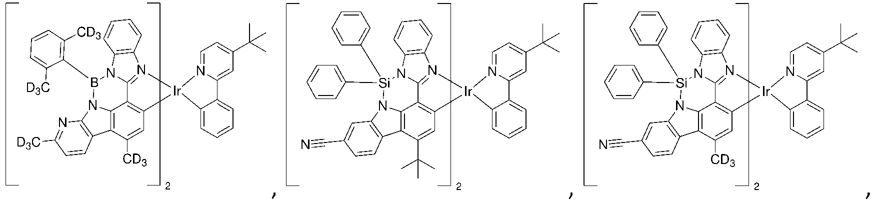 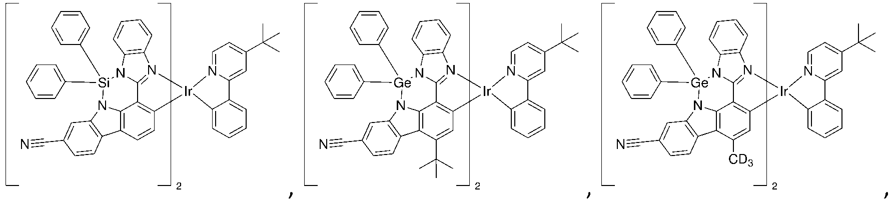 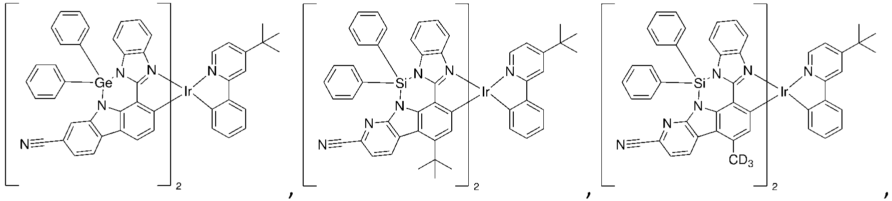 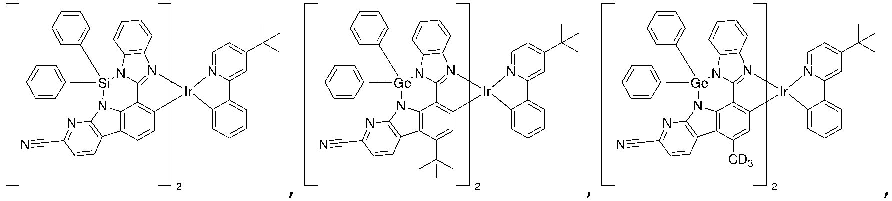 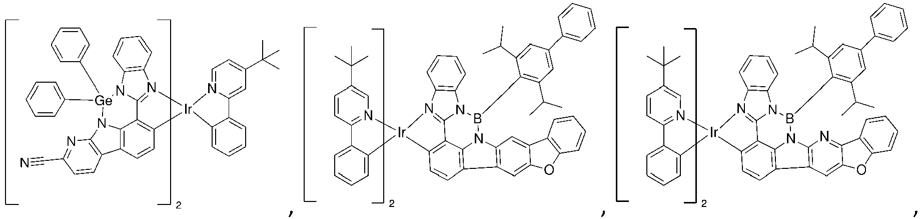 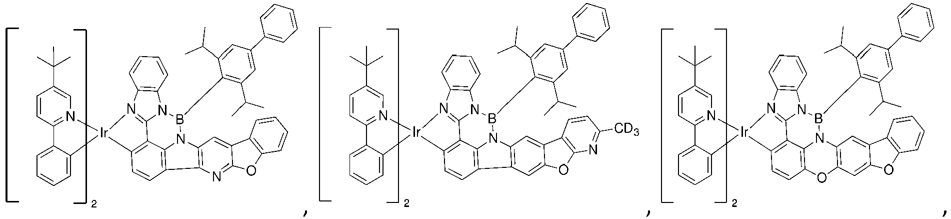 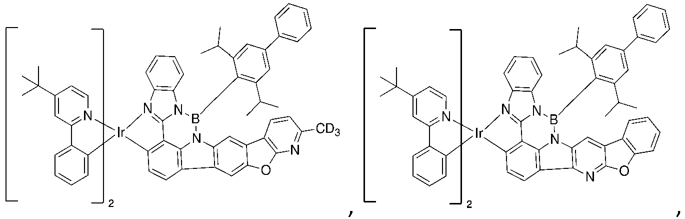 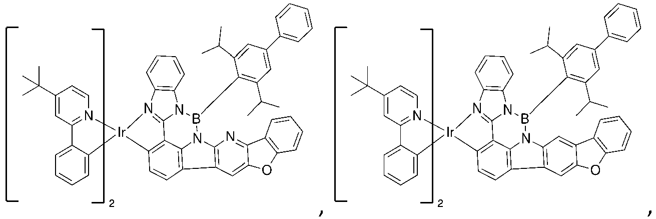 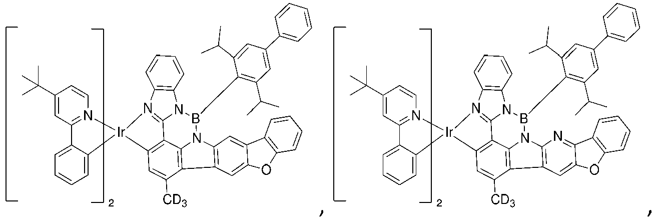 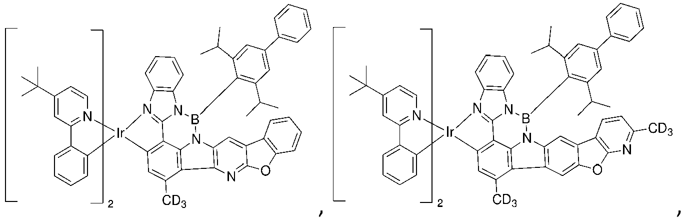 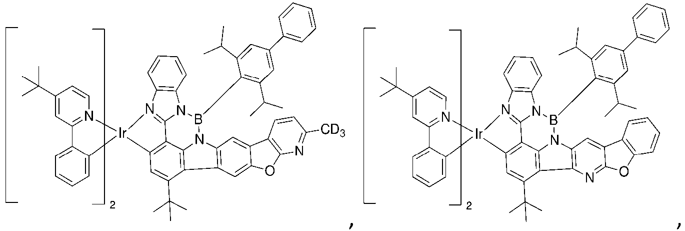 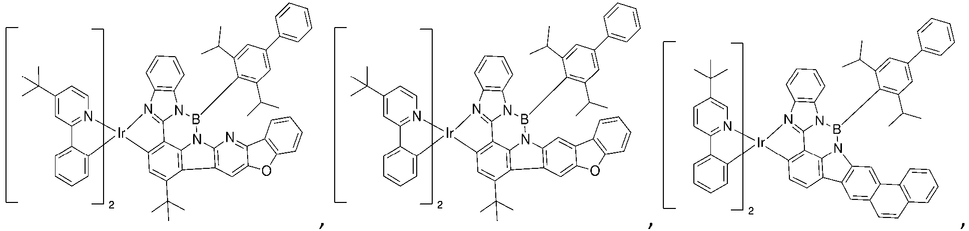 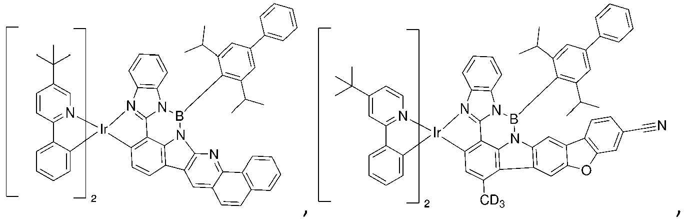 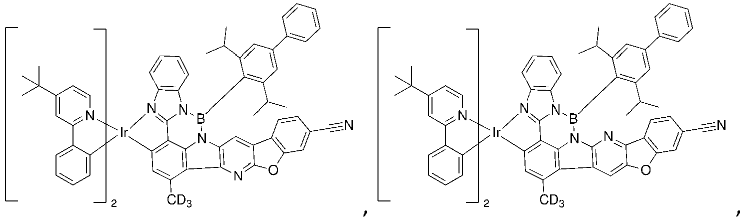 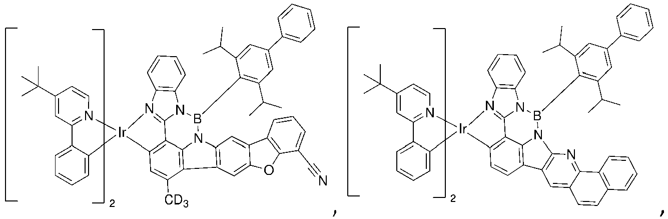 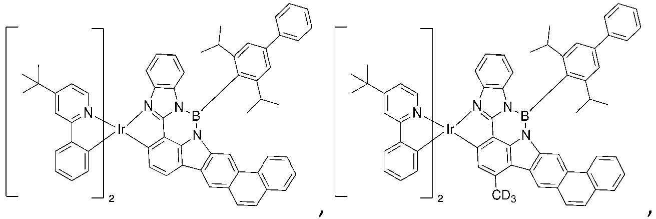 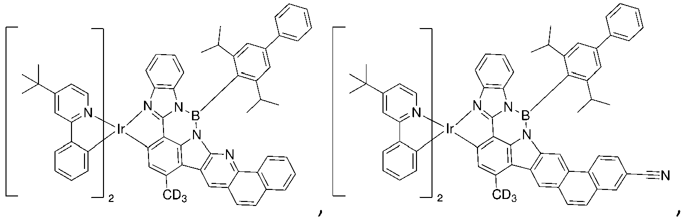 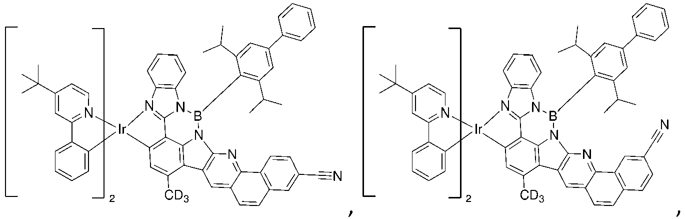 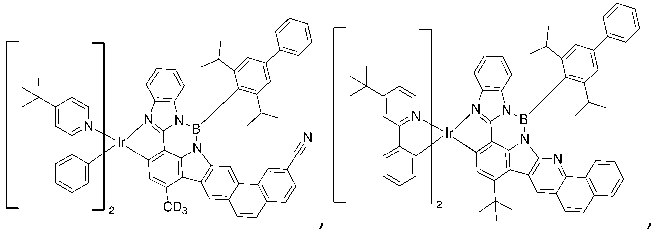 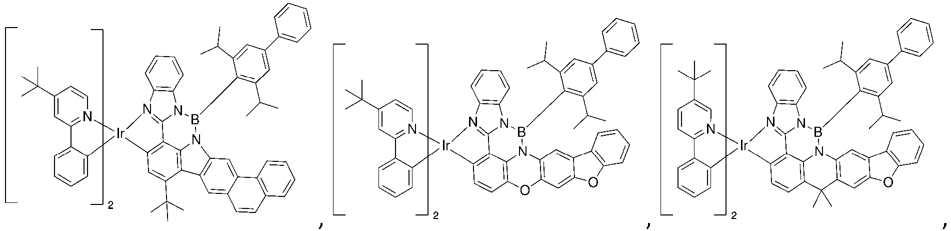 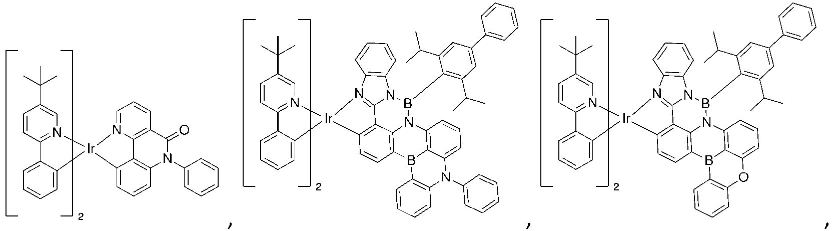 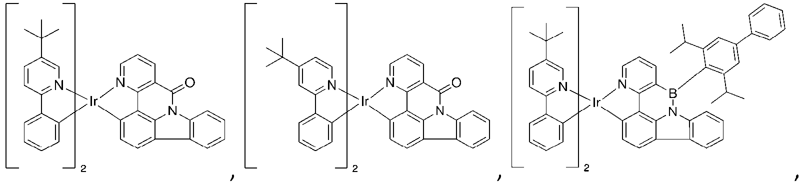 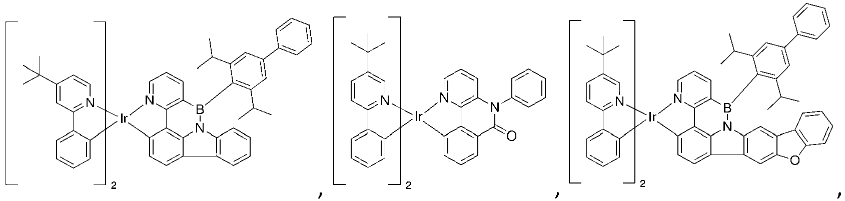 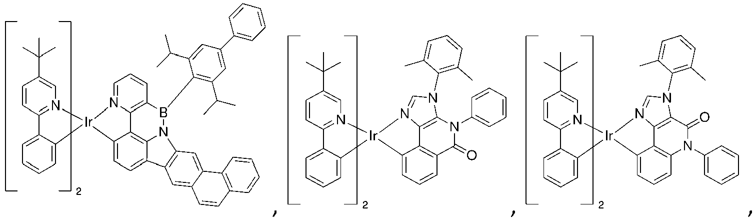 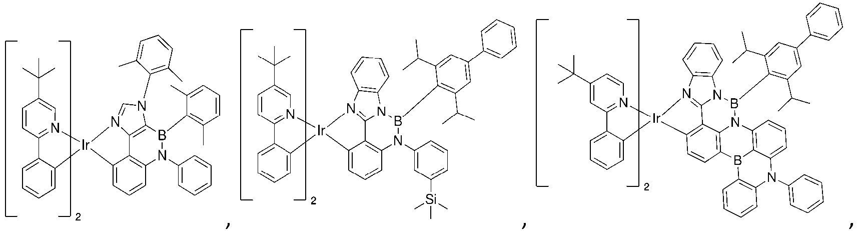 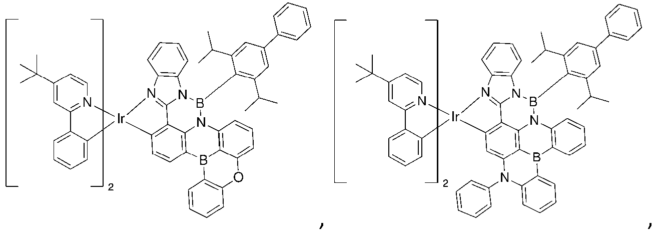 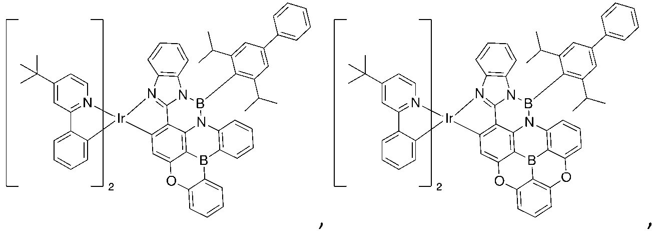 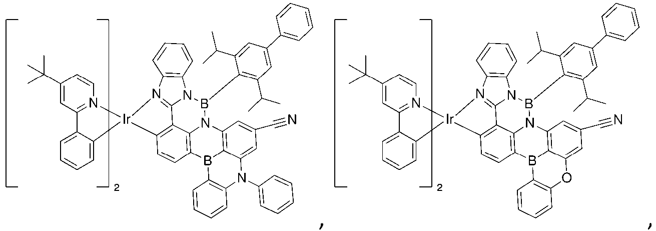 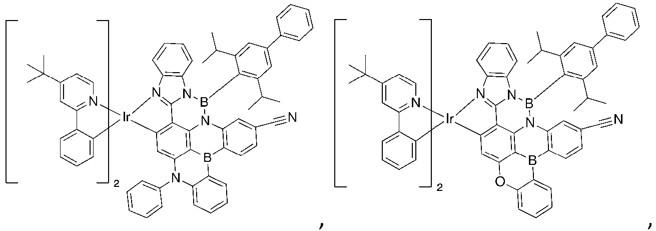 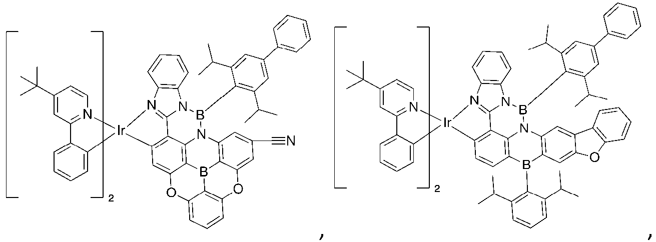 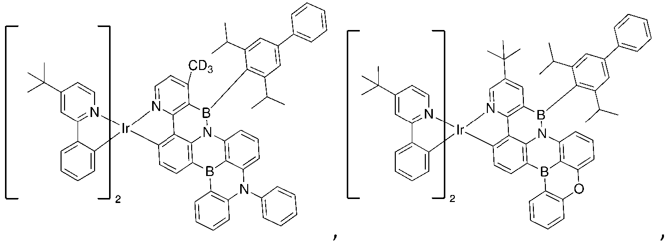 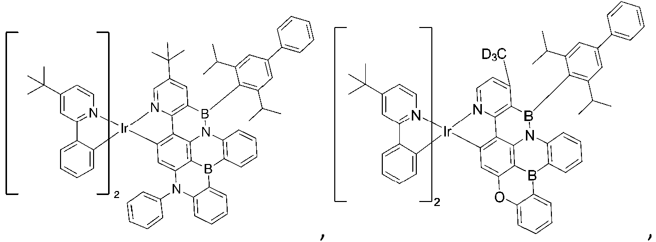 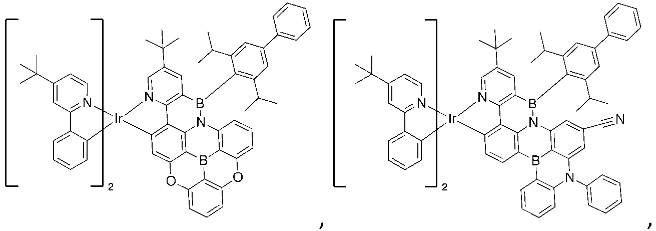 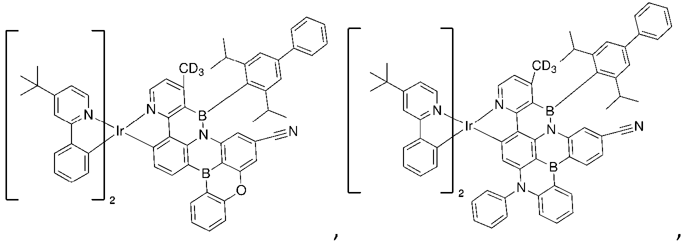 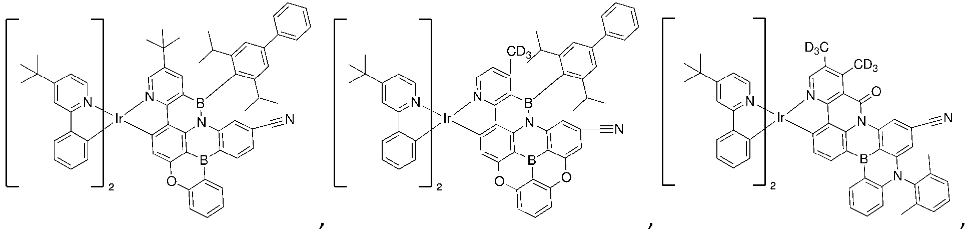 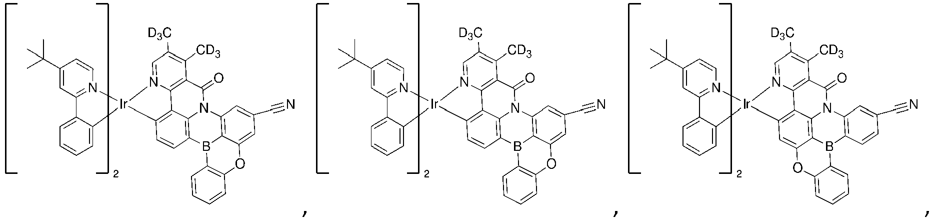 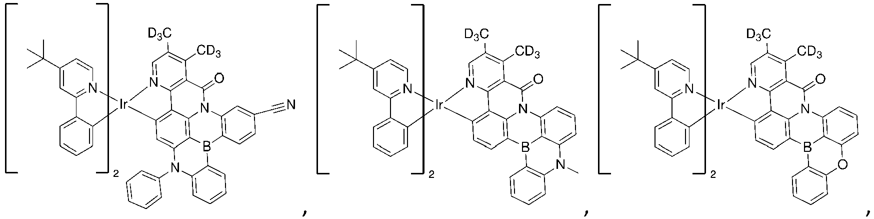 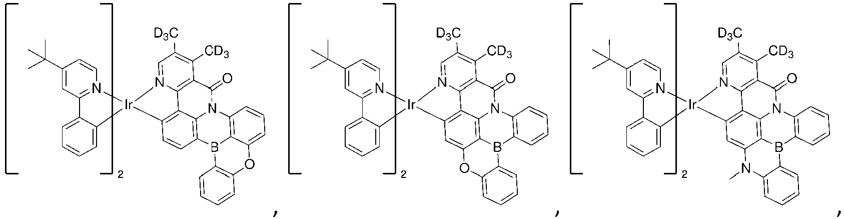 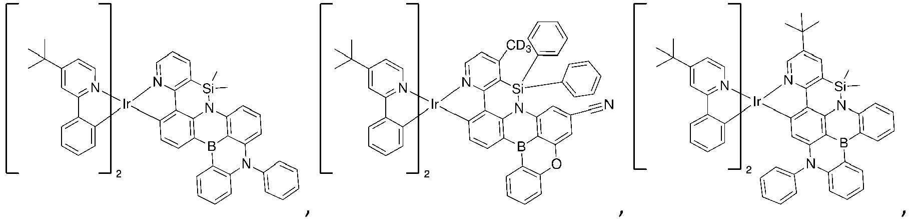 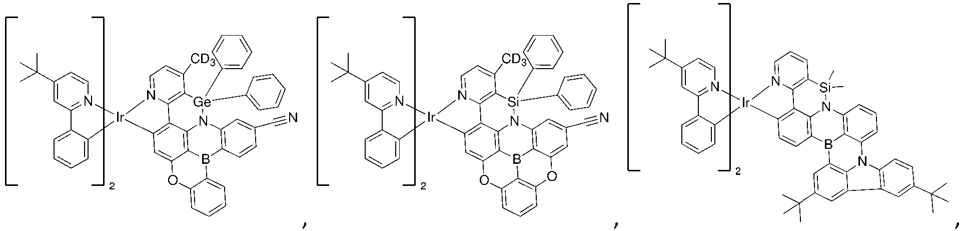 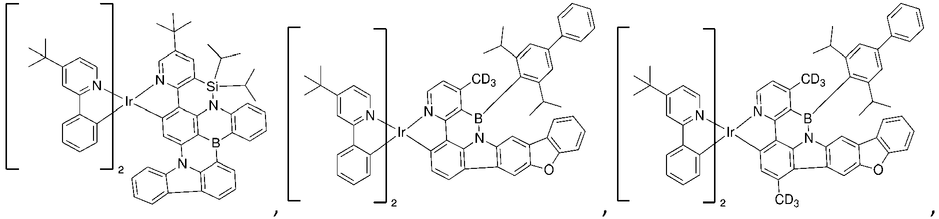 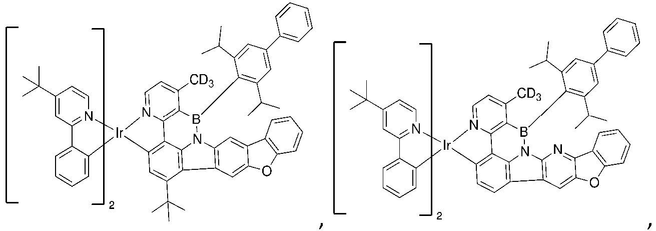 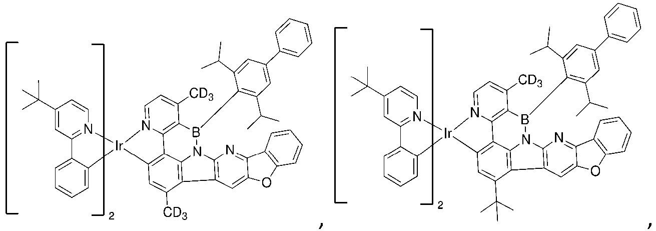 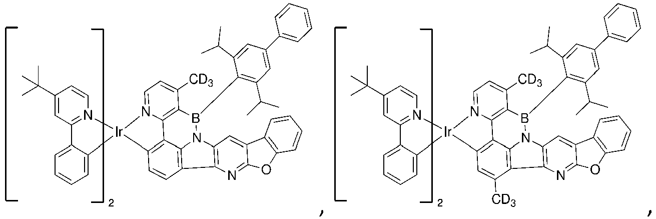 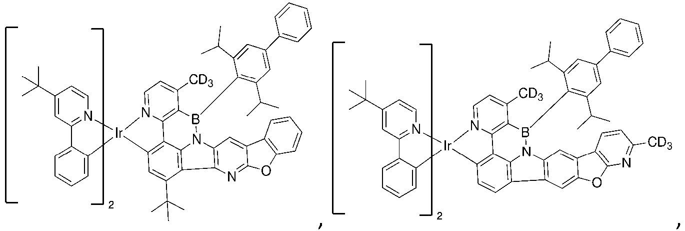 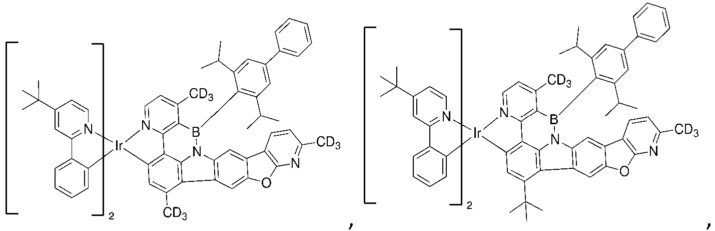 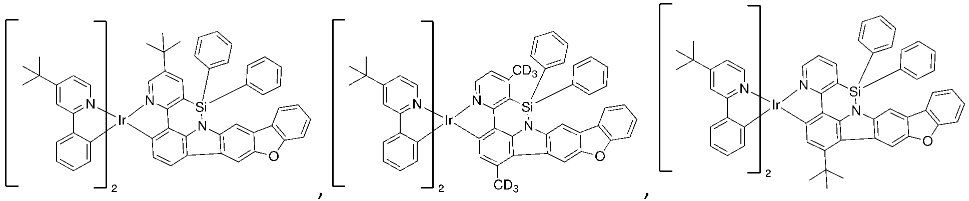 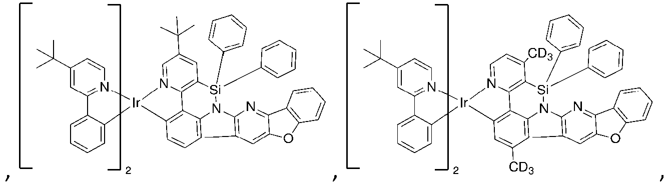 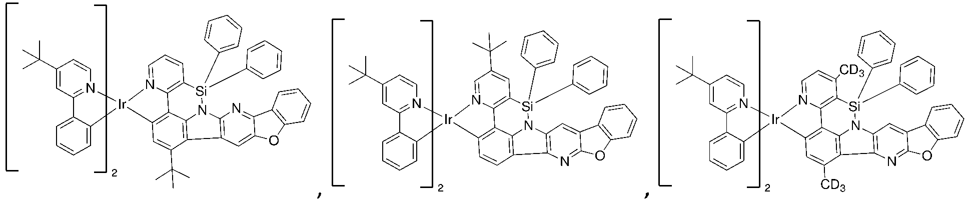 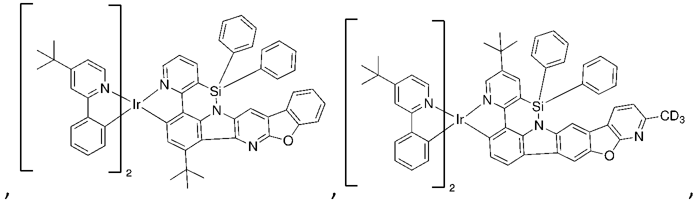 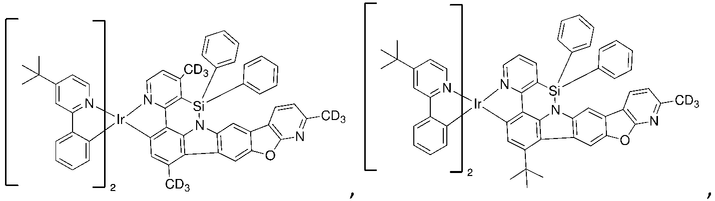 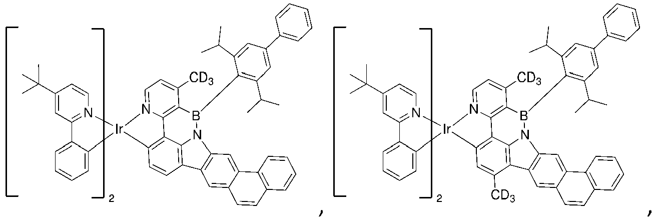 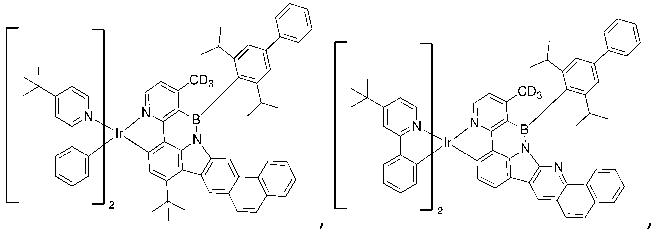 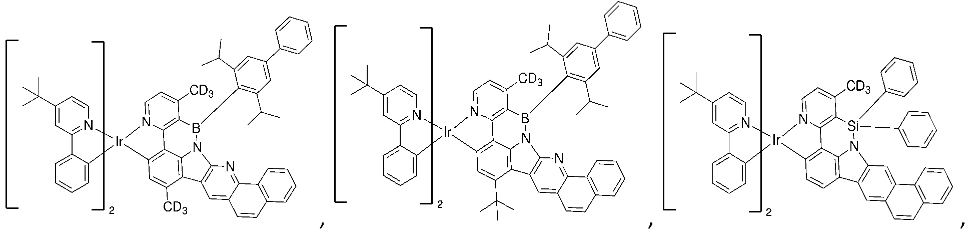 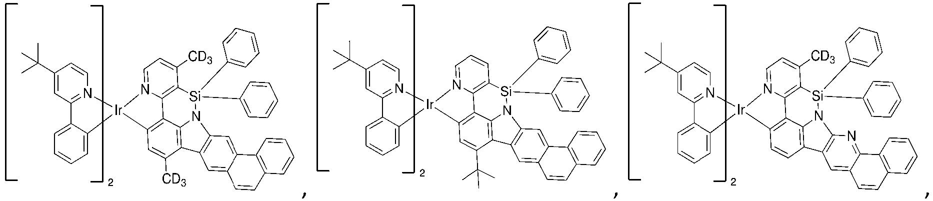 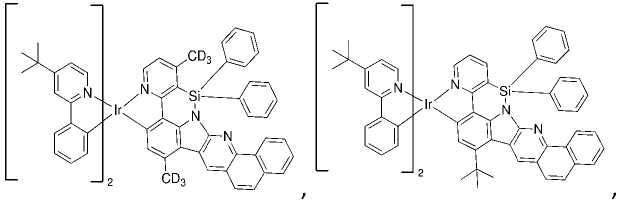 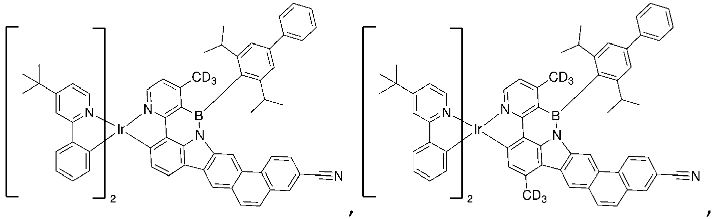 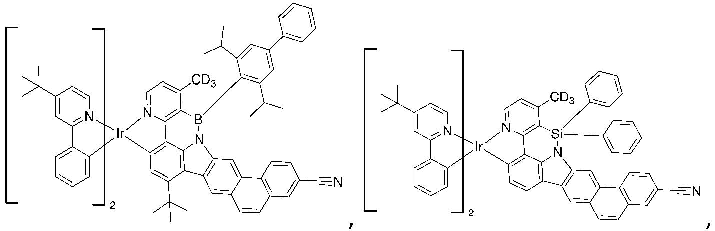 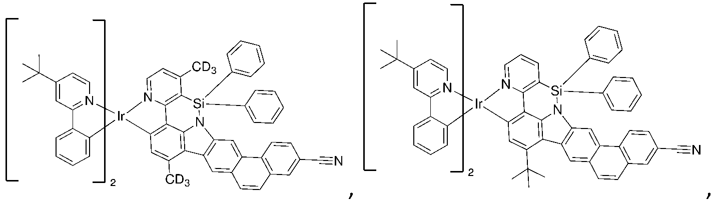 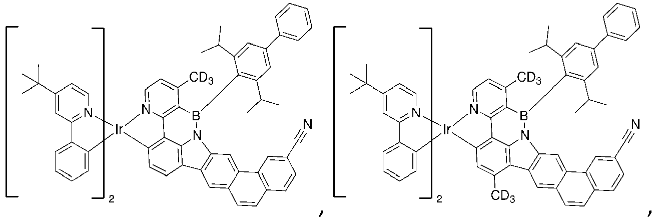 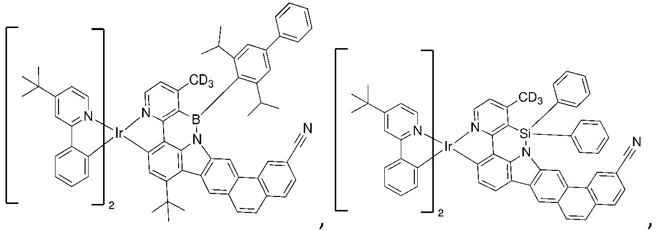 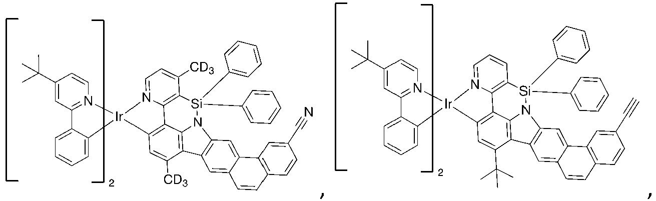 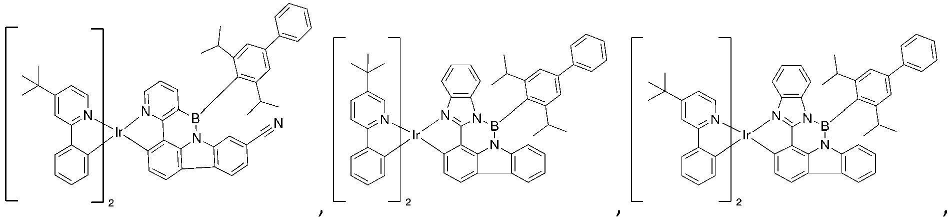 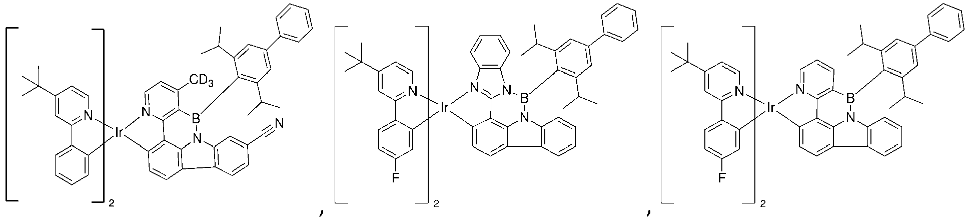 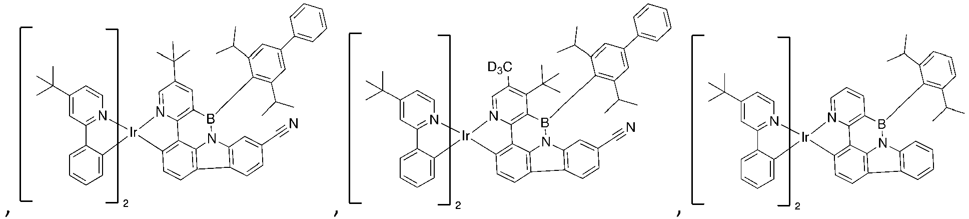 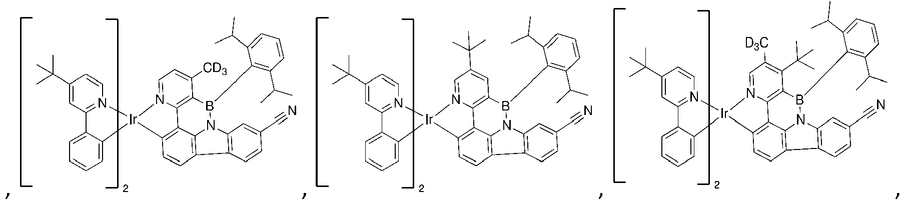 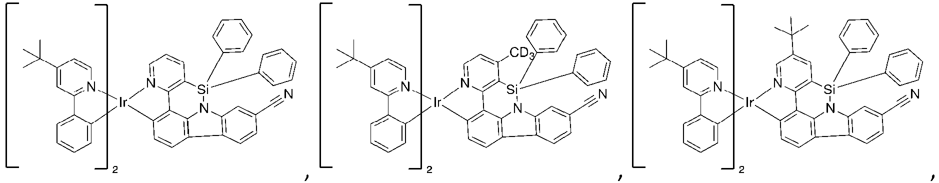 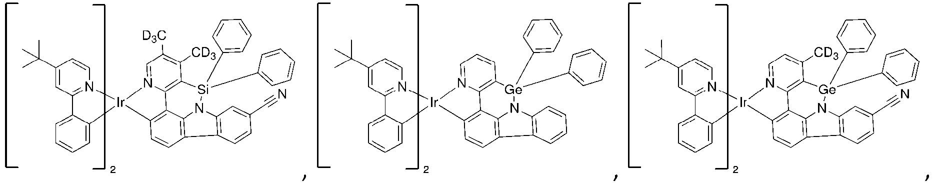 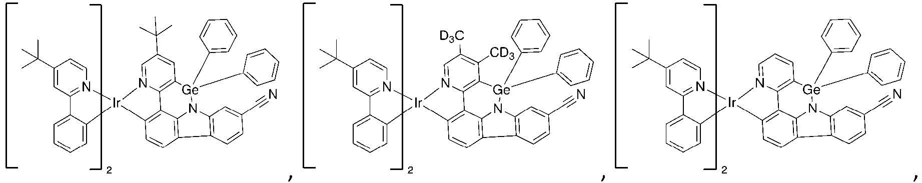 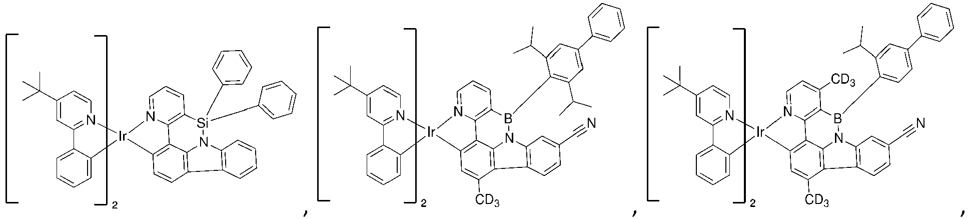 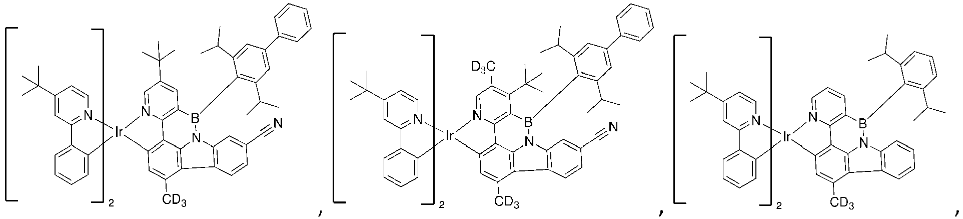 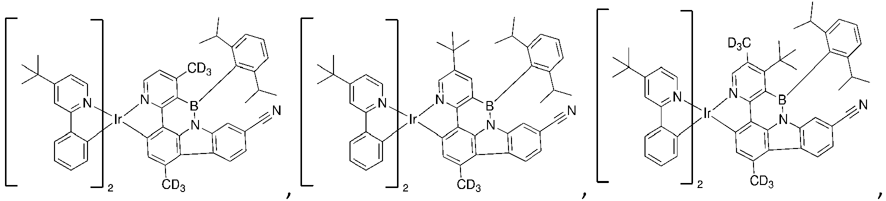 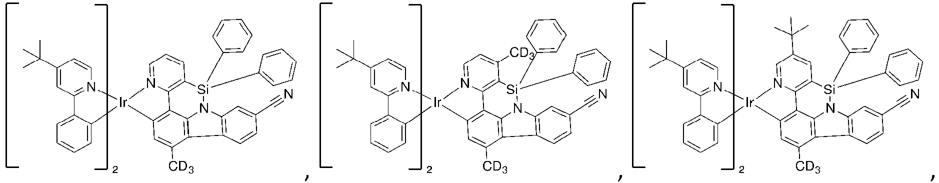 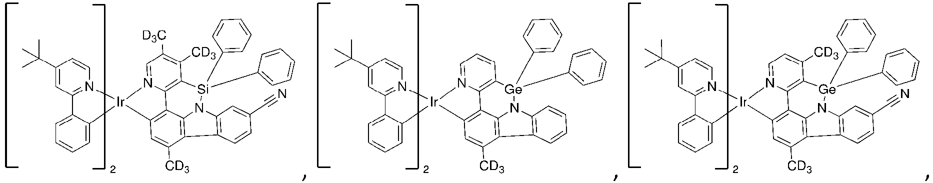 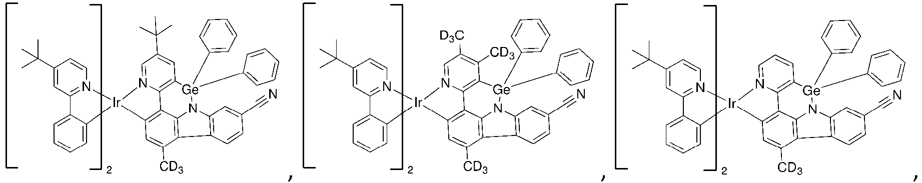 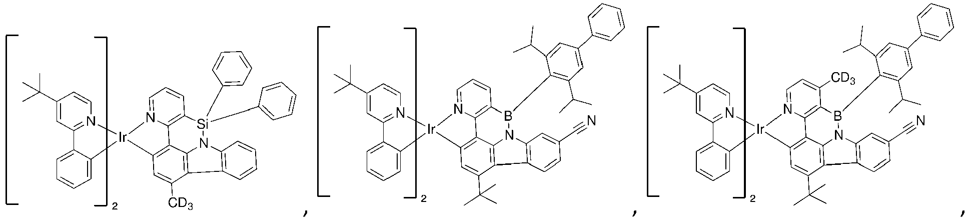 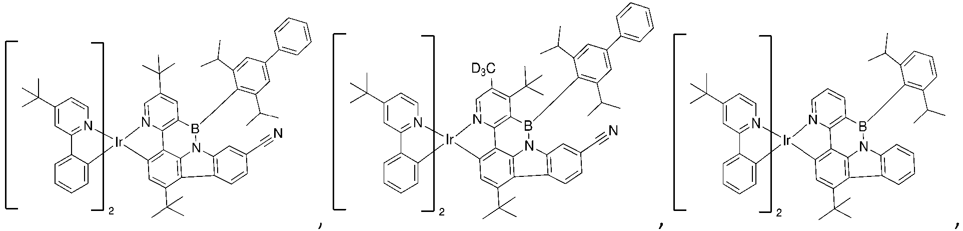 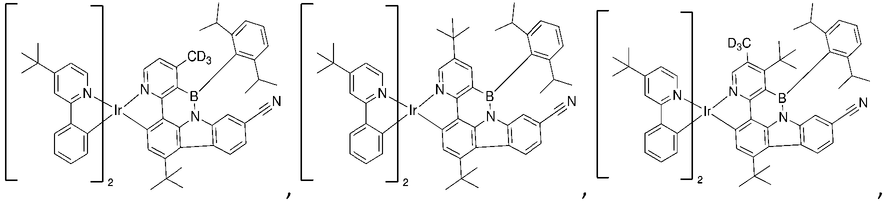 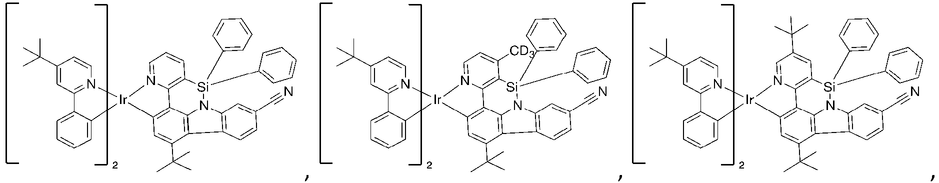 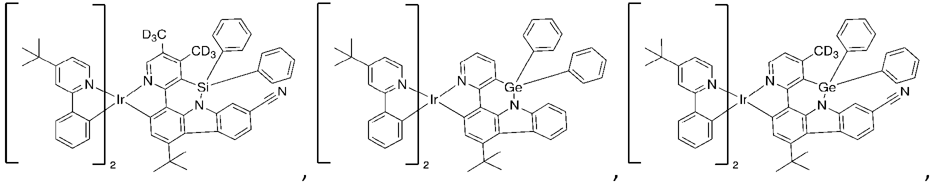 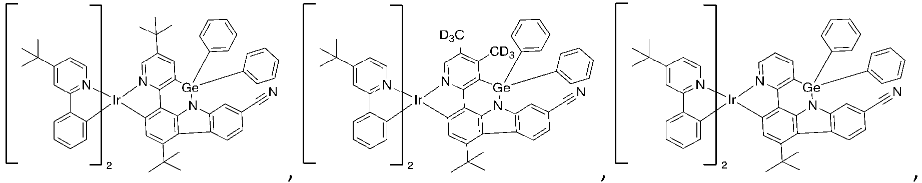 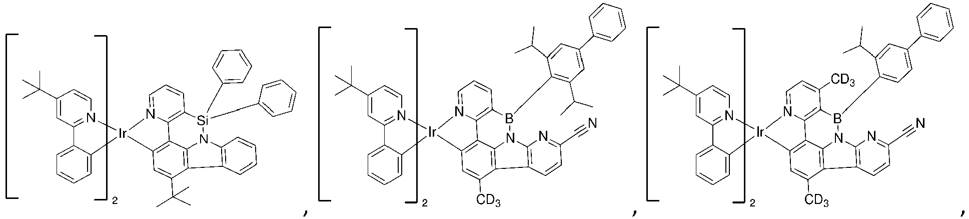 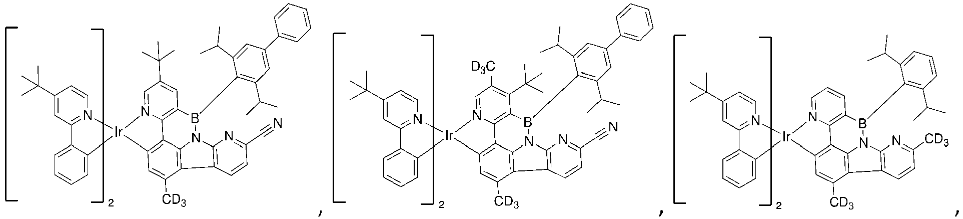 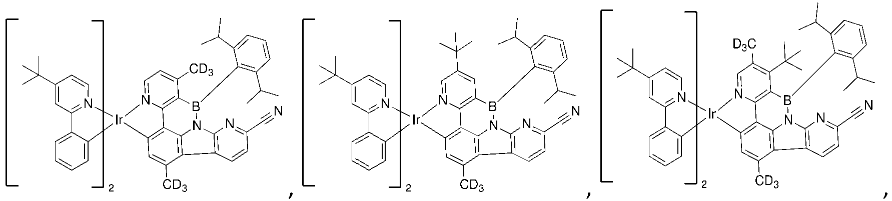 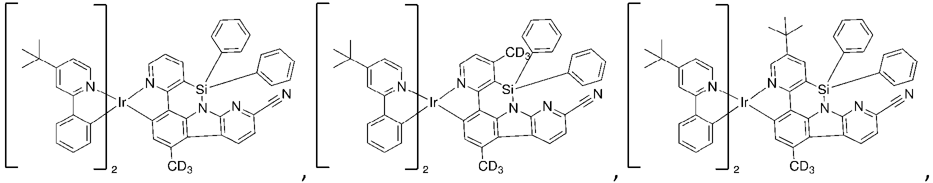 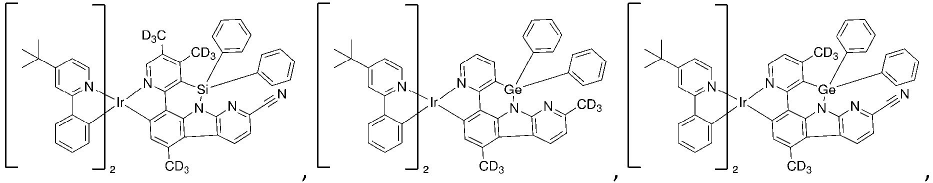 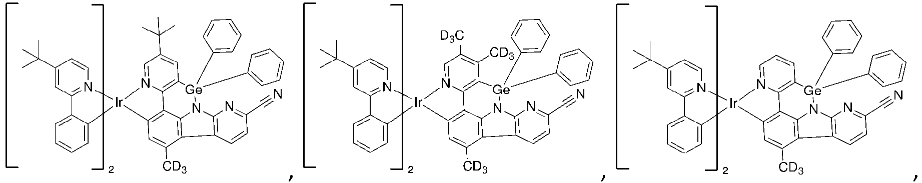 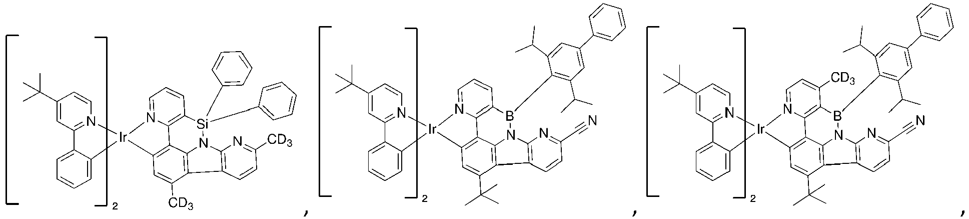 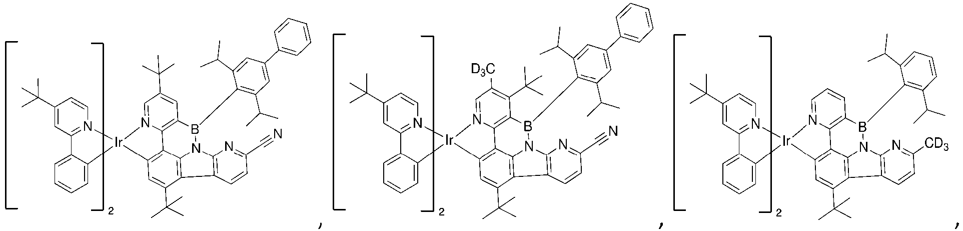 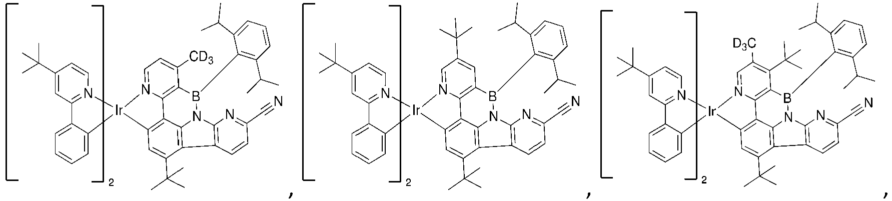 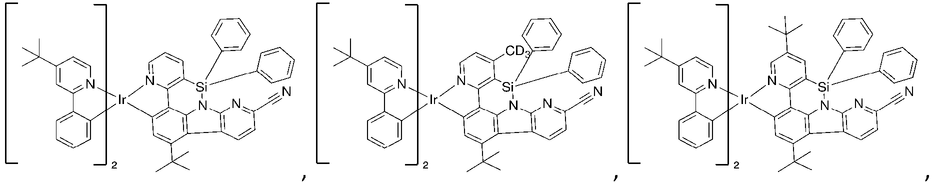 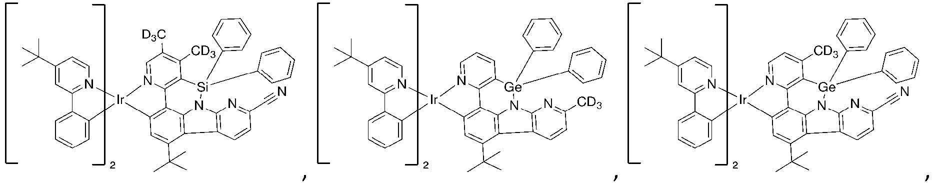 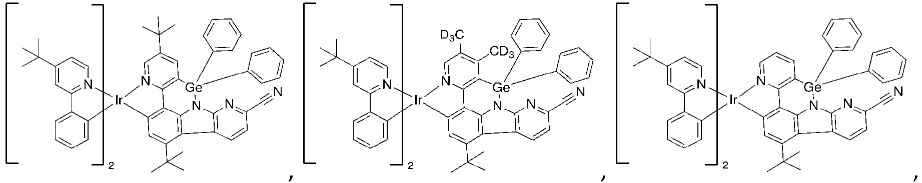 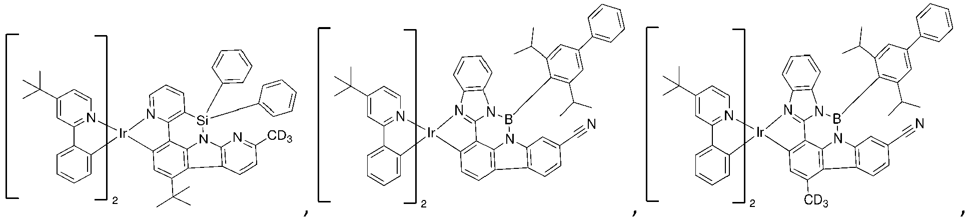 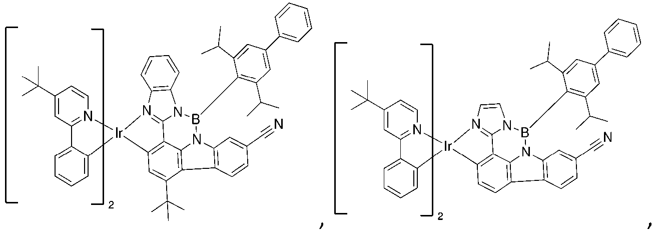 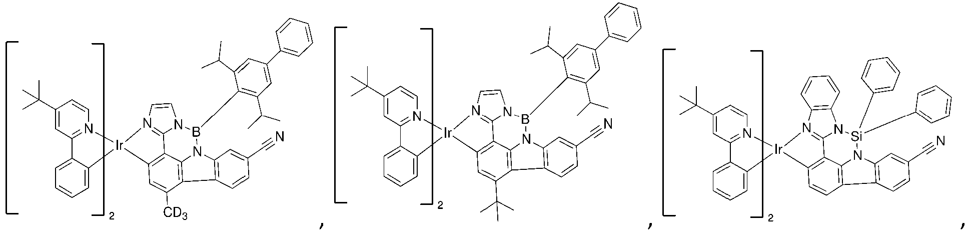 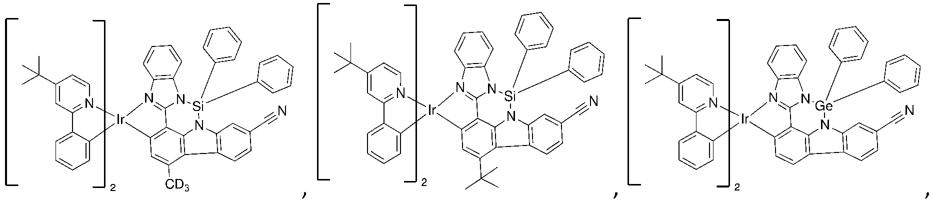 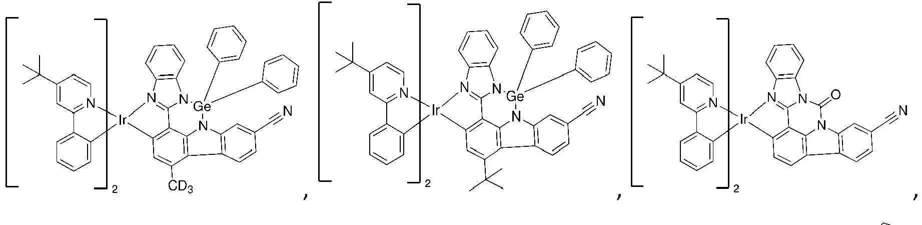 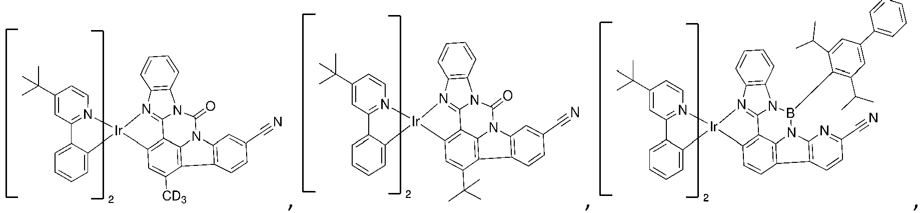 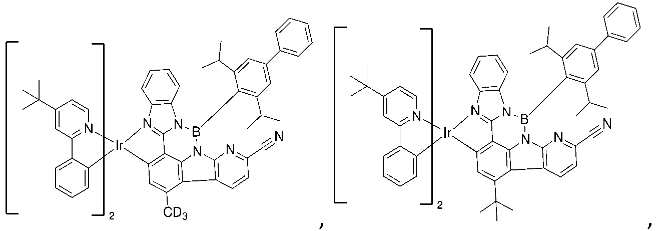 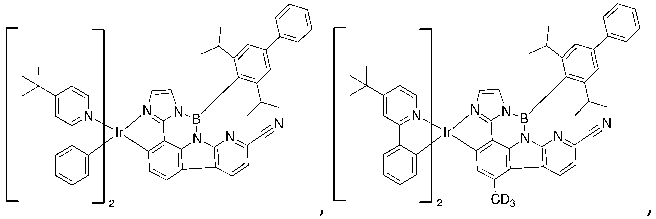 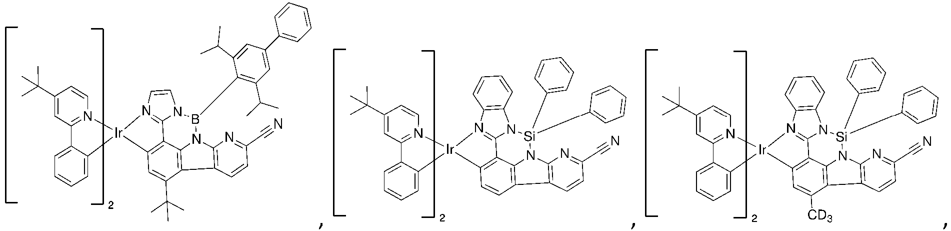 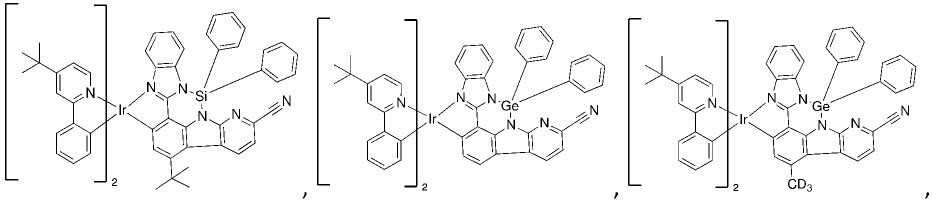 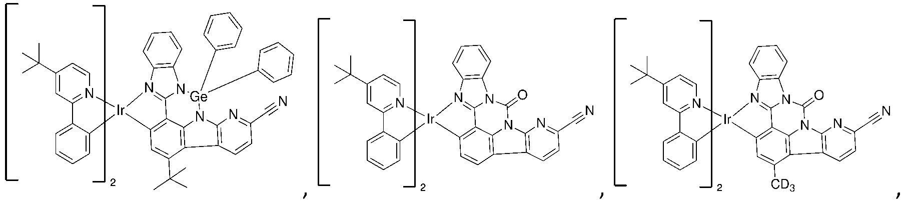 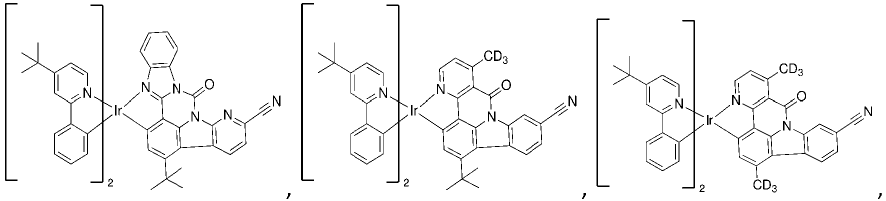 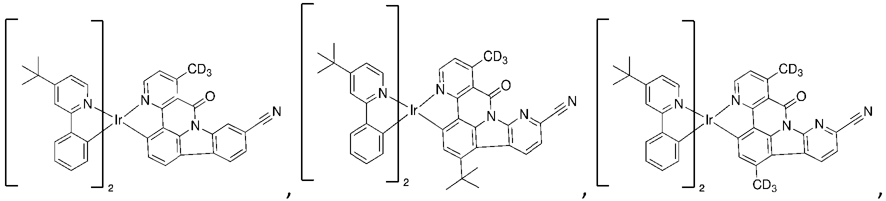 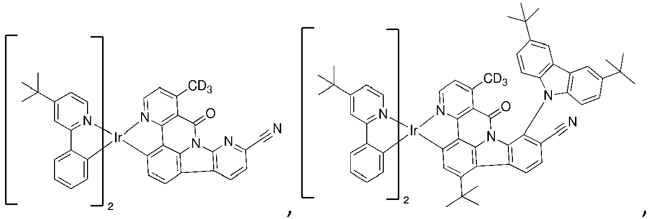 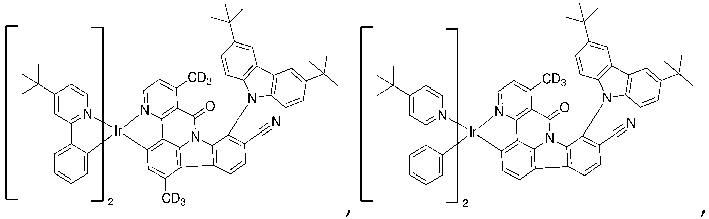 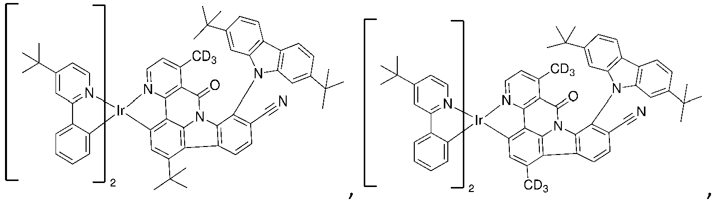 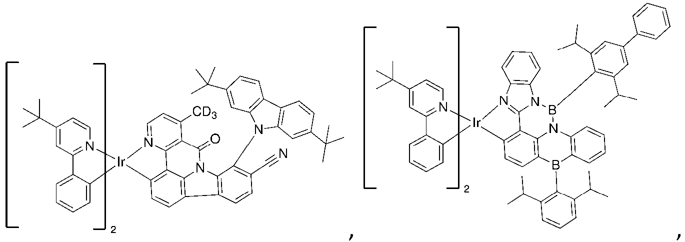 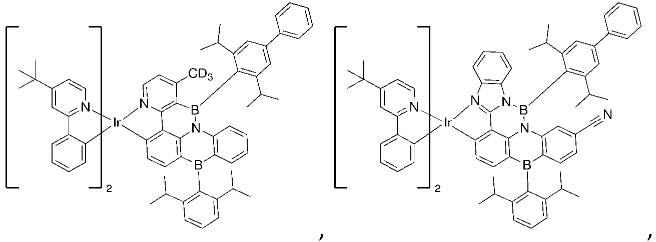 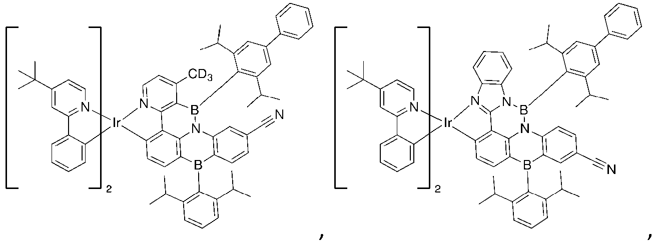 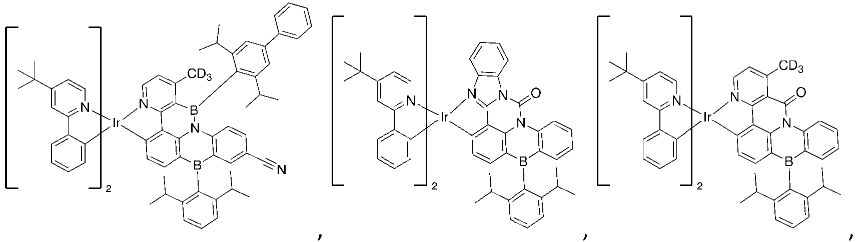 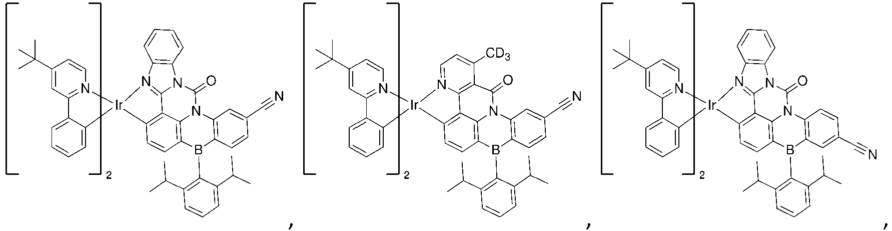 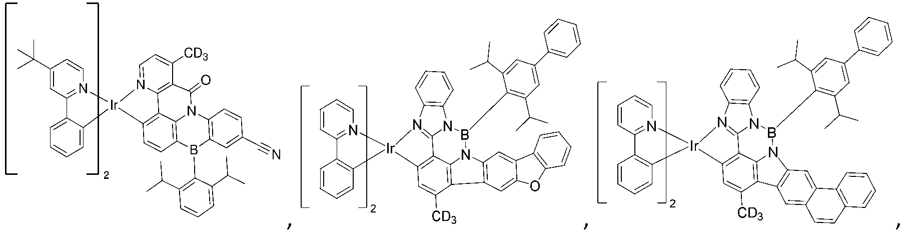 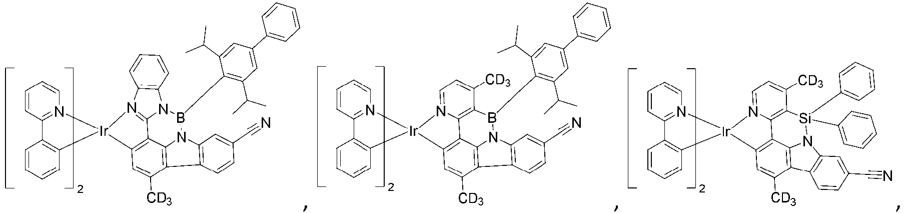 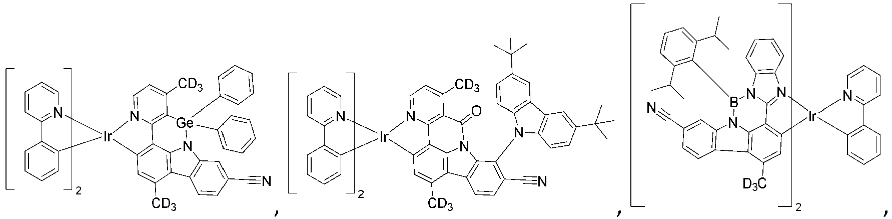 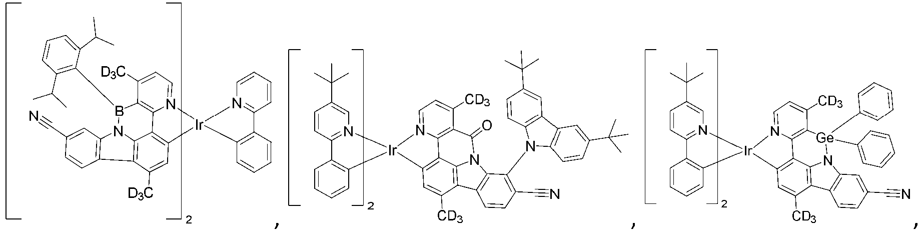 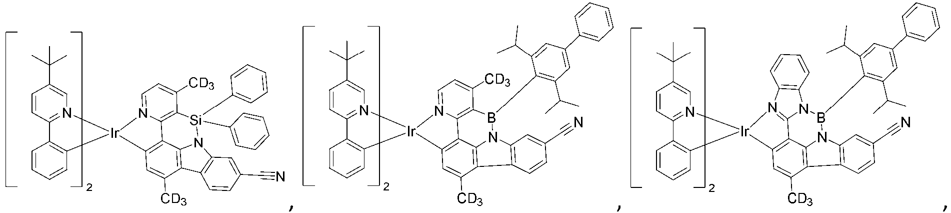 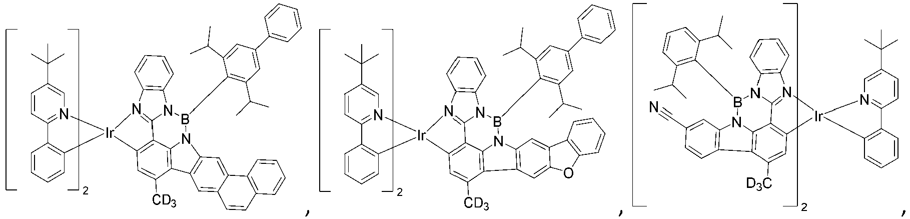 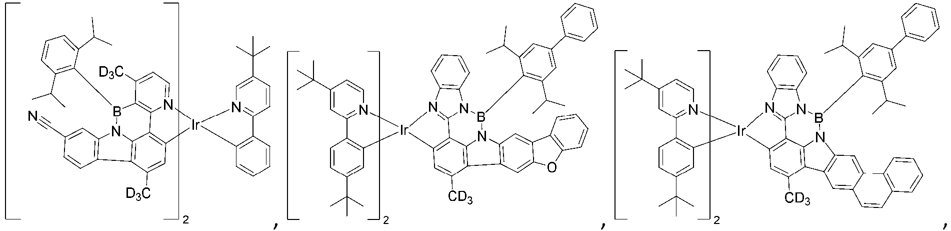 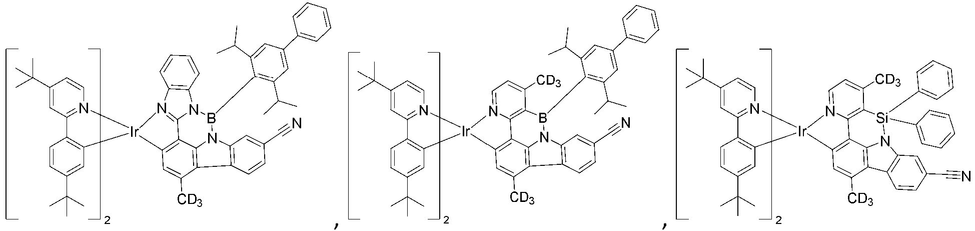 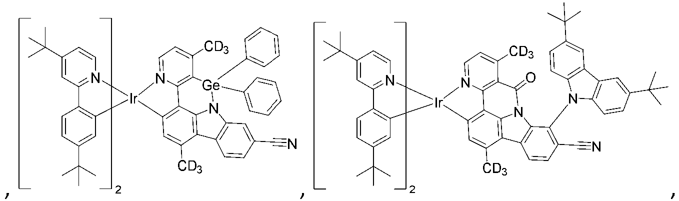 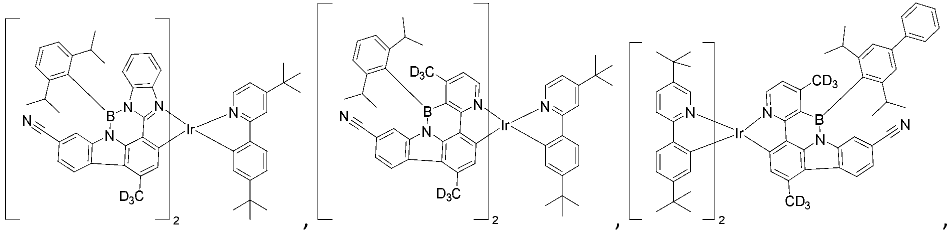 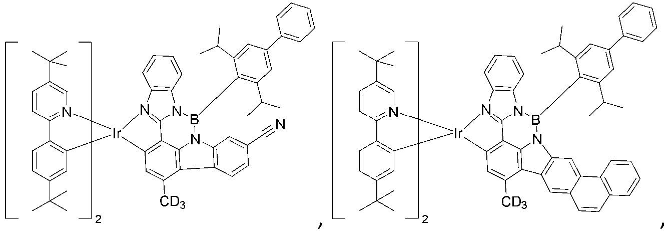 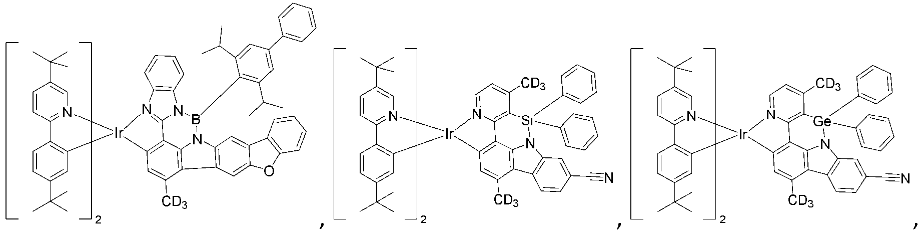 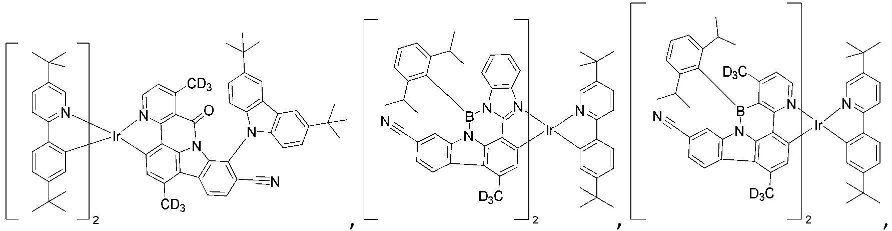 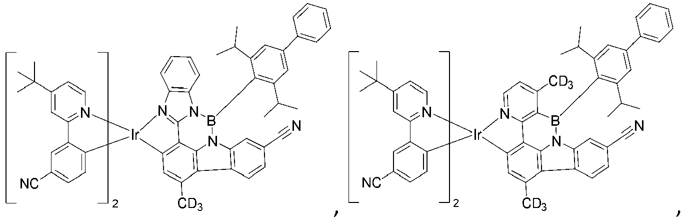 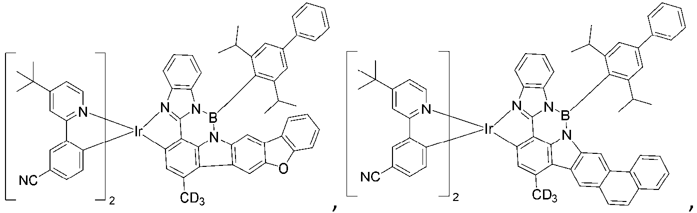 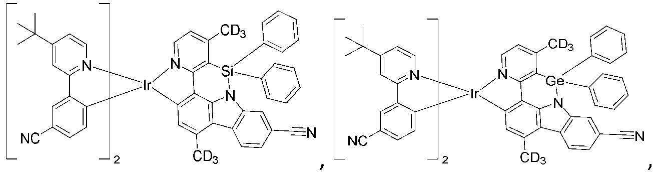 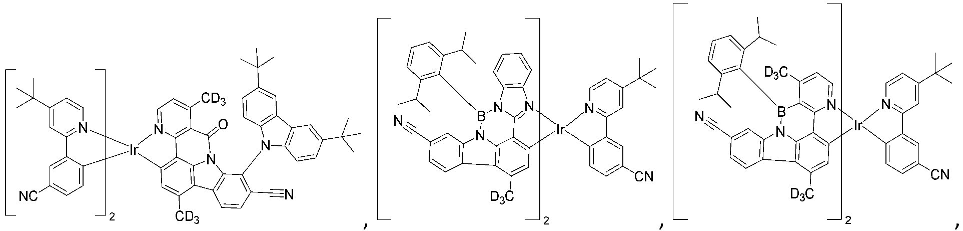 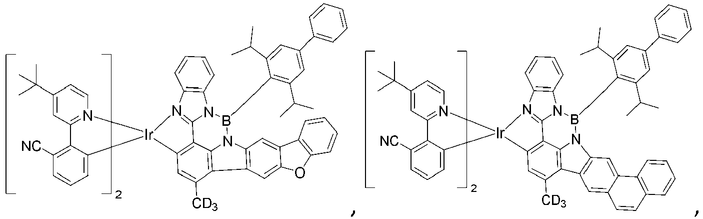 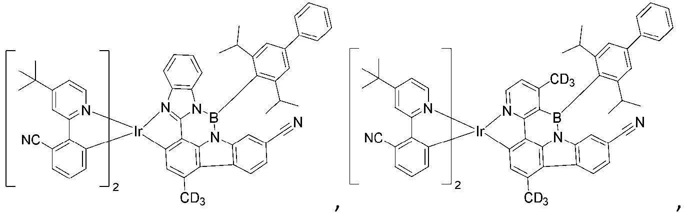 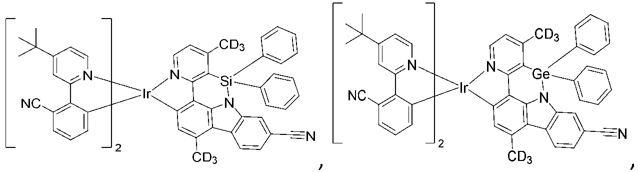 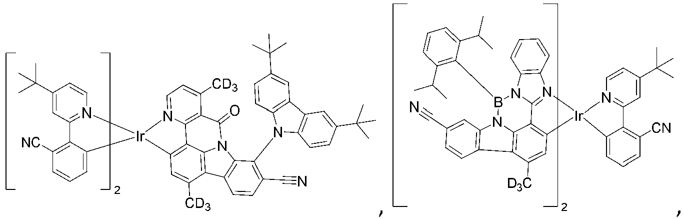 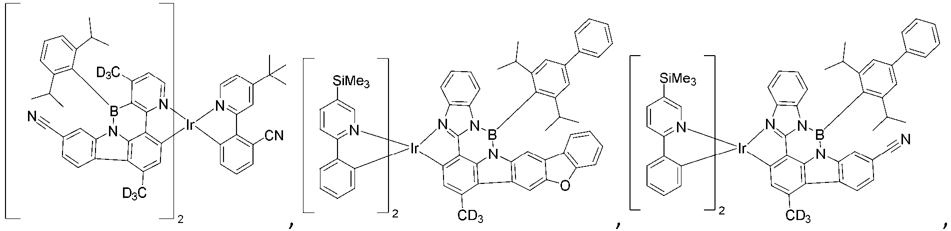 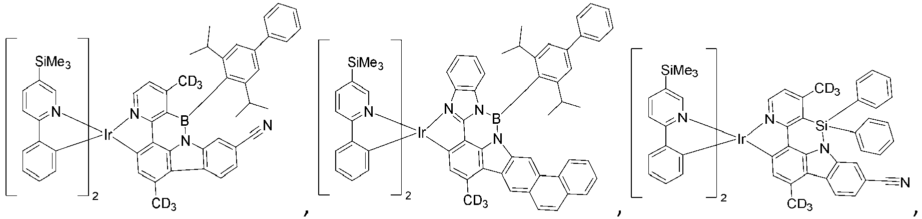 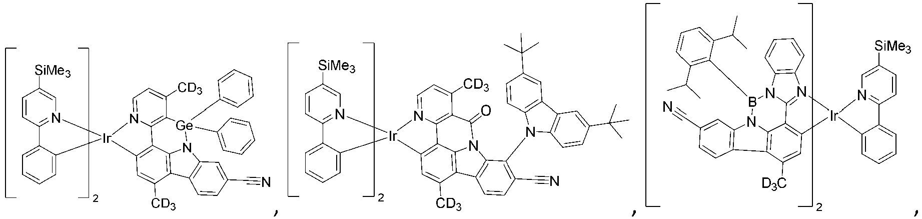 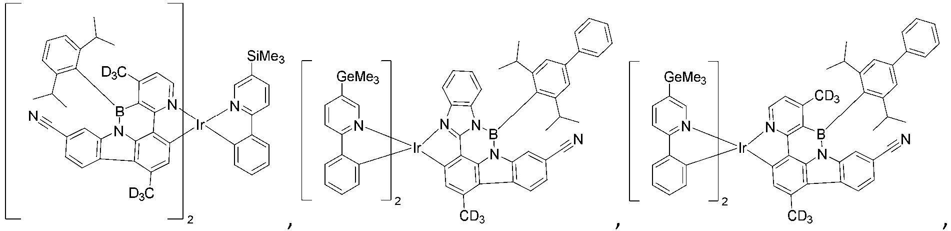 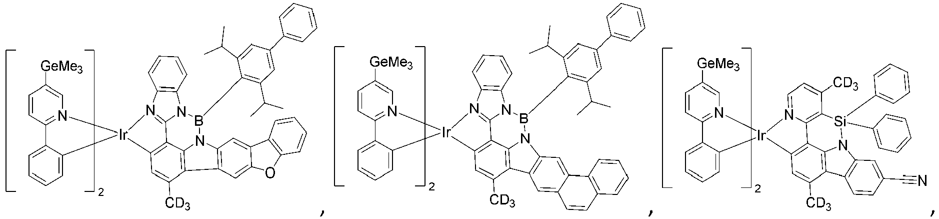 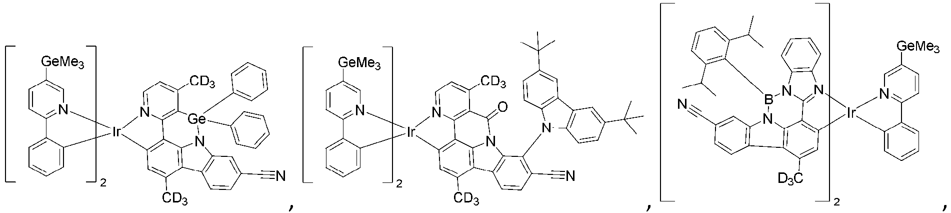 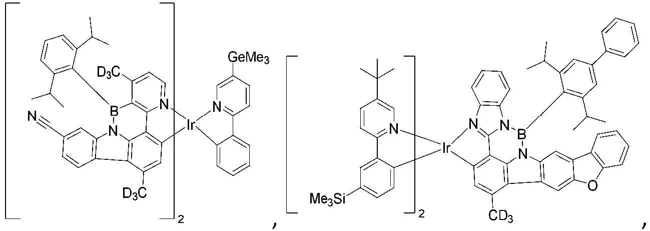 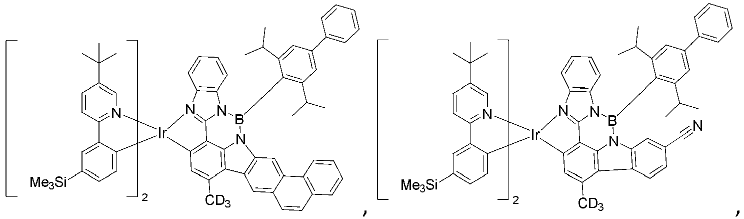 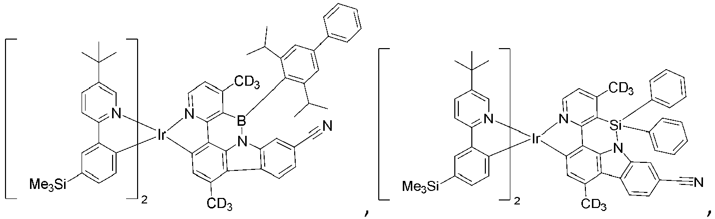 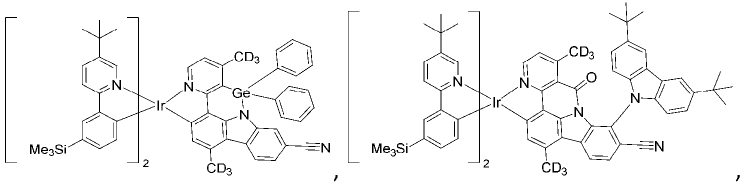 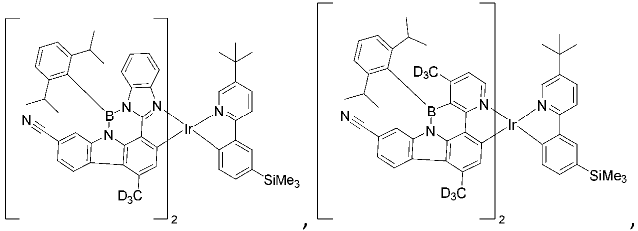 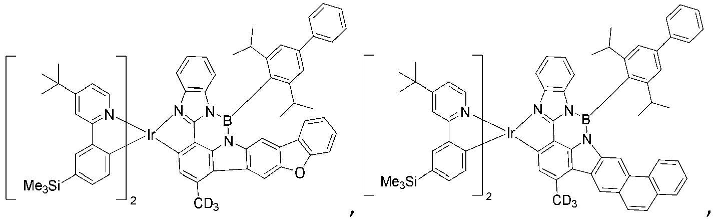 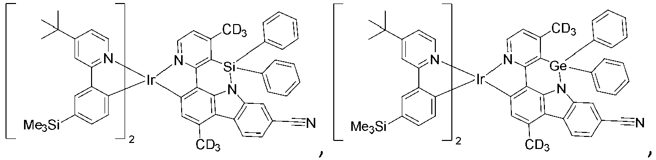 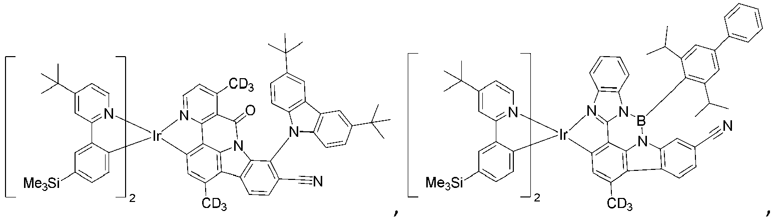 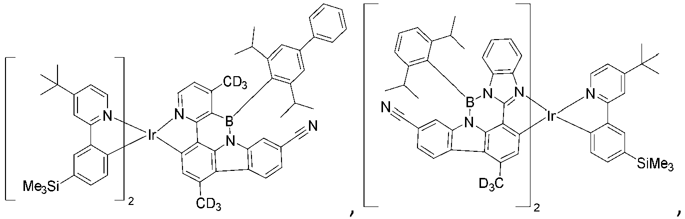 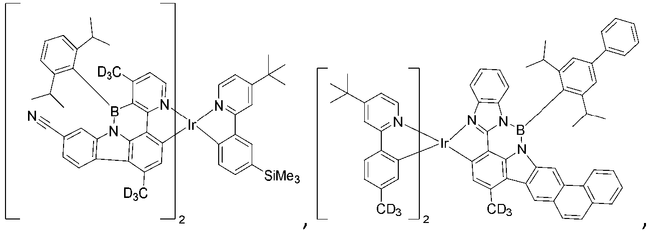 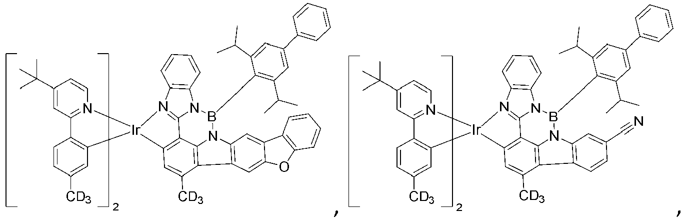 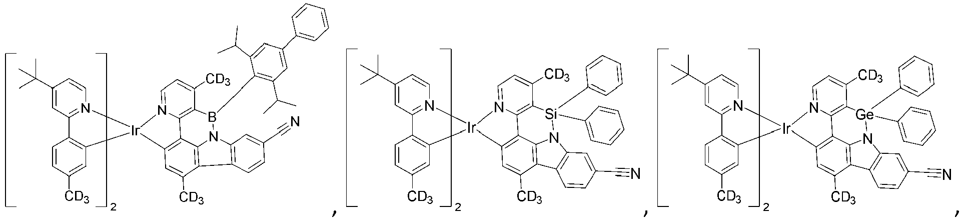 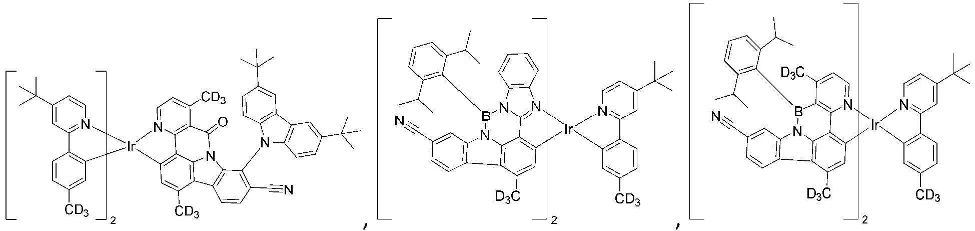 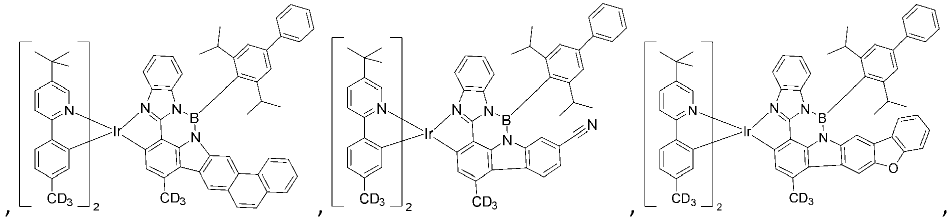 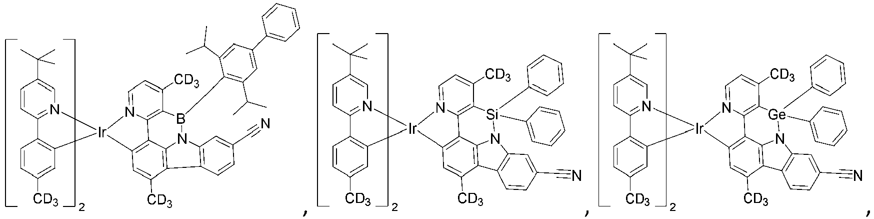 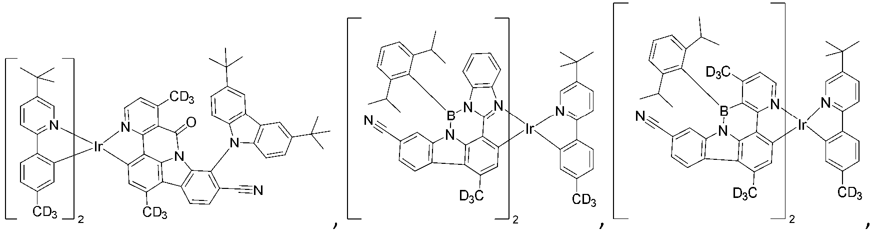 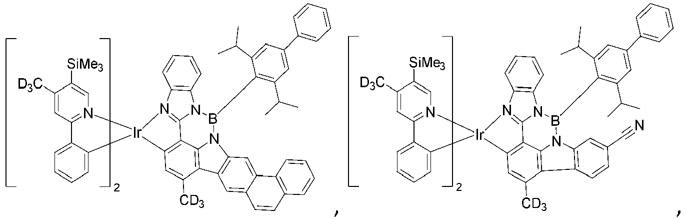 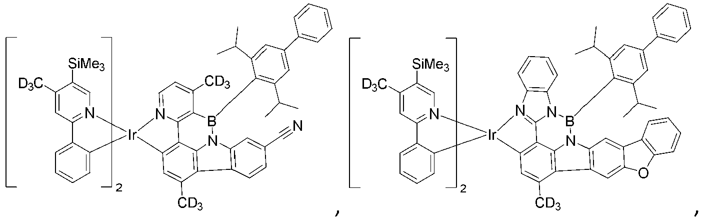 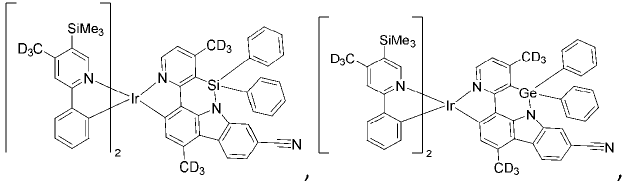 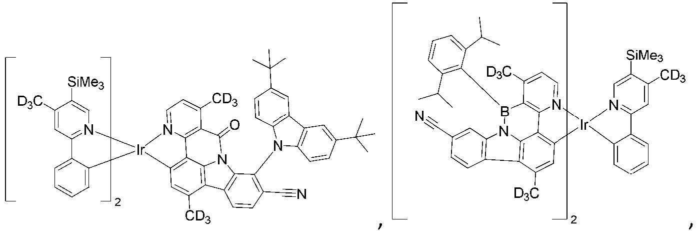 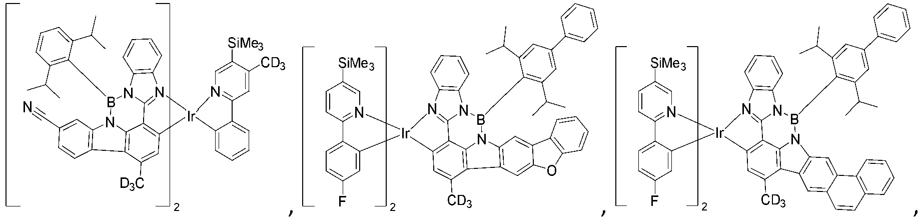 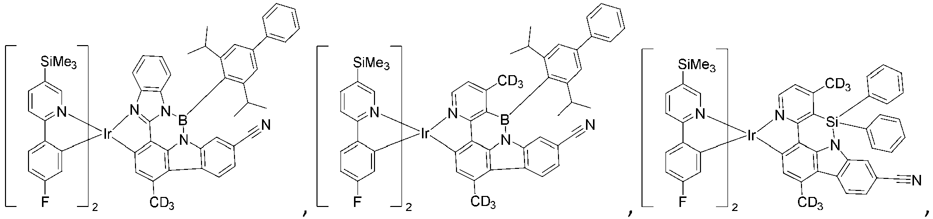 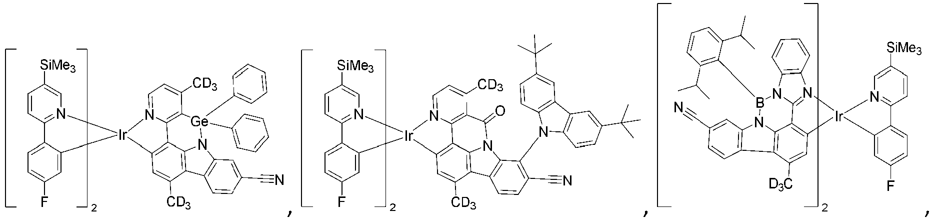 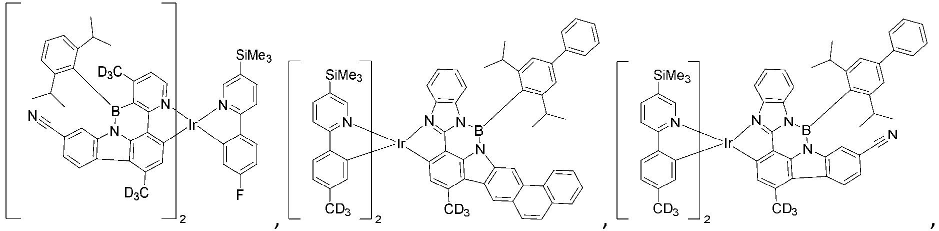 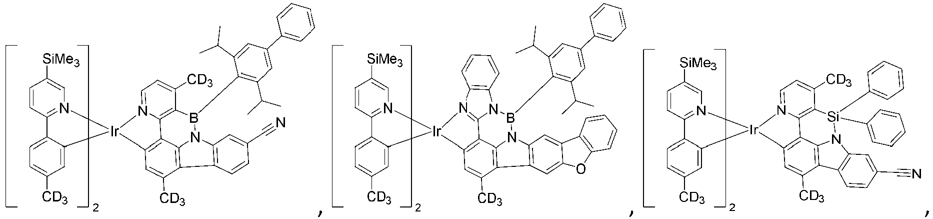 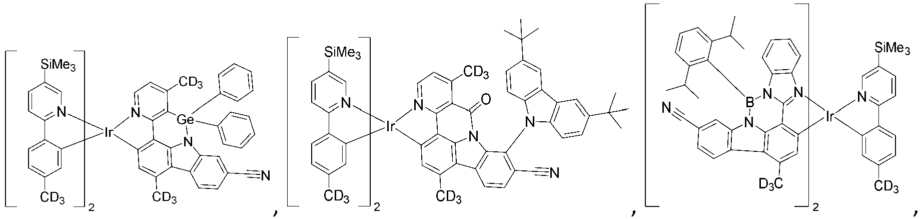 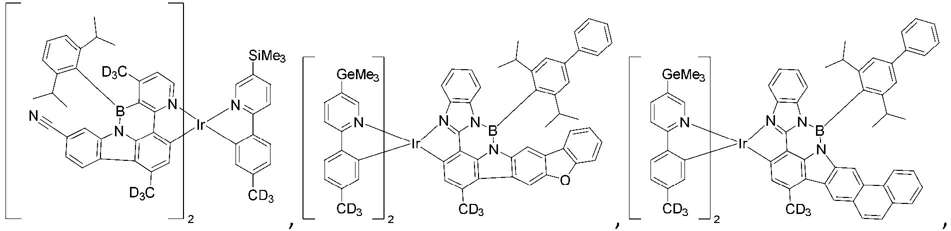 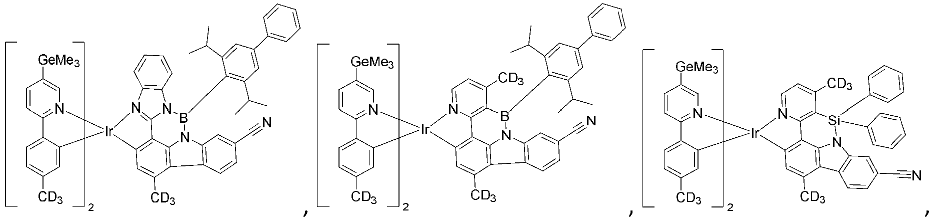 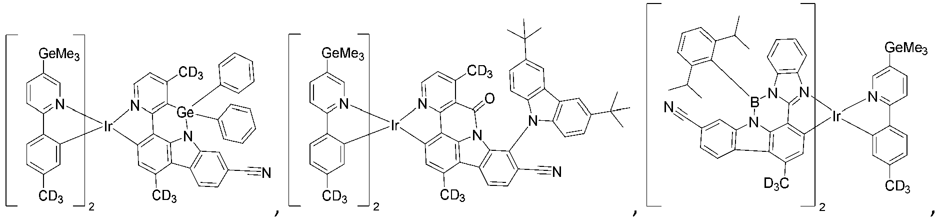 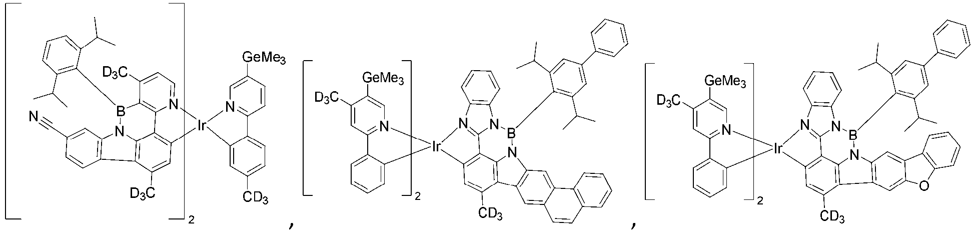 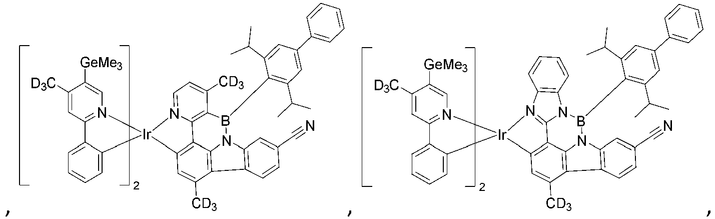 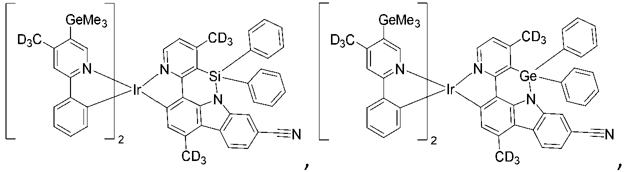 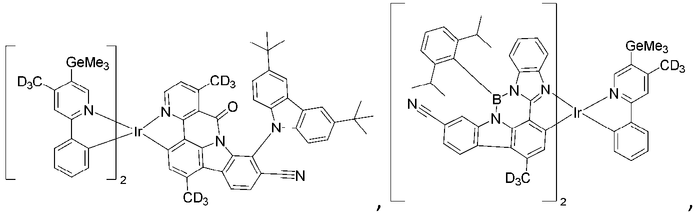 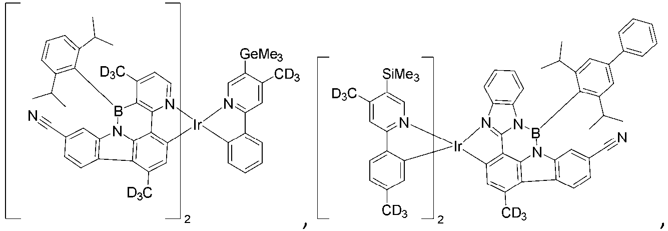 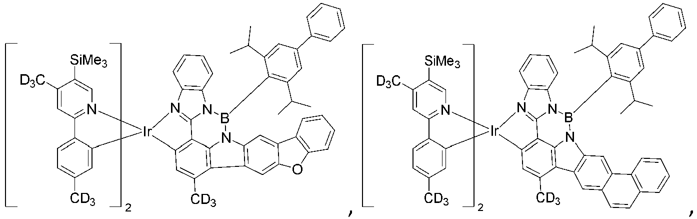 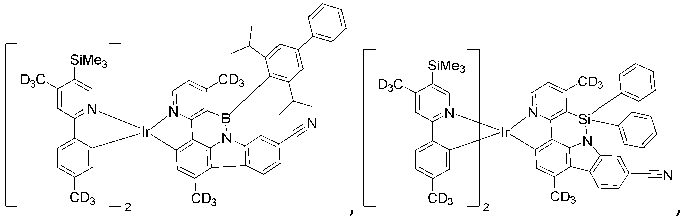 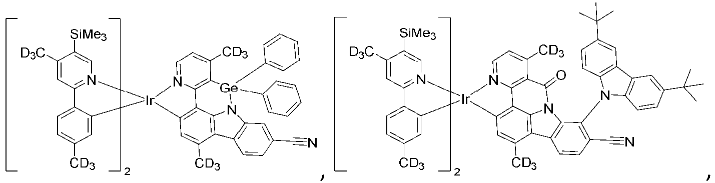 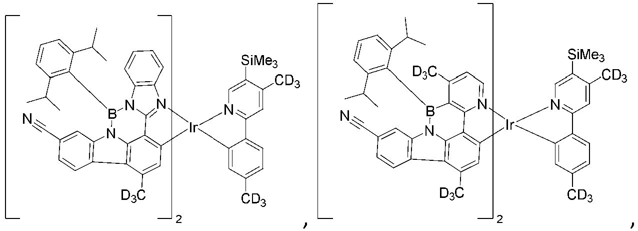 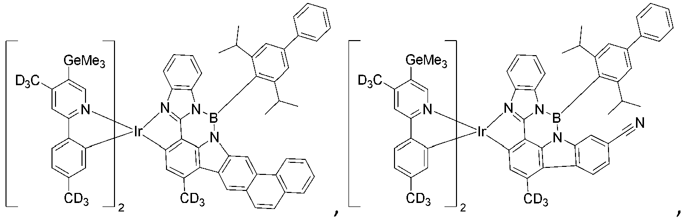 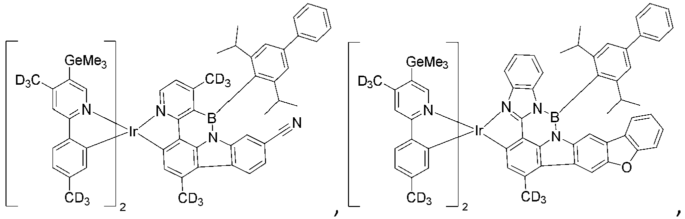 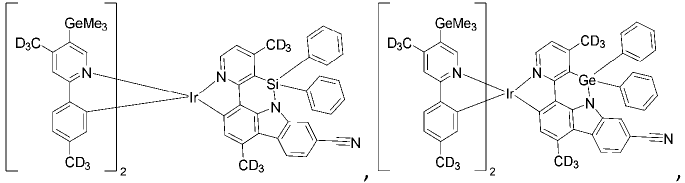 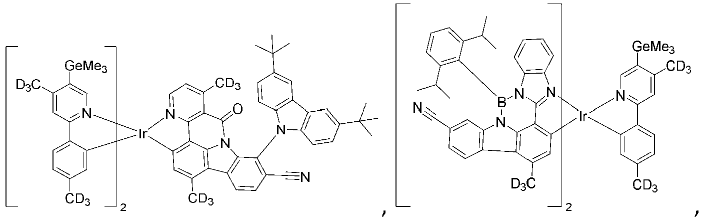 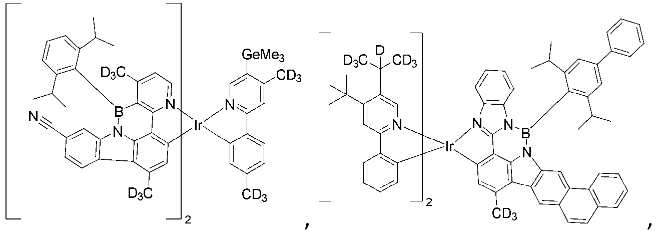 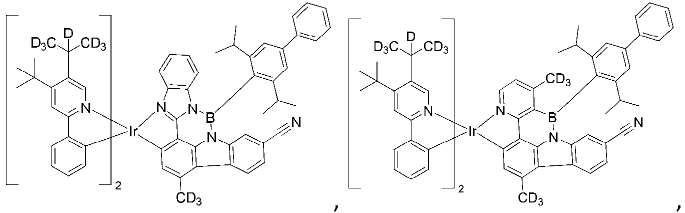 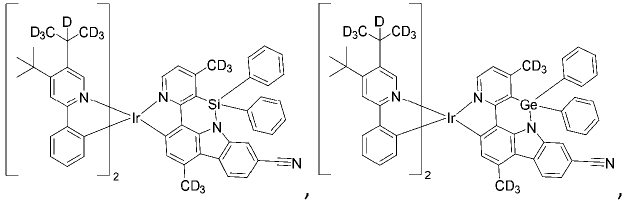 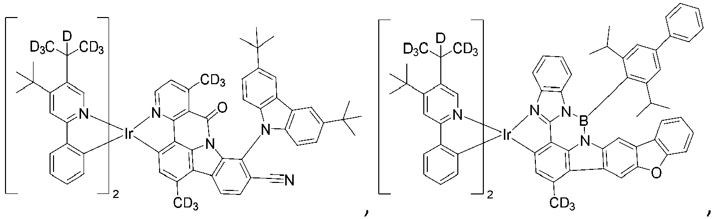 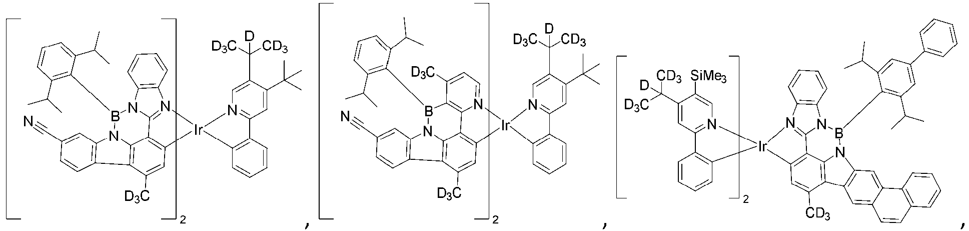 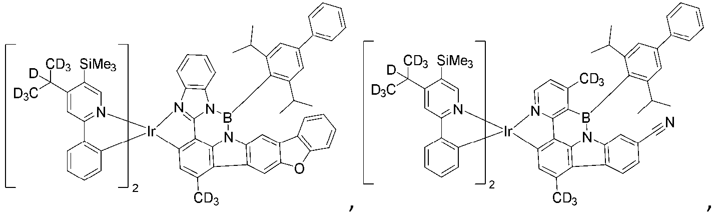 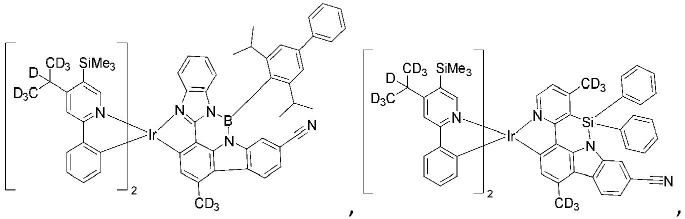 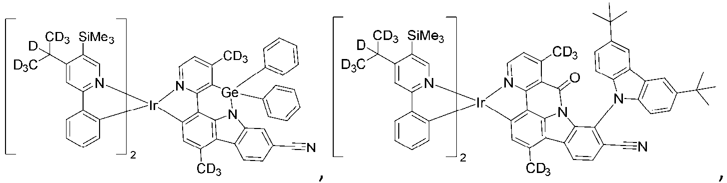 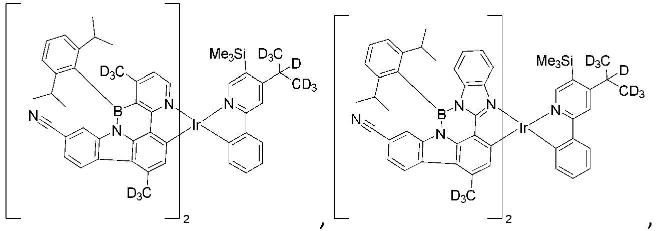 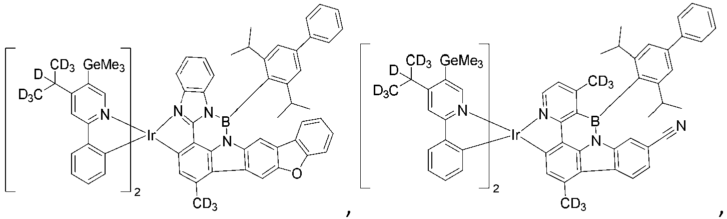 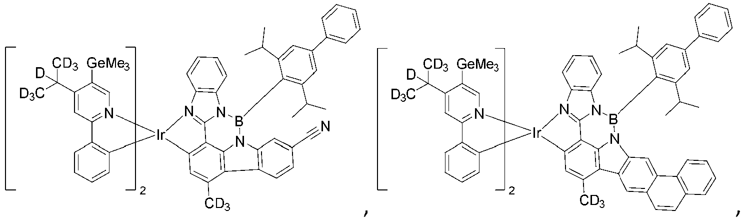 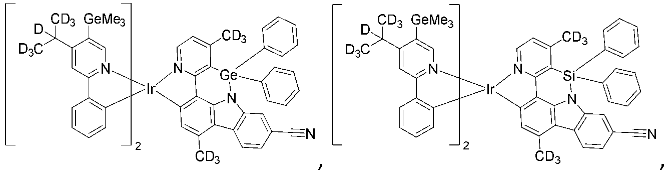 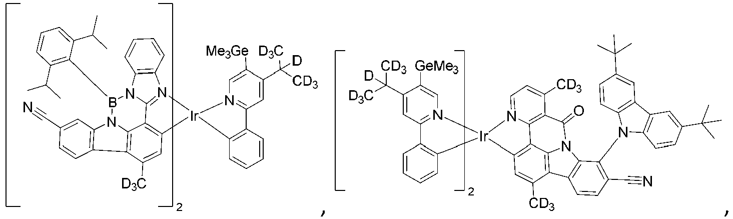 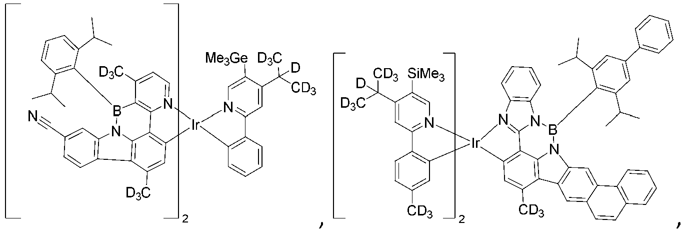 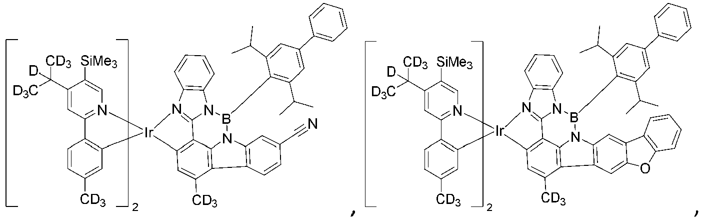 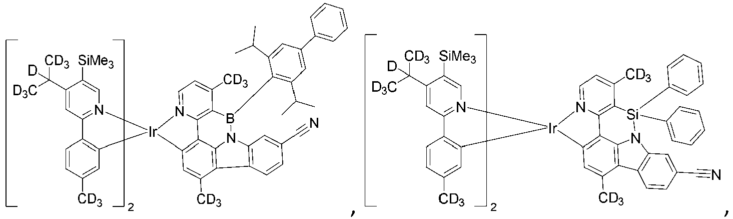 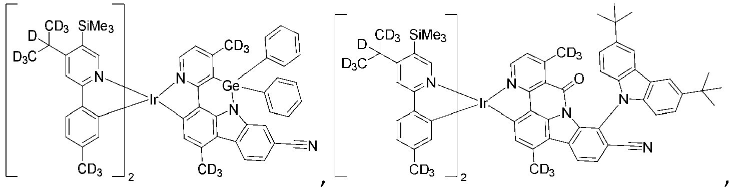 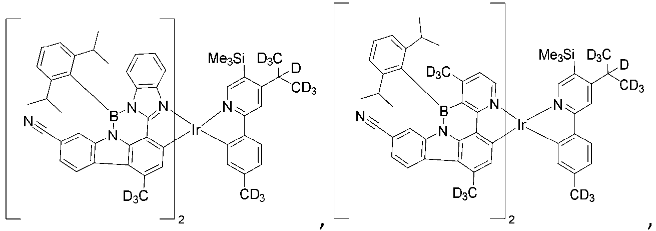 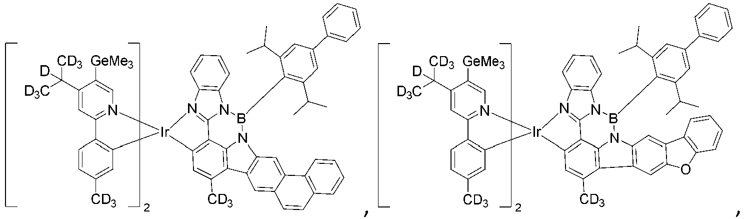 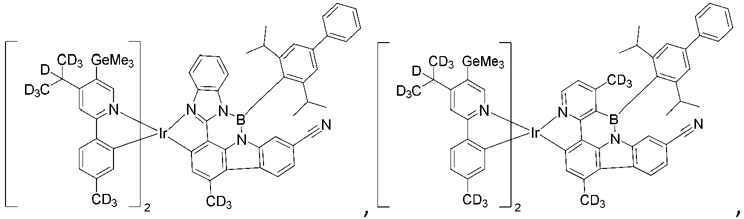 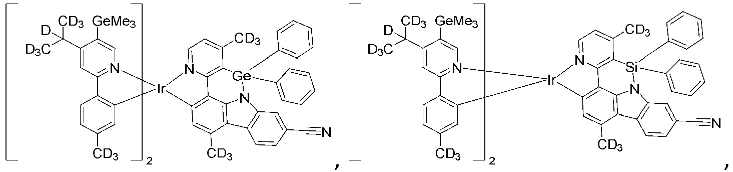 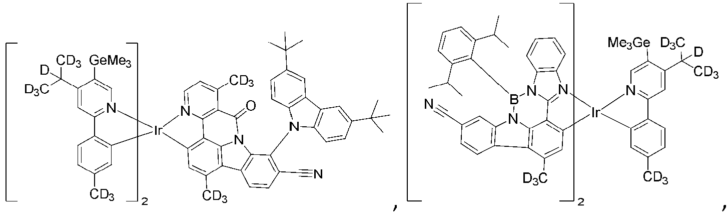 and

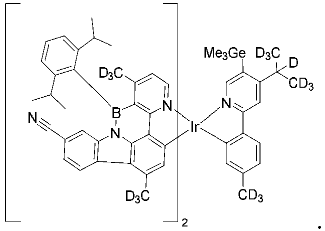

In some embodiments, the compound comprises a structure of Formula II: 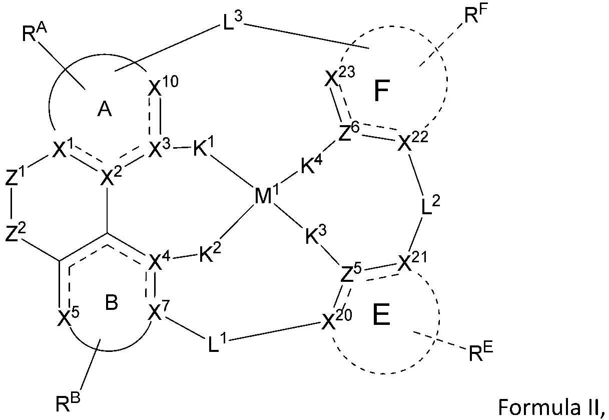 wherein:
M¹ is Pd or Pt;
X²⁰, Z⁵ and X²¹ are optionally joined or fused into moiety E;
X²², Z⁶ and X²³ are optionally joined or fused into moiety F;
moiety E (if present) is optionally substituted by R^{E} representing mono to the maximum allowable substitution;
moiety F (if present) is optionally substituted by R^{F} representing mono to the maximum allowable substitution;
   moieties E (if present) and F (if present) are each independently a monocyclic ring or a polycyclic fused ring system, wherein the monocyclic ring or each ring of the polycyclic fused ring system is independently a 5-membered to 10-membered carbocyclic or heterocyclic ring;
X²⁰ to X²³ are each independently C or N;
   Z⁵ and Z⁶ are each independently C or N;
K¹, K², K³, and K⁴ are each independently selected from the group consisting of a direct bond, O, S, N(R^{α}), P(R^{α}), B(R^{α}), C(R^{α})(R^{β}), and Si(R^{α})(R^{β}), wherein at least two of them are direct bonds;
   two adjacent R^{A}, R^{B}, R^{E}, and R^{F} can be joined or fused together to form a ring where chemically feasible; and
Z¹, Z², moiety A, moiety B, R^{A}, R^{B}, R^{C} and R^{D} are all defined the same as above;
   wherein -̅ -̅ -̅ -̅ -̅ -̅ represents a single bond or a double bond;
   wherein ----- between X²⁰, L¹, and X⁷ represents a direct bond or no bond;
   wherein ----- between X²³, L³, and X¹⁰ represents a direct bond or no bond;
   L¹, L², and L³ are each independently selected from the group consisting of a single bond, absent a bond, BR, BRR', NR, PR, P(O)R, O, S, Se, C=O, C=S, C=Se, C=NR, C=CRR', S=O, SO₂, CR, CRR', SiRR', and GeRR', wherein at least one of L¹ or L³ is present;
wherein when L¹ is present, L¹ is selected from the group consisting of direct bond, BR, BRR', NR, PR, P(O)R, O, S, Se, C=O, C=S, C=Se, C=NR, C=CRR', S=O, SO₂, CR, CRR', SiRR', and GeRR',
   wherein when L³ is present, L³ is selected from the group consisting of direct bond, BR, BRR', NR, PR, P(O)R, O, S, Se, C=O, C=S, C=Se, C=NR, C=CRR', S=O, SO₂, CR, CRR', SiRR', and GeRR',
each of R, R', R^{E} (if present), and R^{F} (if present) is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof;
and at least one of the following eleven conditions is true:
   1) moiety A is a 6-membered to 10-membered ring, and R^{B} on X⁵ and an R^{D} from Z² are joined to form a polycyclic fused ring system, and X⁴ is not N;
   2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
   3) moiety A is a 6-membered ring;
   4) moiety A is a 6-membered ring, X³ is N, and Z¹ is selected from the group consisting of BR^{C}, GaR^{C}, SiR^{C}R^{C'} and GeR^{C}R^{C'};
   5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
   6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
   7) at least one of R^{A}, R^{B}, R^{C} (if present), and R^{D} (if present) comprises a group selected from germyl, boryl, and partially or fully deuterated silyl;
   8) at least one of R^{A}, R^{B}, R^{C} (if present), and R^{D} (if present) comprises three 6-membered aromatic rings that are not fused to each other, or an aromatic ring fused by a non-aromatic ring;
   9) moiety A is a 5-membered ring and Z¹ is selected from the group consisting of C=O, C=S, and C=Se; and
   10) X¹ and X³ are both N, X₂ is C, and moiety A is an imidazole ring, and two R^{A} are joined to form a benzene ring which is further substituted;
   11) the compound comprises a structure of 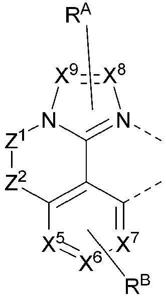 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not

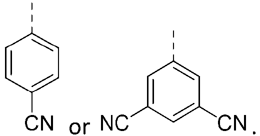

In some embodiments, when moiety E is present, it is a 5-membered or 6-membered carbocyclic or heterocyclic aromatic rings, X²⁰ and X²¹ are each independently C or N, Z⁵ is C or N, R^{E} is present and represents mono to the maximum allowable substitution, or no substitution, and R^{E} is a hydrogen, or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof.

In some embodiments, when moiety E is absent, then L¹ is absent, K³ is a direct bond, R^{E} and X²⁰ are absent, X²¹ is selected from BR, BRR', NR, NRR', PR, PRR', P(O)R, O, S, Se, C=O, C=S, C=Se, C=NR, C=CRR', S=O, SO₂, CR, CRR', SiRR', and GeRR', and Z⁵ is selected from the group consisting of CR, NR, O, S, Se, P, and As.

In some embodiments, when moiety F is present, it is a 5-membered or 6-membered carbocyclic or heterocyclic aromatic rings, X²² and X²³ are each independently C or N, Z⁶ is C or N, R^{F} is present and represents mono to the maximum allowable substitution, or no substitution, and R^{E} is a hydrogen, or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof.

In some embodiments, when moiety F is absent, then L³ is absent, K⁴ is a direct bond, R^{F} and X²³ are absent, X²² is selected from BR, BRR', NR, NRR', PR, PRR', P(O)R, O, S, Se, C=O, C=S, C=Se, C=NR, C=CRR', S=O, SO₂, CR, CRR', SiRR', and GeRR', and Z⁶ is selected from the group consisting of CR, NR, O, S, Se, P, and As.

In some embodiments, the compound consists essentially of Formula II.

In some embodiments, the compound has a structure of Formula II.

In some embodiments, the compound comprises a structure of Formula Ila or Formula Ilb:

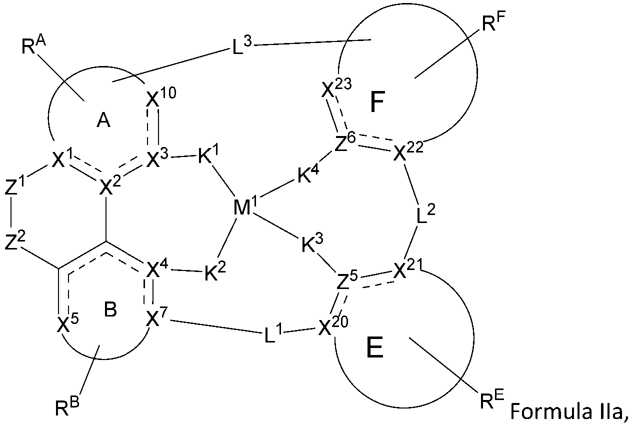

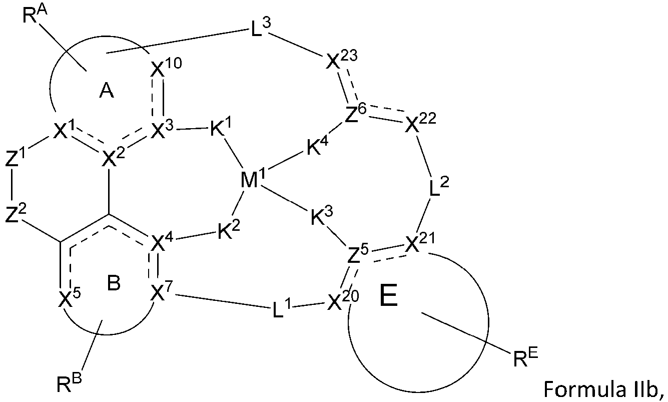

In some embodiments, the compound has the structure of Formula II, at least one R, R', R^{α}, R^{β}, R^{A}, R^{B}, R^{C}, R^{C'} R^{D}, R^{E} and R^{F} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{C'} is partially or fully deuterated. In some embodiments, at least one R^{D} is partially or fully deuterated. In some embodiments, at least one R^{E} is partially or fully deuterated. In some embodiments, at least one R^{F} is partially or fully deuterated. In some embodiments, at least one R^{α} or R^{β} is partially or fully deuterated. In some embodiments, at least one R or R' is partially or fully deuterated.

In some embodiments, the compound has the structure of Formula II, at least one R, R', R^{α}, R^{β}, R^{A}, R^{B}, R^{C}, R^{C'} R^{D}, R^{E} and R^{F} is selected from the group consisting of the General Substituents defined herein. In some embodiments, at least one R^{A} is selected from the group consisting of the General Substituents defined herein. In some embodiments, at least one R^{B} is selected from the group consisting of the General Substituents defined herein. In some embodiments, at least one R^{C} is selected from the group consisting of the General Substituents defined herein. In some embodiments, at least one R^{C'} is selected from the group consisting of the General Substituents defined herein. In some embodiments, at least one R^{D} is selected from the group consisting of the General Substituents defined herein. In some embodiments, at least one R^{E} is selected from the group consisting of the General Substituents defined herein. In some embodiments, at least one R^{F} is selected from the group consisting of the General Substituents defined herein. In some embodiments, at least one R or R' is selected from the group consisting of the General Substituents defined herein. In some embodiments, at least one R^{α} or R^{β} is selected from the group consisting of the General Substituents defined herein.

In some embodiments, the compound has the structure of Formula II, at least one R, R', R^{α}, R^{β}, R^{A}, R^{B}, R^{C}, R^{C'} R^{D}, R^{E} and R^{F} is selected from the group consisting of the Preferred General Substituents defined herein. In some embodiments, at least one R^{A} is selected from the group consisting of the Preferred General Substituents defined herein. In some embodiments, at least one R^{B} is selected from the group consisting of the Preferred General Substituents defined herein. In some embodiments, at least one R^{C} is selected from the group consisting of the Preferred General Substituents defined herein. In some embodiments, at least one R^{C'} is selected from the group consisting of the Preferred General Substituents defined herein. In some embodiments, at least one R^{D} is selected from the group consisting of the Preferred General Substituents defined herein. In some embodiments, at least one R^{E} is selected from the group consisting of the Preferred General Substituents defined herein. In some embodiments, at least one R^{F} is selected from the group consisting of the Preferred General Substituents defined herein. In some embodiments, at least one R or R' is selected from the group consisting of the Preferred General Substituents defined herein. In some embodiments, at least one R^{α} or R^{β} is selected from the group consisting of the Preferred General Substituents defined herein.

In some embodiments, the compound has the structure of Formula II, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments, the compound has the structure of Formula II, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments, the compound has the structure of Formula II, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments, the compound has the structure of Formula II, at least one R^{C'} is or comprises an electron-withdrawing group from the EWG1 LIST as defined herein. In some embodiments, at least one R^{C'} is or comprises an electron-withdrawing group from the EWG2 LIST as defined herein. In some embodiments, at least one R^{C'} is or comprises an electron-withdrawing group from the EWG3 LIST as defined herein. In some embodiments, at least one R^{C'} is or comprises an electron-withdrawing group from the EWG4 LIST as defined herein. In some embodiments, at least one R^{C'} is or comprises an electron-withdrawing group from the Pi-EWG LIST as defined herein.

In some embodiments, the compound has the structure of Formula II, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} is or comprises an electron-withdrawing group from the Pi-EWG LIST as defined herein.

In some embodiments, the compound has the structure of Formula II, at least one R^{E} is or comprises an electron-withdrawing group from the EWG1 LIST as defined herein. In some embodiments, at least one R^{E} is or comprises an electron-withdrawing group from the EWG2 LIST as defined herein. In some embodiments, at least one R^{E} is or comprises an electron-withdrawing group from the EWG3 LIST as defined herein. In some embodiments, at least one R^{E} is or comprises an electron-withdrawing group from the EWG4 LIST as defined herein. In some embodiments, at least one R^{E} is or comprises an electron-withdrawing group from the Pi-EWG LIST as defined herein.

In some embodiments, the compound has the structure of Formula II, at least one R^{F} is or comprises an electron-withdrawing group from the EWG1 LIST as defined herein. In some embodiments, at least one R^{F} is or comprises an electron-withdrawing group from the EWG2 LIST as defined herein. In some embodiments, at least one R^{F} is or comprises an electron-withdrawing group from the EWG3 LIST as defined herein. In some embodiments, at least one R^{F} is or comprises an electron-withdrawing group from the EWG4 LIST as defined herein. In some embodiments, at least one R^{F} is or comprises an electron-withdrawing group from the Pi-EWG LIST as defined herein.

In some embodiments, moiety E (if present) and moiety F (if present) are both 6-membered aromatic rings.

In some embodiments, moiety F (if present) is a 5-membered or 6-membered heteroaromatic ring.

In some embodiments, L¹ is O or CRR'.

In some embodiments, Z⁵ is N and Z⁶ is C.

In some embodiments, Z⁵ is C and Z⁶ is N.

In some embodiments, L² is a direct bond.

In some embodiments, L² is NR.

In some embodiments, K³ and K⁴ are both direct bonds.

In some embodiments, one of K³ and K⁴ is O.

In some embodiments, each of moiety E and moiety F is independently selected from benzene, pyridine, pyrimidine, pyridazine, pyrazine, triazine, imidazole, imidazole derived carbene, pyrazole, pyrrole, oxazole, furan, thiophene, thiazole, triazole, naphthalene, quinoline, isoquinoline, quinazoline, benzofuran, aza-benzofuran, phenanthro[3,2-b]benzofuran, benzoxazole, aza-benzoxazole, benzothiophene, aza-benzothiophene, benzothiazole, aza-benzothiazole, benzoselenophene, aza-benzoselenophene, indene, aza-indene, indole, azaindole, benzimidazole, aza-benzimidazole, benzimidazole derived carbene, aza-benzimidazole derived carbene, benzobenzimidazole, aza-benzobenzimidazole, carbazole, aza-carbazole, dibenzofuran, aza-dibenzofuran, dibenzothiophene, aza-dibenzothiophene, quinoxaline, phthalazine, phenanthrene, aza-phenanthrene, anthracene, aza-anthracene, phenanthridine, fluorene, and aza-fluorene.

In some embodiments, the compound is selected from the group consisting of compounds having the formula of Pt(L_{A'})(L*y*): 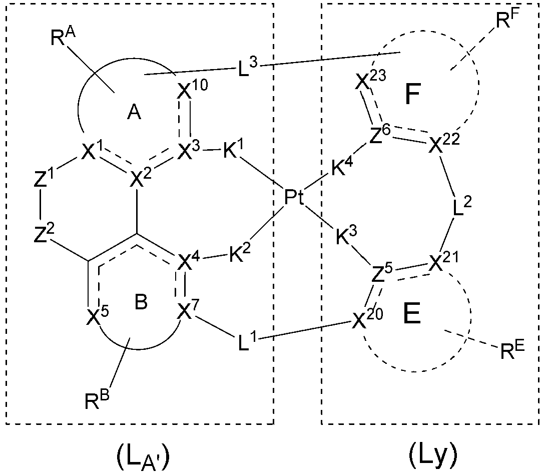 wherein L_{A'} is selected from the group consisting of the structures of from L_{A1'}-1 to L_{A1'}-470 as shown in the following LIST 10: 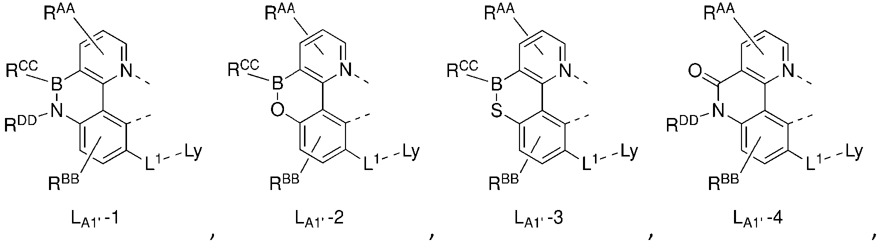 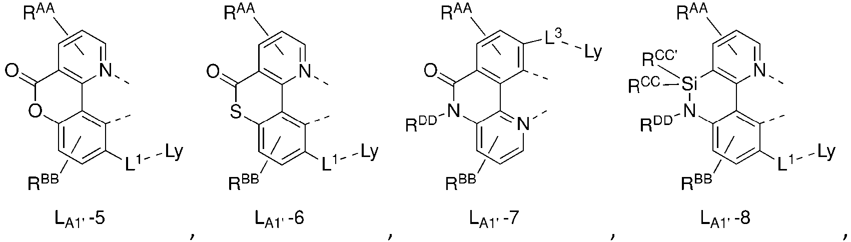 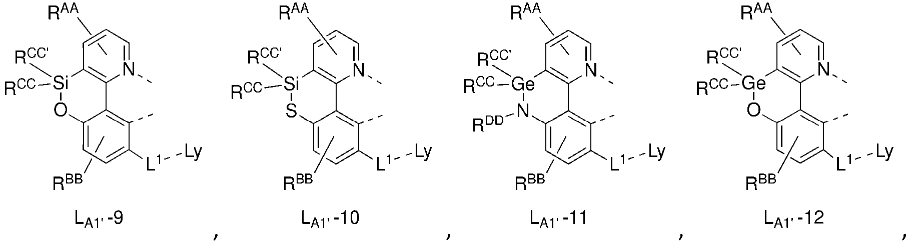 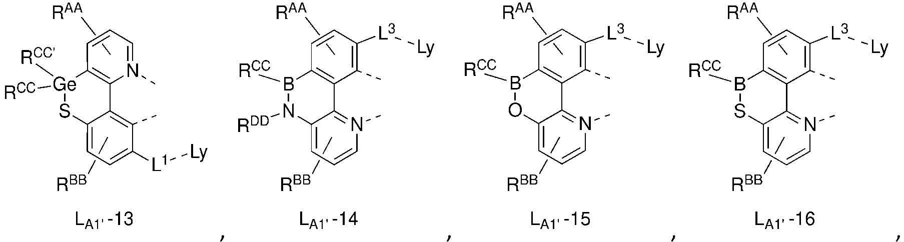 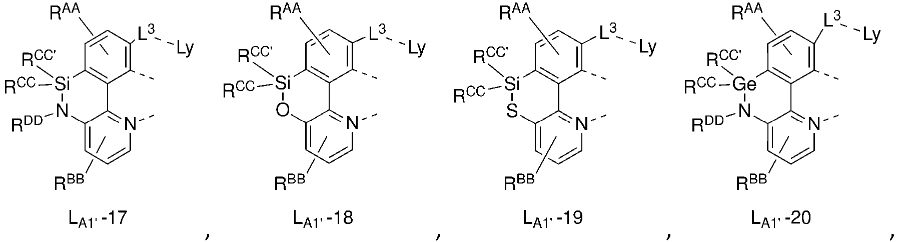 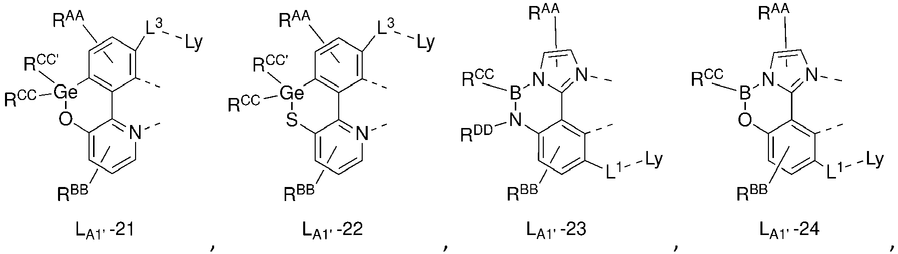 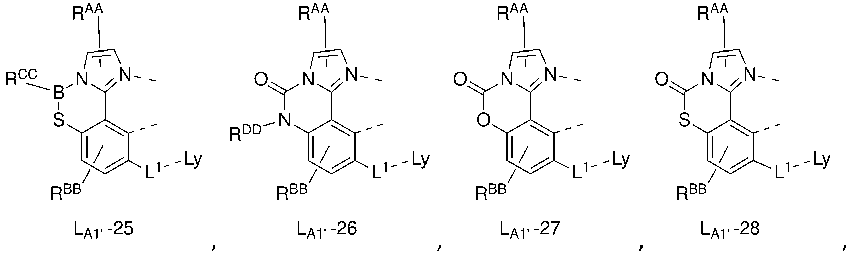 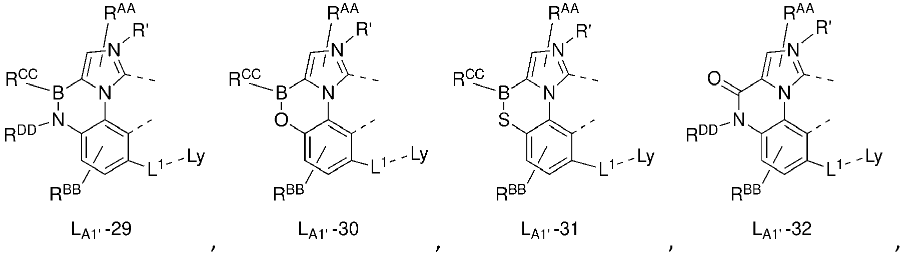 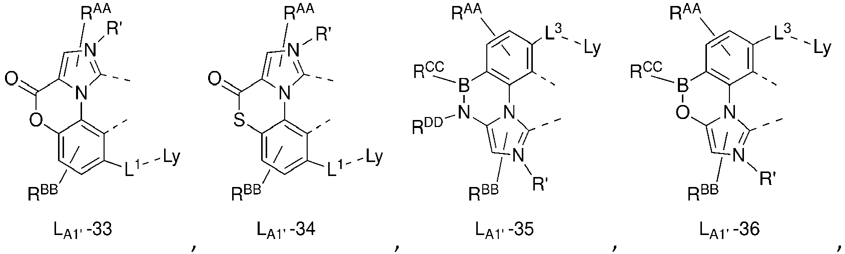 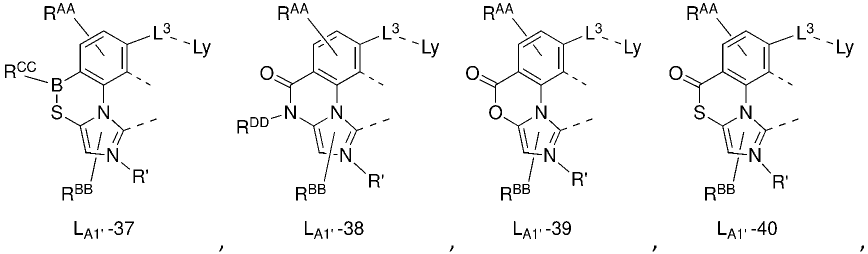 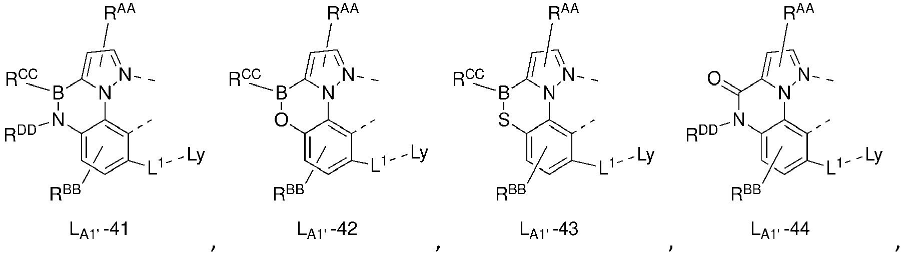 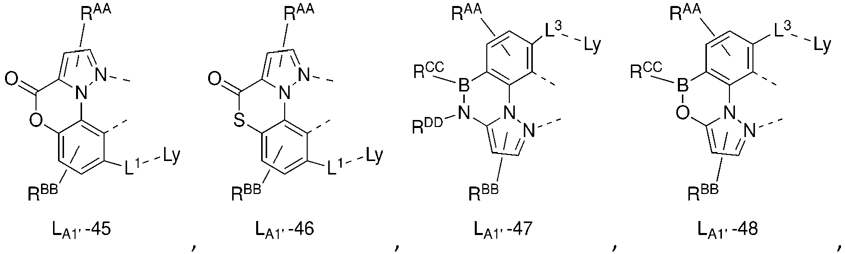 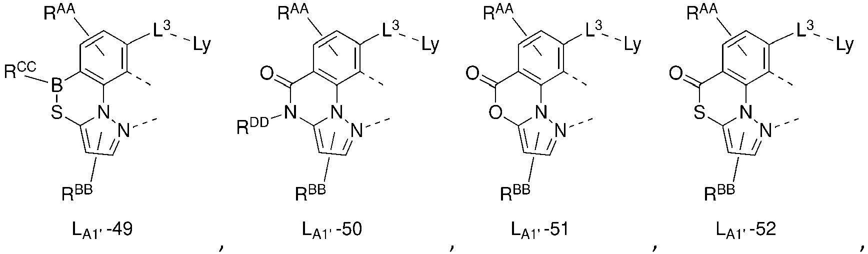 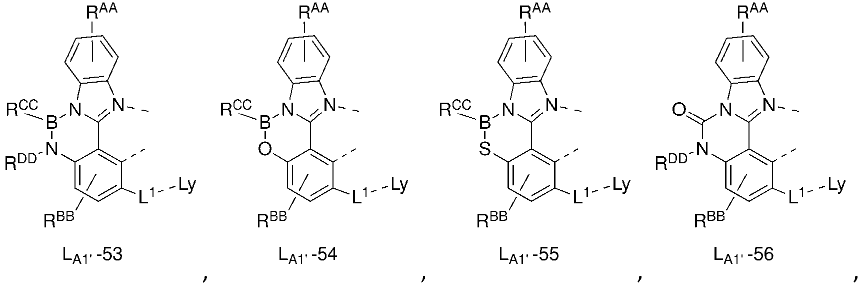 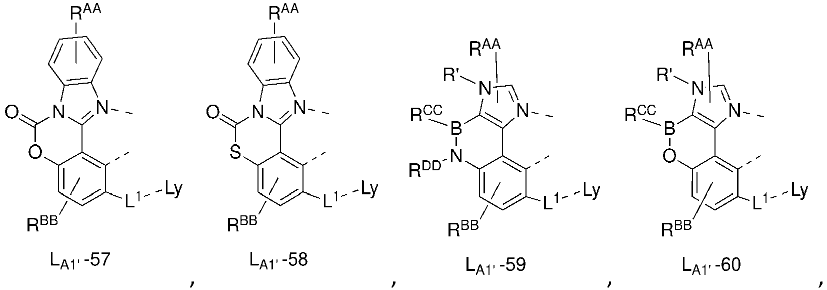 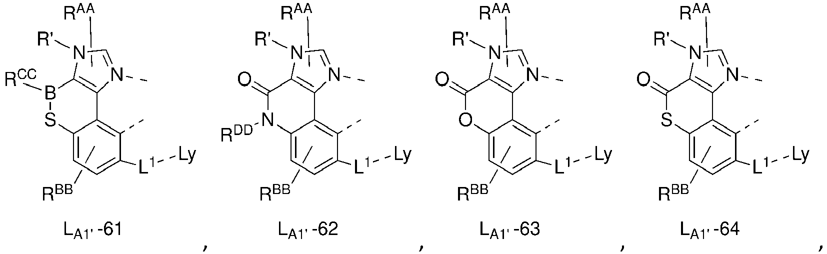 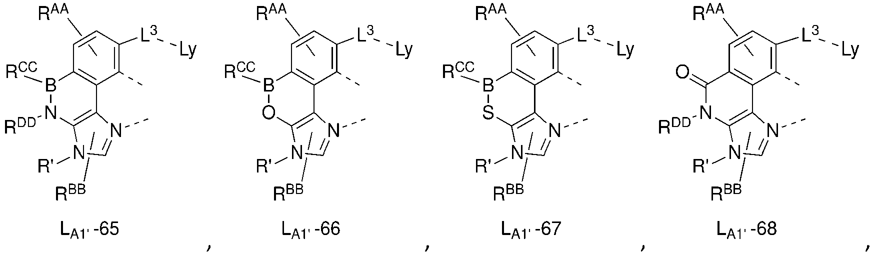 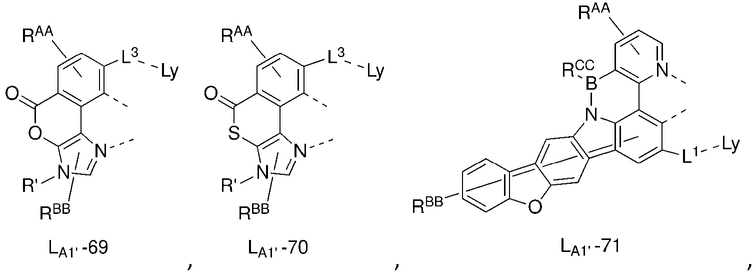 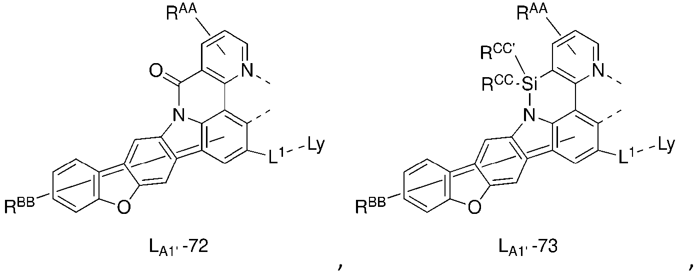 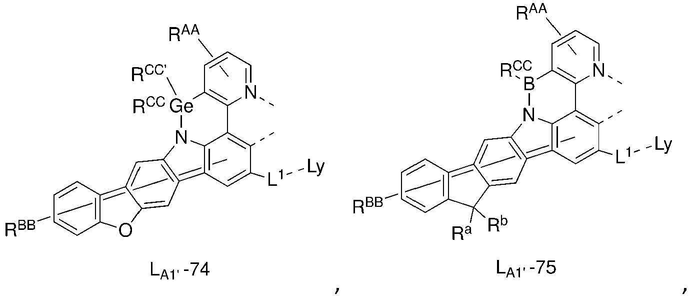 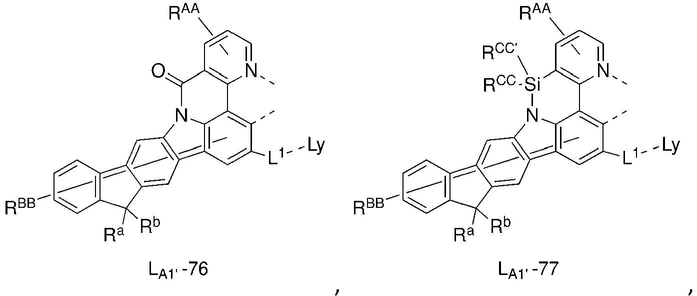 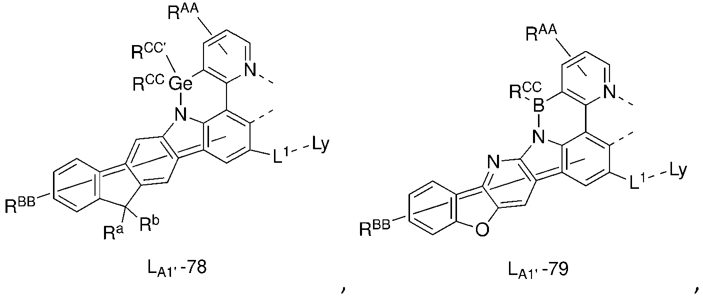 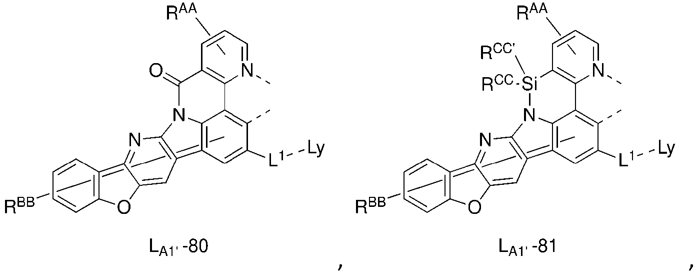 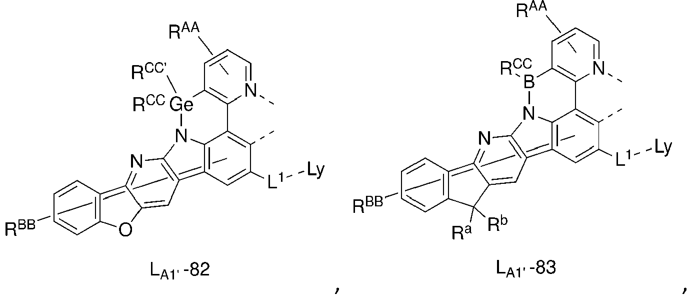 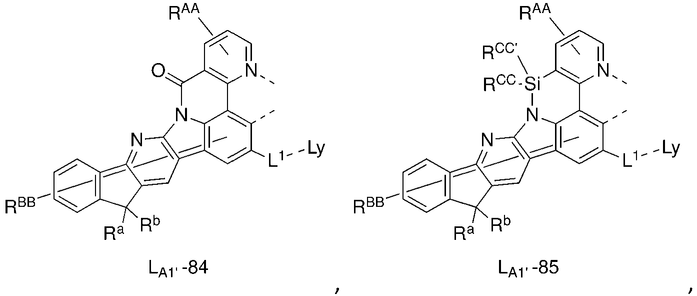 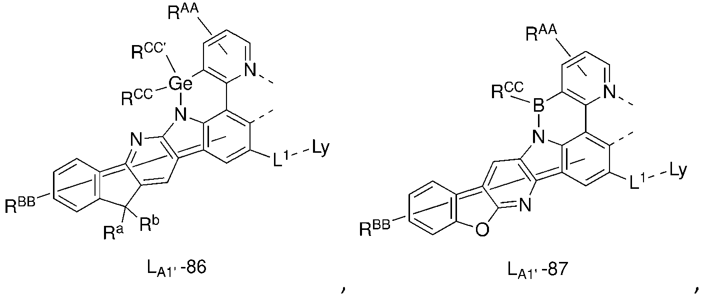 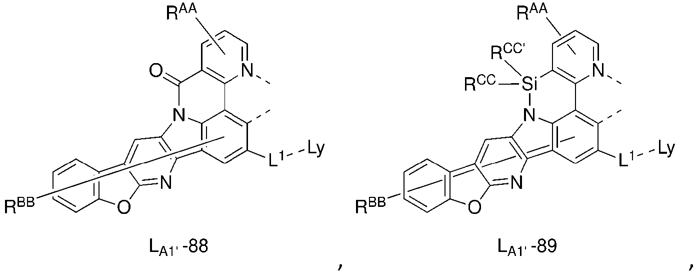 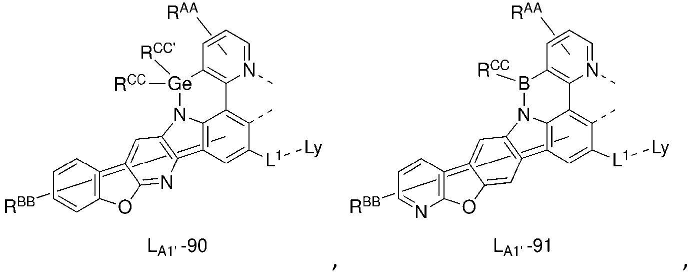 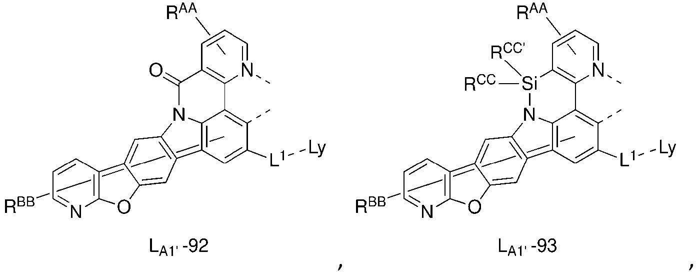 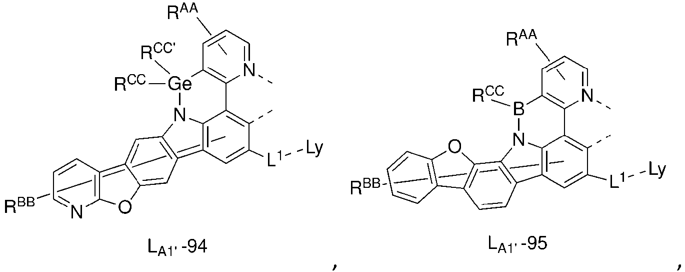 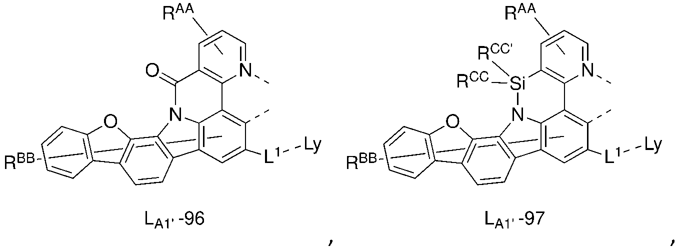 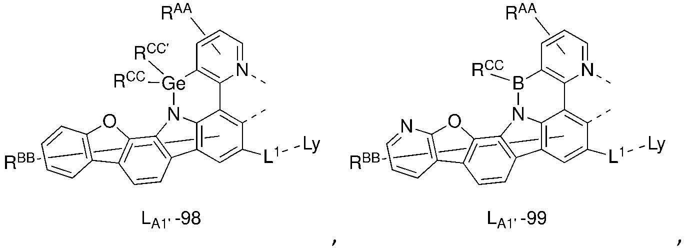 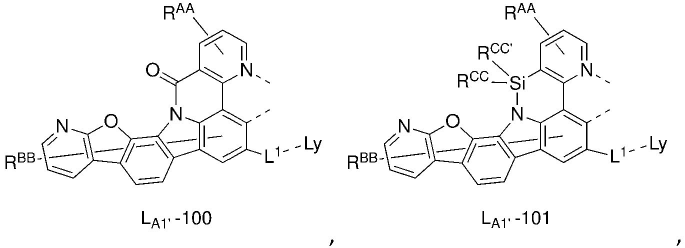 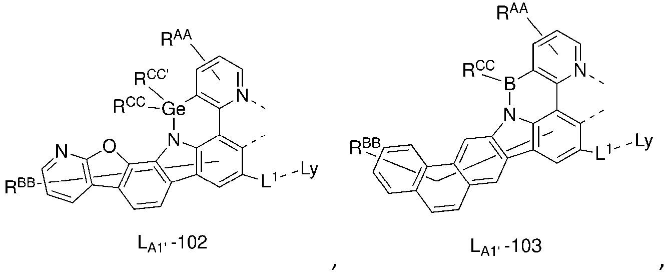 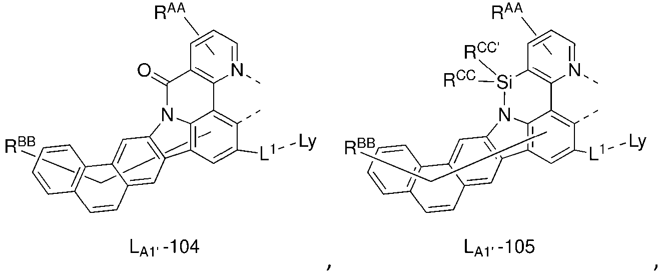 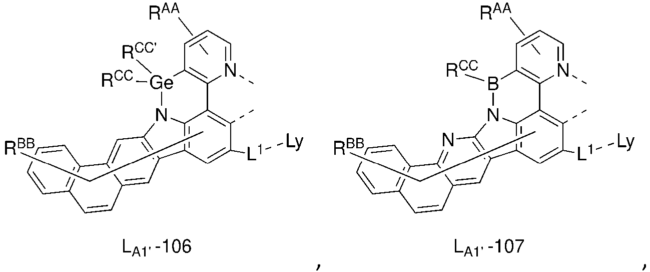 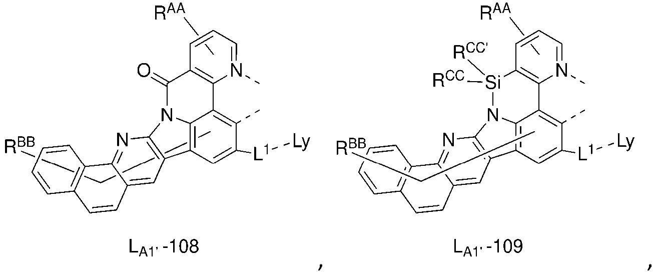 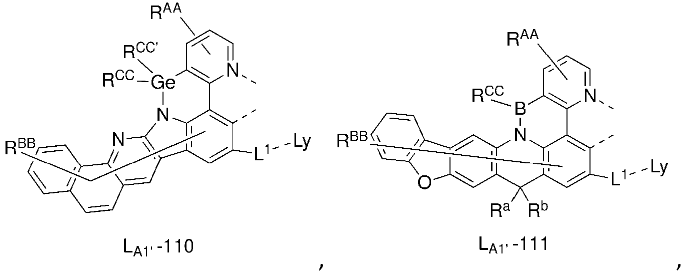 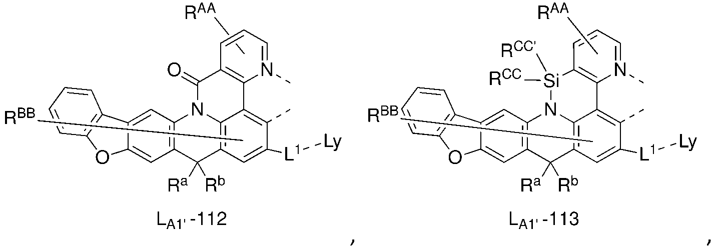 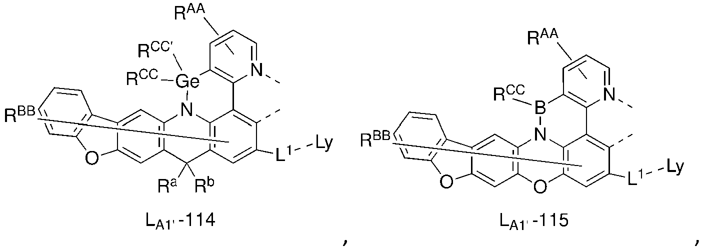 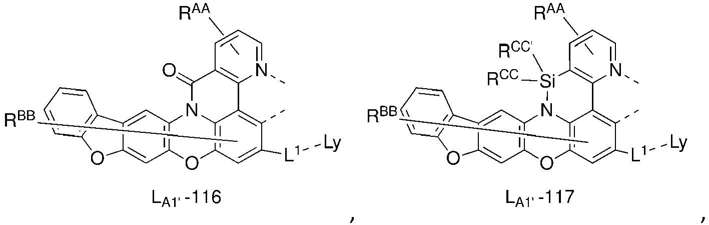 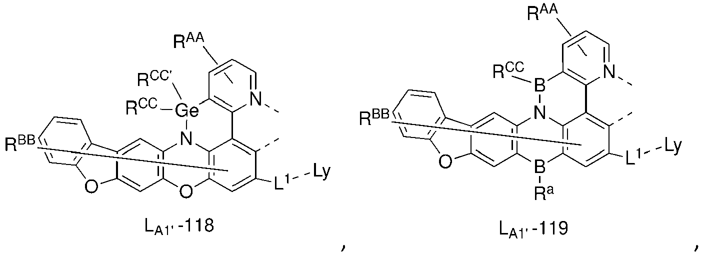 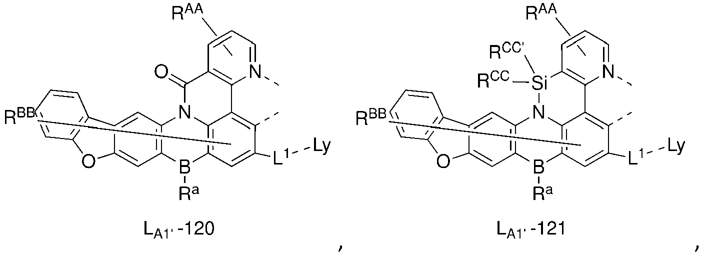 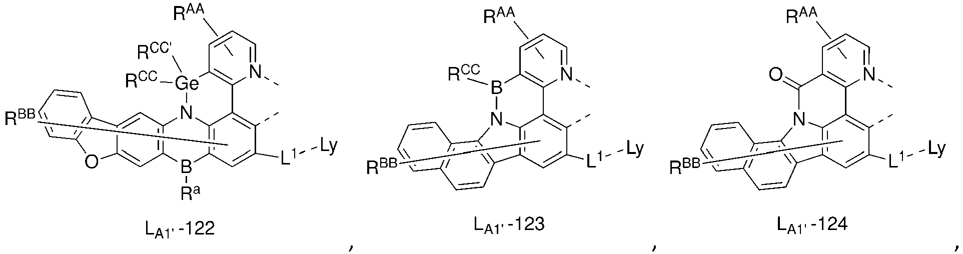 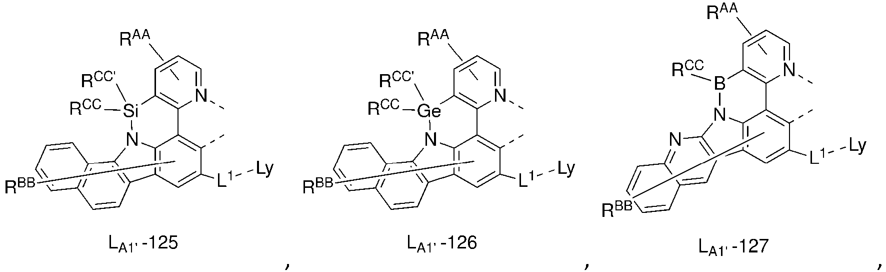 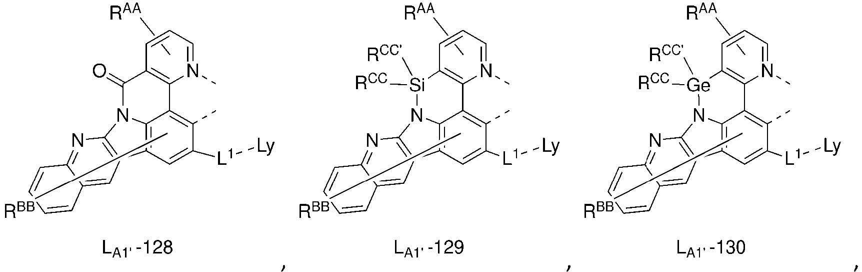 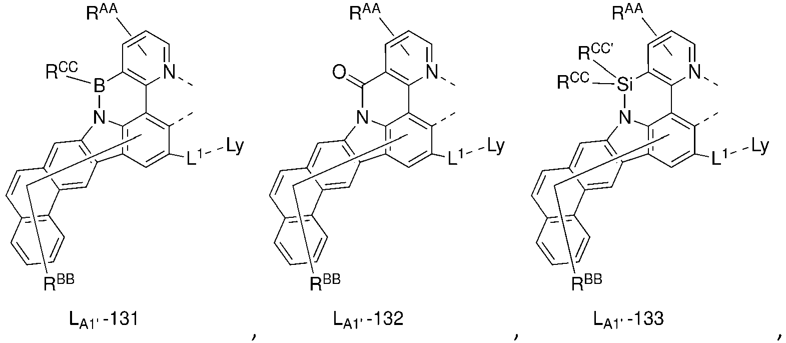 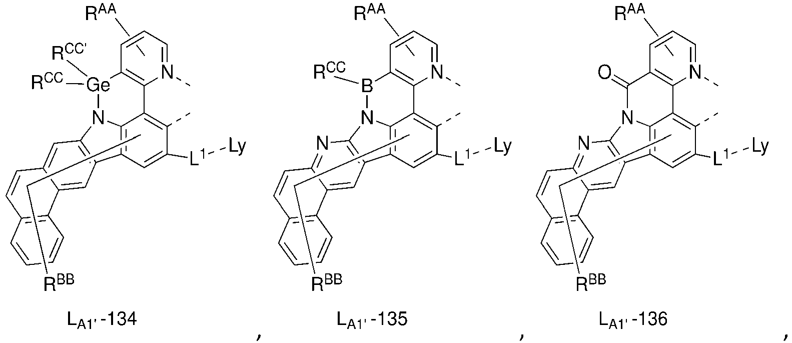 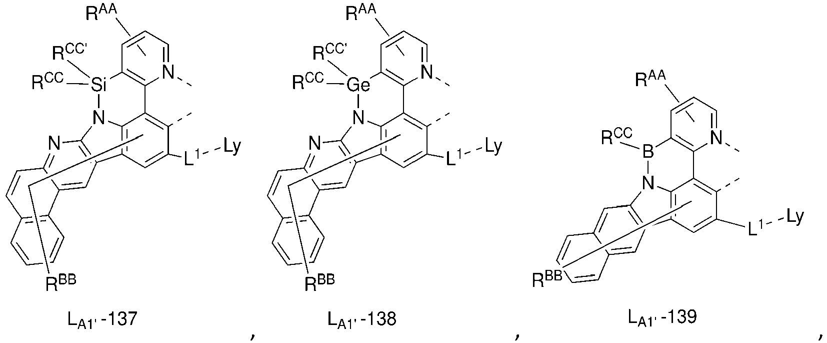 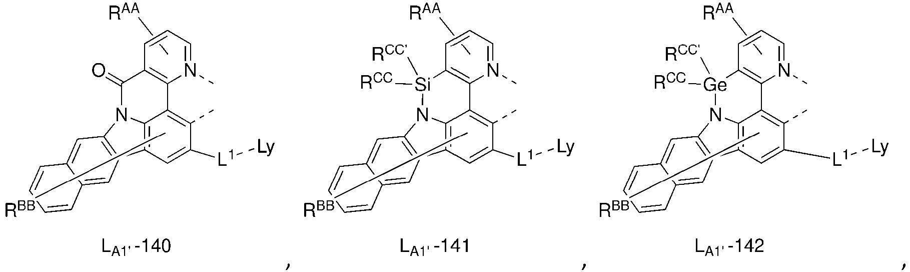 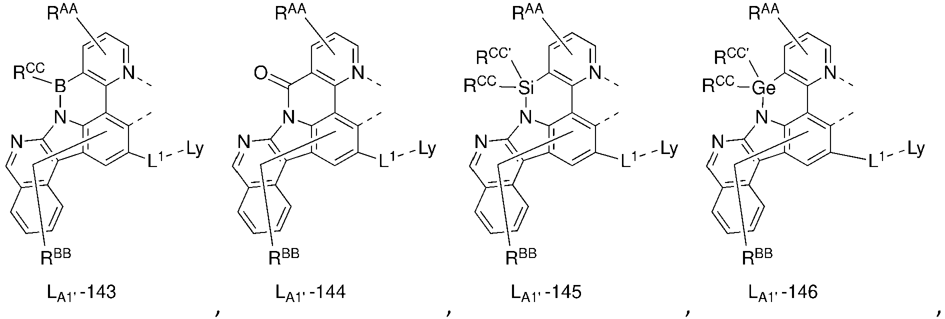 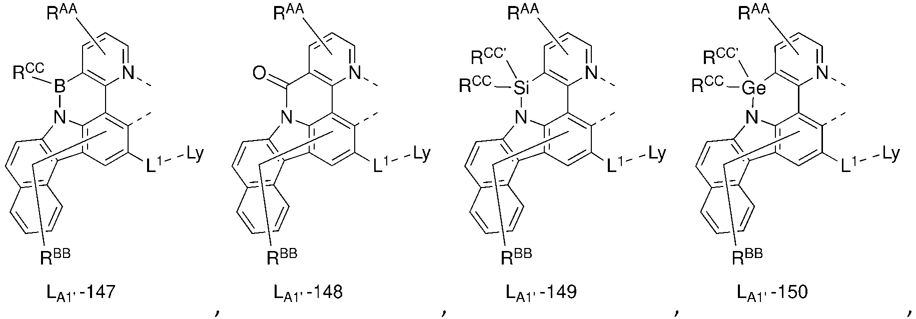 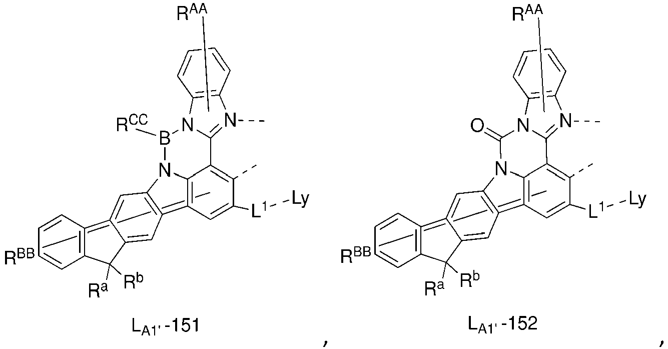 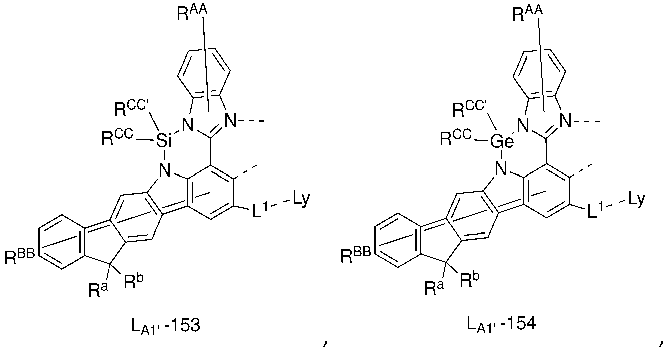 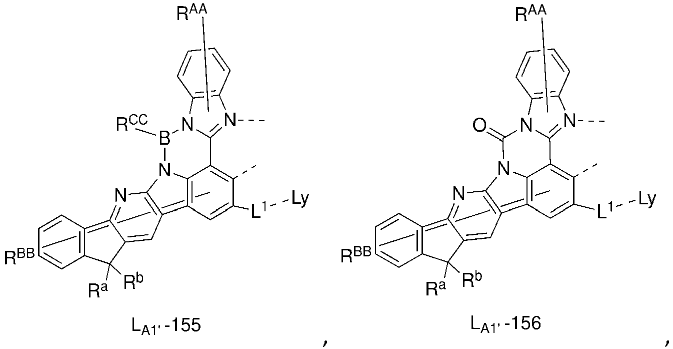 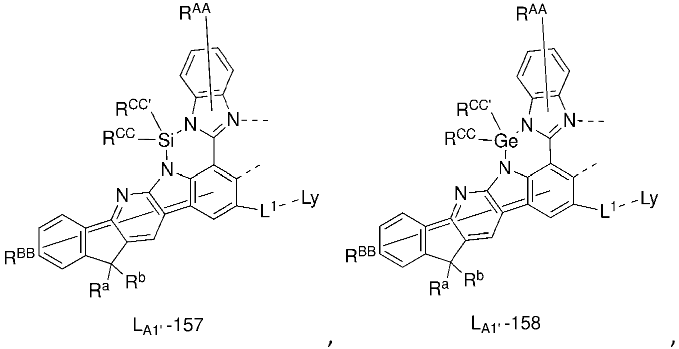 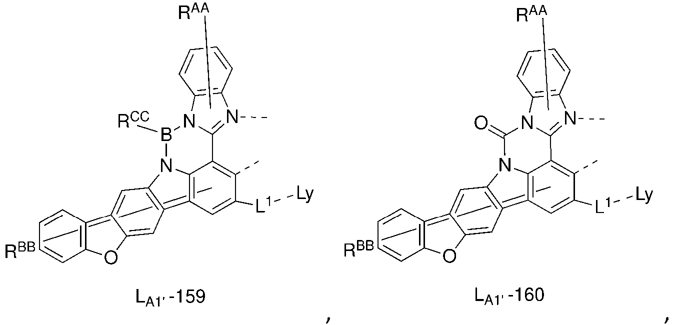 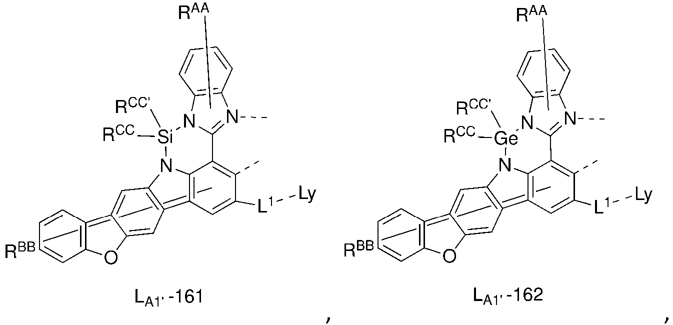 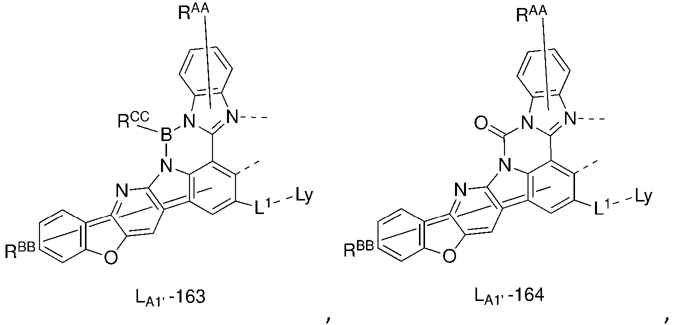 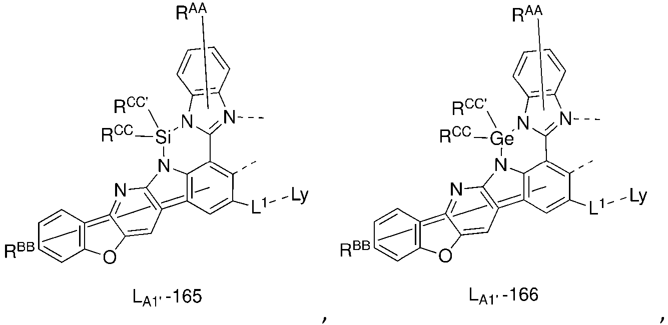 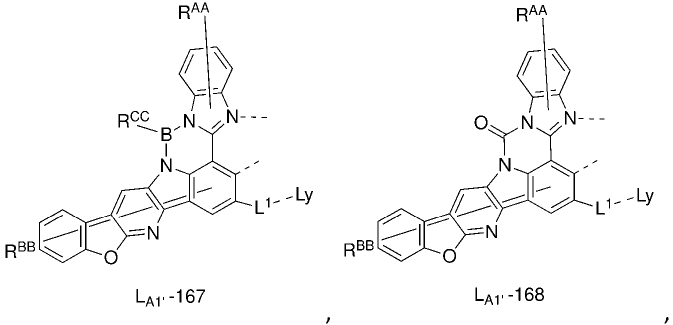 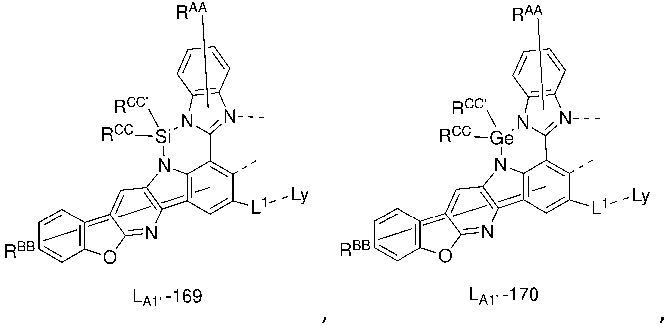 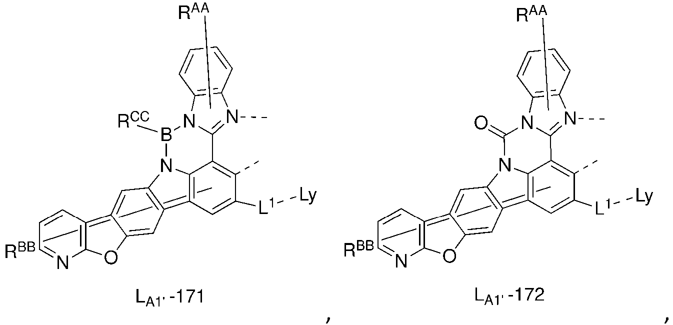 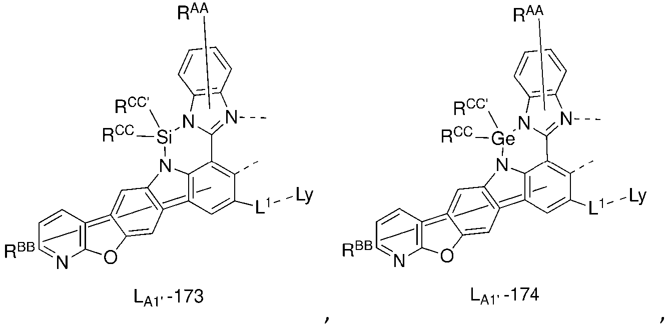 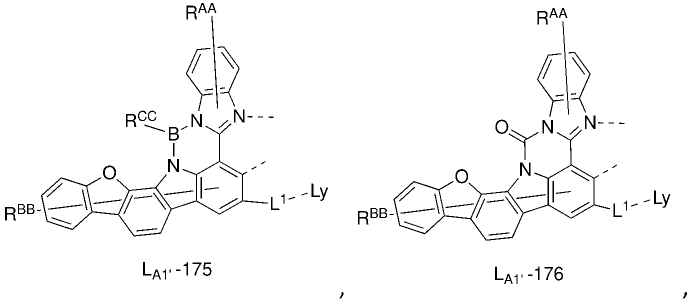 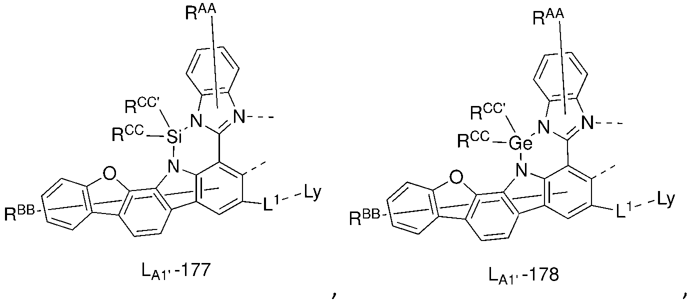 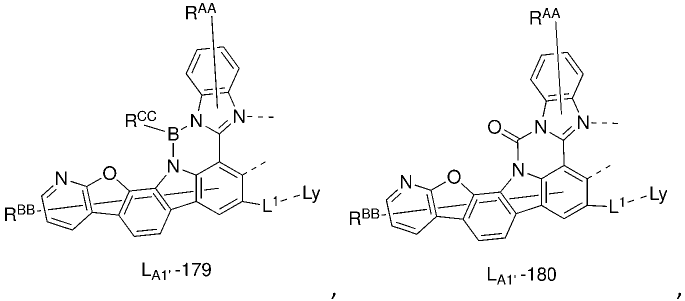 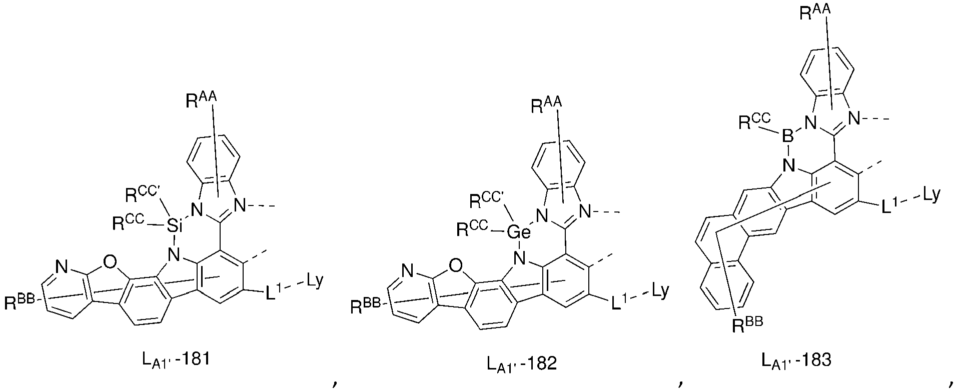 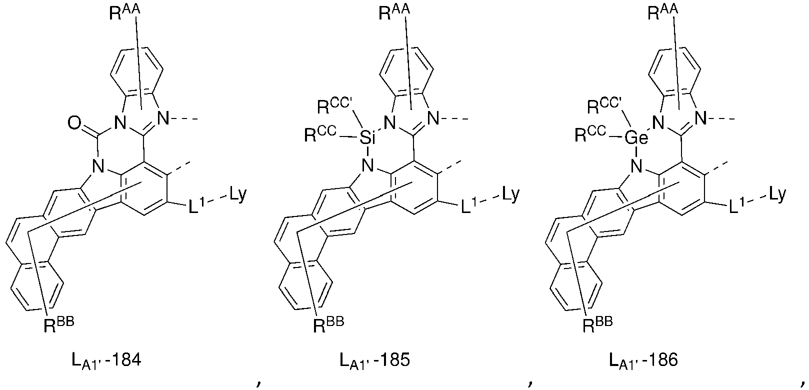 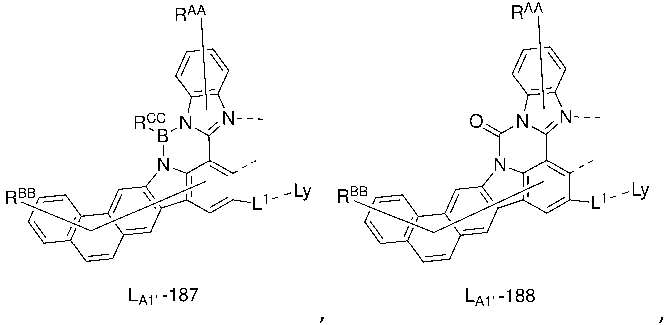 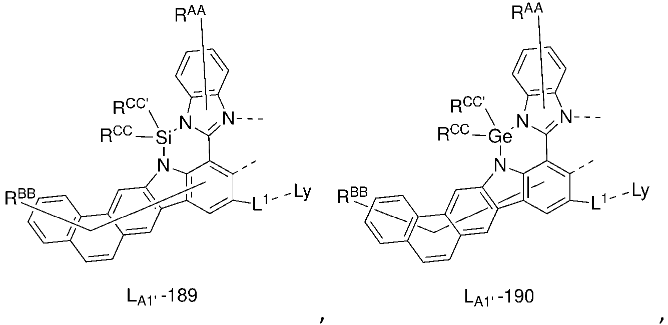 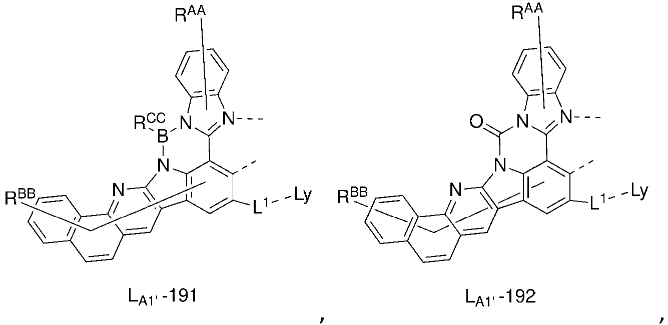 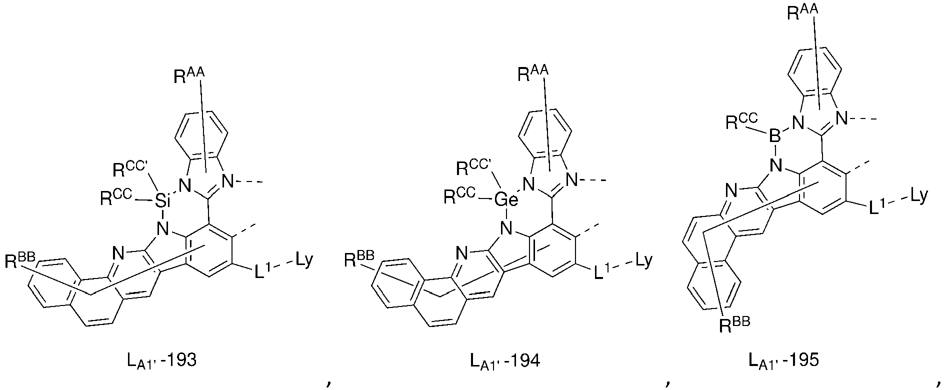 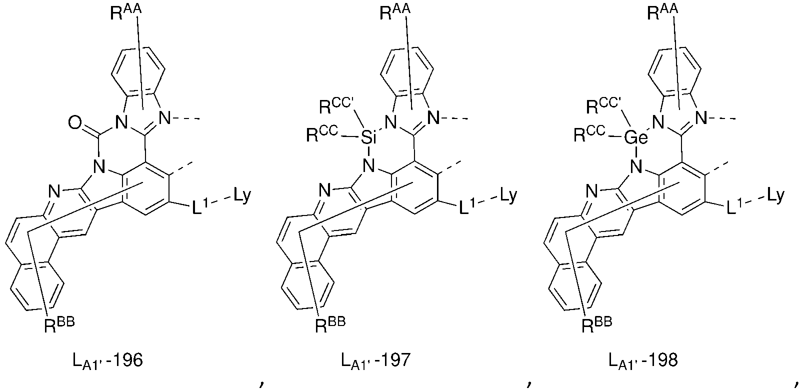 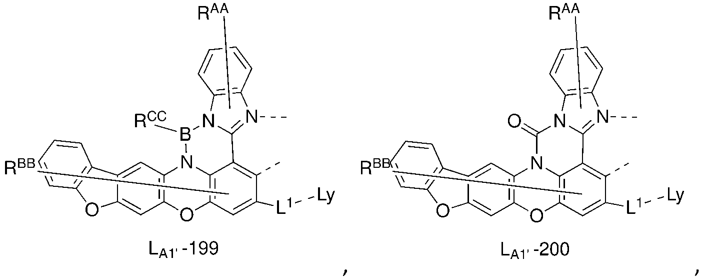 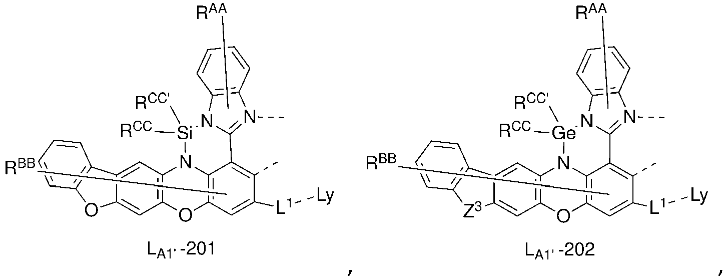 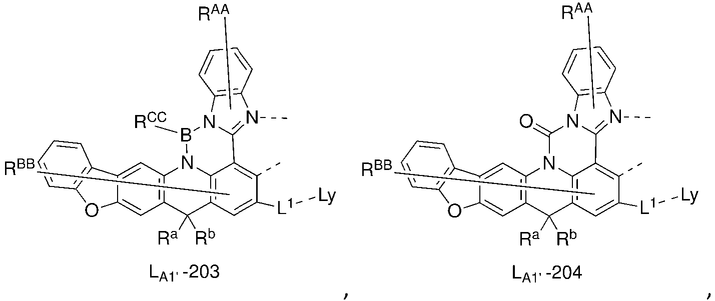 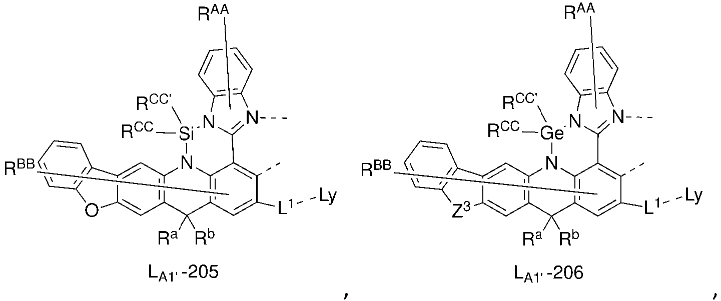 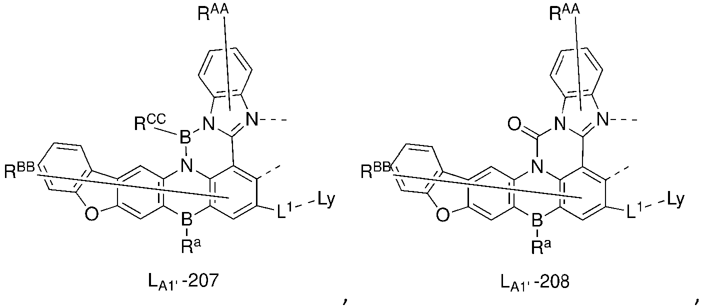 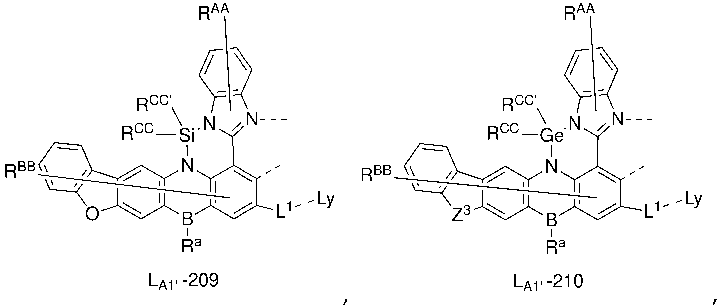 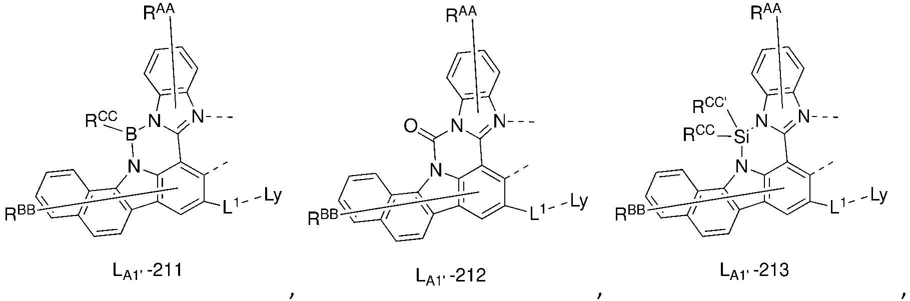 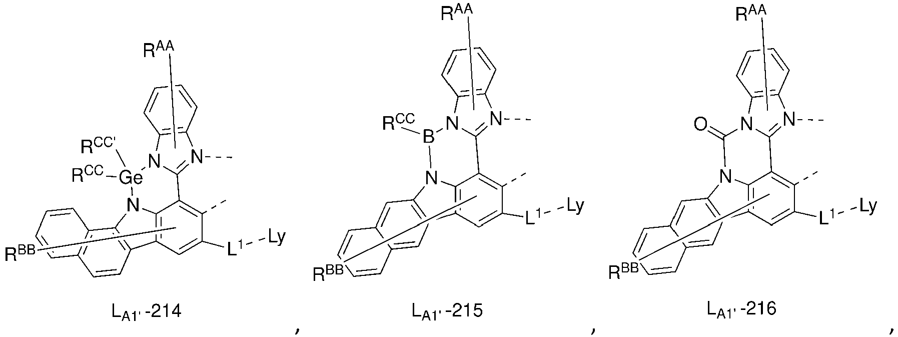 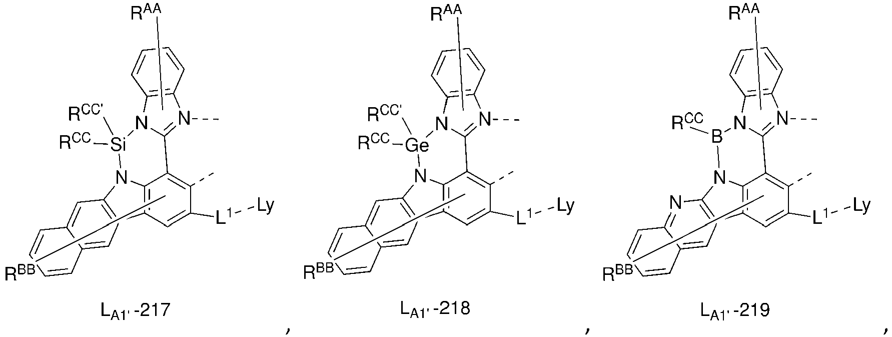 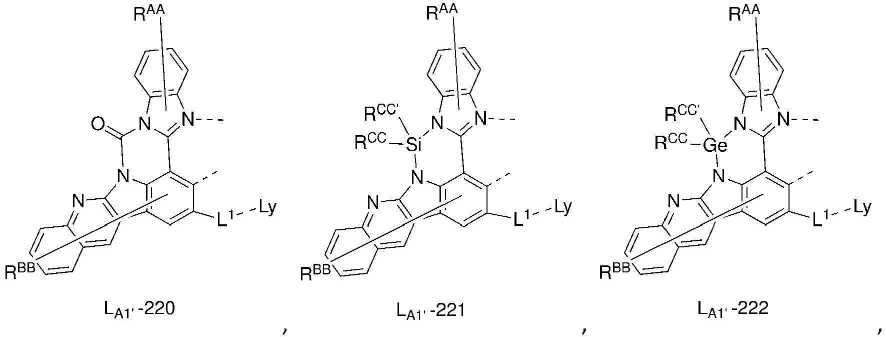 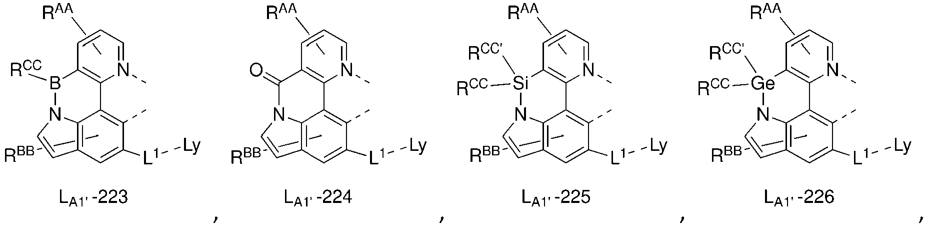 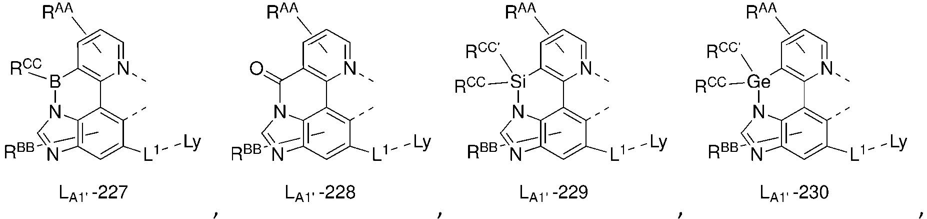 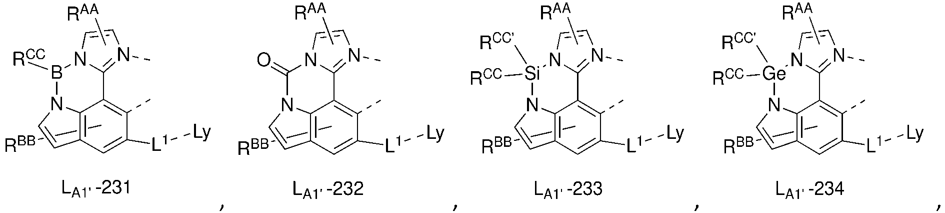 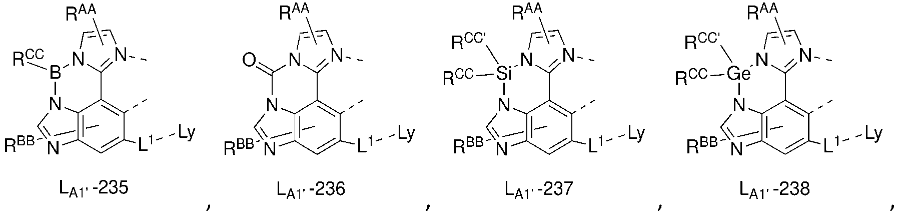 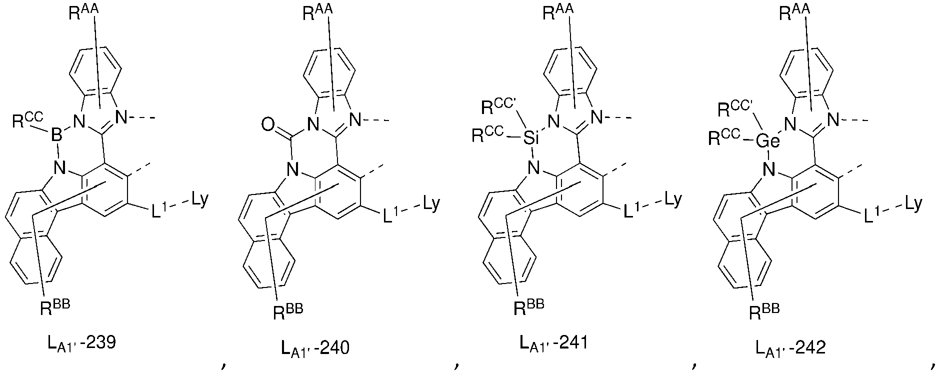 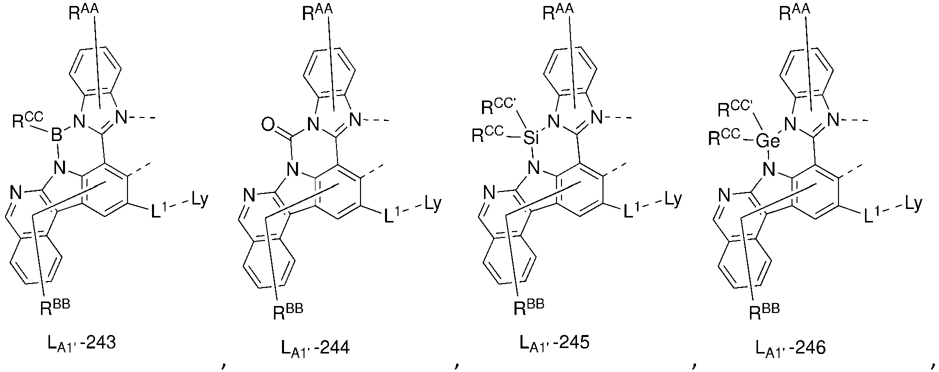 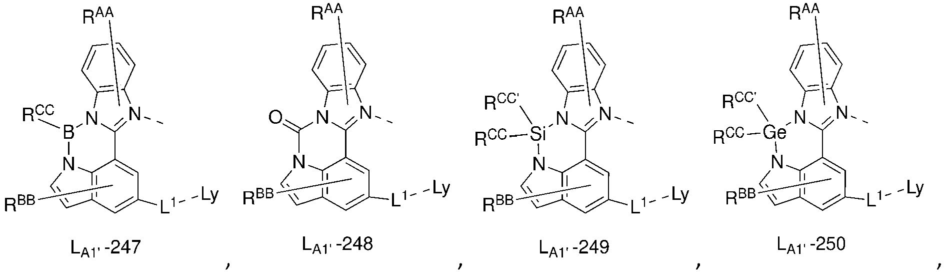 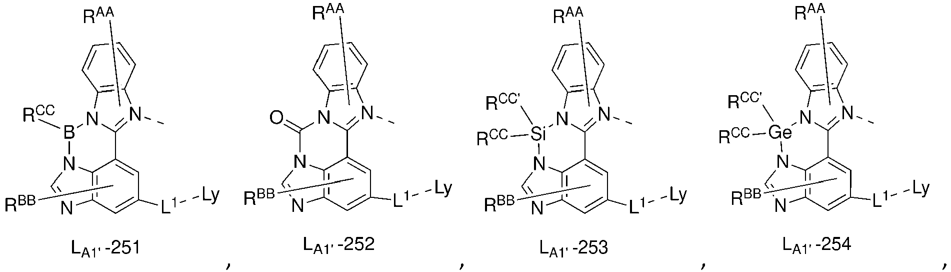 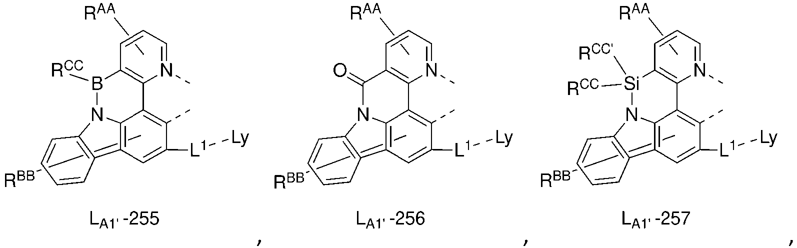 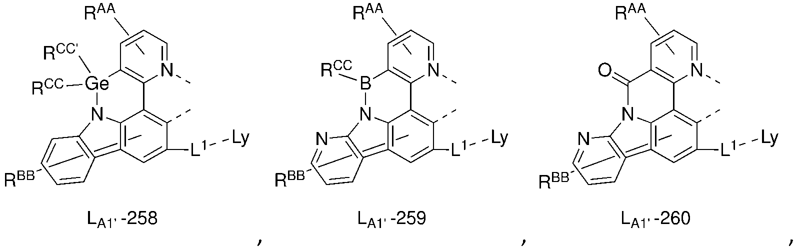 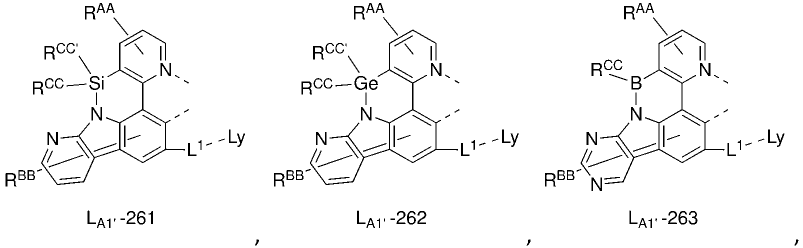 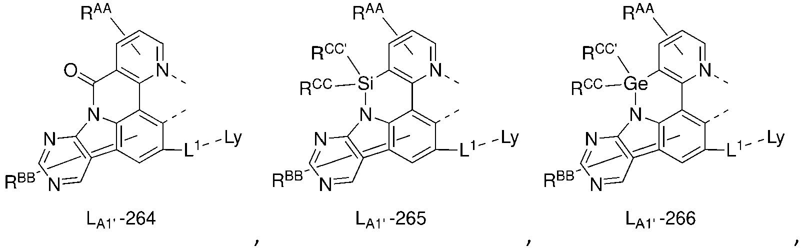 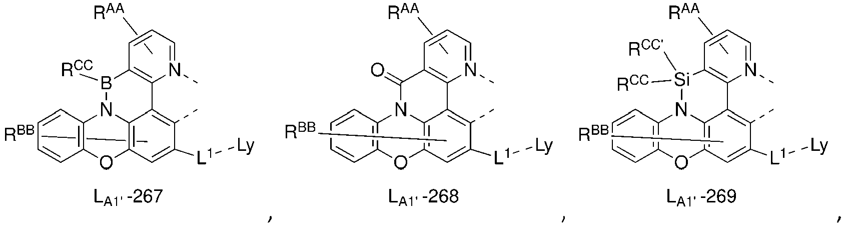 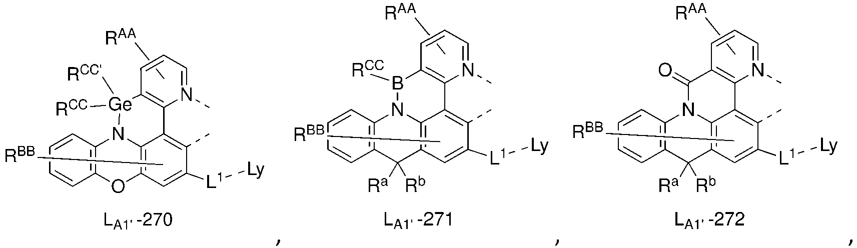 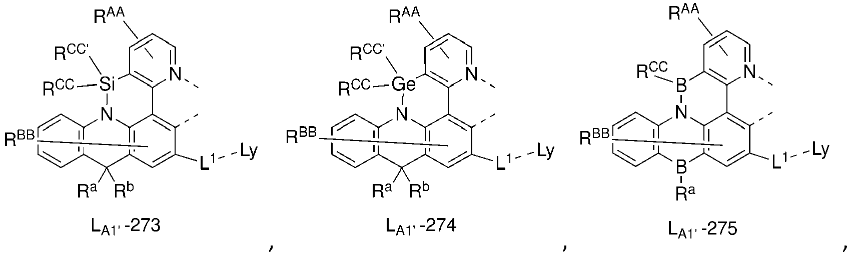 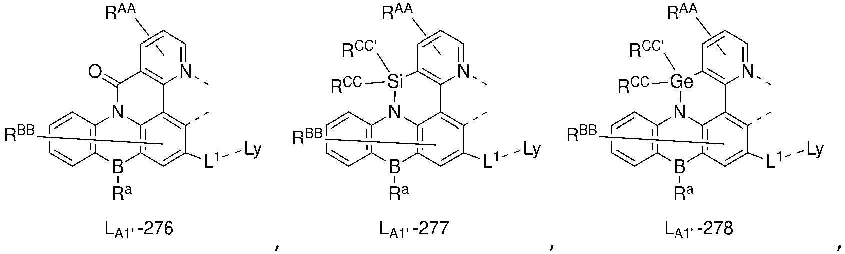 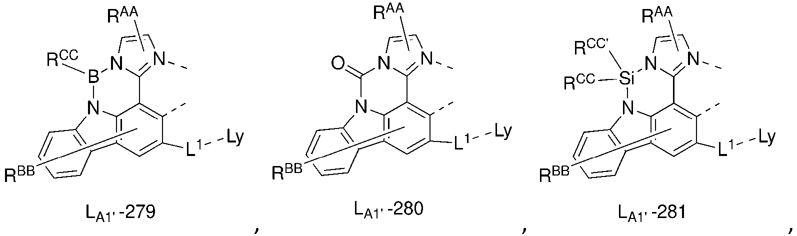 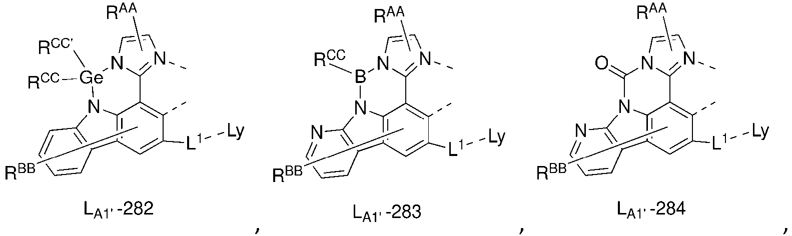 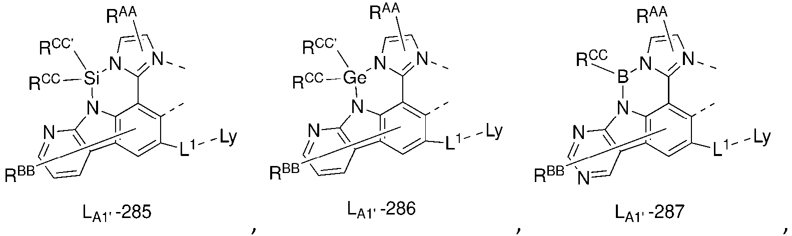 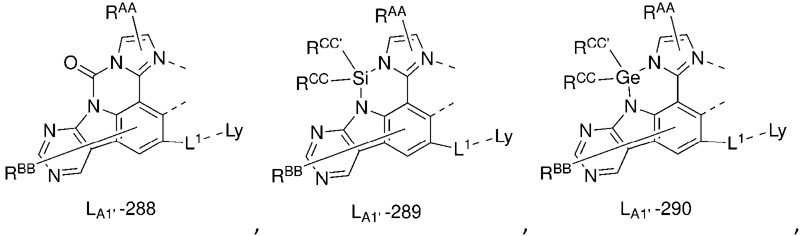 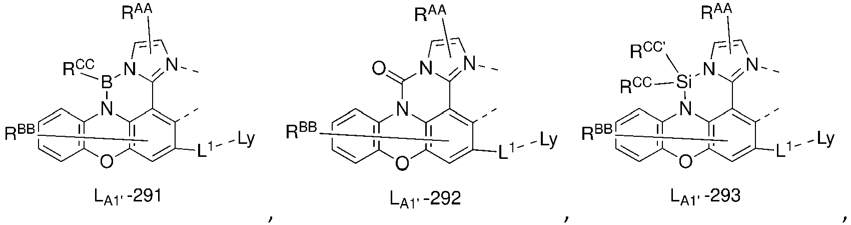 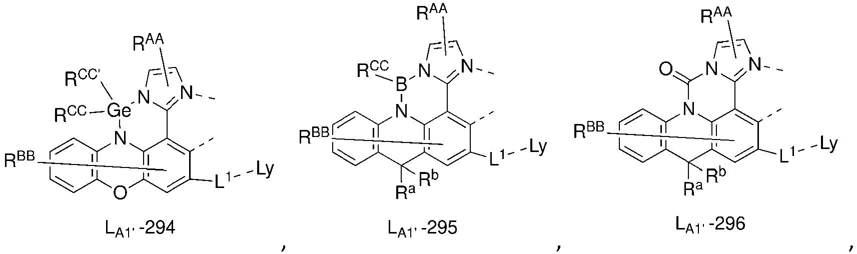 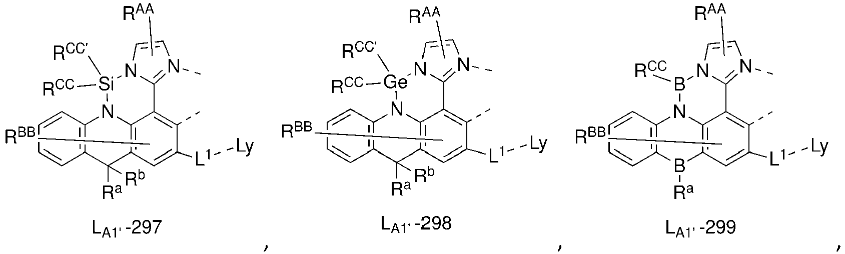 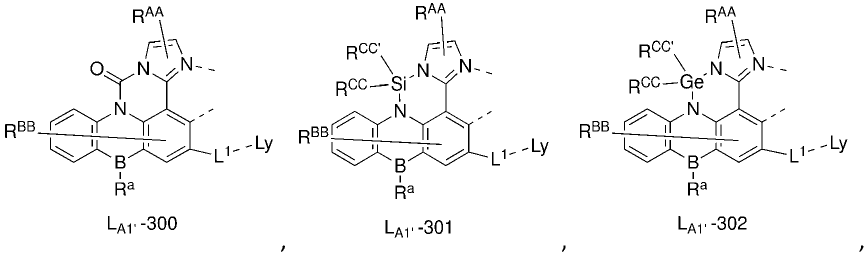 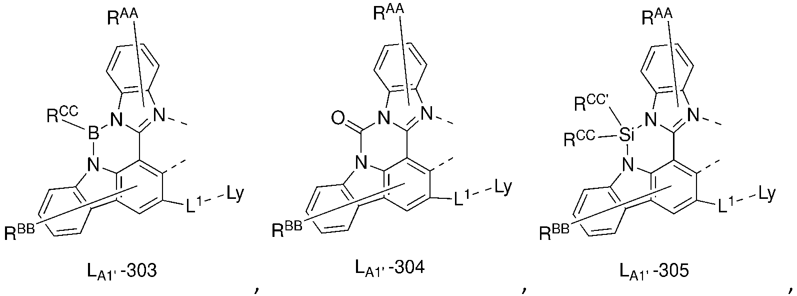 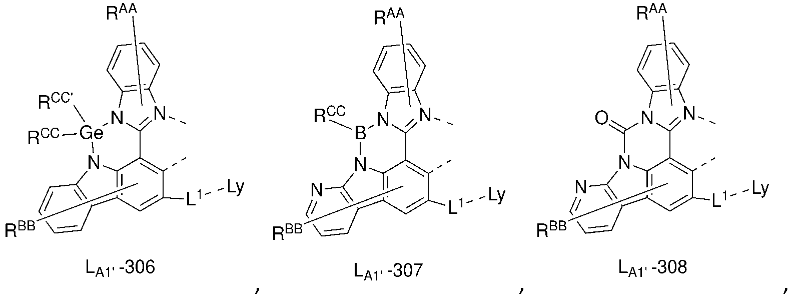 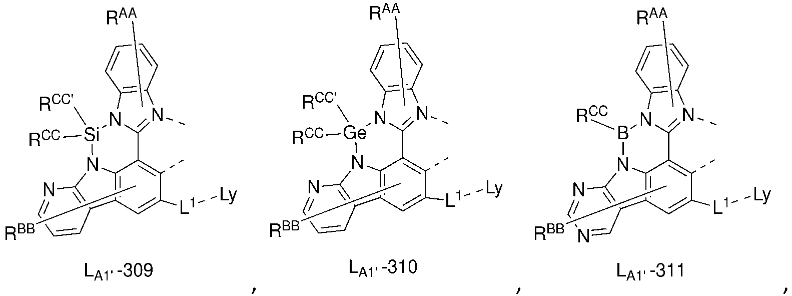 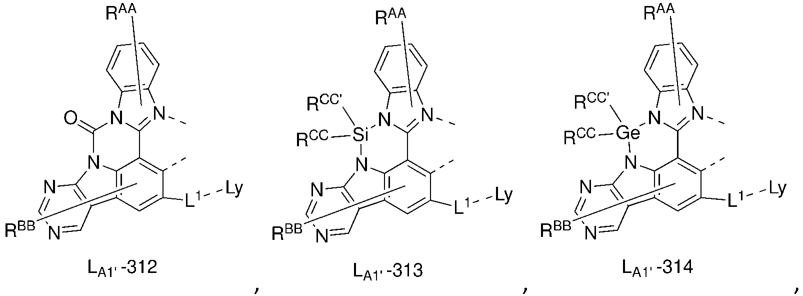 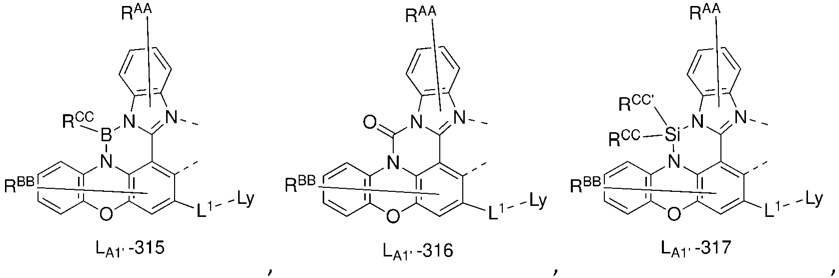 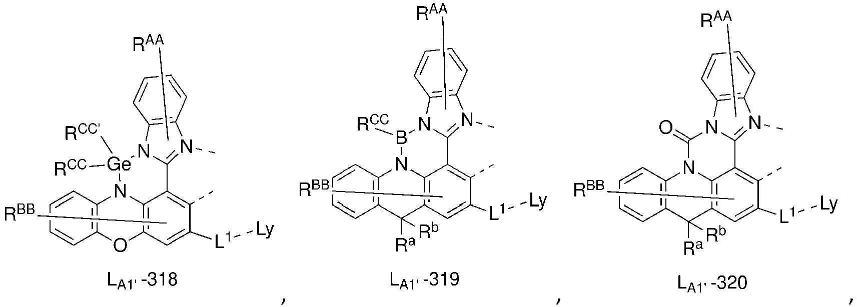 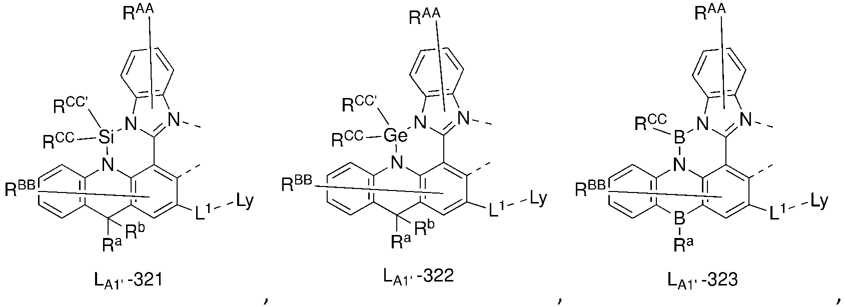 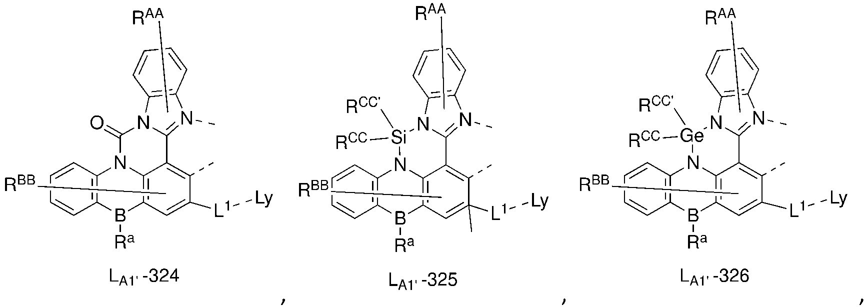 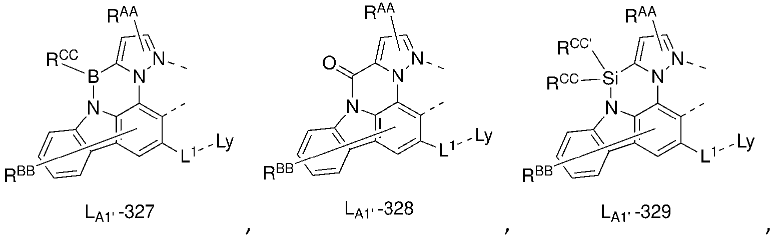 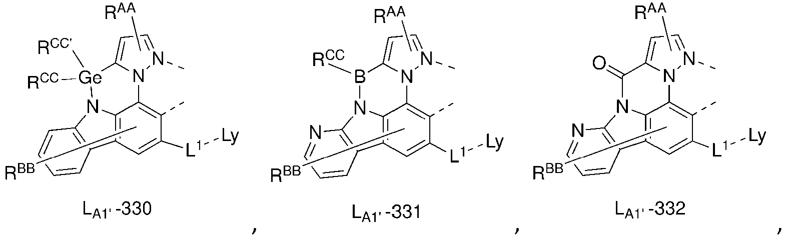 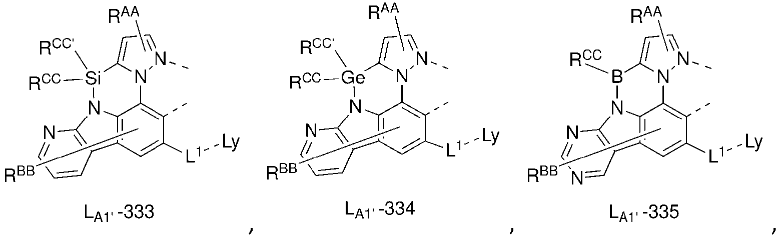 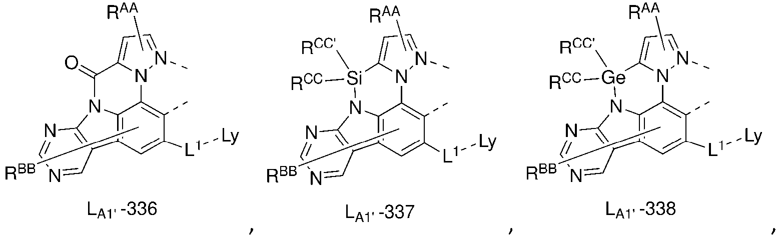 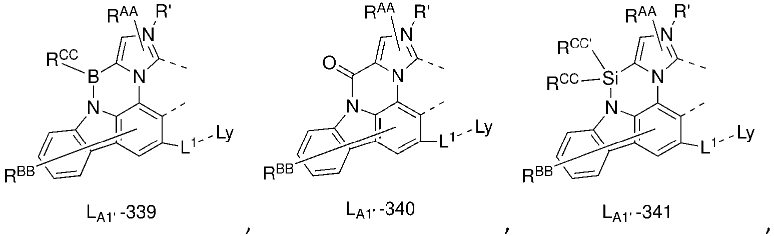 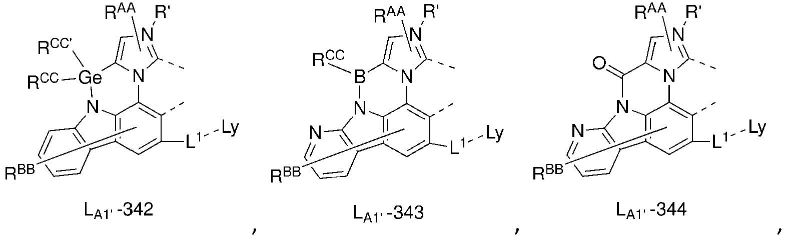 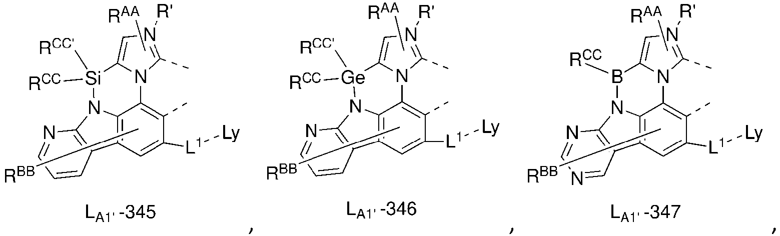 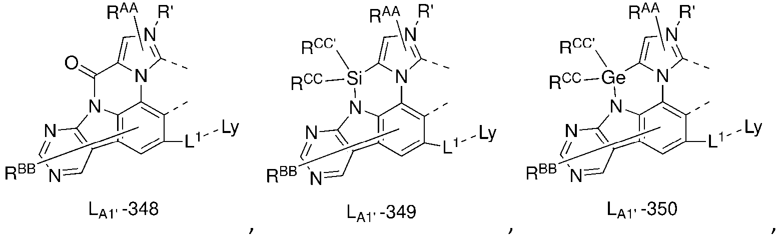 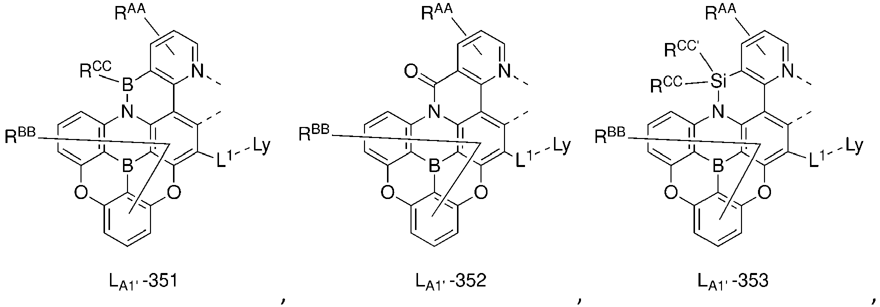 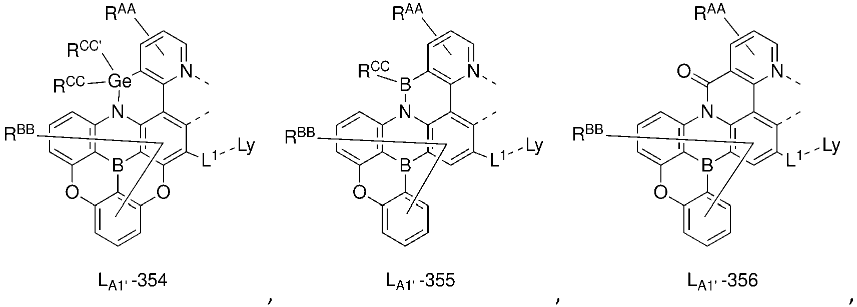 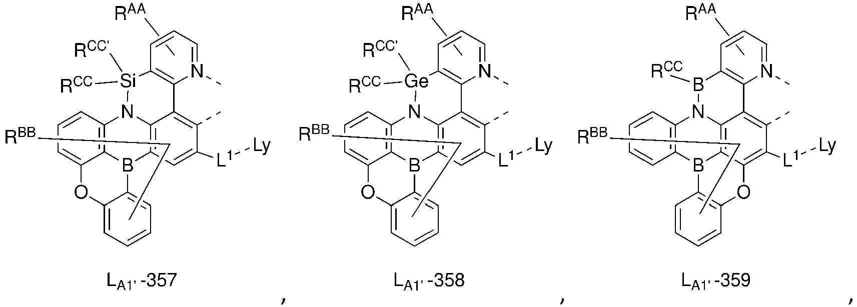 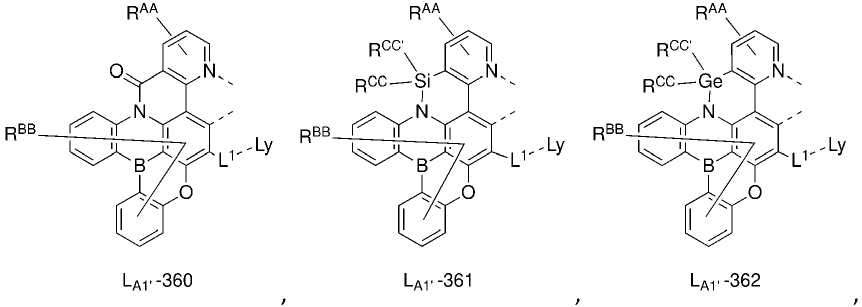 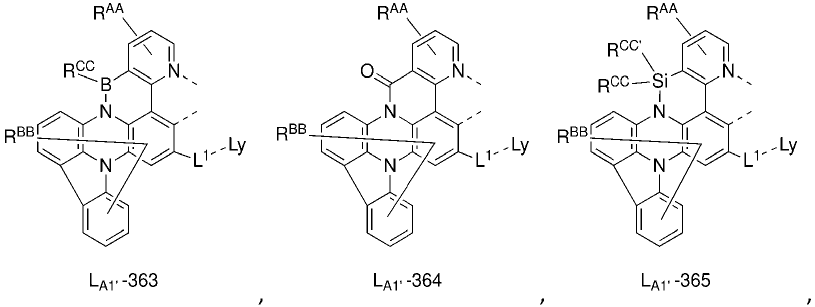 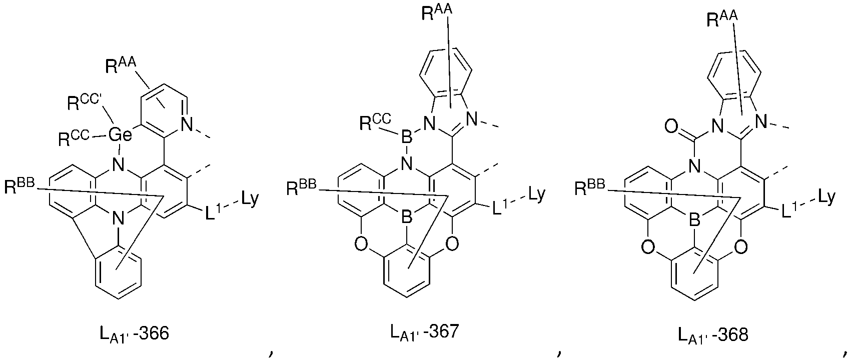 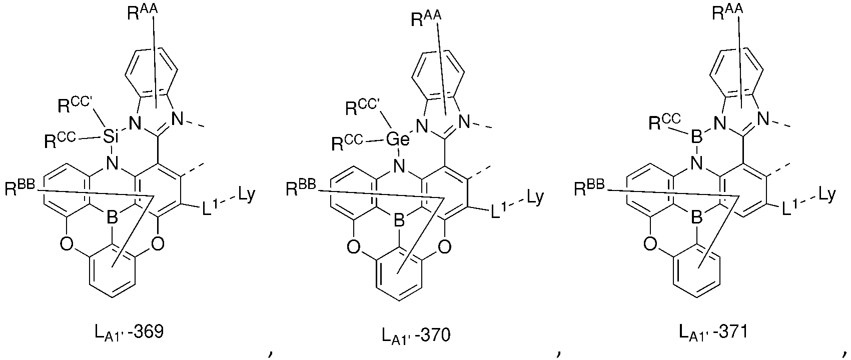 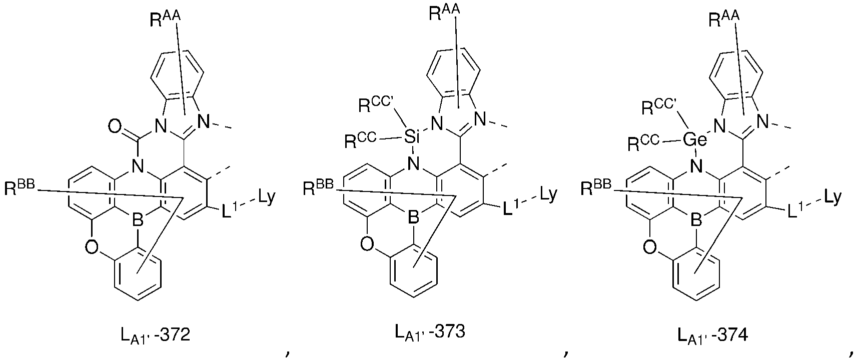 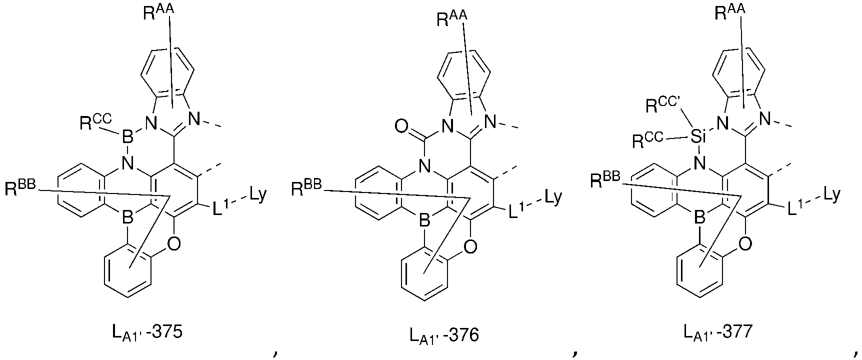 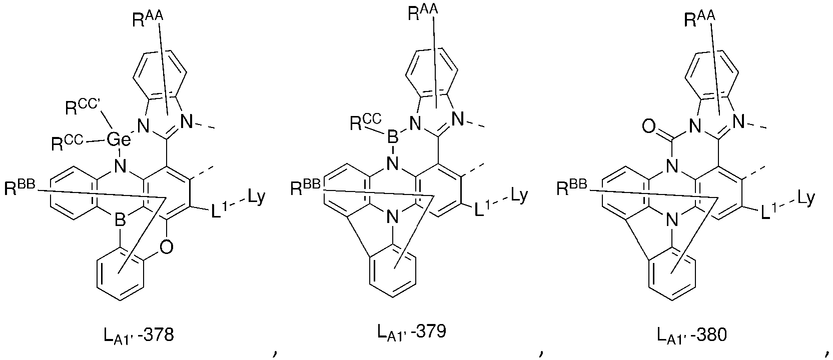 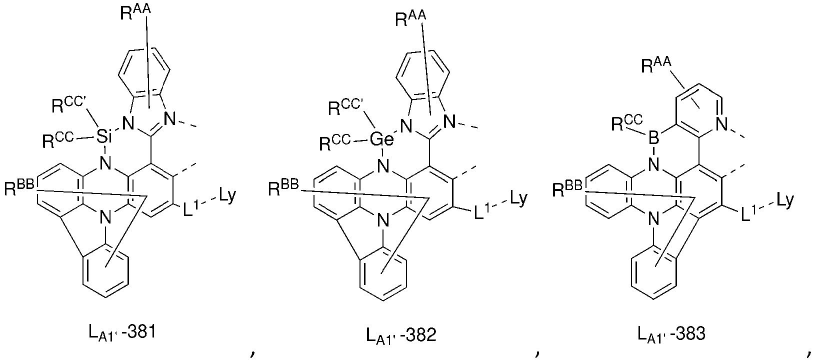 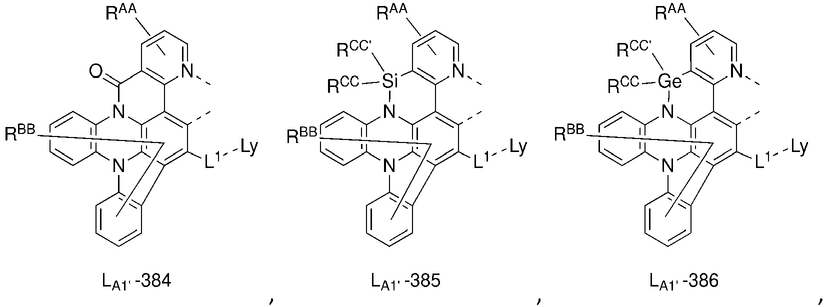 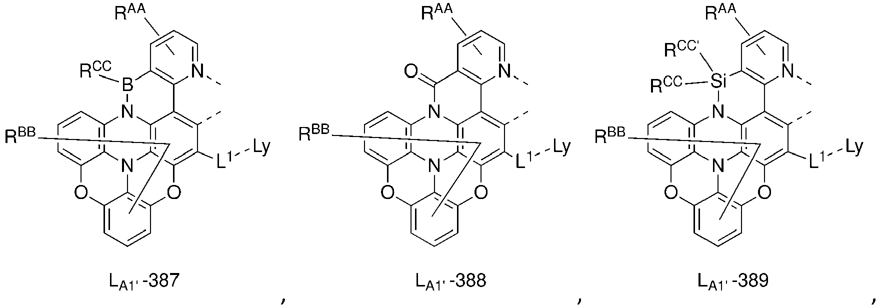 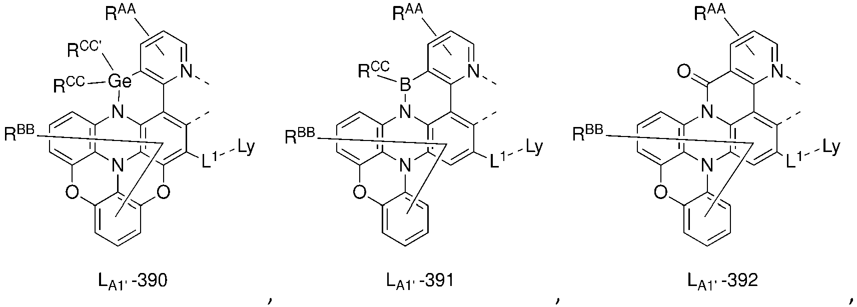 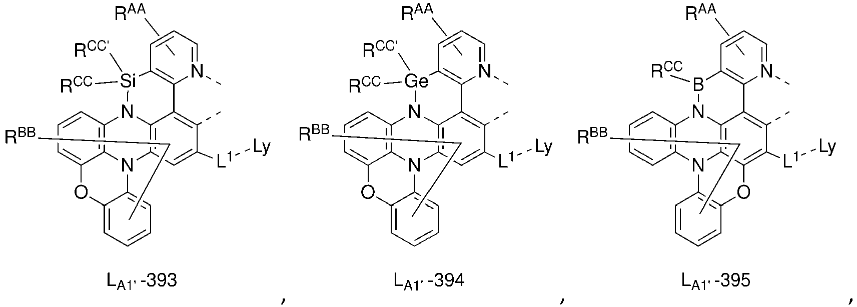 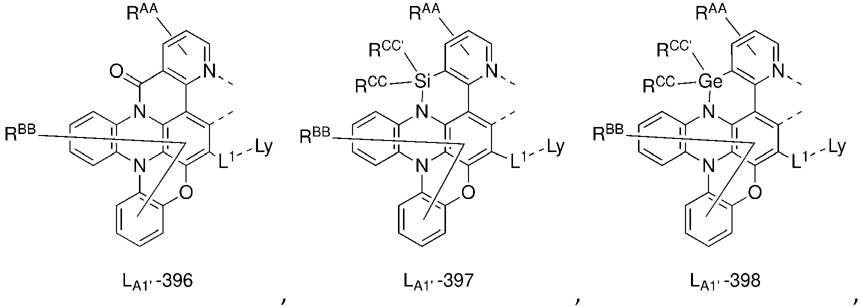 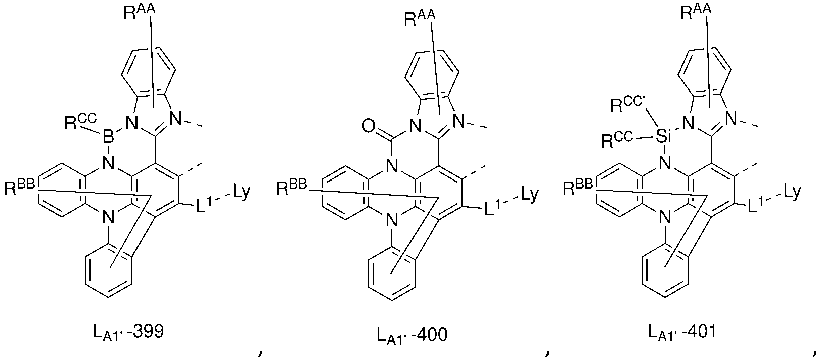 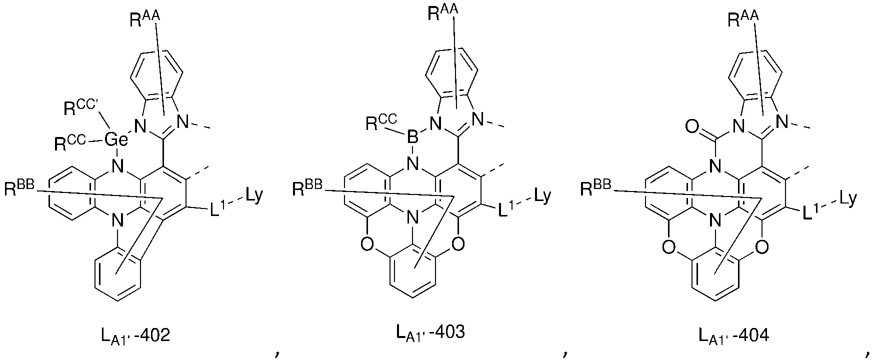 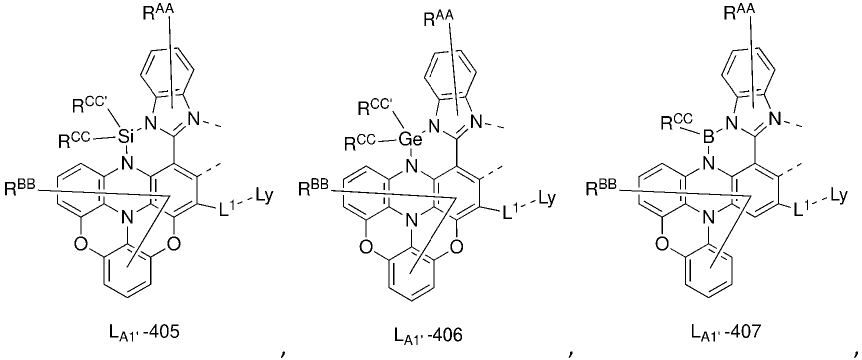 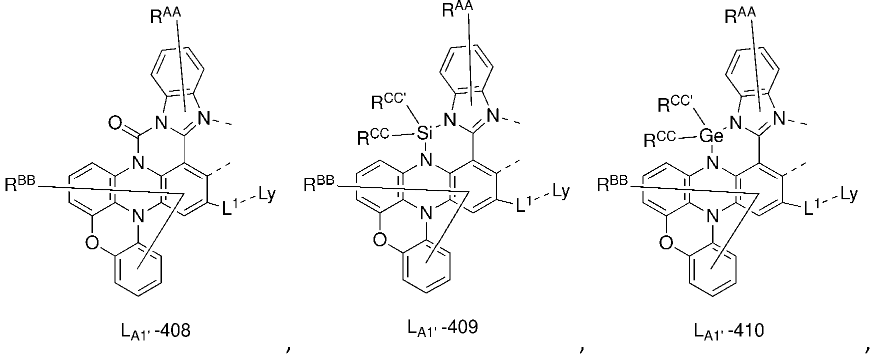 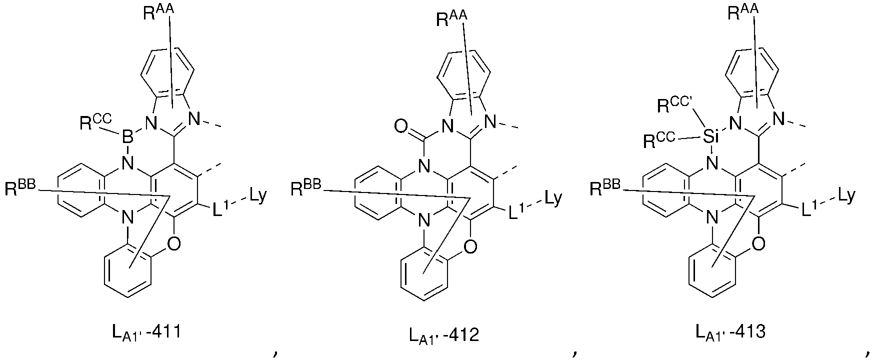 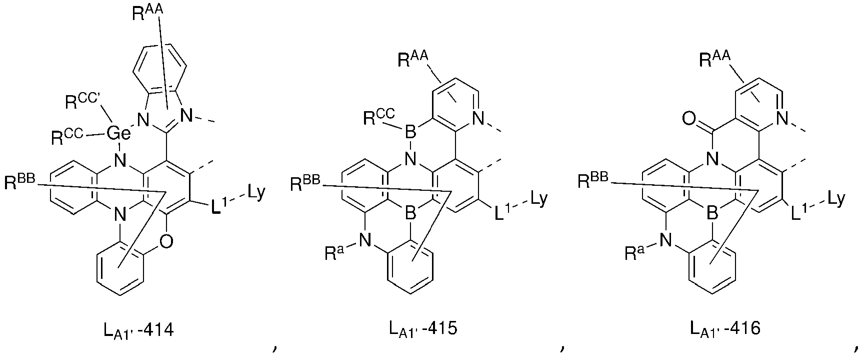 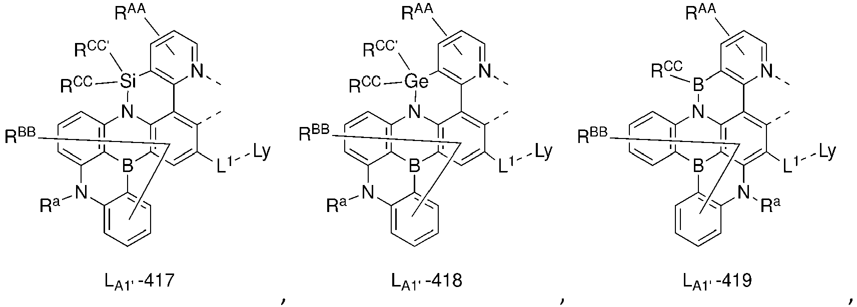 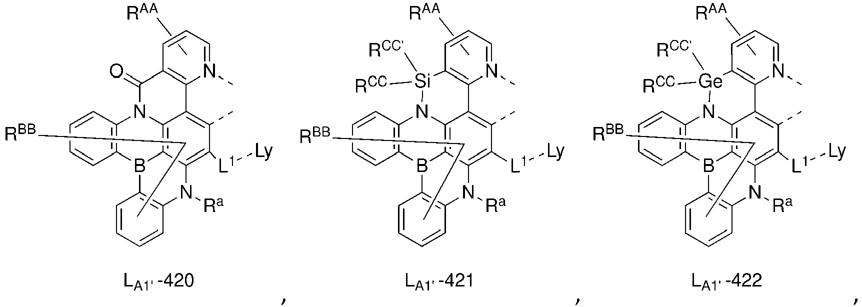 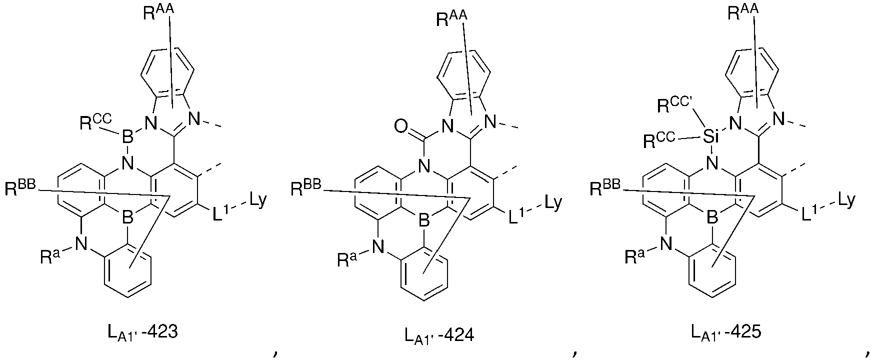 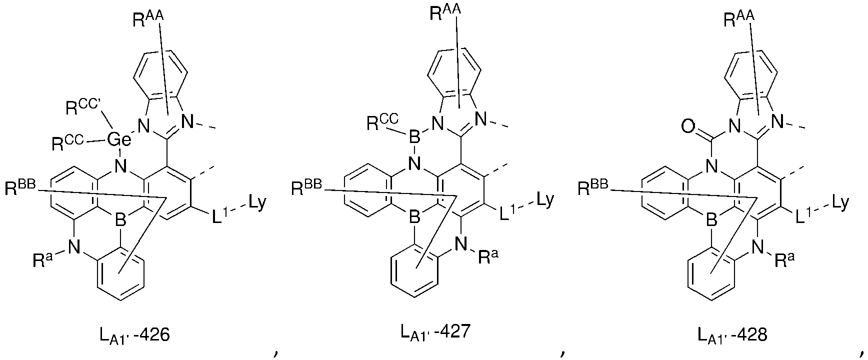 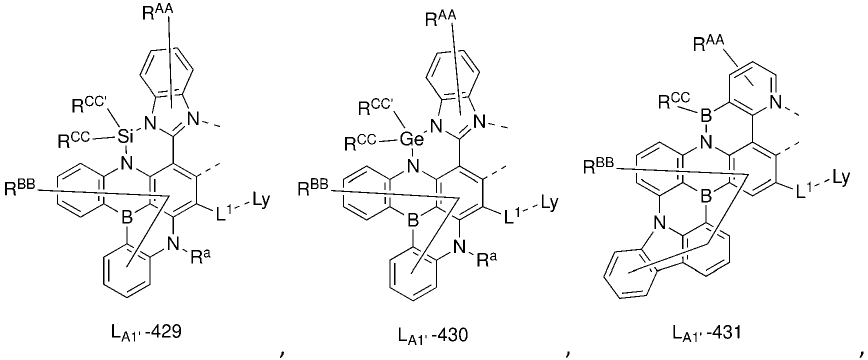 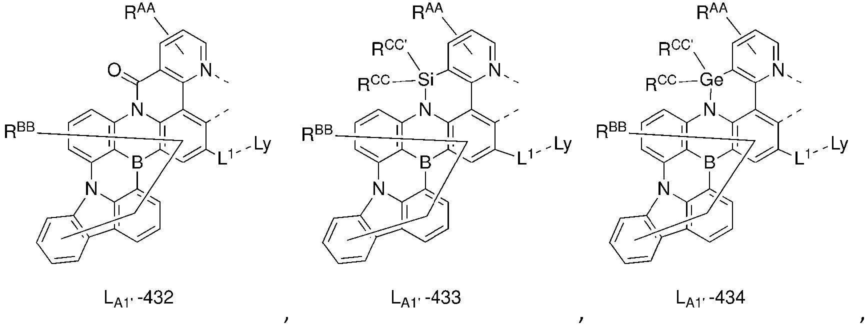 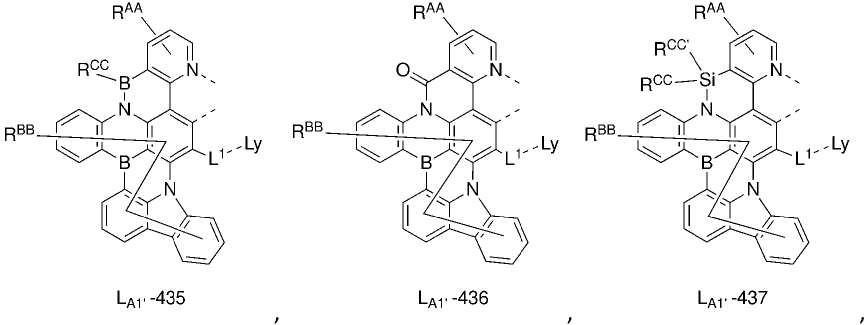 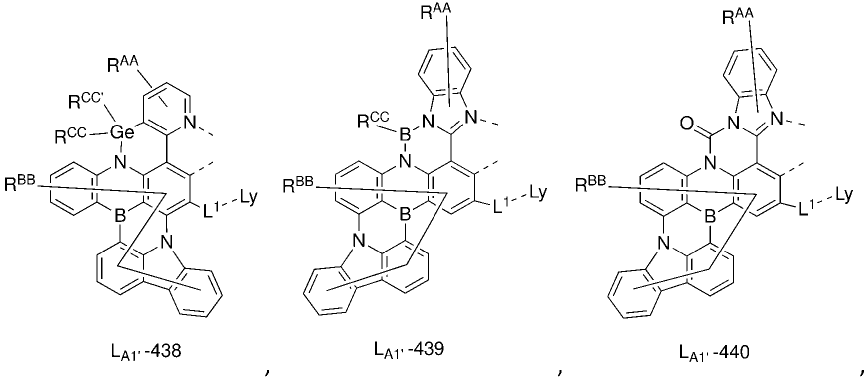 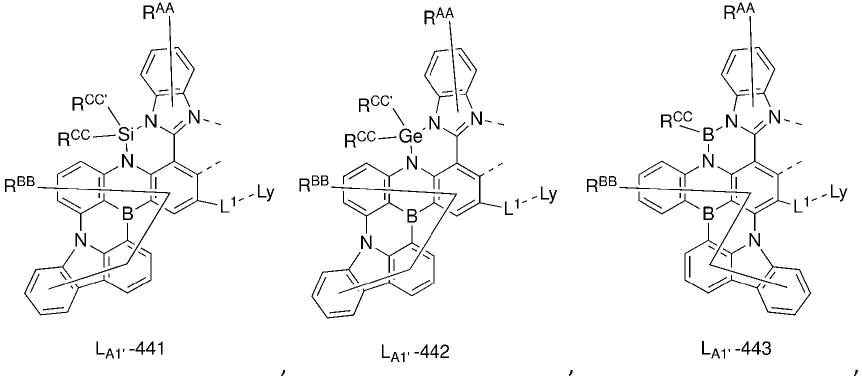 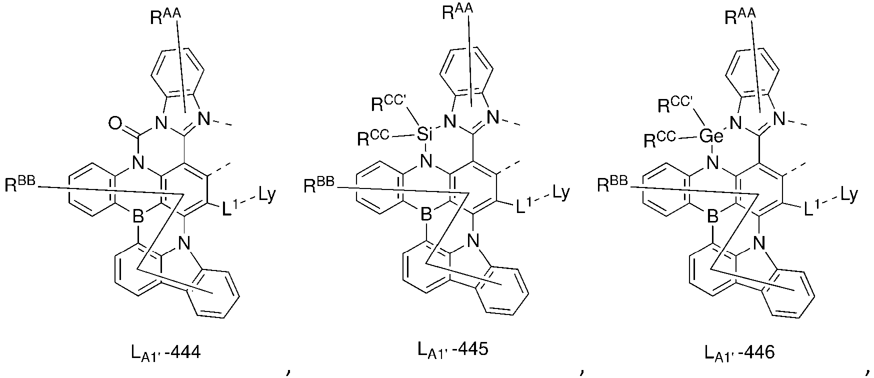 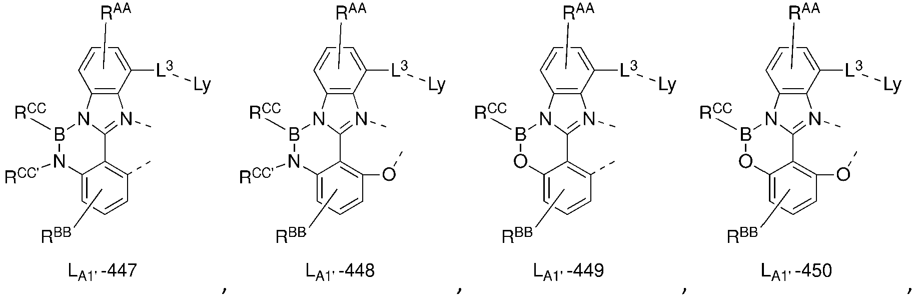 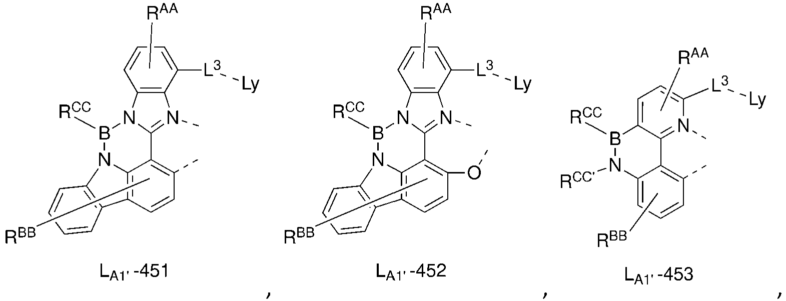 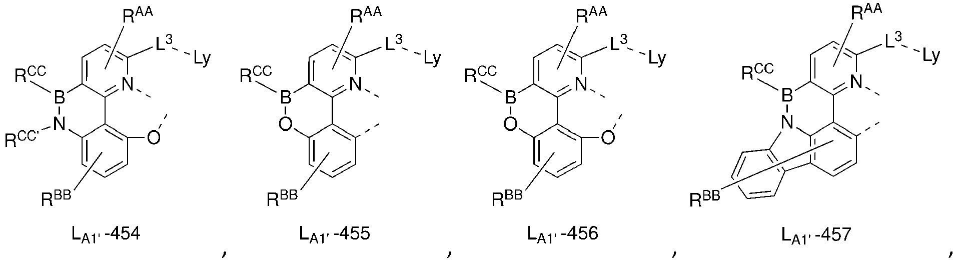 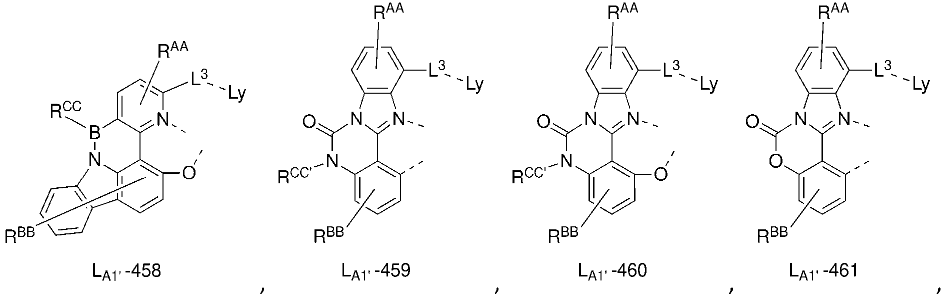 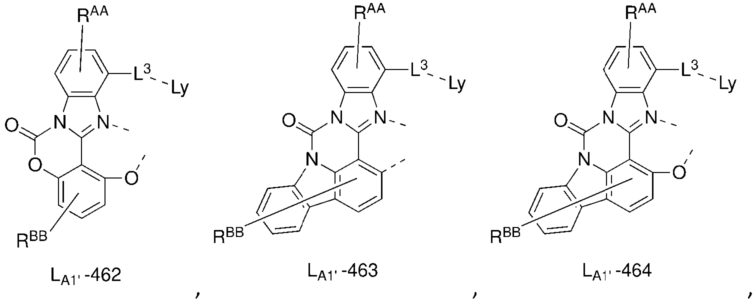 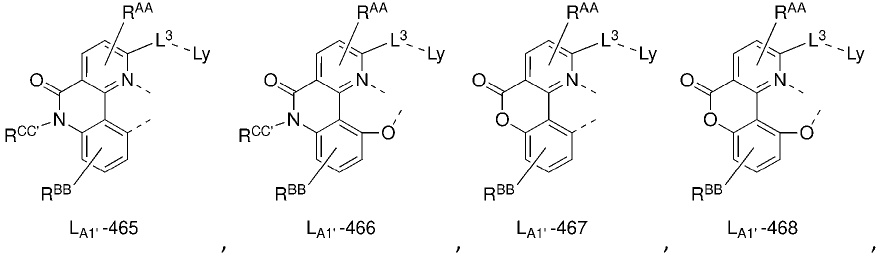 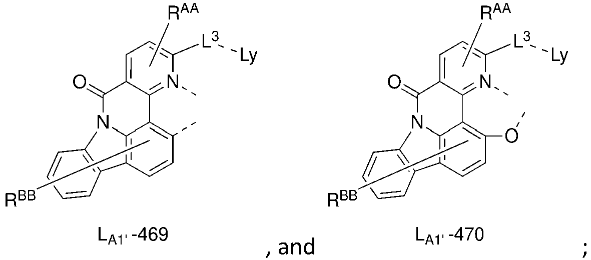 wherein L*_{y}* is selected from the group consisting of the structures of from L_{y1}-1 to L_{y1}-133 as shown below in LIST 13: 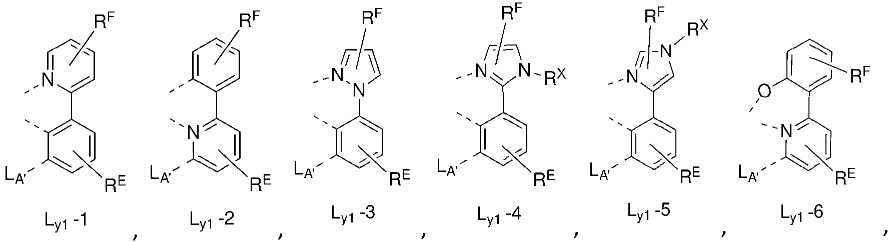 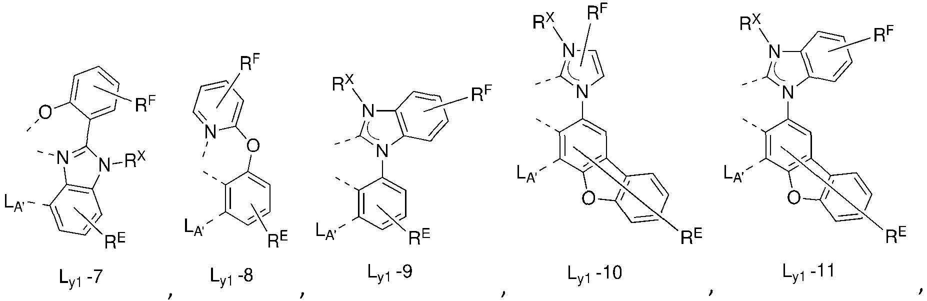 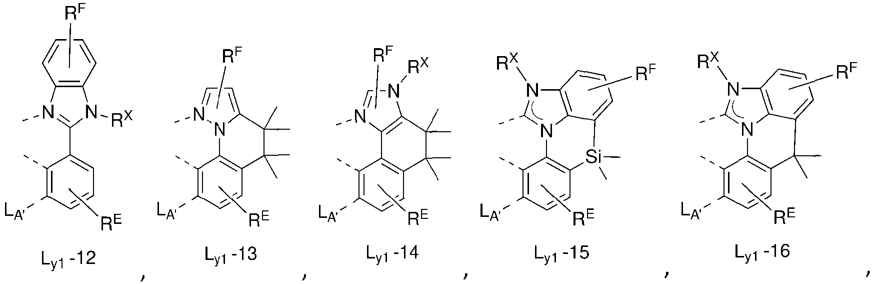 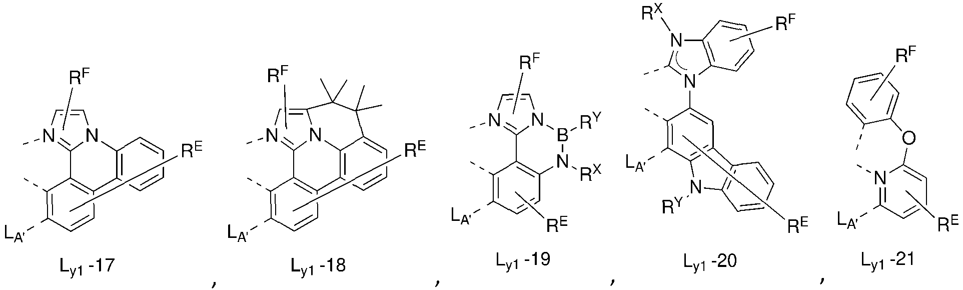 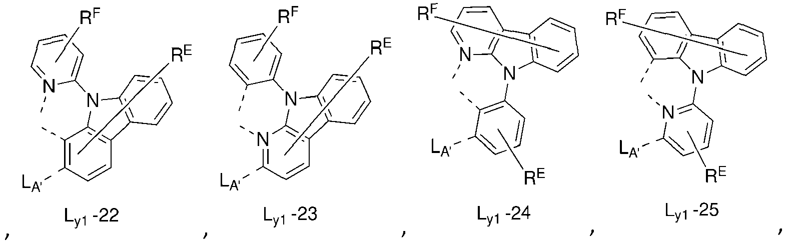 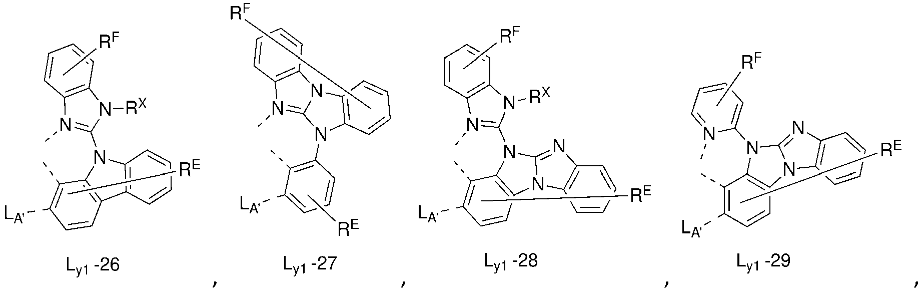 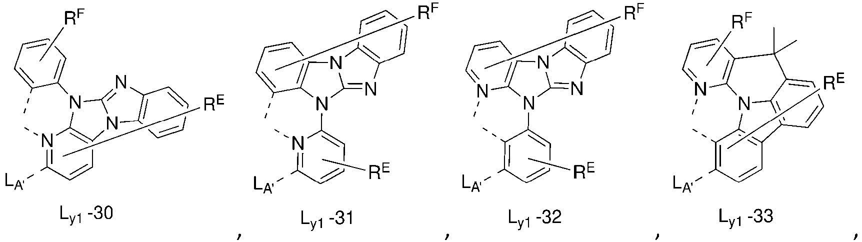 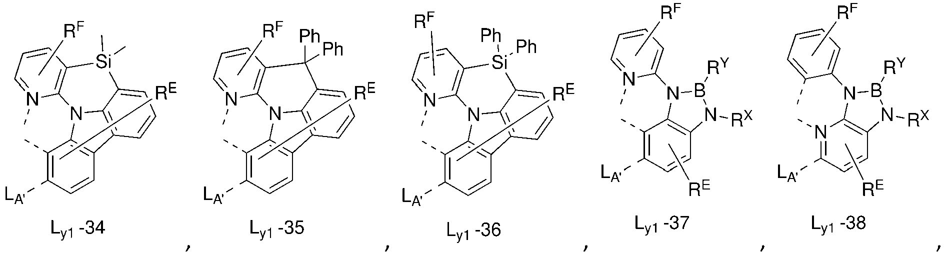 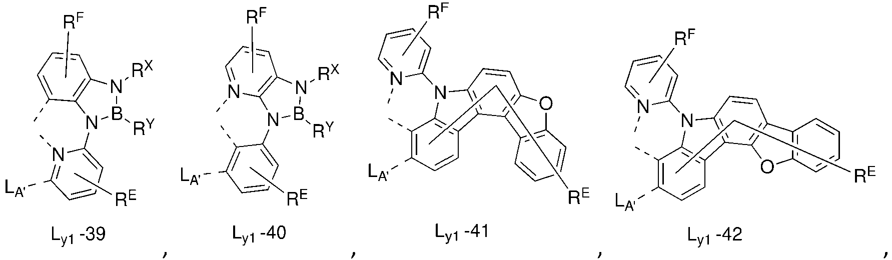 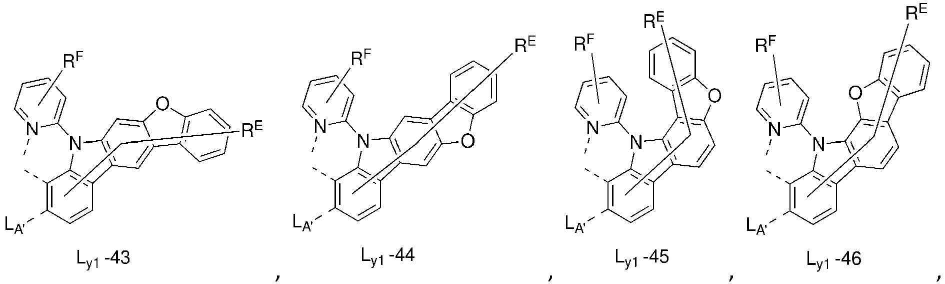 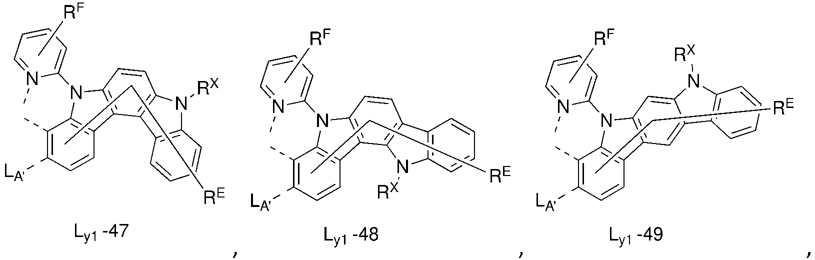 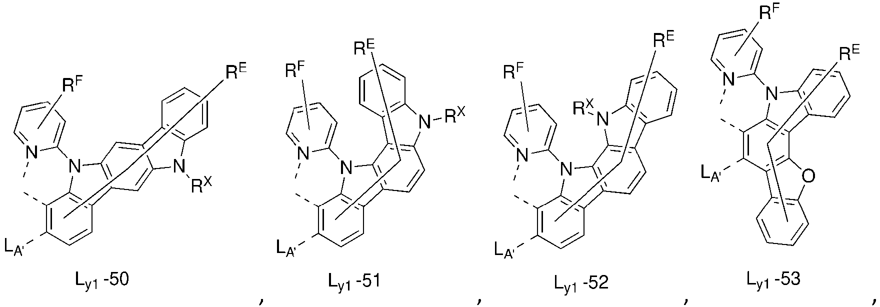 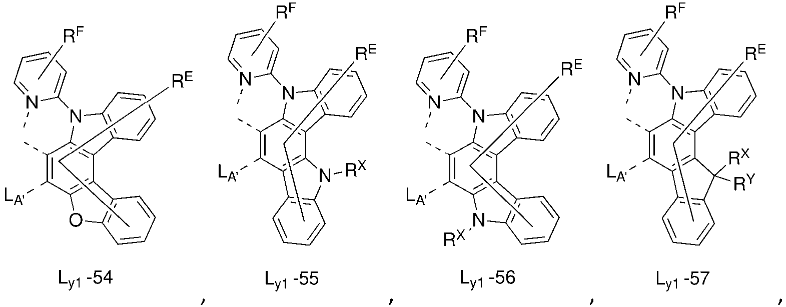 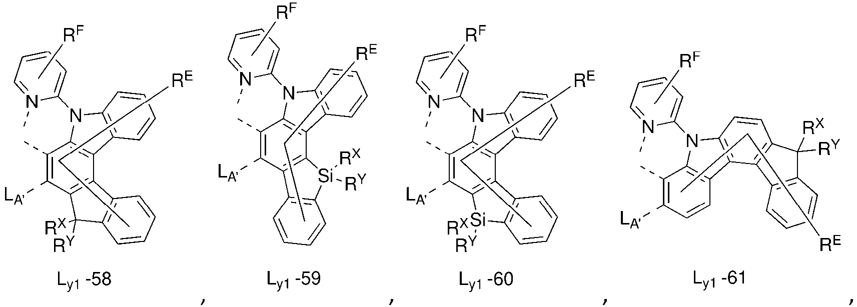 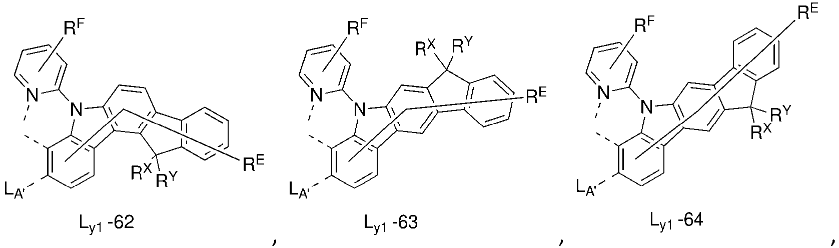 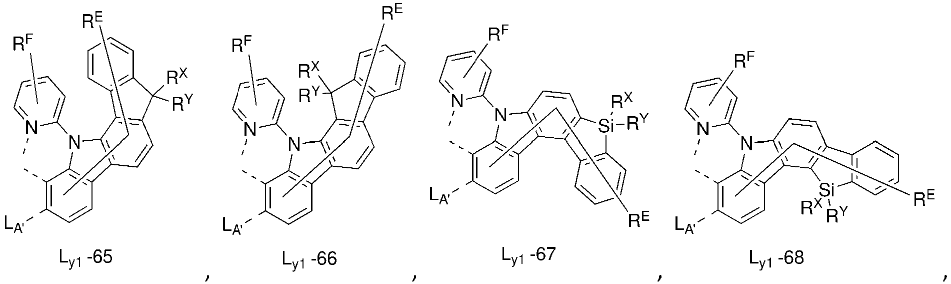 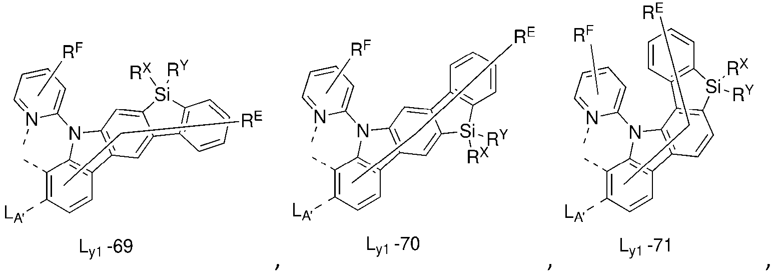 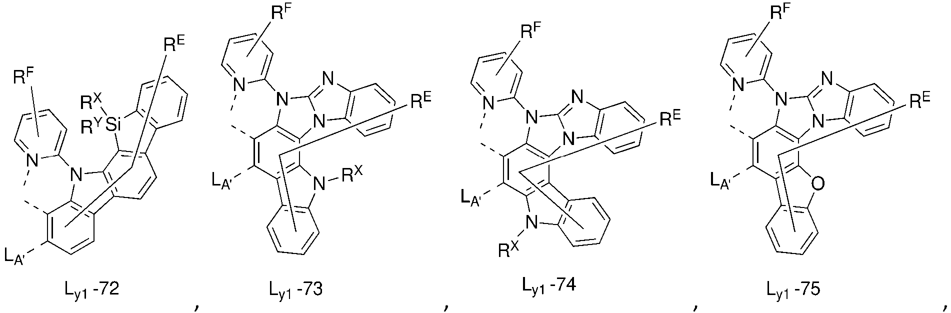 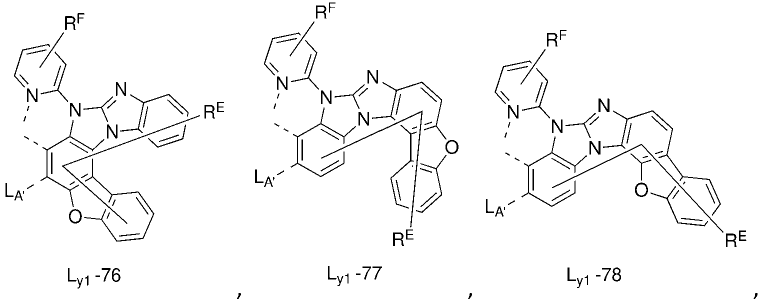 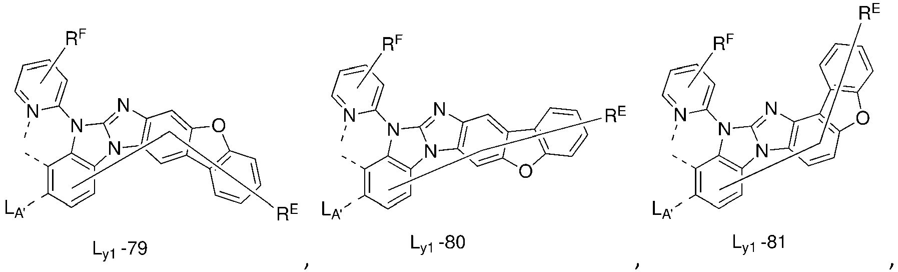 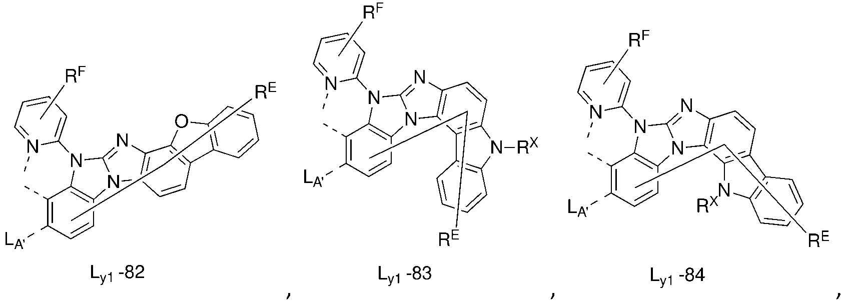 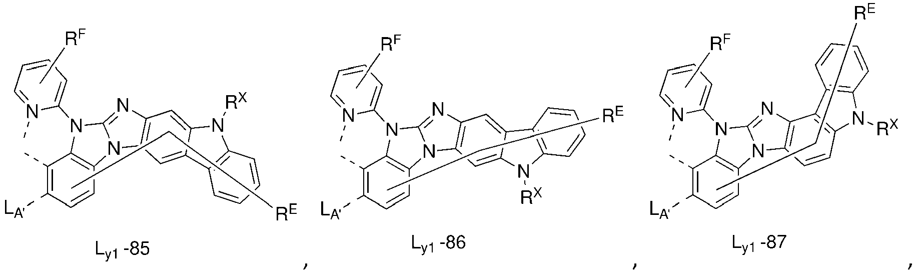 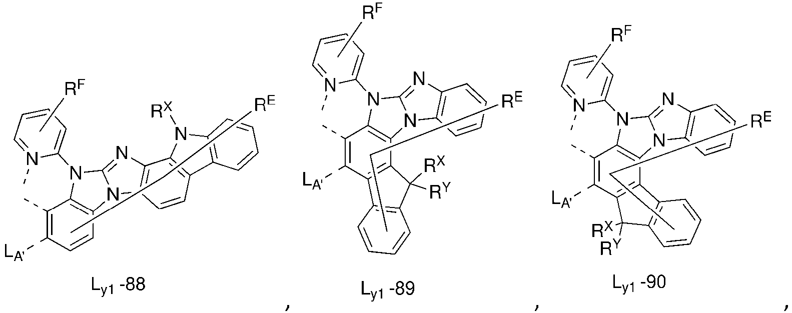 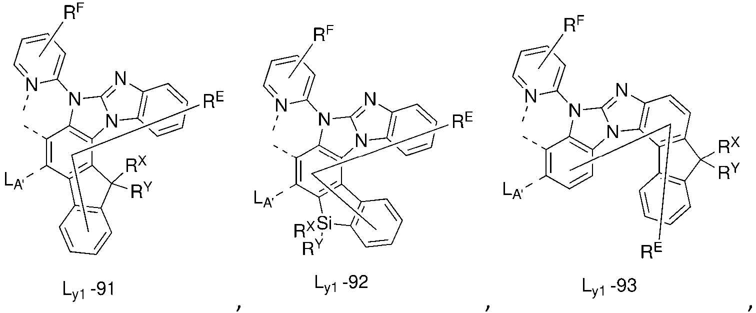 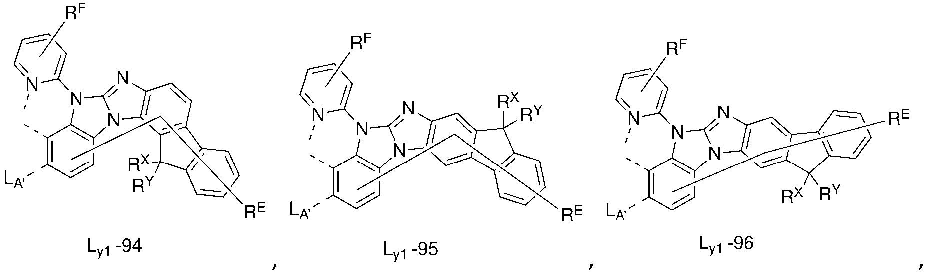 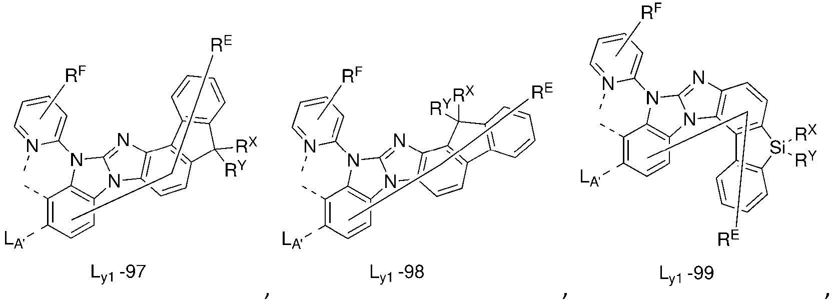 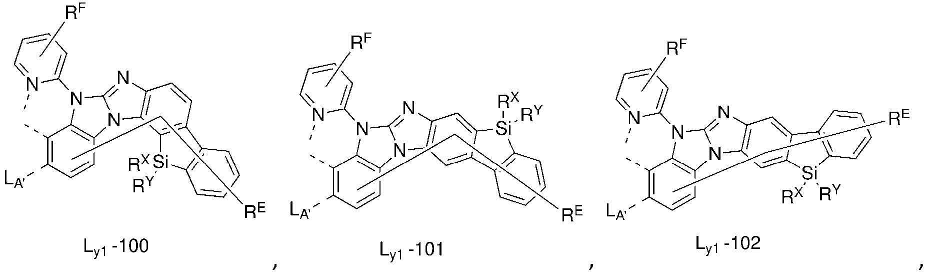 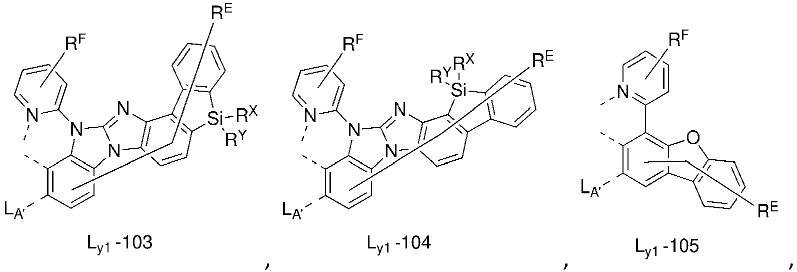 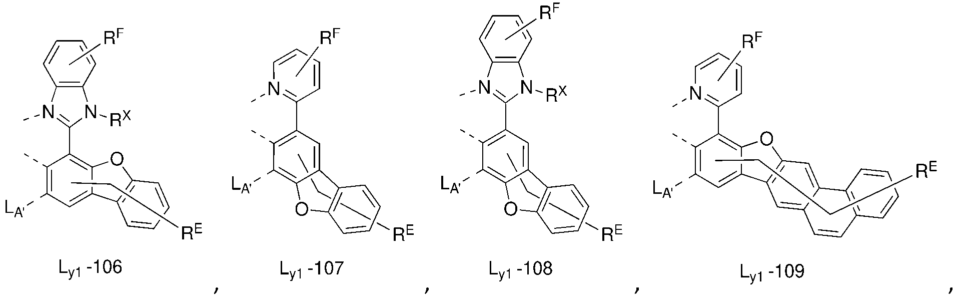 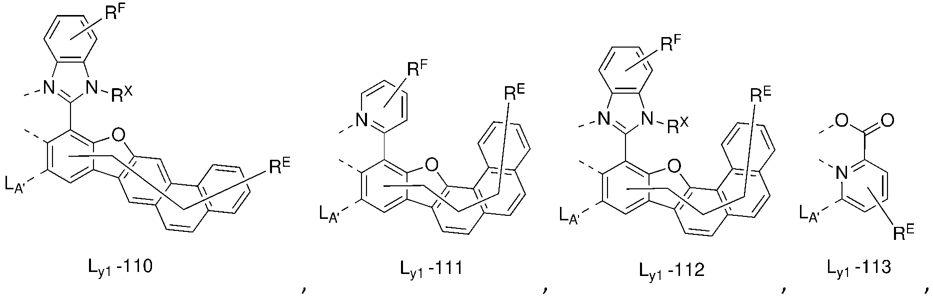 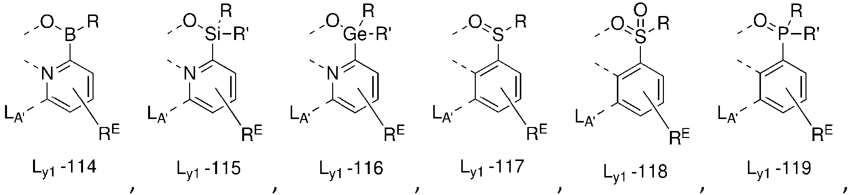 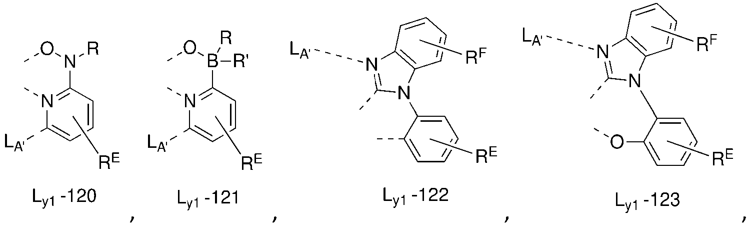 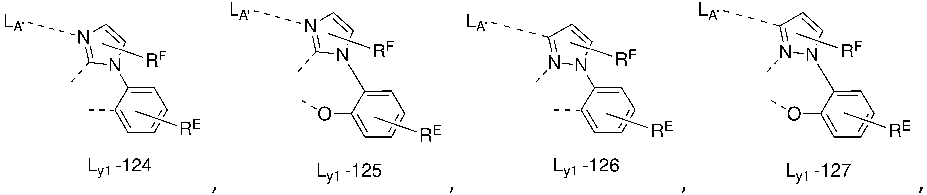 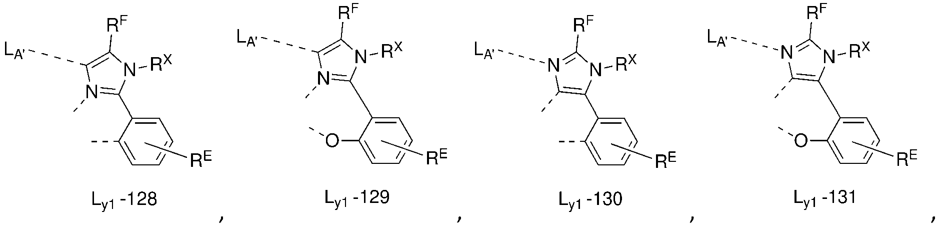 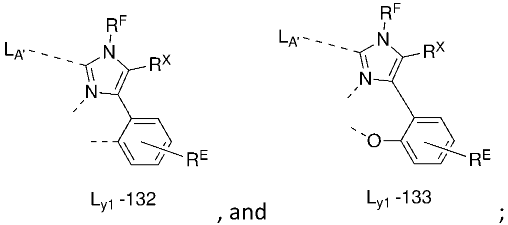 wherein each R^{X} and R^{Y} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

The compound of claim 91, wherein at least one of R, R', R^{X}, R^{Y}, R^{A}, R^{B}, R^{C}, R^{D}, R^{E}, and R^{F} is independently selected from the structures consisting of the following LIST 11: 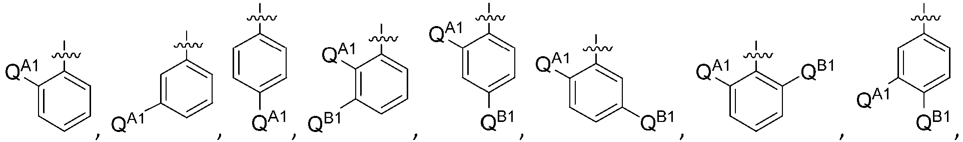 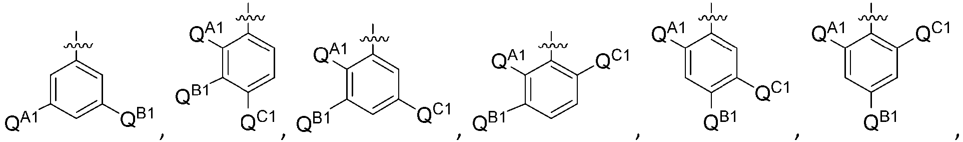 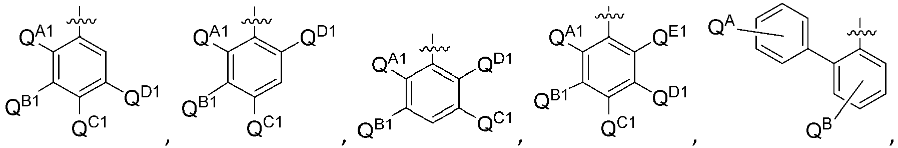 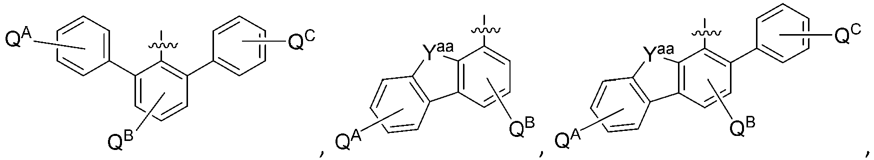 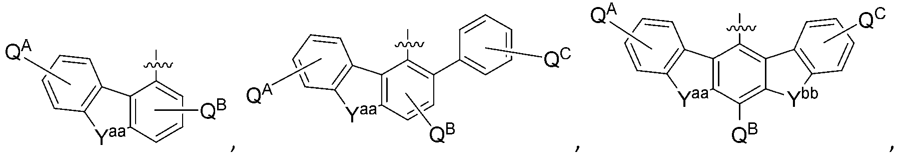 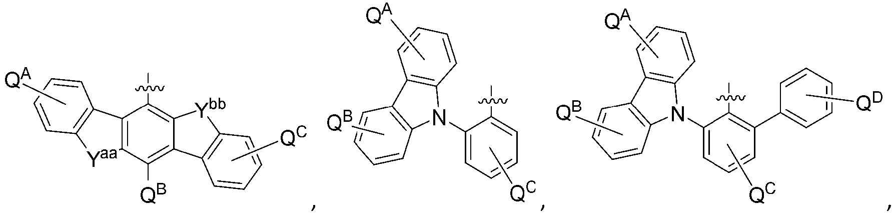 and 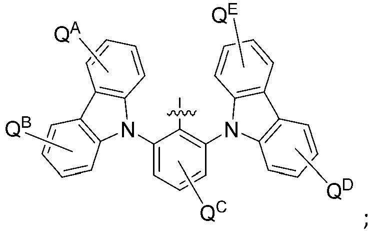
wherein each of Q^{A}, Q^{B}, Q^{C}, Q^{D}, and Q^{E} independently represents mono to the maximum allowable substitution, or no substitution;
wherein each Q^{A}, Q^{B}, Q^{C}, Q^{D}, Q^{E}, Q^{A1}, Q^{B1}, Q^{C1}, Q^{D1} and Q^{E1} is independently a hydrogen or a substituent selected from the group consisting of alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
each Y^{aa} and Y^{bb} is independently selected from the group consisting of a direct bond, BR, BRR', NR, PR, O, S, Se, C=O, C=S, C=Se, C=NR, C=CRR', S=O, SO₂, CR, CRR', SiRR', GeRR', alkyl, cycloalkyl, aryl, heteroaryl, and combinations thereof; and any two substituents can be joined or fused to form a ring. In some embodiments, the compound is selected from the group consisting of the compounds of Pt(L_{A1'}-1)(L_{*y*1}-1) to Pt(L_{A1'}-470)(L_{*y*1}-133).

In some embodiments, the compound is selected from the group consisting of the compounds having the formula of Pt(L_{A'})(L*y*): 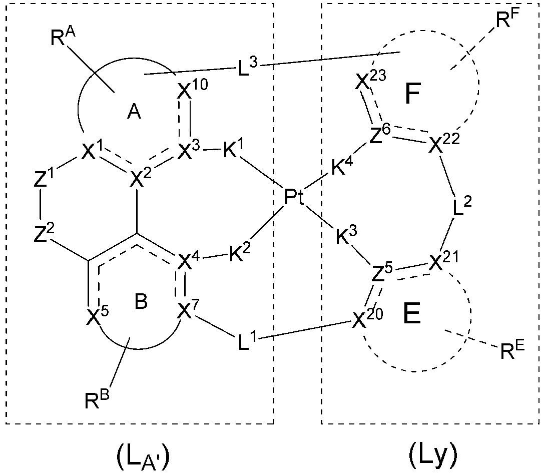 wherein L_{A'} is selected from L_{A'}Q1-(R*i*)(R*j*)(R*k*)(R*l*), L_{A'}Q2-(R*j*)(R*k*)(R*l*), L_{A'}Q3-(R*j*)(R*k*)(R*l*)(R*m*), L_{A'}Q4-(R*i*)(R*j*)(R*k*)(R*n*), L_{A'}Q5-(R*i*)(R*k*)(R*l*)(R*m*), L_{A'}Q6-(R*k*)(R*l*)(R*m*)(R*o*), L_{A'}Q7-(R*j*)(R*k*)(R*n*), L_{A'}Q8-(R*i*)(R*k*)(R*l*)(R*o*), L_{A'}Q9-(R*j*)(R*l*)(R*m*)(R*n*), Q1 is an integer of from 1-15, 17-19, 21-27, 29-259, 261, 263-276, 278, 280-366, 367-372, 376, and 396-400, Q2 is 16, 20, 28, 260, 262, 277, 279, 391, and 393; Q3 is an integer of from 373-375, 378-382, 384, 385, and 401-406, Q4 is 377, Q5 is 383 and 386, Q6 is 387-390, and 394, Q7 is 392, Q8 is 395, Q9 is 407, each *i, j, k, m*, *n, o*, and *l* is independently an integer from 1 to 468; each of R*i*, R*j*, R*k*, R*l*, R*m*, R*n* and R*o* is independently selected from R1 to R468, wherein R1 to R468 are defined in LIST 12, and each of L_{A'} structures are defined in the table below (LIST 14):

| **L_{A'}** | **Structure of L_{A'}** | **Compound** | **Structure of L_{A'}** |
|---|---|---|---|
| L_{A'}1-(R*i*)(R*j*)(R*k*)(R*l*), wherein L_{A'}1-(R1)(R1)(R1)(R1) to L_{A'}1-(R468)(R468)(R468 )(R468), have the structure | 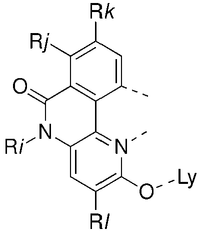 | L_{A'}2-(R*i*)(R*j*)(R*k*)(R*l*), wherein L_{A'}2-(R1)(R1)(R1)(R1) to L_{A'}2-(R468)(R468)(R468 )(R468), have the structure | 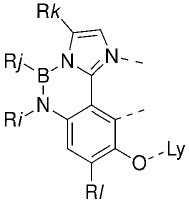 |
| L_{A'}3-(R*i*)(R*j*)(R*k*)(R*l*), wherein L_{A'}3-(R1)(R1)(R1)(R1) to L_{A'}3-(R468)(R468)(R468 )(R468), have the structure | 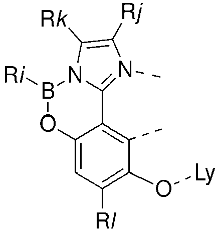 | L_{A}-4-(R*i*)(R*j*)(R*k*)(R*l*), wherein L_{A'}4-(R1)(R1)(R1)(R1) to L_{A'}4-(R468)(R468)(R468 )(R468), have the structure | 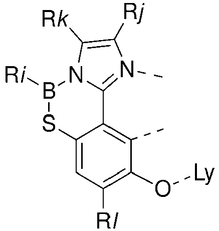 |
| L_{A'}5-(R*i*)(R*j*)(R*k*)(R*l*), wherein L_{A'}5-(R1)(R1)(R1)(R1) to L_{A'}5-(R468)(R468)(R468 )(R468), have the structure | 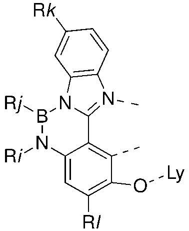 | L_{A'}-6-(R*i*)(R*j*)(R*k*)(R*l*), wherein L_{A'}6-(R1)(R1)(R1)(R1) to L_{A'}6-(R468)(R468)(R468 )(R468), have the structure | 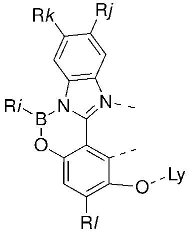 |
| L_{A'}7-(R*i*)(R*j*)(R*k*)(R*l*), wherein L_{A'}7-(R1)(R1)(R1)(R1) to L_{A'}7-(R468)(R468)(R468 )(R468), have the structure | 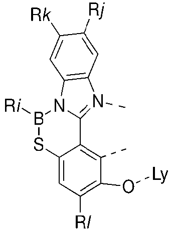 | L_{A'}8-(R*i*)(R*j*)(R*k*)(R*l*), wherein L_{A'}8-(R1)(R1)(R1)(R1) to L_{A'}8-(R468)(R468)(R468 )(R468), have the structure | 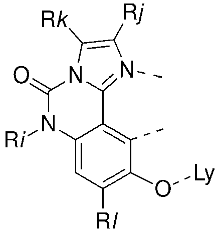 |
| L_{A'}9-(R*i*)(R*i*)(R*k*)(R*l*), wherein L_{A'}9-(R1)(R1)(R1)(R1) to L_{A'}9-(R468)(R468)(R468 )(R468), have the structure | 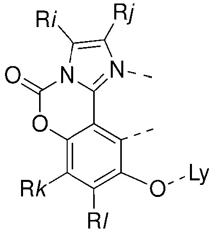 | L_{A'}10-(R*i*)(R*j*)(R*k*)(R*l*), wherein L_{A'}10-(R1)(R1)(R1)(R1) to L_{A'}10-(R468)(R468)(R468 )(R468), have the structure | 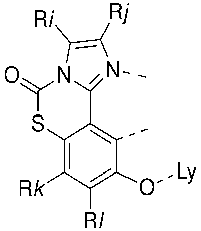 |
| L_{A'}11 - (R*i*)(R*j*)(R*k*)(R*l*)*,* wherein L_{A'}11-(R1)(R1)(R1)(R1) to L_{A'}11-(R468)(R468)(R468 )(R468), have the structure | 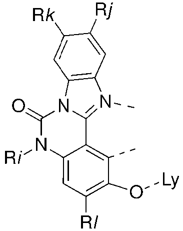 | L_{A'}12-(R*i*)(R*j*)(R*k*)(R*l*), wherein L_{A'}12-(R1)(R1)(R1)(R1) to L_{A'}12-(R468)(R468)(R468 )(R468), have the structure | 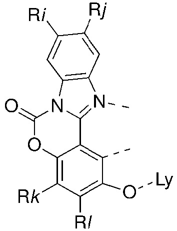 |
| L_{A'}13-(R*i*)(R*j*)(R*k*)(R*l*)*,* wherein L_{A'}13-(R1)(R1)(R1)(R1) to L_{A'}13-(R468)(R468)(R468 )(R468), have the structure | 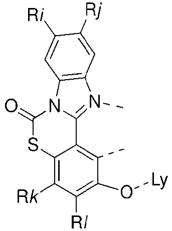 | L_{A'}14-(R*i*)(R*j*)(R*k*)(R*l*), wherein L_{A'}14-(R1)(R1)(R1)(R1) to L_{A'}14-(R468)(R468)(R468 )(R468), have the structure | 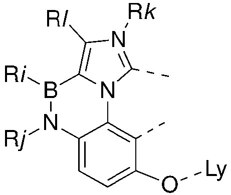 |
| L_{A'}15-(R*i*)(R*j*)(R*k*)(R*l*), wherein L_{A'}15-(R1)(R1)(R1)(R1) to L_{A'}15-(R468)(R468)(R468 )(R468), have the structure | 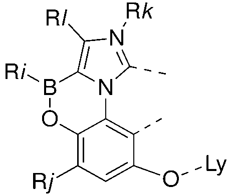 | L_{A'}16-(R*j*)(R*k*)(R*l*), wherein L_{A'}16-(R1)(R1)(R1) to L_{A'}16-(R468)(R468)(R468 ), have the structure | 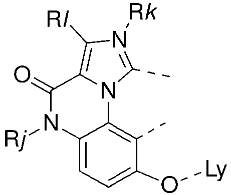 |
| L_{A'}17-(R*i*)(R*j*)(R*k*)(R*l*)*,* wherein L_{A'}17-(R1)(R1)(R1)(R1) to L_{A'}17-(R468)(R468)(R468 )(R468), have the structure | 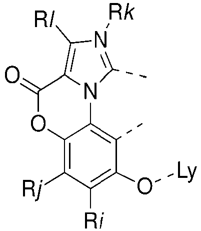 | L_{A'}18-(R*i*)(R*j*)(R*k*)(R*l*), wherein L_{A'}18-(R1)(R1)(R1)(R1) to L_{A'}18-(R468)(R468)(R468 )(R468), have the structure | 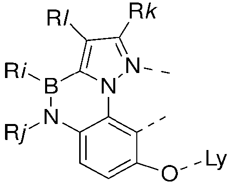 |
| L_{A'}19-(R*i*)(R*j*)(R*k*)(R*l*)*,* wherein L_{A'}19-(R1)(R1)(R1)(R1) to L_{A'}19-(R468)(R468)(R468 )(R468), have the structure | 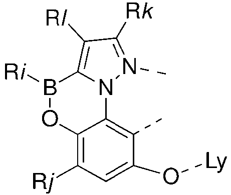 | L_{A'}20-(R*j*)(R*k*)(R*l*), wherein L_{A'}20-(R1)(R1)(R1) to L_{A'}20-(R468)(R468)(R468 ), have the structure | 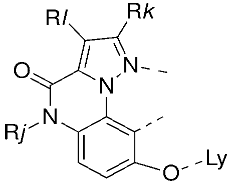 |
| L_{A'}21-(R*i*)(R*j*)(R*k*)(R*l*)*,* wherein L_{A'}21-(R1)(R1)(R1)(R1) to L_{A'}21-(R468)(R468)(R468 )(R468), have the structure | 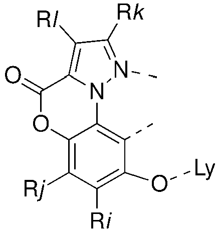 | L_{A'}22-(R*i*)(R*j*)(R*k*)(R*l*), wherein L_{A'}22-(R1)(R1)(R1)(R1) to L_{A'}22-(R468)(R468)(R468 )(R468), have the structure | 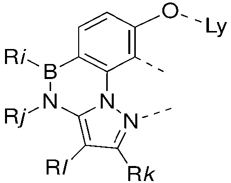 |
| L_{A'}23-(R*i*)(R*j*)(R*k*)(R*l*)*,* wherein L_{A'}23-(R1)(R1)(R1)(R1) to L_{A'}23-(R468)(R468)(R468 )(R468), have the structure | 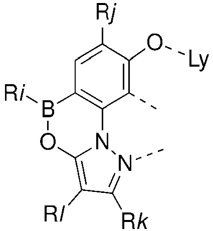 | L_{A'}24-(R*i*)(R*j*)(R*k*)(R*l*), wherein L_{A'}24-(R1)(R1)(R1)(R1) to L_{A'}24-(R468)(R468)(R468 )(R468), have the structure | 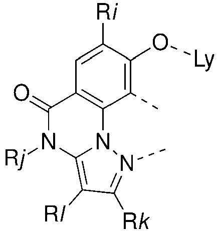 |
| L_{A'}25-(R*i*)(R*j*)(R*k*)(R*l*)*,* wherein L_{A'}25-(R1)(R1)(R1)(R1) to L_{A'}25-(R468)(R468)(R468 )(R468), have the structure | 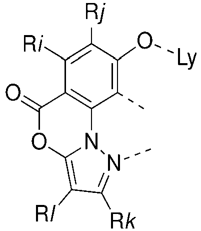 | L_{A'}26-(R*i*)(R*j*)(R*k*)(R*l*)*,* wherein L_{A'}26-(R1)(R1)(R1)(R1) to L_{A'}26-(R468)(R468)(R468 )(R468), have the structure | 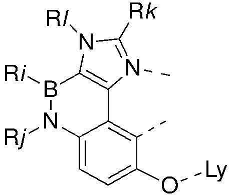 |
| L_{A'}27-(R*i*)(R*j*)(R*k*)(R*l*)*,* wherein L_{A'}27-(R1)(R1)(R1)(R1) to L_{A'}27-(R468)(R468)(R468 )(R468), have the structure | 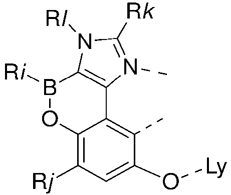 | L_{A'}28-(R*j*)(R*k*)(R*l*), wherein L_{A'}28-(R1)(R1)(R1) to L_{A'}28-(R468)(R468)(R468 ), have the structure | 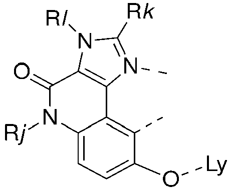 |
| L_{A'}29-(R*i*)(R*j*)(R*k*)(R*l*)*,* wherein L_{A'}29-(R1)(R1)(R1)(R1) to L_{A'}29-(R468)(R468)(R468 )(R468), have the structure | 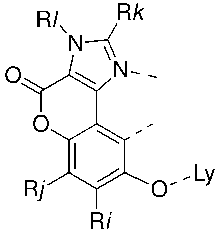 | L_{A'}30-(R*i*)(R*j*)(R*k*)(R*l*), wherein L_{A'}30-(R1)(R1)(R1)(R1) to L_{A'}30-(R468)(R468)(R468 )(R468), have the structure | 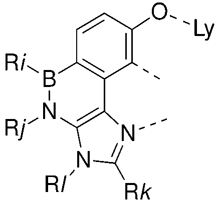 |
| L_{A'}31-(R*i*)(R*j*)(R*k*)(R*l*)*,* wherein L_{A'}31-(R1)(R1)(R1)(R1) to L_{A'}31-(R468)(R468)(R468 )(R468), have the structure | 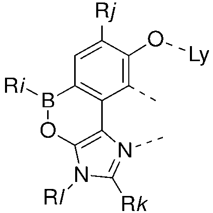 | L_{A'}32-(R*i*)(R*j*)(R*k*)(R*l*), wherein L_{A'}32-(R1)(R1)(R1)(R1) to L_{A'}32-(R468)(R468)(R468 )(R468), have the structure | 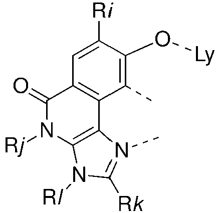 |
| L_{A'}33-(R*i*)(R*j*)(R*k*)(R*l*)*,* wherein L_{A'}33-(R1)(R1)(R1)(R1) to L_{A'}33-(R468)(R468)(R468 )(R468), have the structure | 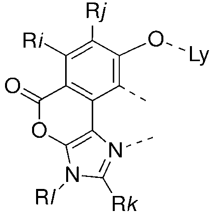 | L_{A'}34-(R*i*)(R*j*)(R*k*)(R*l*), wherein L_{A'}34-(R1)(R1)(R1)(R1) to L_{A'}34-(R468)(R468)(R468 )(R468), have the structure | 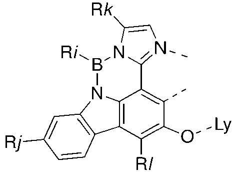 |
| L_{A'}35-(R*i*)(R*j*)(R*k*)(R*l*)*,* wherein L_{A'}35-(R1)(R1)(R1)(R1) to L_{A'}35-(R468)(R468)(R468 )(R468), have the structure | 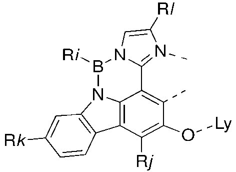 | L_{A'}36-(R*i*)(R*j*)(R*k*)(R*l*), wherein L_{A'}36-(R1)(R1)(R1)(R1) to L_{A'}36-(R468)(R468)(R468 )(R468), have the structure | 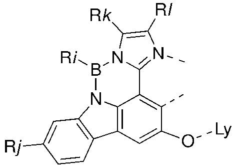 |
| L_{A'}37-(R*i*)(R*j*)(R*k*)(R*l*)*,* wherein L_{A'}37-(R1)(R1)(R1)(R1) to L_{A'}37-(R468)(R468)(R468 )(R468), have the structure | 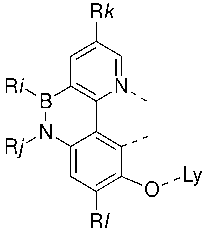 | L_{A'}38-(R*i*)(R*j*)(R*k*)(R*l*), wherein L_{A'}38-(R1)(R1)(R1)(R1) to L_{A'}38-(R468)(R468)(R468 )(R468), have the structure | 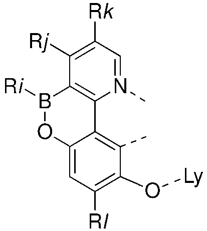 |
| L_{A'}39-(R*i*)(R*j*)(R*k*)(R*l*)*,* wherein L_{A'}39-(R1)(R1)(R1)(R1) to L_{A'}39-(R468)(R468)(R468 )(R468), have the structure | 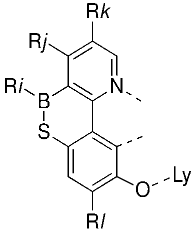 | L_{A'}40-(R*i*)(R*j*)(R*k*)(R*l*), wherein L_{A'}40-(R1)(R1)(R1)(R1) to L_{A'}40-(R468)(R468)(R468 )(R468), have the structure | 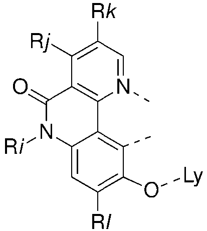 |
| L_{A'}41-(R*i*)(R*j*)(R*k*)(R*l*)*,* wherein L_{A'}41-(R1)(R1)(R1)(R1) to L_{A'}41-(R468)(R468)(R468 )(R468), have the structure | 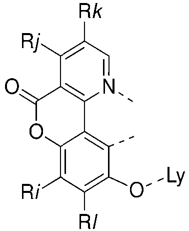 | L_{A'}42-(R*i*)(R*j*)(R*k*)(R*l*), wherein L_{A'}42-(R1)(R1)(R1)(R1) to L_{A'}42-(R468)(R468)(R468 )(R468), have the structure | 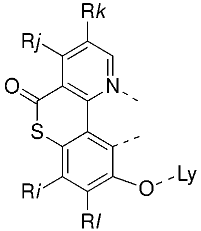 |
| L_{A'}43-(R*i*)(R*j*)(R*k*)(R*l*)*,* wherein L_{A'}43-(R1)(R1)(R1)(R1) to L_{A'}43-(R468)(R468)(R468 )(R468), have the structure | 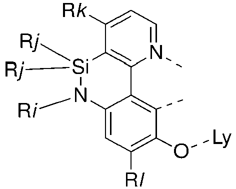 | L_{A'}44-(R*i*)(R*j*)(R*k*)(R*l*), wherein L_{A'}44-(R1)(R1)(R1)(R1) to L_{A'}-44-(R468)(R468)(R468 )(R468), have the structure | 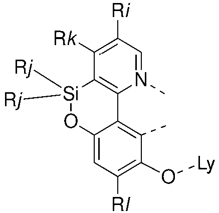 |
| L_{A'}45-(R*i*)(R*j*)(R*k*)(R*l*)*,* wherein L_{A'}45-(R1)(R1)(R1)(R1) to L_{A'}45-(R468)(R468)(R468 )(R468), have the structure | 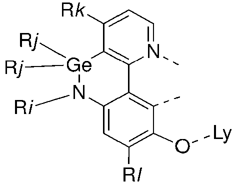 | L_{A'}46-(R*i*)(R*j*)(R*k*)(R*l*), wherein L_{A'}46-(R1)(R1)(R1)(R1) to L_{A'}46-(R468)(R468)(R468 )(R468), have the structure | 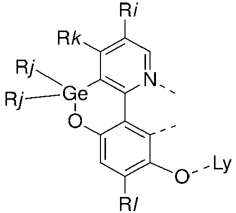 |
| L_{A'}47-(R*i*)(R*j*)(R*k*)(R*l*)*,* wherein L_{A'}47-(R1)(R1)(R1)(R1) to L_{A'}47-(R468)(R468)(R468 )(R468), have the structure | 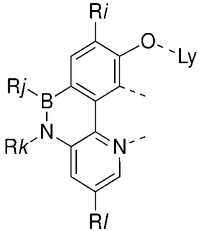 | L_{A'}48-(R*i*)(R*j*)(R*k*)(R*l*), wherein L_{A'}48-(R1)(R1)(R1)(R1) to L_{A'}48-(R468)(R468)(R468 )(R468), have the structure | 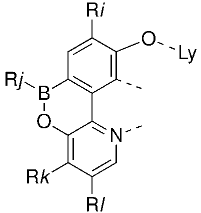 |
| L_{A'}49-(R*i*)(R*j*)(R*k*)(R*l*)*,* wherein L_{A'}49-(R1)(R1)(R1)(R1) to L_{A'}49-(R468)(R468)(R468 )(R468), have the structure | 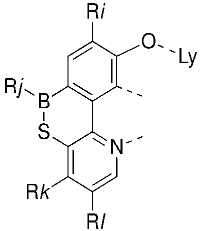 | L_{A'}50-(R*i*)(R*j*)(R*k*)(R*l*), wherein L_{A'}50-(R1)(R1)(R1)(R1) to L_{A'}50-(R468)(R468)(R468 )(R468), have the structure | 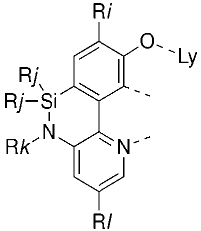 |
| L_{A'}51-(R*i*)(R*j*)(R*k*)(R*l*)*,* wherein L_{A'}51-(R1)(R1)(R1)(R1) to L_{A'}51-(R468)(R468)(R468 )(R468), have the structure | 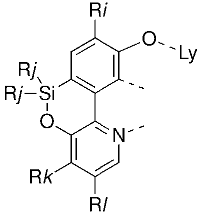 | L_{A'S2}-(R*i*)(R*j*)(R*k*)(R*l*)*,* wherein L_{A'}52-(R1)(R1)(R1)(R1) to L_{A'}52-(R468)(R468)(R468 )(R468), have the structure | 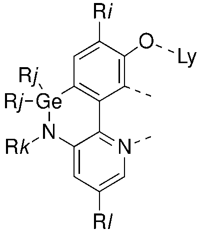 |
| L_{A'}53-(R*i*)(R*j*)(R*k*)(R*l*)*,* wherein L_{A'}53-(R1)(R1)(R1)(R1) to L_{A'}53-(R468)(R468)(R468 )(R468), have the structure | 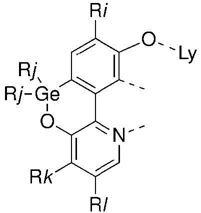 | L_{A'}54-(R*i*)(R*j*)(R*k*)(R*l*)*,* wherein L_{A'}54-(R1)(R1)(R1)(R1) to L_{A'}54-(R468)(R468)(R468 )(R468), have the structure | 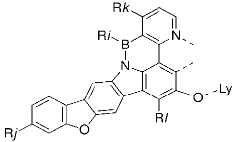 |
| L_{A'}55-(R*i*)(R*j*)(R*k*)(R*l*)*,* wherein L_{A'}55-(R1)(R1)(R1)(R1) to L_{A'}55-(R468)(R468)(R468 )(R468), have the structure | 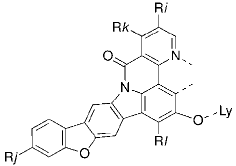 | L_{A'}56-(R*i*)(R*j*)(R*k*)(R*l*)*,* wherein L_{A'}56-(R1)(R1)(R1)(R1) to L_{A'}56-(R468)(R468)(R468 )(R468), have the structure | 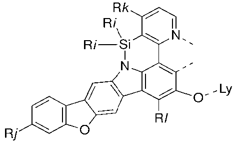 |
| L_{A'}57-(R*i*)(R*j*)(R*k*)(R*l*)*,* wherein L_{A'}57-(R1)(R1)(R1)(R1) to L_{A'}57-(R468)(R468)(R468 )(R468), have the structure | 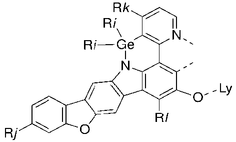 | L_{A'}58-(R*i*)(R*j*)(R*k*)(R*l*)*,* wherein L_{A'}58-(R1)(R1)(R1)(R1) to L_{A'}58-(R468)(R468)(R468 )(R468), have the structure | 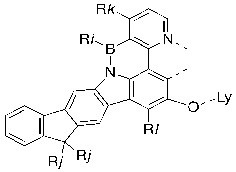 |
| L_{A'}59-(R*i*)(R*j*)(R*k*)(R*l*)*,* wherein L_{A'}59-(R1)(R1)(R1)(R1) to L_{A'}59-(R468)(R468)(R468 )(R468), have the structure | 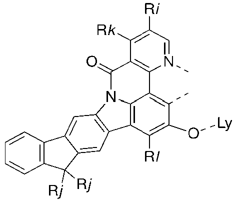 | L_{A'}60-(R*i*)(R*j*)(R*k*)(R*l*)*,* wherein L_{A'}60-(R1)(R1)(R1)(R1) to L_{A'}60-(R468)(R468)(R468 )(R468), have the structure | 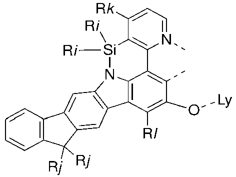 |
| L_{A}61-(R*i*)(R*j*)(R*k*)(R*l*)*,* wherein L_{A'}61-(R1)(R1)(R1)(R1) to L_{A'}61-(R468)(R468)(R468 )(R468), have the structure | 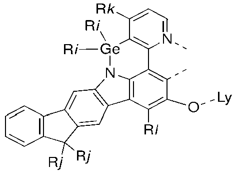 | L_{A'}62-(R*i*)(R*j*)(R*k*)(R*l*)*,* wherein L_{A'}62-(R1)(R1)(R1)(R1) to L_{A'}62-(R468)(R468)(R468 )(R468), have the structure | 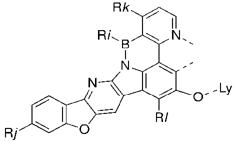 |
| L_{A'}63-(R*i*)(R*j*)(R*k*)(R*l*)*,* wherein L_{A'}63-(R1)(R1)(R1)(R1) to L_{A'}63-(R468)(R468)(R468 )(R468), have the structure | 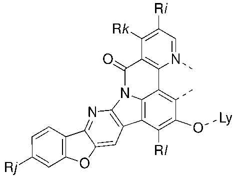 | L_{A'}64-(R*i*)(R*j*)(R*k*)(R*l*)*,* wherein L_{A'}64-(R1)(R1)(R1)(R1) to L_{A'}64-(R468)(R468)(R468 )(R468), have the structure | 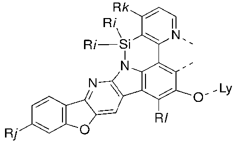 |
| L_{A'}65-(R*i*)(R*j*)(R*k*)(R*l*)*,* wherein L_{A'}65-(R1)(R1)(R1)(R1) to L_{A'}65-(R468)(R468)(R468 )(R468), have the structure | 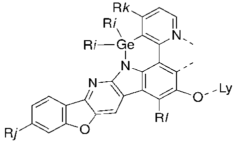 | L_{A'}66-(R*i*)(R*j*)(R*k*)(R*l*)*,* wherein L_{A'}66-(R1)(R1)(R1)(R1) to L_{A'}66-(R468)(R468)(R468 )(R468), have the structure | 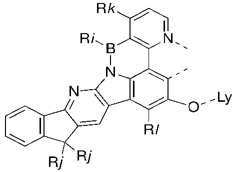 |
| L_{A'67}-(R*i*)(R*j*)(R*k*)(R*l*)*,* wherein L_{A'}67-(R1)(R1)(R1)(R1) to L_{A'67}-(R468)(R468)(R468 )(R468), have the structure | 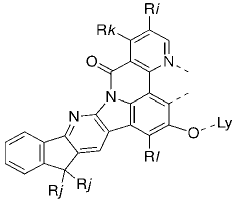 | L_{A'68}-(R*i*)(R*j*)(R*k*)(R*l*)*,* wherein L_{A'}68-(R1)(R1)(R1)(R1) to L_{A'}68-(R468)(R468)(R468 )(R468), have the structure | 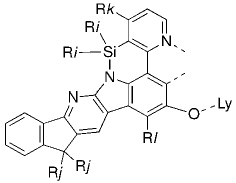 |
| L_{A}'69-(R*i*)(R*j*)(R*k*)(R*l*)*,* wherein L_{A'}69-(R1)(R1)(R1)(R1) to L_{A'}69-(R468)(R468)(R468 )(R468), have the structure | 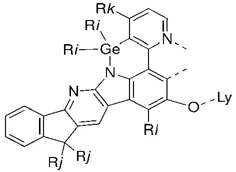 | L_{A'}70-(R*i*)(R*j*)(R*k*)(R*l*)*,* wherein L_{A'}70-(R1)(R1)(R1)(R1) to L_{A'}70-(R468)(R468)(R468 )(R468), have the structure | 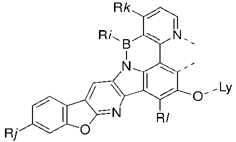 |
| L_{A'}71-(R*i*)(R*j*)(R*k*)(R*l*)*,* wherein L_{A'}71-(R1)(R1)(R1)(R1) to L_{A'}71-(R468)(R468)(R468 )(R468), have the structure | 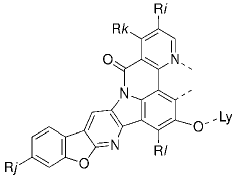 | L_{A'}72-(R*i*)(R*j*)(R*k*)(R*l*)*,* wherein L_{A'}72-(R1)(R1)(R1)(R1) to L_{A'}72-(R468)(R468)(R468 )(R468), have the structure | 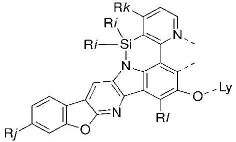 |
| L_{A'}73-(R*i*)(R*j*)(R*k*)(R*l*)*,* wherein L_{A'}73-(R1)(R1)(R1)(R1) to L_{A'}73-(R468)(R468)(R468 )(R468), have the structure | 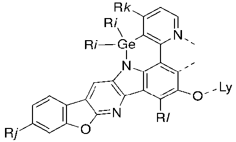 | L_{A'}74-(R*i*)(R*j*)(R*k*)(R*l*)*,* wherein L_{A'}74-(R1)(R1)(R1)(R1) to L_{A'}74-(R468)(R468)(R468 )(R468), have the structure | 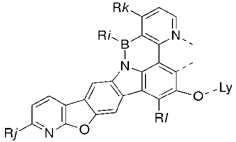 |
| L_{A'}75-(R*i*)(R*j*)(R*k*)(R*l*)*,* wherein L_{A'}75-(R1)(R1)(R1)(R1) to L_{A'}75-(R468)(R468)(R468 )(R468), have the structure | 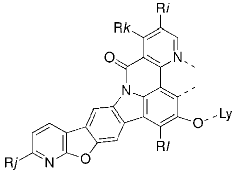 | L_{A'}76-(R*i*)(R*j*)(R*k*)(R*l*)*,* wherein L_{A'}76-(R1)(R1)(R1)(R1) to L_{A'}76-(R468)(R468)(R468 )(R468), have the structure | 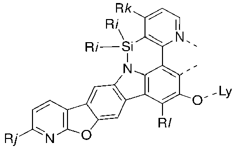 |
| L_{A'}77-(R*i*)(R*j*)(R*k*)(R*l*)*,* wherein L_{A'}77-(R1)(R1)(R1)(R1) to L_{A'}77-(R468)(R468)(R468 )(R468), have the structure | 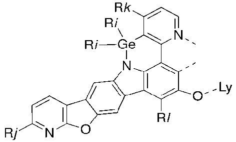 | L_{A'}78-(R*i*)(R*j*)(R*k*)(R*l*)*,* wherein L_{A'}78-(R1)(R1)(R1)(R1) to L_{A'}78-(R468)(R468)(R468 )(R468), have the structure | 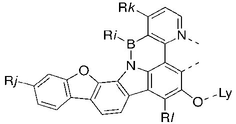 |
| L_{A'}79-(R*i*)(R*j*)(R*k*)(R*l*)*,* wherein L_{A'}79-(R1)(R1)(R1)(R1) to L_{A'}79-(R468)(R468)(R468 )(R468), have the structure | 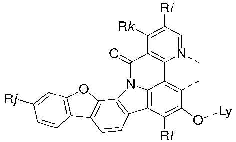 | L_{A'}80-(R*i*)(R*j*)(R*k*)(R*l*)*,* wherein L_{A'}80-(R1)(R1)(R1)(R1) to L_{A'}80-(R468)(R468)(R468 )(R468), have the structure | 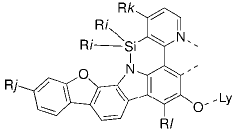 |
| L_{A'}81-(R*i*)(R*j*)(R*k*)(R*l*)*,* wherein L_{A'}81-(R1)(R1)(R1)(R1) to L_{A'}81-(R468)(R468)(R468 )(R468), have the structure | 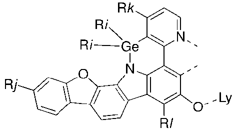 | L_{A'}82-(R*i*)(R*j*)(R*k*)(R*l*)*,* wherein L_{A'}82-(R1)(R1)(R1)(R1) to L_{A'}82-(R468)(R468)(R468 )(R468), have the structure | 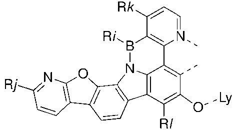 |
| L_{A'}83-(R*i*)(R*j*)(R*k*)(R*l*)*,* wherein L_{A'}83-(R1)(R1)(R1)(R1) to L_{A'}83-(R468)(R468)(R468 )(R468), have the structure | 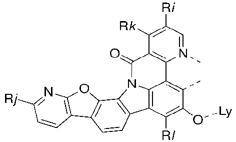 | L_{A'}84-(R*i*)(R*j*)(R*k*)(R*l*)*,* wherein L_{A'}84-(R1)(R1)(R1)(R1) to L_{A'}84-(R468)(R468)(R468 )(R468), have the structure | 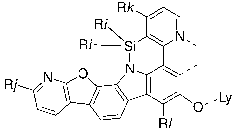 |
| L_{A'}85-(R*i*)(R*j*)(R*k*)(R*l*)*,* wherein L_{A'}85-(R1)(R1)(R1)(R1) to L_{A'}85-(R468)(R468)(R468 )(R468), have the structure | 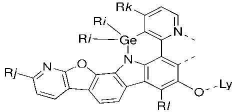 | L_{A'}86-(R*i*)(R*j*)(R*k*)(R*l*)*,* wherein L_{A'}86-(R1)(R1)(R1)(R1) to L_{A'}86-(R468)(R468)(R468 )(R468), have the structure | 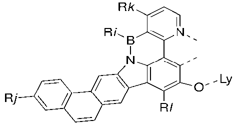 |
| L_{A'}87-(R*i*)(R*j*)(R*k*)(R*l*)*,* wherein L_{A'}87-(R1)(R1)(R1)(R1) to L_{A'}87-(R468)(R468)(R468 )(R468), have the structure | 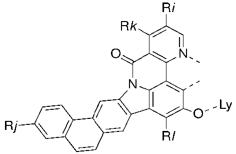 | L_{A'}88-(R*i*)(R*j*)(R*k*)(R*l*)*,* wherein L_{A'}88-(R1)(R1)(R1)(R1) to L_{A'}88-(R468)(R468)(R468 )(R468), have the structure | 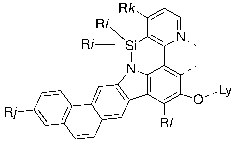 |
| L_{A'}89-(R*i*)(R*j*)(R*k*)(R*l*)*,* wherein L_{A'}89-(R1)(R1)(R1)(R1) to L_{A'}89-(R468)(R468)(R468 )(R468), have the structure | 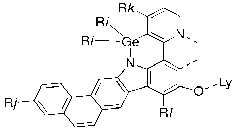 | L_{A'}90-(R*i*)(R*j*)(R*k*)(R*l*)*,* wherein L_{A'}90-(R1)(R1)(R1)(R1) to L_{A'}90-(R468)(R468)(R468 )(R468), have the structure | 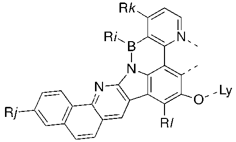 |
| L_{A'}91-(R*i*)(R*j*)(R*k*)(R*l*)*,* wherein L_{A'}91-(R1)(R1)(R1)(R1) to L_{A'}91-(R468)(R468)(R468 )(R468), have the structure | 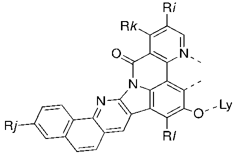 | L_{A'}92-(R*i*)(R*j*)(R*k*)(R*l*)*,* wherein L_{A'}92-(R1)(R1)(R1)(R1) to L_{A'}92-(R468)(R468)(R468 )(R468), have the structure | 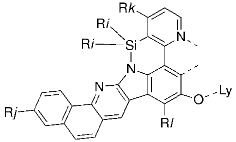 |
| L_{A'}93-(R*i*)(R*j*)(R*k*)(R*l*)*,* wherein L_{A'}93-(R1)(R1)(R1)(R1) to L_{A'}93-(R468)(R468)(R468 )(R468), have the structure | 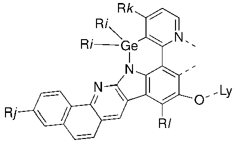 | L_{A'}94-(R*i*)(R*j*)(R*k*)(R*l*)*,* wherein L_{A'}94-(R1)(R1)(R1)(R1) to L_{A'}94-(R468)(R468)(R468 )(R468), have the structure | 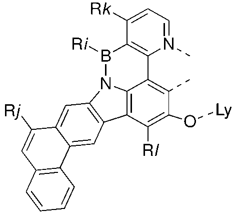 |
| L_{A'}95-(R*i*)(R*j*)(R*k*)(R*l*)*,* wherein L_{A'}95-(R1)(R1)(R1)(R1) to L_{A'}95-(R468)(R468)(R468 )(R468), have the structure | 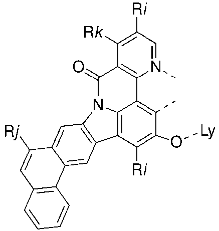 | L_{A'}96-(R*i*)(R*j*)(R*k*)(R*l*)*,* wherein L_{A'}96-(R1)(R1)(R1)(R1) to L_{A'}96-(R468)(R468)(R468 )(R468), have the structure | 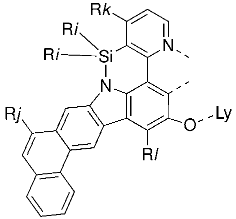 |
| L_{A'}97-(R*i*)(R*j*)(R*k*)(R*l*)*,* wherein L_{A'}97-(R1)(R1)(R1)(R1) to L_{A'}97-(R468)(R468)(R468 )(R468), have the structure | 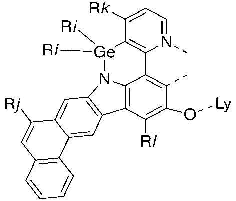 | L_{A'}98-(R*i*)(R*j*)(R*k*)(R*l*)*,* wherein L_{A'}98-(R1)(R1)(R1)(R1) to L_{A'}98-(R468)(R468)(R468 )(R468), have the structure | 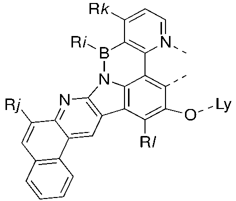 |
| L_{A'}99-(R*i*)(R*j*)(R*k*)(R*l*)*,* wherein L_{A'}99-(R1)(R1)(R1)(R1) to L_{A'}99-(R468)(R468)(R468 )(R468), have the structure | 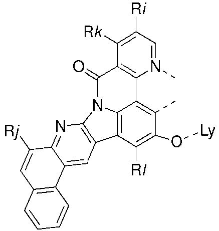 | L_{A'}100-(R*i*)(R*j*)(R*k*)(R*l*)*,* wherein L_{A'}100-(R1)(R1)(R1)(R1) to L_{A'}100-(R468)(R468)(R468 )(R468), have the structure | 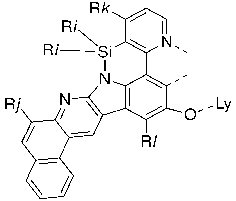 |
| L_{A'}101-(R*i*)(R*j*)(R*k*)(R*l*)*,* wherein L_{A'}101-(R1)(R1)(R1)(R1) to L_{A'}101-(R468)(R468)(R468 )(R468), have the structure | 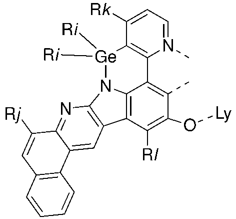 | L_{A'}102-(R*i*)(R*j*)(R*k*)(R*l*)*,* wherein L_{A'}102-(R1)(R1)(R1)(R1) to L_{A'}102-(R468)(R468)(R468 )(R468), have the structure | 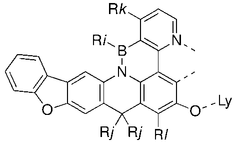 |
| L_{A'}103-(R*i*)(R*j*)(R*k*)(R*l*)*,* wherein L_{A'}103-(R1)(R1)(R1)(R1) to L_{A'}103-(R468)(R468)(R468 )(R468), have the structure | 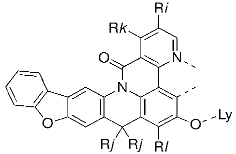 | L_{A'}104-(R*i*)(R*j*)(R*k*)(R*l*)*,* wherein L_{A'}104-(R1)(R1)(R1)(R1) to L_{A'}104-(R468)(R468)(R468 )(R468), have the structure | 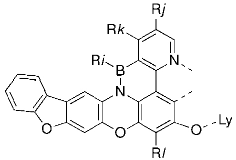 |
| L_{A'}105-(R*i*)(R*j*)(R*k*)(R*l*)*,* wherein L_{A'}105-(R1)(R1)(R1)(R1) to L_{A'}105-(R468)(R468)(R468 )(R468), have the structure | 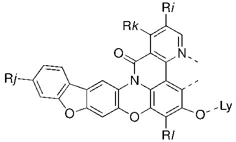 | L_{A'}106-(R*i*)(R*j*)(R*k*)(R*l*)*,* wherein L_{A'}106-(R1)(R1)(R1)(R1) to L_{A'}106-(R468)(R468)(R468 )(R468), have the structure | 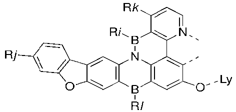 |
| L_{A'}107-(R*i*)(R*j*)(R*k*)(R*l*)*,* wherein L_{A'}107-(R1)(R1)(R1)(R1) to L_{A'}107-(R468)(R468)(R468 )(R468), have the structure | 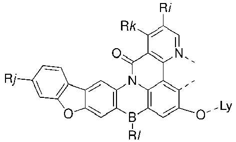 | L_{A'}108-(R*i*)(R*j*)(R*k*)(R*l*)*,* wherein L_{A'}108-(R1)(R1)(R1)(R1) to L_{A'}108-(R468)(R468)(R468 )(R468), have the structure | 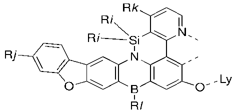 |
| L_{A'}109-(R*i*)(R*j*)(R*k*)(R*l*)*,* wherein L_{A'}109-(R1)(R1)(R1)(R1) to L_{A'}109-(R468)(R468)(R468 )(R468), have the structure | 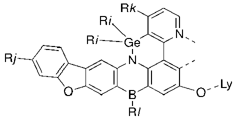 | L_{A'}110-(R*i*)(R*j*)(R*k*)(R*l*)*,* wherein L_{A'}110-(R1)(R1)(R1)(R1) to L_{A'}110-(R468)(R468)(R468 )(R468), have the structure | 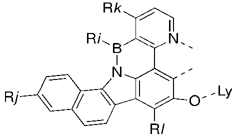 |
| L_{A'}111-(R*i*)(R*j*)(R*k*)(R*l*)*,* wherein L_{A'}111-(R1)(R1)(R1)(R1) to L_{A'}111-(R468)(R468)(R468 )(R468), have the structure | 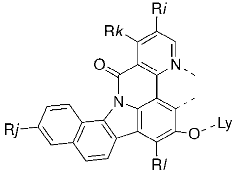 | L_{A'}112-(R*i*)(R*j*)(R*k*)(R*l*)*,* wherein L_{A'}112-(R1)(R1)(R1)(R1) to L_{A'}112-(R468)(R468)(R468 )(R468), have the structure | 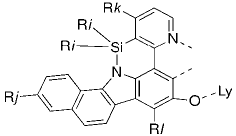 |
| L_{A'}113-(R*i*)(R*j*)(R*k*)(R*l*)*,* wherein L_{A'}113-(R1)(R1)(R1)(R1) to L_{A'}113-(R468)(R468)(R468 )(R468), have the structure | 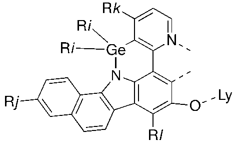 | L_{A'}114-(R*i*)(R*j*)(R*k*)(R*l*)*,* wherein L_{A'}114-(R1)(R1)(R1)(R1) to L_{A'}114-(R468)(R468)(R468 )(R468), have the structure | 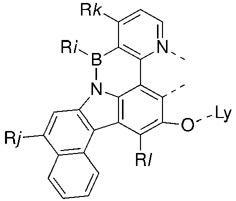 |
| L_{A'}115-(R*i*)(R*j*)(R*k*)(R*l*)*,* wherein L_{A'}115-(R1)(R1)(R1)(R1) to L_{A'}115-(R468)(R468)(R468 )(R468), have the structure | 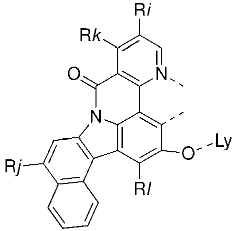 | L_{A'}116-(R*i*)(R*j*)(R*k*)(R*l*)*,* wherein L_{A'}116-(R1)(R1)(R1)(R1) to L_{A'}116-(R468)(R468)(R468 )(R468), have the structure | 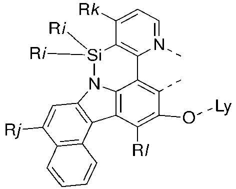 |
| L_{A'}117-(R*i*)(R*j*)(R*k*)(R*l*)*,* wherein L_{A'}117-(R1)(R1)(R1)(R1) to L_{A'}117-(R468)(R468)(R468 )(R468), have the structure | 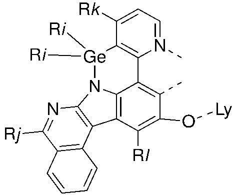 | L_{A'}118-(R*i*)(R*j*)(R*k*)(R*l*)*,* wherein L_{A'}118-(R1)(R1)(R1)(R1) to L_{A'}118-(R468)(R468)(R468 )(R468), have the structure | 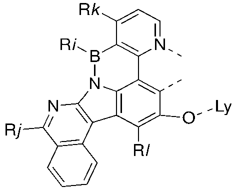 |
| L_{A'}119-(R*i*)(R*j*)(R*k*)(R*l*)*,* wherein L_{A'}119-(R1)(R1)(R1)(R1) to L_{A'}119-(R468)(R468)(R468 )(R468), have the structure | 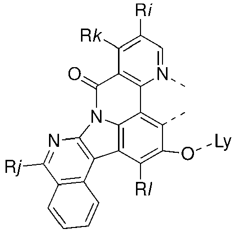 | L_{A'}120-(R*i*)(R*j*)(R*k*)(R*l*)*,* wherein L_{A'}120-(R1)(R1)(R1)(R1) to L_{A'}120-(R468)(R468)(R468 )(R468), have the structure | 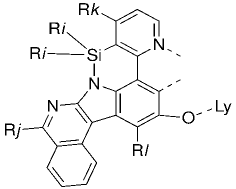 |
| L_{A'}121-(R*i*)(R*j*)(R*k*)(R*l*)*,* wherein L_{A'}121-(R1)(R1)(R1)(R1) to L_{A'}121-(R468)(R468)(R468 )(R468), have the structure | 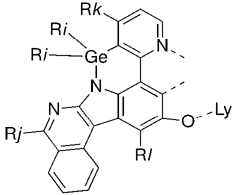 | L_{A'}122-(R*i*)(R*j*)(R*k*)(R*l*)*,* wherein L_{A'}122-(R1)(R1)(R1)(R1) to L_{A'}122-(R468)(R468)(R468 )(R468), have the structure | 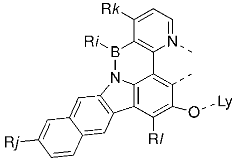 |
| L_{A'}123-(R*i*)(R*j*)(R*k*)(R*l*)*,* wherein L_{A'}123-(R1)(R1)(R1)(R1) to L_{A'}123-(R468)(R468)(R468 )(R468), have the structure | 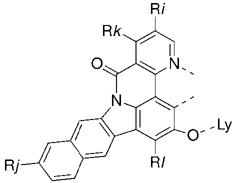 | L_{A'}124-(R*i*)(R*j*)(R*k*)(R*l*)*,* wherein L_{A'}124-(R1)(R1)(R1)(R1) to L_{A'}124-(R468)(R468)(R468 )(R468), have the structure | 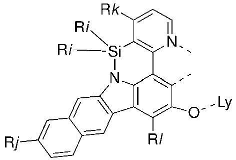 |
| L_{A'}12S-(R*i*)(R*j*)(R*k*)(R*l*)*,* wherein L_{A'}125-(R1)(R1)(R1)(R1) to L_{A'}125-(R468)(R468)(R468 )(R468), have the structure | 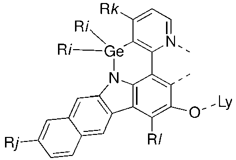 | L_{A'}126-(R*i*)(R*j*)(R*k*)(R*l*)*,* wherein L_{A'}126-(R1)(R1)(R1)(R1) to L_{A'}126-(R468)(R468)(R468 )(R468), have the structure | 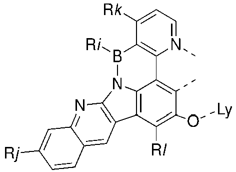 |
| L_{A'}127-(R*i*)(R*j*)(R*k*)(R*l*)*,* wherein L_{A'}127-(R1)(R1)(R1)(R1) to L_{A'}127-(R468)(R468)(R468 )(R468), have the structure | 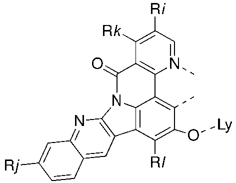 | L_{A'}128-(R*i*)(R*j*)(R*k*)(R*l*)*,* wherein L_{A'}128-(R1)(R1)(R1)(R1) to L_{A'}128-(R468)(R468)(R468 )(R468), have the structure | 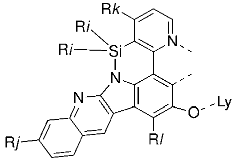 |
| L_{A'}129-(R*i*)(R*j*)(R*k*)(R*l*)*,* wherein L_{A'}129-(R1)(R1)(R1)(R1) to L_{A'}129-(R468)(R468)(R468 )(R468), have the structure | 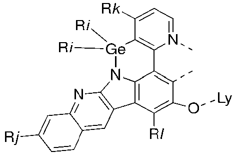 | L_{A'}130-(R*i*)(R*j*)(R*k*)(R*l*)*,* wherein L_{A'}130-(R1)(R1)(R1)(R1) to L_{A'}130-(R468)(R468)(R468 )(R468), have the structure | 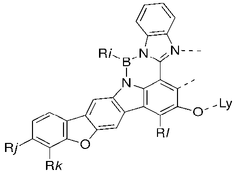 |
| L_{A'}131-(R*i*)(R*j*)(R*k*)(R*l*)*,* wherein L_{A'}131-(R1)(R1)(R1)(R1) to L_{A'}131-(R468)(R468)(R468 )(R468), have the structure | 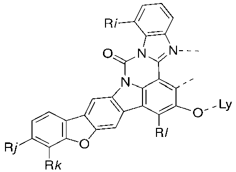 | L_{A'}132-(R*i*)(R*j*)(R*k*)(R*l*)*,* wherein L_{A'}132-(R1)(R1)(R1)(R1) to L_{A'}132-(R468)(R468)(R468 )(R468), have the structure | 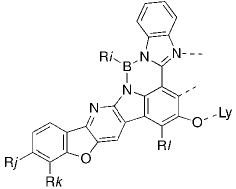 |
| L_{A'}133-(R*i*)(R*j*)(R*k*)(R*l*)*,* wherein L_{A'}133-(R1)(R1)(R1)(R1) to L_{A'}133-(R468)(R468)(R468 )(R468), have the structure | 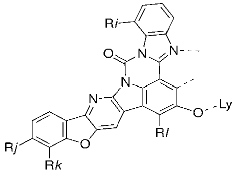 | L_{A'}134-(R*i*)(R*j*)(R*k*)(R*l*)*,* wherein L_{A'}134-(R1)(R1)(R1)(R1) to L_{A'}134-(R468)(R468)(R468 )(R468), have the structure | 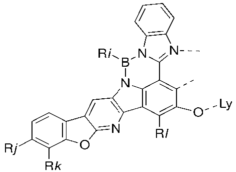 |
| L_{A'}13S-(R*i*)(R*j*)(R*k*)(R*l*)*,* wherein L_{A'}135-(R1)(R1)(R1)(R1) to L_{A'}13S-(R468)(R468)(R468 )(R468), have the structure | 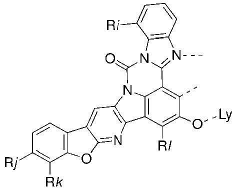 | L_{A'}136-(R*i*)(R*j*)(R*k*)(R*l*)*,* wherein L_{A'}136-(R1)(R1)(R1)(R1) to L_{A'}136-(R468)(R468)(R468 )(R468), have the structure | 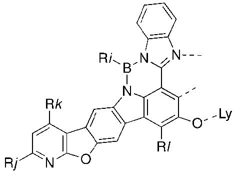 |
| L_{A'}137-(R*i*)(R*j*)(R*k*)(R*l*)*,* wherein L_{A'}137-(R1)(R1)(R1)(R1) to L_{A'}137-(R468)(R468)(R468 )(R468), have the structure | 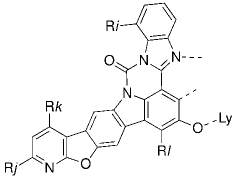 | L_{A'}138-(R*i*)(R*j*)(R*k*)(R*l*)*,* wherein L_{A'}138-(R1)(R1)(R1)(R1) to L_{A'}138-(R468)(R468)(R468 )(R468), have the structure | 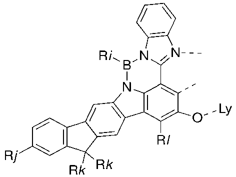 |
| L_{A'}139-(R*i*)(R*j*)(R*k*)(R*l*)*,* wherein L_{A'}139-(R1)(R1)(R1)(R1) to L_{A'}139-(R468)(R468)(R468 )(R468), have the structure | 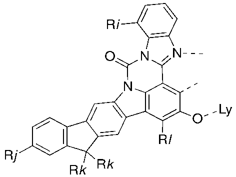 | L_{A'}140-(R*i*)(R*j*)(R*k*)(R*l*)*,* wherein L_{A'}140-(R1)(R1)(R1)(R1) to L_{A'}140-(R468)(R468)(R468 )(R468), have the structure | 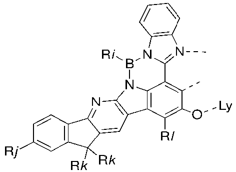 |
| L_{A'}141-(R*i*)(R*j*)(R*k*)(R*l*)*,* wherein L_{A'}141-(R1)(R1)(R1)(R1) to L_{A'}141-(R468)(R468)(R468 )(R468), have the structure | 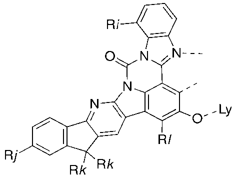 | L_{A'}142-(R*i*)(R*j*)(R*k*)(R*l*)*,* wherein L_{A'}142-(R1)(R1)(R1)(R1) to L_{A'}142-(R468)(R468)(R468 )(R468), have the structure | 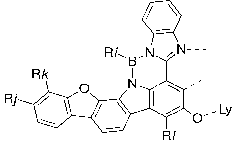 |
| L_{A'}143-(R*i*)(R*j*)(R*k*)(R*l*)*,* wherein L_{A'}143-(R1)(R1)(R1)(R1) to L_{A'}143-(R468)(R468)(R468 )(R468), have the structure | 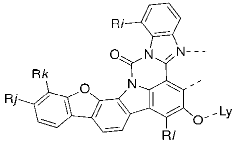 | L_{A'}144-(R*i*)(R*j*)(R*k*)(R*l*)*,* wherein L_{A'}144-(R1)(R1)(R1)(R1) to L_{A'}144-(R468)(R468)(R468 )(R468), have the structure | 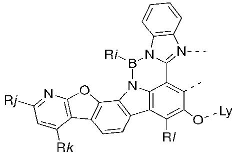 |
| L_{A'}145-(R*i*)(R*j*)(R*k*)(R*l*)*,* wherein L_{A'}145-(R1)(R1)(R1)(R1) to L_{A'}145-(R468)(R468)(R468 )(R468), have the structure | 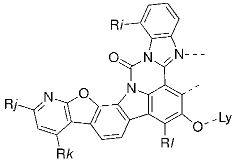 | L_{A'}146-(R*i*)(R*j*)(R*k*)(R*l*)*,* wherein L_{A'}146-(R1)(R1)(R1)(R1) to L_{A'}146-(R468)(R468)(R468 )(R468), have the structure | 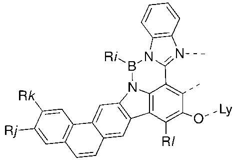 |
| L_{A'}147-(R*i*)(R*j*)(R*k*)(R*l*)*,* wherein L_{A'}147-(R1)(R1)(R1)(R1) to L_{A'}147-(R468)(R468)(R468 )(R468), have the structure | 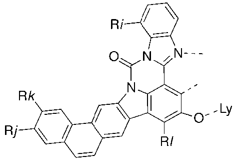 | L_{A'}148-(R*i*)(R*j*)(R*k*)(R*l*)*,* wherein L_{A'}148-(R1)(R1)(R1)(R1) to L_{A'}148-(R468)(R468)(R468 )(R468), have the structure | 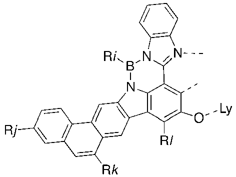 |
| L_{A'}149-(R*i*)(R*j*)(R*k*)(R*l*)*,* wherein L_{A'}149-(R1)(R1)(R1)(R1) to L_{A'}149-(R468)(R468)(R468 )(R468), have the structure | 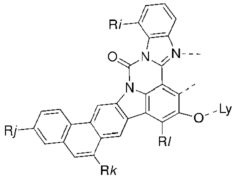 | L_{A'}150-(R*i*)(R*j*)(R*k*)(R*l*)*,* wherein L_{A'}150-(R1)(R1)(R1)(R1) to L_{A'}150-(R468)(R468)(R468 )(R468), have the structure | 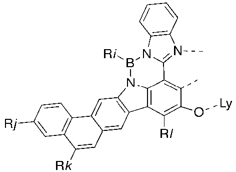 |
| L_{A'}151-(R*i*)(R*j*)(R*k*)(R*l*)*,* wherein L_{A'}151-(R1)(R1)(R1)(R1) to L_{A'}151-(R468)(R468)(R468 )(R468), have the structure | 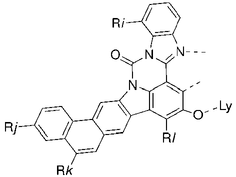 | L_{A'}152-(R*i*)(R*j*)(R*k*)(R*l*)*,* wherein L_{A'}152-(R1)(R1)(R1)(R1) to L_{A'}152-(R468)(R468)(R468 )(R468), have the structure | 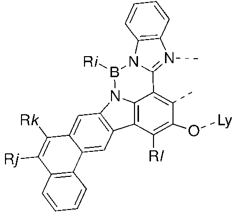 |
| L_{A'}153-(R*i*)(R*j*)(R*k*)(R*l*)*,* wherein L_{A'}153-(R1)(R1)(R1)(R1) to L_{A'}153-(R468)(R468)(R468 )(R468), have the structure | 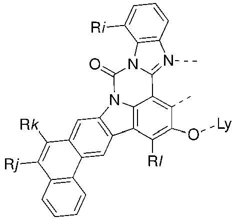 | L_{A'}154-(R*i*)(R*j*)(R*k*)(R*l*)*,* wherein L_{A'}154-(R1)(R1)(R1)(R1) to L_{A'}154-(R468)(R468)(R468 )(R468), have the structure | 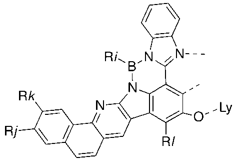 |
| L_{A'}155-(R*i*)(R*j*)(R*k*)(R*l*)*,* wherein L_{A'}155-(R1)(R1)(R1)(R1) to L_{A'}155-(R468)(R468)(R468 )(R468), have the structure | 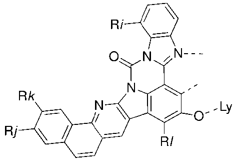 | L_{A'}156-(R*i*)(R*j*)(R*k*)(R*l*)*,* wherein L_{A'}156-(R1)(R1)(R1)(R1) to L_{A'}156-(R468)(R468)(R468 )(R468), have the structure | 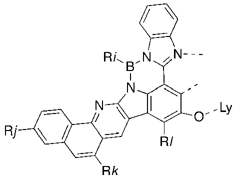 |
| L_{A'}157-(R*i*)(R*j*)(R*k*)(R*l*)*,* wherein L_{A'}157-(R1)(R1)(R1)(R1) to L_{A'}157-(R468)(R468)(R468 )(R468), have the structure | 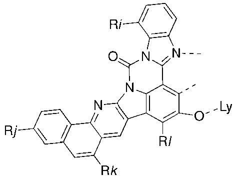 | L_{A'}158-(R*i*)(R*j*)(R*k*)(R*l*)*,* wherein L_{A'}158-(R1)(R1)(R1)(R1) to L_{A'}158-(R468)(R468)(R468 )(R468), have the structure | 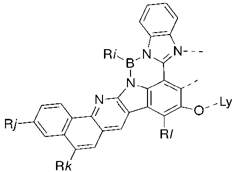 |
| L_{A'}159-(R*i*)(R*j*)(R*k*)(R*l*)*,* wherein L_{A'}159-(R1)(R1)(R1)(R1) to L_{A'}159-(R468)(R468)(R468 )(R468), have the structure | 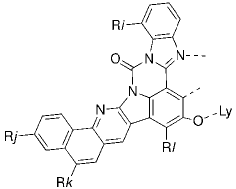 | L_{A'}160-(R*i*)(R*j*)(R*k*)(R*l*)*,* wherein L_{A'}160-(R1)(R1)(R1)(R1) to L_{A'}160-(R468)(R468)(R468 )(R468), have the structure | 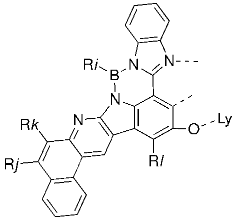 |
| L_{A'}161-(R*i*)(R*j*)(R*k*)(R*l*)*,* wherein L_{A'}161-(R1)(R1)(R1)(R1) to L_{A'}161-(R468)(R468)(R468 )(R468), have the structure | 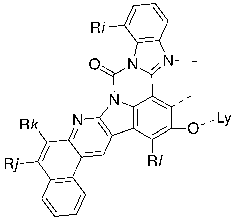 | L_{A'}162-(R*i*)(R*j*)(R*k*)(R*l*)*,* wherein L_{A'}162-(R1)(R1)(R1)(R1) to L_{A'}162-(R468)(R468)(R468 )(R468), have the structure | 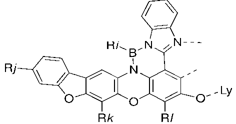 |
| L_{A'}163-(R*i*)(R*j*)(R*k*)(R*l*)*,* wherein L_{A'}163-(R1)(R1)(R1)(R1) to L_{A'}163-(R468)(R468)(R468 )(R468), have the structure | 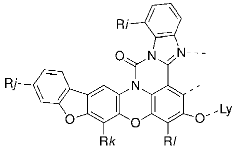 | L_{A'}164-(R*i*)(R*j*)(R*k*)(R*l*)*,* wherein L_{A'}164-(R1)(R1)(R1)(R1) to L_{A'}164-(R468)(R468)(R468 )(R468), have the structure | 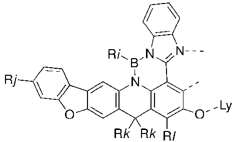 |
| L_{A'}165-(R*i*)(R*j*)(R*k*)(R*l*)*,* wherein L_{A'}165-(R1)(R1)(R1)(R1) to L_{A'}165-(R468)(R468)(R468 )(R468), have the structure | 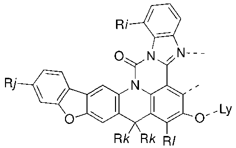 | L_{A'}166-(R*i*)(R*j*)(R*k*)(R*l*)*,* wherein L_{A'}166-(R1)(R1)(R1)(R1) to L_{A'}166-(R468)(R468)(R468 )(R468), have the structure | 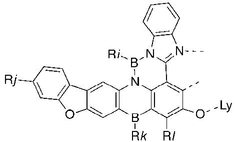 |
| L_{A'}167-(R*i*)(R*j*)(R*k*)(R*l*)*,* wherein L_{A'}167-(R1)(R1)(R1)(R1) to L_{A'}167-(R468)(R468)(R468 )(R468), have the structure | 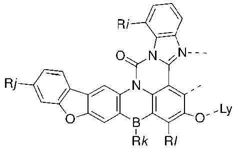 | L_{A'}168-(R*i*)(R*j*)(R*k*)(R*l*)*,* wherein L_{A'}168-(R1)(R1)(R1)(R1) to L_{A'}168-(R468)(R468)(R468 )(R468), have the structure | 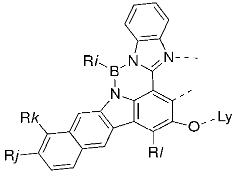 |
| L_{A'}169-(R*i*)(R*j*)(R*k*)(R*l*)*,* wherein L_{A'}169-(R1)(R1)(R1)(R1) to L_{A'}169-(R468)(R468)(R468 )(R468), have the structure | 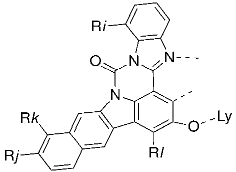 | L_{A'}170-(R*i*)(R*j*)(R*k*)(R*l*)*,* wherein L_{A'}170-(R1)(R1)(R1)(R1) to L_{A'}170-(R468)(R468)(R468 )(R468), have the structure | 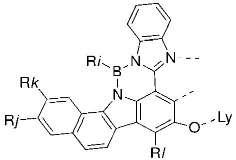 |
| L_{A'}171-(R*i*)(R*j*)(R*k*)(R*l*)*,* wherein L_{A'}171-(R1)(R1)(R1)(R1) to L_{A'}171-(R468)(R468)(R468 )(R468), have the structure | 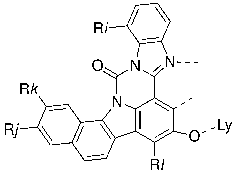 | L_{A'}172-(R*i*)(R*j*)(R*k*)(R*l*)*,* wherein L_{A'}172-(R1)(R1)(R1)(R1) to L_{A'}172-(R468)(R468)(R468 )(R468), have the structure | 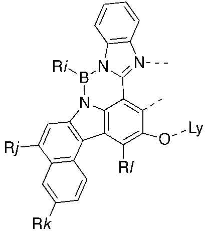 |
| L_{A'}173-(R*i*)(R*j*)(R*k*)(R*l*)*,* wherein L_{A'}173-(R1)(R1)(R1)(R1) to L_{A'}173-(R468)(R468)(R468 )(R468), have the structure | 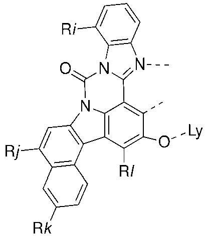 | L_{A'}174-(R*i*)(R*j*)(R*k*)(R*l*)*,* wherein L_{A'}174-(R1)(R1)(R1)(R1) to L_{A'}174-(R468)(R468)(R468 )(R468), have the structure | 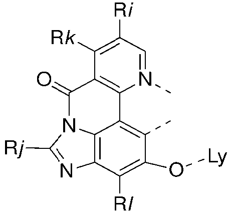 |
| L_{A'}17S-(R*i*)(R*j*)(R*k*)(R*l*)*,* wherein L_{A'}175-(R1)(R1)(R1)(R1) to L_{A'}175-(R468)(R468)(R468 )(R468), have the structure | 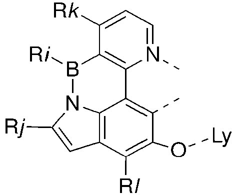 | L_{A'}176-(R*i*)(R*j*)(R*k*)(R*l*)*,* wherein L_{A'}176-(R1)(R1)(R1)(R1) to L_{A'}176-(R468)(R468)(R468 )(R468), have the structure | 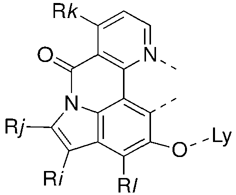 |
| L_{A'}177-(R*i*)(R*j*)(R*k*)(R*l*)*,* wherein L_{A'}177-(R1)(R1)(R1)(R1) to L_{A'}177-(R468)(R468)(R468 )(R468), have the structure | 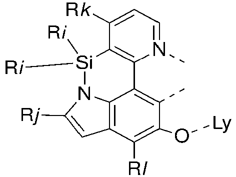 | L_{A'}178-(R*i*)(R*j*)(R*k*)(R*l*)*,* wherein L_{A'}178-(R1)(R1)(R1)(R1) to L_{A'}178-(R468)(R468)(R468 )(R468), have the structure | 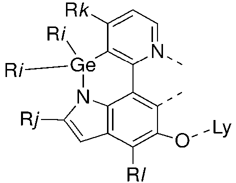 |
| L_{A'}179-(R*i*)(R*j*)(R*k*)(R*l*)*,* wherein L_{A'}179-(R1)(R1)(R1)(R1) to L_{A'}179-(R468)(R468)(R468 )(R468), have the structure | 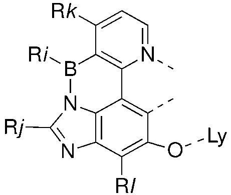 | L_{A'}180-(R*i*)(R*j*)(R*k*)(R*l*)*,* wherein L_{A'}180-(R1)(R1)(R1)(R1) to L_{A'}180-(R468)(R468)(R468 )(R468), have the structure | 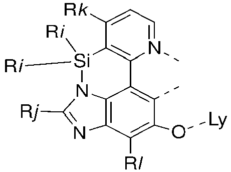 |
| L_{A'}181-(R*i*)(R*j*)(R*k*)(R*l*)*,* wherein L_{A'}181-(R1)(R1)(R1)(R1) to L_{A'}181-(R468)(R468)(R468 )(R468), have the structure | 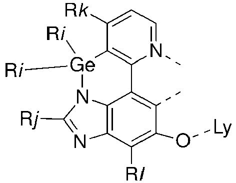 | L_{A'}182-(R*i*)(R*j*)(R*k*)(R*l*)*,* wherein L_{A'}182-(R1)(R1)(R1)(R1) to L_{A'}182-(R468)(R468)(R468 )(R468), have the structure | 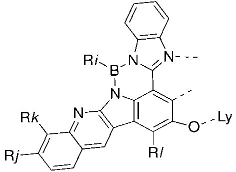 |
| L_{A'}183-(R*i*)(R*j*)(R*k*)(R*l*)*,* wherein L_{A'}183-(R1)(R1)(R1)(R1) to L_{A'}183-(R468)(R468)(R468 )(R468), have the structure | 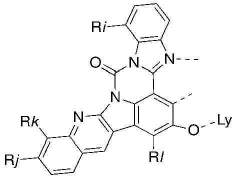 | L_{A'}184-(R*i*)(R*j*)(R*k*)(R*l*)*,* wherein L_{A'}184-(R1)(R1)(R1)(R1) to L_{A'}184-(R468)(R468)(R468 )(R468), have the structure | 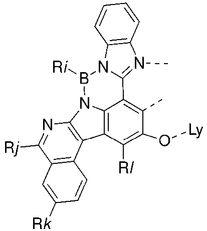 |
| L_{A'}185-(R*i*)(R*j*)(R*k*)(R*l*)*,* wherein L_{A'}185-(R1)(R1)(R1)(R1) to L_{A'}185-(R468)(R468)(R468 )(R468), have the structure | 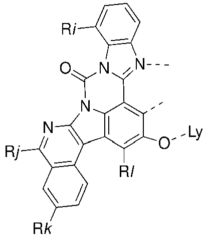 | L_{A'}186-(R*i*)(R*j*)(R*k*)(R*l*)*,* wherein L_{A'}186-(R1)(R1)(R1)(R1) to L_{A'}186-(R468)(R468)(R468 )(R468), have the structure | 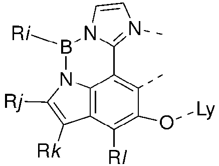 |
| L_{A'}187-(R*i*)(R*j*)(R*k*)(R*l*)*,* wherein L_{A'}187-(R1)(R1)(R1)(R1) to L_{A'}187-(R468)(R468)(R468 )(R468), have the structure | 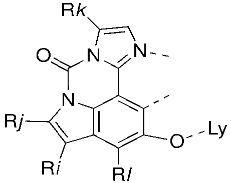 | L_{A'}188-(R*i*)(R*j*)(R*k*)(R*l*)*,* wherein L_{A'}188-(R1)(R1)(R1)(R1) to L_{A'}188-(R468)(R468)(R468 )(R468), have the structure | 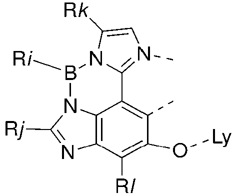 |
| L_{A'}189-(R*i*)(R*j*)(R*k*)(R*l*)*,* wherein L_{A'}189-(R1)(R1)(R1)(R1) to L_{A'}189-(R468)(R468)(R468 )(R468), have the structure | 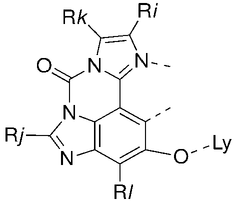 | L_{A'}190-(R*i*)(R*j*)(R*k*)(R*l*)*,* wherein L_{A'}190-(R1)(R1)(R1)(R1) to L_{A'}190-(R468)(R468)(R468 )(R468), have the structure | 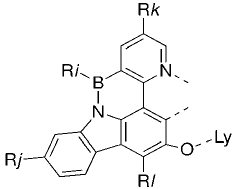 |
| L_{A'}191-(R*i*)(R*j*)(R*k*)(R*l*)*,* wherein L_{A'}191-(R1)(R1)(R1)(R1) to L_{A'}191-(R468)(R468)(R468 )(R468), have the structure | 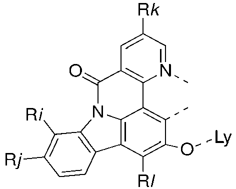 | L_{A'}192-(R*i*)(R*j*)(R*k*)(R*l*)*,* wherein L_{A'}192-(R1)(R1)(R1)(R1) to L_{A'}192-(R468)(R468)(R468 )(R468), have the structure | 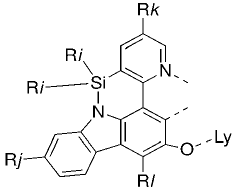 |
| L_{A'}193-(R*i*)(R*j*)(R*k*)(R*l*)*,* wherein L_{A'}193-(R1)(R1)(R1)(R1) to L_{A'}193-(R468)(R468)(R468 )(R468), have the structure | 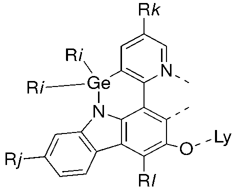 | L_{A'}194-(R*i*)(R*j*)(R*k*)(R*l*)*,* wherein L_{A'}194-(R1)(R1)(R1)(R1) to L_{A'}194-(R468)(R468)(R468 )(R468), have the structure | 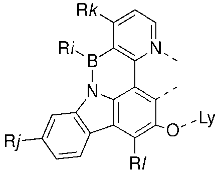 |
| L_{A'}195-(R*i*)(R*j*)(R*k*)(R*l*)*,* wherein L_{A'}195-(R1)(R1)(R1)(R1) to L_{A'}195-(R468)(R468)(R468 )(R468), have the structure | 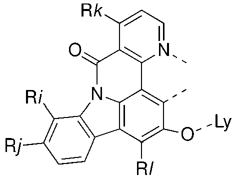 | L_{A'}196-(R*i*)(R*j*)(R*k*)(R*l*)*,* wherein L_{A'}196-(R1)(R1)(R1)(R1) to L_{A'}196-(R468)(R468)(R468 )(R468), have the structure | 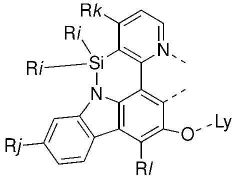 |
| L_{A'}197-(R*i*)(R*j*)(R*k*)(R*l*)*,* wherein L_{A'}197-(R1)(R1)(R1)(R1) to L_{A'}197-(R468)(R468)(R468 )(R468), have the structure | 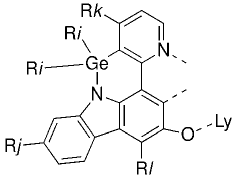 | L_{A'}198-(R*i*)(R*j*)(R*k*)(R*l*)*,* wherein L_{A'}198-(R1)(R1)(R1)(R1) to L_{A'}198-(R468)(R468)(R468 )(R468), have the structure | 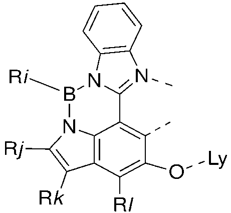 |
| L_{A'}199-(R*i*)(R*j*)(R*k*)(R*l*)*,* wherein L_{A'}199-(R1)(R1)(R1)(R1) to L_{A'}199-(R468)(R468)(R468 )(R468), have the structure | 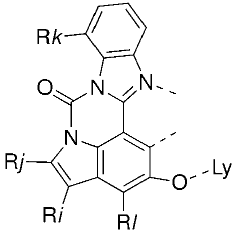 | L_{A'}200-(R*i*)(R*j*)(R*k*)(R*l*)*,* wherein L_{A'}200-(R1)(R1)(R1)(R1) to L_{A'}200-(R468)(R468)(R468 )(R468), have the structure | 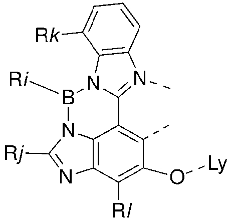 |
| L_{A'}201-(R*i*)(R*j*)(R*k*)(R*l*)*,* wherein L_{A'}201-(R1)(R1)(R1)(R1) to L_{A'}201-(R468)(R468)(R468 )(R468), have the structure | 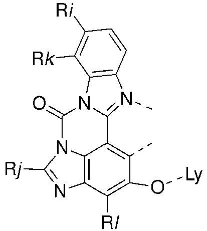 | L_{A'}202-(R*i*)(R*j*)(R*k*)(R*l*)*,* wherein L_{A'}202-(R1)(R1)(R1)(R1) to L_{A'}202-(R468)(R468)(R468 )(R468), have the structure | 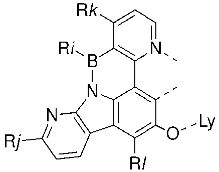 |
| L_{A'}203-(R*i*)(R*j*)(R*k*)(R*l*)*,* wherein L_{A'}203-(R1)(R1)(R1)(R1) to L_{A'}203-(R468)(R468)(R468 )(R468), have the structure | 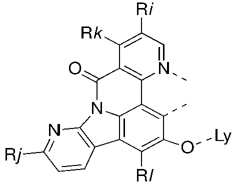 | L_{A'}204-(R*i*)(R*j*)(R*k*)(R*l*)*,* wherein L_{A'}204-(R1)(R1)(R1)(R1) to L_{A'}204-(R468)(R468)(R468 )(R468), have the structure | 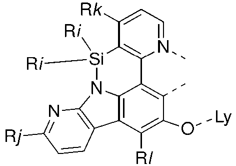 |
| L_{A'}205-(R*i*)(R*j*)(R*k*)(R*l*)*,* wherein L_{A'}205-(R1)(R1)(R1)(R1) to L_{A'}205-(R468)(R468)(R468 )(R468), have the structure | 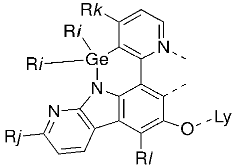 | L_{A'}206-(R*i*)(R*j*)(R*k*)(R*l*)*,* wherein L_{A'}206-(R1)(R1)(R1)(R1) to L_{A'}206-(R468)(R468)(R468 )(R468), have the structure | 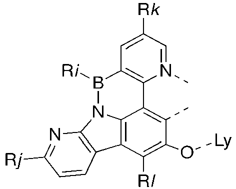 |
| L_{A'}207-(R*i*)(R*j*)(R*k*)(R*l*)*,* wherein L_{A'}207-(R1)(R1)(R1)(R1) to L_{A'}207-(R468)(R468)(R468 )(R468), have the structure | 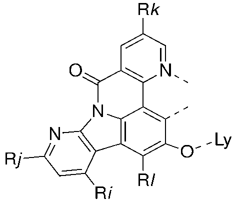 | L_{A'}208-(R*i*)(R*j*)(R*k*)(R*l*)*,* wherein L_{A'}208-(R1)(R1)(R1)(R1) to L_{A'}208-(R468)(R468)(R468 )(R468), have the structure | 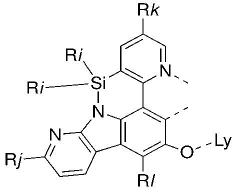 |
| L_{A'}209-(R*i*)(R*j*)(R*k*)(R*l*)*,* wherein L_{A'}209-(R1)(R1)(R1)(R1) to L_{A'}209-(R468)(R468)(R468 )(R468), have the structure | 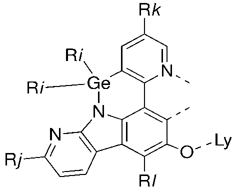 | L_{A'}210-(R*i*)(R*j*)(R*k*)(R*l*)*,* wherein L_{A'}210-(R1)(R1)(R1)(R1) to L_{A'}210-(R468)(R468)(R468 )(R468), have the structure | 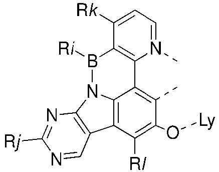 |
| L_{A'}211-(R*i*)(R*j*)(R*k*)(R*l*)*,* wherein L_{A'}211-(R1)(R1)(R1)(R1) to L_{A'}211-(R468)(R468)(R468 )(R468), have the structure | 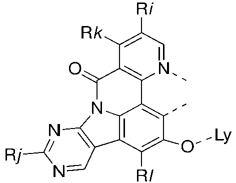 | L_{A'}212-(R*i*)(R*j*)(R*k*)(R*l*)*,* wherein L_{A'}212-(R1)(R1)(R1)(R1) to L_{A'}212-(R468)(R468)(R468 )(R468), have the structure | 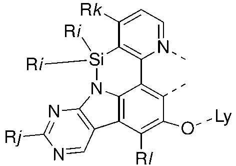 |
| L_{A'}213-(R*i*)(R*j*)(R*k*)(R*l*)*,* wherein L_{A'}213-(R1)(R1)(R1)(R1) to L_{A'}213-(R468)(R468)(R468 )(R468), have the structure | 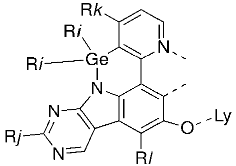 | L_{A'}214-(R*i*)(R*j*)(R*k*)(R*l*)*,* wherein L_{A'}214-(R1)(R1)(R1)(R1) to L_{A'}214-(R468)(R468)(R468 )(R468), have the structure | 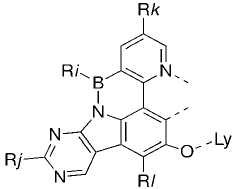 |
| L_{A'}215-(R*i*)(R*j*)(R*k*)(R*l*)*,* wherein L_{A'}215-(R1)(R1)(R1)(R1) to L_{A'}215-(R468)(R468)(R468 )(R468), have the structure | 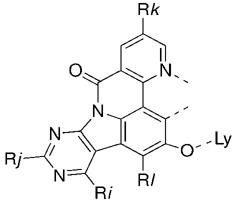 | L_{A'}216-(R*i*)(R*j*)(R*k*)(R*l*)*,* wherein L_{A'}216-(R1)(R1)(R1)(R1) to L_{A'}216-(R468)(R468)(R468 )(R468), have the structure | 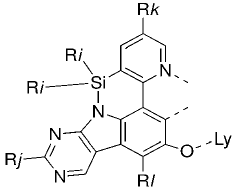 |
| L_{A'}217-(R*i*)(R*j*)(R*k*)(R*l*)*,* wherein L_{A'}217-(R1)(R1)(R1)(R1) to L_{A'}217-(R468)(R468)(R468 )(R468), have the structure | 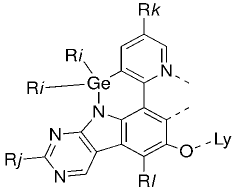 | L_{A'}218-(R*i*)(R*j*)(R*k*)(R*l*)*,* wherein L_{A'}218-(R1)(R1)(R1)(R1) to L_{A'}218-(R468)(R468)(R468 )(R468), have the structure | 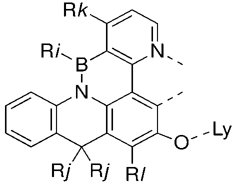 |
| L_{A'}219-(R*i*)(R*j*)(R*k*)(R*l*)*,* wherein L_{A'}219-(R1)(R1)(R1)(R1) to L_{A'}219-(R468)(R468)(R468 )(R468), have the structure | 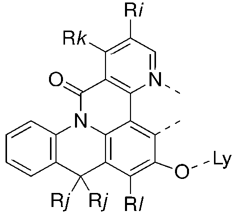 | L_{A'}220-(R*i*)(R*j*)(R*k*)(R*l*)*,* wherein L_{A'}220-(R1)(R1)(R1)(R1) to L_{A'}220-(R468)(R468)(R468 )(R468), have the structure | 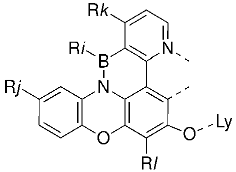 |
| L_{A'}221-(R*i*)(R*j*)(R*k*)(R*l*)*,* wherein L_{A'}221-(R1)(R1)(R1)(R1) to L_{A'}221-(R468)(R468)(R468 )(R468), have the structure | 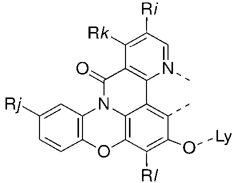 | L_{A'}222-(R*i*)(R*j*)(R*k*)(R*l*)*,* wherein L_{A'}222-(R1)(R1)(R1)(R1) to L_{A'}222-(R468)(R468)(R468 )(R468), have the structure | 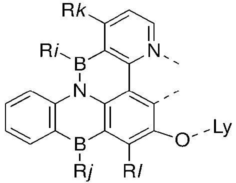 |
| L_{A'}223-(R*i*)(R*j*)(R*k*)(R*l*)*,* wherein L_{A'}223-(R1)(R1)(R1)(R1) to L_{A'}223-(R468)(R468)(R468 )(R468), have the structure | 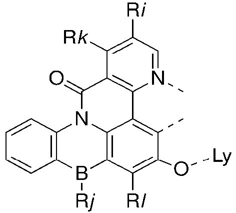 | L_{A'}224-(R*i*)(R*j*)(R*k*)(R*l*)*,* wherein L_{A'}224-(R1)(R1)(R1)(R1) to L_{A'}224-(R468)(R468)(R468 )(R468), have the structure | 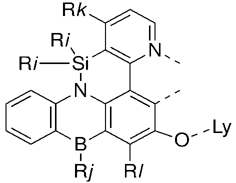 |
| L_{A'}225-(R*i*)(R*j*)(R*k*)(R*l*)*,* wherein L_{A'}225-(R1)(R1)(R1)(R1) to L_{A'}225-(R468)(R468)(R468 )(R468), have the structure | 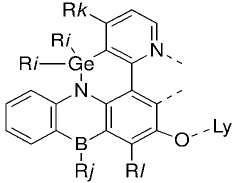 | L_{A'}226-(R*i*)(R*j*)(R*k*)(R*l*)*,* wherein L_{A'}226-(R1)(R1)(R1)(R1) to L_{A'}226-(R468)(R468)(R468 )(R468), have the structure | 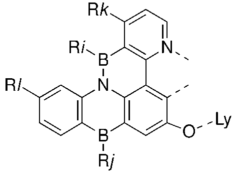 |
| L_{A'}227-(R*i*)(R*j*)(R*k*)(R*l*)*,* wherein L_{A'}227-(R1)(R1)(R1)(R1) to L_{A'}227-(R468)(R468)(R468 )(R468), have the structure | 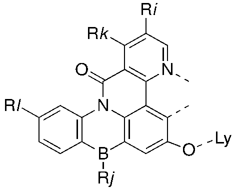 | L_{A'}228-(R*i*)(R*j*)(R*k*)(R*l*)*,* wherein L_{A'}228-(R1)(R1)(R1)(R1) to L_{A'}228-(R468)(R468)(R468 )(R468), have the structure | 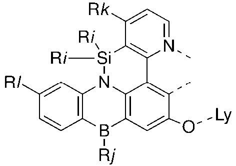 |
| L_{A'}229-(R*i*)(R*j*)(R*k*)(R*l*)*,* wherein L_{A'}229-(R1)(R1)(R1)(R1) to L_{A'}229-(R468)(R468)(R468 )(R468), have the structure | 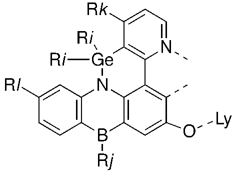 | L_{A'}230-(R*i*)(R*j*)(R*k*)(R*l*)*,* wherein L_{A'}230-(R1)(R1)(R1)(R1) to L_{A'}230-(R468)(R468)(R468 )(R468), have the structure | 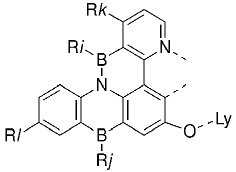 |
| L_{A'}231-(R*i*)(R*j*)(R*k*)(R*l*)*,* wherein L_{A'}231-(R1)(R1)(R1)(R1) to L_{A'}231-(R468)(R468)(R468 )(R468), have the structure | 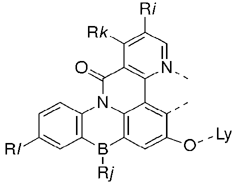 | L_{A'}232-(R*i*)(R*j*)(R*k*)(R*l*)*,* wherein L_{A'}232-(R1)(R1)(R1)(R1) to L_{A'}232-(R468)(R468)(R468 )(R468), have the structure | 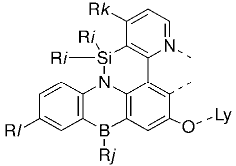 |
| L_{A'}233-(R*i*)(R*j*)(R*k*)(R*l*)*,* wherein L_{A'}233-(R1)(R1)(R1)(R1) to L_{A'}233-(R468)(R468)(R468 )(R468), have the structure | 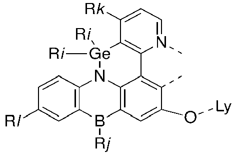 | L_{A'}234-(R*i*)(R*j*)(R*k*)(R*l*)*,* wherein L_{A'}234-(R1)(R1)(R1)(R1) to L_{A'}234-(R468)(R468)(R468 )(R468), have the structure | 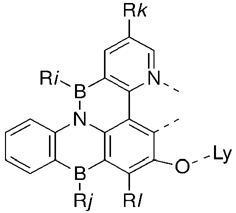 |
| L_{A'}235-(R*i*)(R*j*)(R*k*)(R*l*)*,* wherein L_{A'}235-(R1)(R1)(R1)(R1) to L_{A'}235-(R468)(R468)(R468 )(R468), have the structure | 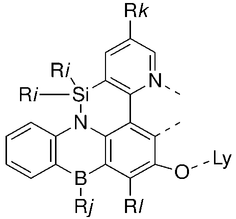 | L_{A'}236-(R*i*)(R*j*)(R*k*)(R*l*)*,* wherein L_{A'}236-(R1)(R1)(R1)(R1) to L_{A'}236-(R468)(R468)(R468 )(R468), have the structure | 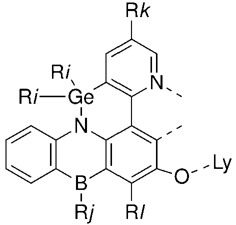 |
| L_{A'}237-(R*i*)(R*j*)(R*k*)(R*l*)*,* wherein L_{A'}237-(R1)(R1)(R1)(R1) to L_{A'}237-(R468)(R468)(R468 )(R468), have the structure | 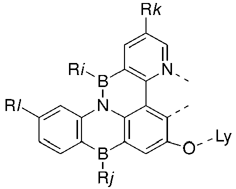 | L_{A'}238-(R*i*)(R*j*)(R*k*)(R*l*)*,* wherein L_{A'}238-(R1)(R1)(R1)(R1) to L_{A'}238-(R468)(R468)(R468 )(R468), have the structure | 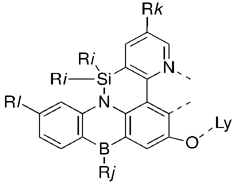 |
| L_{A'}239-(R*i*)(R*j*)(R*k*)(R*l*)*,* wherein L_{A'}239-(R1)(R1)(R1)(R1) to L_{A'}239-(R468)(R468)(R468 )(R468), have the structure | 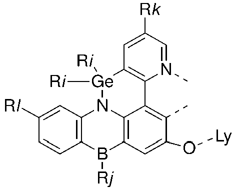 | L_{A'}240-(R*i*)(R*j*)(R*k*)(R*l*)*,* wherein L_{A'}240-(R1)(R1)(R1)(R1) to L_{A'}240-(R468)(R468)(R468 )(R468), have the structure | 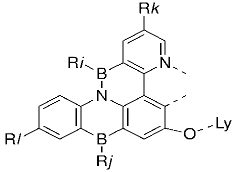 |
| L_{A'}241-(R*i*)(R*j*)(R*k*)(R*l*)*,* wherein L_{A'}241-(R1)(R1)(R1)(R1) to L_{A'}241-(R468)(R468)(R468 )(R468), have the structure | 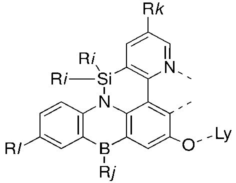 | L_{A'}242-(R*i*)(R*j*)(R*k*)(R*l*)*,* wherein L_{A'}242-(R1)(R1)(R1)(R1) to L_{A'}242-(R468)(R468)(R468 )(R468), have the structure | 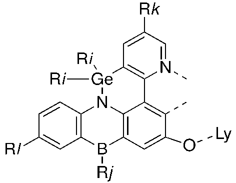 |
| L_{A'}243-(R*i*)(R*j*)(R*k*)(R*l*)*,* wherein L_{A'}243-(R1)(R1)(R1)(R1) to L_{A'}243-(R468)(R468)(R468 )(R468), have the structure | 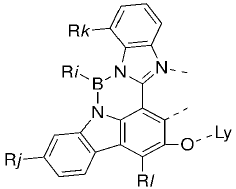 | L_{A'}244-(R*i*)(R*j*)(R*k*)(R*l*)*,* wherein L_{A'}244-(R1)(R1)(R1)(R1) to L_{A'}244-(R468)(R468)(R468 )(R468), have the structure | 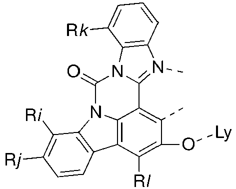 |
| L_{A'}245-(R*i*)(R*j*)(R*k*)(R*l*)*,* wherein L_{A'}245-(R1)(R1)(R1)(R1) to L_{A'}245-(R468)(R468)(R468 )(R468), have the structure | 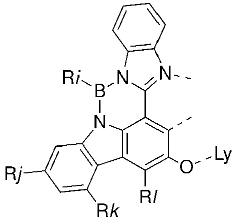 | L_{A'}246-(R*i*)(R*j*)(R*k*)(R*l*)*,* wherein L_{A'}246-(R1)(R1)(R1)(R1) to L_{A'}246-(R468)(R468)(R468 )(R468), have the structure | 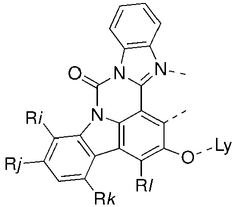 |
| L_{A'}247-(R*i*)(R*j*)(R*k*)(R*l*)*,* wherein L_{A'}247-(R1)(R1)(R1)(R1) to L_{A'}247-(R468)(R468)(R468 )(R468), have the structure | 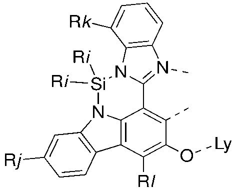 | L_{A'}248-(R*i*)(R*j*)(R*k*)(R*l*)*,* wherein L_{A'}248-(R1)(R1)(R1)(R1) to L_{A'}248-(R468)(R468)(R468 )(R468), have the structure | 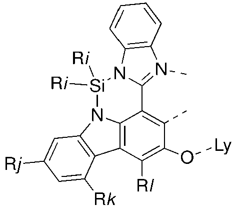 |
| L_{A'}249-(R*i*)(R*j*)(R*k*)(R*l*)*,* wherein L_{A'}249-(R1)(R1)(R1)(R1) to L_{A'}249-(R468)(R468)(R468 )(R468), have the structure | 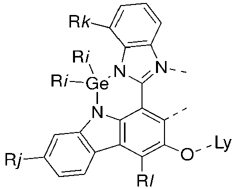 | L_{A'}250-(R*i*)(R*j*)(R*k*)(R*l*)*,* wherein L_{A'}250-(R1)(R1)(R1)(R1) to L_{A'}250-(R468)(R468)(R468 )(R468), have the structure | 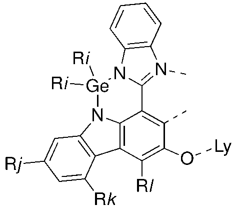 |
| L_{A'}251-(R*i*)(R*j*)(R*k*)(R*l*)*,* wherein L_{A'}251-(R1)(R1)(R1)(R1) to L_{A'}251-(R468)(R468)(R468 )(R468), have the structure | 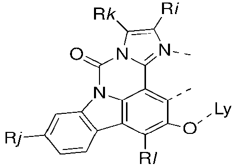 | L_{A'}252-(R*i*)(R*j*)(R*k*)(R*l*)*,* wherein L_{A'}252-(R1)(R1)(R1)(R1) to L_{A'}252-(R468)(R468)(R468 )(R468), have the structure | 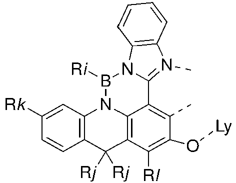 |
| L_{A'}253-(R*i*)(R*j*)(R*k*)(R*l*)*,* wherein L_{A'}253-(R1)(R1)(R1)(R1) to L_{A'}253-(R468)(R468)(R468 )(R468), have the structure | 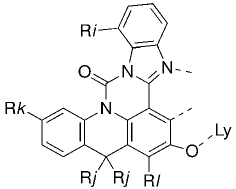 | L_{A'}254-(R*i*)(R*j*)(R*k*)(R*l*)*,* wherein L_{A'}254-(R1)(R1)(R1)(R1) to L_{A'}254-(R468)(R468)(R468 )(R468), have the structure | 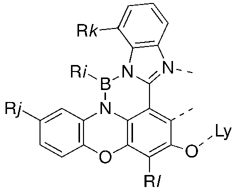 |
| L_{A'}255-(R*i*)(R*j*)(R*k*)(R*l*)*,* wherein L_{A'}255-(R1)(R1)(R1)(R1) to L_{A'}255-(R468)(R468)(R468 )(R468), have the structure | 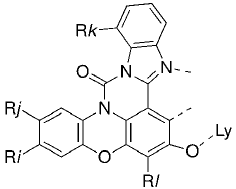 | L_{A'}256-(R*i*)(R*j*)(R*k*)(R*l*)*,* wherein L_{A'}256-(R1)(R1)(R1)(R1) to L_{A'}256-(R468)(R468)(R468 )(R468), have the structure | 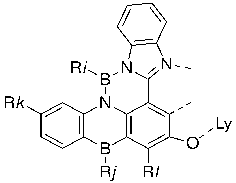 |
| L_{A'}257-(R*i*)(R*j*)(R*k*)(R*l*)*,* wherein L_{A'}257-(R1)(R1)(R1)(R1) to L_{A'}257-(R468)(R468)(R468 )(R468), have the structure | 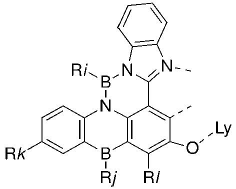 | L_{A'}258-(R*i*)(R*j*)(R*k*)(R*l*)*,* wherein L_{A'}258-(R1)(R1)(R1)(R1) to L_{A'}258-(R468)(R468)(R468 )(R468), have the structure | 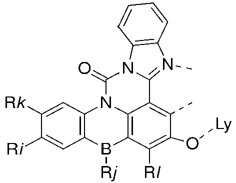 |
| L_{A'}259-(R*i*)(R*j*)(R*k*)(R*l*)*,* wherein L_{A'}259-(R1)(R1)(R1)(R1) to L_{A'}259-(R468)(R468)(R468 )(R468), have the structure | 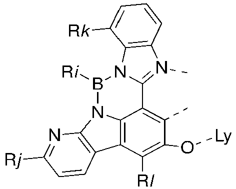 | L_{A'}260-(R*j*)(R*k*)(R*l*), wherein L_{A'}260-(R1)(R1)(R1) to L_{A'}260-(R468)(R468)(R468 ), have the structure | 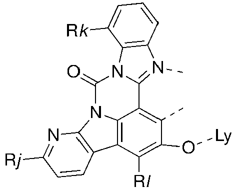 |
| L_{A'}261-(R*i*)(R*j*)(R*k*)(R*l*)*,* wherein L_{A'}261-(R1)(R1)(R1)(R1) to L_{A'}261-(R468)(R468)(R468 )(R468), have the structure | 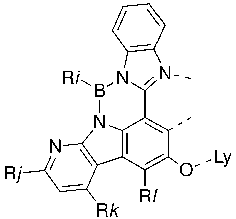 | L_{A'}262-(R*j*)(R*k*)(R*l*), wherein L_{A'}262-(R1)(R1)(R1) to L_{A'}262-(R468)(R468)(R468 ), have the structure | 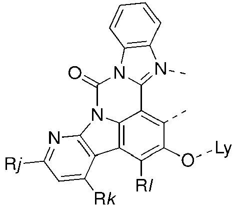 |
| L_{A'}263-(R*i*)(R*j*)(R*k*)(R*l*)*,* wherein L_{A'}263-(R1)(R1)(R1)(R1) to L_{A'}263-(R468)(R468)(R468 )(R468), have the structure | 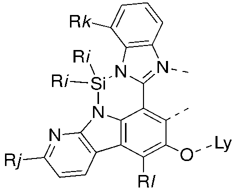 | L_{A'}264-(R*i*)(R*j*)(R*k*)(R*l*)*,* wherein L_{A'}264-(R1)(R1)(R1)(R1) to L_{A'}264-(R468)(R468)(R468 )(R468), have the structure | 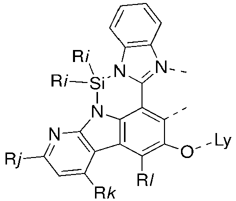 |
| L_{A'}265-(R*i*)(R*j*)(R*k*)(R*l*)*,* wherein L_{A'}265-(R1)(R1)(R1)(R1) to L_{A'}265-(R468)(R468)(R468 )(R468), have the structure | 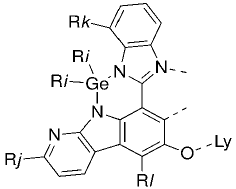 | L_{A'}266-(R*i*)(R*j*)(R*k*)(R*l*)*,* wherein L_{A'}266-(R1)(R1)(R1)(R1) to L_{A'}266-(R468)(R468)(R468 )(R468), have the structure | 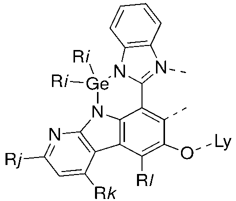 |
| L_{A'}267-(R*i*)(R*j*)(R*k*)(R*l*)*,* wherein L_{A'}267-(R1)(R1)(R1)(R1) to L_{A'}267-(R468)(R468)(R468 )(R468), have the structure | 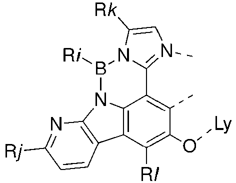 | L_{A'}268-(R*i*)(R*j*)(R*k*)(R*l*)*,* wherein L_{A'}268-(R1)(R1)(R1)(R1) to L_{A'}268-(R468)(R468)(R468 )(R468), have the structure | 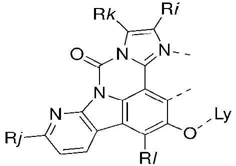 |
| L_{A'}269-(R*i*)(R*j*)(R*k*)(R*l*)*,* wherein L_{A'}269-(R1)(R1)(R1)(R1) to L_{A'}269-(R468)(R468)(R468 )(R468), have the structure | 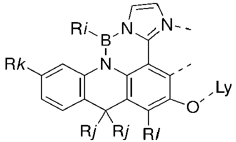 | L_{A'}270-(R*i*)(R*j*)(R*k*)(R*l*)*,* wherein L_{A'}270-(R1)(R1)(R1)(R1) to L_{A'}270-(R468)(R468)(R468 )(R468), have the structure | 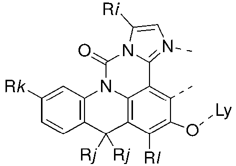 |
| L_{A'}271-(R*i*)(R*j*)(R*k*)(R*l*)*,* wherein L_{A'}271-(R1)(R1)(R1)(R1) to L_{A'}271-(R468)(R468)(R468 )(R468), have the structure | 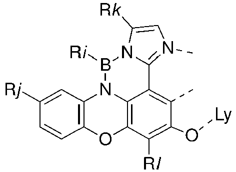 | L_{A'}272-(R*i*)(R*j*)(R*k*)(R*l*)*,* wherein L_{A'}272-(R1)(R1)(R1)(R1) to L_{A'}272-(R468)(R468)(R468 )(R468), have the structure | 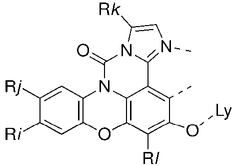 |
| L_{A'}273-(R*i*)(R*j*)(R*k*)(R*l*)*,* wherein L_{A'}273-(R1)(R1)(R1)(R1) to L_{A'}273-(R468)(R468)(R468 )(R468), have the structure | 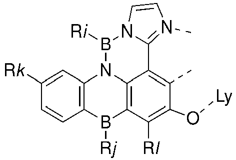 | L_{A'}274-(R*i*)(R*j*)(R*k*)(R*l*)*,* wherein L_{A'}274-(R1)(R1)(R1)(R1) to L_{A'}274-(R468)(R468)(R468 )(R468), have the structure | 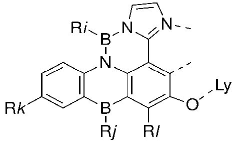 |
| L_{A'}275-(R*i*)(R*j*)(R*k*)(R*l*)*,* wherein L_{A'}275-(R1)(R1)(R1)(R1) to L_{A'}275-(R468)(R468)(R468 )(R468), have the structure | 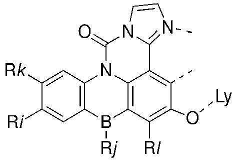 | L_{A'}276-(R*i*)(R*j*)(R*k*)(R*l*)*,* wherein L_{A'}276-(R1)(R1)(R1)(R1) to L_{A'}276-(R468)(R468)(R468 )(R468), have the structure | 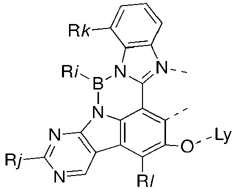 |
| L_{A'}277-(R*j*)(R*k*)(R*l*), wherein L_{A'}277-(R1)(R1)(R1) to L_{A'}277-(R468)(R468)(R468 ), have the structure | 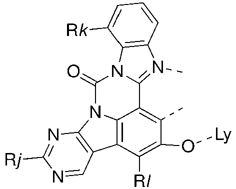 | L_{A'}278-(R*i*)(R*j*)(R*k*)(R*l*)*,* wherein L_{A'}278-(R1)(R1)(R1)(R1) to L_{A'}278-(R468)(R468)(R468 )(R468), have the structure | 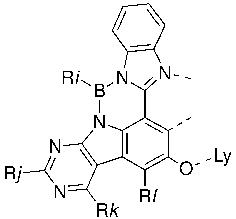 |
| L_{A'}279-(R*j*)(R*k*)(R*l*), wherein L_{A'}279-(R1)(R1)(R1) to L_{A'}279-(R468)(R468)(R468 ), have the structure | 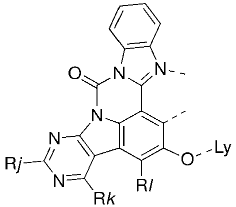 | L_{A'}280-(R*i*)(R*j*)(R*k*)(R*l*)*,* wherein L_{A'}280-(R1)(R1)(R1)(R1) to L_{A'}280-(R468)(R468)(R468 )(R468), have the structure | 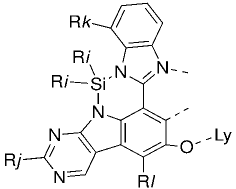 |
| L_{A'}281-(R*i*)(R*j*)(R*k*)(R*l*)*,* wherein L_{A'}281-(R1)(R1)(R1)(R1) to L_{A'}281-(R468)(R468)(R468 )(R468), have the structure | 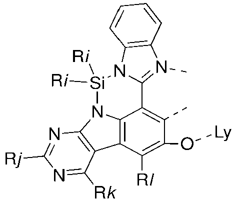 | L_{A'}282-(R*i*)(R*j*)(R*k*)(R*l*)*,* wherein L_{A'}282-(R1)(R1)(R1)(R1) to L_{A'}282-(R468)(R468)(R468 )(R468), have the structure | 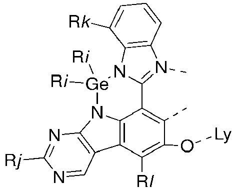 |
| L_{A'}283-(R*i*)(R*j*)(R*k*)(R*l*)*,* wherein L_{A'}283-(R1)(R1)(R1)(R1) to L_{A'}283-(R468)(R468)(R468 )(R468), have the structure | 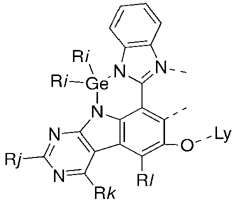 | L_{A'}284-(R*i*)(R*j*)(R*k*)(R*l*)*,* wherein L_{A'}284-(R1)(R1)(R1)(R1) to L_{A'}284-(R468)(R468)(R468 )(R468), have the structure | 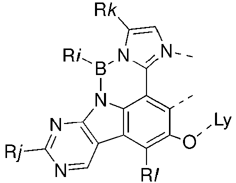 |
| L_{A'}285-(R*i*)(R*j*)(R*k*)(R*l*)*,* wherein L_{A'}285-(R1)(R1)(R1)(R1) to L_{A'}285-(R468)(R468)(R468 )(R468), have the structure | 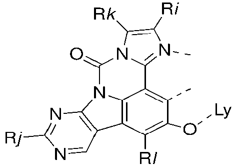 | L_{A'}286-(R*i*)(R*j*)(R*k*)(R*l*)*,* wherein L_{A'}286-(R1)(R1)(R1)(R1) to L_{A'}286-(R468)(R468)(R468 )(R468), have the structure | 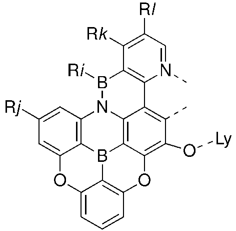 |
| L_{A'}287-(R*i*)(R*j*)(R*k*)(R*l*)*,* wherein L_{A'}287-(R1)(R1)(R1)(R1) to L_{A'}287-(R468)(R468)(R468 )(R468), have the structure | 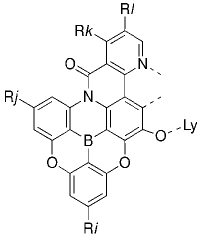 | L_{A'}288-(R*i*)(R*j*)(R*k*)(R*l*)*,* wherein L_{A'}288-(R1)(R1)(R1)(R1) to L_{A'}288-(R468)(R468)(R468 )(R468), have the structure | 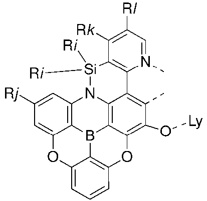 |
| L_{A'}289-(R*i*)(R*j*)(R*k*)(R*l*)*,* wherein L_{A'}289-(R1)(R1)(R1)(R1) to L_{A'}289-(R468)(R468)(R468 )(R468), have the structure | 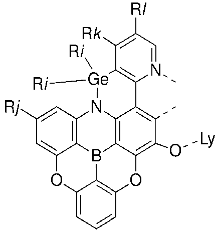 | L_{A'}290-(R*i*)(R*j*)(R*k*)(R*l*)*,* wherein L_{A'}290-(R1)(R1)(R1)(R1) to L_{A'}290-(R468)(R468)(R468 )(R468), have the structure | 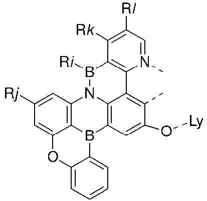 |
| L_{A'}291-(R*i*)(R*j*)(R*k*)(R*l*)*,* wherein L_{A'}291-(R1)(R1)(R1)(R1) to L_{A'}291-(R468)(R468)(R468 )(R468), have the structure | 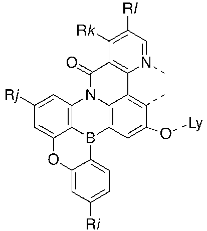 | L_{A'}292-(R*i*)(R*j*)(R*k*)(R*l*)*,* wherein L_{A'}292-(R1)(R1)(R1)(R1) to L_{A'}292-(R468)(R468)(R468 )(R468), have the structure | 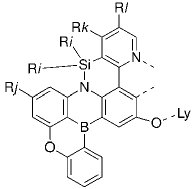 |
| L_{A'}293-(R*i*)(R*j*)(R*k*)(R*l*)*,* wherein L_{A'}293-(R1)(R1)(R1)(R1) to L_{A'}293-(R468)(R468)(R468 )(R468), have the structure | 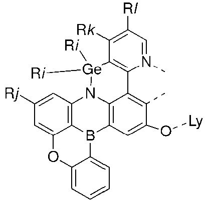 | L_{A'}294-(R*i*)(R*j*)(R*k*)(R*l*)*,* wherein L_{A'}294-(R1)(R1)(R1)(R1) to L_{A'}294-(R468)(R468)(R468 )(R468), have the structure | 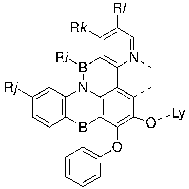 |
| L_{A'}295-(R*i*)(R*j*)(R*k*)(R*l*)*,* wherein L_{A'}295-(R1)(R1)(R1)(R1) to L_{A'}295-(R468)(R468)(R468 )(R468), have the structure | 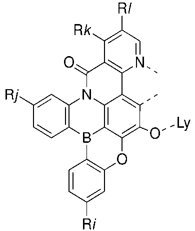 | L_{A'}296-(R*i*)(R*j*)(R*k*)(R*l*)*,* wherein L_{A'}296-(R1)(R1)(R1)(R1) to L_{A'}296-(R468)(R468)(R468 )(R468), have the structure | 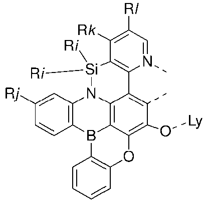 |
| L_{A'}297-(R*i*)(R*j*)(R*k*)(R*l*)*,* wherein L_{A'}297-(R1)(R1)(R1)(R1) to L_{A'}297-(R468)(R468)(R468 )(R468), have the structure | 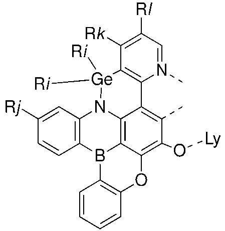 | L_{A'}298-(R*i*)(R*j*)(R*k*)(R*l*)*,* wherein L_{A'}298-(R1)(R1)(R1)(R1) to L_{A'}298-(R468)(R468)(R468 )(R468), have the structure | 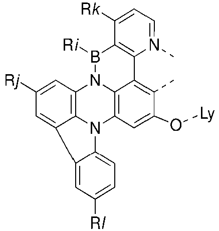 |
| L_{A'}299-(R*i*)(R*j*)(R*k*)(R*l*)*,* wherein L_{A'}299-(R1)(R1)(R1)(R1) to L_{A'}299-(R468)(R468)(R468 )(R468), have the structure | 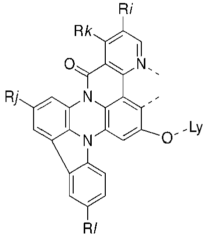 | L_{A'}300-(R*i*)(R*j*)(R*k*)(R*l*)*,* wherein L_{A'}300-(R1)(R1)(R1)(R1) to L_{A'}300-(R468)(R468)(R468 )(R468), have the structure | 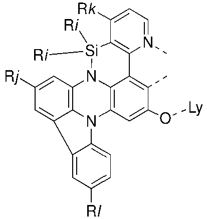 |
| L_{A'}301-(R*i*)(R*j*)(R*k*)(R*l*)*,* wherein L_{A'}301-(R1)(R1)(R1)(R1) to L_{A'}301-(R468)(R468)(R468 )(R468), have the structure | 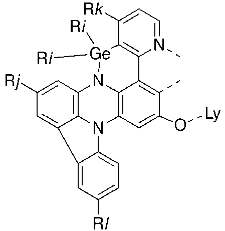 | L_{A'}302-(R*i*)(R*j*)(R*k*)(R*l*)*,* wherein L_{A'}302-(R1)(R1)(R1)(R1) to L_{A'}302-(R468)(R468)(R468 )(R468), have the structure | 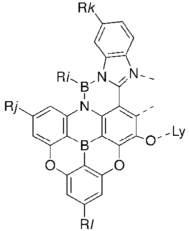 |
| L_{A'}303-(R*i*)(R*j*)(R*k*)(R*l*)*,* wherein L_{A'}303-(R1)(R1)(R1)(R1) to L_{A'}303-(R468)(R468)(R468 )(R468), have the structure | 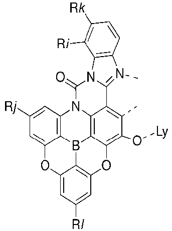 | L_{A'}304-(R*i*)(R*j*)(R*k*)(R*l*)*,* wherein L_{A'}304-(R1)(R1)(R1)(R1) to L_{A'}304-(R468)(R468)(R468 )(R468), have the structure | 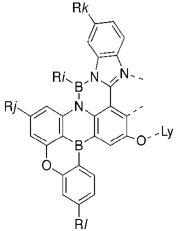 |
| L_{A'}305-(R*i*)(R*j*)(R*k*)(R*l*)*,* wherein L_{A'}305-(R1)(R1)(R1)(R1) to L_{A'}305-(R468)(R468)(R468 )(R468), have the structure | 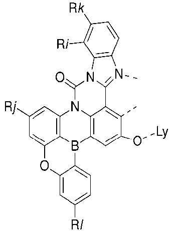 | L_{A'}306-(R*i*)(R*j*)(R*k*)(R*l*)*,* wherein L_{A}'306-(R1)(R1)(R1)(R1) to L_{A'}306-(R468)(R468)(R468 )(R468), have the structure | 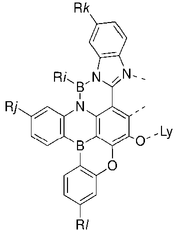 |
| L_{A'}307-(R*i*)(R*j*)(R*k*)(R*l*)*,* wherein L_{A'}307-(R1)(R1)(R1)(R1) to L_{A'}307-(R468)(R468)(R468 )(R468), have the structure | 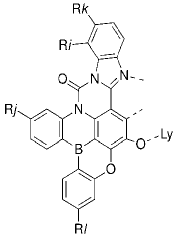 | L_{A'}308-(R*i*)(R*j*)(R*k*)(R*l*)*,* wherein L_{A'}308-(R1)(R1)(R1)(R1) to L_{A'}308-(R468)(R468)(R468 )(R468), have the structure | 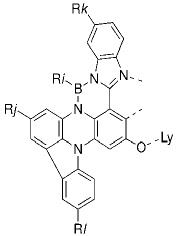 |
| L_{A'}309-(R*i*)(R*j*)(R*k*)(R*l*)*,* wherein L_{A'}309-(R1)(R1)(R1)(R1) to L_{A'}309-(R468)(R468)(R468 )(R468), have the structure | 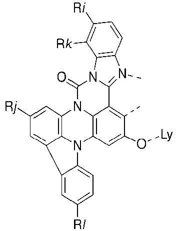 | L_{A'}310-(R*i*)(R*j*)(R*k*)(R*l*)*,* wherein L_{A'}310-(R1)(R1)(R1)(R1) to L_{A'}310-(R468)(R468)(R468 )(R468), have the structure | 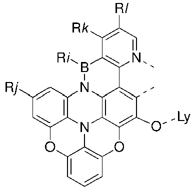 |
| L_{A'}311-(R*i*)(R*j)*(R*k)*(R*l),* wherein L_{A'}311-(R1)(R1)(R1)(R1) to L_{A'}311-(R468)(R468)(R468 )(R468), have the structure | 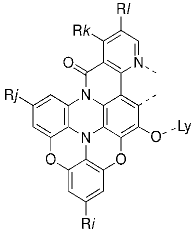 | L_{A'}312-(R*i*)(R*j*)(R*k*)(R*l*), wherein L_{A'}312-(R1)(R1)(R1)(R1) to L_{A'}312-(R468)(R468)(R468 )(R468), have the structure | 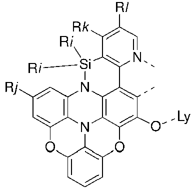 |
| L_{A'}313-(R*i*)(R*j*)(R*k*)(R*l),* wherein L_{A'}313-(R1)(R1)(R1)(R1) to L_{A'}313-(R468)(R468)(R468 )(R468), have the structure | 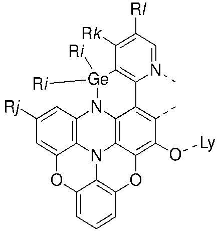 | L_{A'}314-(R*i*)(R*j*)(R*k*)(R*l*), wherein L_{A}'314-(R1)(R1)(R1)(R1) to L_{A'}314-(R468)(R468)(R468 )(R468), have the structure | 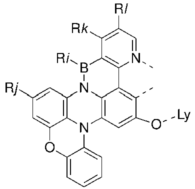 |
| L_{A'}315-(R*i*)(*Rj*)(*Rk*)(*Rl*), wherein L_{A'}315-(R1)(R1)(R1)(R1) to L_{A'}315-(R468)(R468)(R468 )(R468), have the structure | 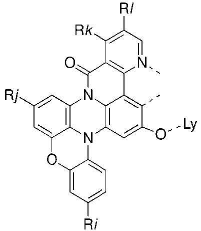 | L_{A'}316-(R*i*)(R*j*)(R*k*)(R*l*), wherein L_{A}'316-(R1)(R1)(R1)(R1) to L_{A'}316-(R468)(R468)(R468 )(R468), have the structure | 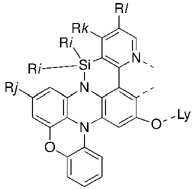 |
| L_{A'}317-(R*i*)(R*j*)(R*k*)(R*l*), wherein L_{A'}317-(R1)(R1)(R1)(R1) to L_{A'}317-(R468)(R468)(R468 )(R468), have the structure | 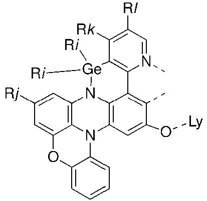 | L_{A'}318-(R*i)*(R*j*)(R*k*)(R*l*), wherein L_{A'}318-(R1)(R1)(R1)(R1) to L_{A'}318-(R468)(R468)(R468 )(R468), have the structure | 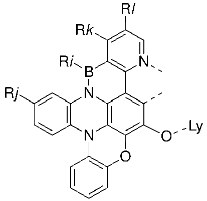 |
| L_{A'}319-(R*i*)(R*j)*(R*k*)(R*l*), wherein L_{A'}319-(R1)(R1)(R1)(R1) to L_{A'}319-(R468)(R468)(R468 )(R468), have the structure | 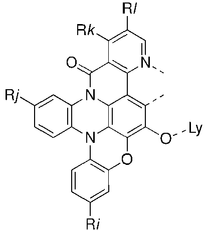 | L_{A'}320-(R*i*)(R*j*)(R*k*)(R*l*), wherein L_{A'}320-(R1)(R1)(R1)(R1) to L_{A'}320-(R468)(R468)(R468 )(R468), have the structure | 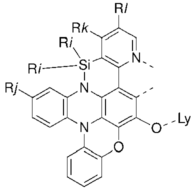 |
| L_{A'}321-(R*i*)(R*j*)(R*k*)(R*l*), wherein L_{A'}321-(R1)(R1)(R1)(R1) to L_{A'}321-(R468)(R468)(R468 )(R468), have the structure | 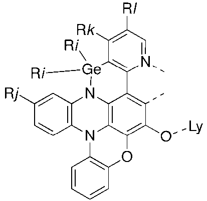 | L_{A'}322-(R*i*)(R*j*)(R*k*)(R*l*), wherein L_{A'}322-(R1)(R1)(R1)(R1) to L_{A'}322-(R468)(R468)(R468 )(R468), have the structure | 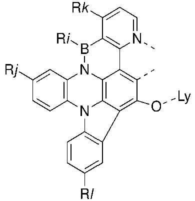 |
| L_{A'}323-(R*i*)(R*j*)(R*k*)(R*l*), wherein L_{A'}323-(R1)(R1)(R1)(R1) to L_{A'}323-(R468)(R468)(R468 )(R468), have the structure | 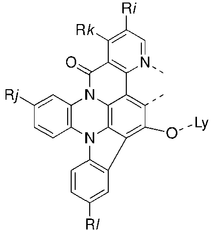 | L_{A'}324-(R*i*)(R*j*)(R*k*)(R*l*), wherein L_{A'}324-(R1)(R1)(R1)(R1) to L_{A'}324-(R468)(R468)(R468 )(R468), have the structure | 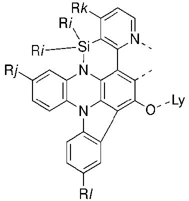 |
| L_{A'}325-(R*i*)(R*j*)(R*k*)(R*l*), wherein L_{A'}325-(R1)(R1)(R1)(R1) to L_{A'}325-(R468)(R468)(R468 )(R468), have the structure | 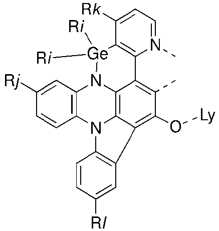 | L_{A'}326-(R*i*)(R*j*)(*Rk*)(*Rl*), wherein L_{A}'326-(R1)(R1)(R1)(R1) to L_{A'}326-(R468)(R468)(R468 )(R468), have the structure | 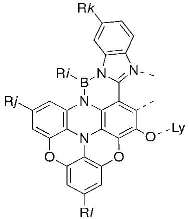 |
| L_{A'}327-(R*i*)(R*j*)(R*k*)(R*l*), wherein L_{A'}327-(R1)(R1)(R1)(R1) to L_{A'}327-(R468)(R468)(R468 )(R468), have the structure | 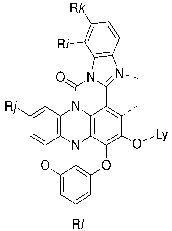 | L_{A'}328-(R*i*)(R*j*)(R*k*)(R*l*), wherein L_{A'}328-(R1)(R1)(R1)(R1) to L_{A'}328-(R468)(R468)(R468 )(R468), have the structure | 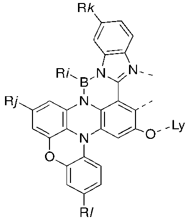 |
| L_{A'}329-(R*i*)(R*j*)(R*k*)(R*l*), wherein L_{A'}329-(R1)(R1)(R1)(R1) to L_{A'}329-(R468)(R468)(R468 )(R468), have the structure | 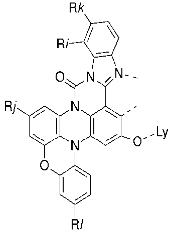 | L_{A'}330-(R*i*)(R*j*)(R*k*)(R*l*), wherein L_{A'}330-(R1)(R1)(R1)(R1) to L_{A'}330-(R468)(R468)(R468 )(R468), have the structure | 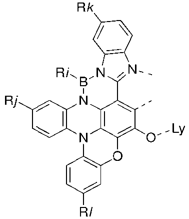 |
| L_{A'}331-(R*i*)(R*j*)(R*k*)(R*l*), wherein L_{A'}331-(R1)(R1)(R1)(R1) to L_{A'}331-(R468)(R468)(R468 )(R468), have the structure | 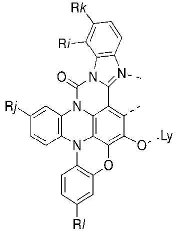 | L_{A'}332-(R*i*)(R*j*)(R*k*)(R*l*), wherein L_{A'}332-(R1)(R1)(R1)(R1) to L_{A'}332-(R468)(R468)(R468 )(R468), have the structure | 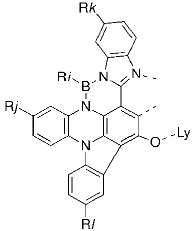 |
| L_{A'}333-(R*i*)(R*j*)(R*k*)(R*l*), wherein L_{A'}333-(R1)(R1)(R1)(R1) to L_{A'}333-(R468)(R468)(R468 )(R468), have the structure | 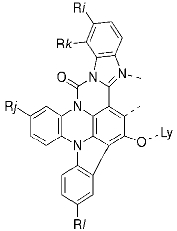 | L_{A'}334-(R*i*)(R*j*)(R*k*)(R*l*), wherein L_{A'}334-(R1)(R1)(R1)(R1) to L_{A'}334-(R468)(R468)(R468 )(R468), have the structure | 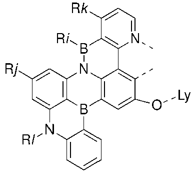 |
| L_{A'}335-(R*i*)(R*j*)(R*k*)(R*l*), wherein L_{A'}335-(R1)(R1)(R1)(R1) to L_{A'}335-(R468)(R468)(R468 )(R468), have the structure | 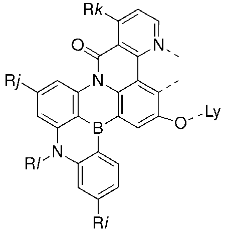 | L_{A'}336-(R*i*)(R*j*)(R*k*)(R*l*), wherein L_{A'}336-(R1)(R1)(R1)(R1) to L_{A'}336-(R468)(R468)(R468 )(R468), have the structure | 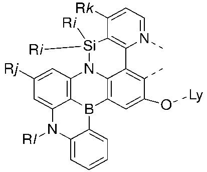 |
| L_{A'}337-(R*i*)(R*j)*(R*k*)(R*l*), wherein L_{A'}337-(R1)(R1)(R1)(R1) to L_{A'}337-(R468)(R468)(R468 )(R468), have the structure | 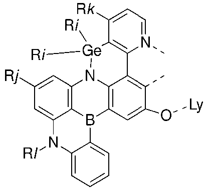 | L_{A'}338-(R*i*)(R*j*)(R*k*)(R*l*), wherein L_{A'}338-(R1)(R1)(R1)(R1) to L_{A'}338-(R468)(R468)(R468 )(R468), have the structure | 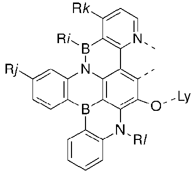 |
| L_{A'}339-(R*i*)(P*j*)(R*k*)(R*l*), wherein L_{A'}339-(R1)(R1)(R1)(R1) to L_{A'}339-(R468)(R468)(R468 )(R468), have the structure | 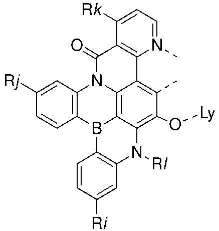 | L_{A'} 340-(R*i*)(R*j*)(R*k*)(R*l*), wherein L_{A'}340-(R1)(R1)(R1)(R1) to L_{A'}340-(R468)(R468)(R468 )(R468), have the structure | 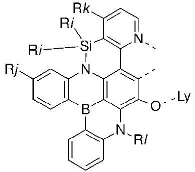 |
| L_{A'}341-(R*i*)(R*j*)(R*k*)(R*l*), wherein L_{A'}341-(R1)(R1)(R1)(R1) to L_{A'}341-(R468)(R468)(R468 )(R468), have the structure | 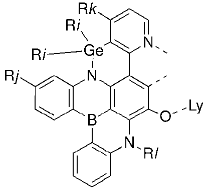 | L_{A'}342-(R*i*)(R*j*)(R*k*)(R*l*), wherein L_{A'}342-(R1)(R1)(R1)(R1) to L_{A'}342-(R468)(R468)(R468 )(R468), have the structure | 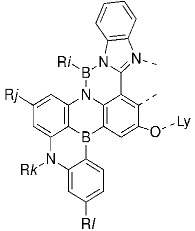 |
| L_{A'}343-(R*i*)(R*j*)(R*k*)(R*l*), wherein L_{A'}343-(R1)(R1)(R1)(R1) to L_{A'}343-(R468)(R468)(R468 )(R468), have the structure | 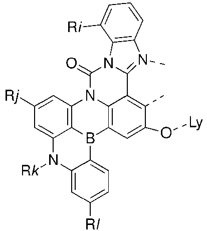 | L_{A'} 344-(R*i*)(R*j*)(R*k*)(R*l*), wherein L_{A'}344-(R1)(R1)(R1)(R1) to L_{A'}344-(R468)(R468)(R468 )(R468), have the structure | 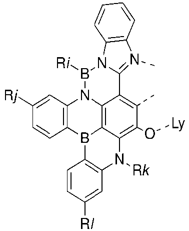 |
| L_{A'}345-(R*i*)(R*j*)(R*k*)(R*l*), wherein L_{A'}345-(R1)(R1)(R1)(R1) to L_{A'}345-(R468)(R468)(R468 )(R468), have the structure | 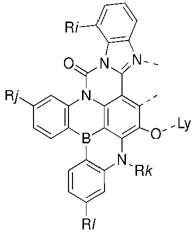 | L_{A'}-346-(R*i*)(R*j*)(R*k*)(R*l*), wherein L_{A'}346-(R1)(R1)(R1)(R1) to L_{A'}346-(R468)(R468)(R468 )(R468), have the structure | 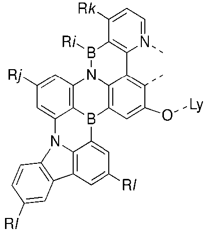 |
| L_{A'}347-(R*i*)(R*j*)(R*k*)(*Rl*), wherein L_{A'}347-(R1)(R1)(R1)(R1) to L_{A'}347-(R468)(R468)(R468 )(R468), have the structure | 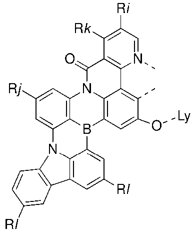 | L_{A'} 348-(R*i*)(R*j*)(R*k*)(R*l*), wherein L_{A'}348-(R1)(R1)(R1)(R1) to L_{A'}348-(R468)(R468)(R468 )(R468), have the structure | 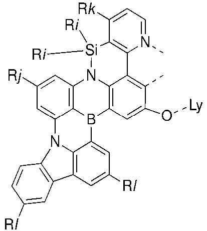 |
| L_{A'}349-(R*i*)(R*j*)(R*k*)(R*l*), wherein L_{A'}349-(R1)(R1)(R1)(R1) to L_{A'}349-(R468)(R468)(R468 )(R468), have the structure | 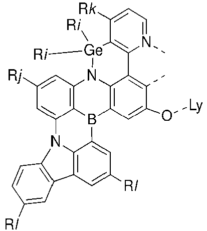 | L_{A'}350-(R*i*)(R*j*)(R*k*)(R*l*), wherein L_{A'}350-(R1)(R1)(R1)(R1) to L_{A'}350-(R468)(R468)(R468 )(R468), have the structure | 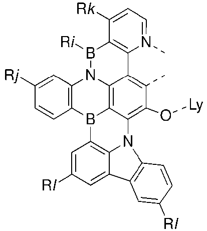 |
| L_{A'}351-(R*i*)(R*j*)(R*k*)(R*l*), wherein L_{A'}351-(R1)(R1)(R1)(R1) to L_{A'}351-(R468)(R468)(R468 )(R468), have the structure | 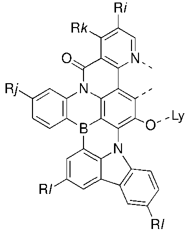 | L_{A'}352-(R*i*)(R*j*)(R*k*)(R*l*), wherein L_{A}'352-(R1)(R1)(R1)(R1) to L_{A'}352-(R468)(R468)(R468 )(R468), have the structure | 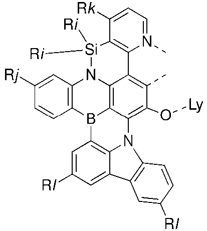 |
| L_{A'}353-(R*i*)(R*j*)(R*k*)(R*l*), wherein L_{A'}353-(R1)(R1)(R1)(R1) to L_{A'}353-(R468)(R468)(R468 )(R468), have the structure | 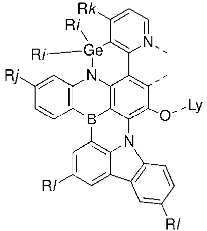 | L_{A'}354-(R*i*)(R*j*)(R*k*)(R*l*), wherein L_{A'}354-(R1)(R1)(R1)(R1) to L_{A'}354-(R468)(R468)(R468 )(R468), have the structure | 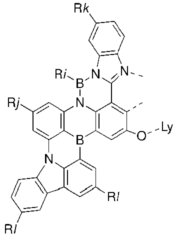 |
| L_{A'}355-(R*i*)(R*j*)(R*k*)(R*l*), wherein L_{A'}355-(R1)(R1)(R1)(R1) to L_{A'}355-(R468)(R468)(R468 )(R468), have the structure | 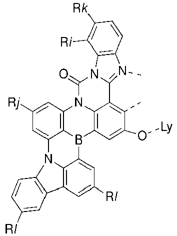 | L_{A'}356-(R*i*)(R*j*)(R*k*)(R*l*), wherein L_{A'}356-(R1)(R1)(R1)(R1) to L_{A'}356-(R468)(R468)(R468 )(R468), have the structure | 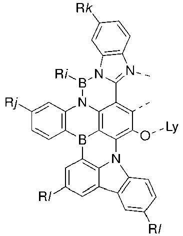 |
| L_{A'}357-(R*i*)(R*j)*(R*k*)(R*l*), wherein L_{A'}357-(R1)(R1)(R1)(R1) to L_{A'}357-(R468)(R468)(R468 )(R468), have the structure | 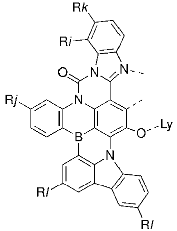 | L_{A'}358-(R*i*)(R*j*)(R*k*)(R*l*), wherein L_{A'}358-(R1)(R1)(R1)(R1) to L_{A'}358-(R468)(R468)(R468 )(R468), have the structure | 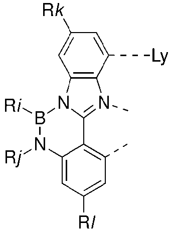 |
| L_{A'}359-(R*i*)(R*j*)(R*k*)(R*l*), wherein L_{A'}359-(R1)(R1)(R1)(R1) to L_{A'}359-(R468)(R468)(R468 )(R468), have the structure | 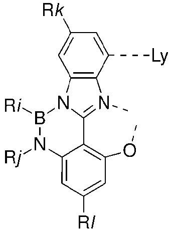 | L_{A'}360-(R*i*)(R*j*)(R*k*)(R*l*), wherein L_{A'}360-(R1)(R1)(R1)(R1) to L_{A'}360-(R468)(R468)(R468 )(R468), have the structure | 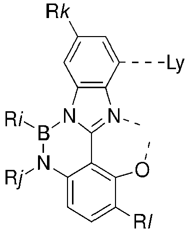 |
| L_{A'}361-(R*i*)(R*j)*(R*k*)(R*l*), wherein L_{A'}361-(R1)(R1)(R1)(R1) to L_{A'}361-(R468)(R468)(R468 )(R468), have the structure | 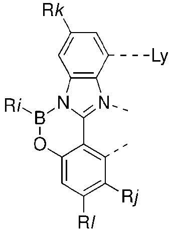 | L_{A'}362-(R*i*)(R*j*)(R*k*)(R*l*), wherein L_{A'}362-(R1)(R1)(R1)(R1) to L_{A'}362-(R468)(R468)(R468 )(R468), have the structure | 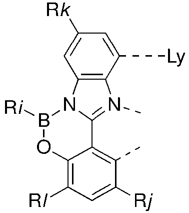 |
| L_{A'}363-(R*i*)(R*j)*(R*k*)(R*l*), wherein L_{A'}363-(R1)(R1)(R1)(R1) to L_{A'}363-(R468)(R468)(R468 )(R468), have the structure | 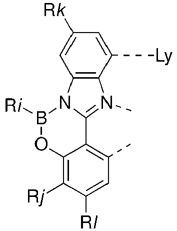 | L_{A'}364-(R*i*)(R*j*)(R*k*)(R*l*), wherein L_{A'}364-(R1)(R1)(R1)(R1) to L_{A'}364-(R468)(R468)(R468 )(R468), have the structure | 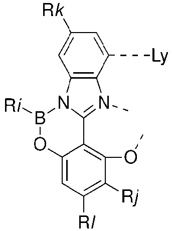 |
| L_{A'}365-(R*i*)(R*j)*(R*k*)(R*l*), wherein L_{A'}365-(R1)(R1)(R1)(R1) to L_{A'}365-(R468)(R468)(R468 )(R468), have the structure | 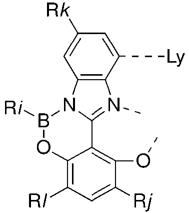 | L_{A'}366-(R*i*)(R*j*)(R*k*)(R*l*), wherein L_{A'}366-(R1)(R1)(R1)(R1) to L_{A'}366-(R468)(R468)(R468 )(R468), have the structure | 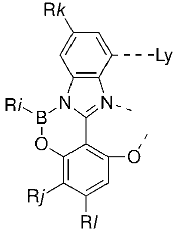 |
| L_{A'}367-(R*i*)(R*j)*(R*k*)(R*l*), wherein L_{A'}367-(R1)(R1)(R1)(R1) to L_{A'}367 (R468)(R468)(R468 )(R468), have the structure | 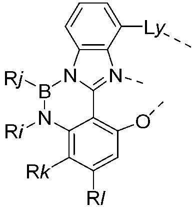 | L_{A'}368-(R*i*)(R*j*)(R*k*)(R*l*), wherein L_{A'}368-(R1)(R1)(R1)(R1) to L_{A'}368 (R468)(R468)(R468 )(R468), have the structure | 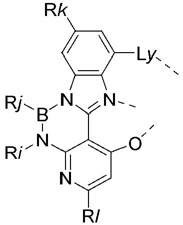 |
| L_{A'}369-(R*i*)(R*j)*(R*k*)(R*l*), wherein L_{A'}369-(R1)(R1)(R1)(R1) to L_{A'}369 (R468)(R468)(R468 )(R468), have the structure | 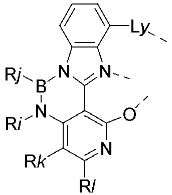 | L_{A'}370-(R*i*)(R*j*)(R*k*)(R*l*), wherein L_{A'}370-(R1)(R1)(R1)(R1) to L_{A'}370 (R468)(R468)(R468 )(R468), have the structure | 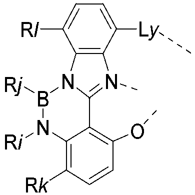 |
| L_{A'}371-(R*i*)(R*j)*(R*k*)(R*l*), wherein L_{A'}371-(R1)(R1)(R1)(R1) to L_{A'}371 (R468)(R468)(R468 )(R468), have the structure | 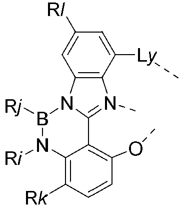 | L_{A'}372-(R*i*)(R*j*)(R*k*)(R*l*), wherein L_{A'}372-(R1)(R1)(R1)(R1) to L_{A'}372 (R468)(R468)(R468 )(R468), have the structure | 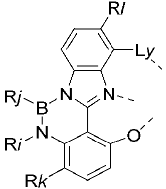 |
| L_{A'}373-(R*j*)(R*k*)(R*l*)(R*m*), wherein L_{A'}373-(R1)(R1)(R1)(R1) to L_{A'}373 (R468)(R468)(R468 )(R468), have the structure | 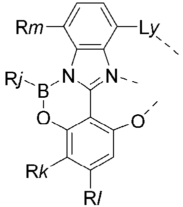 | L_{A'}374-(R*j*)(R*k*)(R*l*)(R*m*), wherein L_{A'}374-(R1)(R1)(R1)(R1) to L_{A'}374 (R468)(R468)(R468 )(R468), have the structure | 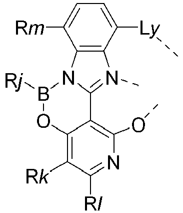 |
| L_{A'}375-(R*j*)(R*k*)(R*l*)(R*m*), wherein L_{A'}375-(R1)(R1)(R1)(R1) to L_{A'} 375 (R468)(R468)(R468 )(R468), have the structure | 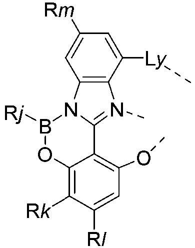 | L_{A'}376-(R*i*)(R*j*)(R*k*)(R*l*), wherein L_{A'}376-(R1)(R1)(R1)(R1) to L_{A'}376 (R468)(R468)(R468 )(R468), have the structure | 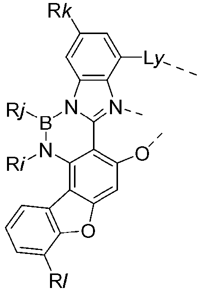 |
| L_{A'}377-(R*i*)(R*j*)(R*k*)(R*n*), wherein L_{A'}377-(R1)(R1)(R1)(R1) to L_{A'}377 (R468)(R468)(R468 )(R468), have the structure | 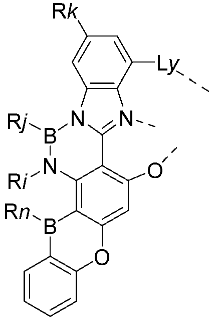 | L_{A'}378-(R*j*)(R*k*)(R*l*)(R*m*), wherein L_{A'}378-(R1)(R1)(R1)(R1) to L_{A'}378 (R468)(R468)(R468 )(R468), have the structure | 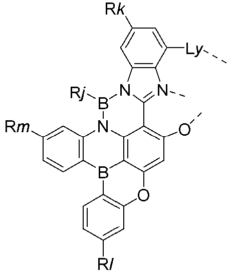 |
| L_{A'}379-(R*j*)(R*k*)(R*l*)(R*m*), wherein L_{A'}379-(R1)(R1)(R1)(R1) to L_{A'}379 (R468)(R468)(R468 )(R468), have the structure | 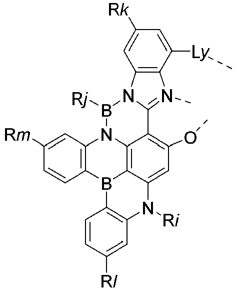 | L_{A'}380-(R*j*)(R*k*)(R*l*)(R*m*), wherein L_{A'}13804-(R1)(R1)(R1)(R1) to L_{A'}380 (R468)(R468)(R468 )(R468), have the structure | 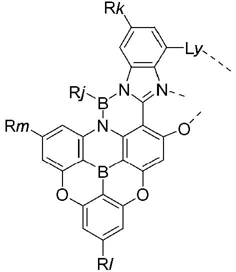 |
| L_{A'}381-(R*j*)(R*k*)(R*l*)(R*m*), wherein L_{A'}381-(R1)(R1)(R1)(R1) to L_{A'} 381 (R468)(R468)(R468 )(R468), have the structure | 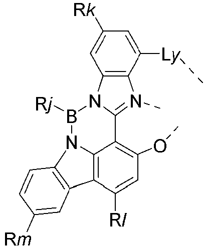 | L_{A'}382-(R*j*)(R*k*)(R*l*)(R*m*), wherein L_{A'}382-(R1)(R1)(R1)(R1) to L_{A'}382 (R468)(R468)(R468 )(R468), have the structure | 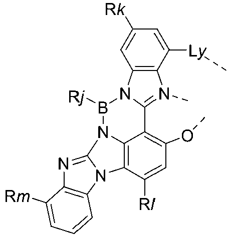 |
| L_{A'}383-(R*i*)(R*k*)(R*l*)(R*m*), wherein L_{A'}383-(R1)(R1)(R1)(R1) to L_{A'}383 (R468)(R468)(R468 )(R468), have the structure | 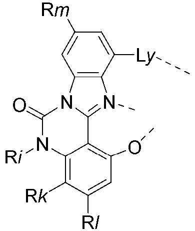 | L_{A'}384-(R*j*)(R*k*)(R*l*)(R*m*), wherein L_{A'}384-(R1)(R1)(R1)(R1) to L_{A'}384 (R468)(R468)(R468 )(R468), have the structure | 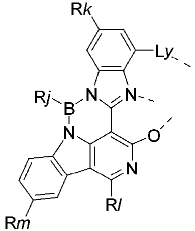 |
| L_{A}:385-(R*j*)(R*k*)(R*l*)(R*m*), wherein L_{A'}385-(R1)(R1)(R1)(R1) to L_{A'}385 (R468)(R468)(R468 )(R468), have the structure | 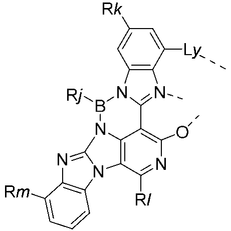 | L_{A'}386-(R*j*)(R*k*)(R*l*)(R*m*), wherein L_{A'}386-(R1)(R1)(R1)(R1) to L_{A'} 386 (R468)(R468)(R468 )(R468), have the structure | 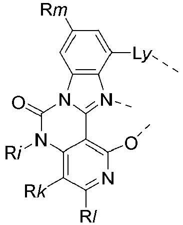 |
| L_{A'}387-(R*k*)(R*l*)(R*m*)(R*o*), wherein L_{A'}387-(R1)(R1)(R1)(R1) to L_{A'}387 (R468)(R468)(R468)(R468), have the structure | 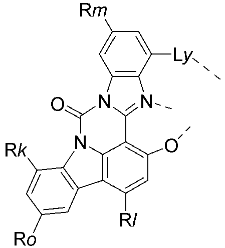 | L_{A'}388-(R*k*)(R*l*)(R*m*)(R*o*)*,* wherein L_{A'}388-(R1)(R1)(R1)(R1) to L_{A'}388 (R468)(R468)(R468)(R468), have the structure | 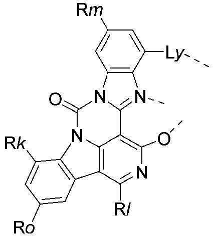 |
| L_{A'}389-(R*k*)(R*l*)(R*m*)(R*o*), wherein L_{A'}389-(R1)(R1)(R1)(R1) to L_{A'} 389 (R468)(R468)(R468 )(R468), have the structure | 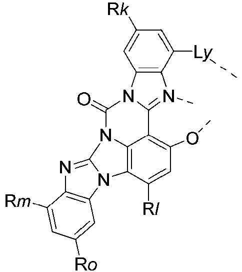 | L_{A'}390-(R*k*)(R*l*)(R*m*)(R*o*), wherein L_{A'}390-(R1)(R1)(R1)(R1) to L_{A'}390 (R468)(R468)(R468 )(R468), have the structure | 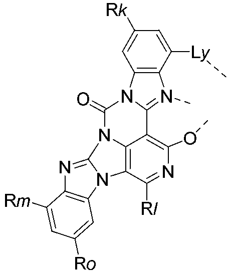 |
| L_{A'}391-(R*j*)(R*k*)(R*l*), wherein L_{A'}391-(R1)(R1)(R1) to L_{A'}391 (R468)(R468)(R468 ), have the structure | 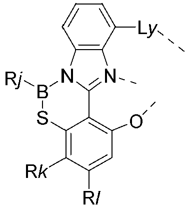 | L_{A'}392-(R*j*)(R*k*)(R*n*), wherein L_{A'}392-(R1)(R1)(R1) to L_{A'}392 (R468)(R468)(R468 ), have the structure | 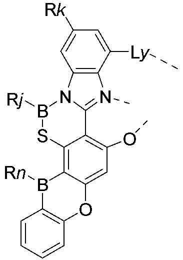 |
| L_{A'} 393-(R*j*)(R*k*)(R*l*), wherein L_{A'}393-(R1)(R1)(R1) to L_{A'}393 (R468)(R468)(R468 ), have the structure | 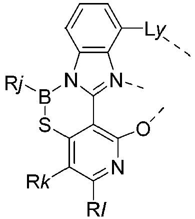 | L_{A'}394-(R*k*)(R*l*)(R*m*)(R*o*), wherein L_{A'}394-(R1)(R1)(R1)(R1) to L_{A'}394 (R468)(R468)(R468 )(R468), have the structure | 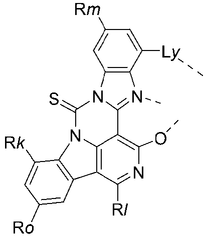 |
| L_{A'}395-(R*i*)(R*k*)(R*l*)(R*o*), wherein L_{A'}395-(R1)(R1)(R1)(R1) to L_{A'} 395 (R468)(R468)(R468 )(R468), have the structure | 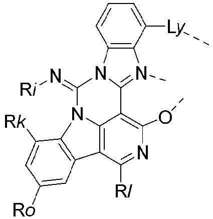 | L_{A'}396-(R*i*)(R*j*)(R*k*)(R*l*), wherein L_{A'}396-(R1)(R1)(R1)(R1) to L_{A'}396 (R468)(R468)(R468 )(R468), have the structure | 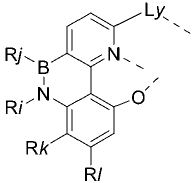 |
| L_{A'}397-(R*i*)(R*j*)(R*k*)(R*l*), wherein L_{A'}397-(R1)(R1)(R1)(R1) to L_{A'}397 (R468)(R468)(R468)(R468), have the structure | 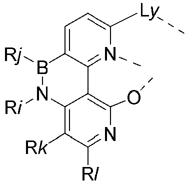 | L_{A'}398-(R*i*)(R*j*)(R*k*)(R*l*), wherein L_{A'}398-(R1)(R1)(R1)(R1) to L_{A'}398 (R468)(R468)(R468)(R468), have the structure | 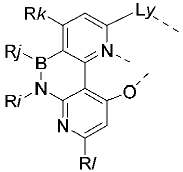 |
| L_{A'}399-(R*i*)(R*j*)(R*k*)(R*l*), wherein L_{A'}399-(R1)(R1)(R1)(R1) to L_{A'}399 (R468)(R468)(R468 )(R468), have the structure | 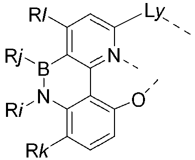 | L_{A'400}-(R*i*)(R*j*)(R*k*)(R*l*), wherein L_{A'}400-(R1)(R1)(R1)(R1) to L_{A'}400 (R468)(R468)(R468 )(R468), have the structure | 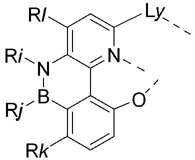 |
| L_{A'}401-(R*j*)(R*k*)(R*l*)(R*m*), wherein L_{A'}401-(R1)(R1)(R1)(R1) to L_{A'}401 (R468)(R468)(R468 )(R468), have the structure | 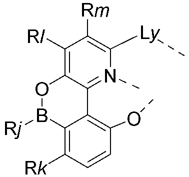 | L_{A'}402-(*R*j)(R*k*)(R*l*)(R*m*), wherein L_{A'}402-(R1)(R1)(R1)(R1) to L_{A'}402 (R468)(R468)(R468 )(R468), have the structure | 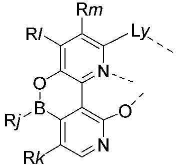 |
| L_{A'}403-(R*j*)(R*k*)(R*l*)(R*m*), wherein L_{A'}403-(R1)(R1)(R1)(R1) to L_{A'}403 (R468)(R468)(R468 )(R468), have the structure | 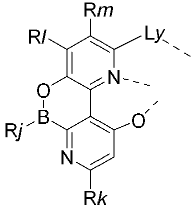 | L_{A'}404-(R*j*)(R*k*)(R*l*)(R*m*), wherein L_{A'}404-(R1)(R1)(R1)(R1) to L_{A'}404 (R468)(R468)(R468 )(R468), have the structure | 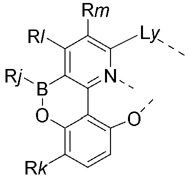 |
| L_{A'}405-(R*j*)(R*k*)(R*l*)(R*m*), wherein L_{A'}405-(R1)(R1)(R1)(R1) to L_{A'}405 (R468)(R468)(R468 )(R468), have the structure | 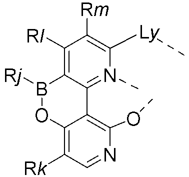 | L_{A'}406-(R*j*)(R*k*)(R*l*)(R*m*), wherein L_{A'}406-(R1)(R1)(R1)(R1) to L_{A'}406 (R468)(R468)(R468 )(R468), have the structure | 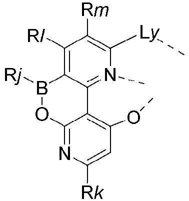 |
| L_{A'}407-(R*j*)(R*l*)(R*m*)(R*n*), wherein L_{A'}407-(R1)(R1)(R1)(R1) to L_{A'}407 (R468)(R468)(R468 )(R468), have the structure | 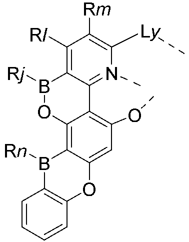 | | |

wherein L*_{y}* is selected from L_{y}Z1-(R*s*)(R*t*)(R*u*), L_{y}Z2-(R*p*)(R*q*)(R*r*)(R*s*), L_{y}Z3-(R*q*)(R*r*)(R*s*), L_{y}Z4-(R*p*)(R*q*)(R*r*)(R*t*), L_{y}Z5-(R*p*)(R*q*)(R*r*)(R*u*), L_{y}Z6-(R*q*)(R*r*)(R*u*), L_{y}Z7-(R*p*)(R*q*)(R*s*)(R*v*), L_{y}Z8-(R*q*)(R*s*)(R*v*), L_{y}Z9-(R*s*)(R*v*)(R*t*), L_{y}Z10-(R*p*)(R*q*)(R*s*)(R*v*)(R*t*), L_{y}Z11-(R*p*)(R*s*)(R*v*), L_{y}Z12-(R*p*)(R*s*)(R*v*)(R*t*), wherein Z1 is an integer from 1 to 95, Z2 is an integer from 96-98, 102-111, 116, 120 and 121; Z3 is an integer from 99, 113, 117-119, and 122; Z4 is 100, 101 and 115; Z5 is 112; Z6 is 114; Z7 is 123 and 124; Z8 is 125; Z9 is 126; Z10 is 127; Z11 is 128 and 129; Z12 is 130; each p, q, r, s, t, u, and v is independently an integer from 1 to 468, each of R*p*, R*q*, R*r,* R*s*, R*t*, R*u* and R*v* is independently selected from R1 to R468, and each of the L*_{y}* structures are defined in the table below (LIST 15):

| **Compound** | **Structure of Ly** | **Compound** | **Structure of Ly** |
|---|---|---|---|
| L_{y}1-(R*s*)(R*t*)(R*u*), wherein L_{y}1-(R1)(R1)(R1) to L_{y}1-(R468)(R468)(R468), having the structure | 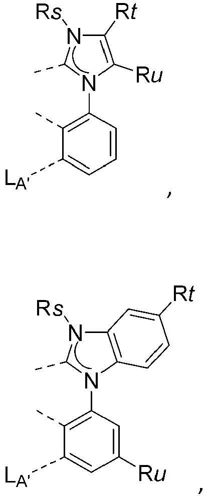 | L_{y}2-(R*s*)(R*t*)(R*u*), wherein L_{y}2-(R1)(R1)(R1) to L_{y}2-(R468)(R468)(R468), having the structure | 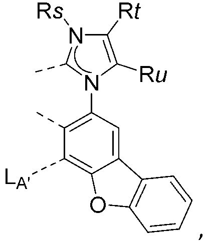 |
| L_{y}3-(R*s*)(R*t*)(R*u*), wherein L_{y}3-(R1)(R1)(R1) to L_{y}3-(R468)(R468)(R468), having the structure | 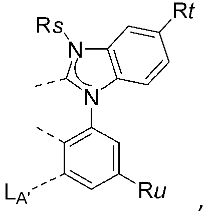 | L_{y}4-(R*s*)(R*t*)(R*u*), wherein L_{y}4-(R1)(R1)(R1) to L_{y}4-(R468)(R468)(R468), having the structure | 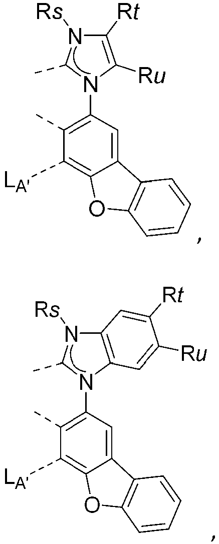 |
| L_{y5}-(R*s*)(R*t*)(R*u*), wherein L_{y}5-(R1)(R1)(R1) to L_{y}5-(R468)(R468)(R468), having the structure | 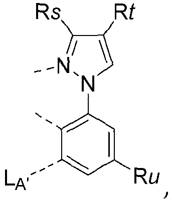 | L_{y}6-(Ris)(R*t*)(R*u*), wherein L_{y}6-(R1)(R1)(R1) to L_{y}6-(R468)(R468)(R468), having the structure | 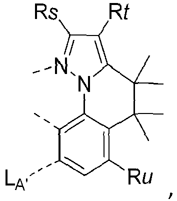 |
| L_{y}7-(R*s*)(R*t*)(R*u*), wherein L_{y}7-(R1)(R1)(R1) to L_{y}7-(R468)(R468)(R468), having the structure | 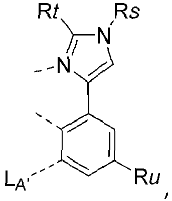 | L_{y}8-(R*s*)(R*t*)(R*u*), wherein L_{y}8-(R1)(R1)(R1) to L_{y}8-(R468)(R468)(R468), having the structure | 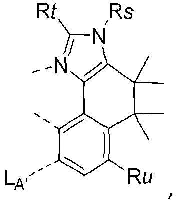 |
| L_{y}9-(R*s*)(R*t*)(R*u*), wherein L_{y}9-(R1)(R1)(R1) to L_{y}9-(R468)(R468)(R468), having the structure | 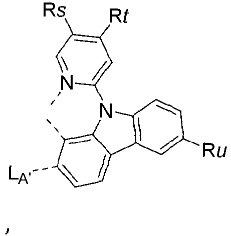 | L_{y}10-(R*s*)(R*t*)(R*u*), wherein L_{y}10-(R1)(R1)(R1) to L_{y}10-(R468)(R468)(R468), having the structure | 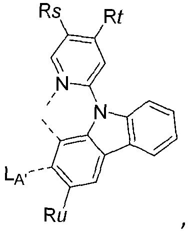 |
| L_{y}11-(R*s*)(R*t*)(R*u*), wherein L_{y}11-(R1)(R1)(R1) to L_{y}11-(R468)(R468)(R468), having the structure | 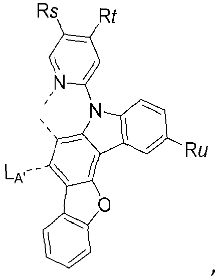 | L_{y}12-(R*s*)(R*t*)(R*u*), wherein L_{y}12-(R1)(R1)(R1) to L_{y}12-(R468)(R468)(R468), having the structure | 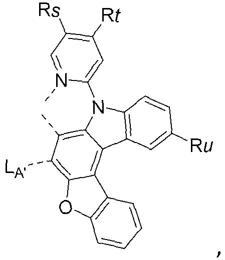 |
| L_{y}13-(R*s*)(R*t*)(R*u*), wherein L_{y}13-(R1)( R1)( R1) to L_{y}13-(R468)( R468)( R468 having the structure | 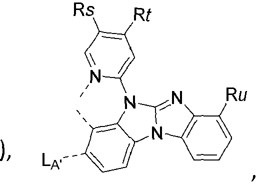 | L_{y}14-(R*s*)(R*t*)(R*u*), wherein L_{y}14-(R1)(R1)(R1) to L_{y}14-(R468)(R468)(R468), having the structure | 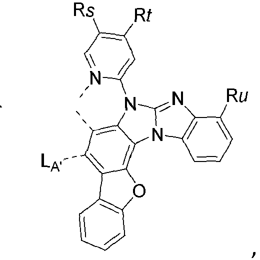 |
| L_{y}15-(R*s*)(R*t*)(R*u*), wherein L_{y}15-(R1)(R1)(R1) to L_{y}15-(R468)(R468)(R468), having the structure | 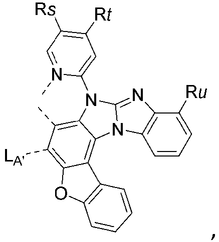 | L_{y}16-(R*s*)(R*t*)(R*u*), wherein L_{y}16-(R1)(R1)(R1) to L_{y}16-(R468)(R468)(R468), having the structure | 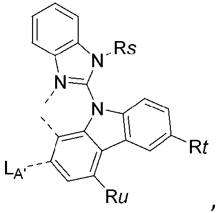 |
| L_{y}17-(R*s*)(R*t*)(R*u*), wherein L_{y}17-(R1)(R1)(R1) to L_{y}17-(R468)(R468)(R468), having the structure | 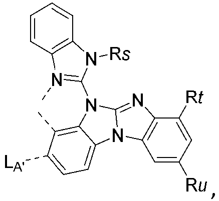 | L_{y}18-(R*s*)(R*t*)(R*u*), wherein L_{y}18-(R1)(R1)(R1) to L_{y}18-(R468)(R468)(R468), having the structure | 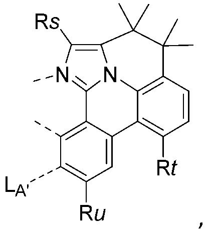 |
| L_{y}19-(R*s*)(R*t*)(R*u*), wherein L_{y}19-(R1)(R1)(R1) to L_{y}19-(R468)(R468)(R468), having the structure | 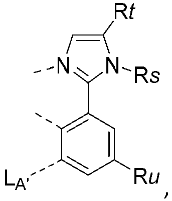 | L_{y}20-(R*s*)(R*t*)(R*u*), wherein L_{y}20-(R1)(R1)(R1) to L_{y}20-(R468)(R468)(R468), having the structure | 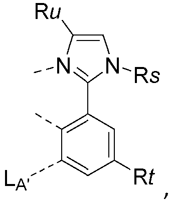 |
| L_{y}21-(R*s*)(R*t*)(R*u*), wherein L_{y}21-(R1)(R1)(R1) to L_{y}21-(R468)(R468)(R468), having the structure | 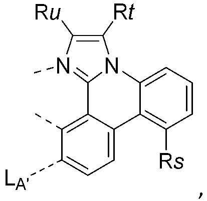 | L_{y}22*-*(R*s*)(R*t*)(R*u*), wherein L_{y}22-(R1)(R1)(R1) to L_{y}22-(R468)(R468)(R468), having the structure | 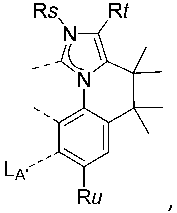 |
| L_{y}23-(R*s*)(R*t*)(R*u*), wherein L_{y}23-(R1)(R1)(R1) to L_{y}23-(R468)(R468)(R468), having the structure | 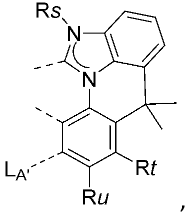 | L_{y}24-(R*s*)(R*t*)(R*u*), wherein L_{y}24-(R1)(R1)(R1) to L_{y}24-(R468)(R468)(R468), having the structure | 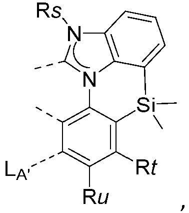 |
| L_{y}25-(R*s*)(R*t*)(R*u*), wherein L_{y}25-(R1)(R1)(R1) to L_{y}25-(R468)(R468)(R468), having the structure | 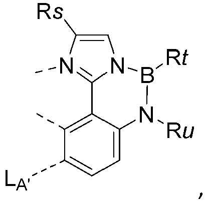 | L_{y}26-(R*s*)(R*t*)(R*u*), wherein L_{y}26-(R1)(R1)(R1) to L_{y}26-(R468)(R468)(R468), having the structure | 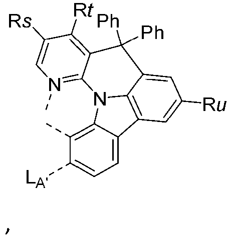 |
| L_{y}27-(R*s*)(R*t*)(R*u*), wherein L_{y}27-(R1)(R1)(R1) to L_{y}27-(R468)(R468)(R468), having the structure | 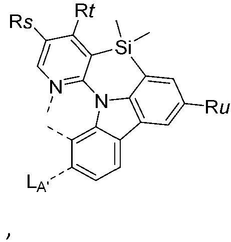 | L_{y}28-(R*s*)(R*t*)(R*u*), wherein L_{y}28-(R1)(R1)(R1) to L_{y}28-(R468)(R468)(R468), having the structure | 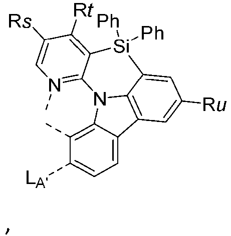 |
| L_{y}29-(R*s*)(R*t*)(R*u*), wherein L_{y}29-(R1)(R1)(R1) to L_{y}29-(R468)(R468)(R468), having the structure | 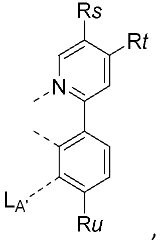 | L_{y}30-(R*s*)(R*t*)(R*u*), wherein L_{y}30-(R1)(R1)(R1) to L_{y}30-(R468)(R468)(R468), having the structure | 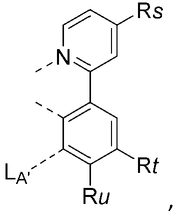 |
| L_{y}31-(R*s*)(R*t*)(R*u*), wherein L_{y}31-(R1)(R1)(R1) to L_{y}31-(R468)(R468)(R468), having the structure | 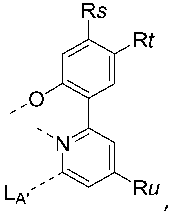 | L_{y}32-(R*s*)(R*t*)(R*u*), wherein L_{y}32-(R1)(R1)(R1) to L_{y}32-(R468)(R468)(R468), having the structure | 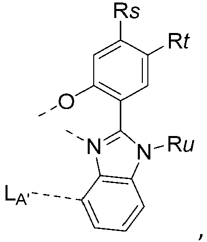 |
| L_{y}33-(R*s*)(R*t*)(R*u*), wherein L_{y}33-(R1)(R1)(R1) to L_{y}33-(R468)(R468)(R468), having the structure | 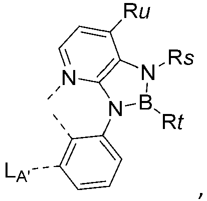 | L_{y}34-(R*s*)(R*t*)(R*u*), wherein L_{y}34-(R1)(R1)(R1) to L_{y}34-(R468)(R468)(R468), having the structure | 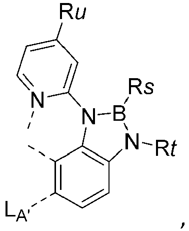 |
| L_{y}35-(R*s*)(R*t*)(R*u*), wherein L_{y}35-(R1)(R1)(R1) to L_{y}35-(R468)(R468)(R468), having the structure | 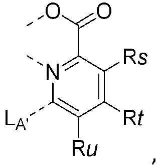 | L_{y}36-(R*s*)(R*t*)(R*u*), wherein L_{y}36-(R1)(R1)(R1) to L_{y}36-(R468)(R468)(R468), having the structure | 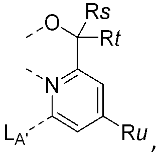 |
| L_{y}37-(R*s*)(R*t*)(R*u*), wherein L_{y}37-(R1)(R1)(R1) to L_{y}37-(R468)(R468)(R468), having the structure | 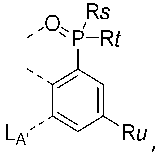 | L_{y}38-(R*s*)(R*t*)(R*u*), wherein L_{y}38-(R1)(R1)(R1) to L_{y}38-(R468)(R468)(R468), having the structure | 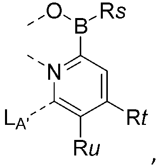 |
| L_{y}39-(R*s*)(R*t*)(R*u*), wherein L_{y}39-(R1)(R1)(R1) to L_{y}39-(R468)(R468)(R468), having the structure | 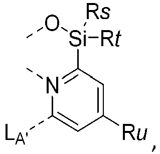 | L_{y}40-(R*s*)(R*t*)(R*u*), wherein L_{y}40-(R1)(R1)(R1) to L_{y}40-(R468)(R468)(R468), having the structure | 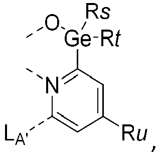 |
| L_{y}41-(R*s*)(R*t*)(*R*u), wherein L_{y}41-(R1)(R1)(R1) to L_{y}41-(R468)(R468)(R468), having the structure | 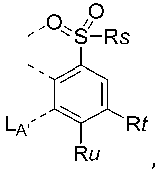 | L_{y}42-(R*s*)(R*t*)(R*u*), wherein L_{y}42-(R1)(R1)(R1) to L_{y}42-(R468)(R468)(R468), having the structure | 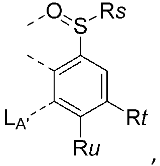 |
| L_{y}43-(R*s*)(R*t*)(R*u*), wherein L_{y}43-(R1)(R1)(R1) to L_{y}43-(R468)(R468)(R468), having the structure | 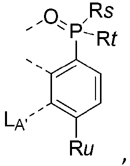 | L_{y}44-(R*s*)(R*t*)(R*u*), wherein L_{y}44-(R1)(R1)(R1) to L_{y}44-(R468)(R468)(R468), having the structure | 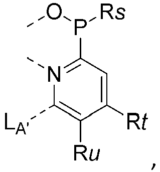 |
| L_{y}45-(R*s*)(R*t*)(R*u*), wherein L_{y}45-(R1)(R1)(R1) to L_{y}45-(R468)(R468)(R468), having the structure | 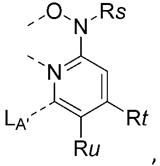 | L_{y}46-(R*s*)(R*t*)(R*u*), wherein L_{y}46-(R1)(R1)(R1) to L_{y}46-(R468)(R468)(R468), having the structure | 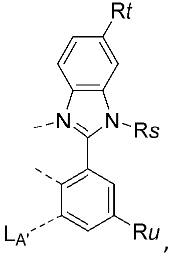 |
| L_{y}47-(R*s*)(R*t*)(R*u*), wherein L_{y}47-(R1)(R1)(R1) to L_{y}47-(R468)(R468)(R468), having the structure | 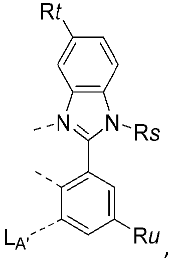 | L_{y}48-(R*s*)(R*t*)(R*u*), wherein L_{y}48-(R1)(R1)(R1) to L_{y}48-(R468)(R468)(R468), having the structure | 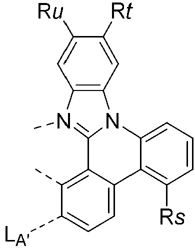 |
| L_{y}49-(R*s*)(R*t*)(R*u*), wherein L_{y}49-(R1)(R1)(R1) to L_{y}49-(R468)(R468)(R468), having the structure | 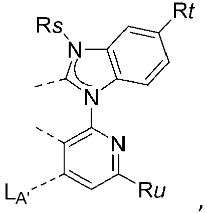 | L_{y}50-(R*s*)(R*t*)(R*u*), wherein L_{y}50-(R1)(R1)(R1) to L_{y}50-(R468)(R468)(R468), having the structure | 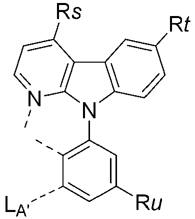 |
| L_{y}51-(R*s*)(R*t*)(R*u*), wherein L_{y}51-(R1)(R1)(R1) to L_{y}51-(R468)(R468)(R468), having the structure | 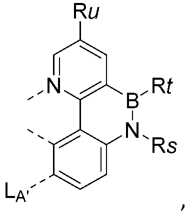 | L_{y}52-(R*s*)(R*t*)(R*u*), wherein L_{y}52-(R1)(R1)(R1) to L_{y}52-(R468)(R468)(R468), having the structure | 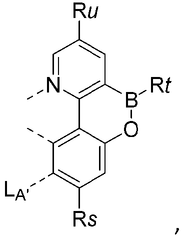 |
| L_{y}53-(R*s*)(R*t*)(R*u*), wherein L_{y}53-(R1)(R1)(R1) to L_{y}53-(R468)(R468)(R468), having the structure | 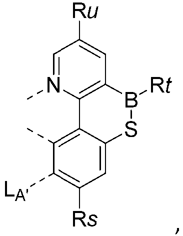 | L_{y}54-(R*s*)(R*t*)(R*u*), wherein L_{y}54-(R1)(R1)(R1) to L_{y}54-(R468)(R468)(R468), having the structure | 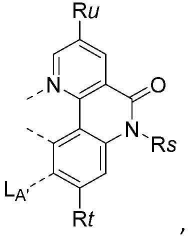 |
| L_{y}55-(R*s*)(R*t*)(R*u*), wherein L_{y}55-(R1)(R1)(R1) to L_{y}55-(R468)(R468)(R468), having the structure | 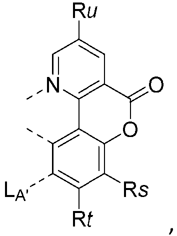 | L_{y}56-(R*s*)(R*t*)(R*u*), wherein L_{y}56-(R1)(R1)(R1) to L_{y}56-(R468)(R468)(R468), having the structure | 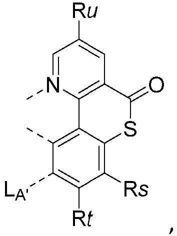 |
| L_{y}57-(R*s*)(R*t*)(R*u*), wherein L_{y}57-(R1)(R1)(R1) to L_{y}57-(R468)(R468)(R468), having the structure | 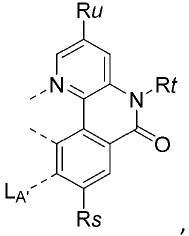 | L_{y}58-(R*s*)(R*t*)(R*u*), wherein L_{y}58-(R1)(R1)(R1) to L_{y}58-(R468)(R468)(R468), having the structure | 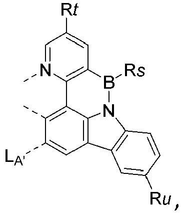 |
| L_{y}59-(R*s*)(R*t*)(R*u*), wherein L_{y}59-(R1)(R1)(R1) to L_{y}59-(R468)(R468)(R468), having the structure | 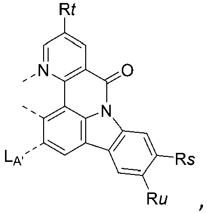 | L_{y}60-(R*s*)(R*t*)(R*u*), wherein L_{y}60-(R1)(R1)(R1) to L_{y}60-(R468)(R468)(R468), having the structure | 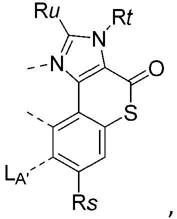 |
| L_{y}61-(R*s*)(R*t*)(R*u*), wherein L_{y}61-(R1)(R1)(R1) to L_{y}61-(R468)(R468)(R468), having the structure | 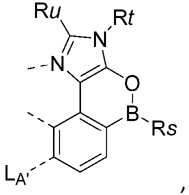 | L_{y}62-(R*s*)(R*t*)(R*u*), wherein L_{y}62-(R1)(R1)(R1) to L_{y}62-(R468)(R468)(R468), having the structure | 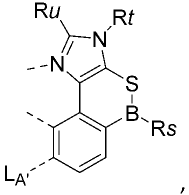 |
| L_{y}63-(R*s*)(R*t*)(R*u*), wherein L_{y}63-(R1)(R1)(R1) to L_{y}63-(R468)(R468)(R468), having the structure | 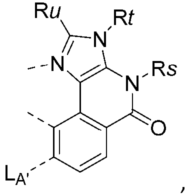 | L_{y}64*-*(R*s*)(R*t*)(R*u*), wherein L_{y}64-(R1)(R1)(R1) to L_{y}64-(R468)(R468)(R468), having the structure | 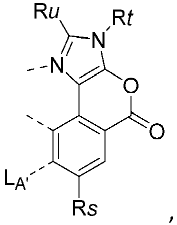 |
| L_{y}65-(R*s*)(R*t*)(R*u*), wherein L_{y}65-(R1)(R1)(R1) to L_{y}65-(R468)(R468)(R468), having the structure | 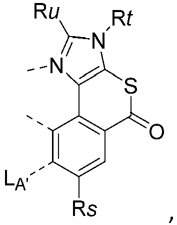 | L_{y}66-(R*s*)(R*t*)(R*u*), wherein L_{y}66-(R1)(R1)(R1) to L_{y}66-(R468)(R468)(R468), having the structure | 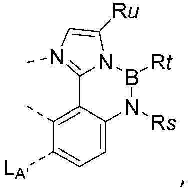 |
| L_{y}67-(R*s*)(R*t*)(R*u*), wherein L_{y}67-(R1)(R1)(R1) to L_{y}67-(R468)(R468)(R468), having the structure | 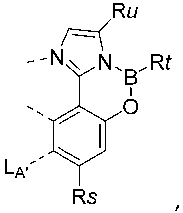 | L_{y}68-(R*s*)(R*t*)(R*u*), wherein L_{y}68-(R1)(R1)(R1) to L_{y}68-(R468)(R468)(R468), having the structure | 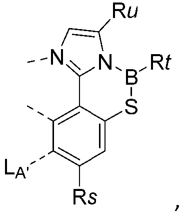 |
| L_{y}69-(R*s*)(R*t*)(R*u*), wherein L_{y}69-(R1)(R1)(R1) to L_{y}69-(R468)(R468)(R468), having the structure | 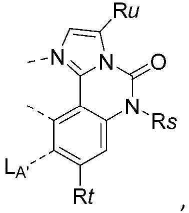 | L_{y}70-(R*s*)(R*t*)(R*u*), wherein L_{y}70-(R1)(R1)(R1) to L_{y}70-(R468)(R468)(R468), having the structure | 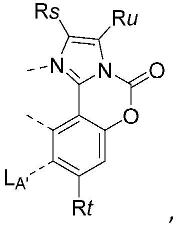 |
| L_{y}71-(R*s*)(R*t*)(R*u*), wherein L_{y}71-(R1)(R1)(R1) to L_{y}71-(R468)(R468)(R468), having the structure | 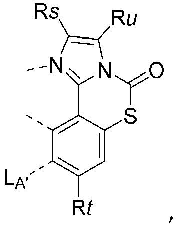 | L_{y}72-(R*s*)(R*t*)(R*u*), wherein L_{y}72-(R1)(R1)(R1) to L_{y}72-(R468)(R468)(R468), having the structure | 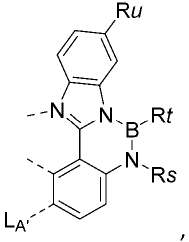 |
| L_{y}73-(R*s*)(R*t*)(R*u*), wherein L_{y}73-(R1)(R1)(R1) to L_{y}73-(R468)(R468)(R468), having the structure | 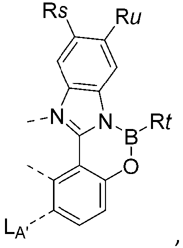 | L_{y}74-(R*s*)(R*t*)(R*u*), wherein L_{y}74-(R1)(R1)(R1) to L_{y}74-(R468)(R468)(R468), having the structure | 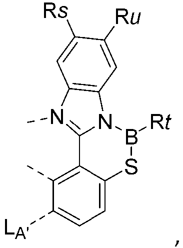 |
| L_{y}75-(R*s*)(R*t*)(R*u*), wherein L_{y}75-(R1)(R1)(R1) to L_{y}75-(R468)(R468)(R468), having the structure | 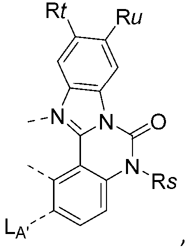 | L_{y}76-(R*s*)(R*t*)(R*u*), wherein L_{y}76-(R1)(R1)(R1) to L_{y}76-(R468)(R468)(R468), having the structure | 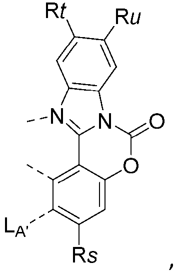 |
| L_{y}77-(R*s*)(R*t*)(R*u*), wherein L_{y}77-(R1)(R1)(R1) to L_{y}77-(R468)(R468)(R468), having the structure | 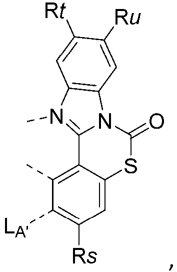 | *L_{y}*78-(R*s*)(R*t*)(R*u*), wherein L_{y}78-(R1)(R1)(R1) to L_{y}78-(R468)(R468)(R468), having the structure | 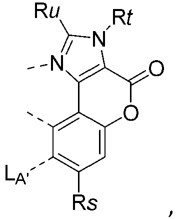 |
| L_{y}79-(R*s*)(R*t*)(R*u*), wherein L_{y}79-(R1)(R1)(R1) to L_{y}79-(R468)(R468)(R468), having the structure | 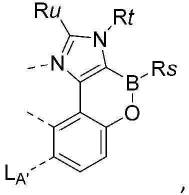 | L_{y}80-(R*s*)(R*t*)(R*u*), wherein L_{y}80-(R1)(R1)(R1) to L_{y}80-(R468)(R468)(R468), having the structure | 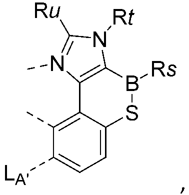 |
| L_{y}81-(R*s*)(R*t*)(R*u*), wherein L_{y}81-(R1)(R1)(R1) to L_{y}81-(R468)(R468)(R468), having the structure | 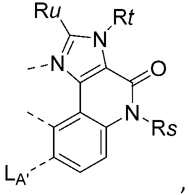 | L_{y}82-(R*s*)(R*t*)(R*u*)(R*v*), wherein L_{y}*8*2-(R1)(R1)(R1)(R1) to L_{y}82-(R468)(R468)(R468)(R4 68), having the structure | 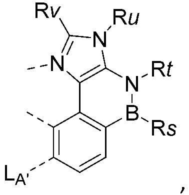 |
| L_{y}83-(R*s*)(R*t*)(R*u*)(R*v*), wherein L_{y}83-(R1)(R1)(R1)(R1) to L_{y}83-(R468)(R468)(R468)(R4 68), having the structure | 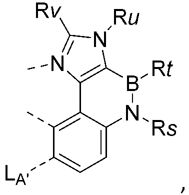 | L_{y}84-(R*s*)(R*t*)(R*u*), wherein L_{y}84-(R1)(R1)(R1) to L_{y}84-(L468)(R468)(R468), have the structure | 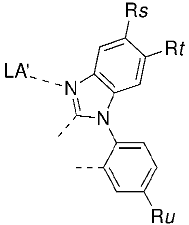 |
| L_{y}85-(R*s*)(R*t*)(Ru), wherein L_{y}85-(R1)(R1)(R1) to L_{y}85-(L468)(R468)(R468), have the structure | 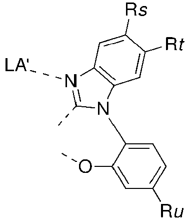 | L_{y}86-(R*s*)(R*t*)(Ru), wherein L_{y}86-(R1)(R1)(R1) to L_{y}86-(L468)(R468)(R468), have the structure | 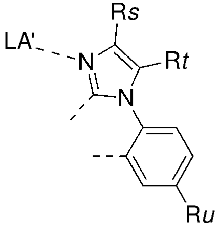 |
| L_{y}87-(R*s*)(R*t*)(Ru), wherein L_{y}87-(R1)(R1)(R1) to L_{y}87-(L468)(R468)(R468), have the structure | 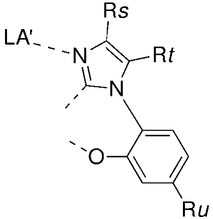 | L_{y}88-(R*s*)(R*t*)(Ru), wherein L_{y}88-(R1)(R1)(R1) to L_{y}88-(L468)(R468)(R468), have the structure | 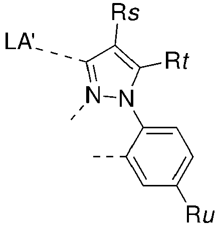 |
| L_{y}89-(R*s*)(R*t*)(Ru), wherein L_{y}89-(R1)(R1)(R1) to L_{y}89-(L468)(R468)(R468), have the structure | 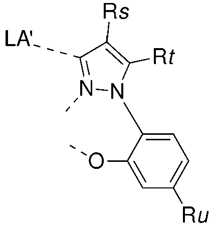 | L_{y}90-(R*s*)(R*t*)(Ru), wherein L_{y}90-(R1)(R1)(R1) to L_{y}90-(L468)(R468)(R468), have the structure | 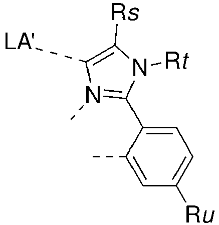 |
| L_{y}91-(R*s*)(R*t*)(Ru), wherein L_{y}91-(R1)(R1)(R1) to L_{y}91-(L468)(R468)(R468), have the structure | 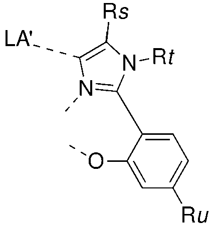 | L_{y}92-(R*s*)(R*t*)(Ru), wherein L_{y}92-(R1)(R1)(R1) to L_{y}92-(L468)(R468)(R468), have the structure | 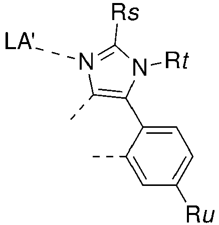 |
| L_{y}93-(R*s*)(R*t*)(Ru), wherein L_{y}93-(R1)(R1)(R1) to L_{y}93-(L468)(R468)(R468), have the structure | 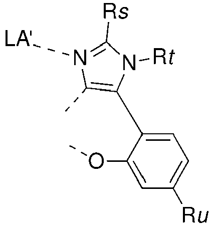 | L_{y}94-(R*s*)(R*t*)(Ru), wherein L_{y}94-(R1)(R1)(R1) to L_{y}94-(L468)(R468)(R468), have the structure | 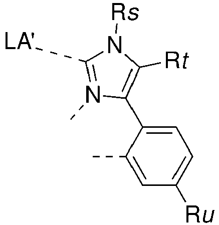 |
| L_{y}95-(R*s*)(R*t*)(Ru), wherein L_{y}95-(R1)(R1)(R1) to L_{y}95-(L468)(R468)(R468), have the structure | 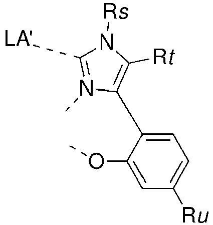 | L_{y}96-(R*p*)(R*q*)(R*r*)(R*s*), wherein L_{y}96-(R1)(R1)(R1)(R1) to L_{y}96 (R468)(R468)(R468)( R468), have the structure | 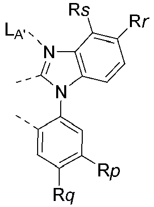 |
| L_{y}97-(R*p*)(R*q*)(R*r*)(R*s*), wherein L_{y}97-(R1)(R1)(R1)(R1) to L_{y}97 (R468)(R468)(R468)( R468), have the structure | 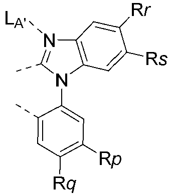 | L_{y}98-(R*p*)(R*q*)(R*r*)(R*s*), wherein L_{y}98-(R1)(R1)(R1)(R1) to L_{y}98 (R468)(R468)(R468)( R468), have the structure | 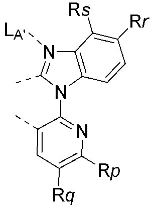 |
| L_{y}99-(R*q*)(R*r*)(R*s*), wherein L_{y}99-(R1)(R1)(R1) to L_{y}99 (R468)(R468)(R468), have the structure | 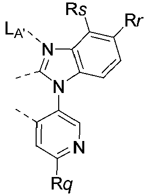 | L_{y}100-(R*p*)(R*q*)(R*r*)(R*t*), wherein L_{y}100-(R1)(R1)(R1)(R1) to L_{y}100 (R468)(R468)(R468)( R468), have the structure | 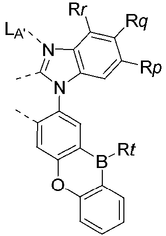 |
| L_{y}101-(R*p*)(R*q*)(R*r*)(R*t*), wherein L_{y}101-(R1)(R1)(R1)(R1) to L_{y}101 (R468)(R468)(R468)( R468), have the structure | 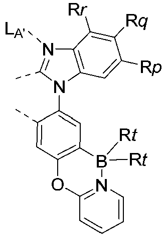 | L_{y}102-(R*p*)(R*q*)(R*r*)(R*s*), wherein L_{y}102-(R1)(R1)(R1)(R1) to L_{y}102 (R468)(R468)(R468)( R468), have the structure | 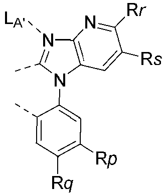 |
| L_{y}103-(R*p*)(R*q*)(R*r*)(R*s*), wherein L_{y}103-(R1)(R1)(R1)(R1) to L_{y}103 (R468)(R468)(R468)( R468), have the structure | 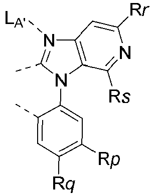 | L_{y}104-(R*p*)(R*q*)(R*r*)(R*s*), wherein L_{y}104-(R1)(R1)(R1)(R1) to L_{y}104 (R468)(R468)(R468)( R468), have the structure | 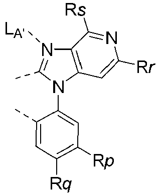 |
| L_{y}105-(R*p*)(R*q*)(R*r*)(R*s*), wherein L_{y}105-(R1)(R1)(R1)(R1) to L_{y}105 (R468)(R468)(R468)( R468), have the structure | 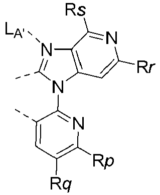 | L_{y}106-(R*p*)(R*q*)(R*r*)(R*s*), wherein L_{y}106-(R1)(R1)(R1)(R1) to L_{y}106 (R468)(R468)(R468)( R468), have the structure | 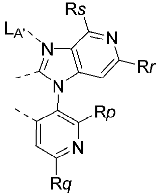 |
| L_{y}107-(R*p*)(R*q*)(R*r*)(R*s*), wherein L_{y}107-(R1)(R1)(R1)(R1) to L_{y}107 (R468)(R468)(R468)( R468), have the structure | 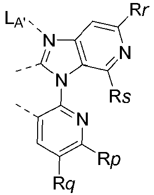 | L_{y}108-(R*p*)(R*q*)(R*r*)(R*s*), wherein L_{y}108-(R1)(R1)(R1)(R1) to L_{y}108 (R468)(R468)(R468)( R468), have the structure | 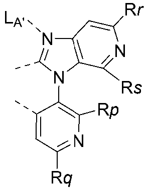 |
| L_{y}109-(R*p*)(R*q*)(R*r*)(R*s*), wherein L_{y}109-(R1)(R1)(R1)(R1) to L_{y}109 (R468)(R468)(R468)(R468), have the structure | 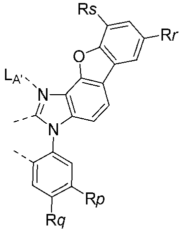 | L_{y}110-(R*p*)(R*q*)(R*r*)(R*s*), wherein L_{y}110-(R1)(R1)(R1)(R1) to L_{y}110 (R468)(R468)(R468)(R468), have the structure | 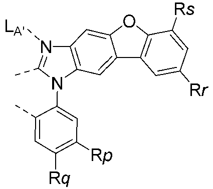 |
| L_{y}111-(R*p*)(R*q*)(R*r*)(R*s*), wherein L_{y}111-(R1)(R1)(R1)(R1) to L_{y}111 (R468)(R468)(R468)( R468), have the structure | 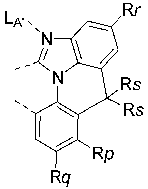 | L_{y}112-(R*p*)(R*q*)(R*r*)(R*u*), wherein L_{y}112-(R1)(R1)(R1)(R1) to L_{y}112 (R468)(R468)(R468)( R468), have the structure | 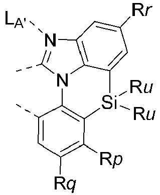 |
| L_{y}113-(R*q*)(R*r*)(Rs), wherein L_{y}113-(R1)(R1)(R1) to L_{y}113 (R468)(R468)(R468), have the structure | 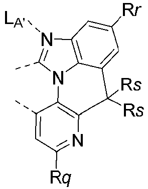 | L_{y}114-(R*q*)(R*r*)(R*u*), wherein L_{y}114-(R1)(R1)(R1) to L_{y}114 (R468)(R468)(R468), have the structure | 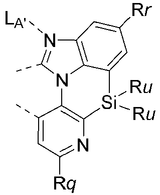 |
| L_{y}115-(R*p*)(R*q*)(R*r*)(R*t*), wherein L_{y}115-(R1)(R1)(R1)(R1) to L_{y}115 (R468)(R468)(R468)( R468), have the structure | 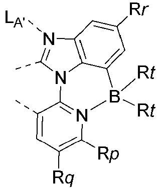 | L_{y}116-(R*p*)(R*q*)(R*r*)(R*s*), wherein L_{y}116-(R1)(R1)(R1)(R1) to L_{y}116 (R468)(R468)(R468)( R468), have the structure | 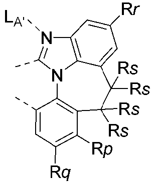 |
| L_{y}117-(R*q*)(R*r*)(R*s*), wherein L_{y}117-(R1)(R1)(R1) to L_{y}117 (R468)(R468)(R468), have the structure | 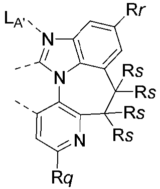 | L_{y}118-(R*q*)(R*r*)(R*s*), wherein L_{y}118-(R1)(R1)(R1) to L_{y}118 (R468)(R468)(R468), have the structure | 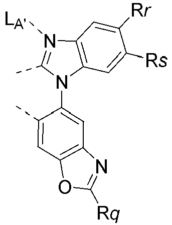 |
| L_{y}119-(R*q*)(R*r*)(R*s*), wherein L_{y}119-(R1)(R1)(R1) to L_{y}119 (R468)(R468)(R468), have the structure | 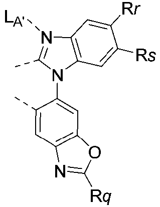 | L_{y}120-(R*p*)(R*q*)(R*r*)(R*s*), wherein L_{y}120-(R1)(R1)(R1)(R1) to L_{y}120 (R468)(R468)(R468)( R468), have the structure | 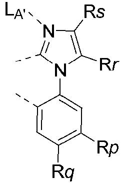 |
| L_{y}121-(R*p*)(R*q*)(R*r*)(R*s*), wherein L_{y}121-(R1)(R1)(R1)(R1) to L_{y}121 (R468)(R468)(R468)( R468), have the structure | 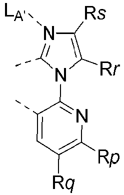 | L_{y}122-(R*q*)(Rr)(R*s*), wherein L_{y}122-(R1)(R1)(R1) to L_{y}122 (R468)(R468)(R468), have the structure | 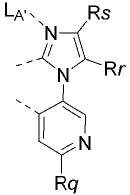 |
| L_{y}123-(R*p*)(R*q*)(R*s*)(R*v*), wherein L_{y}123-(R1)(R1)(R1)(R1) to L_{y}123 (R468)(R468)(R468)( R468), have the structure | 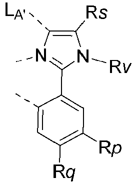 | L_{y}124-(R*p*)(R*q*)(R*s*)(R*v*), wherein L_{y}124-(R1)(R1)(R1)(R1) to L_{y}124 (R468)(R468)(R468)( R468), have the structure | 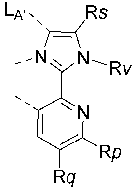 |
| L_{y}125-(R*q*)(R*s*)(R*v*), wherein L_{y}125-(R1)(R1)(R1) to L_{y}125 (R468)(R468)(R468), have the structure | 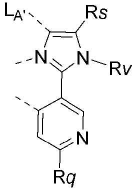 | L_{y}126-(R*s*)(R*v*)(R*t*), wherein L_{y}126-(R1)(R1)(R1) to L_{y}126 (R468)(R468)(R468), have the structure | 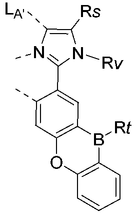 |
| L_{y}127-(R*p*)(R*q*)(R*s*)(R*v*)(R*t*), wherein L_{y}127-(R1)(R1)(R1)(R1)(R1) to L_{y}127 (R468)(R468)(R468)( R468)(R468), have the structure | 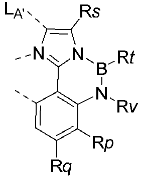 | L_{y128}-(R*p*)(R*s*)(R*v*), wherein L_{y}128-(R1)(R1)(R1) to L_{y}128 (R468)(R468)(R468), have the structure | 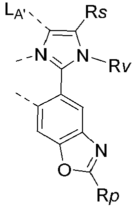 |
| L_{y}129-(R*p*)(R*s*)(R*v*), wherein L_{y}129-(R1)(R1)(R1) to L_{y}129 (R468)(R468)(R468), have the structure | 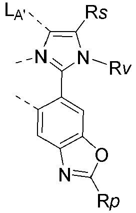 | L_{y}130-(R*p*)(R*s*)(R*v*)(R*t*), wherein L_{y}130-(R1)(R1)(R1)(R1) to L_{y}130 (R468)(R468)(R468)( R468), have the structure | 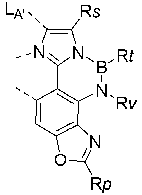 |

wherein R1 to R468 have the following structures (LIST 12):

| | **Structure** | | **Structure** | | **Structure** |
|---|---|---|---|---|---|
| R1 | 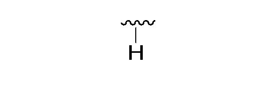 | R2 | 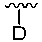 | R3 | 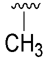 |
| R4 | 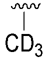 | R5 | 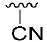 | R6 | 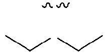 |
| R7 | 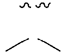 | R8 | 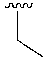 | R9 | 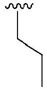 |
| R10 | 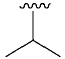 | R11 | 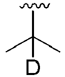 | R12 | 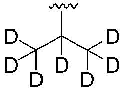 |
| R13 | 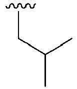 | R14 | 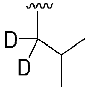 | R15 | 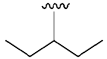 |
| R16 | 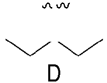 | R17 | 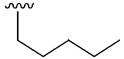 | R18 | 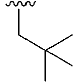 |
| R19 | 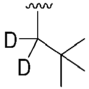 | R20 | 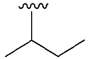 | R21 | 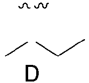 |
| R22 | 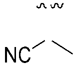 | R23 | 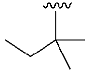 | R24 | 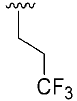 |
| R25 | 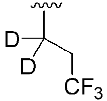 | R26 | 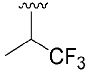 | R27 | 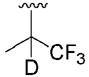 |
| R28 | 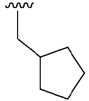 | R29 | 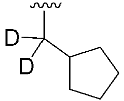 | R30 | 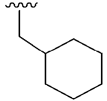 |
| R31 | 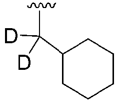 | R32 | 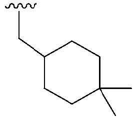 | R33 | 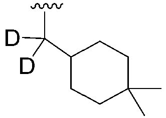 |
| R34 | 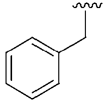 | R35 | 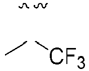 | R36 | 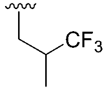 |
| R37 | 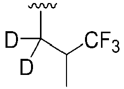 | R38 | 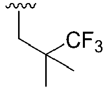 | R39 | 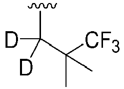 |
| R40 | 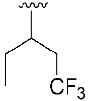 | R41 | 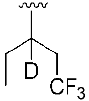 | R42 | 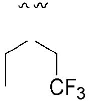 |
| R43 | 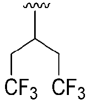 | R44 | 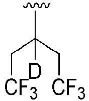 | R45 | 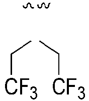 |
| R46 | 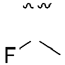 | R47 | 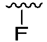 | R48 | 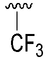 |
| R49 | 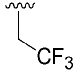 | R50 | 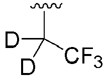 | R51 | 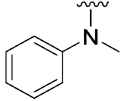 |
| R52 | 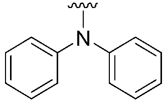 | R53 | 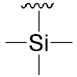 | R54 | 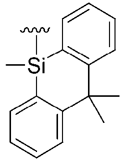 |
| R55 | 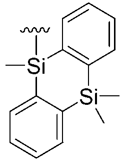 | R56 | 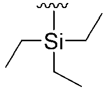 | R57 | 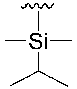 |
| R58 | 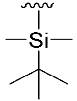 | R59 | 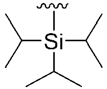 | R60 | 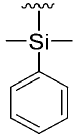 |
| R61 | 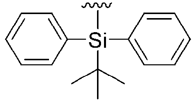 | R62 | 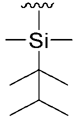 | R63 | 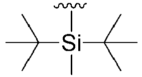 |
| R64 | 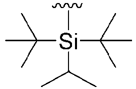 | R65 | 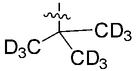 | R66 | 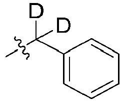 |
| R67 | 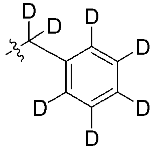 | R68 | 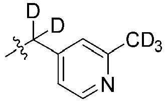 | R69 | 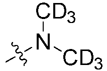 |
| R70 | 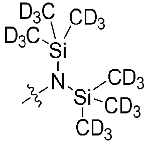 | R71 | 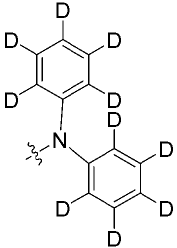 | R72 | 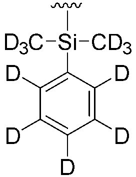 |
| R73 | 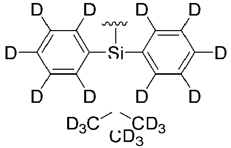 | R74 | 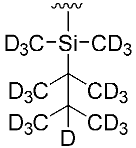 | R75 | 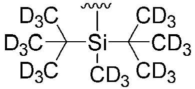 |
| R76 | 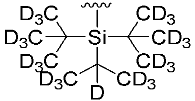 | R77 | 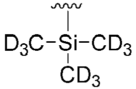 | R78 | 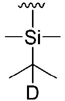 |
| R79 | 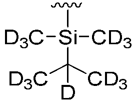 | R80 | 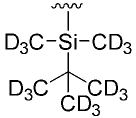 | R81 | 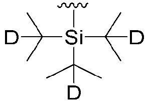 |
| R82 | 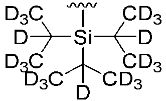 | R83 | 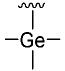 | R84 | 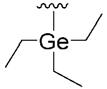 |
| R85 | 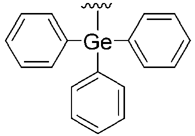 | R86 | 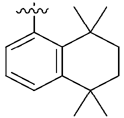 | R87 | 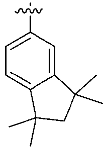 |
| R88 | 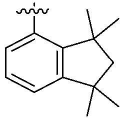 | R89 | 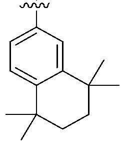 | R90 | 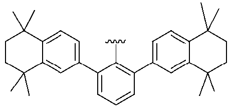 |
| R91 | 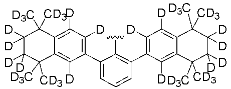 | R92 | 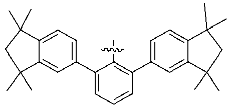 | R93 | 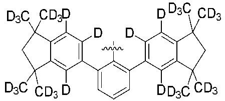 |
| R94 | 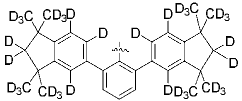 | R95 | 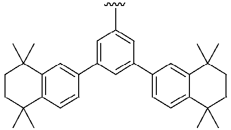 | R96 | 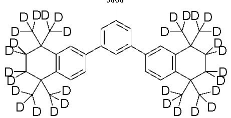 - |
| R97 | 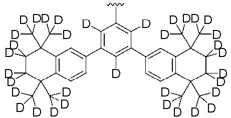 | R98 | 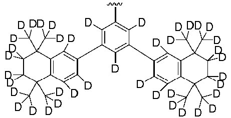 | R99 | 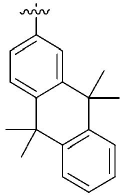 |
| R100 | 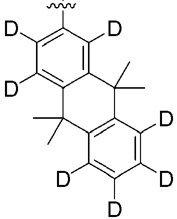 | R101 | 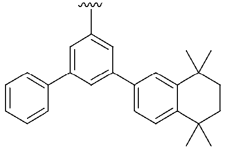 | R102 | 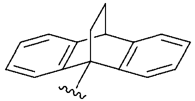 |
| R103 | 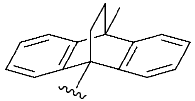 | R104 | 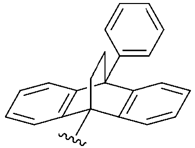 | R105 | 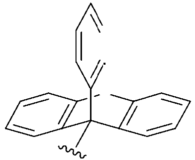 |
| R106 | 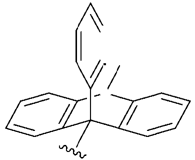 | R107 | 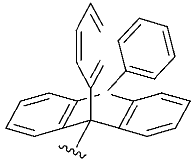 | R108 | 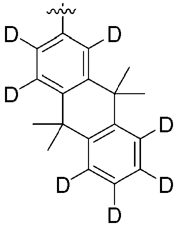 |
| R109 | 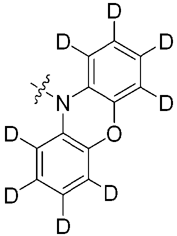 | R110 | 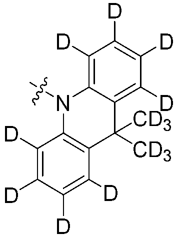 | R111 | 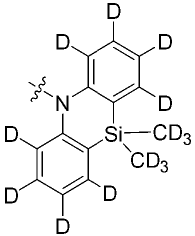 |
| R112 | 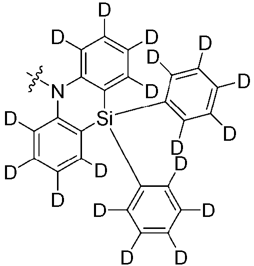 | R113 | 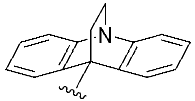 | R114 | 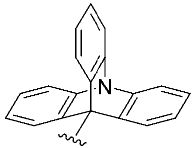 |
| R115 | 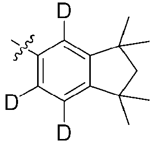 | R116 | 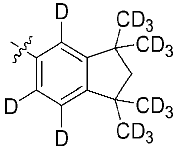 | R117 | 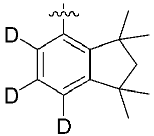 |
| R118 | 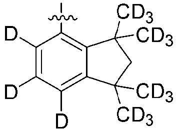 | R119 | 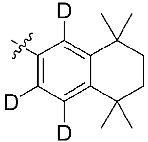 | R120 | 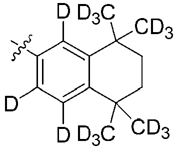 |
| R121 | 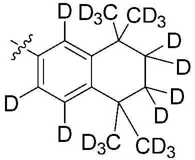 | R122 | 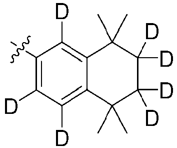 | R123 | 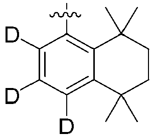 |
| R124 | 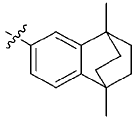 | R125 | 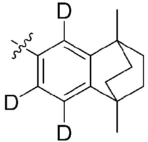 | R126 | 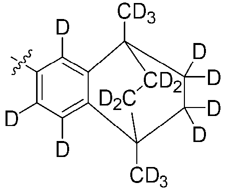 |
| R127 | 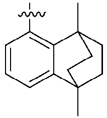 | R128 | 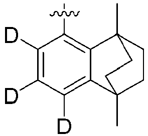 | R129 | 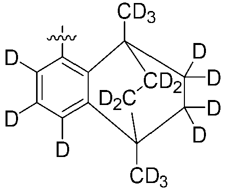 |
| R130 | 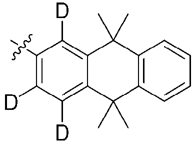 | R131 | 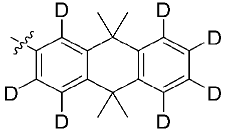 | R132 | 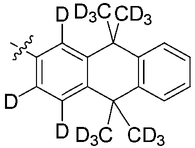 |
| R133 | 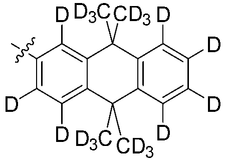 | R134 | 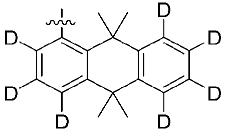 | R135 | 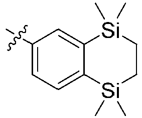 |
| R136 | 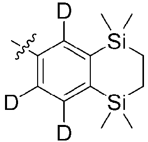 | R137 | 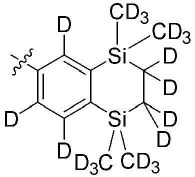 | R138 | 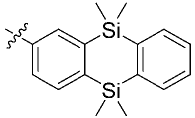 |
| R139 | 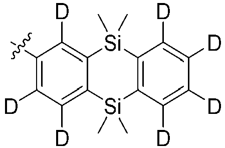 | R140 | 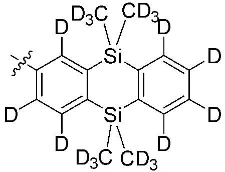 | R141 | 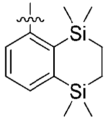 |
| R142 | 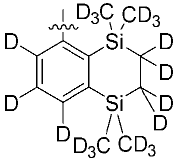 | R143 | 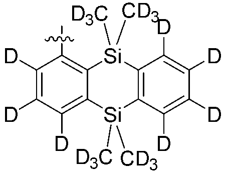 | R144 | 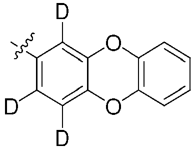 |
| R145 | 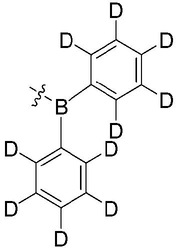 | R146 | 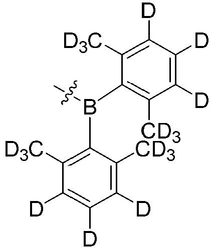 | R147 | 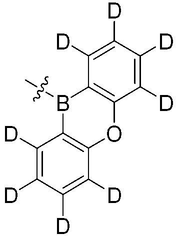 |
| R148 | 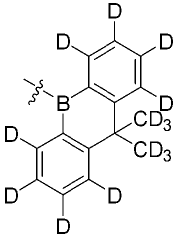 | R149 | 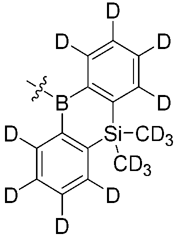 | R150 | 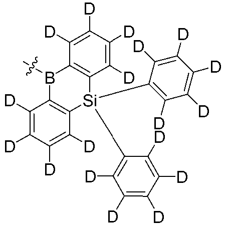 |
| R151 | 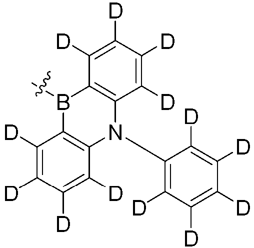 | R152 | 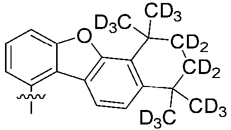 | R153 | 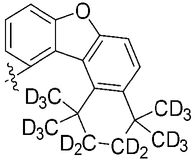 |
| R154 | 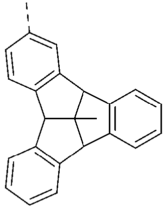 | R155 | 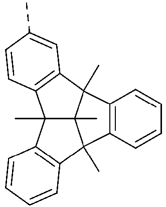 | R156 | 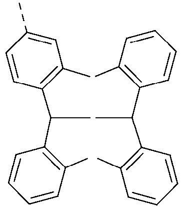 |
| R157 | 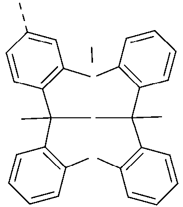 | R158 | 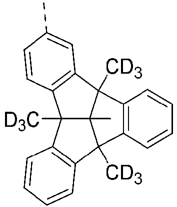 | R159 | 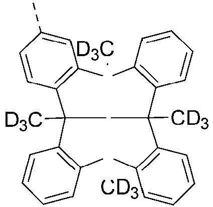 |
| R160 | 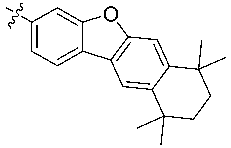 | R161 | 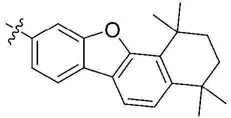 | R162 | 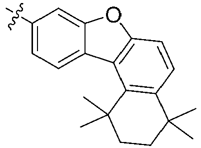 |
| R163 | 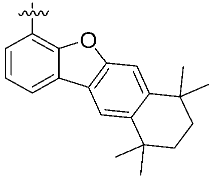 | R164 | 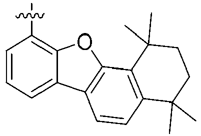 | R165 | 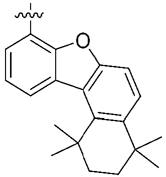 |
| R166 | 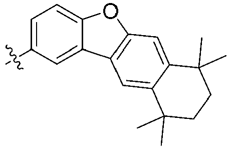 | R167 | 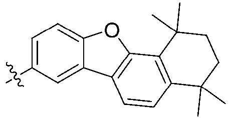 | R168 | 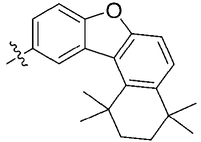 |
| R169 | 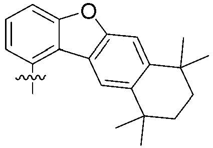 | R170 | 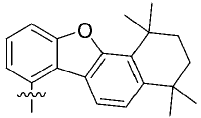 | R171 | 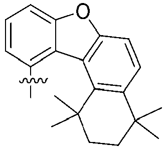 |
| R172 | 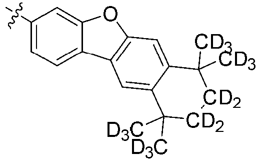 | R173 | 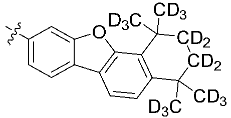 | R174 | 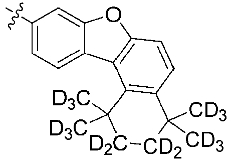 |
| R175 | 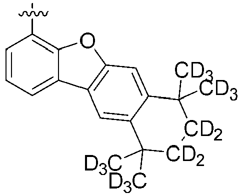 | R176 | 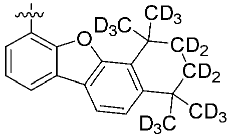 | R177 | 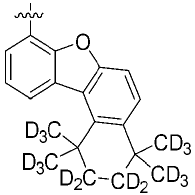 |
| R178 | 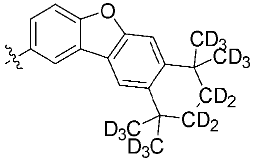 | R179 | 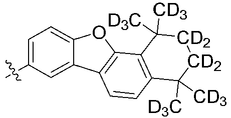 | R180 | 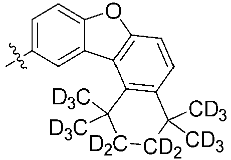 |
| R181 | 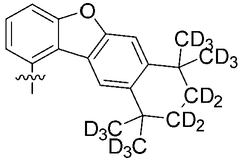 | R182 | 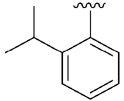 | R183 | 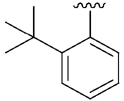 |
| R184 | 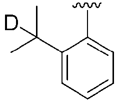 | R185 | 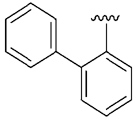 | R186 | 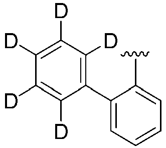 |
| R187 | 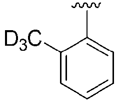 | R188 | 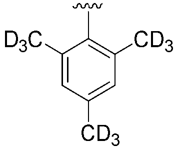 | R189 | 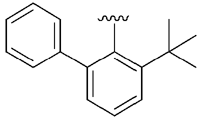 |
| R190 | 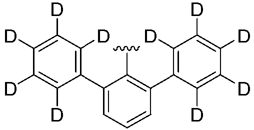 | R191 | 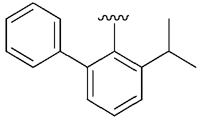 | R192 | 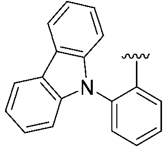 |
| R193 | 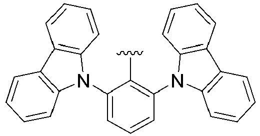 | R194 | 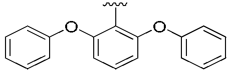 | R195 | 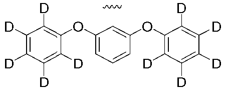 |
| R196 | 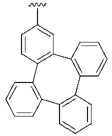 | R197 | 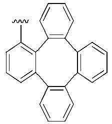 | R198 | 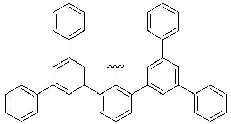 |
| R199 | 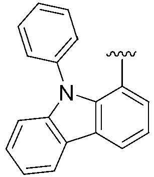 | R200 | 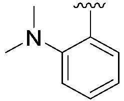 | R201 | 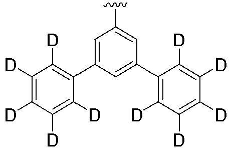 |
| R202 | 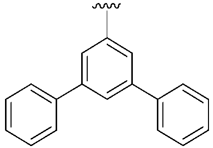 | R203 | 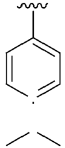 | R204 | 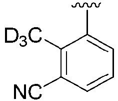 |
| R205 | 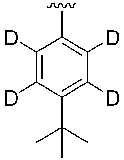 | R206 | 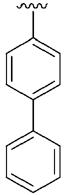 | R207 | 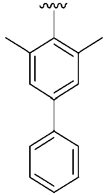 |
| R208 | 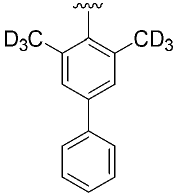 | R209 | 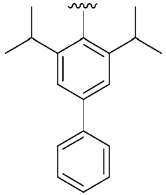 | R210 | 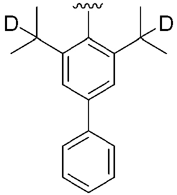 |
| R211 | 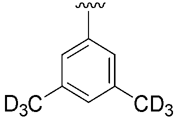 | R212 | 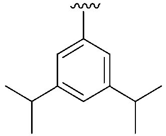 | R213 | 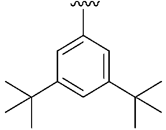 |
| R214 | 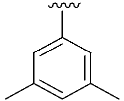 | R215 | 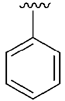 | R216 | 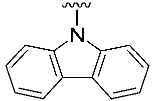 |
| R217 | 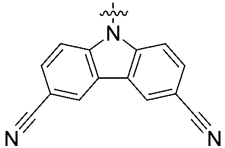 | R218 | 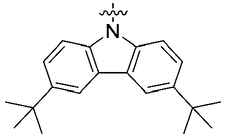 | R219 | 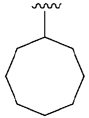 |
| R220 | 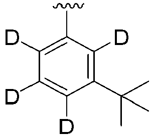 | R221 | 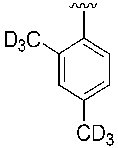 | R222 | 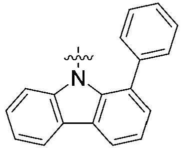 |
| R223 | 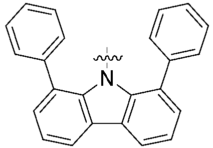 | R224 | 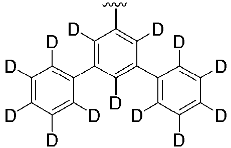 | R225 | 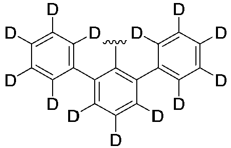 |
| R226 | 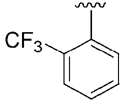 | R227 | 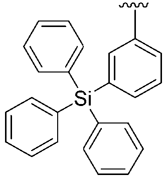 | R228 | 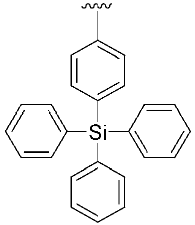 |
| R229 | 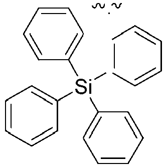 | R230 | 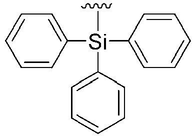 | R231 | 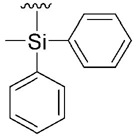 |
| R232 | 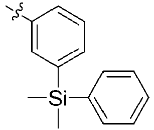 | R233 | 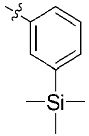 | R234 | 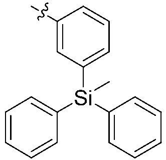 |
| R235 | 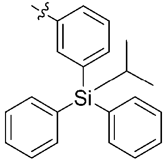 | R236 | 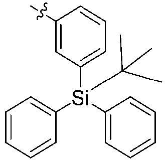 | R237 | 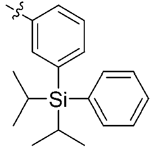 |
| R238 | 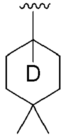 | R239 | 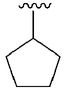 | R240 | 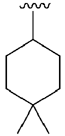 |
| R241 | 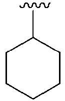 | R242 | 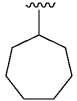 | R243 | 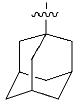 |
| R244 | 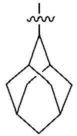 | R245 | 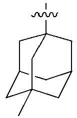 | R246 | 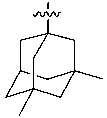 |
| R247 | 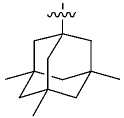 | R248 | 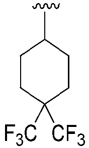 | R249 | 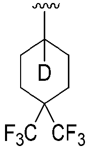 |
| R250 | 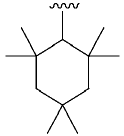 | R251 | 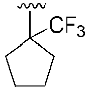 | R252 | 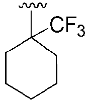 |
| R253 | 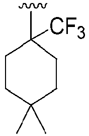 | R254 | 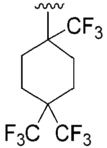 | R255 | 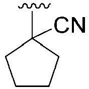 |
| R256 | 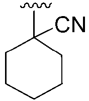 | R257 | 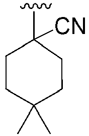 | R258 | 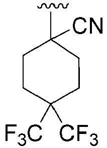 |
| R259 | 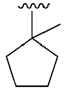 | R260 | 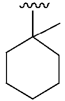 | R261 | 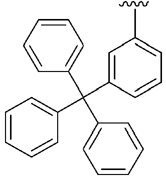 |
| R262 | 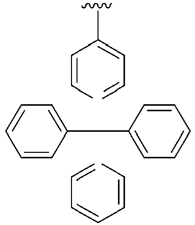 | R263 | 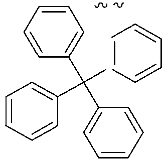 | R264 | 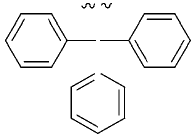 |
| R265 | 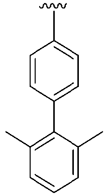 | R266 | 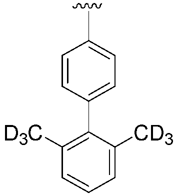 | R267 | 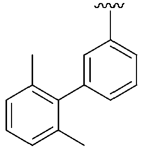 |
| R268 | 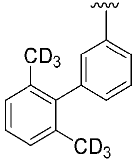 | R269 | 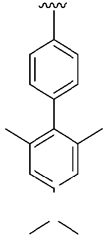 | R270 | 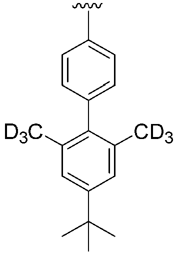 |
| R271 | 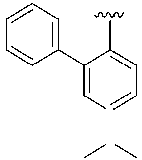 | R272 | 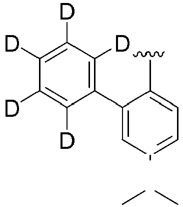 | R273 | 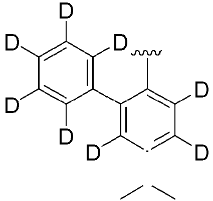 |
| R274 | 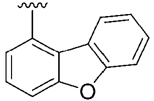 | R275 | 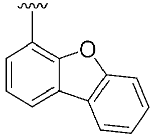 | R276 | 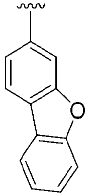 |
| R277 | 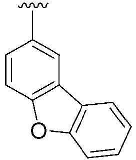 | R278 | 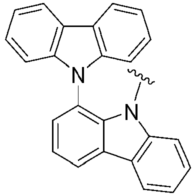 | R279 | 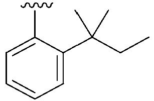 |
| R280 | 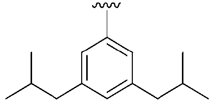 | R281 | 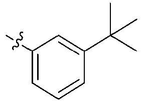 | R282 | 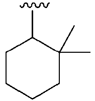 |
| R283 | 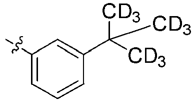 | R284 | 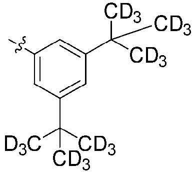 | R285 | 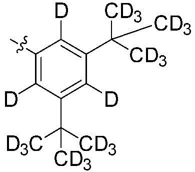 |
| R286 | 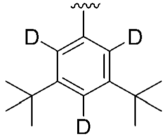 | R287 | 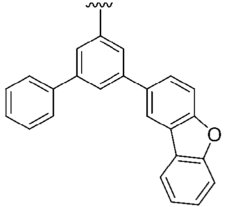 | R288 | 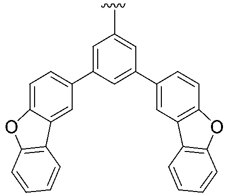 |
| R289 | 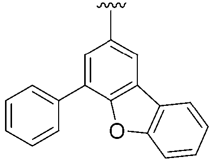 | R290 | 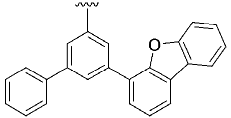 | R291 | 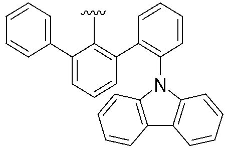 |
| R292 | 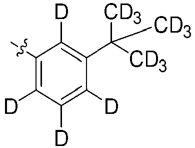 | R293 | 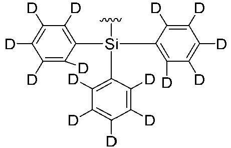 | R294 | 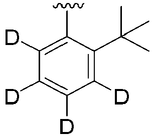 |
| R295 | 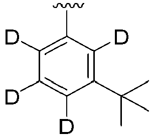 | R296 | 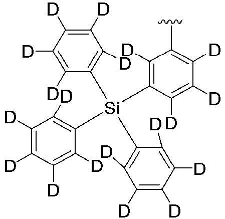 | R297 | 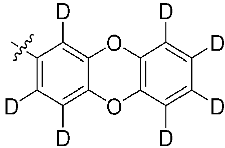 |
| R298 | 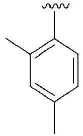 | R299 | 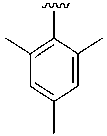 | R300 | 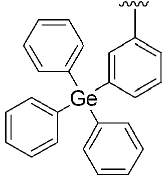 |
| R301 | 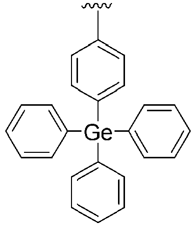 | R302 | 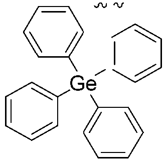 | R303 | 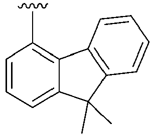 |
| R304 | 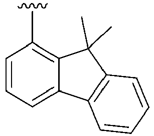 | R305 | 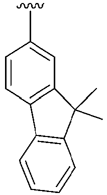 | R306 | 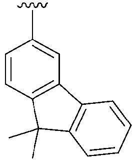 |
| R307 | 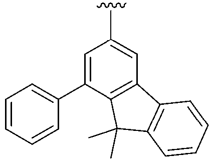 | R308 | 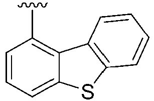 | R309 | 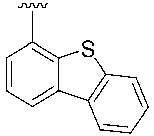 |
| R310 | 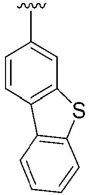 | R311 | 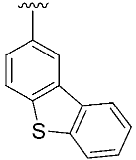 | R312 | 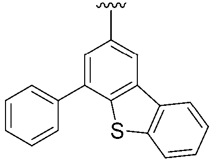 |
| R313 | 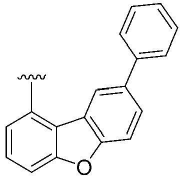 | R314 | 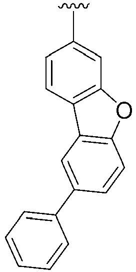 | R315 | 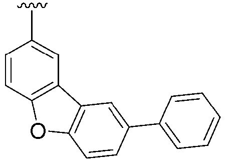 |
| R316 | 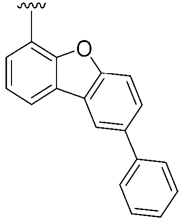 | R317 | 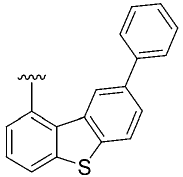 | R318 | 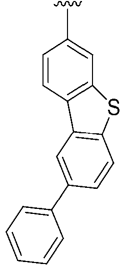 |
| R319 | 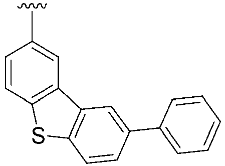 | R320 | 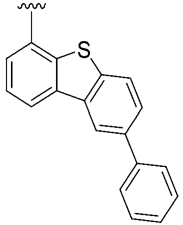 | R321 | 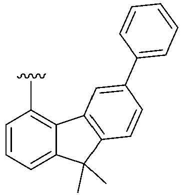 |
| R322 | 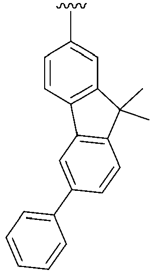 | R323 | 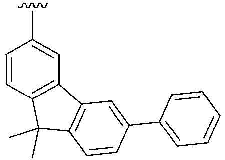 | R324 | 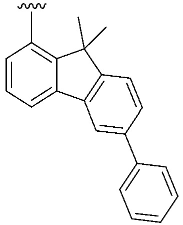 |
| R325 | 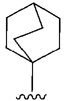 | R326 | 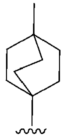 | R327 | 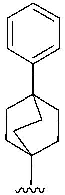 |
| R328 | 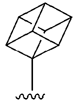 | R329 | 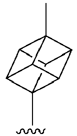 | R330 | 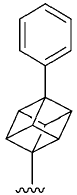 |
| R331 | 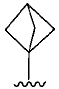 | R332 | 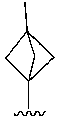 | R333 | 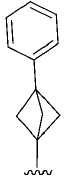 |
| R334 | 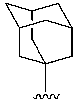 | R335 | 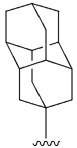 | R336 | 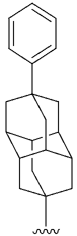 |
| R337 | 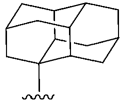 | R338 | 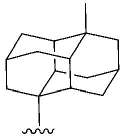 | R339 | 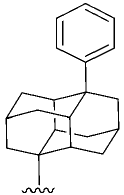 |
| R340 | 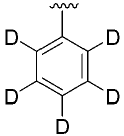 | R341 | 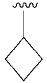 | R342 | 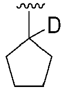 |
| R343 | 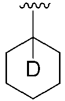 | R344 | 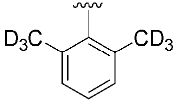 | R345 | 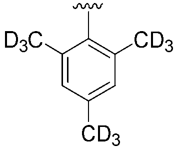 |
| R346 | 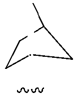 | R347 | 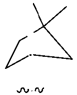 | R348 | 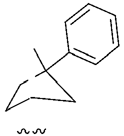 |
| R349 | 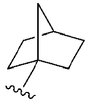 | R350 | 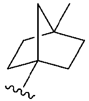 | R351 | 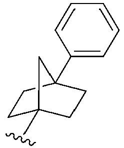 |
| R352 | 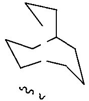 | R353 | 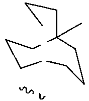 | R354 | 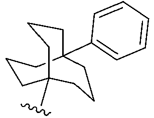 |
| R355 | 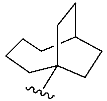 | R356 | 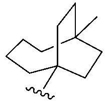 | R357 | 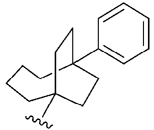 |
| R358 | 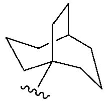 | R359 | 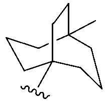 | R360 | 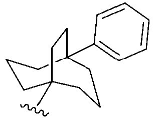 |
| R361 | 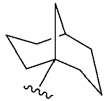 | R362 | 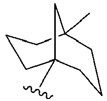 | R363 | 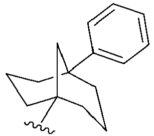 |
| R364 | 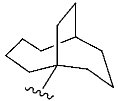 | R365 | 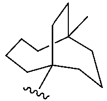 | R366 | 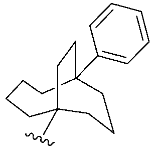 |
| R367 | 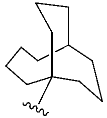 | R368 | 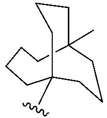 | R369 | 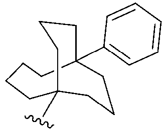 |
| R370 | 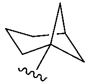 | R371 | 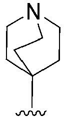 | R372 | 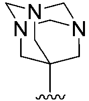 |
| R373 | 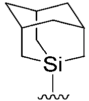 | R374 | 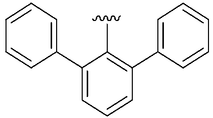 | R375 | 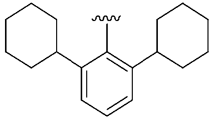 |
| R376 | 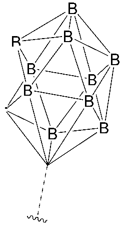 | R377 | 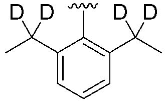 | R378 | 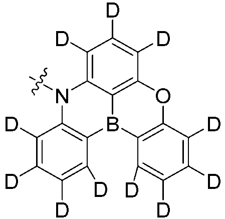 |
| R379 | 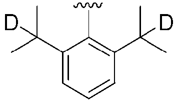 | R380 | 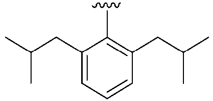 | R381 | 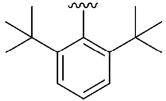 |
| R382 | 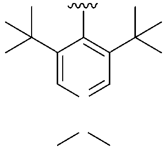 | R383 | 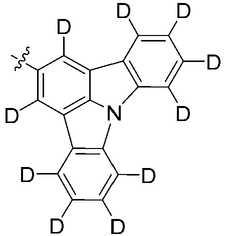 | R384 | 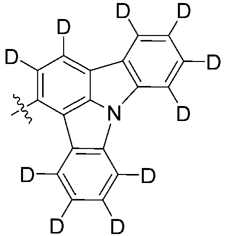 |
| R385 | 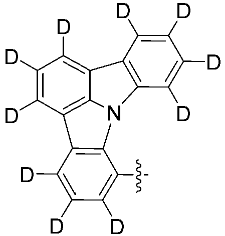 | R386 | 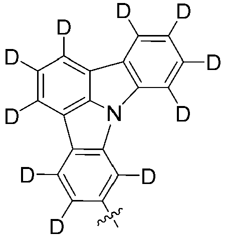 | R387 | 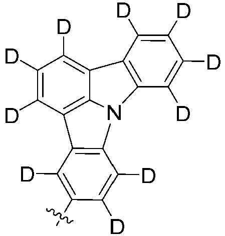 |
| R388 | 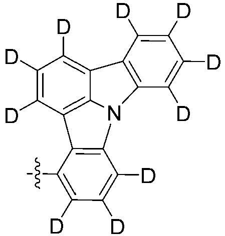 | R389 | 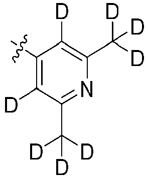 | R390 | 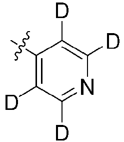 |
| R391 | 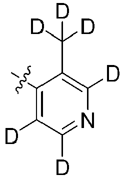 | R392 | 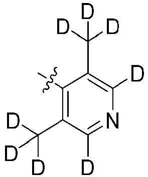 | R393 | 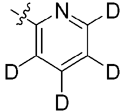 |
| R394 | 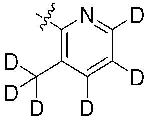 | R395 | 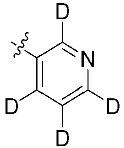 | R396 | 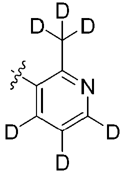 |
| R397 | 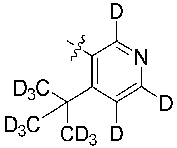 | R398 | 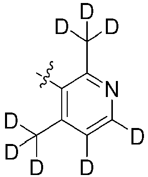 | R399 | 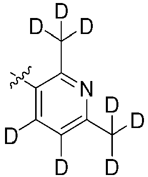 |
| R400 | 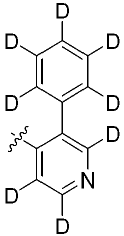 | R401 | 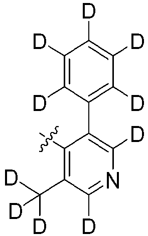 | R402 | 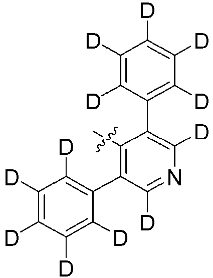 |
| R403 | 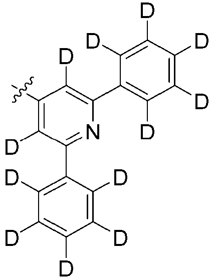 | R404 | 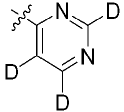 | R405 | 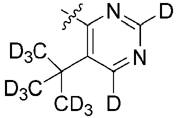 |
| R406 | 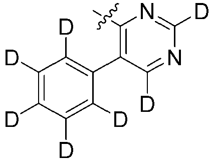 | R407 | 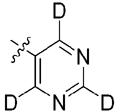 | R408 | 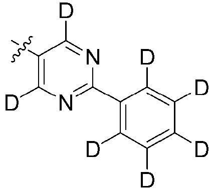 |
| R409 | 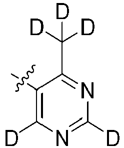 | R410 | 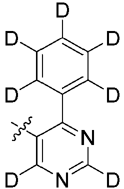 | R411 | 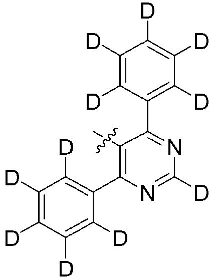 |
| R412 | 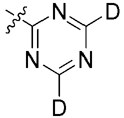 | R413 | 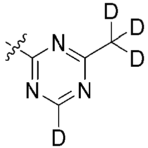 | R414 | 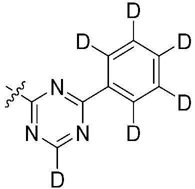 |
| R415 | 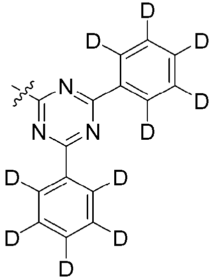 | R416 | 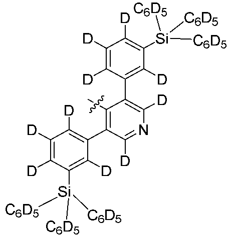 | R417 | 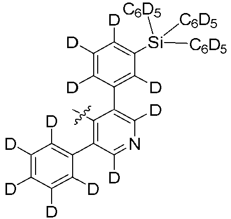 |
| R418 | 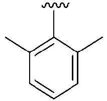 | R419 | 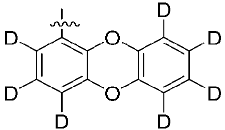 | R420 | 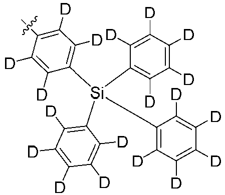 |
| R421 | 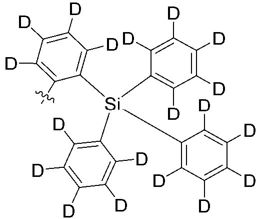 | R422 | 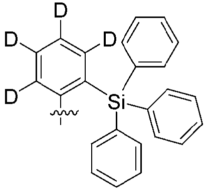 | R423 | 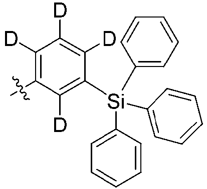 |
| R424 | 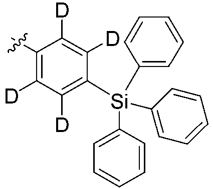 | R425 | 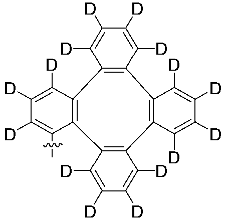 | R426 | 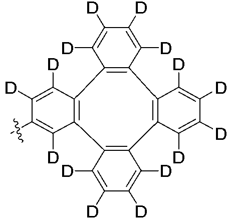 |
| R427 | 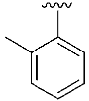 | R428 | 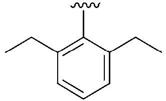 | R429 | 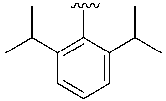 |
| R430 | 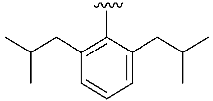 | R431 | 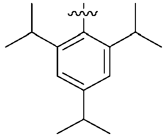 | R432 | 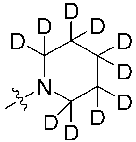 |
| R433 | 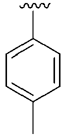 | R434 | 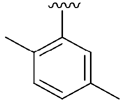 | R435 | 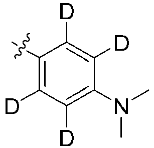 |
| R436 | 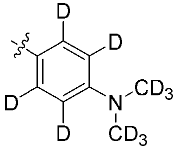 | R437 | 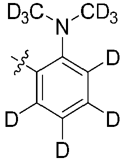 | R438 | 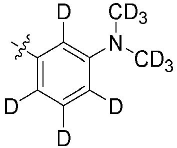 |
| R439 | 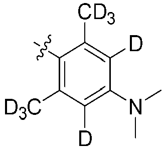 | R440 | 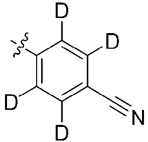 | R441 | 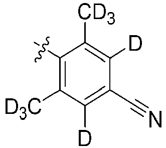 |
| R442 | 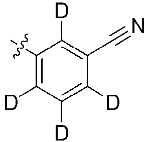 | R443 | 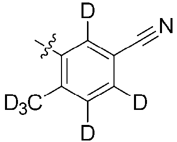 | R444 | 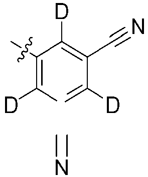 |
| R445 | 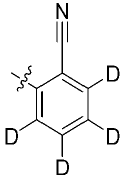 | R446 | 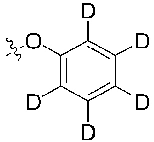 | R447 | 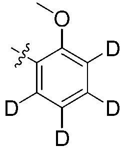 |
| R448 | 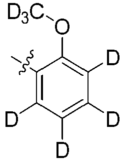 | R449 | 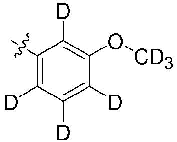 | R450 | 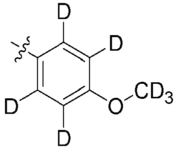 |
| R451 | 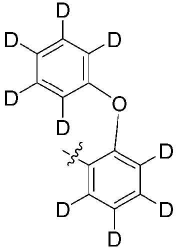 | R452 | 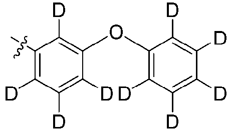 | R453 | 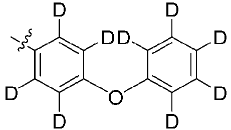 |
| R454 | 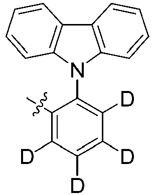 | R455 | 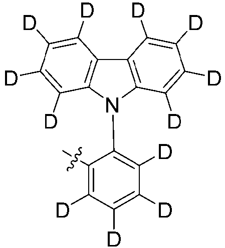 | R456 | 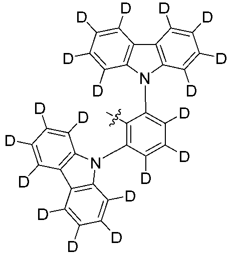 |
| R457 | 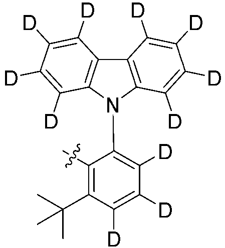 | R458 | 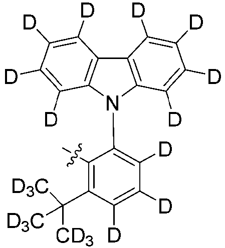 | R459 | 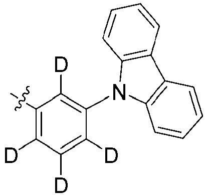 |
| R460 | 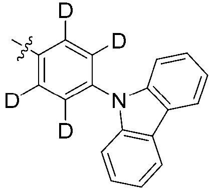 | R461 | 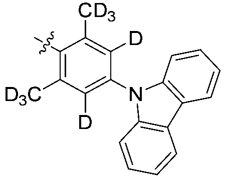 | R462 | 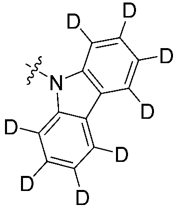 |
| R463 | 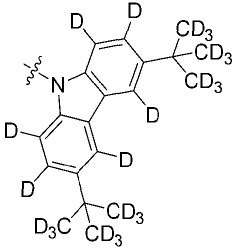 | R464 | 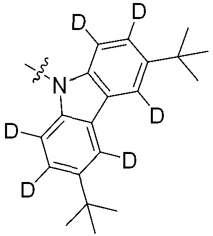 | R465 | 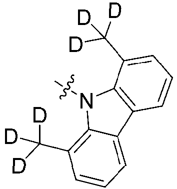 |
| R466 | 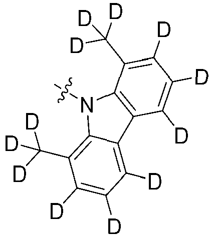 | R467 | 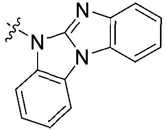 | R468 | 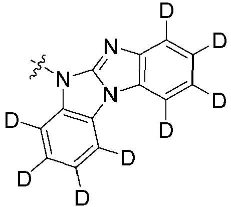 |

In some embodiments, the compound is selected from the group consisting of the structures from the following LIST 16: 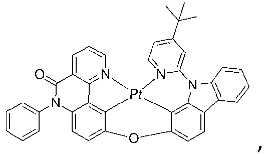 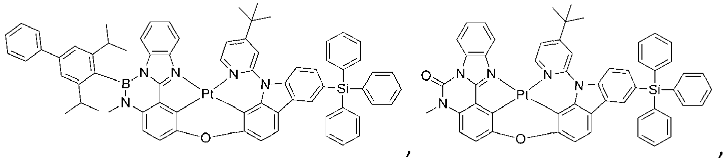 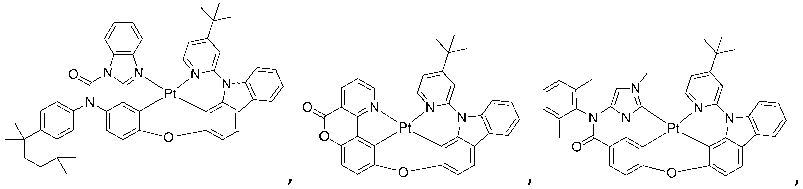 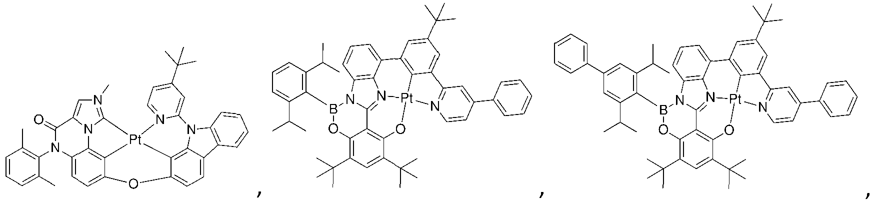 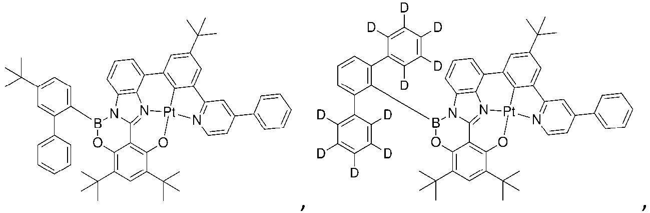 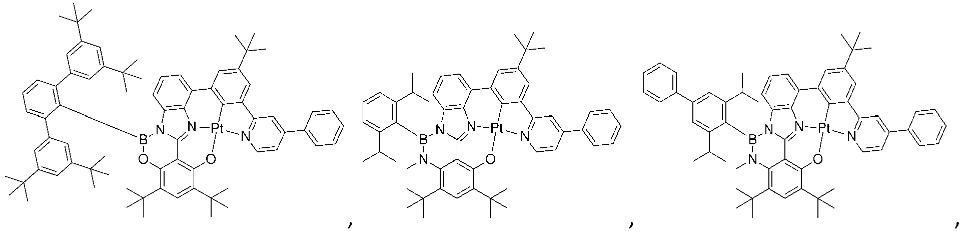 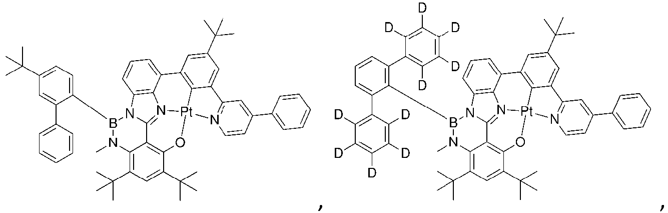 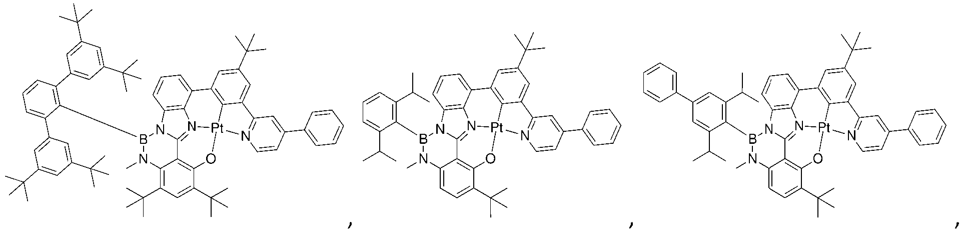 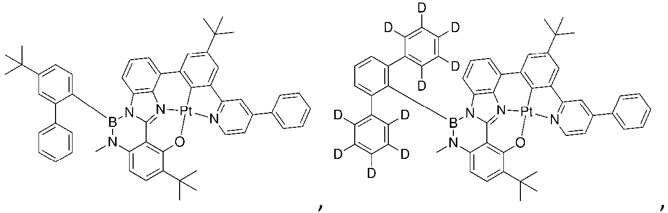 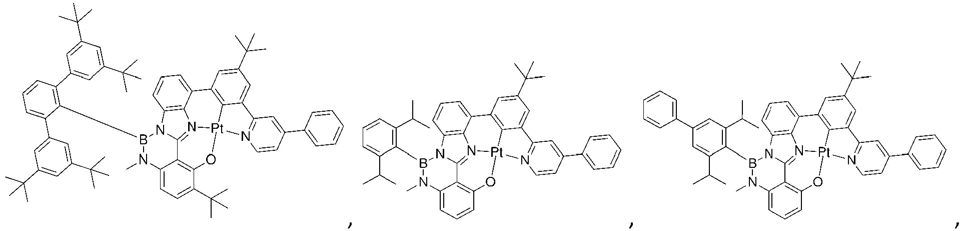 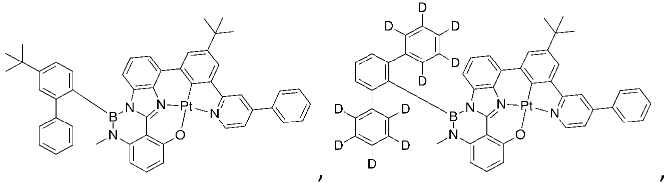 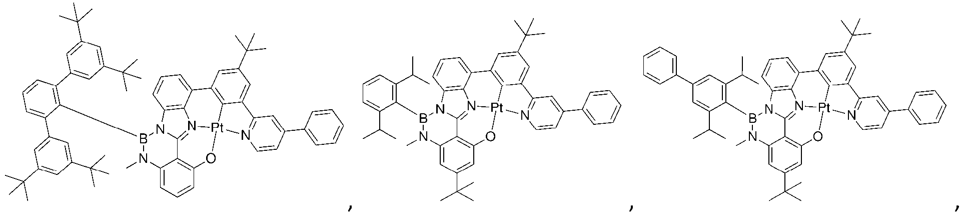 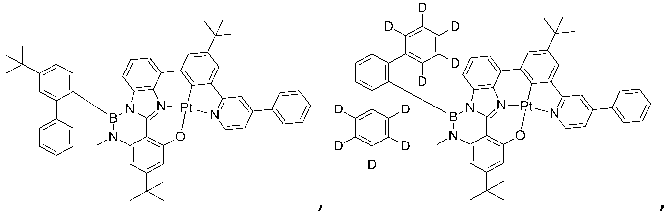 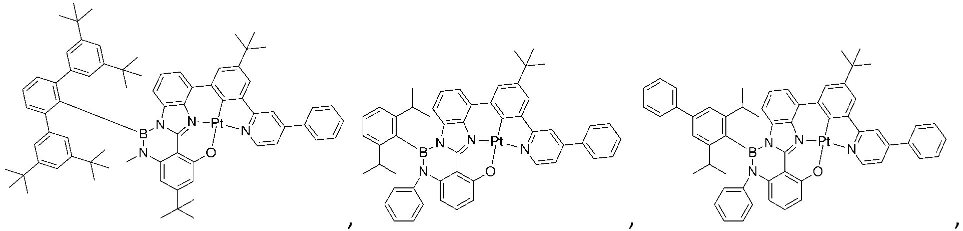 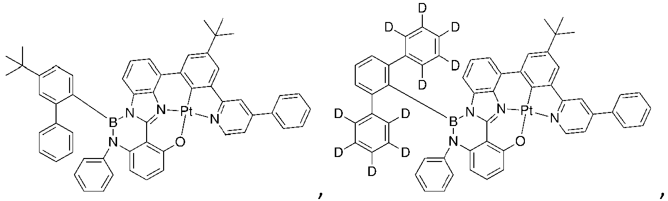 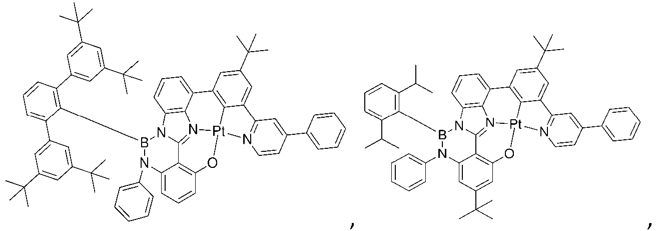 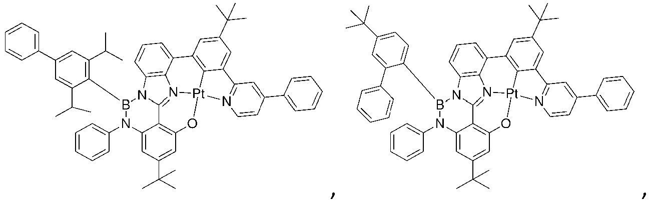 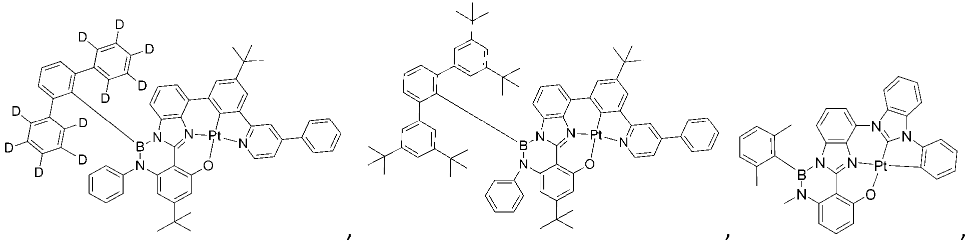 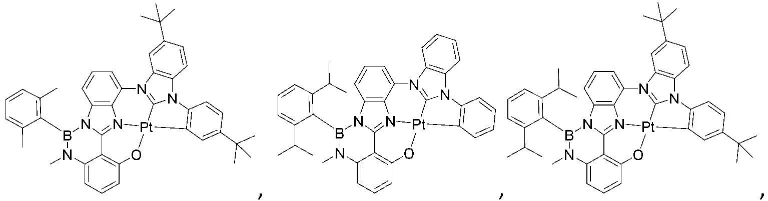 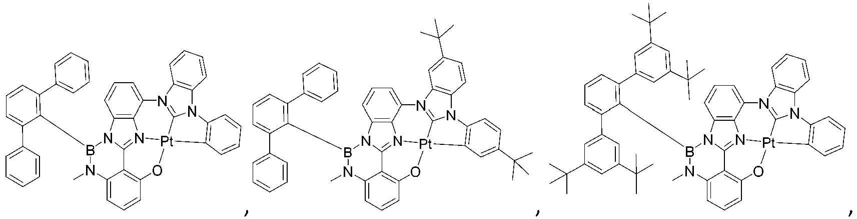 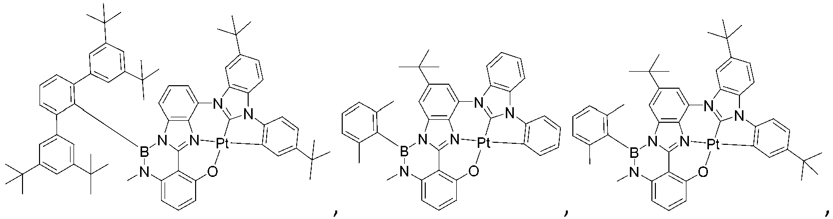 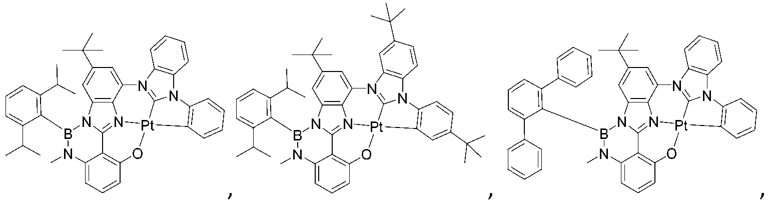 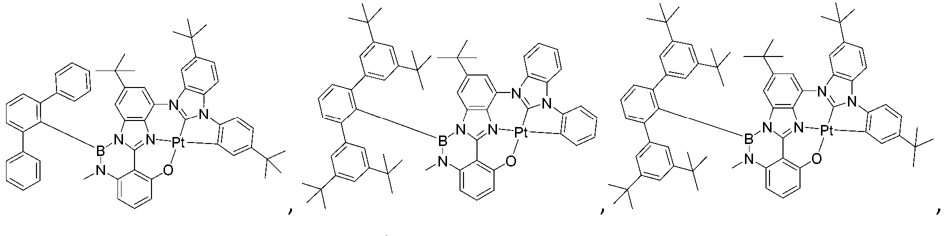 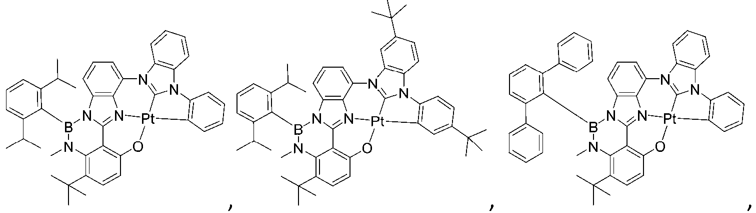 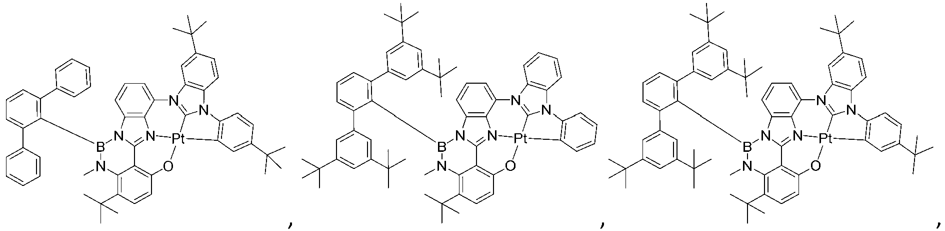 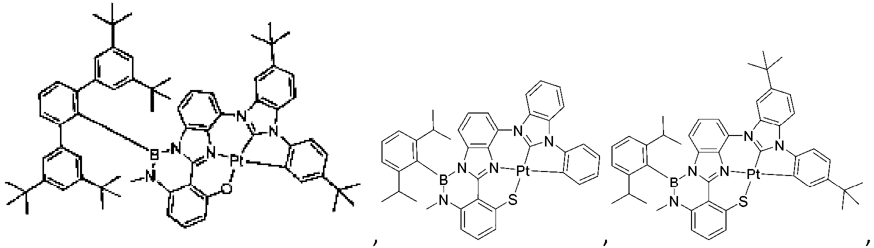 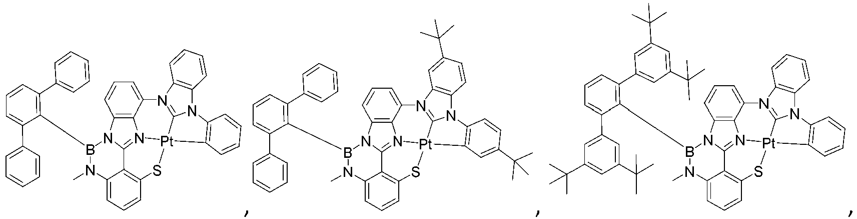 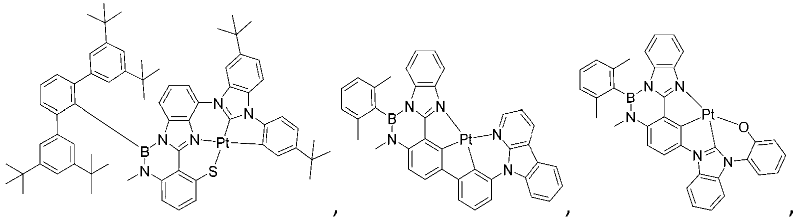 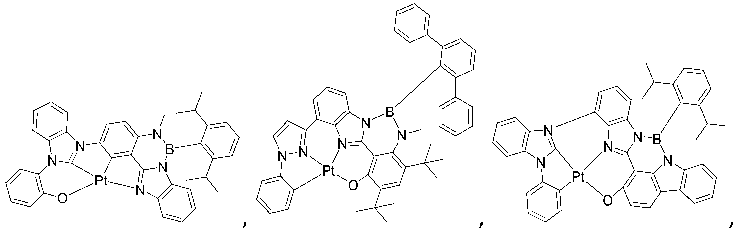 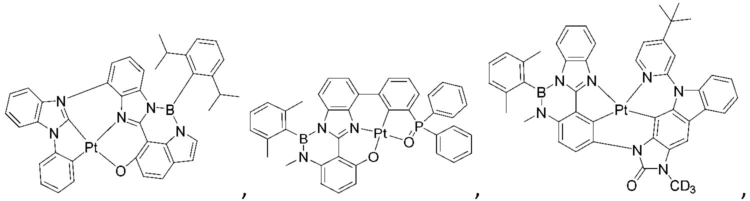 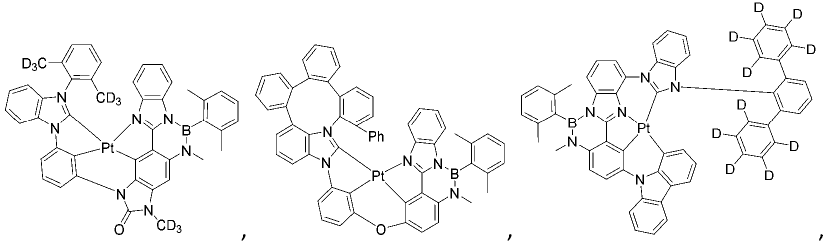 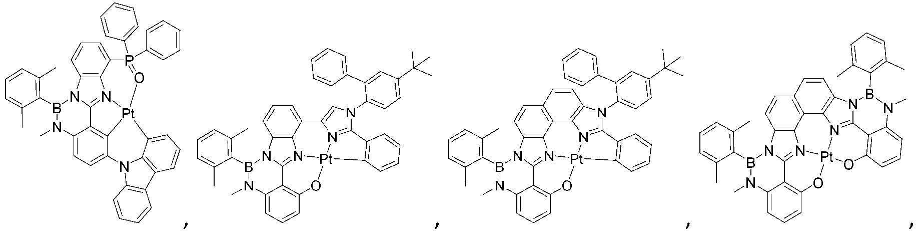 and

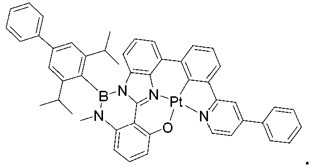

In some embodiments, L_{B} is selected from the group consisting of a substituted or unsubstituted phenylpyridine, a substituted or unsubstituted phenylimidazole, and a substituted or unsubstituted phenylbenzimidazole; and L_{C} is a substituted or unsubstituted acetylacetonate.

In some embodiments, the compound comprises an electron-withdrawing group. In some embodiments, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the compound can have the formula Ir(L_{A})₃, the formula Ir(L_{A})(L_{B*k*})₂, the formula Ir(L_{A})₂(L_{Bk}), the formula Ir(L_{A})₂(L_{C*j-I*}), the formula Ir(L_{A})₂(L_{*Cj*-*II*}), the formula Ir(L_{A})(L_{B*k*})(L*_{Cj-I}*), or the formula Ir(L_{A})(L_{B*k*})(L_{*Cj*-*II*}), wherein L_{A} is a ligand with respect to Formula I as defined here; L_{B*k*} is defined herein; and L_{*Cj*-*I*} and L*_{Cj-II}* are each defined herein.

In some embodiments, each of moiety A, moiety B, moiety E, and moiety F may be each independently selected from the group consisting of benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-anthracene, phenanthridine, fluorene, and aza-fluorene.

In some embodiments, each of moiety A, moiety B, moiety E, and moiety F can independently be a polycyclic fused ring structure. In some embodiments, each of moiety A, moiety B, moiety E, and moiety F can independently be a polycyclic fused ring structure comprising at least two fused rings. In some embodiments, the polycyclic fused ring structure has one 6-membered ring and one 5-membered ring. In some such embodiments, either the 5-membered ring or the 6-membered ring can coordinate to the metal. In some embodiments, the polycyclic fused ring structure has two 6-membered rings. In some embodiments, each of moiety A, moiety B, moiety E, and moiety F can independently be selected from the group consisting of benzofuran, benzothiophene, benzoselenophene, naphthalene, and aza-variants thereof.

In some embodiments, each of moiety A, moiety B, moiety E, and moiety F can independently be a polycyclic fused ring structure comprising at least three fused rings. In some embodiments, the polycyclic fused ring structure has two 6-membered rings and one 5-membered ring. In some such embodiments, the 5-membered ring is fused to the ring coordinated to metal M and the second 6-membered ring is fused to the 5-membered ring. In some embodiments, each of moiety A, moiety B, moiety E, and moiety F can independently be selected from the group consisting of dibenzofuran, dibenzothiophene, dibenzoselenophene, and aza-variants thereof. In some such embodiments, each of moiety A, moiety B, moiety E, and moiety F can independently be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (ortho to the O, S, or Se) with a substituent at the 7-position (meta to the O, S, or Se).

In some embodiments, each of moiety A, moiety B, moiety E, and moiety F can independently be a polycyclic fused ring structure comprising at least four fused rings. In some embodiments, the polycyclic fused ring structure comprises three 6-membered rings and one 5-membered ring. In some such embodiments, the 5-membered ring is fused to the ring coordinated to metal M, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments, each of moiety A, moiety B, moiety E, and moiety F can independently be a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to metal M, the second 6-membered ring is fused to the 5-membered ring, the third 6-membered ring is fused to the second 6-membered ring, and the fourth 6-membered ring is fused to the third 6-membered ring.

In some embodiments, each of moiety A, moiety B, moiety E, and moiety F can independently be an aza version of the polycyclic fused rings described above. In some such embodiments, each of moiety A, moiety B, moiety E, and moiety F can independently contain exactly one aza N atom. In some such embodiments, at least one of moiety A, moiety B, moiety E, and moiety F contains exactly two aza N atoms, which can be in one ring, or in two different rings. In some such embodiments, the ring having aza N atom is separated by at least two other rings from the metal M atom. In some such embodiments, the ring having aza N atom is separated by at least three other rings from the metal M atom. In some such embodiments, each of the ortho positions of the aza N atom is substituted.

In some embodiments, the compound having a first ligand L_{A} comprising Formula I described herein can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of all possible hydrogen atoms in the compound (*e.g.*, positions that are hydrogen or deuterium) that are occupied by deuterium atoms. In some embodiments, carbon atoms comprised the ring coordinated to the metal M are fully or partially deuterated. In some embodiments, carbon atoms comprised by a polycyclic ring system coordinated to the metal M are fully or partially deuterated. In some embodiments, a substituent attached to a monocyclic or fused polycyclic ring system coordinated to the metal M is fully or partially deuterated.

In some embodiments, the compound of Formula I has an emission at room temperature with a full width at half maximum (FWHM) of equal to or less than 50, 45, 40, 35, 30, 25, 20, 15, 10, or 5 nm. Narrower FWHM means better color purity for the OLED display application.

In some embodiments of heteroleptic compound having the formula of M(L_{A})ₚ(L_{B})_{q}(L_{C})ᵣ as defined above, the ligand L_{A} has a first substituent R^{I}, where the first substituent R^{I} has a first atom a-I that is the farthest away from the metal M among all atoms in the ligand L_{A}. Additionally, the ligand L_{B}, if present, has a second substituent R^{II}, where the second substituent R" has a first atom a-II that is the farthest away from the metal M among all atoms in the ligand L_{B}. Furthermore, the ligand L_{C}, if present, has a third substituent R^{III}, where the third substituent R^{III} has a first atom a-III that is the farthest away from the metal M among all atoms in the ligand L_{C}.

In such heteroleptic compounds, vectors V_{D1}, V_{D2}, and V_{D3} can be defined as follows. V_{D1} represents the direction from the metal M to the first atom a-I and the vector V_{D1} has a value D¹ that represents the straight line distance between the metal M and the first atom a-I in the first substituent R^{I}. V_{D2} represents the direction from the metal M to the first atom a-II and the vector V_{D2} has a value D² that represents the straight line distance between the metal M and the first atom a-II in the second substituent R^{II}. V_{D3} represents the direction from the metal M to the first atom a-III and the vector V_{D3} has a value D³ that represents the straight line distance between the metal M and the first atom a-III in the third substituent R^{III}.

In such heteroleptic compounds, a sphere having a radius *r* is defined whose center is the metal M and the radius *r* is the smallest radius that will allow the sphere to enclose all atoms in the compound that are not part of the substituents R^{I}, R^{II} and R^{III}; and where at least one of D¹, D², and D³ is greater than the radius *r* by at least 1.5 Å. In some embodiments, at least one of D¹, D², and D³ is greater than the radius *r* by at least 2.9, 3.0, 4.3, 4.4, 5.2, 5.9, 7.3, 8.8, 10.3, 13.1, 17.6, or 19.1 Å. In some embodiments, at least two of D¹, D², and D³ is greater than the radius *r* by at least 1.5, 2.9, 3.0, 4.3, 4.4, 5.2, 5.9, 7.3, 8.8, 10.3, 13.1, 17.6, or 19.1 Å.

In some embodiments of such heteroleptic compound, the compound has a transition dipole moment axis and angles are defined between the transition dipole moment axis and the vectors V_{D1}, V_{D2}, and V_{D3}, where at least one of the angles between the transition dipole moment axis and the vectors V_{D1}, V_{D2}, and V_{D3} is less than 40°. In some embodiments, at least one of the angles between the transition dipole moment axis and the vectors V_{D1}, V_{D2}, and V_{D3} is less than 30°, 20°, 15°, or 10°. In some embodiments, at least two of the angles between the transition dipole moment axis and the vectors V_{D1}, V_{D2}, and V_{D3} are less than 20°. In some embodiments, at least two of the angles between the transition dipole moment axis and the vectors V_{D1}, V_{D2}, and V_{D3} are less than 15° or 10°.

In some embodiments, all three angles between the transition dipole moment axis and the vectors V_{D1}, V_{D2}, and V_{D3} are less than 20°. In some embodiments, all three angles between the transition dipole moment axis and the vectors V_{D1}, V_{D2}, and V_{D3} are less than 15° or 10°.

In some embodiments of such heteroleptic compounds, the compound has a vertical dipole ratio (VDR) of 0.33 or less. In some embodiments of such heteroleptic compounds, the compound has a VDR of 0.30, 0.25, 0.20, or 0.15 or less.

One of ordinary skill in the art would readily understand the meaning of the terms transition dipole moment axis of a compound and vertical dipole ratio of a compound. Nevertheless, the meaning of these terms can be found in U.S. pat. No. 10,672,997 whose disclosure is incorporated herein by reference in its entirety. In U.S. pat. No. 10,672,997, horizontal dipole ratio (HDR) of a compound, rather than VDR, is discussed. However, one skilled in the art readily understands that VDR = 1 - HDR.

In some embodiments, the compound can be an emissive dopant. In some embodiments, the compound can produce emissions via phosphorescence, fluorescence, thermally activated delayed fluorescence, triplet-triplet annihilation, or combinations of these processes. In some embodiments, the emissive dopant can be a racemic mixture, or can be enriched in one enantiomer. In some embodiments, the present compounds can have different stereoisomers, such as *fac* and *mer.* The current compound relates both to individual isomers and to mixtures of various isomers in any mixing ratio. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from every other ligand. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In yet another aspect of the present disclosure, a composition that comprises the novel compound disclosed herein is described. The composition can include one or more components selected from the group consisting of a solvent, an emitter, a host, a hole injection material, hole transport material, electron blocking material, hole blocking material, and an electron transport material, disclosed herein.

The present disclosure encompasses any chemical structure comprising the novel compound of the present disclosure, or a neutral molecular form thereof, or a monovalent or polyvalent form thereof, or a monomeric or polymeric form thereof, or a macromolecular or supramolecular form thereof; wherein the compound has a first ligand L_{A} of Formula I described herein. In yet another aspect, the present disclosure also provides a composition of a compound of Formula I, wherein the compound of Formula I comprises its neutral molecular form, its monovalent or polyvalent form, or its monomeric or polymeric form, or its macromolecular or supramolecular form; and wherein the compound has a first ligand L_{A} of Formula I described herein. As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds. As used in this context, the description that a structure A comprises a moiety B means that the structure A includes the structure of moiety B not including the H or D atoms that can be attached to the moiety B. This is because at least one H or D on a given moiety structure has to be replaced to become a substituent so that the moiety B can be part of the structure A, and one or more of the H or D on a given moiety B structure can be further substituted once it becomes a part of structure A.

In some embodiments, at least one of R, R', R^{α}, R^{β}, R^{A}, R^{B}, R^{C}, R^{D}, R^{E}, or R^{F} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{D} is partially or fully deuterated. In some embodiments, at least one R^{E} is partially or fully deuterated. In some embodiments, at least one R^{F} is partially or fully deuterated. In some embodiments, at least one of R or R' is partially or fully deuterated. In some embodiments, at least one of R^{α} or R^{β} is partially or fully deuterated.

In some embodiments, at least one of R, R', R^{α}, R^{β}, R^{A}, R^{B}, R^{C}, R^{D}, R^{E}, or R^{F} is a substituent selected from the group consisting of the General Substituents defined herein. In some embodiments, at least one of R or R' is selected from the group consisting of the General Substituents defined herein. In some embodiments, at least one of R^{α} or R^{β} is selected from the group consisting of the General Substituents defined herein. In some embodiments, at least one R^{A} is selected from the group consisting of the General Substituents defined herein. In some embodiments, at least one R^{B} is selected from the group consisting of the General Substituents defined herein. In some embodiments, at least one R^{C} is selected from the group consisting of the General Substituents defined herein. In some embodiments, at least one R^{D} is selected from the group consisting of the General Substituents defined herein. In some embodiments, at least one R^{E} is selected from the group consisting of the General Substituents defined herein. In some embodiments, at least one R^{F} is selected from the group consisting of the General Substituents defined herein.

In some embodiments, at least one of R, R', R^{α}, R^{β}, R^{A}, R^{B}, R^{C}, R^{D}, R^{E}, or R^{F} is a substituent selected from the group consisting of the Preferred General Substituents defined herein. In some embodiments, at least one of R or R' is selected from the group consisting of the Preferred General Substituents defined herein. In some embodiments, at least one of R^{α} or R^{β} is selected from the group consisting of the Preferred General Substituents defined herein. In some embodiments, at least one R^{A} is selected from the group consisting of the Preferred General Substituents defined herein. In some embodiments, at least one R^{B} is selected from the group consisting of the Preferred General Substituents defined herein. In some embodiments, at least one R^{C} is selected from the group consisting of the Preferred General Substituents defined herein. In some embodiments, at least one R^{D} is selected from the group consisting of the Preferred General Substituents defined herein. In some embodiments, at least one R^{E} is selected from the group consisting of the Preferred General Substituents defined herein. In some embodiments, at least one R^{F} is selected from the group consisting of the Preferred General Substituents defined herein.

### C. The OLEDs and the Devices of the Present Disclosure

In another aspect, the present disclosure also provides an OLED device comprising a first organic layer that contains a compound as disclosed in the above compounds section of the present disclosure.

In some embodiments, the OLED comprises: an anode; a cathode; and an organic layer disposed between the anode and the cathode, where the organic layer comprises a compound as described herein.

In some embodiments, the organic layer is selected from the group consisting of HIL, HTL, EBL, EML, HBL, ETL, and EIL. In some embodiments, the organic layer may be an emissive layer and the compound as described herein may be an emissive dopant or a non-emissive dopant. In some embodiments, the emissive layer further optionally comprises a dopant selected from the group consisting of delayed-fluorescent, and non-delayed fluorescent.

In some embodiments, the organic layer may further comprise a host, wherein host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the host can be selected from the group consisting of the structures of the following HOST Group 1: 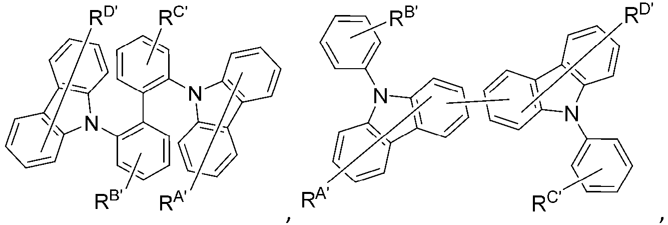 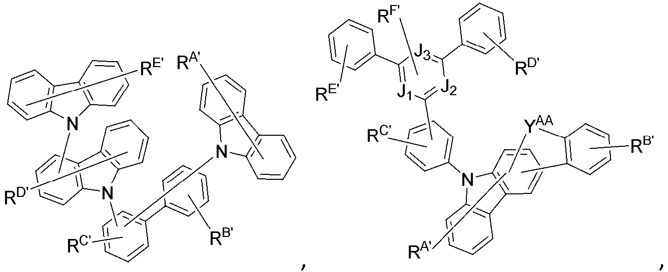 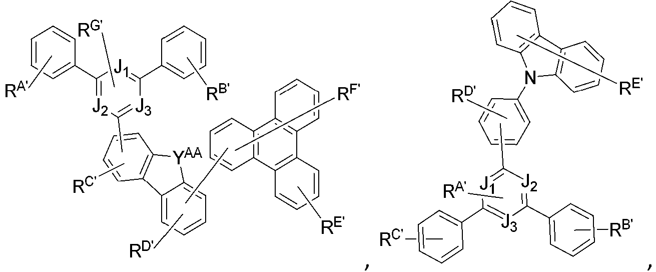 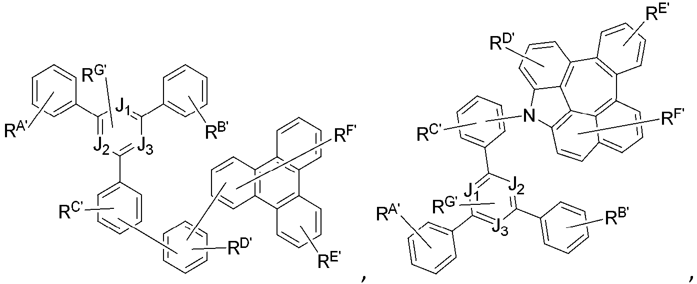 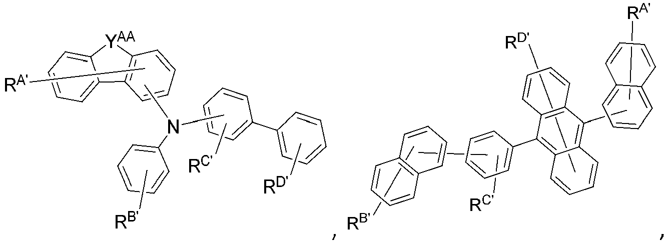 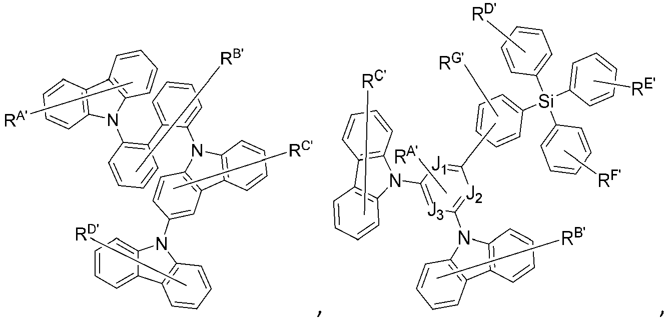 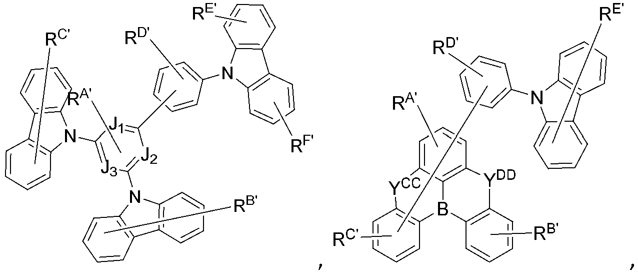 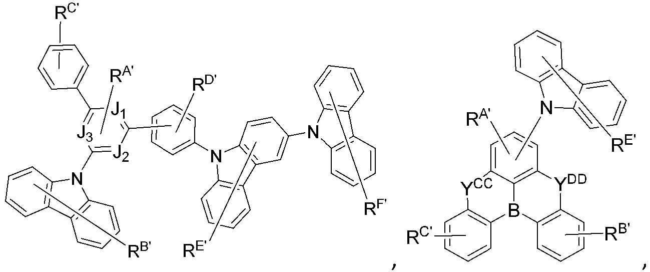 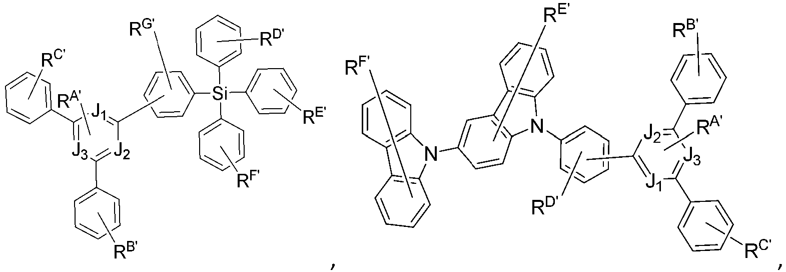 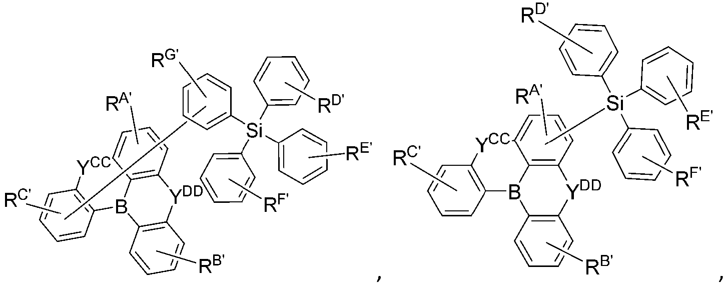 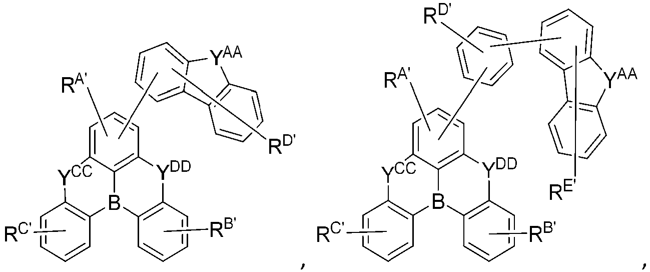 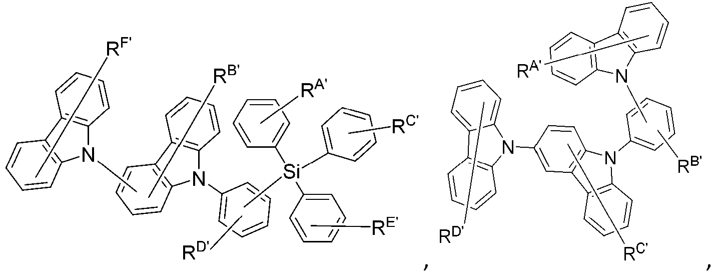 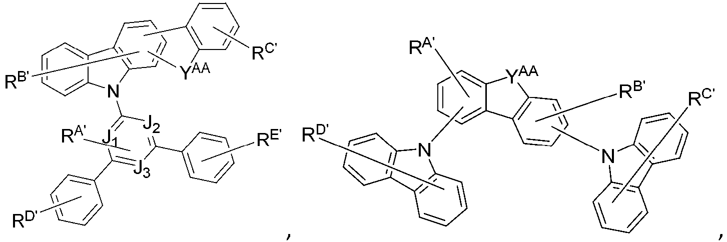 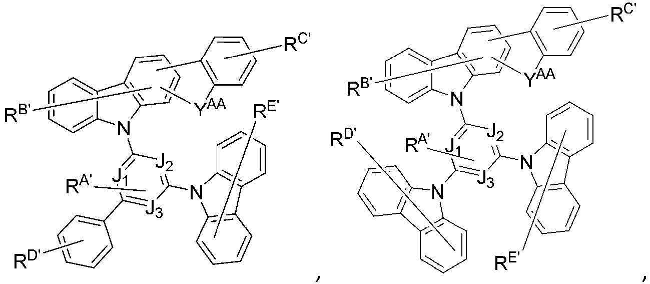 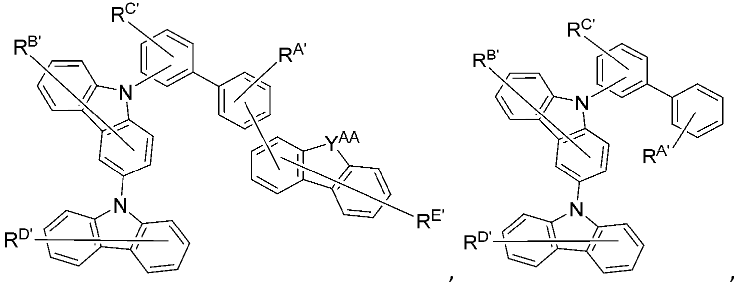 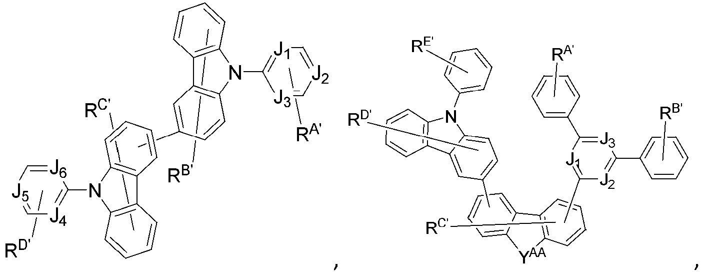 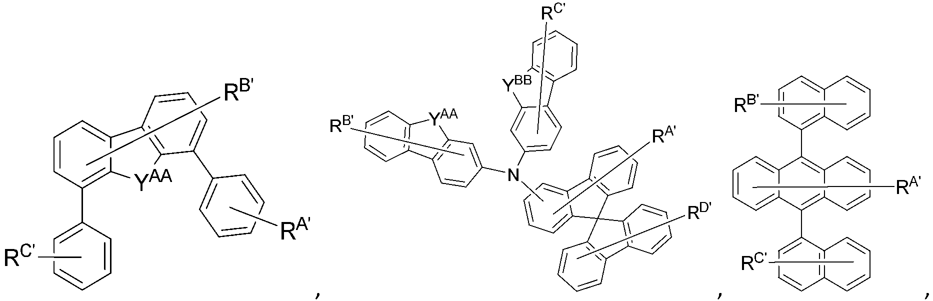 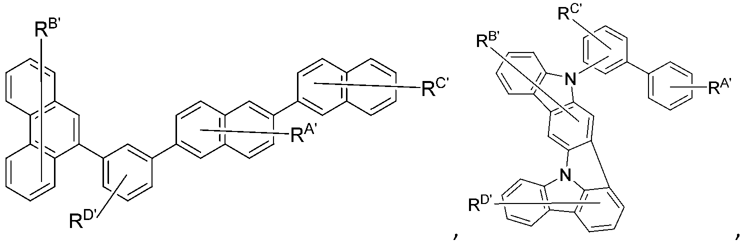 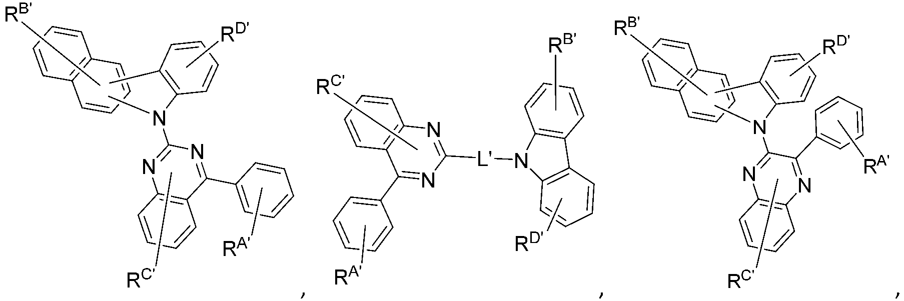 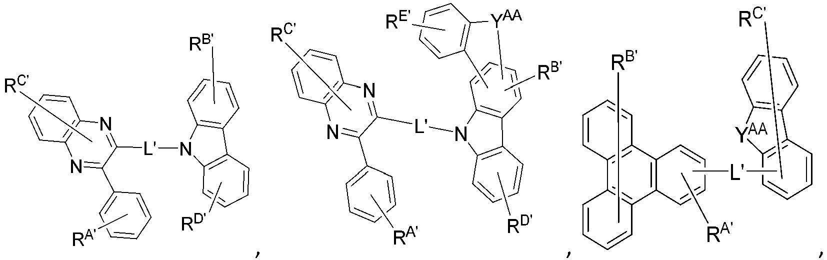 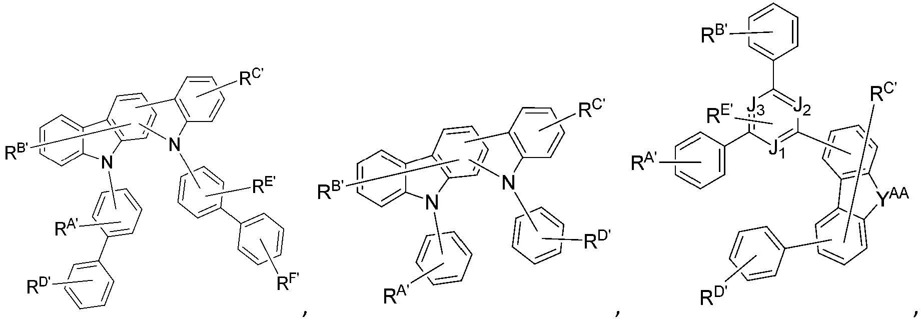 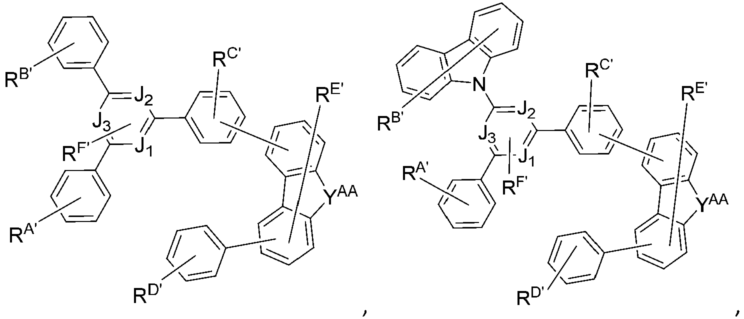 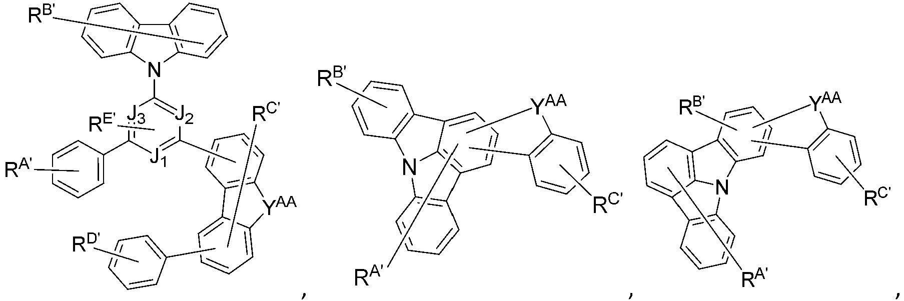 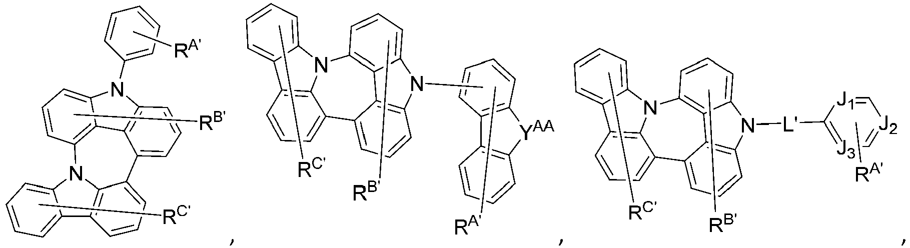 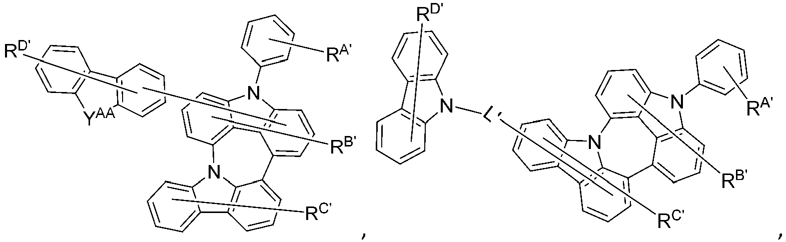 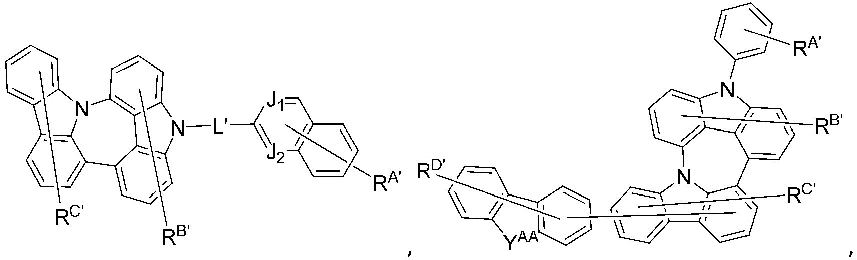 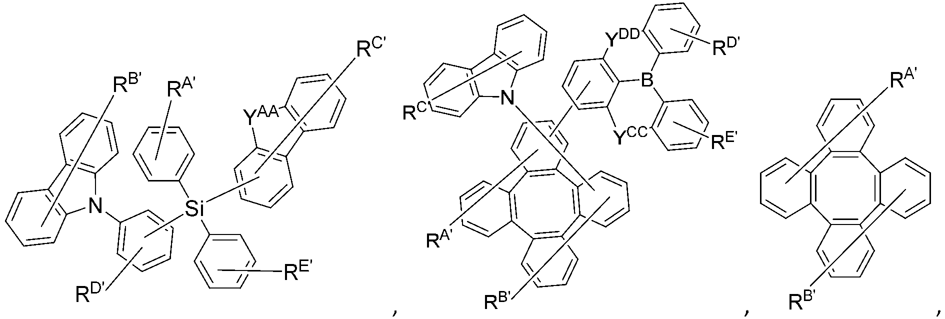 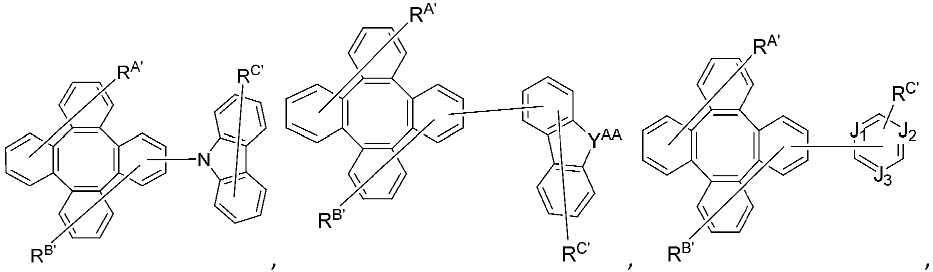 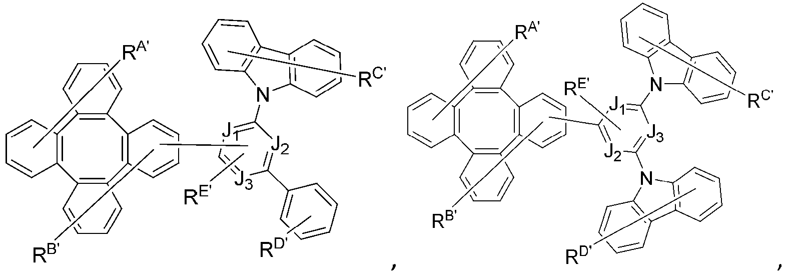 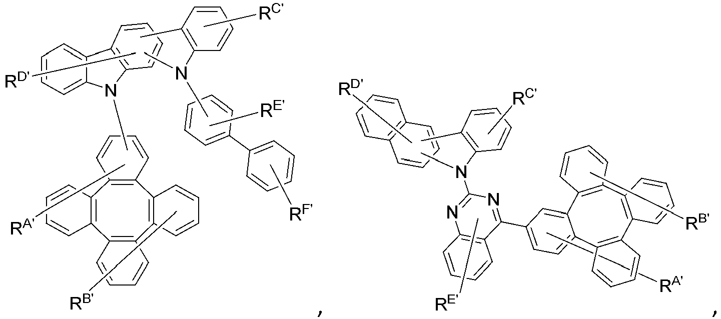 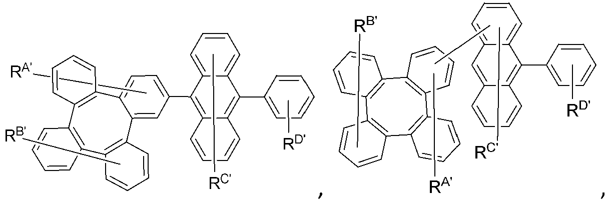 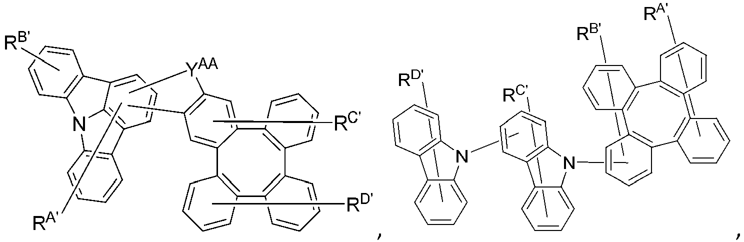 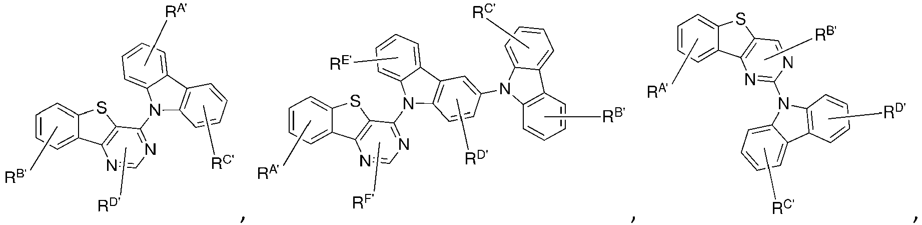 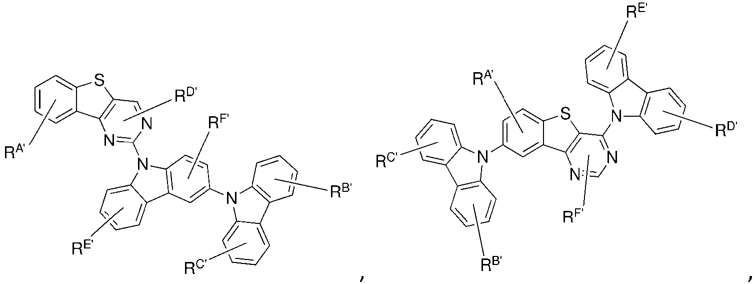 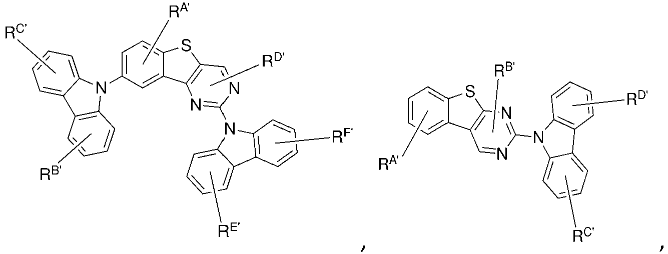 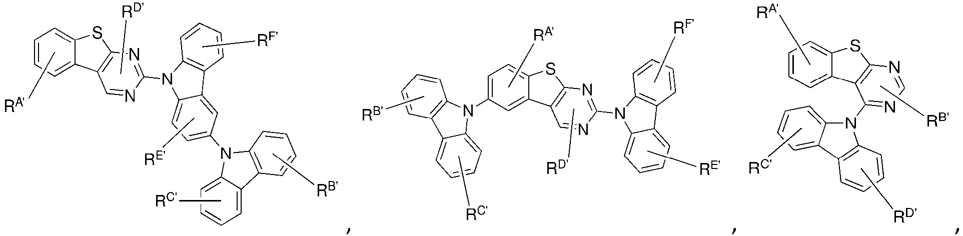 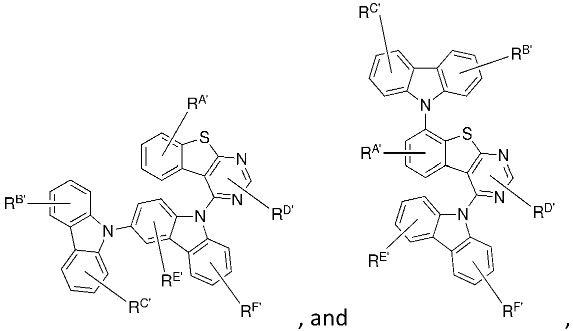 wherein:
each of J₁ to J₆ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A',} R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen, or a substituent selected from the group consisting of the General Substituents as defined herein; any two substituents can be joined or fused to form a ring;
and where possible, each unsubstituted aromatic carbon atom can be replaced with one or more N to form an aza-substituted ring.

In some embodiments at least one of J₁ to J₃ is N. In some embodiments at least two of J₁ to J₃ are N. In some embodiments, all three of J₁ to J₃ are N. In some embodiments, each Y^{CC} and Y^{DD} is independently O, S, or SiRR', or more preferably O or S. In some embodiments, at least one unsubstituted aromatic carbon atom is replaced with N to form an aza-ring.

In some embodiments, the host is selected from the group consisting of EG*1*-MG*1*-EG*1* to EG*53*-MG*27*-EG*53* with a formula of EG*a*-MG*b*-EG*c*, or EG*1*-EG*1* to EG*53*-EG*53* with a formula of EG*a*-EG*c* when MG*b* is absent, wherein *a* is an integer from 1 to 53, *b* is an integer from 1 to 27, *c* is an integer from 1 to 53. The structure of EG1 to EG53 is shown below:

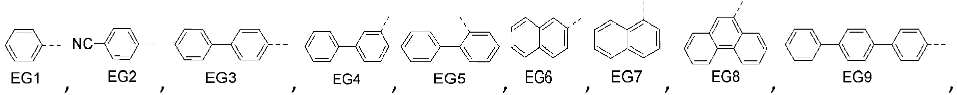

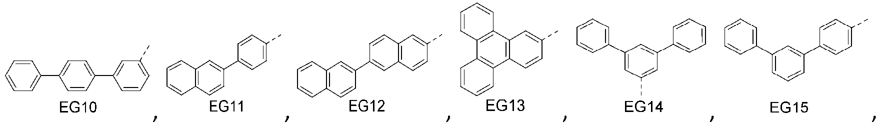

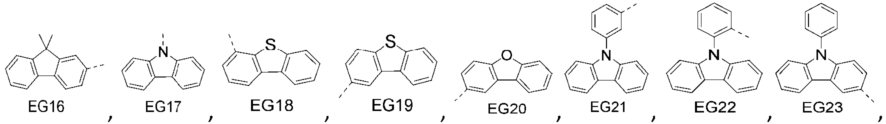

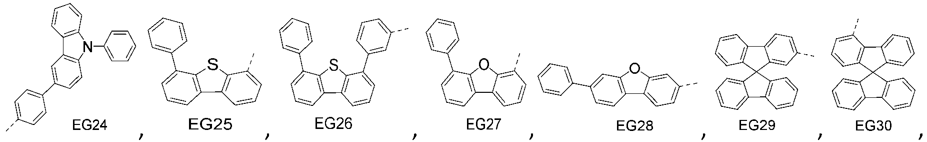

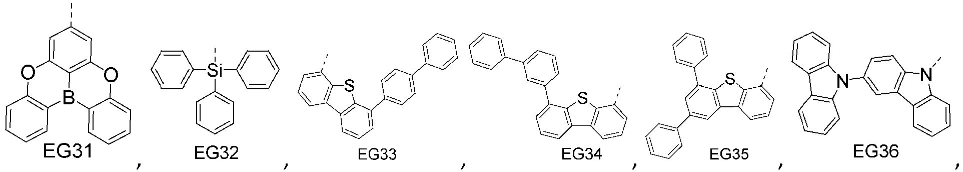

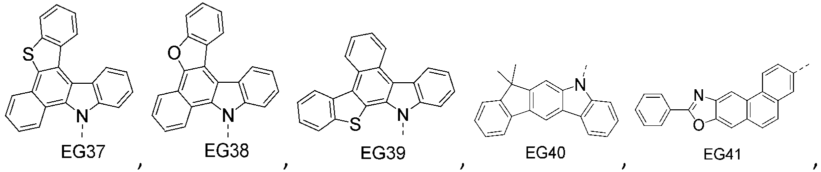

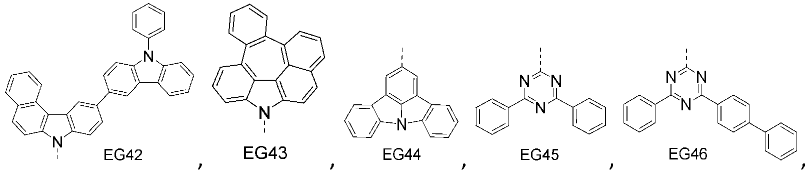

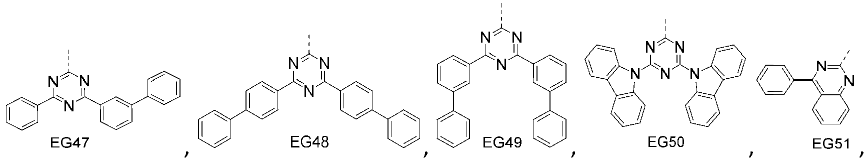

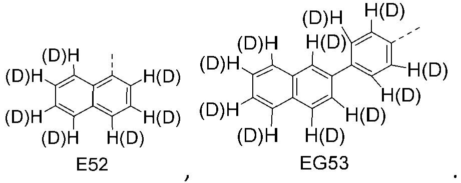

The structures of MG1 to MG27 are shown below: 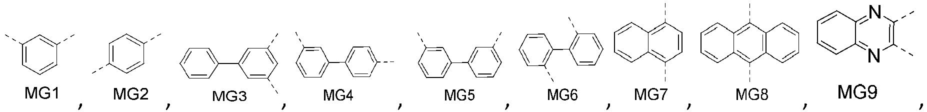 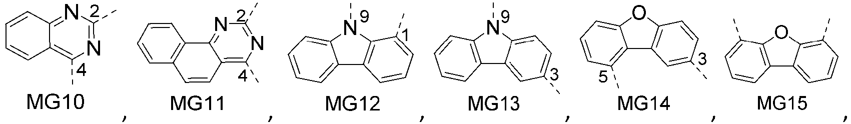 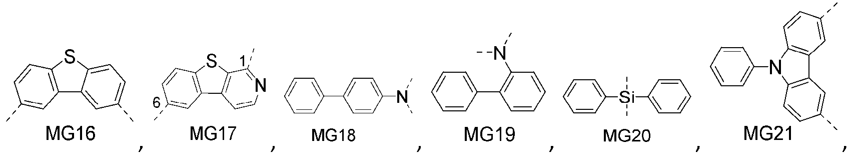 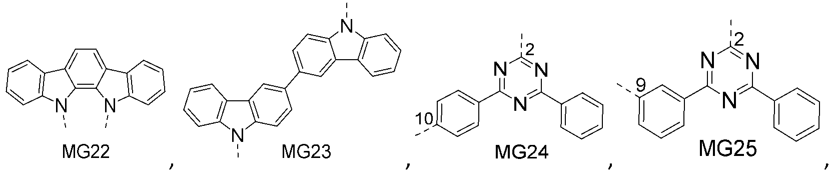 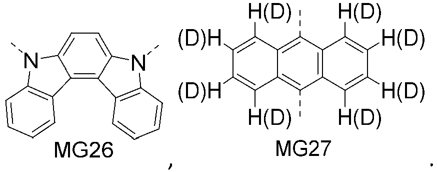 In the MG*b* structures shown above, the two bonding positions in the asymmetric structures MG10, MG11, MG12, MG13, MG14, MG17, MG24, and MG25 are labeled with numbers for identification purposes.

In some embodiments, the host can be any of the aza-substituted variants thereof, fully or partially deuterated variants thereof, and combinations thereof. In some embodiments, the host has formula EGa-MGb-Egc and is selected from the group consisting of *h1* to *h112* defined in the following HOST Group 2 list, where each of MG*b*, EG*a*, and EGc are defined as follows:

| ***h*** | **MG*b*** | **EG*a*** | **EGc** | ***h*** | **MG*b*** | **EG*a*** | **EG*c*** | ***h*** | **MG*b*** | **EG*a*** | **EG*c*** |
|---|---|---|---|---|---|---|---|---|---|---|---|
| ***h1*** | MG1 | EG3 | EG36 | ***h3*** | MG1 | *3*- | *9-*EG4 | ***h77*** | MG2 | EG3 | EG4 |
| ***h2*** | MG1 | EG8 | EG12 | ***h4*** | MG1 | *3*- | *9*- | ***h78*** | MG2 | EG3 | EG5 |
| ***h3*** | MG1 | EG13 | EG14 | ***h4*** | MG1 | *3*- | *9*- | ***h79*** | MG2 | EG4 | EG4 |
| ***h4*** | MG1 | EG13 | EG18 | ***h4*** | MG1 | *3*- | *9*- | ***h80*** | MG2 | EG4 | EG5 |
| ***h5*** | MG1 | EG13 | EG25 | ***h4*** | MG1 | *3*- | *9*- | ***h81*** | MG2 | *2*-EG1 | *10-* |
| ***h6*** | MG1 | EG13 | EG36 | ***h4*** | MG1 | *3*- | *9*- | ***h82*** | MG2 | *2*-EG4 | *10*- |
| ***h7*** | MG1 | EG22 | EG36 | ***h4*** | MG1 | *3*- | *9*- | ***h83*** | MG2 | *2*- | *10*- |
| ***h8*** | MG1 | EG25 | EG46 | ***h4*** | MG1 | *3*- | *9-* | ***h84*** | MG2 | *2*- | *10*- |
| ***h9*** | MG1 | EG27 | EG46 | ***h4*** | MG1 | *3*- | *9*-EG3 | ***h85*** | MG2 | *2*-EG1 | *9*-EG33 |
| ***h10*** | MG1 | EG27 | EG48 | ***h4*** | MG1 | *3-* | *5*- | ***h86*** | MG2 | *2*-EG3 | *9*-EG36 |
| ***h11*** | MG1 | EG32 | EG50 | ***h4*** | MG1 | *3*- | *5*- | ***h87*** | MG2 | *2*-EG4 | *9*-EG36 |
| ***h12*** | MG1 | EG35 | EG46 | ***h5*** | MG1 | EG3 | EG48 | ***h88*** | MG2 | *2*- | *9*-EG27 |
| ***h13*** | MG1 | EG36 | EG45 | ***h5*** | MG1 | EG17 | EG31 | ***h89*** | MG2 | *2*- | *9*-EG36 |
| ***h14*** | MG1 | EG36 | EG49 | ***h5*** | MG1 | EG31 | EG36 | ***h90*** | MG2 | *2*- | *9*-EG36 |
| ***h15*** | MG1 | EG40 | EG45 | ***h5*** | MG1 | EG17 | EG17 | ***h91*** | MG2 | *2*- | *9*-EG27 |
| ***h16*** | MG2 | EG3 | EG36 | ***h5*** | MG1 | EG17 | EG17 | ***h92*** | MG2 | *2*- | *9*-EG36 |
| ***h17*** | MG2 | EG25 | EG31 | ***h5*** | MG1 | EG16 | EG24 | ***h93*** | MG2 | EG1 | EG9 |
| ***h18*** | MG2 | EG31 | EG33 | ***h5*** | MG1 | EG16 | EG30 | ***h94*** | MG2 | EG1 | EG10 |
| ***h19*** | MG2 | EG36 | EG45 | ***h5*** | MG1 | EG20 | EG41 | ***h95*** | MG2 | EG1 | EG21 |
| ***h20*** | MG2 | EG36 | EG46 | ***h5*** | MG1 | EG16 | EG29 | ***h96*** | MG2 | EG1 | EG23 |
| ***h21*** | MG3 | EG4 | EG36 | ***h5*** | MG2 | EG1 | EG31 | ***h97*** | MG2 | EG1 | EG26 |
| ***h22*** | MG3 | EG34 | EG45 | ***h6*** | MG2 | EG17 | EG18 | ***h98*** | MG2 | EG3 | EG3 |
| ***h23*** | MG4 | EG13 | EG17 | ***h6*** | MG2 | EG23 | EG23 | ***h99*** | MG2 | EG3 | EG9 |
| ***h24*** | MG5 | EG13 | EG45 | ***h6*** | MG2 | EG1 | EG45 | ***h10*** | MG2 | EG3 | EG23 |
| ***h25*** | MG5 | EG17 | EG36 | ***h6*** | MG2 | EG1 | EG46 | ***h10*** | MG2 | EG3 | EG26 |
| ***h26*** | MG5 | EG18 | EG36 | ***h6*** | MG2 | EG3 | EG46 | ***h10*** | MG2 | EG4 | EG10 |
| ***h27*** | MG6 | EG17 | EG17 | ***h6*** | MG2 | EG4 | EG46 | ***h10*** | MG2 | EG5 | EG10 |
| ***h28*** | MG7 | EG43 | EG45 | ***h6*** | MG2 | EG4 | EG47 | ***h10*** | MG2 | EG6 | EG10 |
| ***h29*** | MG8 | EG1 | EG28 | ***h6*** | MG2 | EG9 | EG45 | ***h10*** | MG2 | EG10 | EG10 |
| ***h30*** | MG8 | EG6 | EG7 | ***h6*** | MG2 | EG1 | EG3 | ***h10*** | MG2 | EG10 | EG14 |
| ***h31*** | MG8 | EG7 | EG7 | ***h6*** | MG2 | EG1 | EG6 | ***h10*** | MG2 | EG10 | EG15 |
| ***h32*** | MG8 | EG7 | EG11 | ***h7*** | MG2 | EG1 | EG14 | ***h10*** | MG2 | EG52 | EG53 |
| ***h33*** | MG9 | EG1 | EG43 | ***h7*** | MG2 | EG1 | EG18 | ***h10*** | - | EG13 | EG18 |
| ***h34*** | MG1 | *4*-EG1 | *2*- | ***h7*** | MG2 | EG1 | EG19 | ***h11*** | - | EG17 | EG31 |
| ***h35*** | MG1 | *4*-EG1 | *2*- | ***h7*** | MG2 | EG1 | EG23 | ***h11*** | - | EG17 | EG50 |
| ***h36*** | MG1 | EG1 | EG42 | ***h7*** | MG2 | EG1 | EG51 | ***h11*** | - | EG40 | EG45 |
| ***h37*** | MG1 | *4*-EG1 | *2*- | ***h7*** | MG2 | EG2 | EG18 | | | | |
| ***h38*** | MG1 | *1*- | *9*- | ***h7*** | MG2 | EG3 | EG3 | | | | |

In the table above, the EG*a* and EGc structures that are bonded to one of the asymmetric structures MG10, MG11, MG12, MG13, MG14, MG17, MG24, and MG25, are noted with a numeric prefix identifying their bonding position in the MG*b* structure.

In some embodiments, the organic layer may further comprise a host, wherein the host comprises a metal complex.

In some embodiments, the emissive layer can comprise two hosts, a first host and a second host. In some embodiments, the first host is a hole transporting host, and the second host is an electron transporting host. In some embodiments, the first host is a hole transporting host, and the second host is a bipolar host. In some embodiments, the first host is an electron transporting host, and the second host is a bipolar host. In some embodiments, the first host and the second host can form an exciplex. In some embodiments, the emissive layer can comprise a third host. In some embodiments, the third host is selected from the group consisting of an insulating host (wide band gap host), a hole transporting host, and an electron transporting host. In some embodiments, the third host forms an exciplex with one of the first host and the second host, or with both the first host and the second host. In some embodiments, the emissive layer can comprise a fourth host. In some embodiments, the fourth host is selected from the group consisting of an insulating host (wide band gap host), a hole transporting host, and an electron transporting host. In some embodiments, the fourth host forms an exciplex with one of the first host, the second host, and the third host, with two of the first host, the second host, and the third host, or with each of the first host, the second host, and the third host. In some embodiments, the electron transporting host has a LUMO less than -2.4 eV, less than -2.5 eV, less than -2.6 eV, or less than -2.7 eV. In some embodiments, the hole transporting host has a HOMO higher than -5.6 eV, higher than -5.5 eV, higher than -5.4 eV, or higher than -5.35 eV. The HOMO and LUMO values can be determined using solution electrochemistry. Solution cyclic voltammetry and differential pulsed voltammetry can be performed using a CH Instruments model 6201B potentiostat using anhydrous dimethylformamide (DMF) solvent and tetrabutylammonium hexafluorophosphate as the supporting electrolyte. Glassy carbon, platinum wire, and silver wire were used as the working, counter and reference electrodes, respectively. Electrochemical potentials can be referenced to an internal ferrocene-ferroconium redox couple (Fc/Fc+) by measuring the peak potential differences from differential pulsed voltammetry. The corresponding highest occupied molecular orbital (HOMO) and lowest unoccupied molecular orbital (LUMO) energies can be determined by referencing the cationic and anionic redox potentials to ferrocene (4.8 eV vs. vacuum) according to literature ((a) Fink, R.; Heischkel, Y.; Thelakkat, M.; Schmidt, H.-W. Chem. Mater. 1998, 10, 3620-3625. (b) Pommerehne, J.; Vestweber, H.; Guss, W.; Mahrt, R. F.; Bassler, H.; Porsch, M.; Daub, J. Adv. Mater. 1995, 7, 551).

In some embodiments, the compound as described herein may be a sensitizer or a component of a sensitizer; wherein the device may further comprise an acceptor that receives the energy from the sensitizer. In some embodiments, the acceptor is an emitter in the device. In some embodiments, the acceptor may be a fluorescent material. In some embodiments, the compound described herein can be used as a phosphorescent sensitizer in an OLED where one or multiple layers in the OLED contain an acceptor in the form of one or more non-delayed fluorescent and/or delayed fluorescence material. In some embodiments, the compound described herein can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 99.9%. The acceptor could be in either the same layer as the phosphorescent sensitizer or in one or more different layers. In some embodiments, the acceptor is a thermally activated delayed fluorescence (TADF) material. In some embodiments, the acceptor is a non-delayed fluorescent material. In some embodiments, the emission can arise from any or all of the sensitizer, acceptor, and final emitter. In some embodiments, the acceptor has an emission at room temperature with a full width at half maximum (FWHM) of equal to or less than 50, 45, 40, 35, 30, 25, 20, 15, 10, or 5 nm. Narrower FWHM means better color purity for the OLED display application.

As used herein, phosphorescence generally refers to emission of a photon with a change in electron spin quantum number, i.e., the initial and final states of the emission have different electron spin quantum numbers, such as from T1 to S0 state. Most of the Ir and Pt complexes currently used in OLED are phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S1 to S0 state, or from D1 to D0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as TADF. E-type delayed fluorescence characteristics can be found in an exciplex system or in a single compound. Without being bound by theory, it is believed that TADF emissions require a compound or an exciplex having a small singlet-triplet energy gap (ΔE_{S-T}) less than or equal to 400, 350, 300, 250, 200, 150, 100, or 50 meV. There are two major types of TADF emitters, one is called donor-acceptor type TADF, the other one is called multiple resonance (MR) TADF. Often, single compound donor-acceptor TADF compounds are constructed by connecting an electron donor moiety such as amino- or carbazole-derivatives and an electron acceptor moiety such as N-containing six-membered aromatic rings or cyano-substituted aromatic rings. Donor-acceptor exciplexes can be formed between a hole transporting compound and an electron transporting compound. Examples of MR-TADF materials include highly conjugated fused ring systems. In some embodiments, MR-TADF materials comprises boron, carbon, and nitrogen atoms. Such materials may comprise other atoms, such as oxygen, as well. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, the OLED may comprise an additional compound selected from the group consisting of a non-delayed fluorescence material, a delayed fluorescence material, a phosphorescent material, and combination thereof.

In some embodiments, the inventive compound described herein is a phosphorescent material.

In some embodiments, the phosphorescent material is an emitter which emits light within the OLED. In some embodiments, the phosphorescent material does not emit light within the OLED. In some embodiments, the phosphorescent material energy transfers its excited state to another material within the OLED. In some embodiments, the phosphorescent material participates in charge transport within the OLED. In some embodiments, the phosphorescent material is a sensitizer or a component of a sensitizer, and the OLED further comprises an acceptor. In some embodiments, the phosphorescent material forms an exciplex with another material within the OLED, for example a host material, an emitter material.

In some embodiments, the non-delayed fluorescence material or the delayed fluorescence material is an emitter which emits light within the OLED. In some embodiments, the non-delayed fluorescence material or the delayed fluorescence material does not emit light within the OLED. In some embodiments, the non-delayed fluorescence material or the delayed fluorescence material energy transfers its excited state to another material within the OLED. In some embodiments, the non-delayed fluorescence material or the delayed fluorescence material participates in charge transport within the OLED. In some embodiments, the non-delayed fluorescence material or the delayed fluorescence material is an acceptor, and the OLED further comprises a sensitizer.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Pt, Pd, Zn, Cu, Ag, or Au complex (some of them are also called metal-assisted (MA) TADF). In some embodiments, the metal-assisted delayed fluorescence material comprises a metal-carbene bond. In some embodiments, the non-delayed fluorescence material or delayed fluorescence material comprises at least one chemical group selected from the group consisting of aryl-amine, aryloxy, arylthio, triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, 5λ²,9λ²-diaza-13b-boranaphtho[2,3,4-de]anthracene, 5-oxa-9λ²-aza-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, amino, silyl, aza-variants thereof, and combinations thereof. In some embodiments, non-delayed the fluorescence material or delayed fluorescence material comprises a tri(aryl/heteroaryl)borane with one or more pairs of the substituents from the aryl/heteroaryl being joined to form a ring. In some embodiments, the fluorescence material comprises at least one chemical group selected from the group consisting of naphthalene, anthracene, phenalene, phenanthrene, fluorene, pyrene, chrysene, perylene, and azulene.

In yet another aspect, the OLED of the present disclosure may also comprise an emissive region containing a compound or a composition of the compound as disclosed in the above compounds section of the present disclosure. In some embodiments, the emissive region can comprise a compound or a composition of the compound as described herein. In some embodiments, the emissive region consists of one or more organic layers, wherein at least one of the one or more organic layers has a minimum thickness selected from the group consisting of 350, 400, 450, 500, 550, 600, 650 and 700 Å. In some embodiments, the at least one of the one or more organic layers are formed from an Emissive System that has a figure of merit (FOM) value equal to or larger than the number selected from the group consisting of 2.50, 2.55, 2.60, 2.65, 2.70, 2.75, 2.80, 2.85, 2.90, 2.95, 3.00, 5.00, 10.0, 15.0, and 20.0. The definition of FOM is available in U.S. patent Application Publication No. 2023/0292605, and its entire contents are incorporated herein by reference. In some embodiments, the at least one of the one or more organic layers comprises a compound or a composition of the compound as disclosed in Sections A and D of the present disclosure.

In some embodiments, the OLED or the emissive region comprising the inventive compound disclosed herein can be incorporated into a full-color pixel arrangement of a device. The full-color pixel arrangement of such a device comprises at least one pixel, wherein the at least one pixel comprises a first subpixel and a second subpixel. The first subpixel includes a first OLED comprising a first emissive region. The second subpixel includes a second OLED comprising a second emissive region. In some embodiments, the first and/or second OLED, the first and/or second emissive region can be the same or different and each can independently have the various device characteristics and the various embodiments of the inventive compounds included therein, and various combinations and subcombinations of the various device characteristics and the various embodiments of the inventive compounds included therein, as disclosed herein.

In some embodiments, the first emissive region is configured to emit a light having a peak wavelength λₘₐₓ₁; the second emissive region is configured to emit a light having a peak wavelength λₘₐₓ₂. In some embodiments, the difference between the peak wavelengths λₘₐₓ₁ and λₘₐₓ₂ is at least 4 nm but within the same color. For example, a light blue and a deep blue light as described above. In some embodiments, a first emissive region is configured to emit a light having a peak wavelength λₘₐₓ₁ in one region of the visible spectrum of 400-500 nm, 500-600 nm, 600-700 nm; and a second emissive region is configured to emit light having a peak wavelength λₘₐₓ₂ in one of the remaining regions of the visible spectrum of 400-500 nm, 500-600 nm, 600-700 nm. In some embodiments, the first emissive region comprises a first number of emissive layers that are deposited one over the other if more than one; and the second emissive region comprises a second number of emissive layers that is deposited one over the other if more than one; and the first number is different from the second number. In some embodiments, both the first emissive region and the second emissive region comprise a phosphorescent material, which may be the same or different. In some embodiments, the first emissive region comprises a phosphorescent material, while the second emissive region comprises a fluorescent material. In some embodiments, both the first emissive region and the second emissive region comprise a fluorescent material, which may be the same or different.

In some embodiments, the at least one pixel of the OLED or emissive regions includes a total of N subpixels; wherein the N subpixels comprises the first subpixel and the second subpixel; wherein each of the N subpixels comprises an emissive region; wherein the total number of the emissive regions within the at least one pixel is equal to or less than N-1. In some embodiments, the second emissive region is exactly the same as the first emissive region; and each subpixel of the at least one pixel comprises the same one emissive region as the first emissive region. In some embodiments, the full-color pixel arrangements can have a plurality of pixels comprising a first pixel region and a second pixel region; wherein at least one display characteristic in the first pixel region is different from the corresponding display characteristic of the second pixel region, and wherein the at least one display characteristic is selected from the group consisting of resolution, cavity mode, color, outcoupling, and color filter.

In some embodiments, the OLED is a stacked OLED comprising one or more charge generation layers (CGLs). In some embodiments, the OLED comprises a first electrode, a first emissive region disposed over the first electrode, a first CGL disposed over the first emissive region, a second emissive region disposed over the first CGL, and a second electrode disposed over the second emissive region. In some embodiments, the first and/or the second emissive regions can have the various device characteristics as described above for the pixelated device. In some embodiments, the stacked OLED is configured to emit white color. In some embodiments, one or more of the emissive regions in a pixelated or in a stacked OLED comprises a sensitizer and an acceptor with the various sensitizing device characteristics and the various embodiments of the inventive compounds disclosed herein. For example, the first emissive region is comprised in a sensitizing device, while the second emissive region is not comprised in a sensitizing device; in some instances, both the first and the second emissive regions are comprised in sensitizing devices.

In some embodiments, the OLED can emit light having at least 1%, 5%, 10%, 30%, 50%, 70%, 80%, 90%, 95%, 99%, or 100% from the plasmonic mode. In some embodiments, at least one of the anode, the cathode, or a new layer disposed next to the anode or cathode functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. In some embodiments, the enhancement layer is provided no more than a threshold distance away from the organic emissive layer, wherein the emitter material has a total non-radiative decay rate constant and a total radiative decay rate constant due to the presence of the enhancement layer. A threshold distance is where the total non-radiative decay rate constant is equal to the total radiative decay rate constant. Another threshold distance is the distance at which the total radiative decay rate constant divided by the sum of the total non-radiative decay rate constant and total radiative decay rate constant is equal to the photoluminescent yield of the emissive material without the enhancement layer present.

In some embodiments, the OLED further comprises an outcoupling layer. In some embodiments, the outcoupling layer is disposed over the enhancement layer on a side opposite the organic emissive layer The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and a reduced efficiency roll-off of the OLED device. Placement of the enhancement layer on the cathode side, anode side, or on both sides, or the enhancement layer itself being as the CGL, results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

In some embodiments, the enhancement layer can be comprised of plasmonic materials, optically active metamaterials, or hyperbolic metamaterials. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, or Ca, alloys or mixtures of these materials, and stacks of these materials. In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly.

In some embodiments, the outcoupling layer has wavelength-sized or sub-wavelength sized features that are arranged periodically, quasi-periodically, or randomly. In some embodiments, the outcoupling layer may be composed of a plurality of nanoparticles. In some embodiments, the outcoupling layer is composed of a plurality of nanoparticles disposed over a material. In these embodiments the outcoupling layer may be tunable by at least one of: varying a size of the plurality of nanoparticles, varying a shape of the plurality of nanoparticles, changing a material of the plurality of nanoparticles, adjusting a thickness of the material, changing the refractive index of the material, adding an additional layer disposed on the plurality of nanoparticles, varying a thickness of the enhancement layer, or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, and Ca, alloys or mixtures of these materials, and stacks of these materials. In some embodiments the outcoupling layer is formed by lithography.

In some embodiments of a plasmonic device, the emitter, and/or host compounds used in the emissive layer has a vertical dipole ratio (VDR) of 0.33 or more. In some such embodiments, the emitter, and/or host compounds have a VDR of 0.40, 0.50, 0.60, 0.70, or more.

In yet another aspect, the present disclosure also provides a consumer product comprising an organic light-emitting device (OLED) having an anode; a cathode; and an organic layer disposed between the anode and the cathode, wherein the organic layer may comprise a compound or a composition of the compound as disclosed in the above compounds section of the present disclosure.

In some embodiments, the consumer product comprises an OLED having an anode; a cathode; and an organic layer disposed between the anode and the cathode, wherein the organic layer may comprise the compound as described herein.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, and an "exciton," which is a localized electron-hole pair having an excited energy state, is formed. Light is emitted when the exciton relaxes via a photoemissive mechanism. In some cases, the exciton may be localized as an excimer or an exciplex. Non-radiative mechanisms, such as thermal relaxation, may also occur, but are generally considered undesirable.

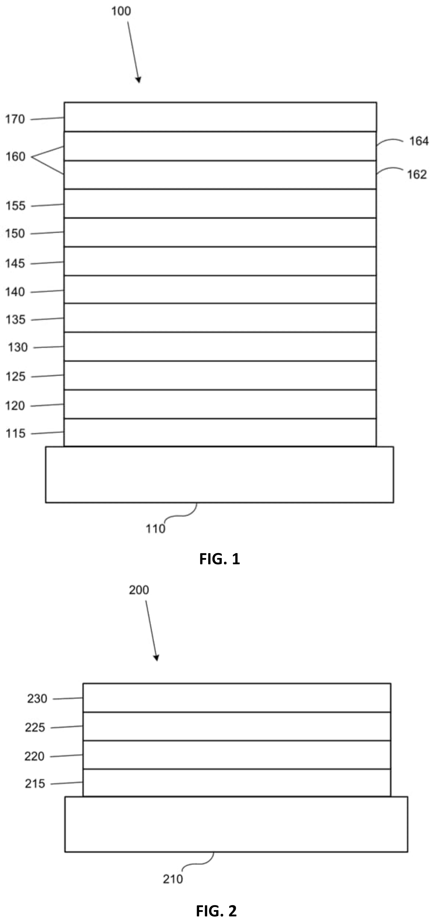

FIG. 1 shows an organic light emitting device 100. The figures are not necessarily drawn to scale. Device 100 may include a substrate 110, an anode 115, a hole injection layer (HIL) 120, a hole transport layer (HTL) 125, an electron blocking layer (EBL) 130, an emissive layer (EML) 135, a hole blocking layer (HBL) 140, an electron transport layer (ETL) 145, an electron injection layer (EIL) 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVIP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation, sputtering, chemical vapor deposition, atomic layer deposition, and electron beam deposition. Preferred patterning methods include deposition through a mask, photolithography, and cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a plurality of alternative layers of polymeric material and non-polymeric material; organic material and inorganic material; or a mixture of a polymeric material and a non-polymeric material as one example described in U.S. Pat. No. 7,968,146, PCT Pat. Application Nos. PCT/US2007/023098 and PCT/US2009/042829, which are herein incorporated by reference in their entireties.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes. In some embodiments, the OLED further comprises one or more quantum dots. Such quantum dots can be in the emissive layer, or in other functional layers, such as a down conversion layer.

In some embodiments, the OLED comprises a RGB pixel arrangement or white plus color filter pixel arrangement. In some embodiments, the OLED is a mobile device, a handheld device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

### D. Other Materials Used in the OLED

The materials described herein are as various examples useful for a particular layer in an OLED. They may also be used in combination with a wide variety of other materials present in the device. For example, emissive dopants disclosed herein may be used by themselves in the EML, or in conjunction with a wide variety of other emitters, hosts, transport layers, blocking layers, injection layers, electrodes and other layers that may be present. The materials described or referred to below are non-limiting examples of materials that may be useful in combination with the compounds and the devices disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer. In some embodiments, conductivity dopants comprise at least one chemical moiety selected from the group consisting of cyano, fluorinated aryl or heteroaryl, fluorinated alkyl or cycloalkyl, alkylene, heteroaryl, amide, benzodithiophene, and highly conjugated heteroaryl groups extended by non-ring double bonds.

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures: 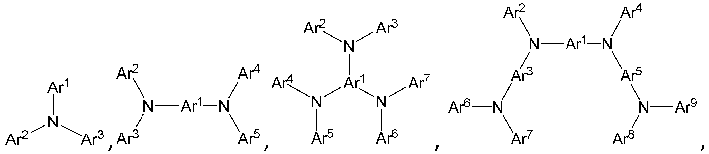 and

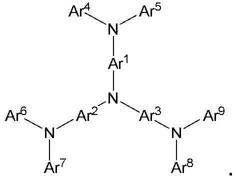

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each of Ar¹ to Ar⁹ may be unsubstituted or may be substituted by a general substituent as described above, any two substituents can be joined or fused into a ring.

In some embodiments, each Ar¹ to Ar⁹ independently comprises a moiety selected from the group consisting of: 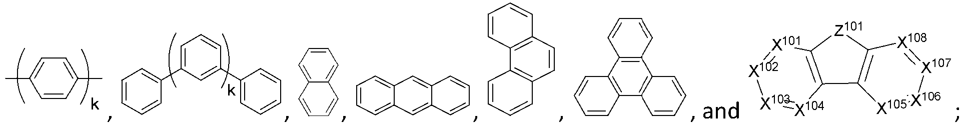 wherein k is an integer from 1 to 20; X¹⁰¹ to X¹⁰⁸ is C or N; Z¹⁰¹ is C, N, O, or S.

Examples of metal complexes used in HIL or HTL include, but are not limited to the following general formula: 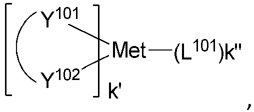 wherein Met is a metal, which can have an atomic weight greater than 40; (Y¹⁰¹-Y¹⁰²) is a bidentate ligand, the coordinating atoms of Y¹⁰¹ and Y¹⁰² are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In some embodiments, (Y¹⁰¹-Y¹⁰²) is a 2-phenylpyridine or 2-phenylimidazole derivative. In some embodiments, (Y¹⁰¹-Y¹⁰²) is a carbene ligand. In some embodiments, Met is selected from Ir, Pt, Pd, Os, Cu, and Zn. In some embodiments, the metal complex has a smallest oxidation potential in solution vs. Fc⁺/Fc couple less than about 0.6 V.

In some embodiments, the HIL/HTL material is selected from the group consisting of phthalocyanine and porphryin compounds, starburst triarylamines, CFₓ fluorohydrocarbon polymer, conducting polymers (e.g., PEDOT:PSS, polyaniline, polypthiophene), phosphonic acid and sliane SAMs, triarylamine or polythiophene polymers with conductivity dopants, Organic compounds with conductive inorganic compounds (such as molybdenum and tungsten oxides), n-type semiconducting organic complexes, metal organometallic complexes, cross-linkable compounds, polythiophene based polymers and copolymers, triarylamines, triaylamine with spirofluorene core, arylamine carbazole compounds, triarylamine with (di)benzothiophene/(di)benzofuran, indolocarbazoles, isoindole compounds, and metal carbene complexes.

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than one or more emitters closest to the EBL interface. In some embodiments, the compound used in EBL contains at least one carbazole group and/or at least one arylamine group. In some embodiments the HOMO level of the compound used in the EBL is shallower than the HOMO level of one or more of the hosts in the EML. In some embodiments, the compound used in EBL contains the same molecule or the same functional groups used as one of the hosts described herein.

### d) Hosts:

The light emitting layer of the organic EL device of the present disclosure preferably contains at least a light emitting material as the dopant, and a host material. Examples of the host material are not particularly limited, and any metal complexes or organic compounds may be used as long as the host won't fully quench the emission of the dopant.

Examples of metal complexes used as host are preferred to have the following general formula: 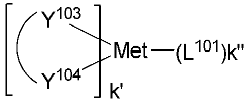 wherein Met is a metal; (Y¹⁰³-Y¹⁰⁴) is a bidentate ligand, the coordinating atoms of Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In some embodiments, the metal complexes are: 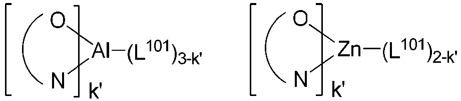 wherein (O-N) is a bidentate ligand, having metal coordinated to atoms O and N.

In some embodiments, Met is selected from Ir and Pt. In a further embodiment, (Y¹⁰³-Y¹⁰⁴) is a carbene ligand.

In some embodiments, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, aza-dibenzothiophene, aza-dibenzofuran, aza-dibenzoselenophene, aza-carbazole, aza-indolocarbazole, aza-triphenylene, aza-tetraphenylene, 5λ²-benzo[d]benzo[4,5]imidazo[3,2-a]imidazole, 5,9-dioxa-13b-boranaphtho[3,2,1-de]anthracene,; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by the General Substituents as described herein or may be further fused.

In some embodiments, the host compound comprises at least one of the moieties selected from the group consisting of: 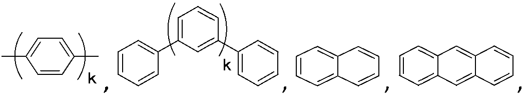 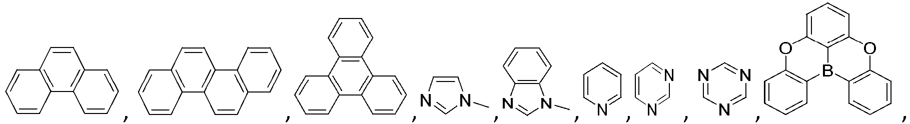 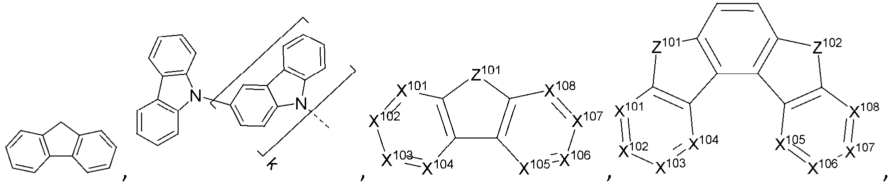 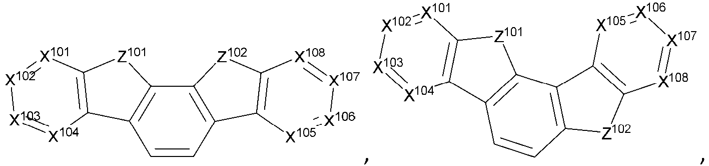 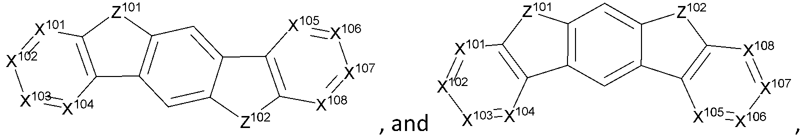 wherein k is an integer from 0 to 20 or 1 to 20. X¹⁰¹ to X¹⁰⁸ are independently selected from C or N. Z¹⁰¹ and Z¹⁰² are independently selected from C, N, O, or S.

In some embodiments, the host material is selected from the group consisting of arylcarbazoles, metal 8-hydroxyquinolates, (e.g., alq3, balq), metal phenoxybenzothiazole compounds, conjugated oligomers and polymers (e.g., polyfluorene), aromatic fused rings, zinc complexes, chrysene based compounds, aryltriphenylene compounds, poly-fused heteroaryl compounds, donor acceptor type molecules, dibenzofuran/dibenzothiophene compounds, polymers (e.g., pvk), spirofluorene compounds, spirofluorene-carbazole compounds, indolocabazoles, 5-member ring electron deficient heterocycles (e.g., triazole, oxadiazole), tetraphenylene complexes, metal phenoxypyridine compounds, metal coordination complexes (e.g., Zn, Al with N^N ligands), dibenzothiophene/dibenzofuran-carbazole compounds, silicon/germanium aryl compounds, aryl benzoyl esters, carbazole linked by non-conjugated groups, aza-carbazole/dibenzofuran/dibenzothiophene compounds, and high triplet metal organometallic complexes (e.g., metal-carbene complexes).

### e) Emitter Materials in EML:

One or more emitter materials may be used in conjunction with the compound or device of the present disclosure. The emitter material can be emissive or non-emissive in the current device as described herein. Examples of the emitter materials are not particularly limited, and any compounds may be used as long as the compounds are capable of producing emissions in a regular OLED device. Examples of suitable emitter materials include, but are not limited to, compounds which are capable of producing emissions via phosphorescence, non-delayed fluorescence, delayed fluorescence, especially the thermally activated delayed fluorescence, i.e., TADF (also referred to as E-type delayed fluorescence), triplet-triplet annihilation, or combinations of these processes.

In some embodiments, the emitter material has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of LIGAND LIST: 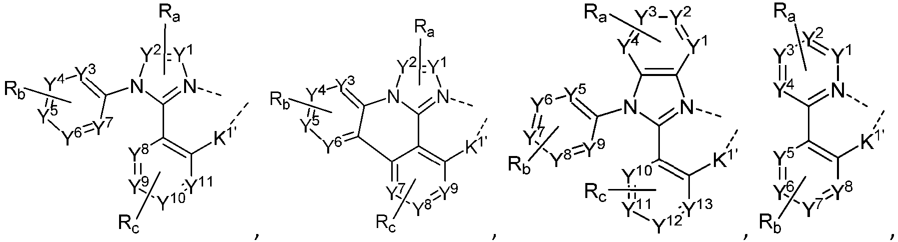 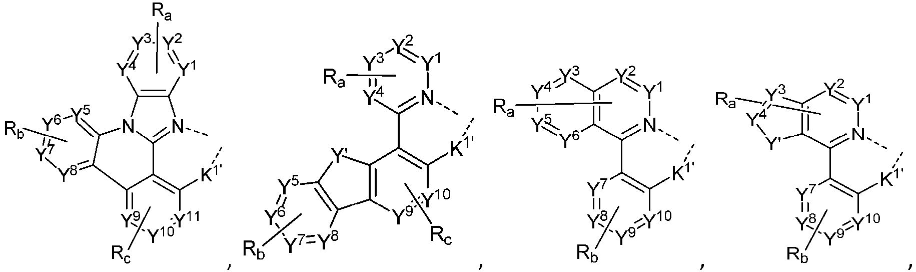 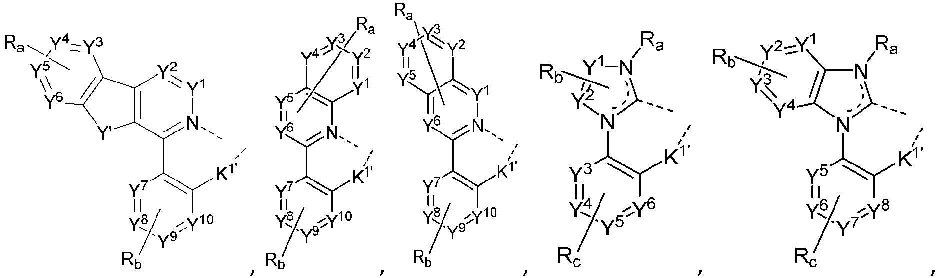 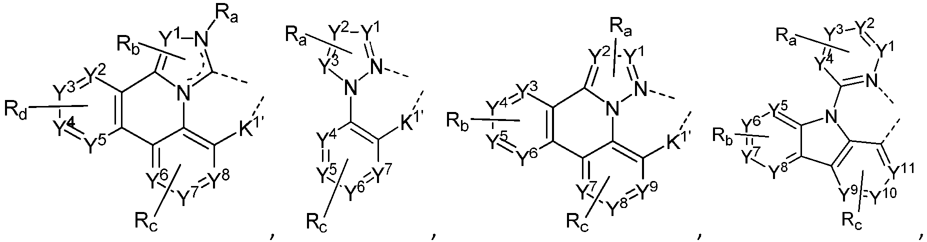 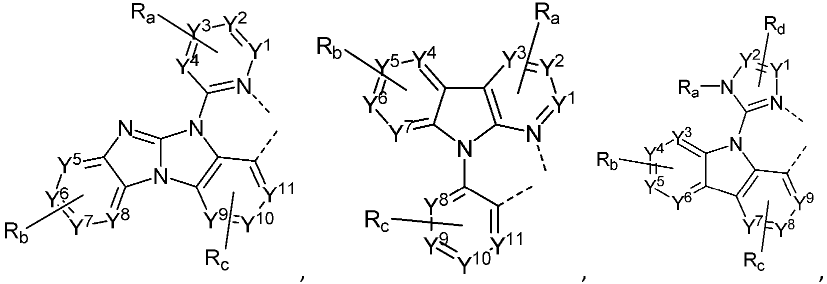 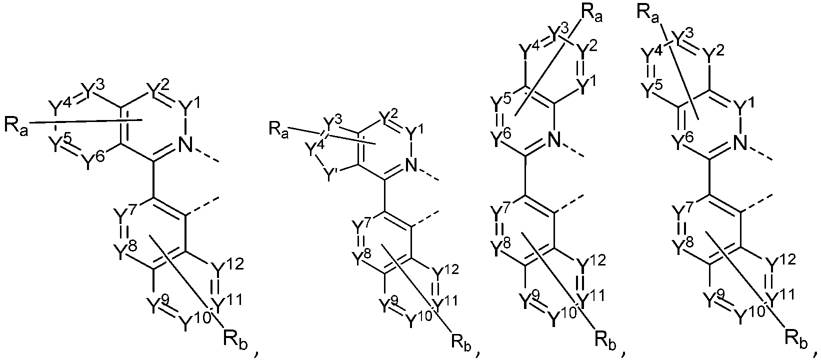 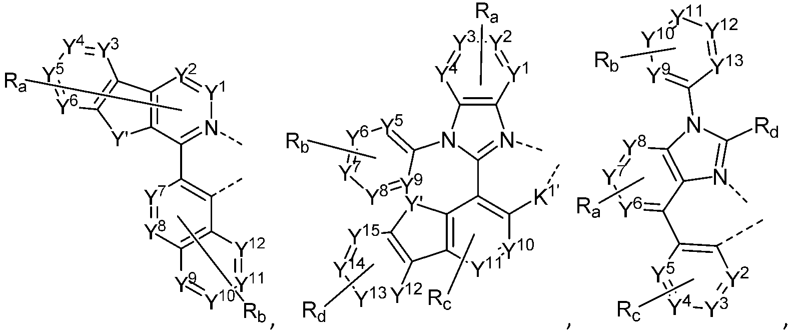 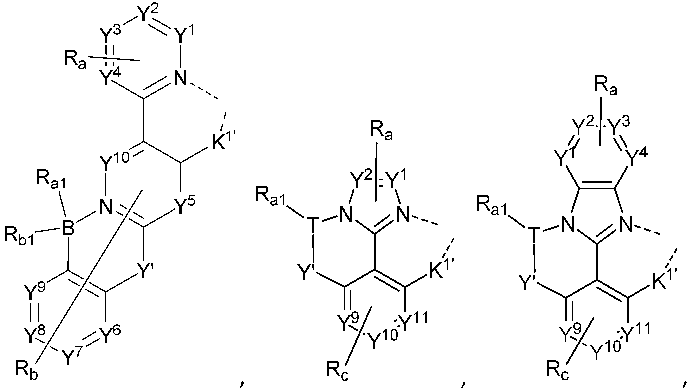 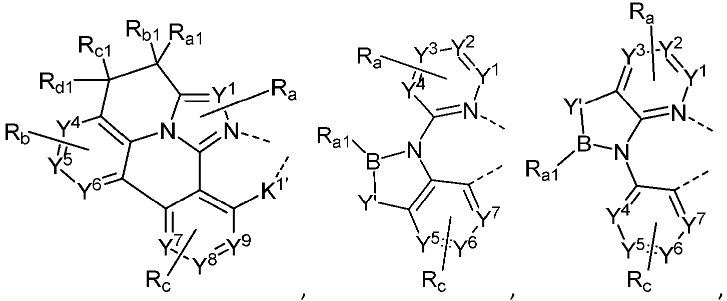 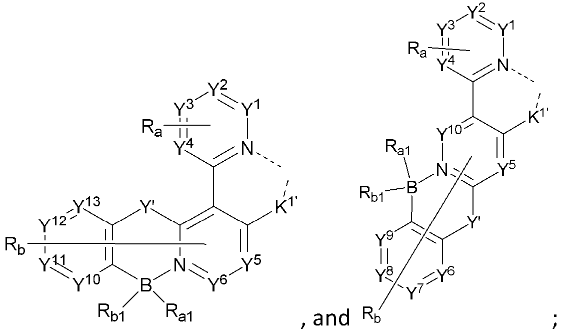
   wherein each L² and L³ are independently selected from the group consisting of 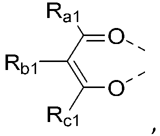 and the structures of LIGAND LIST; wherein:
      M is selected from the group consisting of Ir, Rh, Re, Ru, Os, Pt, Pd, Zn, Au, Ag, and Cu;
      T is selected from the group consisting of B, Al, Ga, and In;
      K^{1'} is a direct bond or is selected from the group consisting of NRₑ, PRₑ, O, S, and Se;
      each Y¹ to Y¹⁵ are independently selected from the group consisting of carbon and nitrogen;
      Y' is selected from the group consisting of BRₑ, NRₑ, PRₑ, O, S, Se, C=O, S=O, SO₂, CRₑR_{f}, SiRₑR_{f}, and GeRₑR_{f};
      each Rₐ, R_{b}, R_{c}, and R_{d} can independently represent from mono to the maximum possible number of substitutions, or no substitution;
      each Rₐ₁, R_{b1}, R_{c1}, R_{d1}, Rₐ, R_{b}, R_{c}, R_{d}, Rₑ, and R_{f} is independently a hydrogen, or a substituent selected from the group consisting of the General Substituents as defined herein; and
   wherein any two substituents can be fused or joined to form a ring or form a multidentate ligand.

In some embodiments, the emitter material is selected from the group consisting of the following Dopant Group 1: 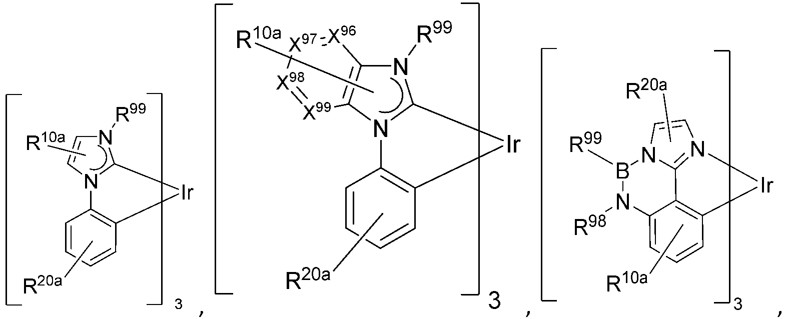 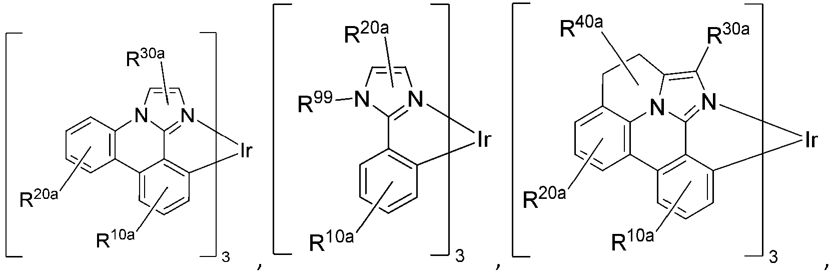 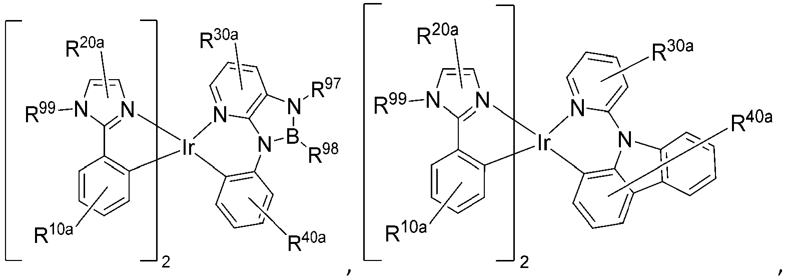 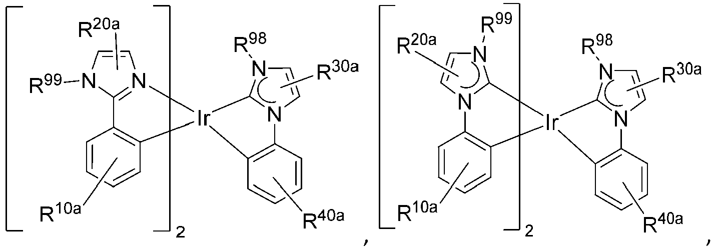 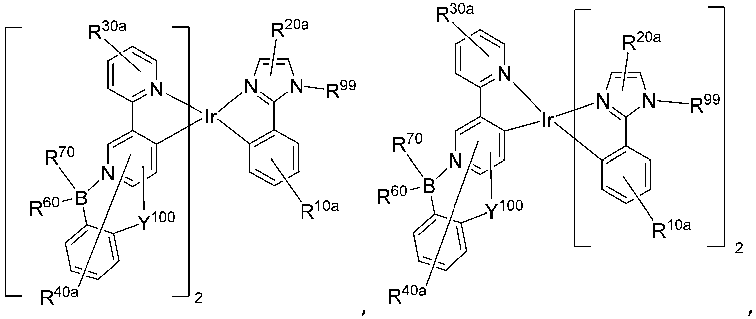 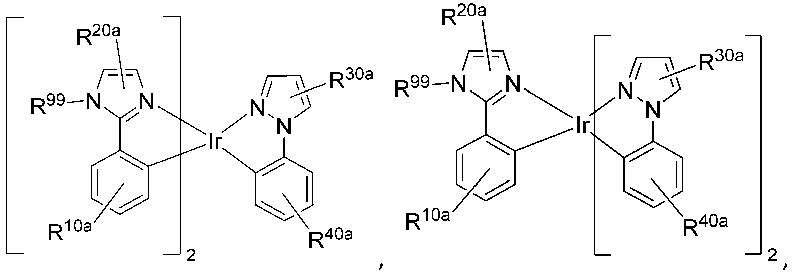 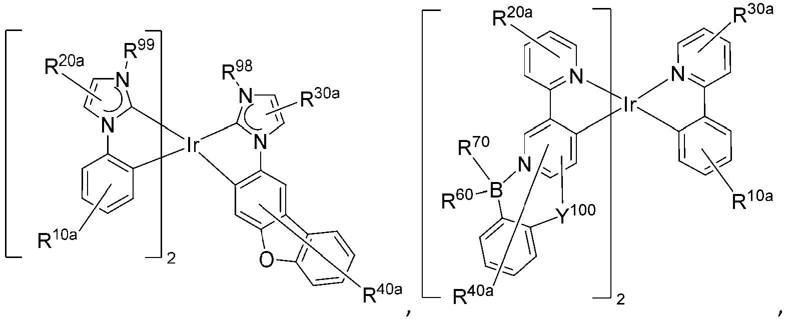 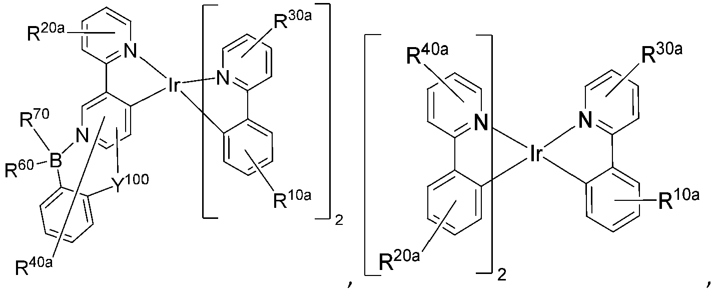 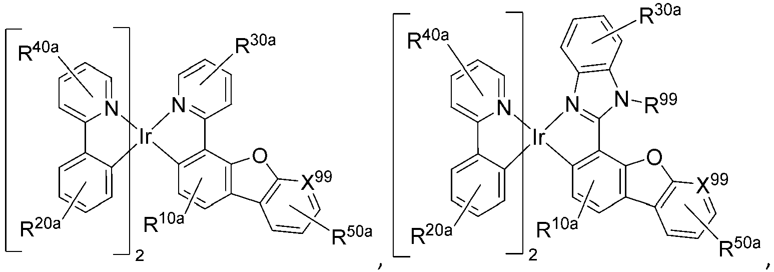 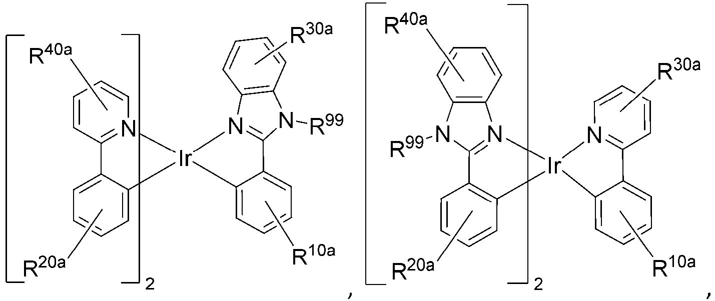 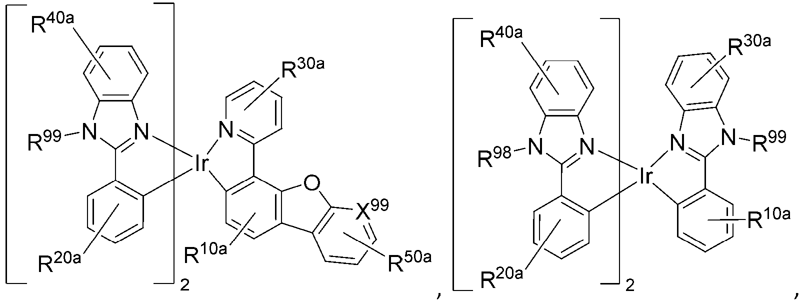 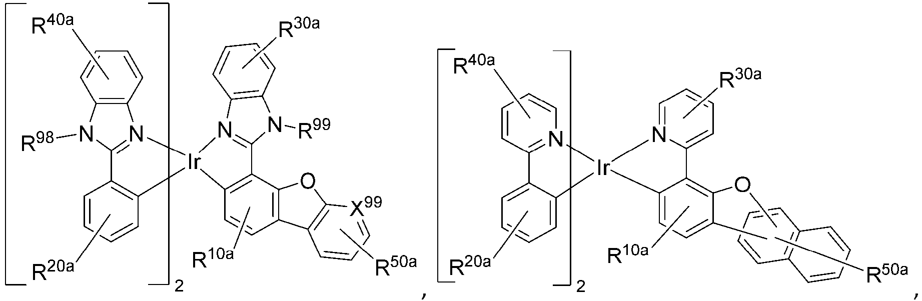 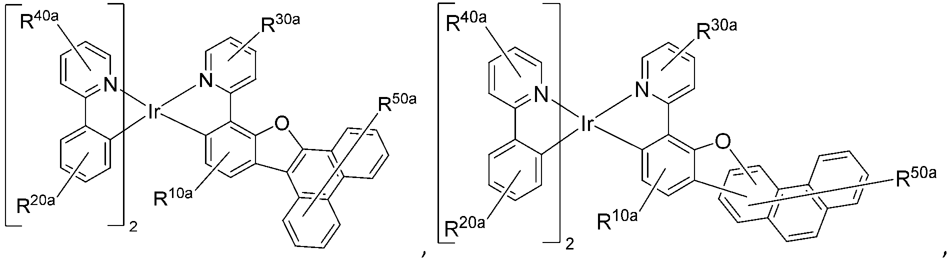 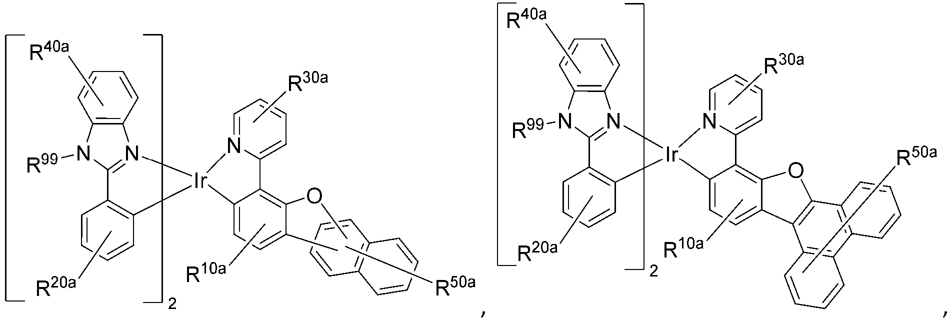 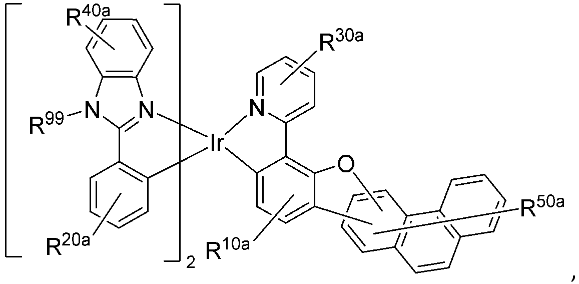 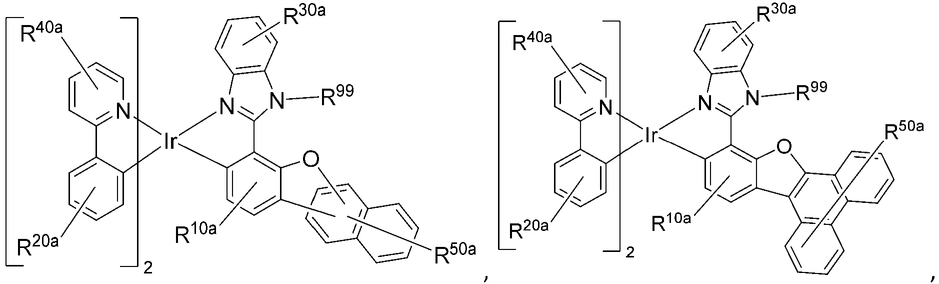 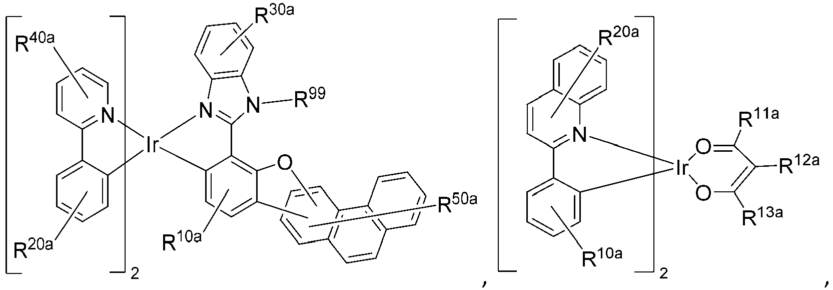 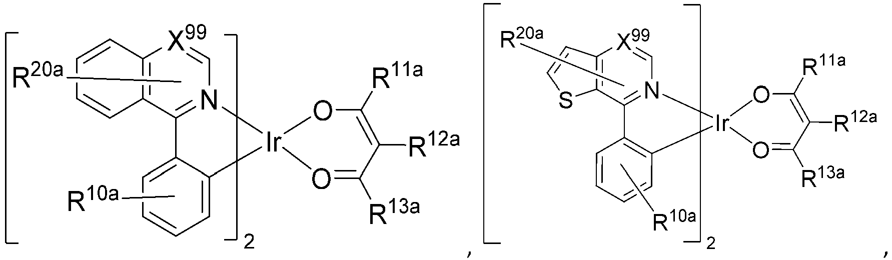 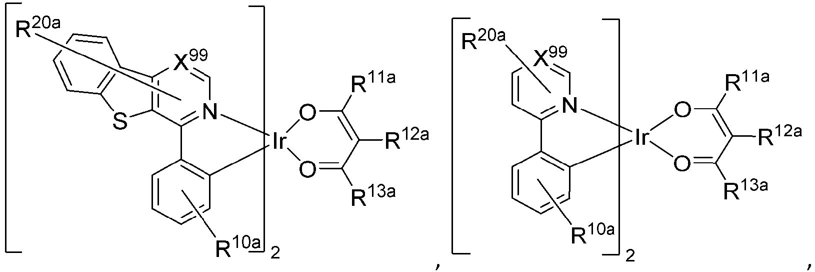 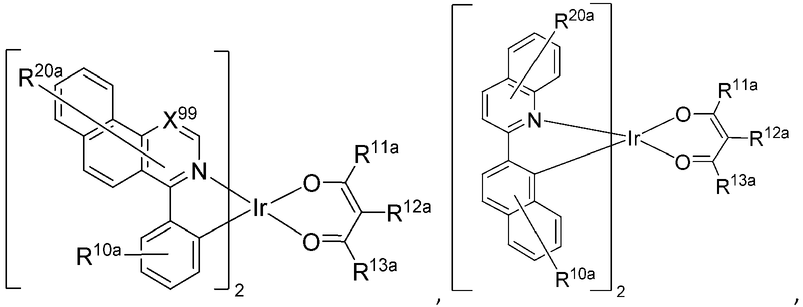 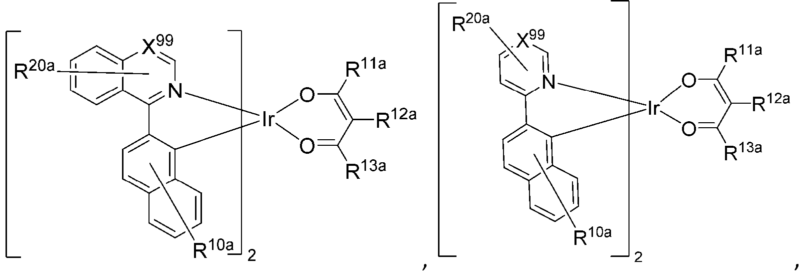 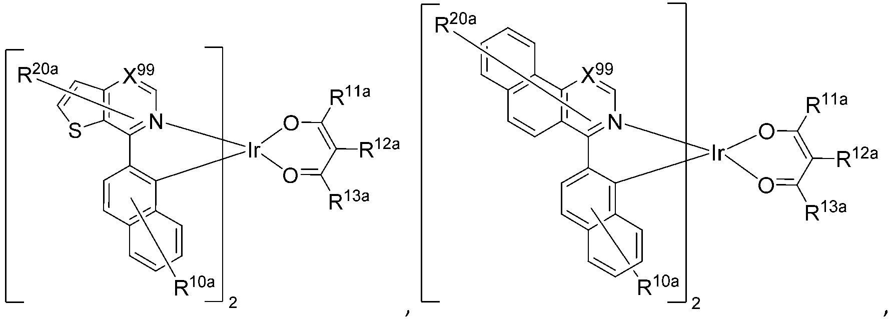 and 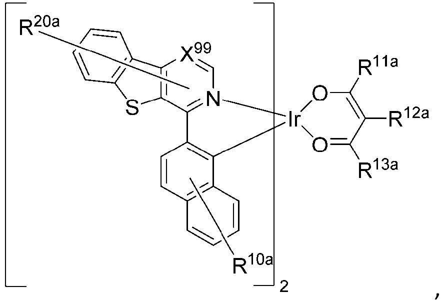 wherein
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitution;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen, or a substituent selected from the group consisting of the General Substituents as defined herein; any two substituents can be joined or fused to form a ring.

In some embodiments, the emitter material is selected from the group consisting of the following Dopant Group 2: 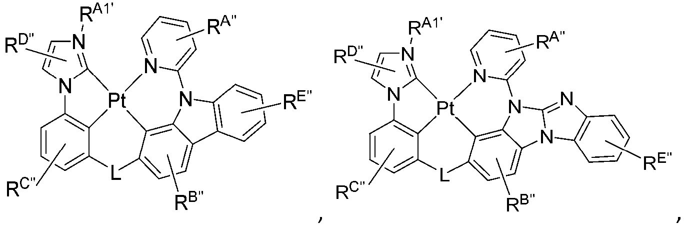 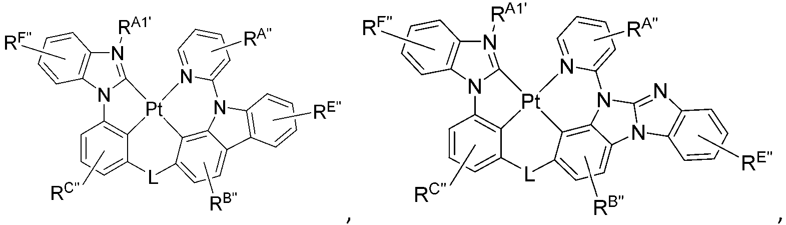 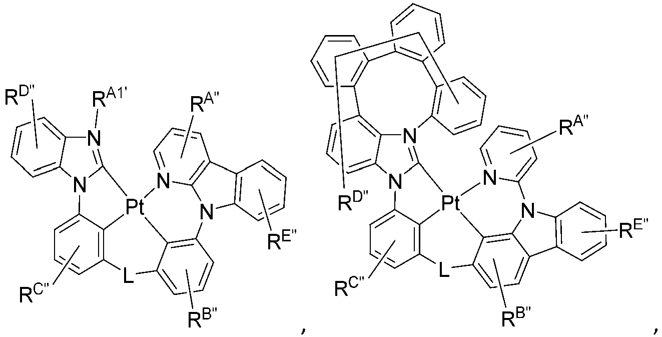 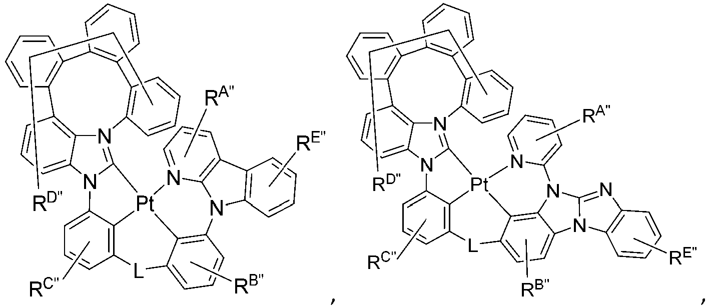 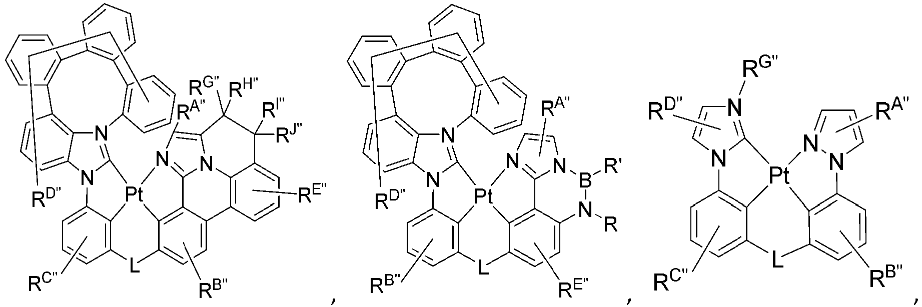 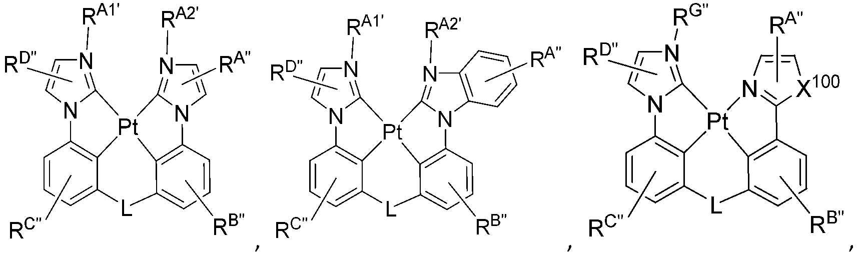 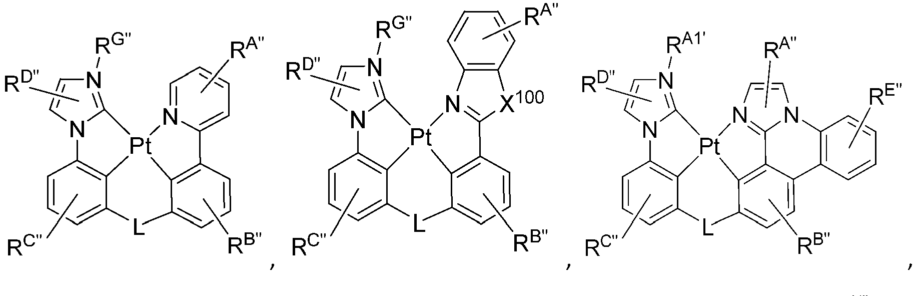 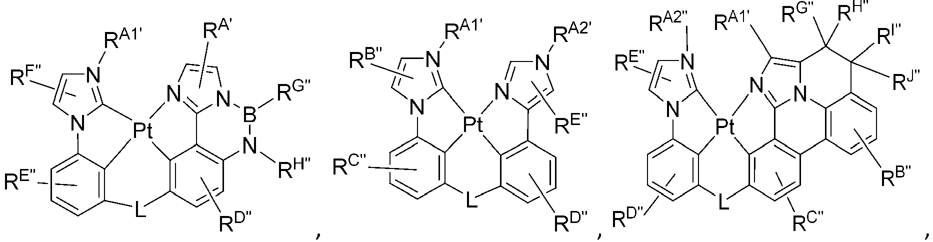 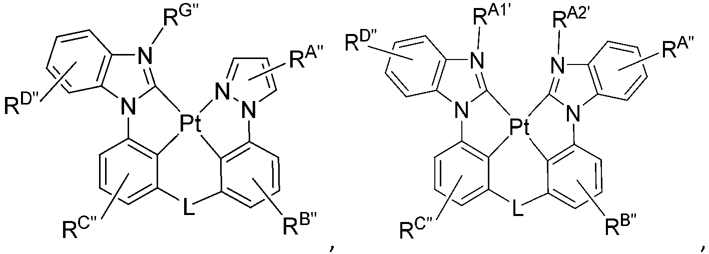 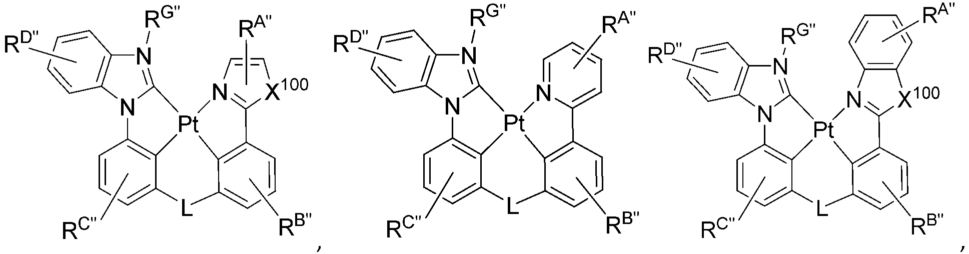 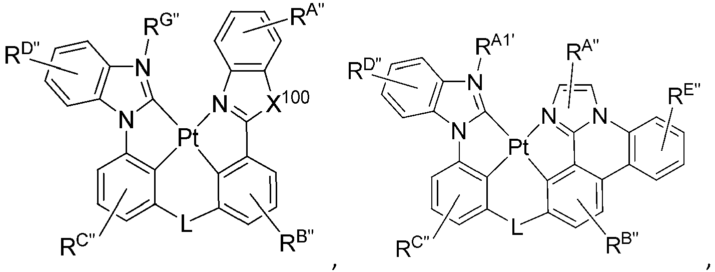 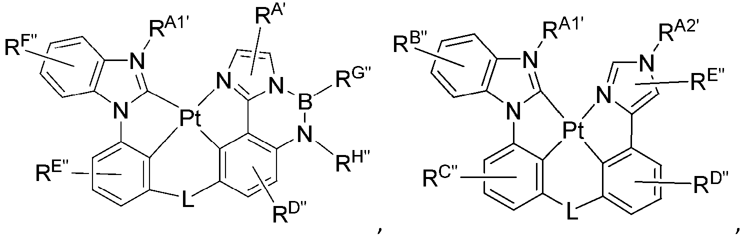 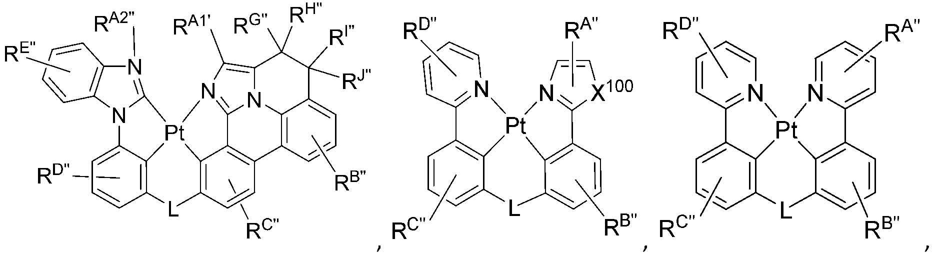 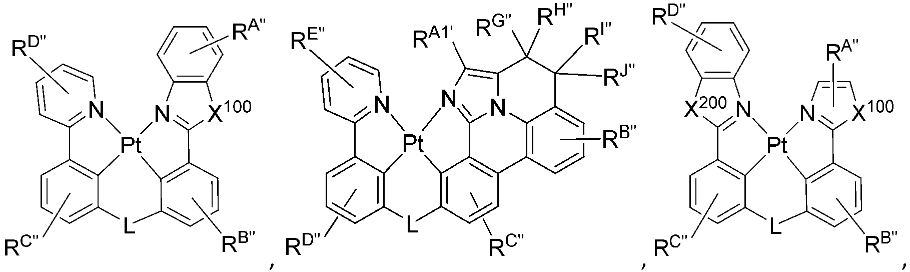 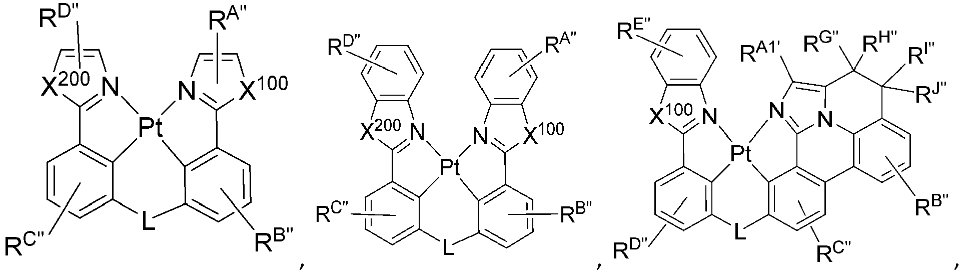 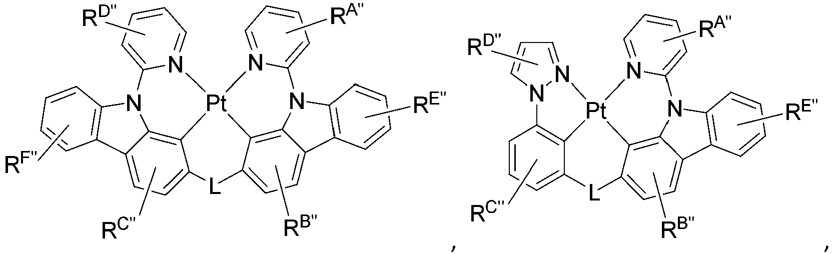 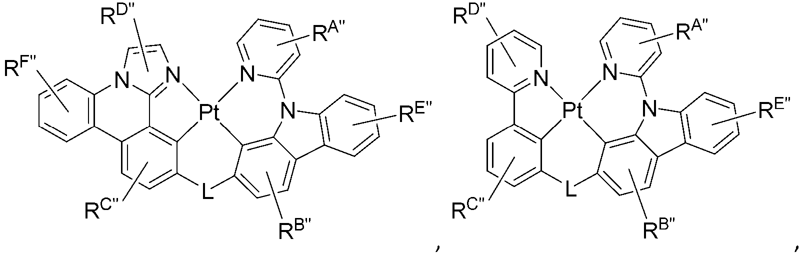 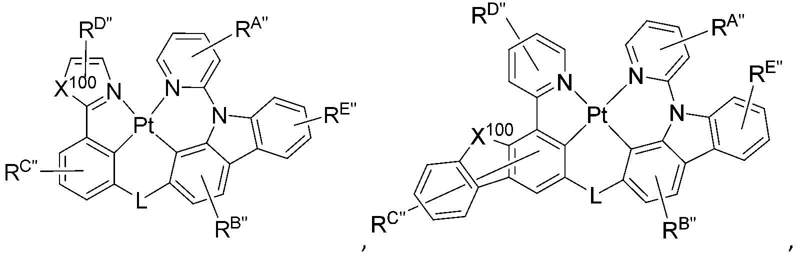 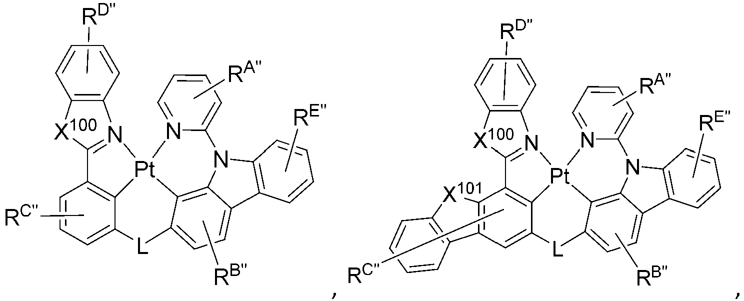 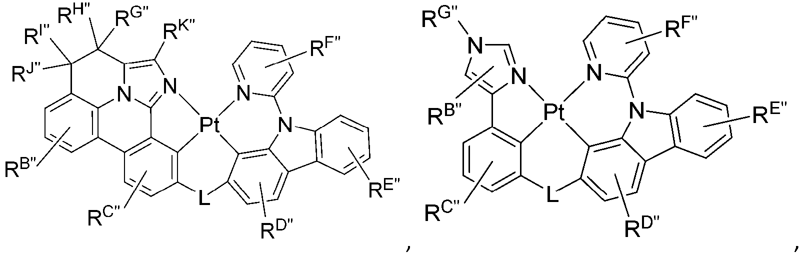 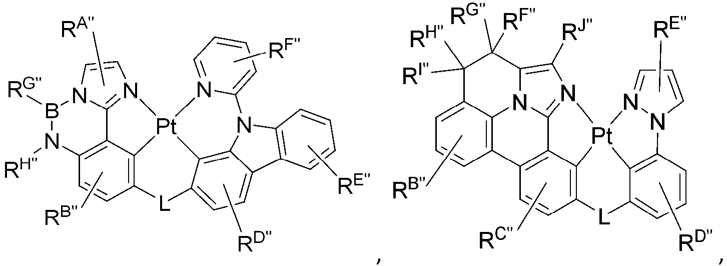 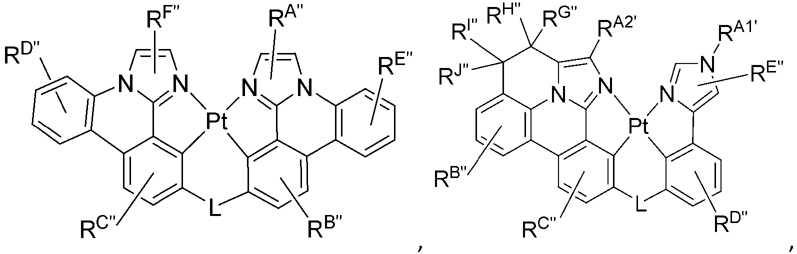 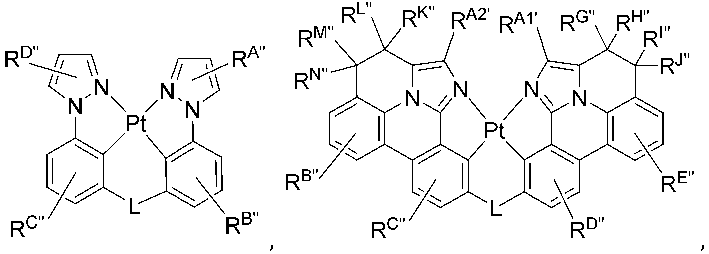 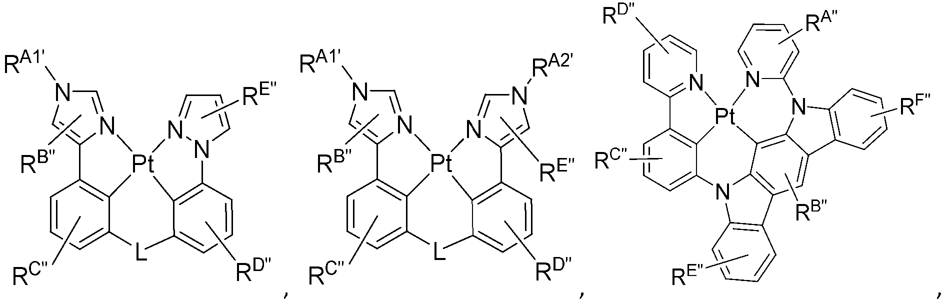 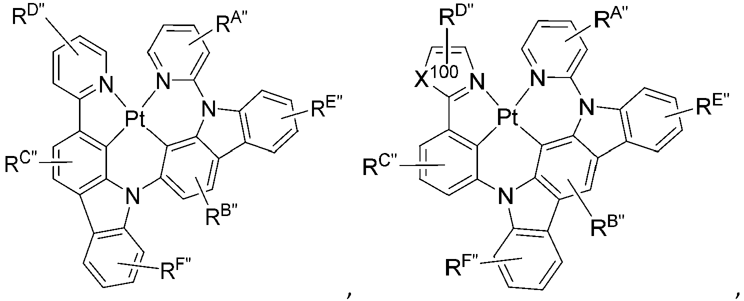 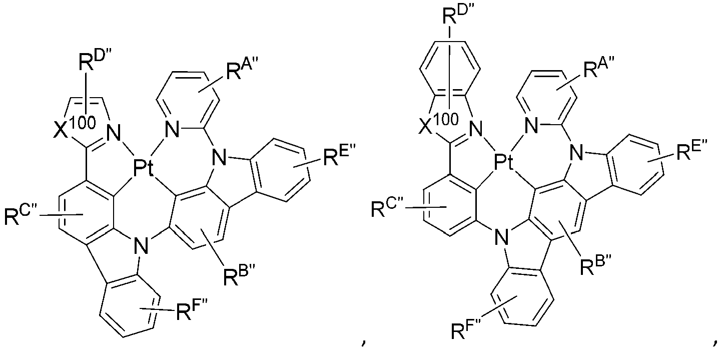 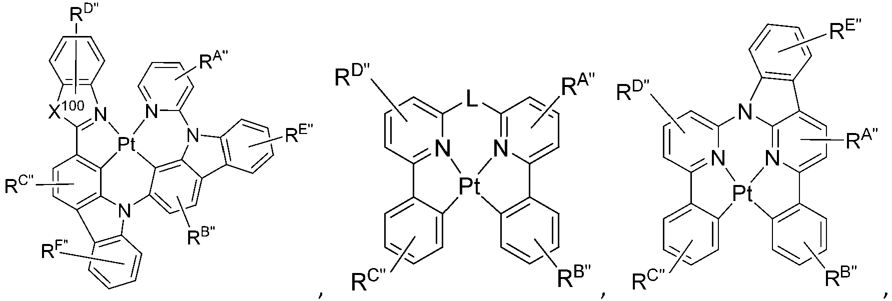 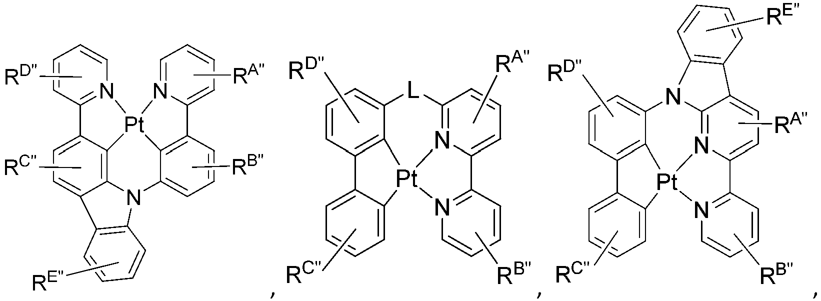 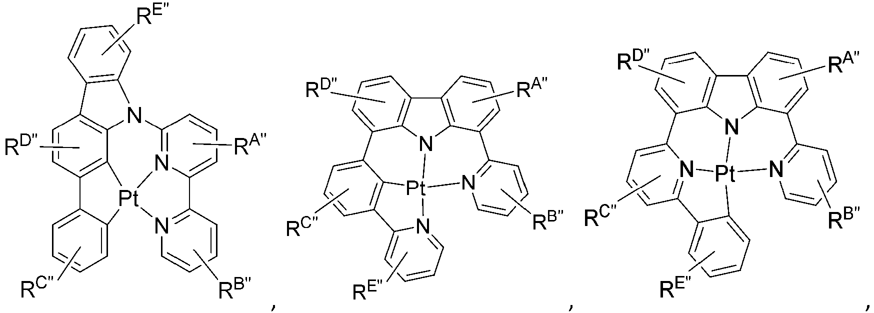 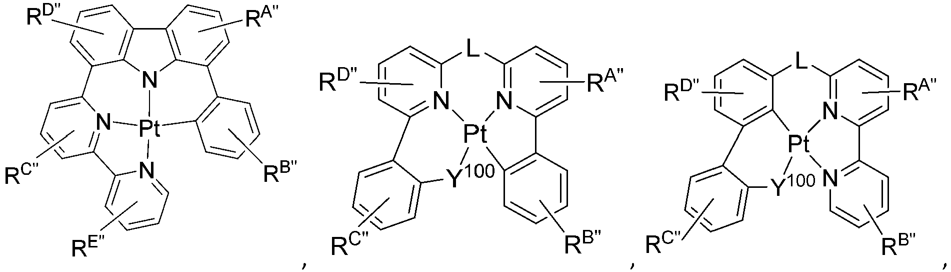 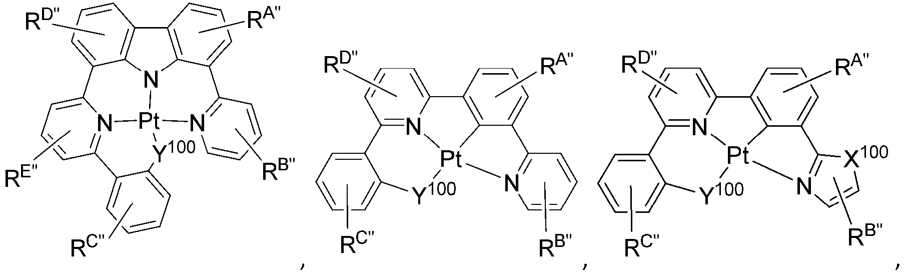 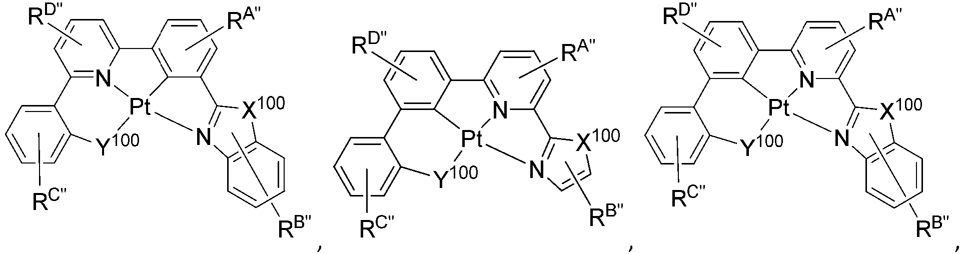 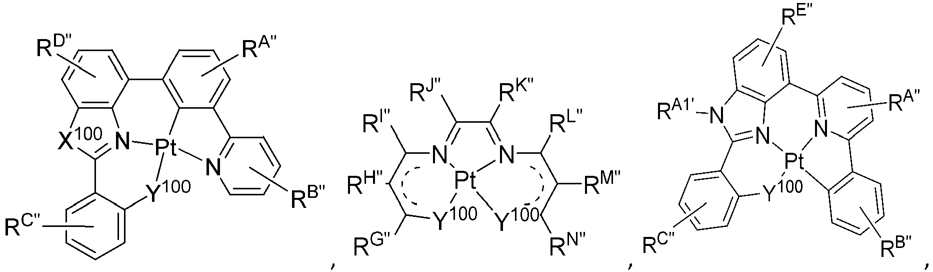 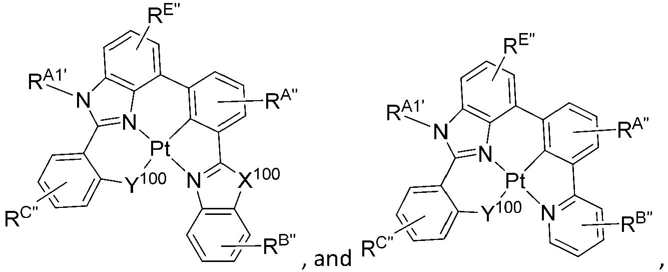 wherein:
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰ and X²⁰⁰ for each occurrence is selected from the group consisting of O, S, Se, NR", and CR"R‴;
each R^{A"}, R^{B"}, R^{C"}, R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen, or a substituent selected from the group consisting of the General Substituents as defined herein; and any two substituents can be joined or fused to form a ring.

In some embodiments of the above Dopant Groups 1 and 2, each unsubstituted aromatic carbon atom can be replaced with N to form an aza-ring. In some embodiments, the maximum number of N atom in one ring is 1 or 2. In some embodiments of the above Dopant Groups 2, Pt atom in each formula can be replaced by Pd atom.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Zn, Cu, Ag, or Au complex.

In some embodiments of the OLED, the delayed fluorescence material has the formula of M(L⁵)(L⁶), wherein M is Cu, Ag, or Au, L⁵ and L⁶ are different, and L⁵ and L⁶ are independently selected from the group consisting of: 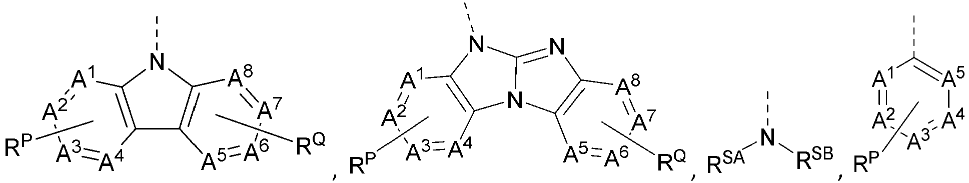 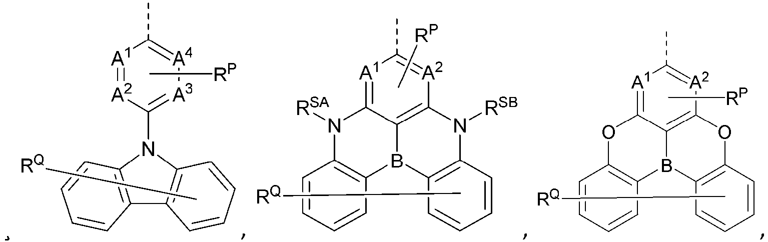 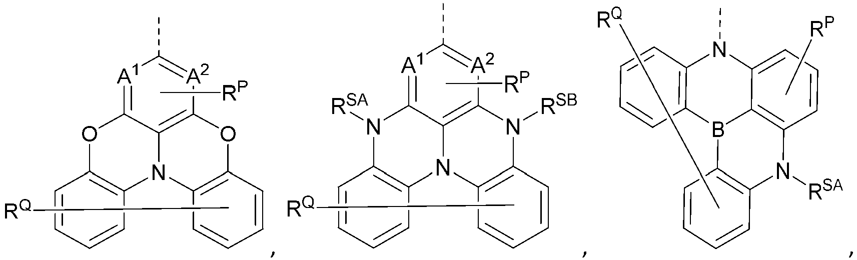 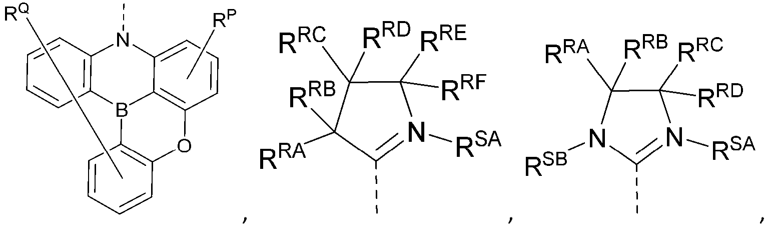 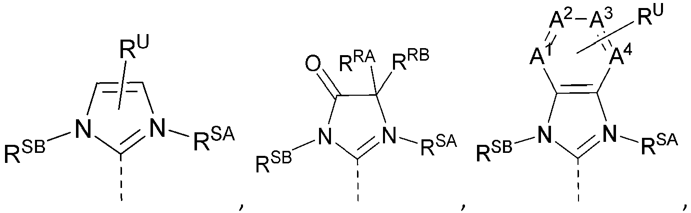 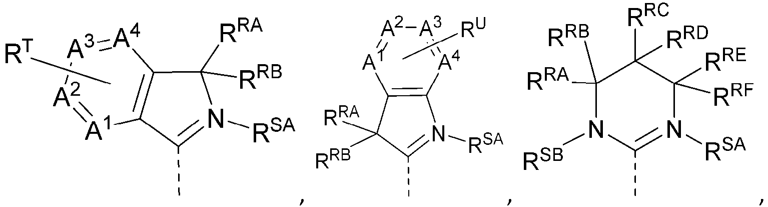 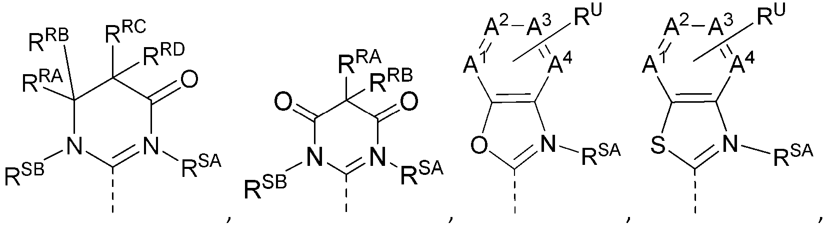 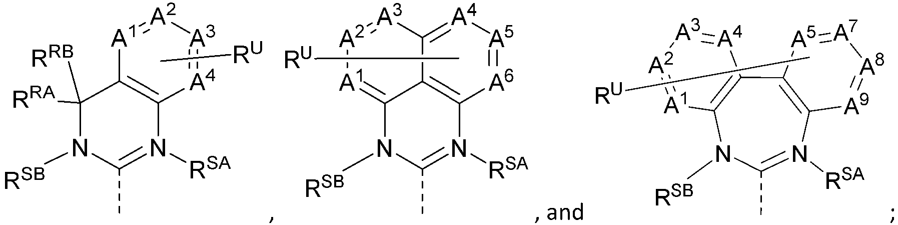
wherein A¹ - A⁹ are each independently selected from C or N;
each R^{P}, R^{Q}, and R^{Y} independently represents mono-, up to the maximum substitutions, or no substitutions;
wherein each R^{P}, R^{P}, R^{U}, R^{SA}, R^{SB}, R^{RA} , R^{RB}, R^{RC} R^{RD}, R^{RE}, and R^{RF} is independently a hydrogen, or a substituent selected from the group consisting of the General Substituents as defined herein; any two substituents can be joined or fused to form a ring.

In some embodiments of the OLED, the delayed fluorescence material comprises at least one of the donor moieties selected from the group consisting of: 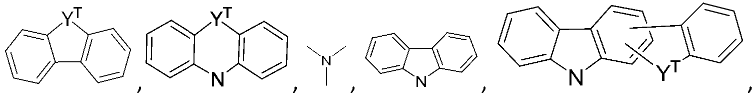 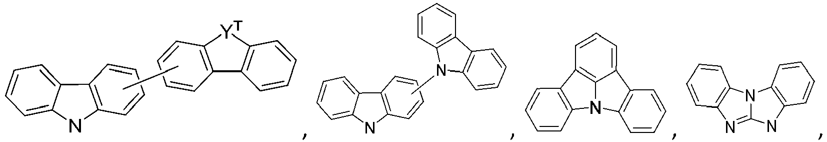 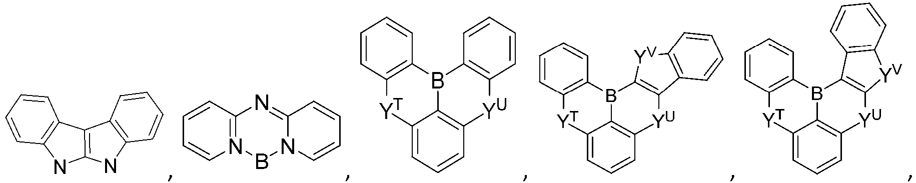 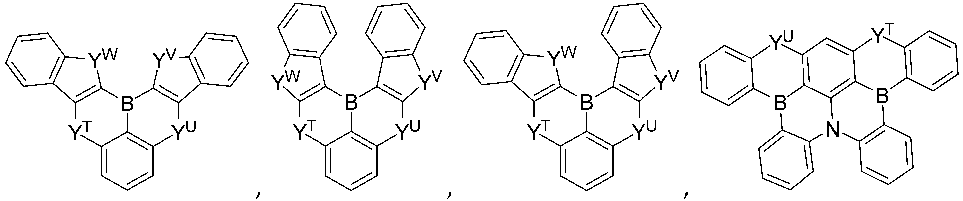 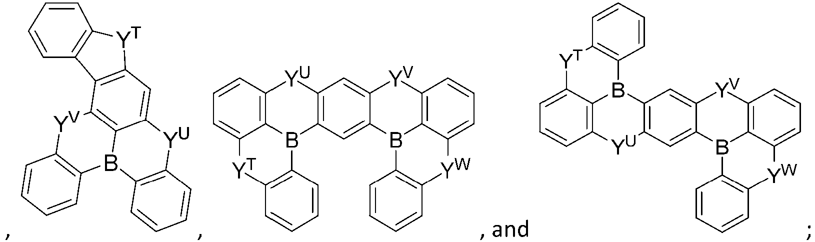 wherein Y^{T}, Y^{U}, Y^{V}, and Y^{W} are each independently selected from the group consisting of B, C, Si, Ge, N, P, O, S, Se, C=O, S=O, and SO₂.

In some of the above embodiments, any carbon ring atoms up to maximum of a total number of three, together with their substituents, in each phenyl ring of any of above structures can be replaced with N.

In some embodiments, the delayed fluorescence material comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a non-conjugated linker, such as a sp³ carbon or silicon atom.

In some embodiments, the fluorescent material comprises at least one of the chemical moieties selected from the group consisting of: 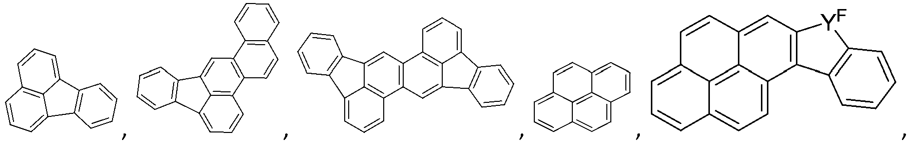 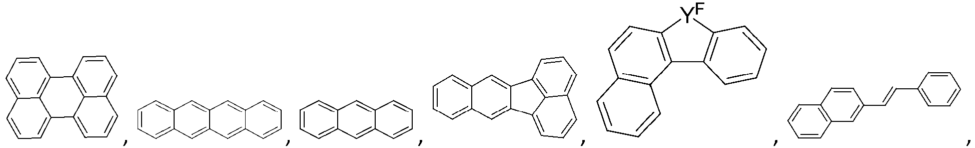 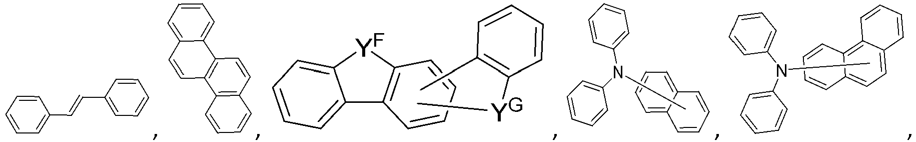 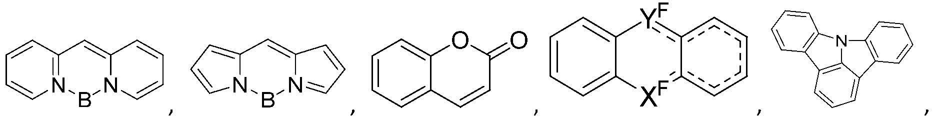 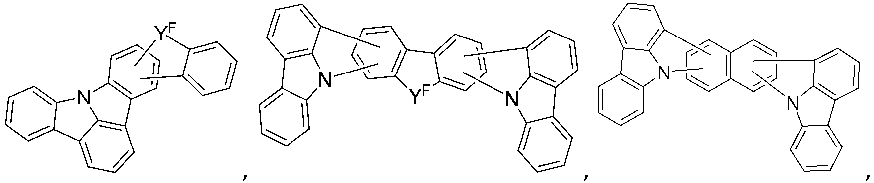 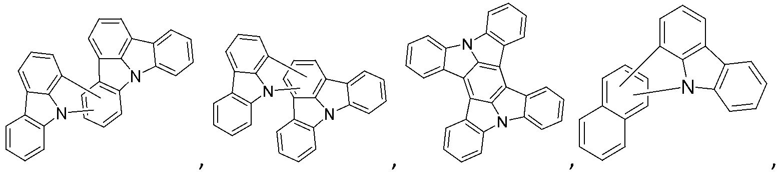 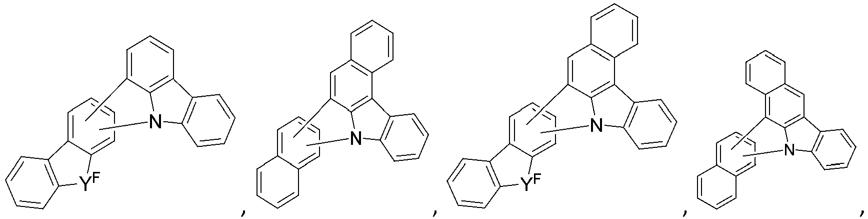 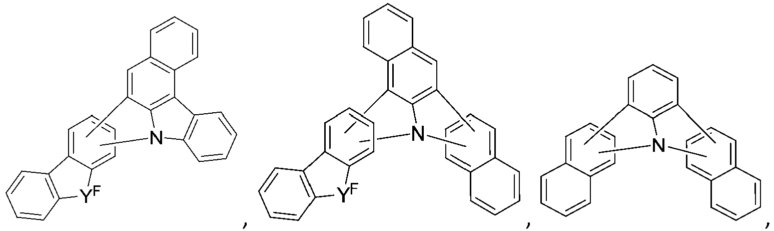 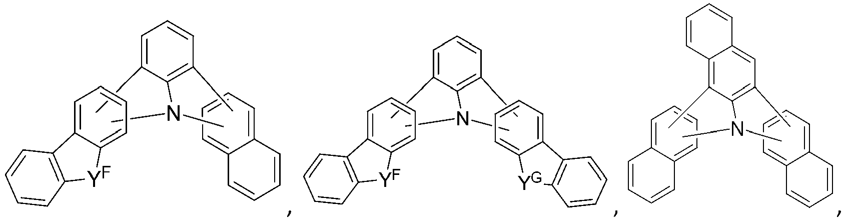 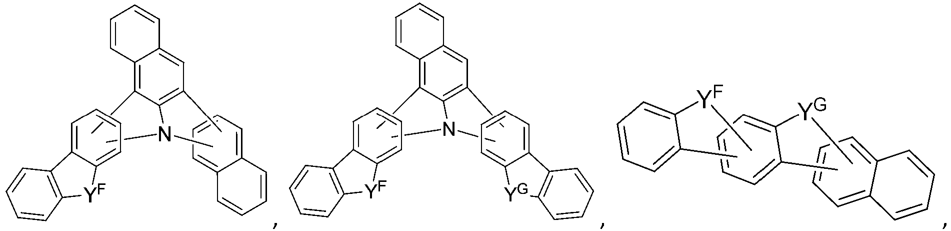 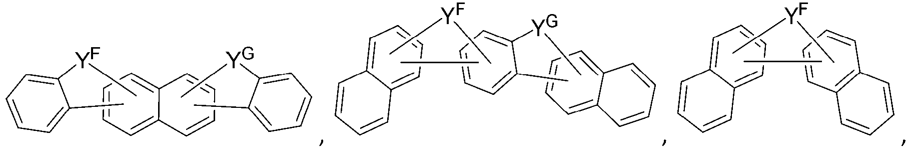 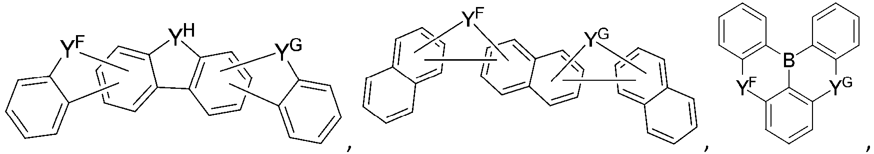 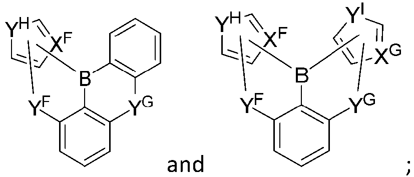
wherein Y^{F}, Y^{G}, Y^{H}, and Y^{I} are each independently selected from the group consisting of B, C, Si, Ge, N, P, O, S, Se, C=O, S=O, and SO₂;
wherein X^{F} and X^{G} are each independently selected from the group consisting of C and N.

In some of the above embodiments, any carbon ring atoms up to maximum of a total number of three, together with their substituents, in each phenyl ring of any of above structures can be replaced with N.

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further away from the vacuum level) and/or higher triplet energy than one or more of the emitters closest to the HBL interface.

In some embodiments, a compound used in the HBL contains the same molecule or the same functional groups used as host described above.

In some embodiments, a compound used in the HBL comprises at least one of the following moieties selected from the group consisting of: 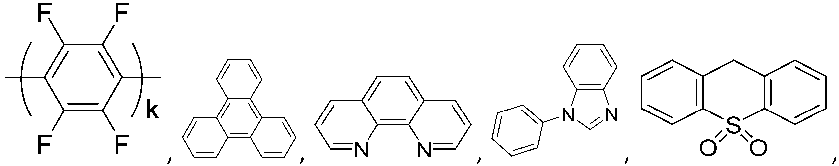 and 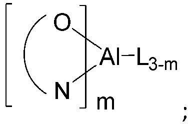 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In some embodiments, compound used in ETL comprises at least one of the following moieties in the molecule: 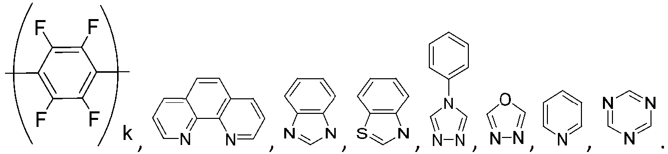 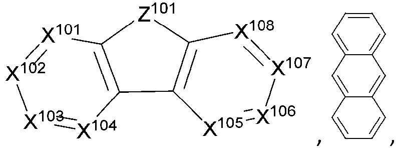 and fullerenes; wherein k is an integer from 1 to 20, X¹⁰¹ to X¹⁰⁸ is selected from C or N; Z¹⁰¹ is selected from the group consisting of C, N, O, and S.

In some embodiments, the metal complexes used in ETL contains, but not limit to the following general formula: 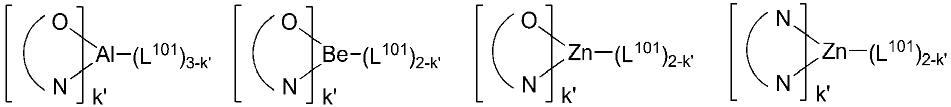 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

In some embodiments, the ETL material is selected from the group consisting of anthracene-benzoimidazole compounds, aza triphenylene derivatives, anthracene-benzothiazole compounds, metal 8-hydroxyquinolates, metal hydroxybenoquinolates, bathocuprine compounds, 5-member ring electron deficient heterocycles (e.g.,triazole, oxadiazole, imidazole, benzoimidazole), silole compounds, arylborane compounds, fluorinated aromatic compounds, fullerene (e.g., C60), triazine complexes, and Zn (N^N) complexes.

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any compounds disclosed herein, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. As used herein, percent deuteration has its ordinary meaning and includes the percent of all possible hydrogen and deuterium atoms that are replaced by deuterium atoms. In some embodiments, the deuterium atoms are attached to an aromatic ring. In some embodiments, the deuterium atoms are attached to a saturated carbon atom, such as an alkyl or cycloalkyl carbon atom. In some other embodiments, the deuterium atoms are attached to a heteroatom, such as Si, or Ge atom.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

### E. Experimental Data

### a) Preparation of Examplary Compounds

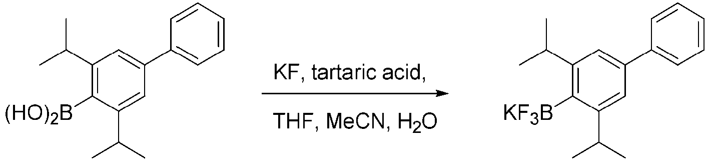

(3,5-Diisopropyl-[1,1'-biphenyl]-4-yl)boronic acid (36.2 g, 95% Wt, 122 mmol) was dissolved in MeCN (550 mL) under nitrogen atmosphere in an overhead stirred 3-neck flask and heated to 45 °C. A solution of potassium fluoride (31.2 g, 536 mmol) in water (50 mL) was added, then a suspension of (+)-tartaric acid (40.2 g, 268 mmol) in THF (175 mL) was added. The mixture was stirred at 45 °C for 2.5 hours, cooled to RT, and the solvent decanted off. The solids were suspended in MeCN (3 x 750 mL) and filtered. The combined filtrates were concentrated. The residue was re-dissolved in MeCN (550 mL) under nitrogen atmosphere in an overhead stirred 3-neck flask and heated to 45 °C. A solution of potassium fluoride (31.2 g, 536 mmol) in water (50 mL) was added, then a suspension of (+)-tartaric acid (40.2 g, 268 mmol) in THF (175 mL) was added. The mixture was stirred at 45 °C for 2 h, cooled to RT and the solvent decanted off. The solids were suspended in MeCN (3 x 750 mL) and filtered. The combined filtrates were concentrated *in vacuo.* The resulting solid was suspended in a mixture of hexane:methyl tert-butyl ether (MTBE) (1:1, 400 mL), sonicated for 5 min, then stirred for at RT for 30 min. The resulting thick suspension was filtered, the solids washed with hexane:MTBE (1:1, 2 x 200 ml) and dried *in vacuo* to give potassium (3,5-diisopropyl-[1,1'-biphenyl]-4-yl)trifluoroborate (26.1 g, 74 mmol, 60 %, 97% purity) as a colorless solid.

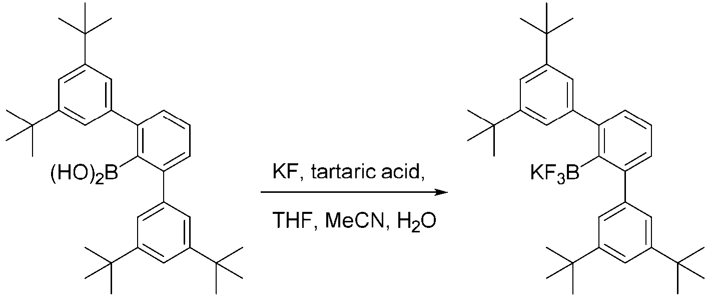

To a mixture of (3,3",5,5"-tetra-tert-butyl-[1,1':3',1"-terphenyl]-2'-yl)boronic acid (1.0 g, 2.0 mmol) in acetonitrile (8.4 mL) was added a solution of KF (0.513 g, 8.83 mmol) in water (0.84 mL). The resulting mixture was stirred at room temperature for 10 minutes, resulting in a suspension of colorless solid. Additional acetonitrile (3 mL) was added the mixture was and heated to 45 oC until homogeneous. A solution of tartaric acid in THF (4.2 mL) was added, then continued stirring at the same temperature for 45 minutes. The mixture was cooled to room temperature, then filtered, rinsing with excess acetonitrile. The filtrate was concentrated to give a colorless solid that was suspended in hexanes and stirred for 1 hour at room temperature, then collected by vacuum filtration to obtain 0.76 g (67% yield) of trifluoro(3,3",5,5"-tetra-tert-butyl-[1,1':3',1"-terphenyl]-2'-yl)-14-borane, potassium salt as a colorless solid.

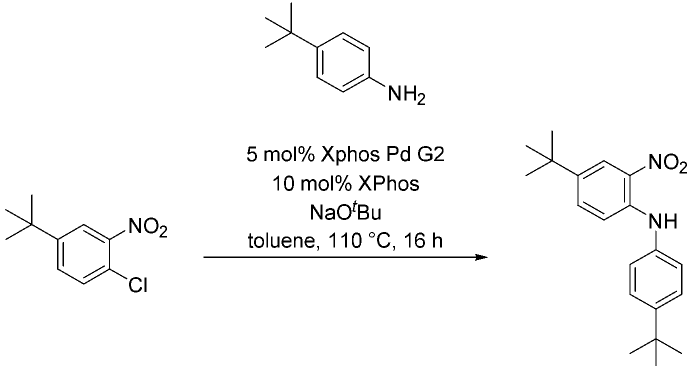

In a 2 L round bottom flask, sodium tert-butoxide (23.8 g, 247 mmol) was added to a mixture of 4-(tert-butyl)-1-chloro-2-nitrobenzene (48.0 g, 225 mmol), 4-(tert-butyl)aniline (36.9 g, 247 mmol), XPhos Pd G2 (9.51 g, 11.2 mmol) and XPhos (10.7 g, 22.5 mmol) in toluene (900 mL). The reaction was stirred and heated to reflux for 16 hours. The mixture was cooled to room temperature and concentrated to 300 mL. The solution was diluted with EtOAc and water. The aqueous and organic layers were separated and the aqueous layer was extracted with EtOAc (x3). The combined organics were dried over MgSO4, filtered and concentrated to give 4-(tert-butyl)-N-(4-(tert-butyl)phenyl)-2-nitroaniline (44.0 g, 54% yield, 90% Purity) as a brown/black oil that was used without further purification in the next step.

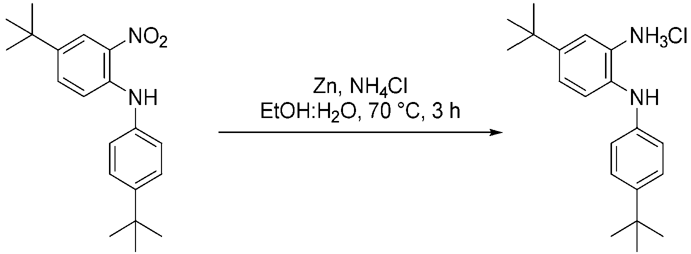

To a round bottom flask was added 4-(tert-butyl)-N-(4-(tert-butyl)phenyl)-2-nitroaniline (44.0 g, 90% Wt, 121 mmol), ammonium chloride (64.9 g, 1.21 mol), zinc (20 mesh, 63.5 g, 971 mmol) in a mixture of EtOH (540 mL) and water (270 mL). After 3 h at 80 oC, the mixture was filtered hot through celite. The filtered material was diluted with EtOAc and 2M HCI (aq) was added until the white solid inorganics dissolved. The biphasic mixture was further diluted with water. The layers were separated and the aqueous layer was extracted with EtOAc (x 3). The combined organics were dried over MgSO4, filtered and concentrated to give a pink oil. The pink oil was dissolved in 1,4 dioxane (1 L) by heating to 90 °C. HCl in 1,4-dioxane (17.7 g, 121 mL, 4.00 molar, 485 mmol) was added dropwise. The reacton was cooled to room temperature. After 3 days, a black precipitate crashed out. The precipitate was filtered and washed with cold Et2O to give the product as a white solid. The filtrated was concentrated to remove all volatiles, the resulting purple gum was triturated with cold Et2O to afford more white solid. This process was repeated a further 3 times. All white solids were combined and washed once more with cold Et2O to give 4-(tert-butyl)-N1-(4-(tert-butyl)phenyl)benzene-1,2-diamine hydrochloride (34.3 g, 85 % yield) as a white solid.

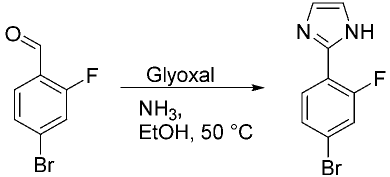

To a stirring mixture of glyoxal (40%wt in H2O, 140 mL, 1.22 mol) and 4-bromo-2-fluorobenzaldehyde (60.0 g, 296 mmol) in EtOH (800 mL) was added NH3 (28%wt in H₂O, 230 mL, 2.98 mmol). The reaction mixture was stirred at 50 °C for 18 h, cooled to room temperature and concentrated in vacuo. The crude product was purified by silica gel column chromatography re-combined to give a brown solid. This solid was triturated in methyl tert-butyl ether (TBME, 300 mL), filtered, rinsed with TBME (3 x 100 mL) and dried in vacuo to give 2-(4-bromo-2-fluorophenyl)-1H-imidazole (28.0 g, 39% yield) as a light brown powder.

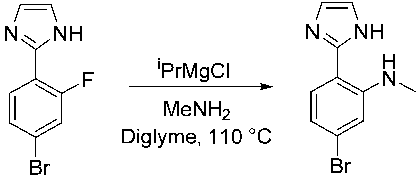

A 3-neck, nitrogen-purged round bottom flask fitted with an overhead stirrer was charged with diglyme (400 mL) and isopropylmagnesium chloride (2 M in THF, 300 mL, 600 mmol). The solution was cooled to 0 °C, methylamine (2 M in THF, 230 mL, 460 mmol) was added over 5 min and the resulting mixture was stirred at 0 °C for 1 hour. A suspension of 2-(4-bromo-2-fluorophenyl)-1H-imidazole (28.0 g, 115 mmol) in diglyme (400 mL) was added over 5 min. The resulting mixture was heated to 110 °C and stirred for 1 hour. The mixture was cooled to room temperature, poured into saturate aqueous NH4Cl (700 mL) and diluted with EtOAc (700 mL). The phases were separated and the aqueous layer was extracted with EtOAc (3 x 400 mL). The combined organic extracts were dried over MgSO4, filtered and concentrated in vacuo. The crude product was purified by silica gel column chromatography in two batches to give 5-bromo-2-(1H-imidazol-2-yl)-N-methylaniline (31.4 g, 86% yield, 80% purity [19% wt diglyme]) as an off-white powder.

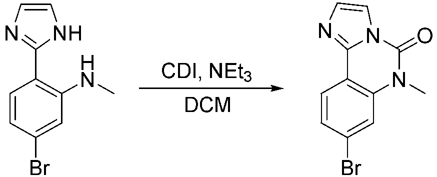

To a mixture of 5-bromo-2-(1H-imidazol-2-yl)-N-methylaniline (34.5 g, 137 mmol) and CDI (45 g, 280 mmol) in DCM (800 mL) was added NEt3 (60 mL, 430 mmol). The resulting mixture was stirred at room temperature for 18 hours then concentrated in vacuo. The crude material was suspended in EtOAc (400 mL), diluted with water (400 mL) and sonicated for 2 min. The resulting solid was collected by filtration, rinsed with water (2 x 100 mL) and dried in vacuo to afford 8-bromo-6-methylimidazo[1,2-c]quinazolin-5(6H)-one (36.5 g, 94% yield) as an off-white powder.

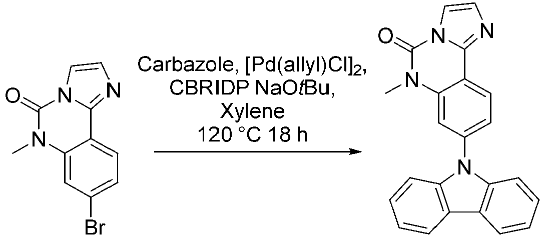

To a dry round bottom flask 8-bromo-6-methylimidazo[1,2-c]quinazolin-5(6H)-one (6.94 g, 24.95 mmol), sodium tert-butoxide (3.60 g, 37.4 mmol), and 9H-carbazole (12.52 g, 74.9 mmol) were suspended in Xylene (125 ml) which was placed under N2 atmosphere. Allylpalladium chloride dimer (0.457 g, 1.248 mmol) and cBRIDP (0.220 g, 0.624 mmol) were then added and the reaction heated to 120 °C and left to stir for 16 hours. The reaction was then cooled to room temperature and then filtered through celite. The celite was washed with THF (3 x 750 mL) and the solvent removed under reduced pressure. The crude material was used in the next step.

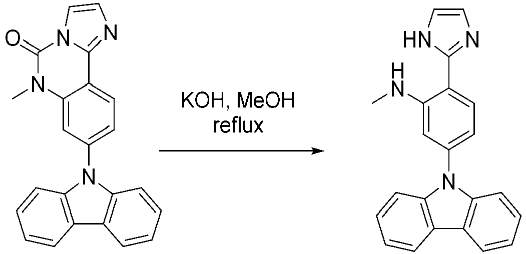

To a round bottom flask containing crude 8-(9H-carbazol-9-yl)-6-methylimidazo[1,2-c]quinazolin-5(6H)-one (9.09 g, 24.94 mmol) from previous step and KOH (14.00 g, 249 mmol) was added to MeOH (249 ml) and the reaction heated at reflux for 16 hours. The crude mixture was cooled to room temperature then filtered through celite. The celite was washed with THF (3 x 750 mL). The resulting filtrate was concentrated and purified by silica gel column chromatography to obtain 5-(9H-carbazol-9-yl)-2-(1H-imidazol-2-yl)-N-methylaniline (4.78 g, 56.6 % yield) as a pink solid.

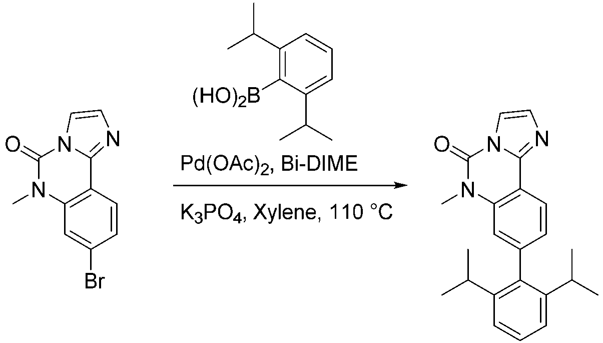

8-bromo-6-methylimidazo[1,2-c]quinazolin-5(6H)-one (8 g, 27.3 mmol), K3PO4 (17.40 g, 82 mmol) and (2,6-diisopropylphenyl)boronic acid (11.32 g, 54.7 mmol) were suspended in Xylene (400 ml) under N2. Bi-DIME (0.903 g, 2.73 mmol) and Palladium (II) acetate (0.307 g, 1.366 mmol) were added and the reaction mixture heated to 110 °C for 16 hours. The reaction mixture was cooled to room temperature, diluted with EtOAc (1 L) and water (0.75 L), the phases separated, the aqueous extracted with EtOAc (1 L), the combined organics dried over Na2SO4, filtered and concentrated in vacuo to give a brown oil that was further purified by silica gel column chromatography to obtain 8-(2,6-diisopropylphenyl)-6-methylimidazo[1,2-c]quinazolin-5(6H)-one (8.75 g, 87 % yield) as an off-white solid.

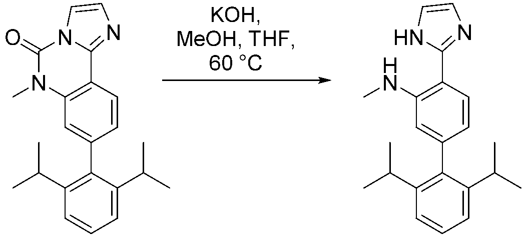

8-(2,6-diisopropylphenyl)-6-methylimidazo[1,2-c]quinazolin-5(6H)-one (8.75 g, 23.85 mmol) was dissolved in THF (200 ml) and MeOH (115 ml) under nitrogen. KOH (13.38 g, 239 mmol) was added and the reaction mixture heated to 60 °C for 21 h. The reaction mixture was cooled to room temperature, then concentrated in vacuo. The residual material was dissolved in EtOAc (400 mL) and water (400 mL). The aqueous layer was extracted with EtOAc (2 x 200 mL) and the combined organic extracts were washed with brine (150 mL), dried over Na2SO4, filtered and concentrated in vacuo to give an orange-brown solid, 4-(1H-imidazol-2-yl)-2',6'-diisopropyl-N-methyl-[1,1'-biphenyl]-3-amine (7.90 g, 97 % yield).

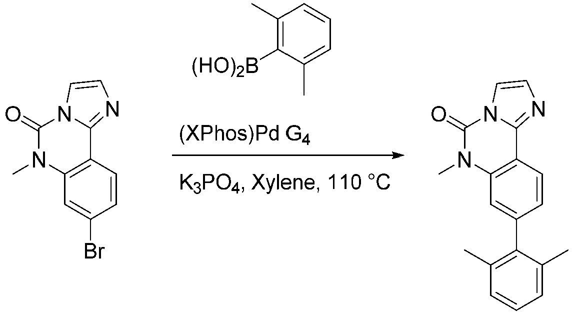

A mixture of 8-bromo-6-methylimidazo[1,2-c]quinazolin-5(6H)-one (2.85 g, 9.99 mmol), potassium phosphate (6.36 g, 30.0 mmol) and (2,6-dimethylphenyl)boronic acid (2.25 g, 15.00 mmol) in xylene (160 mL) was placed under N2 atmosphere. (XPhos)Pd G4 (430 mg, 0.500 mmol) was added and the mixture was heated to 110 °C for 1 h. The mixture was cooled to room temperature, filtered on celite and washed with EtOAc (150 mL). The filtrate was diluted with water (100 mL) and the aqueous layer was extracted with EtOAc (3 x 50 mL). The combined organic extracts were washed with brine (150 mL), dried over MgSO4, filtered and concentrated in vacuo. The crude product was triturated in MTBE (30 mL) and sonicated for 2 min, then filtered, washed with MTBE (2 x 30 mL) and dried in vacuo to afford 8-(2,6-dimethylphenyl)-6-methylimidazo[1,2-c]quinazolin-5(6H)-one (2.23 g, 73.6 % yield) as a colorless solid.

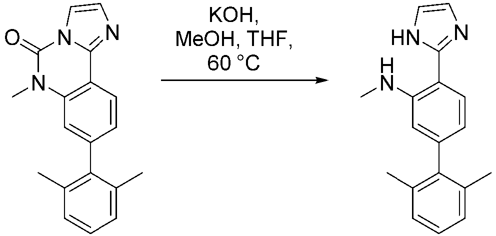

To a solution of 8-(2,6-dimethylphenyl)-6-methylimidazo[1,2-c]quinazolin-5(6H)-one (4.51 g, 14.87 mmol) in MeOH (30 mL) and THF (60 mL) under nitrogen, was added KOH (9.81 g, 149 mmol). The resulting mixture was stirred under N2 at 60 °C for 18 h. The mixture was cooled to room temperature, concentrated in vacuo and the residual material was dissolved in EtOAc (100 mL) and water (100 mL). The aqueous layer was extracted with EtOAc (3 x 50 mL) and the combined organic extracts were washed with brine (100 mL), dried over MgSO4, filtered and concentrated in vacuo. The crude product was purified by silica gel column chromatography to afford 4-(1H-imidazol-2-yl)-N,2',6'-trimethyl-[1,1'-biphenyl]-3-amine (3.78 g,

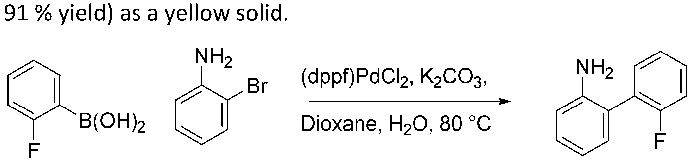

A mixture of 2-bromoaniline (25 g, 145 mmol), (2-fluorophenyl)boronic acid (21.4 g, 153 mmol) and K2CO3 (60 g, 434 mmol) in 1,4-dioxane (680 mL) and water (220 mL) was placed under N2 atmosphere. Then (dppf)PdCl2-CH2Cl2 adduct (5.90 g, 7.22 mmol) was added and the resulting mixture was stirred at 80 °C for 19 hours. The mixture was cooled to room temperature, filtered through celite and washed with EtOAc (2 x 100 mL). The filtrate was washed with H2O (300 mL) and brine (150 mL), dried (Na2SO4), filtered, concentrated, and purified by silica gel column chromatography to obtain 2'-fluoro-[1,1'-biphenyl]-2-amine (22.6 g, 82% yield) as a pale pink solid.

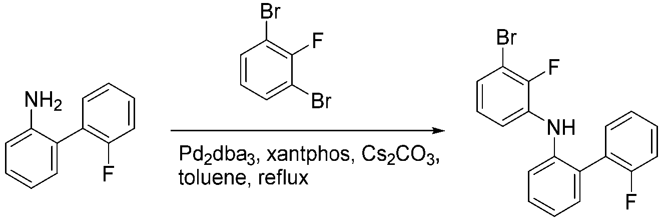

A mixture of 1,3-dibromo-2-fluorobenzene (13.5 g, 53.2 mmol), 2'-fluoro-[1,1'-biphenyl]-2-amine (5 g, 26.7 mmol) and Cs2CO3 (17.4 g, 53.4 mmol) in toluene (80 mL) was placed under N2, then Pd2(dba)3 (1.22 g, 1.332 mmol) and xantphos (1.55 g, 2.68 mmol) were added. The mixture was stirred at reflux for 3 days, cooled to room temperature, diluted with DCM (80 mL), filtered through celite and washed through with DCM (80 mL). The filtrate was concentrated, and the crude material was purified by silica gel column chromatography to obtain N-(3-bromo-2-fluorophenyl)-2'-fluoro-[1,1'-biphenyl]-2-amine (9.26 g, 90 % yield) as a pale yellow oil.

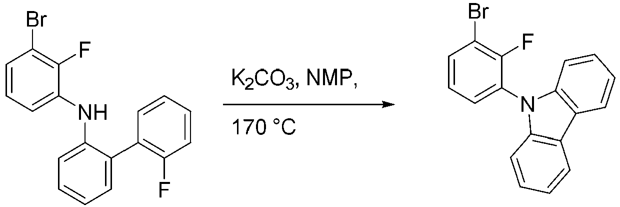

A mixture of N-(3-bromo-2-fluorophenyl)-2'-fluoro-[1,1'-biphenyl]-2-amine (9.26 g, 24.17 mmol) and K2CO3 (10.02 g, 72.5 mmol) in NMP (40 mL) was stirred at 170 °C for 22 hours The mixture was cooled to room temperature, diluted with water (120 mL) and extracted with EtOAc (3 x 80 mL). The combined organic phases were washed with water (80 mL) and brine (80 mL), dried (Na2SO4), filtered, concentrated, and purified by silica gel column chromatography to obtain 9-(3-bromo-2-fluorophenyl)-9H-carbazole (8.42 g, 94 % yield) as a colorless solid.

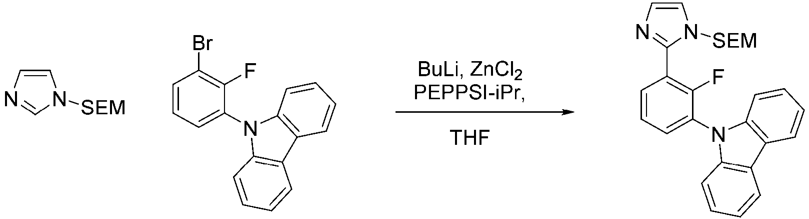

n-Butyllithium (1.6 M in hexanes; 24 mL, 38.4 mmol) was added over 5 min to a solution of 1-((2-(trimethylsilyl)ethoxy)methyl)-1H-imidazole (5.63 g, 28.4 mmol) in THF (100 mL) at -78 °C. The resulting mixture was stirred at -78 °C for 15 minutes, then zinc chloride, (1.9 M in MeTHF; 20 mL, 38.0 mmol) was added. The cooling bath was removed, and the mixture was allowed to warm to room temperature over 15 min. A mixture of PEPPSI-iPr (0.772 g, 1.136 mmol), 9-(3-bromo-2-fluorophenyl)-9H-carbazole (8.40 g, 22.72 mmol) and 1,4-Dioxane (100 mL) was added, and the resulting mixture was stirred at 110 °C for 21 hours. It was then cooled to room temperature, quenched with saturated aqueous NH4Cl (100mL), diluted with water (150 mL) and extracted with EtOAc (3 x 150 mL). The combined organic phases were dried (Na2SO4), filtered, concentrated, and purified by silica gel column chromatography to obtain 9-(2-fluoro-3-(1-((2-(trimethylsilyl)ethoxy)methyl)-1H-imidazol-2-yl)phenyl)-9H-carbazole (10.1 g, 72.9% yield, 75% purity) as a colorless solid that was carried forward without further purification.

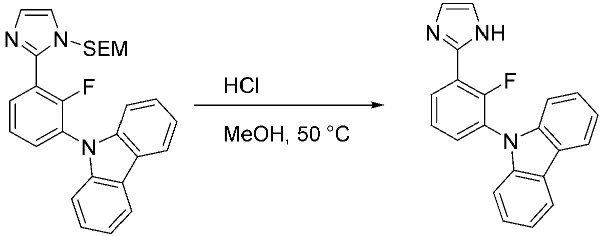

A solution of 9-(2-fluoro-3-(1-((2-(trimethylsilyl)ethoxy)methyl)-1H-imidazol-2-yl)phenyl)-9H-carbazole (13.3 g, 21.51 mmol) in HCl (3 M in MeOH; 250 mL, 750 mmol) was stirred at 50 °C for 4 days, cooled to room temperature and concentrated at 40 °C. Water (100 mL) and DCM (100 mL) were added, and the solid was collected by filtration and washed with water (20 mL) and DCM (20 mL) to give a grey solid. The solid was suspended in 2 M aqueous NaOH (200 mL) and 9:1 DCM:iPrOH (200 mL) and the mixture was stirred at room temperature for 1 hour until the solid was fully dissolved. The aqueous phase was further extracted with DCM (2 x 50 mL), and the combined organic phases were washed with brine (50 mL), dried (Na2SO4), filtered and concentrated to give 9-(2-fluoro-3-(1H-imidazol-2-yl)phenyl)-9H-carbazole (4.30 g, 58.0% yield) as a pale grey solid.

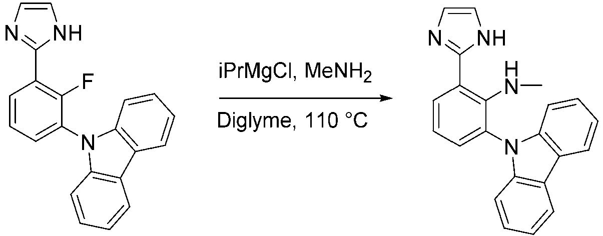

Methylamine (2 M in THF; 3.1 mL, 6.20 mmol) was added over 2 minutes to a solution of isopropylmagnesium chloride (2 M in THF; 3.8 mL, 7.60 mmol) in diglyme (8 mL) at 0 °C. The mixture was stirred at 0 °C for 1 hour, then a solution of 9-(2-fluoro-3-(1H-imidazol-2-yl)phenyl)-9H-carbazole (0.5 g, 1.527 mmol) in diglyme (6 mL) was added over 2 min. The mixture was stirred at 110 °C for 20 h, cooled to room temperature, and quenched with saturated aqueous NH4Cl (10 mL). The mixture was diluted with water (10 mL) and extracted with EtOAc (3 x 10 mL). The combined organic phases were dried (Na2SO4), filtered and concentrated to give a pale orange solid. DCM (10 mL) was added, followed by isohexane (10 mL). The suspension was stirred at room temperature for 1 h, and the solid was collected by filtration, washed with 1:1 DCM:isohexane (10 mL) and dried to give 2-(9H-carbazol-9-yl)-6-(1H-imidazol-2-yl)-N-methylaniline (0.476 g, 92 % yield) as an off-white solid.

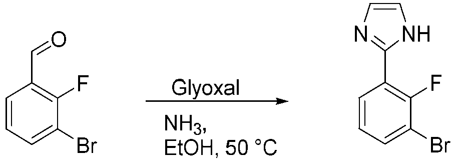

Ammonia (28%wt in H2O, 100 mL, 1.29 mol) was added to a stirred mixture of glyoxal (40%wt in H2O, 60 mL, 0.52 mol) and 3-bromo-2-fluorobenzaldehyde (25.0 g, 123 mmol) in EtOH (300 mL). The reaction mixture was stirred at 50 °C for 18 h, cooled to room temperature and concentrated in vacuo. Purification by silica gel column chromatography gave a dark brown solid (18 g). This solid was triturated in TBME (70 mL), filtered, rinsed with TBME (20 mL) and dried in vacuo to give 2-(3-bromo-2-fluorophenyl)-1H-imidazole (10.9 g, 36% yield) as a pale yellow solid.

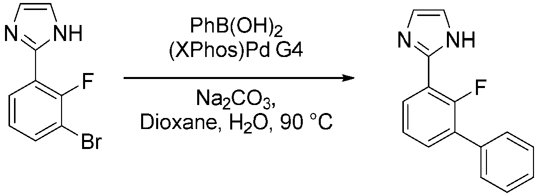

A mixture of 2-(3-bromo-2-fluorophenyl)-1H-imidazole (8.0 g, 33 mmol), phenylboronic acid (6.1 g, 50 mmol) and Na2CO3 (11.6 g, 110 mmol) in 1,4-dioxane (200 mL) and water (40 mL) was placed under N2 atmosphere. (XPhos)Pd G4 (1.43 g, 1.66 mmol) was added, and the mixture was stirred at 90 °C for 67 hours, cooled to room temperature and diluted with water (300 mL). The mixture was extracted with EtOAc (3 x 150 mL), and the combined organic phases were washed with brine (100 mL), dried (Na2SO4), filtered and concentrated. Purification by silica gel column chromatography gave 2-(2-fluoro-[1,1'-biphenyl]-3-yl)-1H-imidazole (7.16 g, 83% yield) as a pale brown solid.

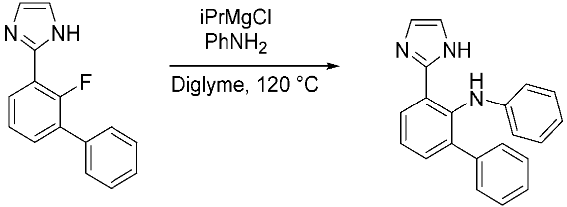

Aniline (11 mL, 120 mmol) was added over 5 minutes to a solution of isopropylmagnesium chloride (2 M in THF, 76 mL, 150 mmol) in diglyme (100 mL) at 0 °C. The mixture was stirred at 0 °C for 1 hour, then a solution of 2-(2-fluoro-[1,1'-biphenyl]-3-yl)-1H-imidazole (7.91 g, 30.5 mmol) in diglyme (80 mL) was added over 2 minutes. The mixture was stirred at 120 °C for 21 hours, cooled to room temperature, and quenched with saturated aqueous NH4Cl (250 mL). The mixture was diluted with water (150 mL) and extracted with EtOAc (3 x 150 mL). The combined organic phases were dried (Na2SO4), filtered and concentrated at 70 oC, the purified by silica gel column chromatography to obtain a pale brown solid that was then triturated with 4:1 isohexane:EtOAc (200 mL) and left overnight. The solid was collected by filtration, rinsed with 4:1 isohexane:EtOAc (50 mL) then isohexane (50 mL), and dried to give 3-(1H-imidazol-2-yl)-N-phenyl-[1,1'-biphenyl]-2-amine (7.25 g, 67% yield, 88% purity) as an off-white solid that was used without further purification.

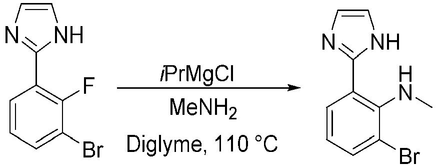

A solution of isopropylmagnesium chloride (2M in THF, 80 mL, 160 mmol) in diglyme (150 mL) was cooled to 0 °C and methylamine (2M in THF, 65 mL, 130 mmol) was added over 5 minutes. The mixture was stirred at 0 °C for 1 hour, and then a solution of 2-(3-bromo-2-fluorophenyl)-1H-imidazole (7.43 g, 30.8 mmol) in diglyme (120 mL) was added over 10 minutes. The resulting mixture was heated to 110 °C and stirred for 2.5 hours, then cooled to room temperature. The mixture was poured into saturated aqueous NH4Cl (300 mL), diluted with EtOAc (300 mL) and sonicated for 2 minutes. The layers were separated and the aqueous phase was extracted with EtOAc (3 x 150 mL). The combined organic extracts were washed with water (3 x 150 mL) and brine (200 mL), dried over MgSO4, filtered and concentrated. The crude product was purified by silica gel column chromatography to give 2-bromo-6-(1H-imidazol-2-yl)-N-methylaniline (6.24 g, 72% yield, >90% purity [7% wt solvents]) as an orange oil.

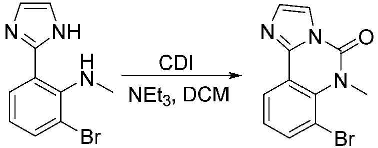

Triethylamine (7.7 mL, 55 mmol) was added to a mixture of 2-bromo-6-(1*H*-imidazol-2-yl)-*N*-methylaniline (90% wt, 6.24 g, 22.3 mmol) and CDI (5.40 g, 33.3 mmol) in DCM (70 mL). The resulting mixture was stirred at room temperature for 3 days. The mixture was concentrated *in vacuo* and the crude was triturated with water (80 mL), filtered, rinsed with water (3 x 20 mL) and dried *in vacuo* to give an orange solid. The aqueous filtrate was extracted with DCM (3 x 50 mL), the combined organic extracts were washed with water (2 x 20 mL) and brine (50 mL), then concentrated *in vacuo.* This extract was combined with the precipitated solid and purified by silica gel column chromatography to give 7-bromo-6-methylimidazo[1,2-c]quinazolin-5(6H)-one (6.03 g, 96% yield,) as a yellow solid.

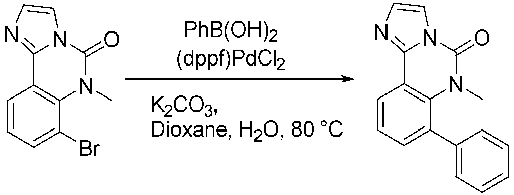

A mixture of 7-bromo-6-methylimidazo[1,2-c]quinazolin-5(6H)-one (6.03 g, 21.3 mmol), phenylboronic acid (2.90 g, 23.8 mmol) and K2CO3 (9.00 g, 65.1 mmol) in 1,4-dioxane (150 mL) and water (30 mL) was placed under N2 atmosphere. (dppf)PdCl2 (dcm adduct, 870 mg, 1.06 mmol) was added and the mixture was stirred at 80 °C under N2 for 48 hours. Further phenylboronic acid (2.90 g, 23.78 mmol) and (dppf)PdCl2 (dcm adduct, 870 mg, 1.06 mmol) were added and stirring continued at 80 °C for 4 hours. The mixture was cooled to room temperature, filtered through Celite and rinsed through with EtOAc (2 x 50 mL). The filtrate was diluted with water (150 mL), the layers were separated and the aqueous layer was extracted with EtOAc (3 x 100 mL). The combined organic extracts were washed with brine (150 mL), dried over MgSO4, filtered and concentrated. The crude product was purified by silica gel column chromatography to obtain 6-methyl-7-phenylimidazo[1,2-c]quinazolin-5(6H)-one (4.75 g, 75% yield) as a pale yellow solid.

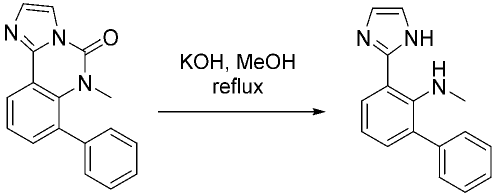

To a solution of 6-methyl-7-phenylimidazo[1,2-c]quinazolin-5(6H)-one (3.31 g, 11.4 mmol) in MeOH (15 mL) and THF (30 mL) under N2 was added KOH (3.70 g, 56.1 mmol). The mixture was stirred at 60 °C for 2 hours, then cooled to room temperature. The mixture was filtered and concentrated in vacuo. The residue was dissolved in EtOAc (100 mL) and water (100 mL) was added. The layers were separated and the aqueous layer was extracted with EtOAc (3 x 60 mL). The combined organic extracts were washed with brine (100 mL), dried over MgSO4, filtered and concentrated. Purification by silica gel column chromatography gave an orange oil that was subsequently was treated with 1:3 TBME/isohexane (10 mL), sonicated for 5 minutes and concentrated to give 3-(1H-imidazol-2-yl)-N-methyl-[1,1'-biphenyl]-2-amine (2.55 g, 84% yield) as a yellow-brown solid.

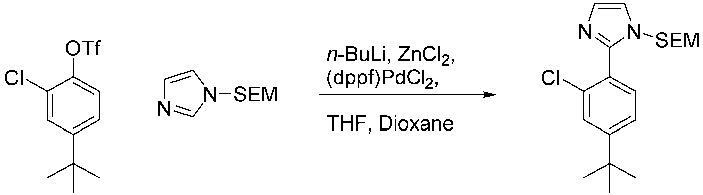

1-((2-(trimethylsilyl)ethoxy)methyl)-1H-imidazole (2.011 g, 10.14 mmol) was dissolved in THF (50 ml), then the resulting solution was cooled to -78 °C and n-butyllithium (2.5 M in hexanes, 4.06 ml, 10.14 mmol) was added. The mixture was stirred at this temperature for 15 minutes, then zinc(II) chloride solution (1.9M in 2Me-THF, 5.82 ml, 11.06 mmol) was added and the cooling bath was removed to allow the reaction mixture to warm to room temperature while stirring. Separately, 4-(tert-butyl)-2-chlorophenyl trifluoromethanesulfonate (2.92 g, 9.22 mmol) was combined with (dppf)PdCl2 (dcm adduct, 0.376 g, 0.461 mmol) and this mixture was added to the zincate solution. 1,4-dioxane (50 mL) was then added and the mixture was heated to active reflux to distill off THF. The solution was refluxed for 24 hours. It was then cooled to room temperature, quenched with saturated aqueous NH4Cl, then transferred to a separatory funnel using water and EtOAc. The organic and aqueous layers were separated, then the aqueous layer was extracted with EtOAc (3x). The combined organics were then washed with brine, dried (MgSO4), filtered, concentrated, and the resulting crude residue purified by silica gel column chromatography to obtain 2.70 g (80% yield) of 2-(4-(tert-butyl)-2-chlorophenyl)-1-((2-(trimethylsilyl)ethoxy)methyl)-1H-imidazole as an off-white solid.

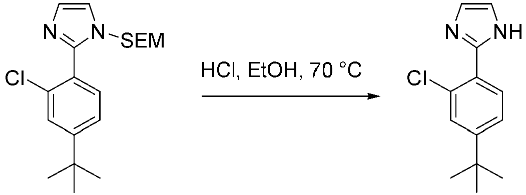

Dissolved 2-(4-(tert-butyl)-2-chlorophenyl)-1-((2-(trimethylsilyl)ethoxy)methyl)-1H-imidazole (2.7 g, 7.40 mmol) in Ethanol (50 ml), added hydrochloric acid (aqueous, 5M, 20 ml, 100 mmol) and stirred at 70 °C for 16 hours. The mixture was concentrated to dryness, then the resulting solid was suspended in saturated aqueous Na2CO3 and extracted with EtOAc three times. The organics were washed with brine, dried (Na2SO4), filtered, and concentrated to obtain 1.29 g (74% yield) of 2-(4-(tert-butyl)-2-chlorophenyl)-1H-imidazoleas an off-white solid (74%).

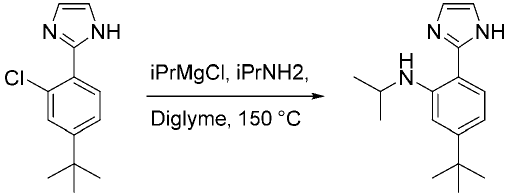

Isopropylamine (0.816 ml, 9.97 mmol) and 2-(4-(tert-butyl)-2-chlorophenyl)-1H-imidazole (0.936 g, 3.99 mmol) were combined in diglyme (20 ml) under N2 and cooled to 0 °C. Isopropylmagnesium chloride solution in THF (5.98 ml, 11.96 mmol) was added, then the resulting suspension was warmed to room temperature. The mixture was then heated to 150 °C for 2 days. The mixture was cooled to room temperature, quenched with saturated aqueous NH4Cl, diluted further with EtOAc and water and transferred to a separatory funnel. The aqueous and organic layers were separated, then the organics were washed with brine, dried (Na2SO4), filtered, concentrated, and purified by silica gel column chromatography to obtain 0.42 g (41% yield) of 5-(tert-butyl)-2-(1H-imidazol-2-yl)-N-isopropylaniline as a colorless solid.

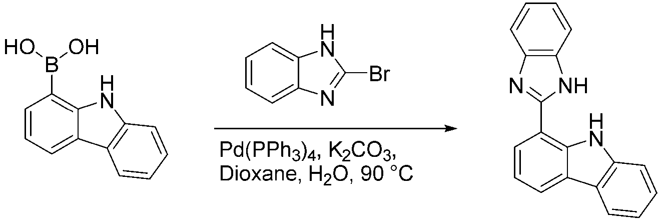

(9H-carbazol-1-yl)boronic acid (2.110 g, 9.999 mmol), 2-bromo-1H-benzo[d]imidazole (2.364 g, 12.00 mmol), and potassium carbonate (4.145 g, 3.0 Eq, 30.00 mmol) were combined in a mixture of 1,4- Dioxane (41.66 mL) and Water (8.332 mL) in a 250 mL round bottom flask and sparged with N2 for 5 minutes. Tetrakis(triphenylphosphine) Palladium(0) (577.7 mg, 499.9 µmol) was added followed by continued sparging for 3 minutes. The reaction mixture was then heated to 90 °C for 16 hours. The reaction mixture was cooled to room temperature and poured into water (100 mL). The aqueous layer was extracted with ethyl acetate (3 x 100 mL). The combined organic extracts were dried over sodium sulfate (10 g), filtered, and concentrated under reduced pressure. The crude residue was purified by silica gel column chromatography to give 2.14 g (76% yield) of 1-(1H-benzo[d]imidazol-2-yl)-9H-carbazole as a light yellow solid.

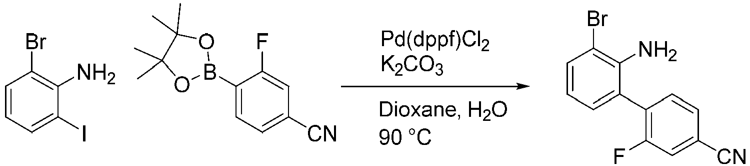

A stirred mixture of 2-Bromo-6-iodoaniline (66.1 g, 222 mmol), 3-fluoro-4-(4,4,5,5-tetramethyl-1,3,2-dioxaborolan-2-yl)benzonitrile (57.6 g, 233 mmol), Potassium carbonate (61.3 g, 444 mmol) and 1,1'-Bis(diphenylphosphino)ferrocenepalladium (II) dichloride (3.26 g, 4.44 mmol) in 1,4-dioxane (600 mL) and water (150 mL) under N2 atmosphere was stirred at 90 oC for 45 mins. Further 3-fluoro-4-(4,4,5,5-tetramethyl-1,3,2-dioxaborolan-2-yl)benzonitrile (3.29 g, 13.3 mmol) was added and the reaction mixture was stirred at 90 oC for a further 30 mins. The reaction mixture was cooled to room temperature then diluted with EtOAc (600 mL) and washed with half saturated brine (2 x 400 mL), brine (400 mL), dried (Na2SO4), filtered and concentrated in vacuo to provide the crude product as an orange solid. The solid was triturated from MeOH, washed with pentane and dried in vacuo to provide a first crop of product. The mother liquors were concentrated in vacuo and triturated from MeOH then washed with pentane to provide a second crop of product. The mother liquors were concentrated in vacuo and purified by silica gel plug eluting with neat DCM and concentrated in vacuo to provide a crude third crop of product. The three crops were combined and dried in vacuo to provide 4-(2-amino-3-bromo-phenyl)-3-fluoro-benzonitrile (61.2 g, 210 mmol, 95% yield) as a tan solid.

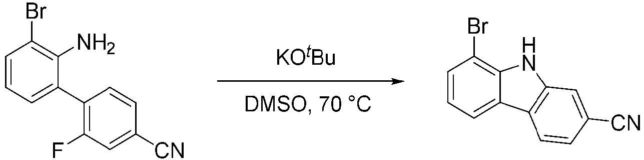

To a solution of 4-(2-amino-3-bromo-phenyl)-3-fluoro-benzonitrile (61.2 g, 210 mmol) in anhydrous dimethyl sulfoxide (600 mL) was added potassium tert-butoxide (47.2 g, 420 mmol). The reaction mixture was placed under N2 atmosphere then heated to 70 oC while stirring for 30 mins. The reaction mixture was cooled to room temperature, diluted with EtOAc (500 mL), cooled to 0 oC, poured into a separating funnel, washed with ice-cold half saturated aqueous NH4Cl (2.00 L). The organics were separated. The aqueous was back extracted with EtOAc (2 x 500 mL) and the combined organic extracts were washed with brine (1.00 L), dried (Na2SO4), filtered and concentrated in vacuo to provide the crude product. The crude product was triturated from MeOH then washed with pentane and dried in vacuo to provide a first crop of product. The mother liquors were concentrated then triturated from MeOH, washed with pentane and dried in vacuo to provide a second crop of product. The two crops were combined then dried in vacuo to provide 8-bromo-9H-carbazole-2-carbonitrile (34.1g, 126 mmol, 60% yield) as a tan solid.

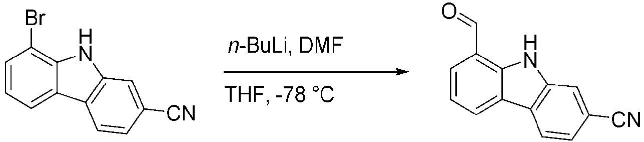

To a cooled (-78 °C) solution of 8-bromo-9H-carbazole-2-carbonitrile (25.3 g, 93.3 mmol) in anhydrous tetrahydrofuran (373 mL) was added n-Butyllithium (2.5 M, 90 mL, 224 mmol) dropwise over 30 minutes. The reaction mixture was stirred at -78 °C for 30 minutes then N,N-dimethylformamide (14 mL, 187 mmol) was added over 10 minutes. The reaction mixture was stirred at -78 °C for 30 mins and then quenched with sat. aq. NH₄Cl (100 mL) and allowed to warm to 20 °C. The resulting mixture was partitioned between EtOAc (300 mL) and water (100 mL). The organics were separated and the aqueous was back extracted with EtOAc (2 x 100 mL). The combined organic extracts were washed with brine, dried (Na2SO4), passed through a phase separator and concentrated in vacuo to provide the crude product. The crude product was triturated twice from warm (50 °C) methanol, with the solid washed with cold methanol followed by pentane and dried in vacuo. The resultant solid was triturated twice from warm (50 °C) acetone with the solid washed with cold acetone followed by pentane and dried in vacuo to provide 8-formyl-9H-carbazole-2-carbonitrile (12.0 g, 54.5 mmol, 58% yield) as a tan solid.

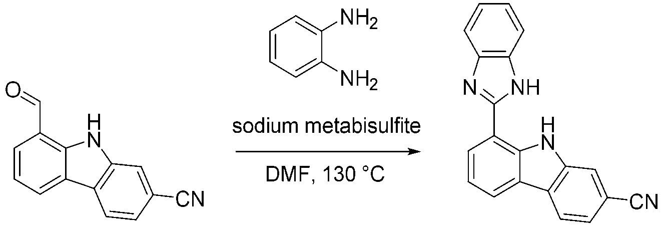

A mixture of 8-formyl-9H-carbazole-2-carbonitrile (12.0 g, 54.5 mmol) , 1,2-Phenylenediamine (6.07 g, 56.1 mmol) and Sodium metabisulfite (25.89 g, 136 mmol) in N,N-dimethylformamide (136 mL) under N2 atmosphere and then heated to 130 °C for 1 hour. The reaction mixture was allowed to cool to room temperature, poured into water (600 mL), and the resulting precipitate collected by filtration. The residue was washed with water (3x), then MeOH (2x), then pentane. The solid was collected and dried in vacuo to provide the crude product. The crude product was triturated twice from warm (50 °C) methanol, with the solid washed with cold methanol followed by pentane and dried in vacuo. The resultant solid was triturated twice from warm (50 °C) acetone with the solid washed with cold acetone followed by pentane and dried in vacuo to provide 8-(1H-benzimidazol-2-yl)-9H-carbazole-2-carbonitrile, (13.3g, 43.1 mmol, 79% yield) as a pale yellow solid.

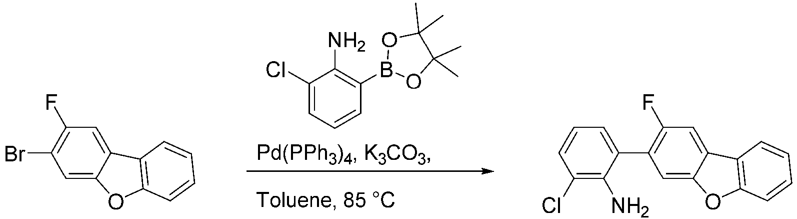

In a 1 L round bottom flask, 3-bromo-2-fluorodibenzo[b,d]furan 825-4 (20.00 g, 75.45 mmol), potassium carbonate (20.85 g, 150.9 mmol) and 2- chloro-6-(4,4,5,5-tetramethyl-1,3,2-dioxaborolan-2-yl)aniline (28.69 g, 113.2 mmol) were combined in 1,4-dioxane (200.00 mL) and water (50.00 mL). and the resulting solution was placed under N2, then tetrakis(triphenylphosphine)palladium(0) (21.251 g, 18.390 mmol) was added. The reaction mixture was heated to 85 °C for 16 hours. The reaction was cooled to room temperature and diluted with ethyl acetate (200 mL) and water (200 mL). The organic and aqueous layers were separated, then the aqueous layer was extracted with ethyl acetate (2 x 100 mL). The organics were combined and dried over Na2SO4, filtered, and concentrated to a crude residue that was purified by silica gel column chromatography to 2-chloro-6-(2-fluorodibenzo[b,d]furan-3-yl)aniline as a colorless solid (16.2 g, 68.9% yield).

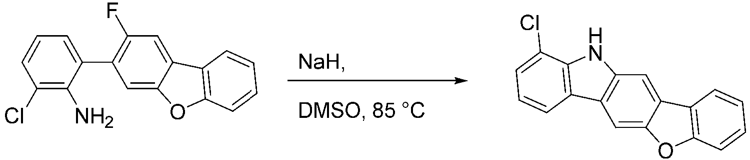

In a 500 mL round bottom flask, 2-chloro-6-(2-fluorodibenzo[b,d]furan-3-yl)aniline (16.00 g, 51.32 mmol) in DMSO (200.00 mL) was placed under N2. NaH (3.695 g, 154.0 mmol) was added to the solution and the reaction mixture was heated to 120 °C and stirred for 72 hours. After cooling to room temperature, dichloromethane (500 mL) and water (500 mL) were added and the mixture was transferred to a separatory funnel. The organic and aqueous layers were separated, and the aqueous layer was extracted with dichloromethane (100 mL) twice. The combined organic layers were dried over anhydrous sodium sulphate, filtered, and concentrated under reduced pressure. The crude product was purified by silica gel column chromatography to obtain 10-chloro-11H-benzofuro[3,2-b]carbazole as a colorless solid (11.4 g, 76.1% yield).

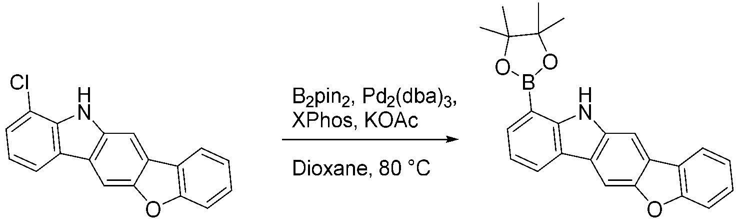

In a 500 mL round bottom flask, 10-chloro-11H-benzofuro[3,2- b]carbazole (6.000 g, 20.57 mmol), bis(pinacolato)diboron (10.45 g, 41.13 mmol) and 2-(Dicyclohexylphosphanyl)-2',4',6'-tris(isopropyl)biphenyl (XPhos 1.961 g, 4.113 mmol) were combined in 1,4-Dioxane (100.00 mL) and the solution placed under N2 atmosphere. Pd2(dba)3 (941.7 mg, 1.028 mmol) was added, then the reaction mixture was heated to 80 °C for 16 hours. The reaction mixture was cooled to room temperature and diluted with ethyl acetate (200 mL) and water (200 mL). The aqueous and organic layers were separated, then the aqueous layer was extracted with ethyl acetate (2 x 50 mL). The organics were combined and dried over anhydrous Na2SO4, filtered, concentrated, and purified by silica gel column chromatography to obtain 10-(4,4,5,5-tetramethyl-1,3,2-dioxaborolan-2-yl)-11H-benzofuro[3,2-b]carbazole as off-white solid (3.2 g, 41% yield).

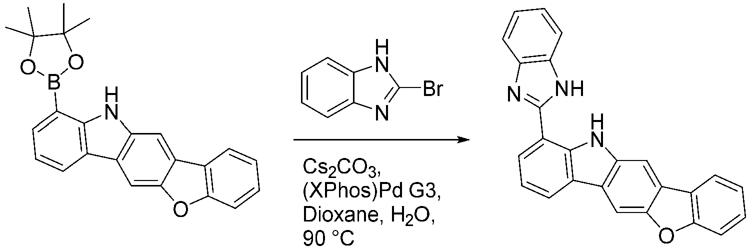

10-(4,4,5,5-tetramethyl-1,3,2-dioxaborolan-2-yl)-11H-benzofuro[3,2-b]carbazole (199.6 mg, 96% Wt, 500 µmol), 2-bromo-1H-benzo[d]imidazole (118.2 mg, 600.0 µmol), and cesium carbonate (488.7 mg, 1.500 mmol) were combined in a mixture of 1,4-dioxane (4.2 mL) and Water (830 µL) in a 20 mL scintillation vial. The reaction mixture was placed under N2 atmosphere and (Xphos)Pd G3 (42.32 mg, 50.00 µmol) was added. The vial was sealed, and the reaction mixture was heated to 90 °C for 16 hours. The reaction mixture was cooled to room temperature and additional (Xphos)Pd G3 (42.32 mg, 25.00 µmol) was added. The vial was resealed under N2 atmosphere and heating continued at 90 °C for 3 days. The reaction mixture was cooled to room temperature and diluted with water and EtOAc. The layers were separated, and the organics were dried over sodium sulfate, filtered, and concentrated to a crude yellow solid that was purified by silica gel column chromatography to obtain 10-(1H-benzo[d]imidazol-2-yl)-11H-benzofuro[3,2-b]carbazole (80. mg, 43% yield) as a light yellow solid.

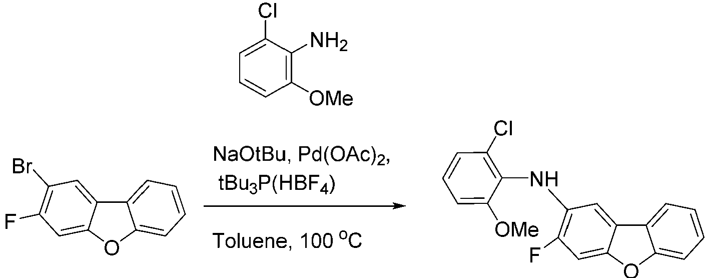

A solution of 2-bromo-3-fluorodibenzo[b,d]furan (16.9 g, 63.8 mmol) and sodium tert-butoxide (17.8 g, 185 mmol) in anhydrous toluene (200 mL) at 22 °C was placed under N2 atmosphere. 2-Chloro-6-methoxyaniline (9.13 g, 58.0 mmol) was added, followed by palladium(II) acetate (650 mg, 2.90 mmol) and tri-tert-butylphosphonium tetrafluoroborate (1.68 g, 5.80 mmol). The reaction mixture was heated to 100 °C for 2 hours. The reaction mixture was cooled to room temperature, diluted with EtOAc (300 mL) and quenched with sat. NH4Cl solution (400 mL). The resulting biphasic mixture was partitioned and the aqueous layer extracted with DCM (3 x 250 mL). The combined organics were concentrated and the crude product mixture was purified by silica gel column chromatography to afford N-(2-chloro-6-methoxyphenyl)-3-fluorodibenzo[b,d]furan-2-amine (15.7 g, 77 % yield) as a pale brown solid.

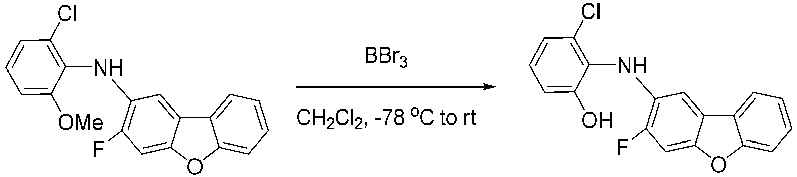

To a solution of N-(2-chloro-6-methoxyphenyl)-3-fluorodibenzo[b,d]furan-2-amine (15.7 g, 45.9 mmol) in anhydrous dichloromethane (450 mL) at -60 °C under a nitrogen atmosphere was added boron tribromide in dichloromethane (110 mL, 1.000 molar, 110 mmol) dropwise. The reaction mixture was allowed to warm to 0 °C and stirred for 1 hour. Additional dichloromethane (150 mL) was added and the reaction mixture was left to stir at 0 °C for 1 hour. The reaction mixture was gradually warmed to 22 °C and left to stir for 2 hours, then cooled to 0 °C and quenched with water (250 mL). The resulting organic layer was separated, and the aqueous layer was extracted with CH2Cl2 (3 x 250 mL). The combined organic layers were washed with sat. NH4Cl solution (3 x 250 mL) dried over MgSO4 and concentrated in vacuo. The crude material was purified by silica gel column chromatography to afford 3-chloro-2-((3-fluorodibenzo[b,d]furan-2-yl)amino)phenol (13.4 g, 85 % yield) as a colorless solid.

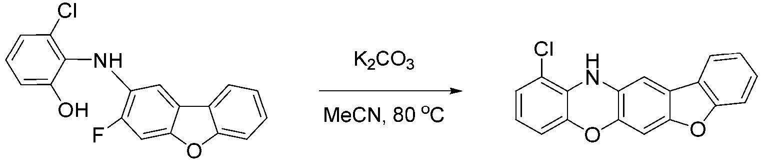

To a solution of 3-chloro-2-((3-fluorodibenzo[b,d]furan-2-yl)amino)phenol (13.4 g, 40.9 mmol) in anhydrous MeCN (650 mL) under a N2 atmosphere at 22 °C was added potassium carbonate (8.50 g, 61.5 mmol). The reaction mixture was heated to 80 °C and stirred for 3 hours. The reaction mixture was cooled to room temperature and quenched with water (1.0 L). The resulting solids were isolated via filtration, washed with water (3 x 500 mL) and suspended in DCM (500 mL). The organic layer was washed with saturated aqueous NH4Cl (500 mL), dried over MgSO4 and concentrated in vacuo to afford 11-chloro-12H-benzofuro[3,2-b]phenoxazine (11.9 g, 91% yield) as a grey solid.

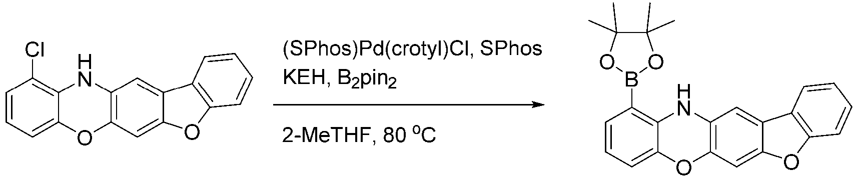

A flask containing 11-chloro-12H-benzofuro[3,2-b]phenoxazine (12.6 g, 40.9 mmol), bis(pinacolato)diboron (B₂pin₂, 15.5 g, 61.0 mmol), (Sphos)Pd(crotyl)Cl (1.25 g, 2.06 mmol) and SPhos (850 mg, 2.07 mmol) was placed under N2 atmosphere. A solution of potassium 2-ethylhexanoate (KEH) in 2-MeTHF (13.7 g, 150 mL, 0.500 molar, 75.0 mmol) and additional dry 2-MeTHF (20.0 mL) were added at 22 °C. The reaction mixture was heated to 80 °C for 2 hours, then cooled to room temperature and MeOH (250 mL) was added dropwise with stirring. The resulting solids were isolated via filtration, washed with MeOH (3 x 100 mL) and dried in vacuo to afford 11-(4,4,5,5-tetramethyl-1,3,2-dioxaborolan-2-yl)-12H-benzofuro[3,2-b]phenoxazine (13.6 g, 80 % yield) as a grey solid.

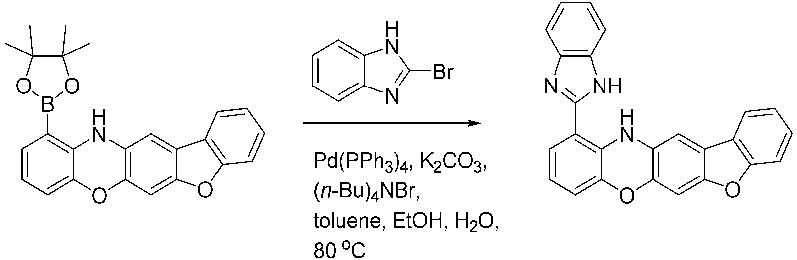

In a 40 mL scintillation vial, 11-(4,4,5,5-tetramethyl-1,3,2-dioxaborolan-2-yl)-12H-benzofuro[3,2-b]phenoxazine (226.9 mg, 88% Wt, 500.1 µmol), 2-bromo-1H-benzo[d]imidazole (118.3 mg, 600.1 µmol), potassium carbonate (207.3 mg, 1.500 mmol), and tetrabutylammonium bromide (16.12 mg, 50.01 µmol) were combined in a mixture of toluene (2.9 mL), ethanol (1.4 mL), and Water (0.71 mL). The reaction mixture was placed under N2 atmosphere, then tetrakis(triphenylphosphine)palladium(0) (28.90 mg, 25.01 µmol) was added. The vial was sealed, and the reaction was heated to 80 °C for 16 hours. The reaction mixture was cooled to room temperature and poured into water (50 mL). The aqueous layer was extracted with dichloromethane (2 x 40 mL) and ethyl acetate (2 x 40 mL). The combined organic layers were dried over sodium sulfate (5 g), filtered, and concentrated under reduced pressure. The crude mixture was then purified by silica gel column chromatography to obtain 11-(1H-benzo[d]imidazol-2-yl)-12H-benzofuro[3,2-b]phenoxazine (88. mg, 45% yield) as a yellow solid.

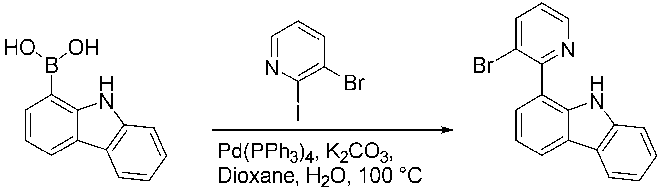

3-bromo-2-iodopyridine (7.399 g, 26.06 mmol) and (9H-carbazol-1-yl)boronic acid (5.000 g, 23.69 mmol) were combined in 1,4-dioxane (70.00 mL) under N2 atmosphere. A solution of potassium carbonate (6.549 g, 47.39 mmol) in Water (14.00 mL) was added, followed by tetrakis(triphenylphosphine)palladium(0) (1.369 g, 1.185 mmol). The reaction mixture was then heated to 100 °C for 16 hours. The mixture was cooled to room temperature, then diluted with water and the resulting solids collected by filtration. These solids were then re-dissolved in EtOAc (50 mL) and the solution was layered with hexanes (100 mL). The resulting mixture was left for 2 days, resulting in formation of crystalline material that was collected by filtration and washed with heptanes to obtain 3.0 g (39% yield) of 1-(3-bromopyridin-2-yl)-9H-carbazole as an off-white solid.

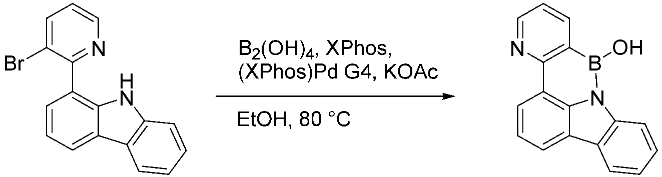

To an oven dried 40 mL vial was added Methanesulfonato(2-dicyclohexylphosphino-2',4',6'-tri-i-propyl-1,1'-biphenyl)(2'- methylamino-1,1'-biphenyl-2-yl)palladium(II) ((XPhos)Pd G4), 1.599 g, 1.856 mmol), 2-(Dicyclohexylphosphanyl)-2',4',6'- tris(isopropyl)biphenyl (2.655 g, 5.569 mmol), Hypodiboric acid (4.993 g, 55.69 mmol), and Potassium acetate (5.466 g, 55.69 mmol) and 1-(3-bromopyridin-2-yl)-9H-carbazole (6.000 g, 18.56 mmol). EtOH (50.00 mL) was added via syringe and the resulting mixture was heated to 80 °C for 16 hours. The mixture was then concentratd and purified by silica gel column chromatography to obtain 1.0 g (19% yield) of 8H-pyrido[3',2':3,4][1,2]azaborinino[5,6,1-jk]carbazol-8-ol as a yellow solid.

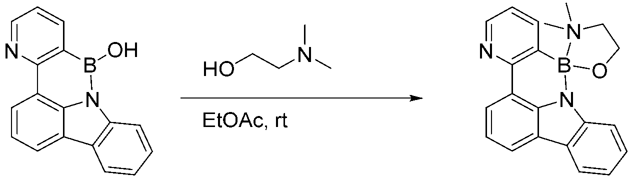

8H-pyrido[3',2':3,4][1,2]azaborinino[5,6,1-jk]carbazol-8-ol (2.020 g, 7.479 mmol) was dissolved in Ethyl acetate (25.00 mL) and then added N,N-dimethylethanolamine (733.3 mg, 830 µL, 8.227 mmol) and the resulting solution was stirred at room temperature for 16 hours. The mixture was then concentrated to dryness, then the resulting solids were suspended in diethyl ether and collected by vacuum filtration to give 1.40 g (55% yield) of 3',3'-dimethyl-3'I4,8I4-spiro[pyrido[3',2':3,4][1,2]azaborinino[5,6,1-jk]carbazole-8,2'-[1,3,2]oxazaborolidine] as a yellow solid.

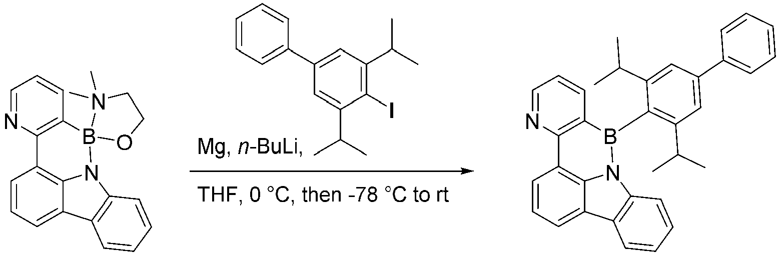

A 40 mL vial containing 4-iodo-3,5-diisopropyl-1,1'-biphenyl (80.07 mg, 219.8 µmol) was charged with THF (3.000 mL) placed under N2 atmosphere and cooled to 0 °C. Mg(0) (5.0 mg, 0.21 mmol) was then added and the reaction mixture was allowed to warm to room temperature and stir for 6 hour. An aliquot taken for analysis revealed no conversion of iodide starting material, so the reaction was further cooled to -78 °C and n-butyllithium (2.5 M, 0.082 mL, 0.21 mmol) was added dropwise via syringe. After 5 minutes, solid 3',3'-dimethyl-3'I4,8I4-spiro[pyrido[3',2':3,4][1,2]azaborinino[5,6,1-jk]carbazole-8,2'-[1,3,2]oxazaborolidine] (50 mg, 0.15 mmol) was added all at once. The cooling bath was removed and the reaction mixture was allowed to ambiently warm to room temperature while stirring for 16 hours. The reaction was quenched by addition of saturated aqueous NH4Cl, then diluted further with water and ethyl acetate and transferred to a separatory funnel. The organic and aqueous layers were separated, and the aqueous was further extracted with ethyl acetate (twice). The combined organics were washed with brine, dried over Na2SO4, filtered, concentrated, and purified by silica gel column chromatography to obtain 15 mg (21% yield) of 8-(3,5-diisopropyl-[1,1'-biphenyl]-4-yl)-8H-pyrido[3',2':3,4][1,2]azaborinino[5,6,1-jk]carbazole as a pale yellow solid.

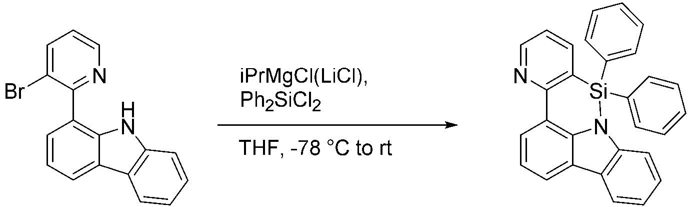

1-(3-bromopyridin-2-yl)-9H-carbazole (50.00 mg, 154.7 µmol) was dissolved in THF (2.000 mL) in a reaction vial and cooled to -78 °C under N2 atmosphere. Isopropylmagnesium chloride lithium chloride complex (270.5 µL, 1.300 molar, 351.6 µmol) was added dropwise via syringe, then stirring was continued for 30 minutes at the same temperature before allowing to warm to room temperature ambiently while stirring over 1 hour. Dichlorodiphenylsilane (44.37 µL, 211.0 µmol) was then added and the mixture was heated to 60 °C for 16 hours. The reaction was quenched by addition of saturated aqueous NH₄Cl, then diluted further with water and ethyl acetate and transferred to a separatory funnel. The organic and aqueous layers were separated, and the aqueous was further extracted with ethyl acetate (twice). The combined organics were washed with brine, dried over Na2SO4, filtered, concentrated, and purified by silica gel column chromatography to obtain 50 mg (84% yield) of 8,8-diphenyl-8H-pyrido[3',2':3,4][1,2]azasilino[5,6,1-jk]carbazole as a pale yellow solid.

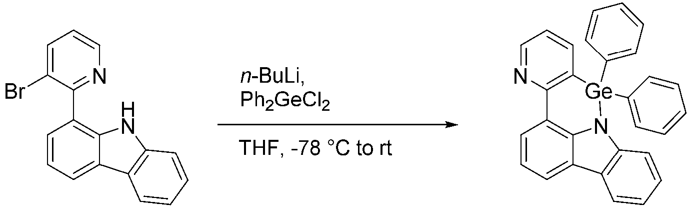

1-(3-bromopyridin-2-yl)-9H-carbazole (250. mg, 774 µmol) was dissolved in THF (2.000 mL) in a reaction vial and cooled to -78 °C under N2 atmosphere. n-Butylllithium (2.5 M in hexane, 0.647 mL, 1.68 mmol) was added dropwise via syringe, then stirring was continued for 30 minutes at the same temperature Dichlorodiphenylgermane (0.148 mL, 701.0 µmol) was then added and the mixture was heated to 60 °C for 16 hours. The reaction was quenched by addition of saturated aqueous NH4Cl, then diluted further with water and ethyl acetate and transferred to a separatory funnel. The organic and aqueous layers were separated, and the aqueous was further extracted with ethyl acetate (twice). The combined organics were washed with brine, dried over Na2SO4, filtered, concentrated, and purified by silica gel column chromatography to obtain 20 mg (7.0% yield) of 8,8-diphenyl-8H-pyrido[3',2':3,4][1,2]azagermino[5,6,1-jk]carbazole as a pale yellow solid.

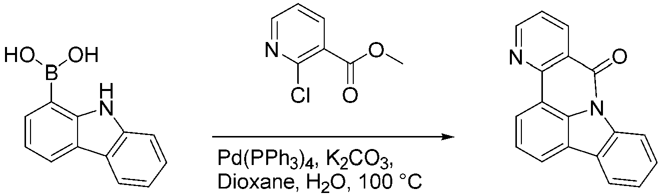

Methyl 2-chloronicotinate (1.789 g, 10.43 mmol) was combined with (9H-carbazol-1-yl)boronic acid (2.000 g, 9.477 mmol) in 1,4-dioxane (30.000 mL) and placed under N2 atmosphere. A solution of potassium carbonate (2.620 g, 18.95 mmol) in Water (6.0000 mL) was added, followed by tetrakis(triphenylphosphine)palladium(0) (547.6 mg, 473.9 µmol). The reaction mixture was then heated to 100 °C for 16 hours. The mixture was then cooled to room temperature and transferred to a separatory funnel using EtOAc and water. The aqueous and organic layers were separated, then the aqueous was extracted with EtOAc (3x50 mL). The combined organics were washed with brine (100 mL), dried over Na2SO4, filtered, concentrated, and purified by silica gel column chromatography to obtain 2.1 g (82% yield) of 8H-[1,6]naphthyridino[8,7,6-jk]carbazol-8-one as an off-white solid.

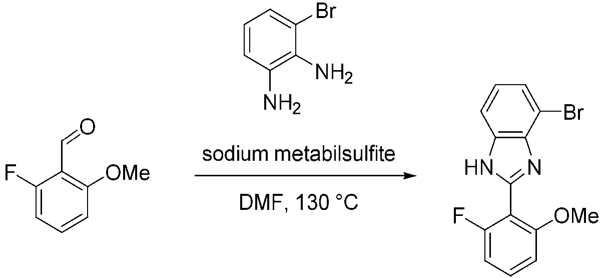

A 1 L three-necked round bottom flask fitted with a reflux condenser was charged with 2-Fluoro-6-methoxybenzaldehyde (10.00 g, 64.9 mmol), 3-Bromobenzene-1,2-diamine (12.13 g, 64.9 mmol), Sodium metabisulfite (30.83 g, 162 mmol), and N,N-dimethylformamide (250 mL) under N2 atmosphere. The reaction was heated at 130 °C for 3 hours. The reaction mixture was allowed to cool to room temperature, poured onto ice and stirred for 15 minutes. The resulting beige precipitate was collected by filtration and washed twice with water before drying under reduced pressure. 4-bromo-2-(2-fluoro-6-methoxy-phenyl)-1H-benzimidazole (18.13 g, 87.0% yield).

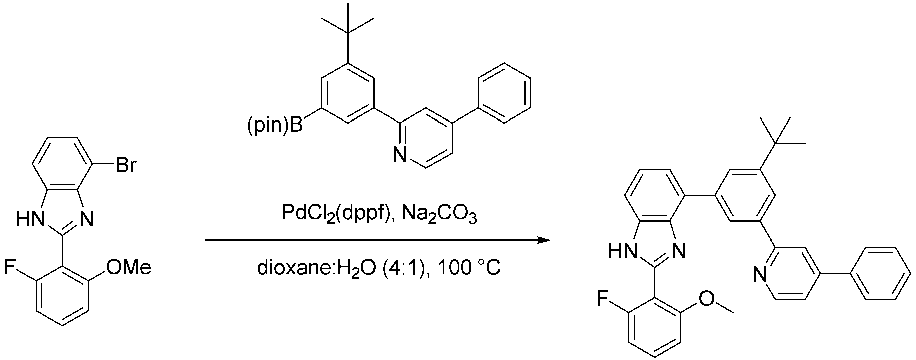

A 1 L round bottom flask was charged with 4-bromo-2-(2-fluoro-6-methoxy-phenyl)-1H-benzimidazole (15.00 g, 46.7 mmol), PdCl2(dppf) (1.72 g, 2.34 mmol), 2-(3-(tert-butyl)-5-(4,4,5,5-tetramethyl-1,3,2-dioxaborolan-2-yl)phenyl)-4-phenylpyridine (20.27 g, 49.0 mmol), and sodium carbonate (9.90 g, 93.4 mmol). The flask was evacuated and backfilled thrice with N2 before degassed 1,4-dioxane (300 mL) and water (75 mL) were added. The mixture was heated to 100 °C with stirring for 3 hours. The reaction mixture was then cooled to room temperature and filtered through a pad of Celite, washing with EtOAc. The filtrate was concentrated in vacuo, then diluted with EtOAc (200 mL) and water (200 mL). The aqueous and organic layers were separated, then the aqueous layer was extracted with EtOAc (3 × 100 mL) and the combined organics were passed through a hydrophobic frit before being concentrated in vacuo to yield a crude brown solid that was purified by silica gel column chromatography to provide 4-(3-(tert-butyl)-5-(4-phenylpyridin-2-yl)phenyl)-2-(2-fluoro-6-methoxyphenyl)-1H-benzo[d]imidazole as a colorless solid (23.86 g, 92.9% yield).

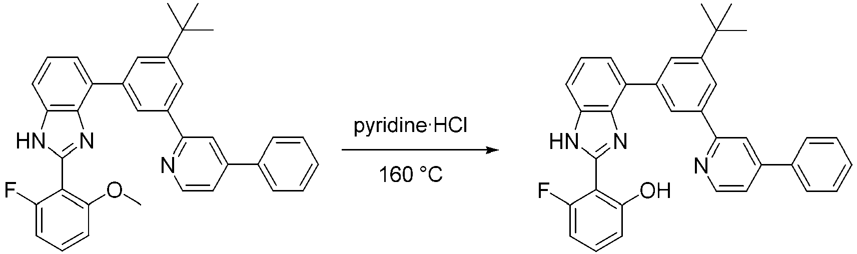

4-(3-(tert-butyl)-5-(4-phenylpyridin-2-yl)phenyl)-2-(2-fluoro-6-methoxyphenyl)-1H-benzo[d]imidazole (23.86 g, 45.2 mmol) and pyridine hydrochloride (40.00 g, 346 mmol) were heated to 160 ºC under N2 atmosphere for 3 h hours. The mixture was cooled to room temperature and diluted with EtOAc and saturated aqueous NaHCO3. The organic layer was collected, washed with brine, and passed through a hydrophobic frit before being concentrated in vacuo to yield the crude residue that was purified by silica gel column chromatography to obtain 2-(4-(3-(tert-butyl)-5-(4-phenylpyridin-2-yl)phenyl)-1H-benzo[d]imidazol-2-yl)-3-fluorophenol as a colorless solid (19.92 g, 85.6% yield).

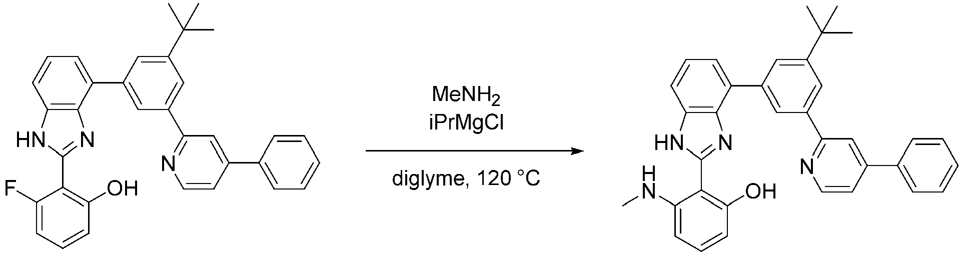

A mixture of isopropyl magnesium chloride (2.0 M in THF) (39.0 mL, 77.9 mmol) in diglyme (40 mL) was cooled to 0 ºC and methylamine (39.0 mL, 77.9 mmol) was added. The resulting mixture was stirred at 0 ºC for 1 hour, then a solution of 2-(4-(3-(tert-butyl)-5-(4-phenylpyridin-2-yl)phenyl)-1H-benzo[d]imidazol-2-yl)-3-fluorophenol (8.00 g, 15.6 mmol) in diglyme (40 mL) was added. The reaction mixture heated to 120 ºC and stirred for 4 hours. The mixture was cooled to room temperature and quenched with saturated aqueous NH4Cl and diluted with EtOAc. The aqueous and organic layers were separated, then the aqueous layer was extracted with EtOAc (3 × 100 mL). The combined organics were washed with brine and passed through a hydrophobic frit. The filtrate was concentrated in vacuo to yield the crude residue, which was purified by silica gel column chromatography give 2-(4-(3-(tert-butyl)-5-(4-phenylpyridin-2-yl)phenyl)-1H-benzo[d]imidazol-2-yl)-3-(methylamino)phenol as a dark green solid (4.60 g, 56.3% yield).

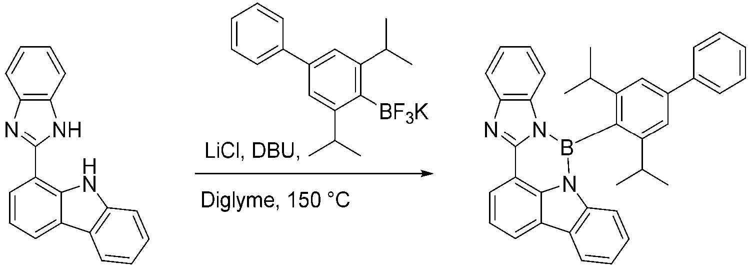

**Representative Boron Procedure 1**. To a 3-neck 100 mL round-bottom with a stir bar was added 1-(1H-benzo[d]imidazol-2-yl)-9H-carbazole (900.0 mg, 3.177 mmol), potassium (3,5-diisopropyl-[1,1'-biphenyl]-4-yl)trifluoroborate (1.640 g, 4.765 mmol), and lithium chloride (701.5 mg, 5.21 Eq, 16.55 mmol). Anhydrous diglyme (30.00 mL) added, then the reaction mixture placed under N2 atmosphere and 2,3,4,6,7,8,9,10-octahydropyrimido[1,2-a]azepine ( DBU, 1.451 g, 1.425 mL, 9.530 mmol) was added via syringe. The reaction mixture was heated to 150 °C and stirred for 3 hours. The reaction mixture was cooled to room temperature and concentrated under reduced pressure, then purified by silica gel column chromatography to obtain 1.18 g (70.0% yield) of 9-(3,5-diisopropyl-[1,1'-biphenyl]-4-yl)-9H-benzo[4',5']imidazo[1',2':3,4][1,3,2]diazaborinino[5,6,1-jk]carbazole as a pale yellow solid.

The ligands in Table 1 were synthesized using **Representative Boron Procedure 1** with their corresponding diamine precursors chosen from the list of [4-(1H-imidazol-2-yl)-N,2',6'-trimethyl-[1,1'-biphenyl]-3-amine, 4-(1H-imidazol-2-yl)-2',6'-diisopropyl-N-methyl-[1,1'-biphenyl]-3-amine, 5-(9H-carbazol-9-yl)-2-(1H-imidazol-2-yl)-N-methylaniline, 2-(9H-carbazol-9-yl)-6-(1H-imidazol-2-yl)-N-methylaniline, 3-(1H-imidazol-2-yl)-N-methyl-[1,1'-biphenyl]-2-amine, 3-(1H-imidazol-2-yl)-N-phenyl-[1,1'-biphenyl]-2-amine, 5-(tert-butyl)-2-(1H-imidazol-2-yl)-N-isopropylaniline, 4-(1H-imidazol-2-yl)-N,2',6'-trimethyl-[1,1'-biphenyl]-3-amine, 8-(1H-benzo[d]imidazol-2-yl)-9H-carbazole-2-carbonitrile, 10-(1H-benzo[d]imidazol-2-yl)-11H-benzofuro[3,2-b]carbazole, and 11-(1H-benzo[d]imidazol-2-yl)-12H-benzofuro[3,2-b]phenoxazine] and potassium aryl-trifluoroborate precursors chosen from the list of [(2,6-dimethylphenyl)trifluoro-I4-borane potassium salt, (2,6-diisopropylphenyl)trifluoro-I4-borane potassium salt, and (3,5-diisopropyl-[1,1'-biphenyl]-4-yl)trifluoro-I4-borane potassium salt].

**Table 1. Boron ligands synthesized using Representative Boron Procedure 1.**

| **Name of Ligand** | **Structure of Ligand** | **Name of Ligand** | **Structure of Ligand** |
|---|---|---|---|
| 5-(2,6-diisopropylphenyl)-8-(2,6-dimethylphenyl)-6-methyl-5,6-dihydrobenzo[e]imidazo [1,2-c][1,3,2]diazaborinine | 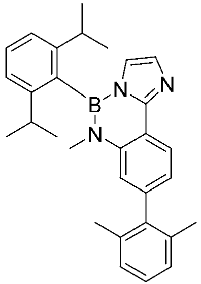 | 5,8-bis(2,6-diisopropylphenyl)-6-methyl-5,6-dihydrobenzo[e]imidazo [1,2-c][1,3,2]diazaborinine | 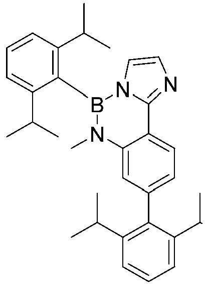 |
| 8-(9H-carbazol-9-yl)-5-(2,6-diisopropylphenyl)-6-methyl-5,6-dihydrobenzo[e]imidazo [1,2-c][1,3,2]diazaborinine | 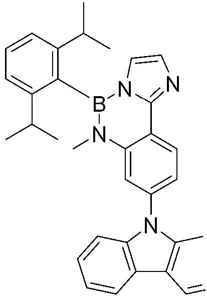 | 7-(9H-carbazol-9-yl)-5-(2,6-diisopropylphenyl)-6-methyl-5,6-dihydrobenzo[e]imidazo [1,2-c][1,3,2]diazaborinine | 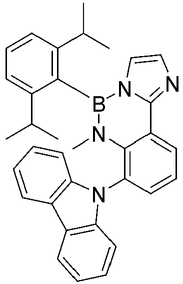 |
| 5-(2,6-diisopropylphenyl)-6-methyl-7-phenyl-5,6-dihydrobenzo[e]imidazo [1,2-c][1,3,2]diazaborinine | 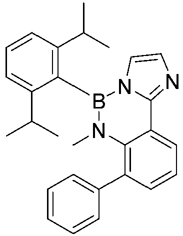 | 5-(2,6-diisopropylphenyl)-6,7-diphenyl-5,6-dihydrobenzo[e]imidazo [1,2-c][1,3,2]diazaborinine | 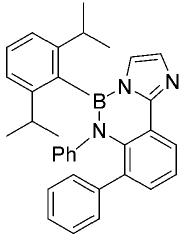 |
| 8-(tert-butyl)-5-(2,6-diisopropylphenyl)-6-isopropyl-5,6-dihydrobenzo[e]imidazo [1,2-c][1,3,2]diazaborinine | 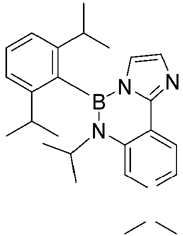 | 5,8-bis(2,6-dimethylphenyl)-6-methyl-5,6-dihydrobenzo[e]imidazo [1,2-c][1,3,2]diazaborinine | 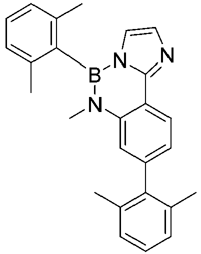 |
| 9-(3,5-diisopropyl-[1,1'-biphenyl]-4-yl)-9H-benzo[4',5']imidazo[1',2 ':3,4] [1,3,2]diazaborinino[5,6 ,1-jk]carbazole-6-carbonitrile | 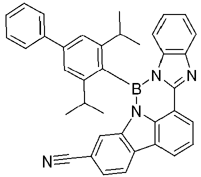 | 10-(3,5-diisopropyl-[1,1'-biphenyl]-4-yl)-10H-benzo[4',5']imidazo[1',2 ':3,4] [1,3,2]diazaborinino[5,6 ,1-jk]benzofuro[3,2-b]carbazole | 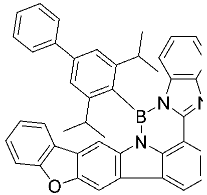 |
| 18-(3,5-diisopropyl-[1,1'-biphenyl]-4-yl)-18H-benzo[4',5']imidazo[1',2 ':3,4] | 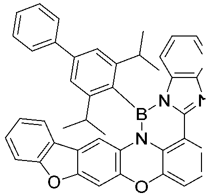 | | |
| [1,3,2]diazaborinino[5,6 ,1-kl]benzofuro[3,2-b]phenoxazine | | | |

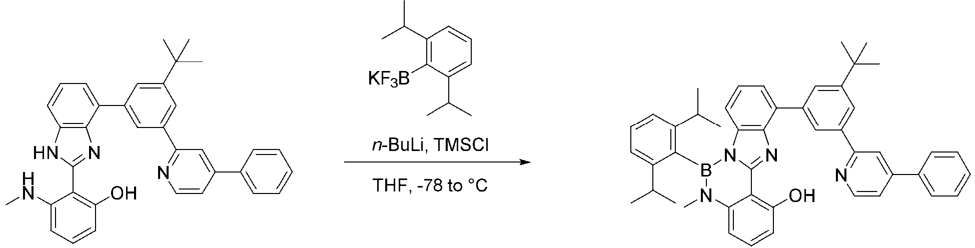

**Representative Boron Procedure 2.** To an oven-dried 50 mL Schlenk tube with a stir bar was added (2,6-diisopropylphenyl)trifluoro-I4-borane, potassium salt (1.073 g, 4.003 mmol). Under N2 atmosphere, anhydrous THF (10.00 mL) was added. While stirring at room temperature, chlorotrimethylsilane (437 mg, 0.510 mL, 4.02 mmol) was added via syringe. Continued stirring at room temperature for 2 hours. To a separate 50 mL Schlenk flask was weighed 2-(4-(3-(tert-butyl)-5-(4-phenylpyridin-2-yl)phenyl)-1H-benzo[d]imidazol-2-yl)-3-(methylamino)phenol (1.000 g, 1.906 mmol). Under N2 atmosphere, anhydrous THF (10.00 mL) added. Cooled to -78 °C, then n-butyllithium (2.5 M in hexane, 2.400 mL, 6.000 mmol) was added dropwise via syringe. Continued stirring at this temperature for 2 h. The to mixtures were then combined via cannula transfer, the cooling bath removed, then the combined mixture allowed to warm ambiently to room temperature while stirring, then heated to 60 °C for 16 hours. The mixture was cooled to room temperature, quenched with saturated aqueous NH4Cl, diluted further with EtOAc and more water. The biphasic solution was stirred for 15 minutes before transferring to a separatory funnel. The aqueous and organic layers were separated, then the aqueous was extracted with EtOAc (x2). The combined organic layer was washed with water then brine, dried over Na2SO4, filtered, concentrated, and purified by silica gel column chromatography to obtain 11-(3-(tert-butyl)-5-(4-phenylpyridin-2-yl)phenyl)-6-(2,6-diisopropylphenyl)-5-methyl-5,6- dihydrobenzo[e]benzo[4,5]imidazo[1,2-c][1,3,2]diazaborinin-1-ol (1.0 g, 76 % yield) as a colorless solid.

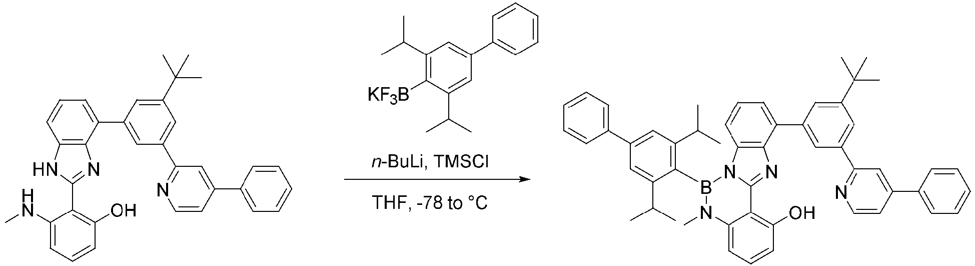

11-(3-(tert-butyl)-5-(4-phenylpyridin-2-yl)phenyl)-6-(3,5-diisopropyl-[1,1'-biphenyl]-4-yl)-5-methyl-5,6-dihydrobenzo[e]benzo[4,5]imidazo[1,2-c][1,3,2]diazaborinin-1-ol was prepared using **Representative Boron Procedure 2** with 2-(4-(3-(tert-butyl)-5-(4-phenylpyridin-2-yl)phenyl)-1H-benzo[d]imidazol-2-yl)-3-(methylamino)phenol and (3,5-diisopropyl-[1,1'-biphenyl]-4-yl)trifluoro-I4-borane, potassium salt.

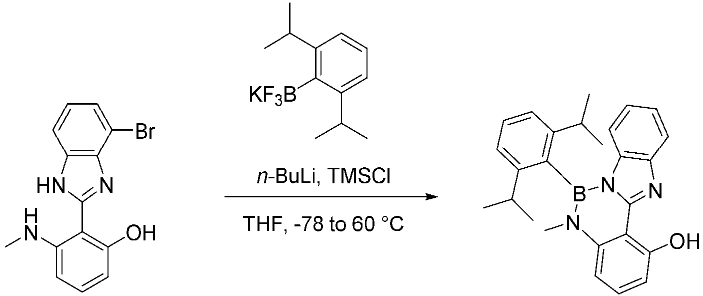

11-bromo-6-(2,6-diisopropylphenyl)-5-methyl-5,6-dihydrobenzo[e]benzo[4,5]imidazo[1,2-c][1,3,2]diazaborinin-1-ol was prepared using **Representative Boron Procedure 2** with 2-(4-bromo-1H-benzo[d]imidazol-2-yl)-3-(methylamino)phenol and (2,6-diisopropylphenyl)trifluoro-I4-borane, potassium salt.

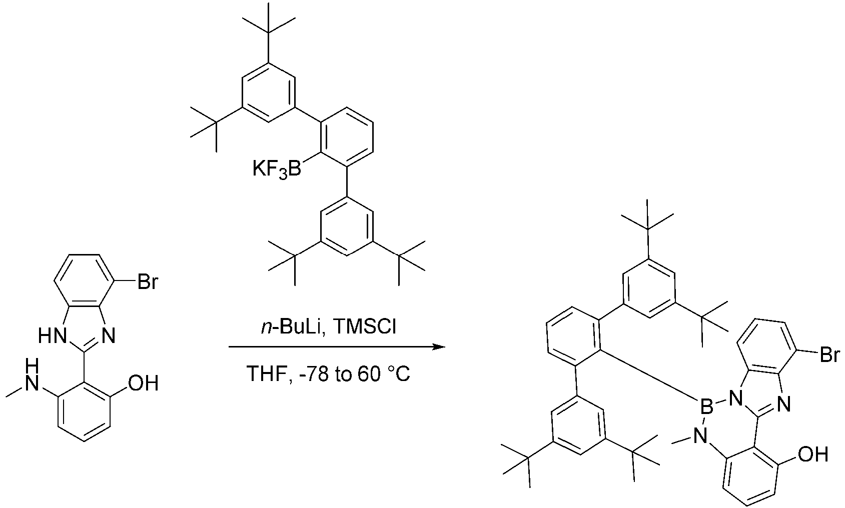

11-bromo-5-methyl-6-(3,3",5,5"-tetra-tert-butyl-[1,1':3',1"-terphenyl]-2'-yl)-5,6-dihydrobenzo[e]benzo[4,5]imidazo[1,2-c][1,3,2]diazaborinin-1-ol was prepared using **Representative Boron Procedure 2** with 2-(4-bromo-1H-benzo[d]imidazol-2-yl)-3-(methylamino)phenol and trifluoro(3,3",5,5"-tetra-tert-butyl-[1,1':3',1"-terphenyl]-2'-yl)-I4-borane, potassium salt.

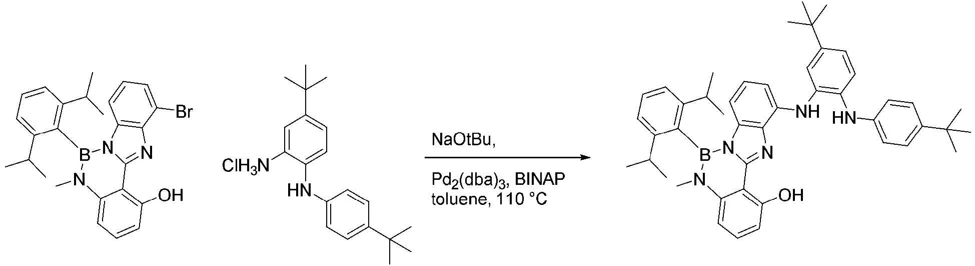

To a round bottom flask with a stir bar was added 4-(tert-butyl)-N1-(4-(tert-butyl)phenyl)benzene-1,2-diamine hydrochloride (0.455 g, 1.54 mmol), 11-bromo-6-(2,6-diisopropylphenyl)-5-methyl-5,6-dihydrobenzo[e]benzo[4,5]imidazo[1,2-c][1,3,2]diazaborinin-1-ol (0.500 g, 1.02 mmol), and sodium tert-butoxide (0.345 g, 3.58 mmol). These were suspended in toluene (10.2 mL). The mixture was placed under N2 atmosphere, then BINAP (0.128 g, 0.205 mmol) and Pd2(dba)3 (94 mg, 102 µmol) were added. The mixture was fitted with a reflux condenser heated to 110 °C for 16 hours. The mixture was cooled to room temperature and purified by silica gel column chromatography to obtain 6-(2,6-diisopropylphenyl)-5-methyl-5,6-dihydrobenzo[e]benzo[4,5]imidazo[1,2-c][1,3,2]diazaborinin-1-ol (0.433 g, 60.1% yield) as a colorless solid.

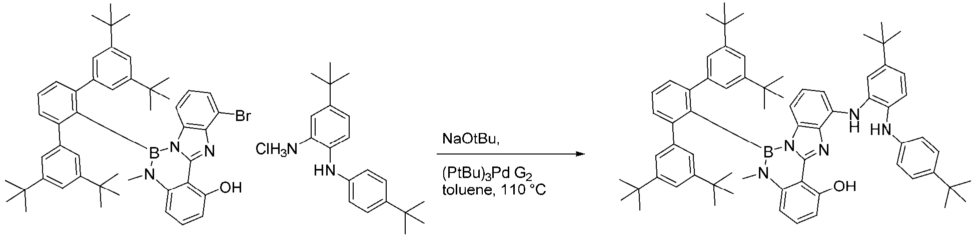

A mixture of 4-(tert-butyl)-N1-(4-(tert-butyl)phenyl)benzene-1,2-diamine hydrochloride (3.0 g, 9.0 mmol) and 11-bromo-5-methyl-6-(3,3",5,5"-tetra-tert-butyl-[1,1':3',1"-terphenyl]-2'-yl)-5,6-dihydrobenzo[e]benzo[4,5]imidazo[1,2-c][1,3,2]diazaborinin-1-ol (5 g, 6.4 mmol) in anhydrous toluene (54 mL) was placed under N2 atmosphere, then Chloro(tri-t-butylphosphine)(2'-amino-1,1'-biphenyl-2-yl)palladium(II) ((PtBu)3Pd G2, 0.33 g, 0.64 mmol) and sodium tert-butoxide (1.8 g, 19 mmol) were added. The mixture was heated to 110 °C for 10 hours. The mixture was cooled to room temperature, water (5 mL) was added, and the mixture filtered through a Celite plug and washed with DCM. The filtrate was concentrated and purified by silica gel column chromatography to obtain 3.0 g (51% yield) of 11-((5-(tert-butyl)-2-((4-(tert-butyl)phenyl)amino)phenyl)amino)-5-methyl-6-(3,3",5,5"-tetra-tert-butyl-[1,1':3',1"-terphenyl]-2'-yl)-5,6-dihydrobenzo[e]benzo[4,5]imidazo[1,2-c][1,3,2]diazaborinin-1-ol as a colorless solid.

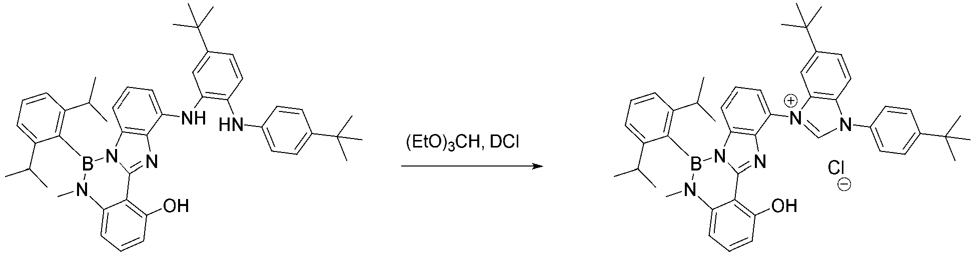

A mixture of 11-((5-(tert-butyl)-2-((4-(tert-butyl)phenyl)amino)phenyl)amino)-6-(2,6-diisopropylphenyl)-5-methyl-5,6-dihydrobenzo[e]benzo[4,5]imidazo[1,2-c][1,3,2]diazaborinin-1-ol (345.3 mg, 490.6 µmol) in triethoxymethane (7.271 g, 8.16 mL, 49.06 mmol) was placed under N2 atmosphere. concentrated (35%) deuterium chloride (73.52 mg, 163.5 µL, 12.000 molar, 1.963 mmol) was added and the mixture was heated at 100 °C for 1 hour. The mixture was then cooled to room temperature and purified by silica gel column chromatography to obtain 0.116 g (33% yield) of 11-(6-(tert-butyl)-3-(4-(tert-butyl)phenyl)-1H-3I4-benzo[d]imidazol-1-yl)-6-(2,6-diisopropylphenyl)-5-methyl-5,6-dihydrobenzo[e]benzo[4,5]imidazo[1,2-c][1,3,2]diazaborinin-1-ol as a colorless solid.

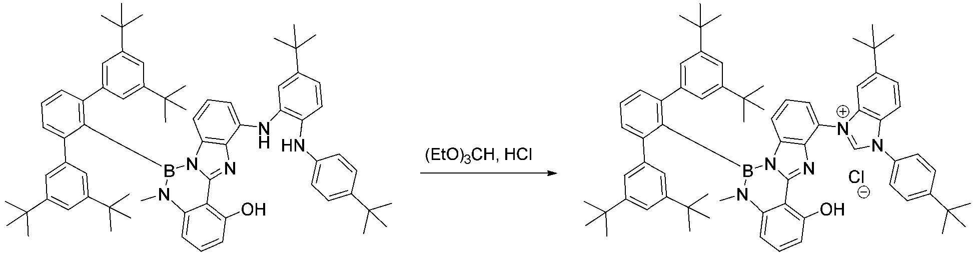

To a vial containing 11-((5-(tert-butyl)-2-((4-(tert-butyl)phenyl)amino)phenyl)amino)-5-methyl-6-(3,3",5,5"-tetra-tert-butyl-[1,1':3',1"-terphenyl]-2'-yl)-5,6-dihydrobenzo[e]benzo[4,5]imidazo[1,2-c][1,3,2]diazaborinin-1-ol (3.3 g, 3.3 mmol) was added triethyl orthoformate (27.4 mL, 24.4 g, 165 mmol). The resulting solution was placed under N2 atmosphere, then concentrated hydrochloric acid (0.82 mL, 9.9 mmol) was added. The reaction mixture was heated to 100 °C for 1 hour. LC/MS indicated reaction complete. The mixture was concentrated under reduced pressure to obtain 3.4 g (99% yield) of 5-(tert-butyl)-1-(4-(tert-butyl)phenyl)-3-(1-hydroxy-5-methyl-6-(3,3",5,5"-tetra-tert-butyl-[1,1':3',1"-terphenyl]-2'-yl)-5,6-dihydrobenzo[e]benzo[4,5]imidazo[1,2-c][1,3,2]diazaborinin-11-yl)-1H-benzo[d]imidazol-3-ium chloride as a colorless solid.

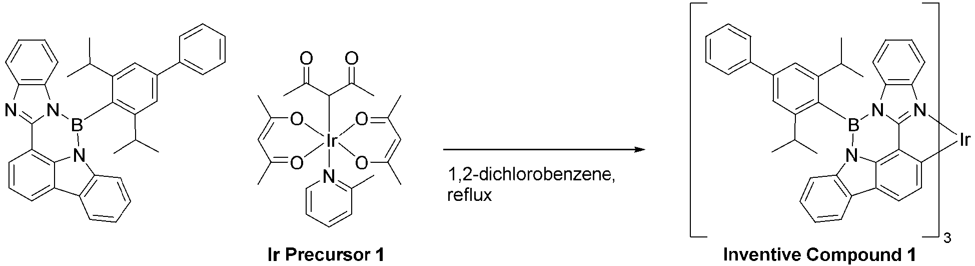

**Representative Ir Procedure 1**. This compound was synthesized according to the procedure reported in Macor et. al., US20200354390 by combining 0.220 g (0.416 mmol) of 9-(3,5-diisopropyl-[1,1'-biphenyl]-4-yl)-9H-benzo[4',5']imidazo[1',2':3,4][1,3,2]diazaborinino[5,6,1-jk]carbazole with Ir Precursor 1 in refluxing 1,2-dichlorobenzene. Purification of the crude reaction mixture by silica gel column chromatography yielded 0.122 g (56%) of **Inventive Compound 1** as a yellow solid.

The Inventive Compounds in Table 2 were synthesized using **Representative Ir Procedure 1** with their corresponding ligands chosen from the list of 9-(3,5-diisopropyl-[1,1'-biphenyl]-4-yl)-9H-benzo[4',5']imidazo[1',2':3,4] [1,3,2]diazaborinino[5,6,1-jk]carbazole-6-carbonitrile, 8-(3,5-diisopropyl-[1,1'-biphenyl]-4-yl)-8H-pyrido[3',2':3,4][1,2]azaborinino[5,6,1-jk]carbazole, 5-(2,6-diisopropylphenyl)-8-(2,6-dimethylphenyl)-6-methyl-5,6-dihydrobenzo[e]imidazo[1,2-c][1,3,2]diazaborinine, 5,8-bis(2,6-diisopropylphenyl)-6-methyl-5,6-dihydrobenzo[e]imidazo[1,2-c][1,3,2]diazaborinine, 8-(9H-carbazol-9-yl)-5-(2,6-diisopropylphenyl)-6-methyl-5,6-dihydrobenzo[e]imidazo[1,2-c][1,3,2]diazaborinine, 7-(9H-carbazol-9-yl)-5-(2,6-diisopropylphenyl)-6-methyl-5,6-dihydrobenzo[e]imidazo[1,2-c][1,3,2]diazaborinine, 5-(2,6-diisopropylphenyl)-6-methyl-7-phenyl-5,6-dihydrobenzo[e]imidazo[1,2-c][1,3,2]diazaborinine, 5-(2,6-diisopropylphenyl)-6,7-diphenyl-5,6-dihydrobenzo[e]imidazo[1,2-c][1,3,2]diazaborinine, and 8-(tert-butyl)-5-(2,6-diisopropylphenyl)-6-isopropyl-5,6-dihydrobenzo[e]imidazo[1,2-c][1,3,2]diazaborinine.

**Table 2. Inventive Compounds synthesized using Representative Ir Procedure 1.**

| **Compound Structure** | **Compound Structure** |
|---|---|
| 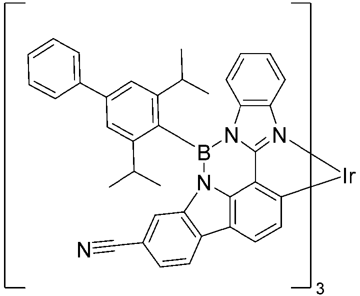 **Inventive Compound 2** | 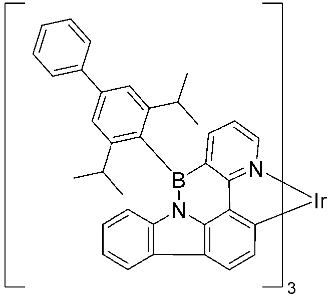 **Inventive Compound 3** |
| 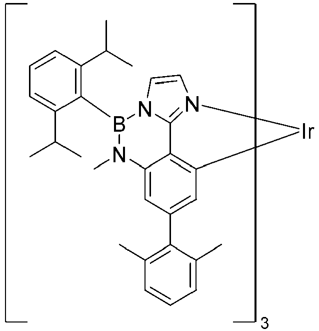 **Inventive Compound 4** | 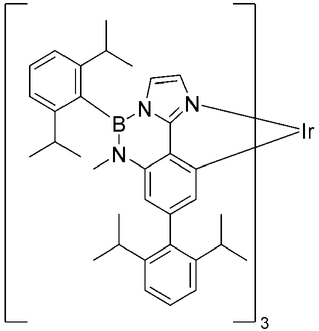 **Inventive Compound 5** |
| 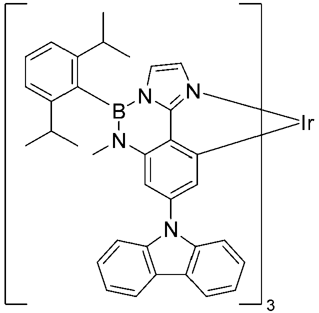 **Inventive Compound 6** | 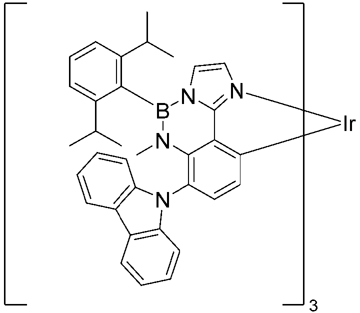 **Inventive Compound 7** |
| 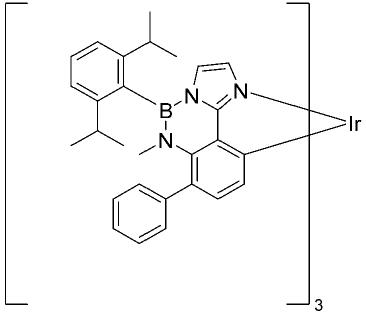 **Inventive Compound 8** | 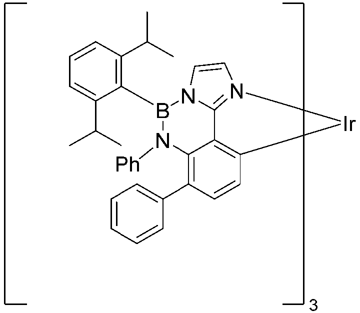 **Inventive Compound 9** |
| 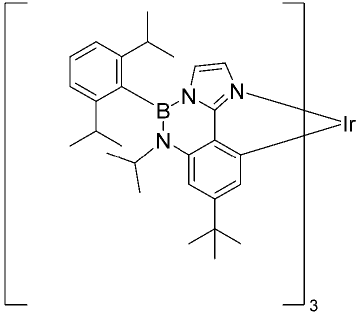 **Inventive Compound 10** | |

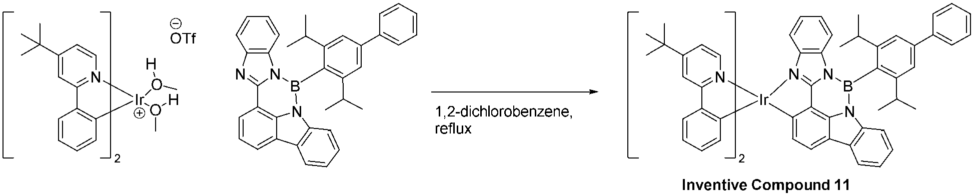

**Representative Ir Procedure 2**. Bis(2-(4-(tert-butyl)pyridin-2-yl)phenyl)iridium(III) triflate bis(methanol) adduct (0.425 g, 0.515 mmol) was combined with 9-(3,5-diisopropyl-[1,1'-biphenyl]-4-yl)-9H-benzo[4',5']imidazo[1',2':3,4][1,3,2]diazaborinino[5,6,1-jk]carbazole (0.300 g, 0.567 mmol) in 1,2-dichlorobenzene (4.0 mL) and the combined reaction mixture was brought to reflux for 24 hours. The mixture was cooled to room temperature and purified by silica gel column chromatography to obtain 0.013 g (2.1% yield) of **Inventive Compound 11** as a yellow solid.

The Inventive Compounds in Table 3 were synthesized using **Representative Ir Procedure 2** with their corresponding ligands chosen from the list of 10-(3,5-diisopropyl-[1,1'-biphenyl]-4-yl)-10H-benzo[4',5']imidazo[1',2':3,4][1,3,2]diazaborinino[5,6,1-jk]benzofuro[3,2-b]carbazole, 18-(3,5-diisopropyl-[1,1'-biphenyl]-4-yl)-18H-benzo[4',5']imidazo[1',2':3,4][1,3,2]diazaborinino[5,6,1-kl]benzofuro[3,2-b]phenoxazine, 8-(3,5-diisopropyl-[1,1'-biphenyl]-4-yl)-8H-pyrido[3',2':3,4][1,2]azaborinino[5,6,1-jk]carbazole, 8H-[1,6]naphthyridino[8,7,6-jk]carbazol-8-one, 8,8-diphenyl-8H-pyrido[3',2':3,4][1,2]azasilino[5,6,1-jk]carbazole, and 8,8-diphenyl-8H-pyrido[3',2':3,4][1,2]azagermino[5,6,1-jk]carbazole, and iridium complex precursors chosen from the list of bis(2-(4-(tert-butyl)pyridin-2-yl)phenyl)Iridium(III) triflate bis(methanol) adduct, bis((2-(4-(tert-butyl)pyridin-2-yl)-5-fluorophenyl)iridium (III) bis(methanol) adduct, and bis(2-(5-(tert-butyl)pyridin-2-yl)phenyl)Iridium(III) triflate bis(methanol) adduct.

**Table 3. Inventive Compounds synthesized using Representative Ir Procedure 2.**

| **Compound Structure** | **Compound Structure** |
|---|---|
| 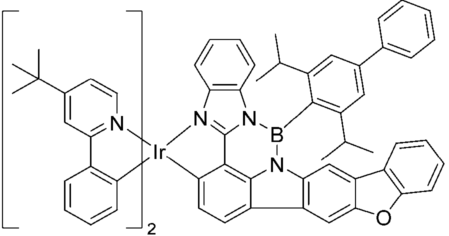 **Inventive Compound 12** | 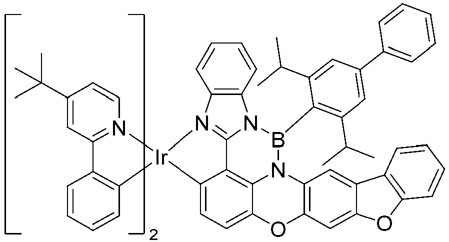 **Inventive Compound 13** |
| 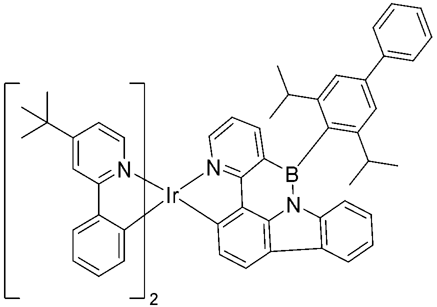 **Inventive Compound 14** | 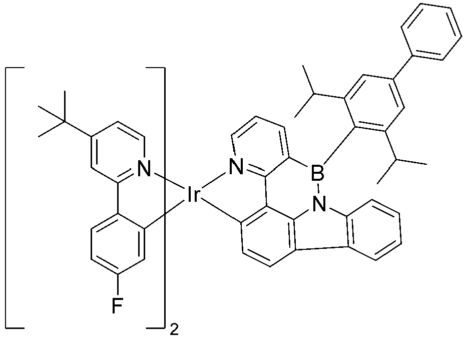 **Inventive Compound 15** |
| 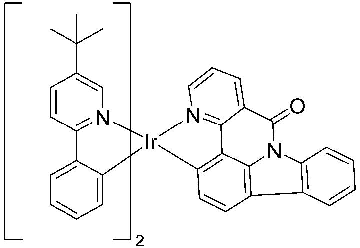 **Inventive Compound 16** | 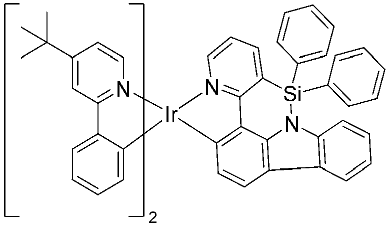 **Inventive Compound 17** |
| 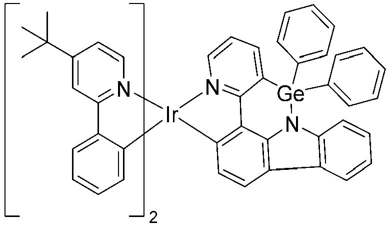 **Inventive Compound 18** | |

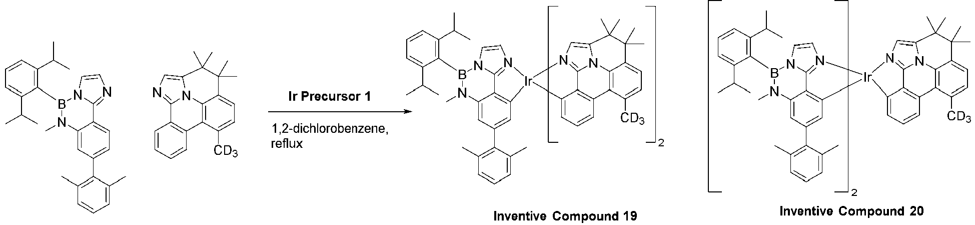

**Representative Ir Procedure 3.** These compounds were synthesized according to the procedure reported in Macor et. al., US20200354390 by combining 0.038 g (0.0.084 mmol) of 5-(2,6-diisopropylphenyl)-8-(2,6-dimethylphenyl)-6-methyl-5,6-dihydrobenzo[e]imidazo[1,2-c][1,3,2]diazaborinine and 0.027 g (0.084 mmol) of 3,3,4,4-tetramethyl-7-(methyl-d3)-3,4-dihydrodibenzo[b,ij]imidazo[2,1,5-de]quinolizine with 0.028 g (0.048 mmol) of Ir Precursor 1 in refluxing 1,2-dichlorobenzene. Purification of the crude reaction mixture by silica gel column chromatography yielded 0.005 g (8.2%) of **Inventive Compound 19** as a yellow solid and 0.012 g (18%) of **Inventive Compound 20** as a yellow solid.

The inventive Compounds in Table 4 were synthesized using **Representative Ir Procedure 3** with their corresponding inventive ligands chosen from the list of 5,8-bis(2,6-dimethylphenyl)-6-methyl-5,6-dihydrobenzo[e]imidazo[1,2-c][1,3,2]diazaborinine, 5-(2,6-diisopropylphenyl)-8-(2,6-dimethylphenyl)-6-methyl-5,6-dihydrobenzo[e]imidazo[1,2-c][1,3,2]diazaborinine, 8-(2,6-diisopropylphenyl)-5-(2,6-dimethylphenyl)-6-methyl-5,6-dihydrobenzo[e]imidazo[1,2-c][1,3,2]diazaborinine, 8-(9H-carbazol-9-yl)-5-(2,6-diisopropylphenyl)-6-methyl-5,6-dihydrobenzo[e]imidazo[1,2-c][1,3,2]diazaborinine, 7-(9H-carbazol-9-yl)-5-(2,6-diisopropylphenyl)-6-methyl-5,6-dihydrobenzo[e]imidazo[1,2-c][1,3,2]diazaborinine, and 8-(tert-butyl)-5-(2,6-diisopropylphenyl)-6-isopropyl-5,6-dihydrobenzo[e]imidazo[1,2-c][1,3,2]diazaborinine, and their corresponding ancillary ligands chosen from the list of 3,6-di-tert-butyl-9-(4-methylpyridin-2-yl)-9H-carbazole, 9-(4,5-dimethylpyridin-2-yl)-9H-carbazole, 9-(4,5-bis(methyl-d3)pyridin-2-yl)-9H-carbazole, 2-(2,6-diisopropylphenyl)-1,3-diphenyl-2,3-dihydro-1H-[1,3,2]diazaborolo[4,5-b]pyridine, 2-(2,6-dimethylphenyl)-7-methyl-1,3-diphenyl-2,3-dihydro-1H-[1,3,2]diazaborolo[4,5-b]pyridine, 3,6-di-tert-butyl-9-(4-methylpyridin-2-yl)-9H-carbazole, and 3,6-diethyl-9-(4-methylpyridin-2-yl)-9H-carbazole.

**Table 4. Inventive Compounds synthesized using Representative Ir Procedure 3.**

| **Compound Structure** | **Compound Structure** |
|---|---|
| 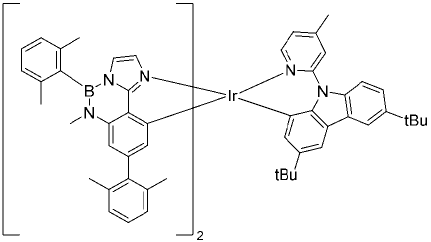 **Inventive Compound 21** | 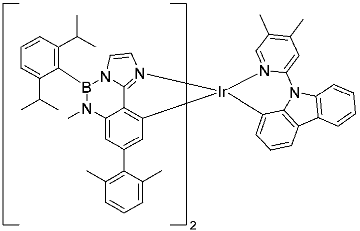 **Inventive Compound 22** |
| 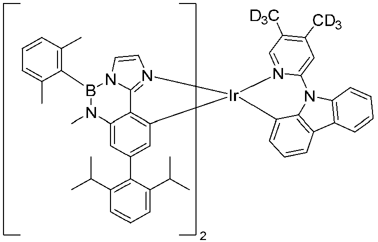 **Inventive Compound 23** | 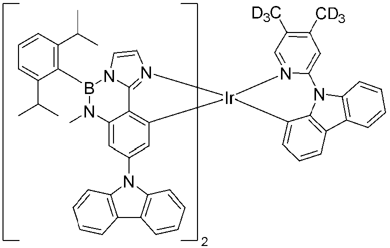 **Inventive Compound 24** |
| 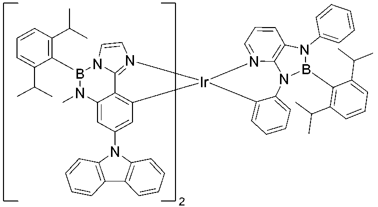 **Inventive Compound 25** | 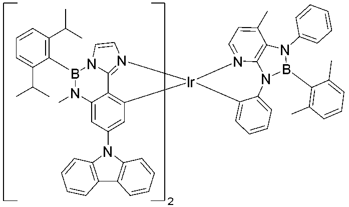 **Inventive Compound 26** |
| 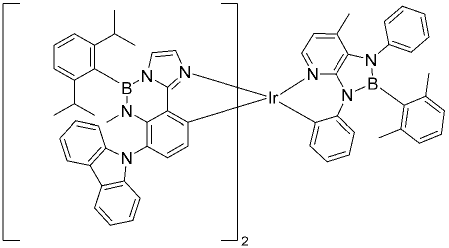 **Inventive Compound 27** | 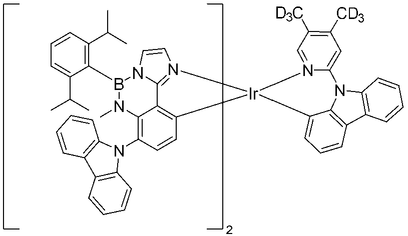 **Inventive Compound 28** |
| 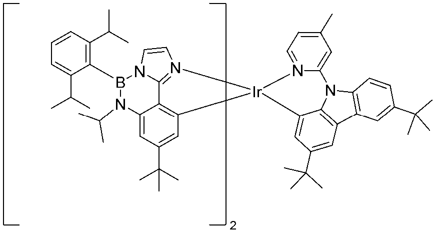 **Inventive Compound 29** | 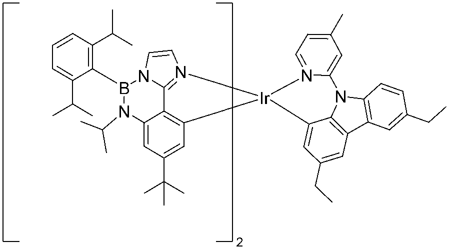 **Inventive Compound 30** |
| 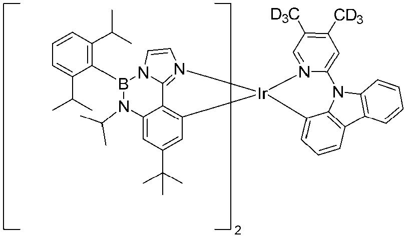 **Inventive Compound 31** | |

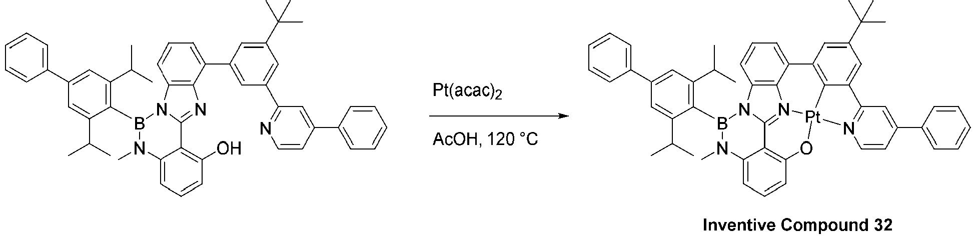

**Representative Pt Procedure 1**. To a 50 mL Schlenk tube with a stir bar was added 11-(3-(tert-butyl)-5-(4-phenylpyridin-2-yl)phenyl)-6-(3,5-diisopropyl-[1,1'-biphenyl]-4-yl)-5-methyl-5,6-dihydrobenzo[e]benzo[4,5]imidazo[1,2-c][1,3,2]diazaborinin-1-ol (0.509 g, 660 µmol), Pt(acac)2 (260 mg, 660 µmol), and acetic acid (6.000 mL). The mixture was placed under N2 atmosphere, then heated to reflux for 16 hours. The mixture was cooled to room temperature then diluted with MeOH. The resulting precipitate was collected by vacuum filtration onto a bed of celite, then dissolved and rinsed through using DCM. The filtrated was then transferred to a separatory funnel, washed with saturated aqueous NaHCO3 and brine, dried over Na2SO4), filtered, concentrated, and purified by silica gel column chromatography to obtain 366 mg (56%) of **Inventive Compound 32** as a yellow solid.

The Inventive Compounds in Table 4 were synthesized using **Representative Pt Procedure 1** with their corresponding ligands chosen from the list of 11-(3-(tert-butyl)-5-(4-phenylpyridin-2-yl)phenyl)-6-(2,6-diisopropylphenyl)-5-methyl-5,6-dihydrobenzo[e]benzo[4,5]imidazo[1,2-c][1,3,2]diazaborinin-1-ol, 5-(tert-butyl)-1-(4-(tert-butyl)phenyl)-3-(6-(2,6-diisopropylphenyl)-1-hydroxy-5-methyl-5,6-dihydrobenzo[e]benzo[4,5]imidazo[1,2-c][1,3,2]diazaborinin-11-yl)-1H-benzo[d]imidazol-3-ium chloride, and 5-(tert-butyl)-1-(4-(tert-butyl)phenyl)-3-(1-hydroxy-5-methyl-6-(3,3",5,5"-tetra-tert-butyl-[1,1':3',1"-terphenyl]-2'-yl)-5,6-dihydrobenzo[e]benzo[4,5]imidazo[1,2-c][1,3,2]diazaborinin-11-yl)-1H-benzo[d]imidazol-3-ium chloride.

**Table 5. Inventive Compounds synthesized using Representative Pt Procedure 1.**

| **Compound Structure** | **Compound Structure** |
|---|---|
| 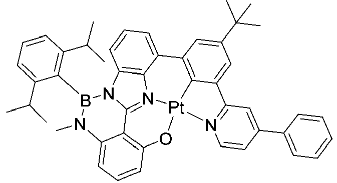 **Inventive Compound 33** | 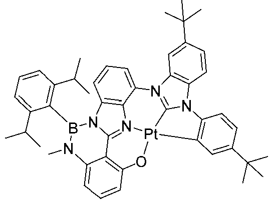 **Inventive Compound 34** |
| 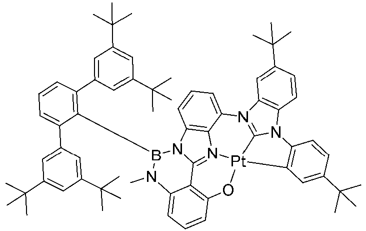 **Inventive Compound 35** | |

**Table 6. Photophysical properties of blue emitting Ir compounds**

| | **Structure** | **PL max (nm), PMMA** | **PLQY (%), PMMA** |
|---|---|---|---|
| **Comparative Compound 1** | 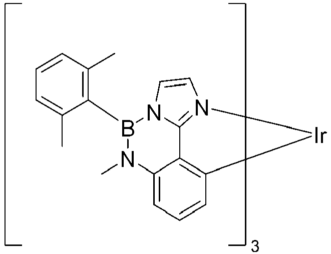 | 454 | 36 |
| **Comparative Compound 2** | 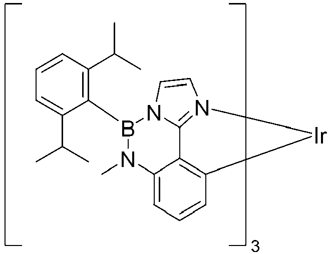 | 454 | 32 |
| **Comparative Compound 3** | 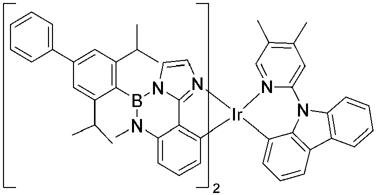 | 484 | 51 |
| **Inventive Compound 4** | 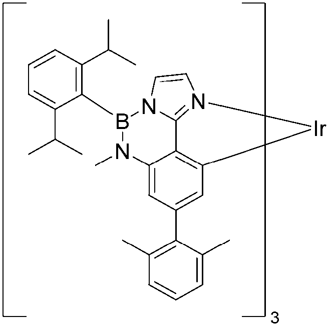 | 464 | 59 |
| **Inventive Compound 5** | 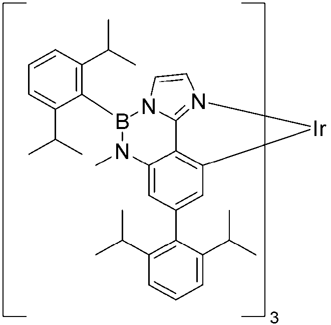 | 460 | 72 |
| **Inventive Compound 6** | 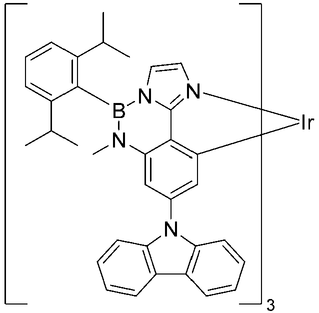 | 463 | 78 |
| **Inventive Compound 7** | 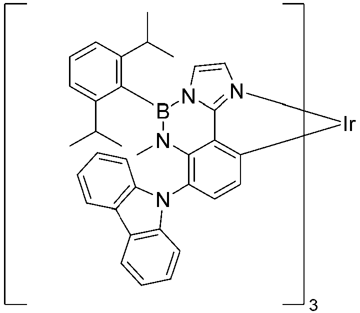 | 463 | 71 |
| **Inventive Compound 8** | 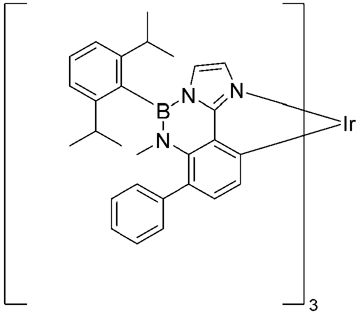 | 467 | 66 |
| **Inventive Compound 9** | 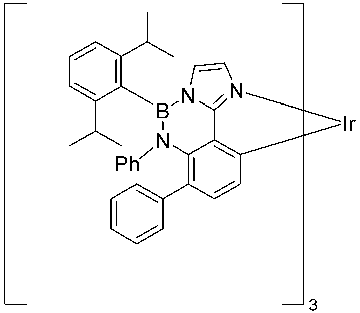 | 472 | 64 |
| **Inventive Compound 10** | 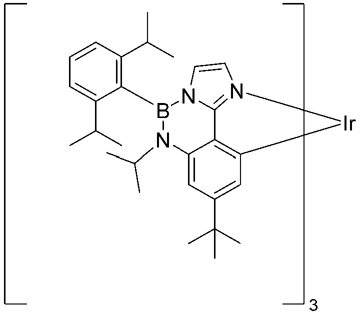 | 452 | 36 |
| **Inventive Compound 19** | 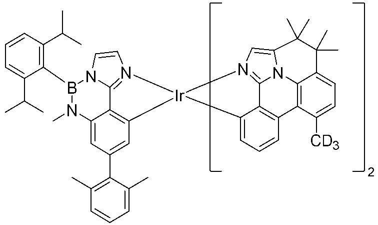 | 464 | 48 |
| **Inventive Compound 20** | 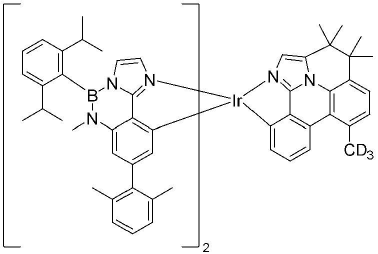 | 465 | 60 |
| **Inventive Compound 21** | 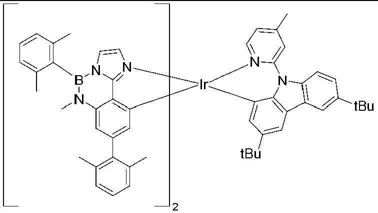 | 476 | 77 |
| **Inventive Compound 22** | 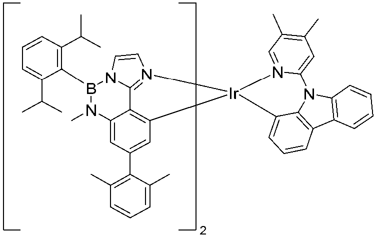 | 471 | 49 |
| **Inventive Compound 23** | 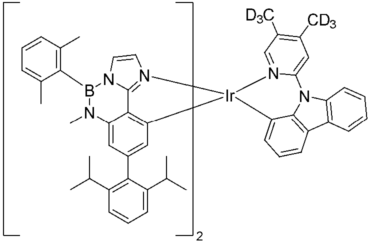 | 471 | 45 |
| **Inventive Compound 24** | 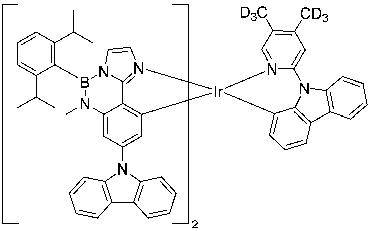 | 469 | 69 |
| **Inventive Compound 25** | 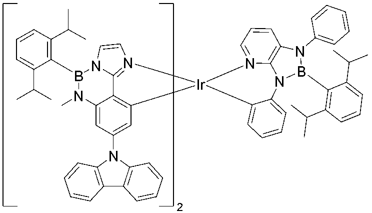 | 468 | 51 |
| **Inventive Compound 27** | 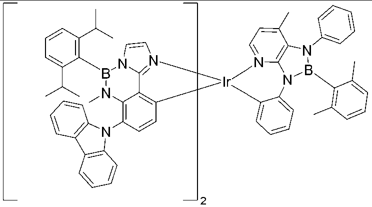 | 470 | 69 |
| **Inventive Compound 28** | 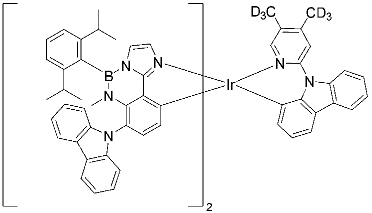 | 472 | 74 |
| **Inventive Compound 29** | 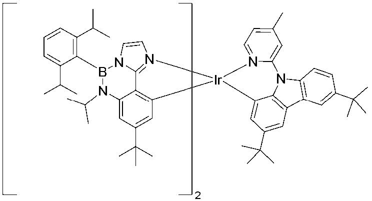 | 493 | 66 |
| **Inventive Compound 30** | 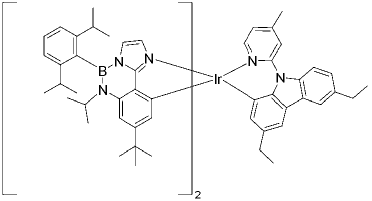 | 491 | 70 |
| **Inventive Compound 31** | 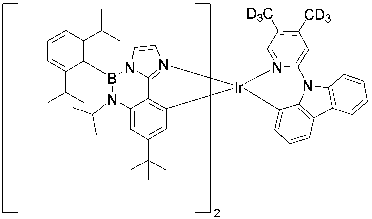 | 487 | 65 |

Table 6 shows the PL λₘₐₓ photoluminescent quantum yield (PLQY) of emission spectra in PMMA of **Comparative Compounds 1-3** and **Inventive Compounds 4-10, 19-25, and 27-31.** With the inventive design of aryl or heteroaryl substitution on ring B of Formula I, a general trend of increased PLQY can be observed between the Comparative Compounds and the Inventive Compounds while maintaining blue emission color. This is apparent when comparing homoleptics **Comparative Compound 1** (454 nm, 36% PLQY) and **Comparative Compound 2** (454 nm, 32% PLQY) with homoleptic **Inventive Compounds 4-9** (all ≤ 472 nm, all ≥ 59% PLQY). Moreover, a similar trend can be observed in heteroleptic **Comparative Compound 3** (484 nm, 51% PLQY) and **Inventive Compounds 24** (469 nm, 69% PLQY) and **28** (472 nm, 74% PLQY) where not only is **PLQY** increased by heteroaryl substitution on ring B of Formula I, but a blue-shifted λₘₐₓ is achieved. The improvement of these values are above the value that could be attributed to experimental error and the observed improvement is significant. These data demonstrate an unexpected benefit of efficiency and color introduced by aryl or heteroaryl substitution, making this invention suitable for saturated blue PhOLED applications.

**Table 7. Photophysical properties of green emitting Ir compounds**

| | **Structure** | **PL λₘₐₓ (nm), 77K** | **FWHM (nm)** |
|---|---|---|---|
| **Inventive Compound 1** | 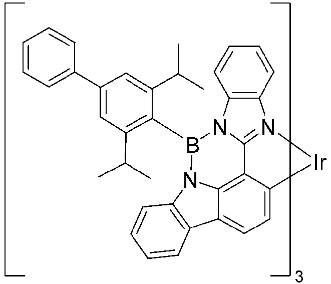 | 510 | 11 |
| **Inventive Compound 2** | 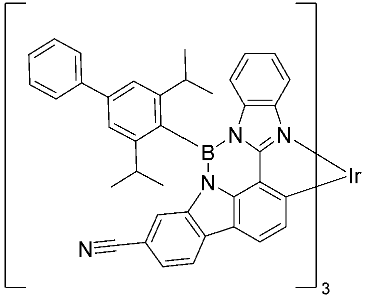 | 520 | 10 |
| **Inventive Compound 3** | 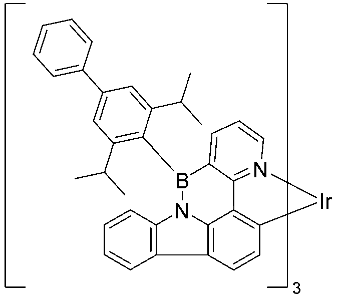 | 514 | 14 |
| **Inventive Compound 11** | 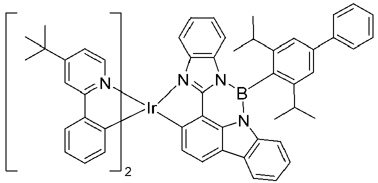 | 511 | 15 |
| **Inventive Compound 12** | 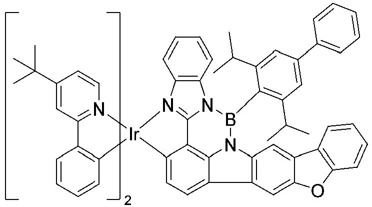 | 525 | 13 |
| **Inventive Compound 13** | 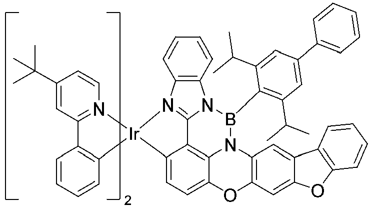 | 500 | 19 |
| **Inventive Compound 14** | 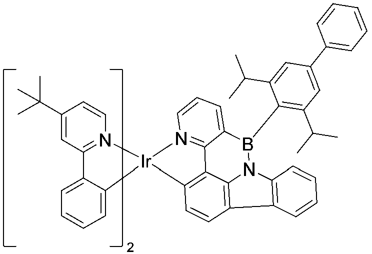 | 520 | 22 |
| **Inventive Compound 15** | 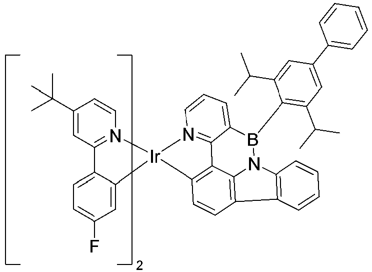 | 512 | 18 |
| **Inventive Compound 16** | 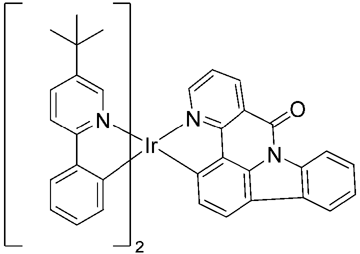 | 544 | 105 |
| **Inventive Compound 17** | 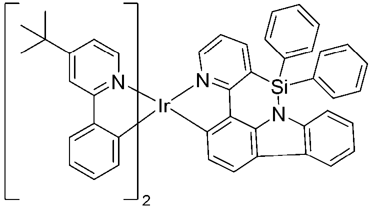 | 525 | 17 |
| **Inventive Compound 18** | 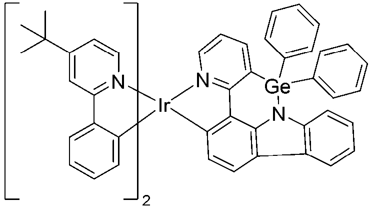 | 531 | 18 |

Table 7 shows the PL λₘₐₓ and full width half max (FWHM) of emission measured at 77K in 2-methyltetrahydrofuran solution of **Inventive Compounds 1-3** and **11-18.** The benzimidazole-ligated homoleptic structures **Inventive Compound 1** (510 nm λₘₐₓ, 11 nm FWHM) and **Inventive Compound 2** (520 nm, 10 nm) demonstrate narrow lineshape at a saturated and tunable green color achieved by the inventive boron-linked structures. **Inventive Compound 11** (511 nm , 15 nm) and **Inventive Compound 12** (525 nm, 13 nm) further demonstrate these properties in heteroleptic structures. The homoleptic and heteroleptic structures **Inventive Compound 3** (514 nm, 14 nm) and **Inventive Compounds 14** (520 nm, 22 nm), 17 (525 nm, 17 nm), and **18** (531 nm, 18 nm) further demonstrate that the benefit of the inventive features extends to the use of pyridine A rings as well as SiR2 or GeR2 linkers to achieve tunable and narrow green emission. Taken together, the data in Table 7 provide multiple strategies for modification of PhOLED materials by lineshape or color tuning that make the invention herein suitable for green PhOLED applications.

**Table 8. Photophysical properties of green emitting Pt compounds**

| | **Structure** | **PL λₘₐₓ (nm), 77K** | **FWHM (nm), 77K** |
|---|---|---|---|
| **Comparative Compound 8** | 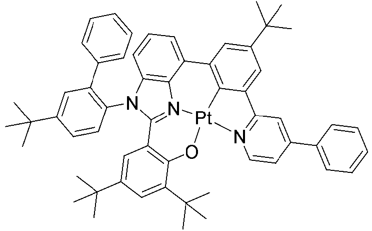 | 503 | 24 |
| **Inventive Compound 32** | 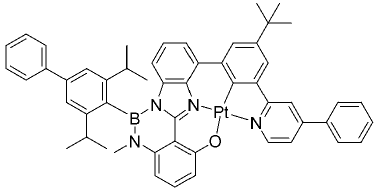 | 504 | 22 |
| **Inventive Compound 33** | 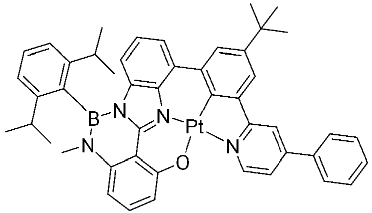 | 503 | 22 |

Table 8 shows the PL λₘₐₓ and full width half max (FWHM) of the A pea of emission measured at 77K in 2-methyltetrahydrofuran solution of **Comparative Compound 8** (503 nm λₘₐₓ, 24 nm FWHM) and **Inventive Compounds 32-33** (504 nm, 22 nm; 503 nm, 22 nm; respectively). These data demonstrate that the inventive BN-linked structures can achieve a comparable T1 emission color (saturated green) but with an added benefit of narrower lineshape (2 nm), thus providing improved color purity. The improvement of these values are above the value that could be attributed to experimental error and the observed improvement is significant. This benefit make the invention herein suitable for saturated green PhOLED applications.

Emission spectra were collected on a Horiba Fluorolog-3 spectrofluorometer equipped with a Synapse Plus CCD detector. All samples were excited at 340nm. Solutions of 1% emitter with PMMA in toluene were prepared, filtered, and dropcast onto Quartz substrates.

OLED devices were fabricated with the following material set.

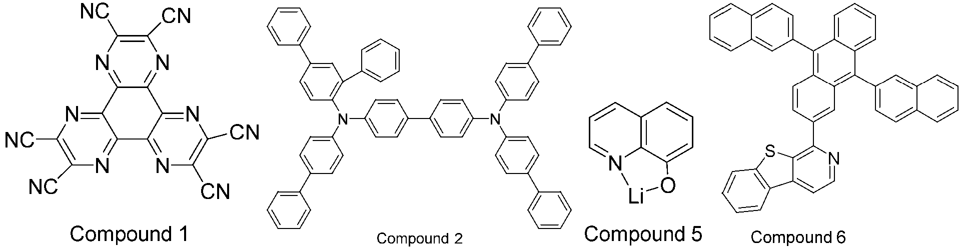

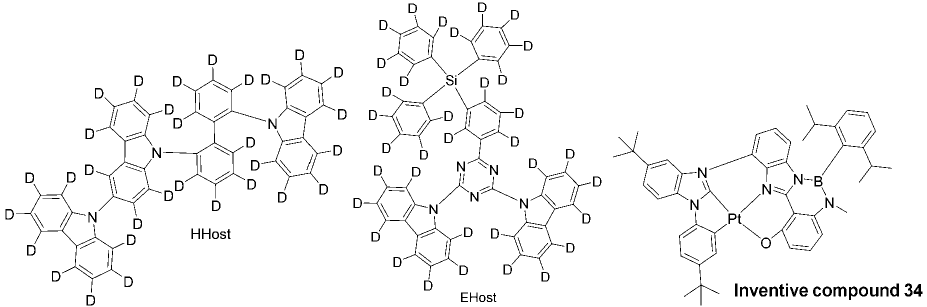

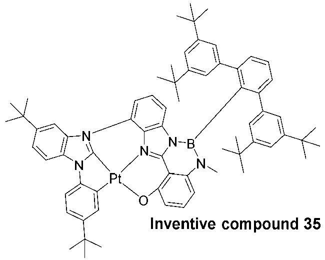

OLEDs were grown on a glass substrate pre-coated with an indium-tin-oxide (ITO) layer having a sheet resistance of 15-Ω/sq. Prior to any organic layer deposition or coating, the substrate was degreased with solvents and then treated with an oxygen plasma for 1.5 minutes with 50W at 100 mTorr and with UV ozone for 5 minutes. The devices were fabricated in high vacuum (< 10⁻⁶ Torr) by thermal evaporation. The anode electrode was 750 Å of indium tin oxide (ITO). All devices were encapsulated with a glass lid sealed with an epoxy resin in a nitrogen glove box (<1ppm of H₂O and O₂,) immediately after fabrication with a moisture getter incorporated inside the package. Doping percentages are in volume percent.

Two devices were grown having organic layers consisting of, sequentially, from the ITO surface, 100 Å of Compound 1 (HIL), 250 Å of Compound 2 (HTL), 50 Å of HHost (EBL), EML, 50Å of EHost (BL), 300 Å of Compound 5 doped with 35% of Compound 6 (ETL), 10 Å of Compound 5 (EIL) followed by 1,000 Å of Al (Cathode). The composition of the EML is as shown in Table 1.

**Table 1: EML composition and the electroluminescence wavelength at maximum intensity (λₘₐₓ)**

| | **EML composition** | **λₘₐₓ (nm)** |
|---|---|---|
| **Device 1** | HHost: 38% EHost: 50% Inventive compound 34: 12% | 455 |
| **Device 2** | HHost: 38% EHost: 50% Inventive compound 35: 12% | 452.5 |

Inventive compounds 34 and 35 both display deep blue emission in OLED devices, with λₘₐₓ (nm) = 455 nm and 452.5 nm respectively. This color point in a blue OLED is essential to meet specs needed for high color purity display applications. Inventive compound 35 with its bulkier substituent attached to the boron atom shows a higher energy λₘₐₓ, illustrating the importance of steric encumbrance to achieve deep blue color points.

## Claims

1. A compound having a first ligand L_{A} comprising a structure of Formula I: 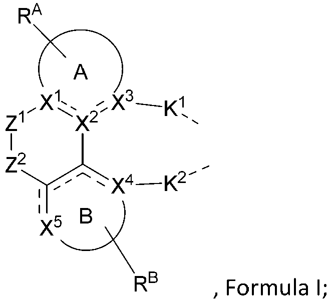
wherein moieties A and B are each independently a monocyclic ring or a polycyclic fused ring system, wherein the monocyclic ring or each ring of the polycyclic fused ring system is independently a 5-membered to 10-membered carbocyclic or heterocyclic ring;
wherein K¹ and K² are each independently selected from the group consisting of a direct bond, O, S, N(R^{α}), P(R^{α}), B(R^{α}), C(R^{α})(R^{β}), and Si(R^{α})(R^{β});
wherein Z¹ is selected from the group consisting of BR^{C}, C=O, C=S, C=Se, GaR^{C}, SiR^{C}R^{C'}, and GeR^{C}R^{C'};
wherein Z² is selected from the group consisting of NR^{D}, O, and S;
wherein X¹ to X⁵ are each independently C or N;
wherein R^{A} and R^{B} each independently represent mono to the maximum allowable substitution or no substitution;
wherein R^{α}, R^{β}, R^{A}, R^{B}, R^{C} and R^{D} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof;
wherein any two of R^{α}, R^{β}, R^{A}, R^{B}, R^{C} and R^{D} may be joined or fused to form a ring;
wherein ----- is a single or double bond;
wherein L_{A} is coordinated to a metal M;
wherein the metal M may be coordinated to other ligands;
wherein L_{A} may join with other ligands to comprise a tridentate, tetradentate, pentadentate, or hexadentate ligand;
with the proviso that when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring;
and
wherein at least one of the following eleven conditions is true:
1) moiety A is a 6-membered to 10-membered ring, and R^{B} on X⁵ and an R^{D} from Z² are joined to form a polycyclic fused ring system, and X⁴ is not N;
2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
3) M is Pt or Pd, and moiety A is a 6-membered ring;
4) moiety A is a 6-membered ring, X³ is N, and Z¹ is selected from the group consisting of BR^{C}, GaR^{C}, SiR^{C}R^{C'} and GeR^{C}R^{C'};
5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
7) at least one of R^{A}, R^{B}, R^{C} (if present), and R^{D} (if present) comprises a group selected from germyl, boryl, and partially or fully deuterated silyl;
8) at least one of R^{A}, R^{B}, R^{C} (if present), and R^{D} (if present) comprises three 6-membered aromatic rings that are not fused to each other, or an aromatic ring fused by a non-aromatic ring;
9) moiety A is a 5-membered ring and Z¹ is selected from the group consisting of C=O, C=S, and C=Se;
10) M is Pt or Pd, X¹ and X³ are both N, X² is C, moiety A is an imidazole ring, and two R^{A} are joined to form a benzene ring which is further substituted; and
11) the compound comprises a structure of 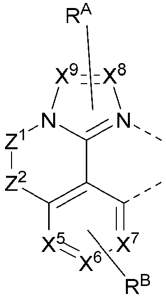 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 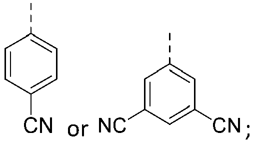 and wherein the compound is not one of the following:

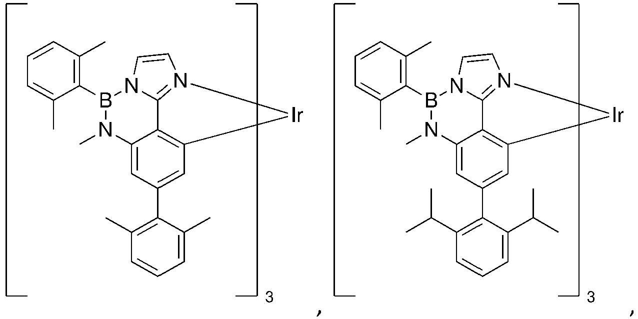

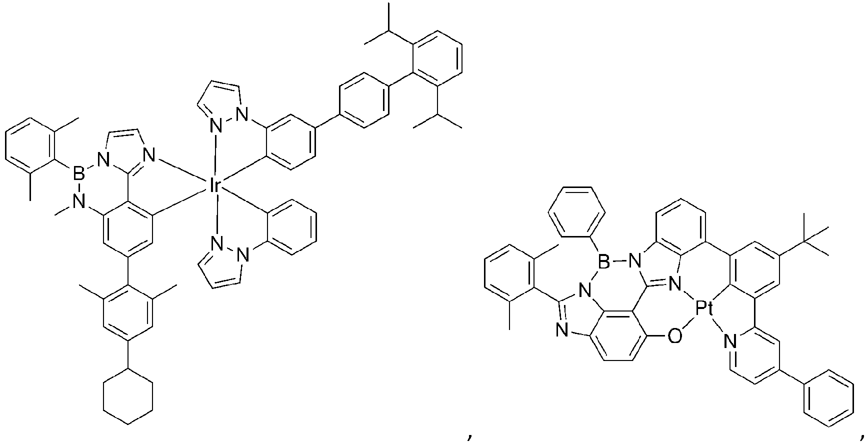

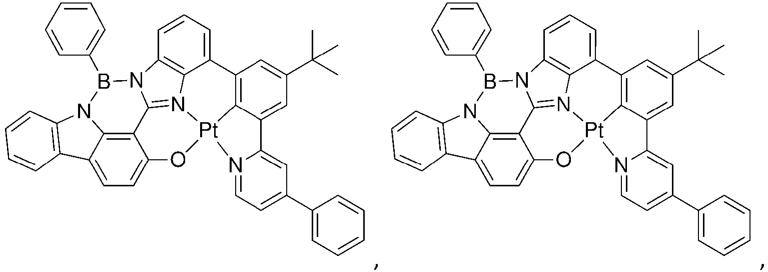

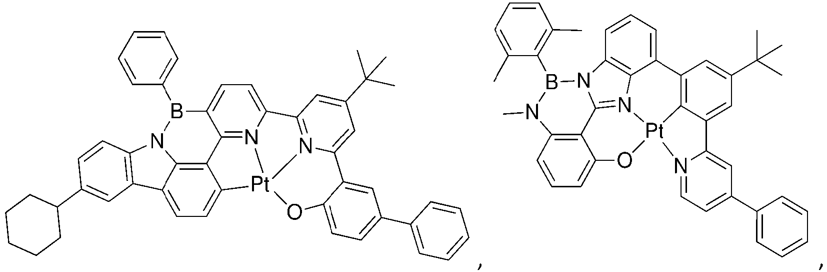

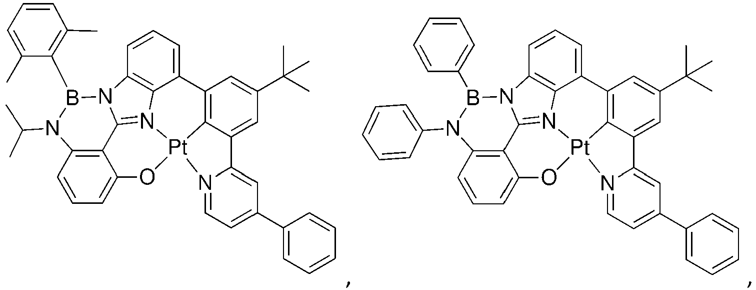

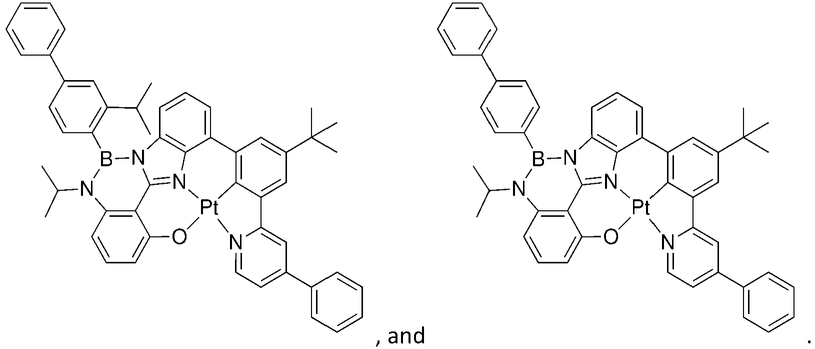

2. The compound of claim 1, when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring; and/or wherein Z² is NR^{D}, R^{D} comprises a polycyclic fused ring system, and R^{D} and R^{B} on X⁵ are joined together to form a 5 to 10-membered ring; and/or wherein R^{D} is selected from the group consisting of naphthalene, quinoline, isoquinoline, quinazoline, quinoxaline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, nathpho-imidazole (benzobenzimidazole), dibenzofuran, aza-dibenzofuran, dibenzothiophene, aza-dibenzothiophene, phthalazine, phenanthrene, aza-phenanthrene, anthracene, aza-anthracene, phenanthridine, fluorene, and aza-fluorene; and/or wherein R^{D} and R^{B} on X⁵ are joined together to form a 5-membered ring; and/or wherein R^{D} and R^{B} on X⁵ are joined together to form a 6-membered ring.

3. The compound of claim 1 or 2, wherein moiety A is a 6-membered to 10-membered ring, and R^{B} on X⁵ and an R^{D} on Z² are joined to form a polycyclic fused ring system, and X⁴ is not N; or
wherein moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole; and/or
wherein at least one of R^{A}, R^{B}, R^{C} (if present), and R^{D} (if present) comprises a group selected from germyl, boryl, and partially or fully deuterated silyl; and/or wherein at least one of R^{A}, R^{B}, R^{C} (if present), and R^{D} (if present) comprises three 6-membered aromatic rings that are not fused to each other, or an aromatic ring fused by a non-aromatic ring.

4. The compound of claim 1, wherein one of the two conditions 10) and 11) is true:
10) M is Pt or Pd, X¹ and X³ are both N, X² is C, moiety A is an imidazole ring, and two R^{A} are joined to form a benzene ring which is further substituted; or
11) the compound comprises a structure of 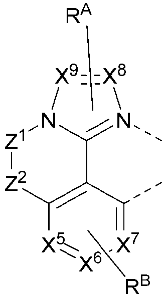 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not

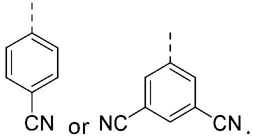

5. The compound of claim 1, wherein the ligand L_{A} is selected from the group consisting of the structures from LIST 1 as defined herein;
wherein X⁶ to X¹⁹ are each independently C or N;
wherein Z³ and Z⁴ are each independently selected from the group consisting of O, S, NR^{a}, C(R^{a})(R^{b}), and Si(R^{a})(R^{b}); and
wherein each R', R^{a}, R^{b} , R^{AA}, R^{BB}, R^{CC} and R^{DD} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof.

6. The compound of claim 1, wherein the ligand L_{A} is selected from the group consisting of the structures from LIST 2 as defined herein.

7. The compound of claim 1, wherein the ligand L_{A} is selected from L_{A}W1-(R*i*)(R*j*)(R*k*)(R*l*), and L_{A}W2-(R*j*)(R*k*)(R*l*), wherein W1 is an integer from 1-263, 265, 267-280, 282, 284-489, W2 is 264, 266, 281, and 283, each i, j, k, and l is independently an integer from 1 to 263, each of R*i*, R*j*, R*k* and R*l* is independently selected from V1 to V263, and each of L_{A}W1-(R*i*)(R*j*)(R*k*)(R*l*), and L_{A}W2-(R*j*)(R*k*)(R*l*) is defined in the table of LIST 3 as defined herein;
wherein V1 to V263 have the structures of LIST A as defined herein.

8. The compound of claim 1, wherein the compound is selected from the group consisting of the structures from LIST 9 as defined herein; and/or wherein the compound is selected from the group consisting of the structures from LIST 16 as defined herein.

9. The compound of claim 1, wherein the compound comprises a structure of Formula II: 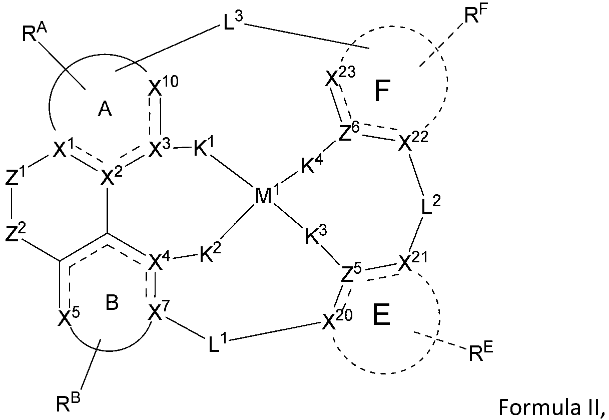 wherein:
M¹ is Pd or Pt;
X²⁰, Z⁵ and X²¹ are optionally joined or fused into moiety E;
X²², Z⁶ and X²³ are optionally joined or fused into moiety F;
moiety E (if present) is optionally substituted by R^{E} representing mono to the maximum allowable substitution;
moiety F (if present) is optionally substituted by R^{F} representing mono to the maximum allowable substitution;
moieties E (if present) and F (if present) are each independently a monocyclic ring or a polycyclic fused ring system, wherein the monocyclic ring or each ring of the polycyclic fused ring system is independently a 5-membered to 10-membered carbocyclic or
heterocyclic ring;
X²⁰ to X²³ are each independently C or N;
Z⁵ and Z⁶ are each independently C or N;
K¹, K², K³ and K⁴ are each independently selected from the group consisting of a direct bond, O, S, N(R^{α}), P(R^{α}), B(R^{α}), C(R^{α})(R^{β}), and Si(R^{α})(R^{β}), wherein at least two of them are direct bonds;
two adjacent R^{A}, R^{B}, R^{E}, and R^{F} can be joined or fused together to form a ring where chemically feasible; and
Z¹, Z², moiety A, moiety B, R^{A}, R^{B}, R^{C} and R^{D} are all defined the same as above;
wherein ------ represents a single bond or a double bond;
wherein ----- between X²⁰, L¹, and X⁷ represents a direct bond or no bond;
wherein ----- between X²³, L³, and X¹⁰ represents a direct bond or no bond;
L¹, L², and L³ are each independently selected from the group consisting of a single bond, absent a bond, BR, BRR', NR, PR, P(O)R, O, S, Se, C=O, C=S, C=Se, C=NR, C=CRR', S=O, SO₂, CR, CRR', SiRR', and GeRR', wherein at least one of L¹ and L³ is present;
wherein when L¹ is present, L¹ is selected from the group consisting of direct bond, BR, BRR', NR, PR, P(O)R, O, S, Se, C=O, C=S, C=Se, C=NR, C=CRR', S=O, SO₂, CR, CRR', SiRR', and GeRR',
wherein when L³ is present, L³ is selected from the group consisting of direct bond, BR, BRR', NR, PR, P(O)R, O, S, Se, C=O, C=S, C=Se, C=NR, C=CRR', S=O, SO₂, CR, CRR', SiRR', and GeRR',
each of R, R', R^{E} (if present), and R^{F} (if present) is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof;
and at least one of the following eleven conditions is true:
1) moiety A is a 6-membered to 10-membered ring, and R^{B} on X⁵ and an R^{D} from Z² are joined to form a polycyclic fused ring system, and X⁴ is not N;
2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
3) moiety A is a 6-membered ring;
4) moiety A is a 6-membered ring, X³ is N, and Z¹ is selected from the group consisting of BR^{C}, GaR^{C}, SiR^{C}R^{C'} and GeR^{C}R^{C'};
5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
7) at least one of R^{A}, R^{B}, R^{C} (if present), and R^{D} (if present) comprises a group selected from germyl, boryl, and partially or fully deuterated silyl;
8) at least one of R^{A}, R^{B}, R^{C} (if present), and R^{D} (if present) comprises three 6-membered aromatic rings that are not fused to each other, or an aromatic ring fused by a non-aromatic ring;
9) moiety A is a 5-membered ring and Z¹ is selected from the group consisting of C=O, C=S, and C=Se;
10) X¹ and X³ are both N, X² is C, moiety A is an imidazole ring, and two R^{A} are joined to form a benzene ring which is further substituted; and
11) the compound comprises a structure of 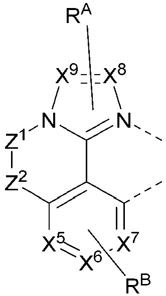 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 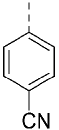 or 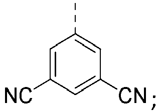
and wherein the compound is not one of the following: 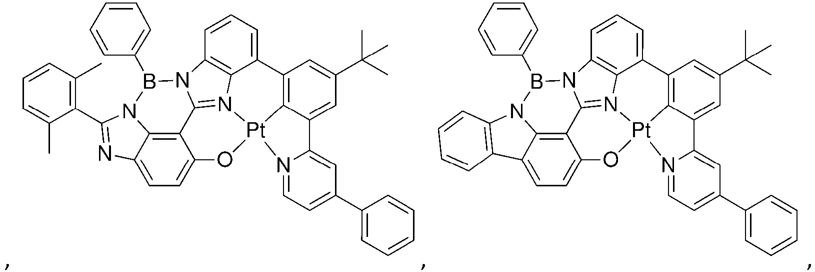 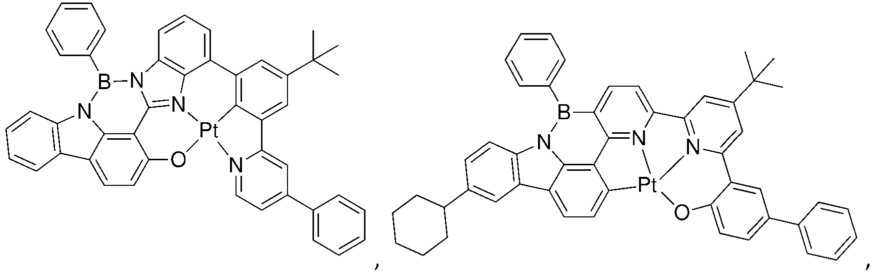 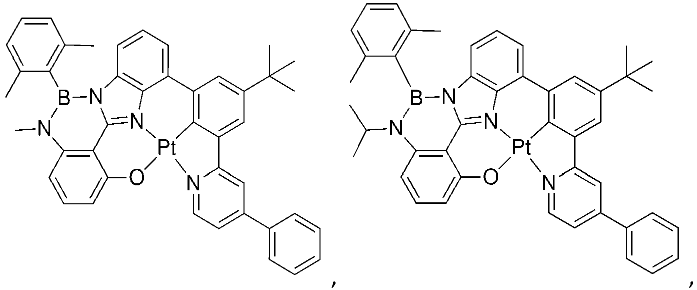 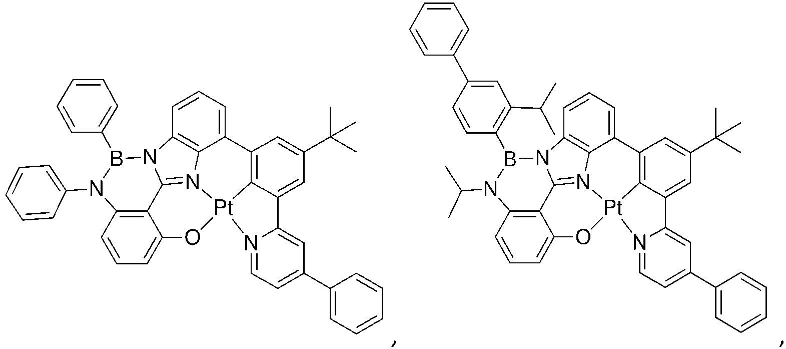 and

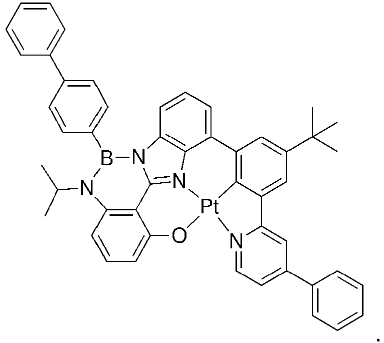

10. The compound of claim 9, wherein the compound is selected from the group consisting of compounds having the formula of Pt(L_{A'})(L*y*): 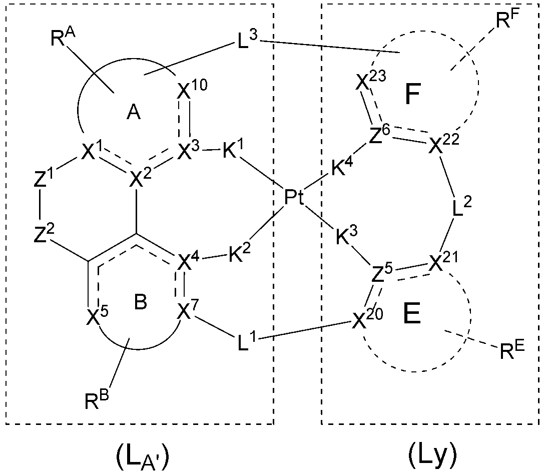
wherein L_{A'} is selected from the group consisting of the structures shown in LIST 10 as defined herein;
wherein L*_{y}* is selected from the group consisting of the structures shown in LIST 13 as defined herein;
wherein each R^{X} and R^{Y} is independently a hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

11. The compound of claim 1, wherein the compound is selected from the group consisting of the compounds having the formula of Pt(L_{A'})(L*y*): 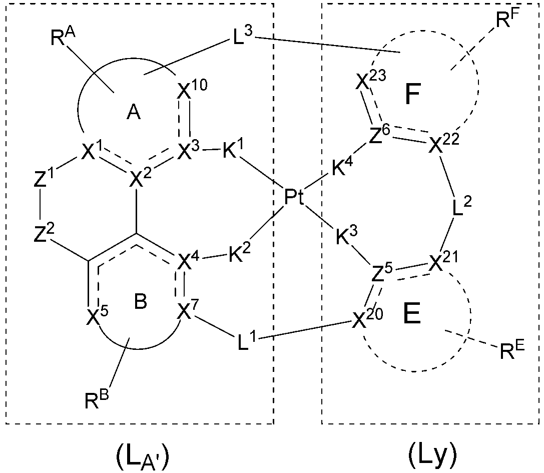
wherein L_{A'} is selected from L_{A'}Q1-(R*i*)(R*j*)(R*k*)(R*l*), L_{A'}Q2-(R*j*)(R*k*)(R*l*), L_{A'}Q3-(R*j*)(R*k*)(R*l*)(R*m*), L_{A'}Q4-(R*i*)(R*j*)(R*k*)(R*n*), L_{A'}Q5-(R*i*)(R*k*)(R*l*)(R*m*), L_{A'}Q6-(R*k*)(R*l*)(R*m*)(R*o*), L_{A'}Q7-(R*j*)(R*k*)(R*n*), L_{A'}Q8-(R*i*)(R*k*)(R*l*)(R*o*), L_{A'}Q9-(R*j*)(R*l*)(R*m*)(R*n*), Q1 is an integer of from 1-15, 17-19, 21-27, 29-259, 261, 263-276, 278, 280-366, 367-372, 376, and 396-400, Q2 is 16, 20, 28, 260, 262, 277, 279, 391, and 393; Q3 is an integer of from 373-375, 378-382, 384, 385, and 401-406, Q4 is 377, Q5 is 383 and 386, Q6 is 387-390, and 394, Q7 is 392, Q8 is 395, Q9 is 407, each *i, j, k, m, n, o,* and *l* is independently an integer from 1 to 468; each of R*i*, R*j*, R*k*, R*l*, R*m*, R*n* and R*o* is independently selected from R1 to R468, wherein R1 to R468 are defined in LIST 12, and each of L_{A'} structures are defined in the table of LIST 14 as defined herein;;
wherein L*_{y}* is selected from L_{y}Z1-(R*s*)(R*t*)(R*u*), L_{y}Z2-(R*p*)(R*q*)(R*r*)(R*s*), L_{y}Z3-(R*q*)(R*r*)(R*s*), L_{y}Z4-(Rp)(Rq)(Rr)(Rt), L_{y}Z5-(R*p*)(R*q*)(R*r*)(R*u*), L_{y}Z6-(R*q*)(R*r*)(R*u*), L_{y}Z7-(R*p*)(R*q*)(R*s*)(R*v*), L_{y}Z8-(R*q*)(R*s*)(R*v*), L_{y}Z9-(R*s*)(R*v*)(R*t*), L_{y}Z10-(R*p*)(R*q*)(R*s*)(R*v*)(R*t*), L_{y}Z11-(R*p*)(R*s*)(R*v*), L_{y}Z12-(R*p*)(R*s*)(R*v*)(R*t*), wherein Z1 is an integer from 1 to 95, Z2 is an integer from 96-98, 102-111, 116, 120 and 121; Z3 is an integer from 99, 113, 117-119, and 122; Z4 is 100, 101 and 115; Z5 is 112; Z6 is 114; Z7 is 123 and 124; Z8 is 125; Z9 is 126; Z10 is 127; Z11 is 128 and 129; Z12 is 130; each p, q, r, s, t, u, and v is independently an integer from 1 to 468, each of R*p*, R*q*, R*r*, R*s*, R*t*, R*u* and R*v* is independently selected from R1 to R468, and each of the L*_{y}* structures are defined in the table of LIST 15 as defined herein;
wherein R1 to R468 have the structures as defined in LIST 12 as defined herein.

12. An organic light emitting device (OLED) comprising:
an anode;
a cathode; and
an organic layer disposed between the anode and the cathode,
wherein the organic layer comprises a compound as defined in any one of the previous claims, the compound having a first ligand L_{A} comprising a structure of Formula I: 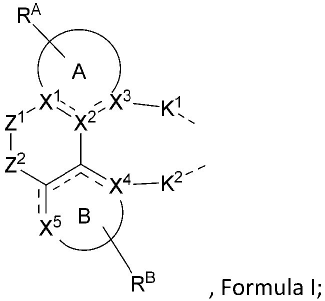
wherein moieties A and B are each independently a monocyclic ring or a polycyclic fused ring system, wherein the monocyclic ring or each ring of the polycyclic fused ring system is independently a 5-membered to 10-membered carbocyclic or heterocyclic ring;
wherein K¹ and K² are each independently selected from the group consisting of a direct bond, O, S, N(R^{α}), P(R^{α}), B(R^{α}), C(R^{α})(R^{β}), and Si(R^{α})(R^{β});
wherein Z¹ is selected from the group consisting of BR^{C}, C=O, C=S, C=Se, GaR^{C}, SiR^{C}R^{C'}, and GeR^{C}R^{C'};
wherein Z² is selected from the group consisting of NR^{D}, O, and S;
wherein X¹ to X⁵ are each independently C or N;
wherein R^{A} and R^{B} each independently represent mono to the maximum allowable substitution or no substitution;
wherein R^{α}, R^{β}, R^{A}, R^{B}, R^{C} and R^{D} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof;
wherein any two of R^{α}, R^{β}, R^{A}, R^{B}, R^{C} and R^{D} may be joined or fused to form a ring; wherein ----- is a single or double bond;
wherein L_{A} is coordinated to a metal M;
wherein the metal M may be coordinated to other ligands;
wherein L_{A} may join with other ligands to comprise a tridentate, tetradentate, pentadentate, or hexadentate ligand;
with the proviso that when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring;
and
wherein at least one of the following eleven conditions is true:
1) moiety A is a 6-membered to 10-membered ring, and R^{B} on X⁵ and an R^{D} from Z² are joined to form a polycyclic fused ring system, and X⁴ is not N;
2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
3) M is Pt or Pd, and moiety A is a 6-membered ring;
4) moiety A is a 6-membered ring, X³ is N, and Z¹ is selected from the group consisting of BR^{C}, GaR^{C}, SiR^{C}R^{C'} and GeR^{C}R^{C'};
5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
7) at least one of R^{A}, R^{B}, R^{C} (if present), and R^{D} (if present) comprises a group selected from germyl, boryl, and partially or fully deuterated silyl;
8) at least one of R^{A}, R^{B}, R^{C} (if present), and R^{D} (if present) comprises three 6-membered aromatic rings that are not fused to each other, or an aromatic ring fused by a non-aromatic ring;
9) moiety A is a 5-membered ring and Z¹ is selected from the group consisting of C=O, C=S, and C=Se;
10) M is Pt or Pd, X¹ and X³ are both N, X² is C, moiety A is an imidazole ring, and two R^{A} are joined to form a benzene ring which is further substituted; and
11) the compound comprises a structure of 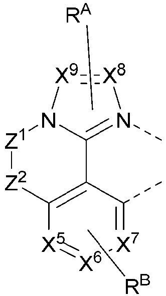 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 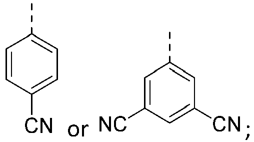 and wherein the compound is not one of the following: 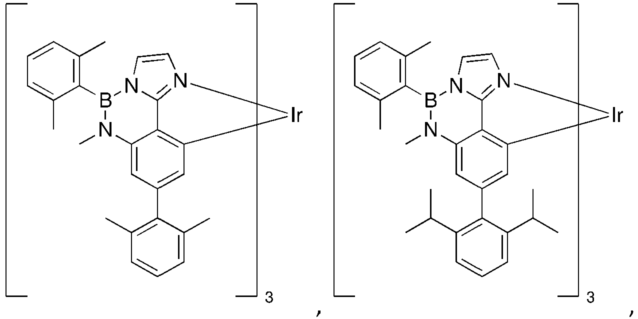 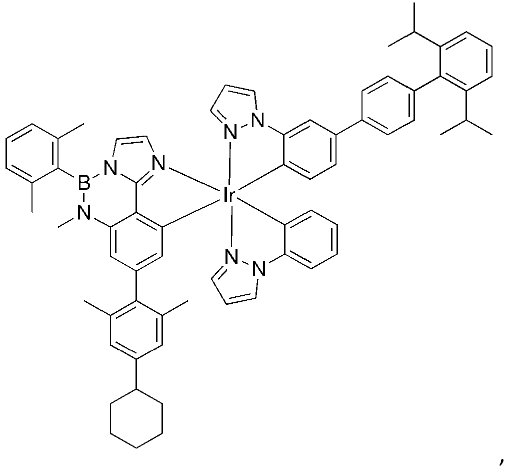 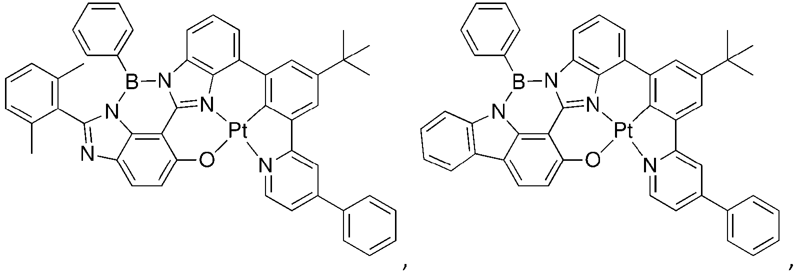 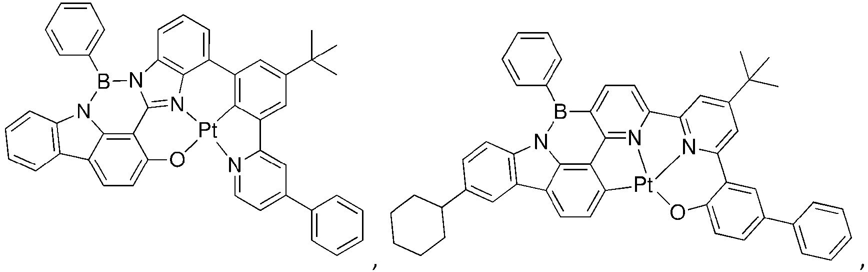 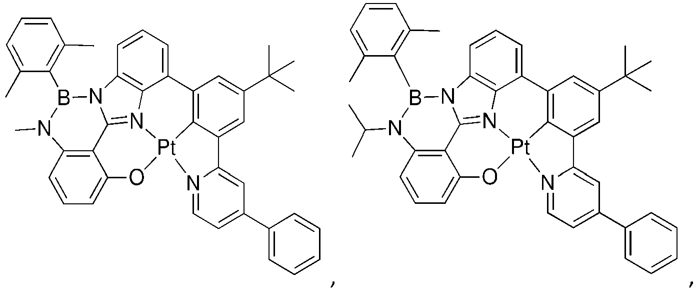 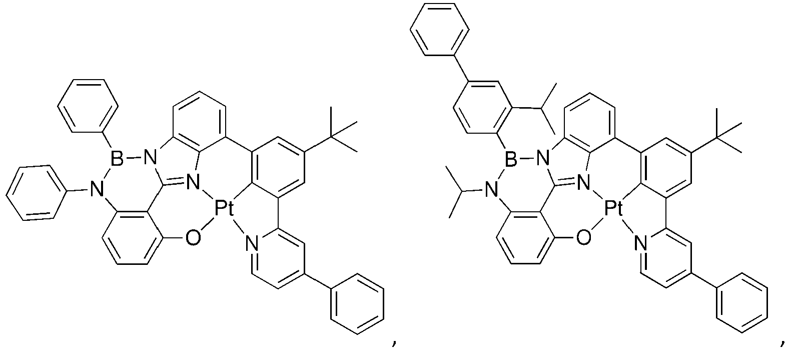 and

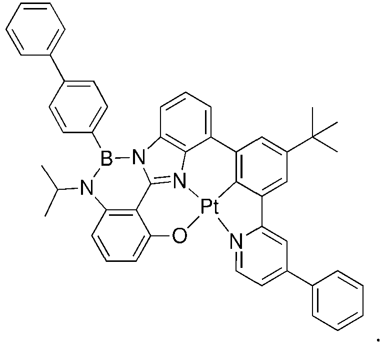

13. The OLED of claim 12, wherein the organic layer is an emissive layer and the compound is an emissive dopant or a sensitizer, wherein when the compound is a sensitizer, the OLED further comprises an acceptor selected from the group consisting of a fluorescent emitter, a delayed fluorescence emitter, and combination thereof

14. A consumer product comprising an organic light-emitting device (OLED) comprising:
an anode;
a cathode; and
an organic layer disposed between the anode and the cathode,
wherein the organic layer comprises a compound according to any one of claims 1 to 11.

15. A compound, or a neutral molecular form thereof, or a monovalent or polyvalent form thereof, or a monomeric or polymeric form thereof, or a macromolecular or supramolecular form thereof; wherein the compound has a first ligand L_{A} comprising a structure of Formula I: 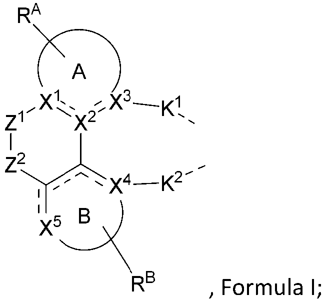
wherein moieties A and B are each independently a monocyclic ring or a polycyclic fused ring system, wherein the monocyclic ring or each ring of the polycyclic fused ring system is independently a 5-membered to 10-membered carbocyclic or heterocyclic ring;
wherein K¹ and K² are each independently selected from the group consisting of a direct bond, O, S, N(R^{α}), P(R^{α}), B(R^{α}), C(R^{α})(R^{β}), and Si(R^{α})(R^{β});
wherein Z¹ is selected from the group consisting of BR^{C}, C=O, C=S, C=Se, GaR^{C}, SiR^{C}R^{C'}, and GeR^{C}R^{C'};
wherein Z² is selected from the group consisting of NR^{D}, O, and S;
wherein X¹ to X⁵ are each independently C or N;
wherein R^{A} and R^{B} each independently represent mono to the maximum allowable substitution or no substitution;
wherein R^{α}, R^{β}, R^{A}, R^{B}, R^{C} and R^{D} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof;
wherein any two of R^{α}, R^{β}, R^{A}, R^{B}, R^{C} and R^{D} may be joined or fused to form a ring;
wherein ----- is a single or double bond;
wherein L_{A} is coordinated to a metal M;
wherein the metal M may be coordinated to other ligands;
wherein L_{A} may join with other ligands to comprise a tridentate, tetradentate, pentadentate, or hexadentate ligand;
with the proviso that when M is Ir, Z¹ is BR^{C}, and Z² is NR^{D}, then R^{A} and R^{C} from Z¹ are not joined together to form a 5 or 6-membered ring, and R^{C} from Z¹ and R^{D} from Z² are not joined together to form a 5 or 6-membered ring;
and
wherein at least one of the following eleven conditions is true:
1) moiety A is a 6-membered to 10-membered ring, and R^{B} on X⁵ and an R^{D} from Z² are joined to form a polycyclic fused ring system, and X⁴ is not N;
2) moiety A is a 5-membered ring, Z² is NR^{D}, R^{B} on X⁵ and an R^{D} from Z² are joined to form a polycyclic fused ring system, and X⁴ is not N, with the proviso that if Z¹ is BR^{C}, moiety A is imidazole, and X¹ and X³ are N, then the polycyclic fused ring system formed by R^{B} and R^{D} from Z² is not a tetrahydroquinoline or an unsubstituted carbazole;
3) M is Pt or Pd, and moiety A is a 6-membered ring;
4) moiety A is a 6-membered ring, X³ is N, and Z¹ is selected from the group consisting of BR^{C}, GaR^{C}, SiR^{C}R^{C'} and GeR^{C}R^{C'};
5) moiety B is a 6-membered ring, X⁴ is N, and Z¹ is selected from the group consisting of BR^{C}, GaR^{C}, SiR^{C}R^{C'} and GeR^{C}R^{C'}, with the proviso that if Z² is NR^{D}, then R^{D} and R^{B} from X⁵ do not join to form a cycle;
6) moiety A and moiety B are both 6-membered rings, Z¹ is selected from the group consisting of C=O, C=S, and C=Se, and Z² is NR^{D}, with the proviso that if M is Ir, then R^{D} is a cyclic group;
7) at least one of R^{A}, R^{B}, R^{C} (if present), and R^{D} (if present) comprises a group selected from germyl, boryl, and partially or fully deuterated silyl;
8) at least one of R^{A}, R^{B}, R^{C} (if present), and R^{D} (if present) comprises three 6-membered aromatic rings that are not fused to each other, or an aromatic ring fused by a non-aromatic ring;
9) moiety A is a 5-membered ring and Z¹ is selected from the group consisting of C=O, C=S, and C=Se;
10) M is Pt or Pd, X¹ and X³ are both N, X² is C, moiety A is an imidazole ring, and two R^{A} are joined to form a benzene ring which is further substituted; and
11) the compound comprises a structure of 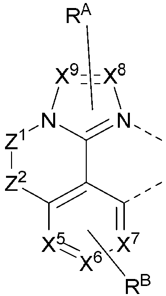 and at least one of the following three conditions is true: (i) at least one R^{B} is not hydrogen or CH₃, (ii) at least one of X⁵ to X⁹ is N, and (iii) R^{D} is present and is heteroaryl or comprises at least one electron-withdrawing group with the proviso that if X⁵ to X⁹ are all C, then R^{C} and R^{D} do not join to form a 6-membered ring and R^{D} is not 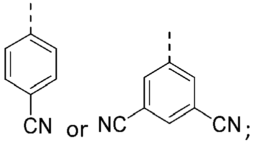 and wherein the compound is not one of the following: 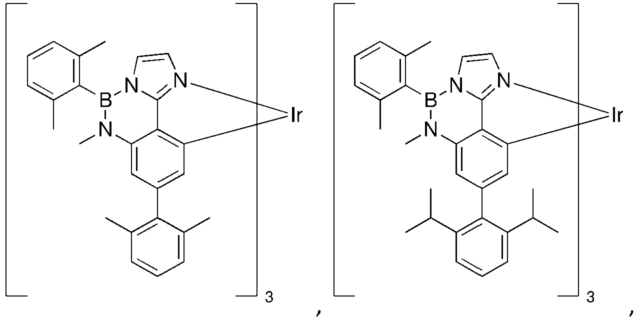 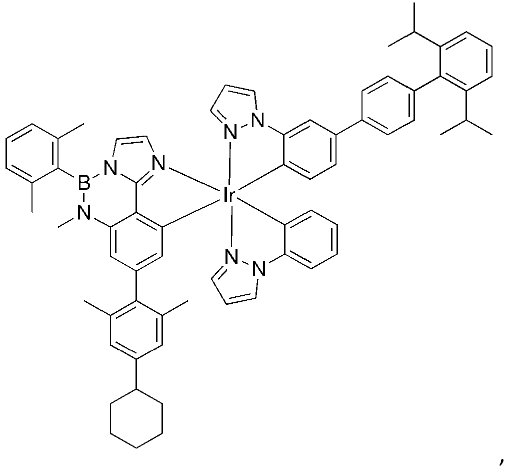 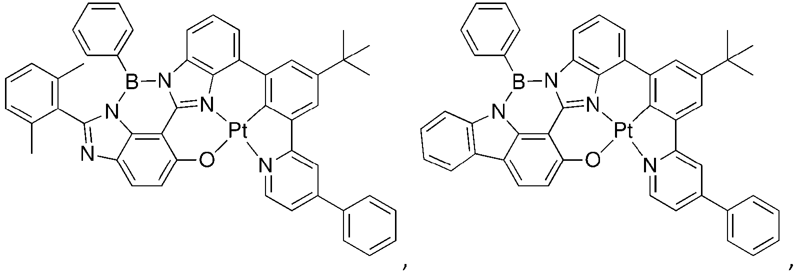 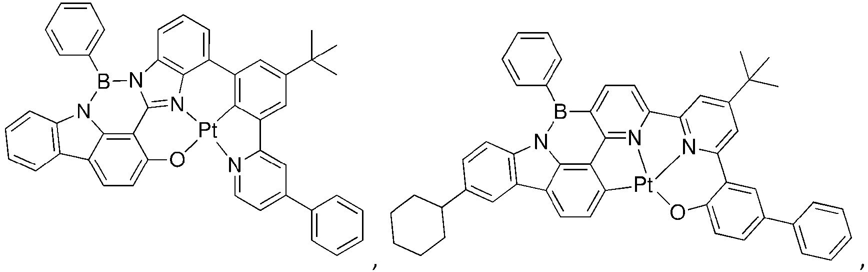 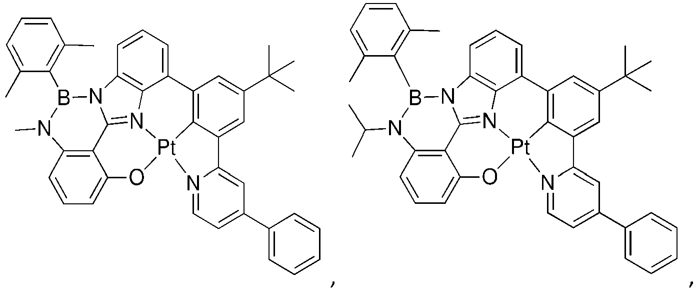 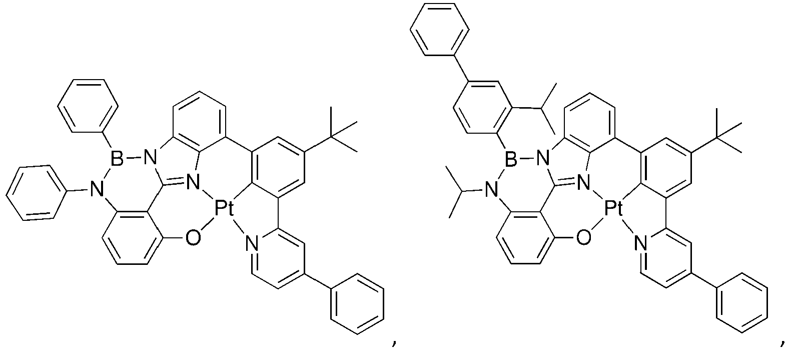 and
